# EUROPEAN PATENT SPECIFICATION

(11) **EP 4 203 661 B1**
(45) Date of publication and mention of the grant of the patent: **27.08.2025**
(21) Application number: 22215062.5
(22) Date of filing: 20.12.2022
(51) Int. Cl.: H10K 85/30, H10K 50/19, H10K 59/32, H10K 50/13, H10K 101/10, H10K 101/30

(54) **LIGHT-EMITTING DEVICE AND ELECTRONIC APPARATUS INCLUDING THE SAME**
LICHTEMITTIERENDE VORRICHTUNG UND ELEKTRONISCHE VORRICHTUNG DAMIT
DISPOSITIF ÉLECTROLUMINESCENT ET APPAREIL ÉLECTRONIQUE LE COMPRENANT

(30) Priority: 23.12.2021 KR 20210186593
(43) Date of publication of application: 28.06.2023
(73) Proprietor: Samsung Electronics Co., Ltd., Gyeonggi-do 16677 (KR)
(72) Inventor: KWAK, Seungyeon, 16678 Suwon-si (KR); KANG, Byungjoon, 16678 Suwon-si (KR); KIM, Hyungjun, 16678 Suwon-si (KR); SIM, Myungsun, 16678 Suwon-si (KR); LEE, Kum Hee, 16678 Suwon-si (KR); LEE, Sunghun, 16678 Suwon-si (KR); LEE, Yong Joo, 16678 Suwon-si (KR); CHOI, Byoungki, 16678 Suwon-si (KR); HONG, Youngki, 16678 Suwon-si (KR)
(74) Representative: Elkington and Fife LLP

(56) References cited:
- US-A1- 2021 175 457

## Description

### FIELD OF THE INVENTION

The present disclosure relates to a light-emitting device and an electronic apparatus including the same.

### BACKGROUND OF THE INVENTION

From among light-emitting devices, organic light-emitting devices (OLEDs) are self-emissive devices, which have improved characteristics in terms of viewing angles, response time, luminance, driving voltage, and response speed. In addition, OLEDs may produce full-color images.

In an example, an organic light-emitting device includes an anode, a cathode, and an organic layer arranged between the anode and the cathode, wherein the organic layer includes an emission layer. A hole transport region may be arranged between the anode and the emission layer, and an electron transport region may be arranged between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transition from an excited state to a ground state, thereby generating light. One concrete example is shown in US 2021/0175457 A1, which discloses an OLED with two adjacent red light emitting layers comprising different Ir complexes.

### SUMMARY OF THE INVENTION

Provided are a light-emitting device having excellent characteristics in terms of lifespan, change in color purity, turn-on time, and turn-off time, and an electronic apparatus including the light-emitting device.

Additional aspects will be set forth in part in the detailed description which follows and, in part, will be apparent from the detailed description, or may be learned by practice of the presented one or more embodiments of the description.

According to an aspect, a light-emitting device includes:
a first electrode;
a second electrode facing the first electrode; and
an interlayer arranged between the first electrode and the second electrode,
wherein the interlayer includes a first emission layer and a second emission layer,
the first emission layer includes a first compound that emits a first light having a first spectrum,
the second emission layer includes a second compound that emits a second light having a second spectrum,
the first compound includes a first transition metal,
the second compound includes a second transition metal,
the first transition metal and the second transition metal are different from each other,
|HOMO(1) - HOMO(2)| is about 0.05 electron Volts (eV) to about 0.4 eV,
|λmax(1) - λmax(2)| is about 0 nanometers (nm) to about 30 nm,
HOMO(1) is a highest occupied molecular orbital (HOMO) energy level of the first compound, expressed in eV,
HOMO(2) is a highest occupied molecular orbital (HOMO) energy level of the second compound, expressed in eV,
each of HOMO(1) and HOMO(2) is a negative value measured by differential pulse voltammetry using ferrocene as a reference material,
λmax(1) is an emission peak wavelength of the first compound in the first spectrum,
λmax(2) is an emission peak wavelength of the second compound in the second spectrum,
λmax(1) and λmax(2) are evaluated from photoluminescence spectra measured for a first film and a second film, respectively,
wherein the first film is a film including the first compound, and
wherein the second film is a film including the second compound.

For example, the interlayer may include:
m light-emitting units including at least one emission layer; and
m-1 charge generation layers arranged between two neighboring light-emitting units of the m light-emitting units,
wherein m may be an integer of 2 or greater, and
wherein:
   a first light-emitting unit of the m light-emitting units may include the first emission layer, and a second light-emitting unit of the m light-emitting units may include the second emission layer, or
   one light-emitting unit of the m light-emitting units may include the first emission layer and the second emission layer.

According to another aspect, an electronic apparatus includes the light-emitting device as described herein.

### BRIEF DESCRIPTION OF THE DRAWINGS

The above and other aspects, features, and advantages of certain exemplary embodiments will be more apparent from the following detailed description taken in conjunction with the accompanying drawings, in which:
FIG. 1 is a schematic view of a light-emitting device according to one or more embodiments;
FIG. 2 is a schematic view of a light-emitting device according to one or more embodiment;
FIG. 3 is a graph of luminescence efficiency (candela per Ampere, cd/A) versus color coordinate CIEx for each of OLED 1 (Pt-Pt), OLED 2 (Ir-Pt), and OLED 3 (Pt-Ir);
FIG. 4 is a graph of transient electroluminescence (EL) intensity (arbitrary units, a.u.) versus time (hour, hr) for each of OLED 1 (Pt-Pt), OLED 2 (Ir-Pt), and OLED 3 (Pt-Ir);
FIG. 5 is a graph of ΔCIEx versus luminance (cd/m²) for each of OLED 4 (Ir-Ir), OLED 2 (Ir-Pt), OLED 3 (Pt-Ir), and OLED 1 (Pt-Pt) in the range of 2 cd/m² to 15,000 cd/m²; and
FIGS. 6 and 7 are graphs of transient electroluminescence (EL) intensity (a.u.) versus time (microsecond, µs) for each of OLED 4 (Ir-Ir), OLED 2 (Ir-Pt), OLED 3 (Pt-Ir), and OLED 1 (Pt-Pt).

### DETAILED DESCRIPTION OF THE EMBODIMENTS

Reference will now be made in further detail to exemplary embodiments, examples of which are illustrated in the accompanying drawings, wherein like reference numerals refer to like elements throughout. In this regard, the present exemplary embodiments may have different forms and should not be construed as being limited to the detailed descriptions set forth herein. Accordingly, the exemplary embodiments are merely described in further detail below by referring to the figures, to explain certain aspects. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

Hereinafter, a work function or a highest occupied molecular orbital (HOMO) energy level may be expressed as an absolute value from a vacuum level. In addition, when the work function or the HOMO energy level is referred to be "deep," "high" or "large," the work function or the HOMO energy level has a large absolute value based on "0 eV" of the vacuum level, while when the work function or the HOMO energy level is referred to be "shallow," "low," or "small," the work function or HOMO energy level has a small absolute value based on "0 eV" of the vacuum level.

A light-emitting device includes a first electrode, a second electrode facing the first electrode, and an interlayer arranged between the first electrode and the second electrode.

The interlayer includes a first emission layer and a second emission layer.

The first emission layer and the second emission layer may be stacked from the first electrode in the order of the first emission layer and the second emission layer, or the first emission layer and the second emission layer may be stacked from the first electrode in the order of the second emission layer and the first emission layer.

The first emission layer may be in contact, for example in direct contact, with the second emission layer. In one or more embodiments, an additional layer may be further arranged between the first emission layer and the second emission layer.

The first emission layer includes a first compound that emits a first light having a first spectrum (i.e., is configured to or is capable of emitting the first light), and the second emission layer includes a second compound that emits a second light having a second spectrum (i.e., is configured to or is capable of emitting the second light).

The first compound includes a first transition metal, the second compound includes a second transition metal, and the first transition metal and the second transition metal are different from each other.

The first transition metal and the second transition metal may each independently be iridium, platinum, osmium, rhenium, gold, or palladium.

|HOMO(1) - HOMO(2)| of the light-emitting device is about 0.05 electron Volts (eV) to about 0.4 eV. It is to be understood that "|HOMO(1) - HOMO(2)|" refers to an absolute value of the difference between HOMO(1) and HOMO(2). For example, |HOMO(1) - HOMO(2)| may be about 0.05 eV to about 0.4 eV, about 0.05 eV to about 0.3 eV, about 0.05 eV to about 0.2 eV, or about 0.05 eV to about 0.1 eV.

HOMO(1) is a highest occupied molecular orbital (HOMO) energy level (eV) of the first compound, and HOMO(2) is a HOMO energy level (eV) of the second compound. As used herein, a "HOMO energy level" is a negative value measured by differential pulse voltammetry using ferrocene as a reference material. For example, a method of evaluating HOMO(1) and HOMO(2) may be as described in the Evaluation Examples herein.

In one or more embodiments, an absolute value of HOMO(1) may be greater than an absolute value of HOMO(2).

In one or more embodiments, HOMO(1) may be about -5.50 eV to about -5.10 eV, about -5.45 eV to about -5.10 eV, about -5.40 eV to about -5.10 eV, about -5.35 eV to about -5.10 eV, about -5.30 eV to about -5.10 eV, about -5.50 eV to about -5.15 eV, about -5.45 eV to about -5.15 eV, about -5.40 eV to about -5.15 eV, about -5.35 eV to about -5.15 eV, about -5.30 eV to about -5.15 eV, about -5.50 eV to about -5.20 eV, about -5.45 eV to about -5.20 eV, about -5.40 eV to about -5.20 eV, about -5.35 eV to about - 5.20 eV, or about -5.30 eV to about -5.20 eV.

In one or more embodiments, HOMO(2) may be about -5.30 eV to about -5.00 eV, about -5.25 eV to about -5.00 eV, about -5.20 eV to about -5.00 eV, about -5.30 eV to about -5.05 eV, about -5.25 eV to about -5.05 eV, about -5.20 eV to about -5.05 eV, about -5.30 eV to about -5.10 eV, about -5.25 eV to about -5.10 eV, or about -5.20 eV to about -5.10 eV.

In one or more embodiments, a dipole moment of the first compound may be less than about 3.0 debye, and a dipole moment of the second compound may be about 3.0 debye or greater.

As used herein, a "dipole moment" may be calculated based on a density functional theory (DFT). Any various programs may be used for quantum mechanical calculation based on the DFT, and for example, a Gaussian 16 program may be used.

For example, a method of evaluating the dipole moment of each of the first compound and the second compound may be as described in the Evaluation Examples herein.

In one or more embodiments, a dipole moment of the first compound may be about 0.5 debye to about 4.0 debye, about 1.0 debye to about 4.0 debye, about 1.5 debye to about 4.0 debye, about 0.5 debye to about 3.5 debye, about 1.0 debye to about 3.5 debye, about 1.5 debye to about 3.5 debye, about 0.5 debye to about 3.0 debye, about 1.0 debye to about 3.0 debye, about 1.5 debye to about 3.0 debye, about 0.5 debye to about 2.5 debye, about 1.0 debye to about 2.5 debye, about 1.5 debye to about 2.5 debye, about 0.5 debye to about 2.0 debye, about 1.0 debye to about 2.0 debye, or about 1.5 debye to about 2.0 debye.

In one or more embodiments, a dipole moment of the second compound may be about 3.0 debye to about 7.0 debye, about 3.5 debye to about 7.0 debye, about 4.0 debye to about 7.0 debye, about 4.5 debye to about 7.0 debye, about 5.0 debye to about 7.0 debye, about 3.0 debye to about 6.5 debye, about 3.5 debye to about 6.5 debye, about 4.0 debye to about 6.5 debye, about 4.5 debye to about 6.5 debye, about 5.0 debye to about 6.5 debye, about 3.0 debye to about 6.0 debye, about 3.5 debye to about 6.0 debye, about 4.0 debye to about 6.0 debye, about 4.5 debye to about 6.0 debye, about 5.0 debye to about 6.0 debye, about 3.0 debye to about 5.5 debye, about 3.5 debye to about 5.5 debye, about 4.0 debye to about 5.5 debye, about 4.5 debye to about 5.5 debye, or about 5.0 debye to about 5.5 debye.

As used herein, the term "emission peak wavelength" (also referred to as "peak emission wavelength" or "emission peak wavelength maximum") refers to a wavelength in the emission peak at which the emission intensity is maximum". |λmax(1) - λmax(2)| of the light-emitting device is about 0 nm to about 30 nm, or is 0 nm to about 30 nm. It is to be understood that the expression "|λmax(1) - λmax(2)|" refers to the absolute value of a difference between λmax(1) and λmax(2). For example, |λmax(1) - λmax(2)| may be about 0 nm to about 25 nm, about 0 nm to about 20 nm, about 0 nm to about 15 nm, about 0 nm to about 10 nm, or about 0 nm to about 5 nm.

λmax(1) and λmax(2) are evaluated from photoluminescence spectra measured for a first film and a second film, respectively.

The term "first film" as used herein refers to a film including the first compound, and the term "second film" as used herein refers to a film including the second compound. The first film and the second film may be manufactured using various methods, for example, a vacuum deposition method, and a coating and heating method. The first film and the second film may further include other compounds, for example, a host described herein, in addition to the first compound and the second compound. It is to be understood that the first film comprises the first compound and does not comprise the second compound, whereas the second film comprises the second compound and does not comprise the first compound.

For example, a method of evaluating λmax(1) and λmax(2) may be as described in the Evaluation Examples herein.

In one or more embodiments, each of λmax(1) and λmax(2) may be about 500 nm to about 570 nm.

In one or more embodiments, each of λmax(1) and λmax(2) may be about 510 nm to about 540 nm, about 515 nm to about 540 nm, about 520 nm to about 540 nm, about 510 nm to about 535 nm, about 515 nm to about 535 nm, or about 520 nm to about 535 nm.

In one or more embodiments, each of λmax(1) and λmax(2) may be bout 540 nm to about 570 nm, about 545 nm to about 570 nm, about 550 nm to about 570 nm, about 540 nm to about 565 nm, about 545 nm to about 565 nm, or about 550 nm to about 565 nm.

In one or more embodiments,
λmax(1) may be about 510 nm to about 530 nm, and λmax(2) may be about 520 nm to about 540 nm, or
λmax(1) may be about 540 nm to about 560 nm, and λmax(2) may be about 550 nm to about 570 nm.

In one or more embodiments, each of the first light and the second light may be a green light.

In one or more embodiments, each of the first emission layer and the second emission layer may emit a green light.

In one or more embodiments, each of λmax(1) and λmax(2) may be about 570 nm to about 650 nm.

For example, λmax(1) may be about 570 nm to about 630 nm, and λmax(2) may be about 620 nm to about 650 nm.

In one or more embodiments, each of the first light and the second light may be a red light.

In one or more embodiments, each of the first emission layer and the second emission layer may emit a red light.

In one or more embodiments, each of λmax(1) and λmax(2) may be about 400 nm to about 500 nm.

For example, λmax(1) may be about 430 nm to about 480 nm, and λmax(2) may be about 470 nm to about 500 nm.

In one or more embodiments, each of the first light and the second light may be a blue light.

In one or more embodiments, each of the first emission layer and the second emission layer may emit a blue light.

The first transition metal of the first compound and the second transition metal of the second compound are different from each other, and the first compound and the second compound satisfy the conditions of |HOMO(1) - HOMO(2)| and |λmax(1) - λmax(2)| as described above. In addition, each of the first compound and the second compound may satisfy the dipole moment conditions as described herein.

Without wishing to be bound to theory, since excitons generated in the first emission layer including the first compound are distributed over a relatively wide area, 1) a change in color purity of the light-emitting device due to a change in exciton distribution according to a change in luminance may be reduced, and 2) resistance of the light-emitting device may be reduced so that an resistance capacitance (RC) delay may be improved, and thus, the light-emitting device may have an improved response speed for turning-on and turning-off.

Furthermore, and without wishing to be bound to theory, since excitons generated in the second emission layer including the second compound are distributed over a relatively narrow area, 1) microcavity resonance of light emitted by the excitons may be effectively achieved so that external luminescence efficiency of the light-emitting device including the second emission layer may be improved, and 2) deterioration due to excitons at an interface between the second emission layer and a neighboring layer thereof may be reduced, and thus, the light-emitting device including the second emission layer may have an improved lifespan. In addition, since a recombination rate of holes and electrons in the second emission layer including the second compound may be increased, internal luminescence efficiency of the light-emitting device including the second emission layer may also be improved.

Accordingly, the light-emitting device including the first emission layer and the second emission layer as described herein may simultaneously achieve an increase in luminescence efficiency, an increase in lifespan, a decrease in color purity change, and an increase in response speed (that is, a decrease in turn-on time and turn-off time), and thus may have high-quality luminescence characteristics.

The above results are described in more detail in the Evaluation Examples provided herein.

The first emission layer of the light-emitting device may be arranged between the second emission layer and the second electrode. That is, the first electrode, the second emission layer, the first emission layer, and the second electrode of the light-emitting device may be arranged in this stated order.

In one or more embodiments, the second emission layer of the light-emitting device may be arranged between the first emission layer and the second electrode. That is, the first electrode, the first emission layer, the second emission layer, and the second electrode of the light-emitting device may be arranged in this stated order.

The light-emitting device may not emit white light. In one or more embodiments, the light-emitting device emits substantially no white light.

The first compound and the second compound may include a first transition metal and a second transition metal, respectively.

In one or more embodiments, the first transition metal may be platinum, and the second transition metal may be iridium.

In one or more embodiments, the first compound may be an organometallic compound including a first transition metal (for example, iridium, platinum, osmium, or the like) and at least one organic ligand bonded to the first transition metal. For example, the first light may be phosphorescent light.

In one or more embodiments, the second compound may be an organometallic compound including a second transition metal (for example, iridium, platinum, osmium, or the like) and at least one organic ligand bonded to the second transition metal. For example, the second light may be phosphorescent light.

Each of the first compound and the second compound may be electrically neutral.

In one or more embodiments, the first compound may be an organometallic compound including platinum and a tetradentate ligand bonded to the platinum, and the second compound may be an organometallic compound including iridium, and a first ligand, a second ligand, and a third ligand that are bonded to the iridium.

For example, the organometallic compound including platinum and a tetradentate ligand bonded to the platinum may be an organometallic compound including a) a chemical bond (e.g., a covalent bond) between carbon of the tetradentate ligand and the platinum and b) a chemical bond (e.g., a covalent bond) between oxygen (O) of the tetradentate ligand and the platinum. The organometallic compound may further include a chemical bond (e.g., coordinate bond) between nitrogen of the tetradentate ligand and the platinum.

In one or more embodiments, the organometallic compound including platinum and a tetradentate ligand bonded to the platinum may be an organometallic compound including a) a chemical bond (e.g., a covalent bond) between carbon of the tetradentate ligand and the platinum and b) a chemical bond (e.g., a covalent bond) between sulfur (S) of the tetradentate ligand and the platinum. The organometallic compound may further include a chemical bond (e.g., coordinate bond) between nitrogen of the tetradentate ligand and the platinum.

In one or more embodiments, a) the first ligand, the second ligand, and the third ligand may be identical to each other, b) the first ligand and the second ligand may be identical to each other, and the second ligand and the third ligand may be different from each other, or c) the first ligand, the second ligand, and the third ligand may be different from each other, and
each of the first ligand, the second ligand, and the third ligand may be:
a bidentate ligand bonded to iridium of the second compound via two nitrogen atoms;
a bidentate ligand bonded to iridium of the second compound via a nitrogen atom and a carbon atom; or
a bidentate ligand bonded to iridium of the second compound via two carbon atoms.

In one or more embodiments, each of the first ligand, the second ligand, and the third ligand may be a bidentate ligand bonded to iridium of the second compound via nitrogen atom and carbon atom.

In one or more embodiments, the first compound and the second compound may each independently be an organometallic compound represented by Formula 1 or an organometallic compound represented by Formula 2:

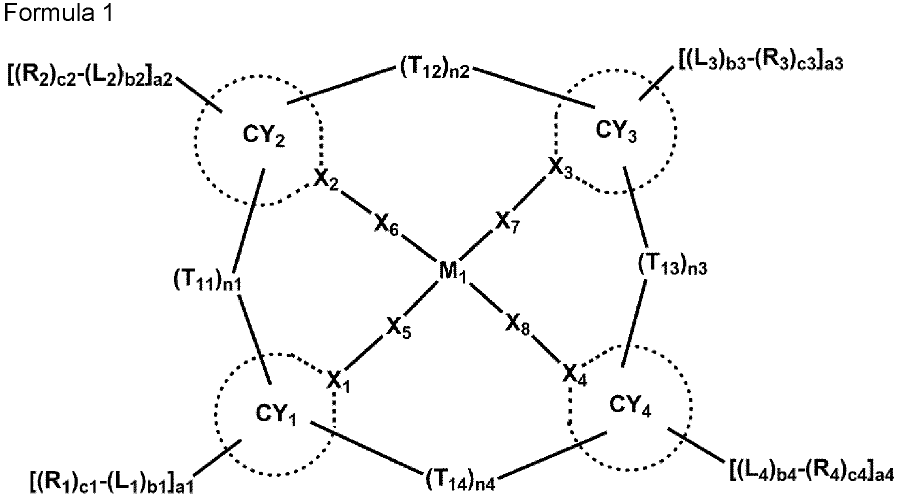

Formula 2 M₂(L₁₁)n₁₁(L₁₂)n₁₂(L₁₃)n₁₃.

wherein, M₁ in Formula 1 may be platinum (Pt), and M₂ in Formula 2 may be iridium (Ir).

In Formula 2, L₁₁ may be a ligand represented by Formula 2-1, L₁₂ may be a ligand represented by Formula 2-2, and L₁₃ may be a ligand represented by Formula 2-1 or 2-2: 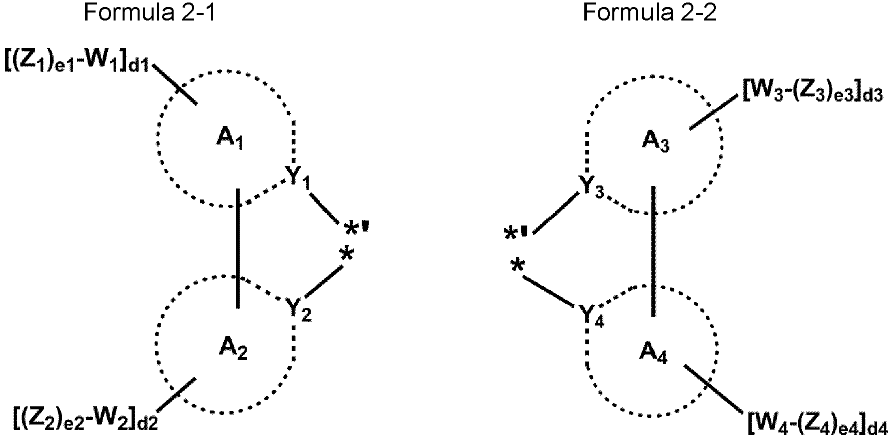 wherein, Formulae 1-1 and 1-2 are as described herein.

L₁₁ and L₁₂ in Formula 2 may be different from each other.

n11 to n13 in Formula 2 indicate the number of L₁₁(s), the number of L₁₂(s), and the number of L₁₃(s), respectively, and may each independently be 0, 1, 2, or 3, wherein a sum of n11, n12, and n13 may be 3.

For example, in Formula 2, n11 may be 1, 2, or 3, and n12 and n13 may each independently be 0, 1, or 2.

In one or more embodiments, in Formula 2, n12 may be 1, 2, or 3, and n11 and n13 may each independently be 0, 1, or 2.

In one or more embodiments, n11 may be 1, n12 may be 2, and n13 may be 0.

In one or more embodiments, n11 may be 2, n12 may be 1, and n13 may be 0.

In one or more embodiments, n11 may be 3, and n12 and n13 may each be 0.

In one or more embodiments, n12 may be 3, and n11 and n13 may each be 0.

The organometallic compound represented by Formula 2 may be a heteroleptic complex or a homoleptic complex.

In one or more embodiments, the organometallic compound represented by Formula 2 may be a heteroleptic complex.

X₁ to X₄ and Y₁ to Y₄ in Formulae 1, 2-1, and 2-2 may each independently be C or N.

For example, at least one of X₁ to X₄ in Formula 1 may be C.

In one or more embodiments, X₁ in Formula 1 may be C.

In one or more embodiments, in Formula 1, i) X₁ and X₃ may each be C, and X₂ and X₄ may each be N, or ii) X₁ and X₄ may each be C, and X₂ and X₃ may each be N.

In one or more embodiments, in Formulae 2-1 and 2-2, Y₁ and Y₃ may each be N, and Y₂ and Y₄ may each be C.

X₅ to X₈ in Formula 1 may each independently be a chemical bond, O, S, N(R'), C(R')(R"), or C(=O), wherein at least one of X₅ to X₈ may not be a chemical bond. R' and R" are each as described herein.

In an embodiment, X₅ in Formula 1 may not be a chemical bond.

In an embodiment, X₅ in Formula 1 may be O or S.

In an embodiment, in Formula 1, X₅ may be O or S, and X₆ to X₈ may each be a chemical bond.

In Formula 1, two bonds of a bond between X₅ or X₁ and M₁, a bond between X₆ or X₂ and M₁, a bond between X₇ or X₃ and M₁, and a bond between X₈ or X₄ and M₁ may each be a coordinate bond, and the other two bonds may each be a covalent bond.

For example, a bond between X₂ and M in Formula 1 may be a coordinate bond.

In an embodiment, in Formula 1, a bond between X₅ or X₁ and M and a bond between X₃ and M may each be a coordinate bond, and a bond between X₂ and M and a bond between X₄ and M may each be a covalent bond. In an embodiment, in Formula 1, a bond between X₅ or X₁ and M and a bond between X₃ and M may each be a covalent bond, and a bond between X₂ and M and a bond between X₄ and M may each be a coordinate bond.

Ring CY₁ to ring CY₄ and ring A₁ to ring A₄ in Formulae 1, 2-1, and 2-2 may each independently be a C₅-C₃₀ carbocyclic group or a C₁-C₃₀ heterocyclic group.

In an embodiment, each of ring CY₁, ring CY₃, and ring CY₄ in Formula 1 may not be a benzimidazole group.

For example, ring CY₁ to ring CY₄ and ring A₁ to ring A₄ in Formulae 1, 2-1, and 2-2 may each independently be i) a first ring, ii) a second ring, iii) a condensed ring in which two or more first rings are condensed with each other, iv) a condensed ring in which two or more second rings are condensed with each other, or v) a condensed ring in which at least one first ring and at least one second ring are condensed with each other,
the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

In an embodiment, ring CY₁ to ring CY₄ and ring A₁ to ring A₄ in Formulae 1, 2-1, and 2-2 may each independently be a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a pyrrole group, a furan group, a thiophene group, a silole group, a borole group, a phosphole group, a germole group, a selenophene group, an indene group, an indole group, a benzofuran group, a benzothiophene group, a benzosilole group, a benzoborole group, a benzophosphole group, a benzogermole group, a benzoselenophene group, a fluorene group, a carbazole group, a dibenzofuran group, a dibenzothiophene group, a dibenzosilole group, a dibenzoborole group, a dibenzophosphole group, a dibenzogermole group, a dibenzoselenophene group, a benzofluorene group, a benzocarbazole group, a naphthobenzofuran group, a naphthobenzothiophene group, a naphthobenzosilole group, a naphthobenzoborole group, a naphthobenzophosphole group, a naphthobenzogermole group, a naphthobenzoselenophene group, a dibenzofluorene group, a dibenzocarbazole group, a dinaphthofuran group, a dinaphthothiophene group, a dinaphthosilole group, a dinaphthoborole group, a dinaphthophosphole group, a dinaphthogermole group, a dinaphthoselenophene group, an indenophenanthrene group, an indolophenanthrene group, a phenanthrobenzofuran group, a phenanthrobenzothiophene group, a phenanthrobenzosilole group, a phenanthrobenzoborole group, a phenanthrobenzophosphole group, a phenanthrobenzogermole group, a phenanthrobenzoselenophene group, a dibenzothiophene 5-oxide group, a 9H-fluoren-9-one group, a dibenzothiophene 5,5-dioxide group, an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthrobenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a pyrrole group, a pyrazole group, an imidazole group, a triazole group, an oxazole group, an isoxazole group, a thiazole group, an isothiazole group, an oxadiazole group, a thiadiazole group, an azasilole group, an azaborole group, an azaphosphole group, an azagermole group, an azaselenophene group, a benzopyrrole group, a benzopyrazole group, a benzimidazole group, a benzoxazole group, a benzisoxazole group, a benzothiazole group, a benzisothiazole group, a benzoxadiazole group, a benzothiadiazole group, a pyridinopyrrole group, a pyridinopyrazole group, a pyridinoimidazole group, a pyridinooxazole group, a pyridinoisoxazole group, a pyridinothiazole group, a pyridinoisothiazole group, a pyridinooxadiazole group, a pyridinothiadiazole group, a pyrimidinopyrrole group, a pyrimidinopyrazole group, a pyrimidinoimidazole group, a pyrimidinooxazole group, a pyrimidinoisoxazole group, a pyrimidinothiazole group, a pyrimidinoisothiazole group, a pyrimidinooxadiazole group, a pyrimidinothiadiazole group, a naphthopyrrole group, a naphthopyrazole group, a naphthoimidazole group, a naphthooxazole group, a naphthoisoxazole group, a naphthothiazole group, a naphthoisothiazole group, a naphthooxadiazole group, a naphthothiadiazole group, a phenanthrenopyrrole group, a phenanthrenopyrazole group, a phenanthrenoimidazole group, a phenanthrenooxazole group, a phenanthrenoisoxazole group, a phenanthrenothiazole group, a phenanthrenoisothiazole group, a phenanthrenooxadiazole group, a phenanthrenothiadiazole group, a 5,6,7,8-tetrahydroisoquinoline group, a 5,6,7,8-tetrahydroquinoline group, an adamantane group, a norbornane group, a norbornene group, a benzene group condensed with at least one cyclohexane group, a benzene group condensed with at least one norbornane group, a pyridine group condensed with at least one cyclohexane group, or a pyridine group condensed with at least one norbornane group.

**In** an embodiment, ring CY₁ and ring CY₃ in Formula 1 may each independently be:
a benzene group, a naphthalene group, a phenanthrene group, a dibenzofuran group, a dibenzothiophene group, a dibenzoselenophene group, a carbazole group, a fluorene group, or a dibenzosilole group; or
a benzene group, a naphthalene group, a phenanthrene group, a dibenzofuran group, a dibenzothiophene group, a dibenzoselenophene group, a carbazole group, a fluorene group, or a dibenzosilole group, each condensed with at least one of a cyclohexane group, a cyclohexene group, a norbornane group, a piperidine group, or a combination thereof.

In one or more embodiments, ring CY₂ in Formula 1 may be:
an imidazole group, a benzimidazole group, a pyridine group, a pyrimidine group, a pyridazine group, a pyrazine group, a triazine group, a quinoline group, an isoquinoline group, a quinoxaline group, or a quinazoline group; or
an imidazole group, a benzimidazole group, a pyridine group, a pyrimidine group, a pyridazine group, a pyrazine group, a triazine group, a quinoline group, an isoquinoline group, a quinoxaline group, or a quinazoline group, each condensed with at least one of a cyclohexane group, a cyclohexene group, a norbornane group, a benzene group, a pyridine group, a pyrimidine group, or a combination thereof.

In one or more embodiments, ring CY₄ in Formula 1 may be:
a pyridine group, a pyrimidine group, a pyridazine group, a pyrazine group, a triazine group, a quinoline group, an isoquinoline group, a quinoxaline group, a quinazoline group, an azadibenzofuran group, an azadibenzothiophene group, an azadibenzoselenophene group, an azacarbazole group, an azafluorene group, or an azadibenzosilole group; or
a pyridine group, a pyrimidine group, a pyridazine group, a pyrazine group, a triazine group, a quinoline group, an isoquinoline group, a quinoxaline group, a quinazoline group, an azadibenzofuran group, an azadibenzothiophene group, an azadibenzoselenophene group, an azacarbazole group, an azafluorene group, or an azadibenzosilole group, each condensed with at least one of a cyclohexane group, a cyclohexene group, a norbornane group, a benzene group, a pyridine group, a pyrimidine group, or a combination thereof.

Ring A₁ and ring A₃ in Formulae 2-1 and 2-2 may be different from each other.

In one or more embodiments, a Y₁-containing monocyclic group in ring A₁, a Y₂-containing monocyclic group in ring A₂, and Y₄-containing monocyclic group in ring A₄ may each be a 6-membered ring.

In one or more embodiments, a Y₃-containing monocyclic group in ring A₃ may be a 6-membered ring.

In one or more embodiments, a Y₃-containing monocyclic group in ring A₃ may be a 5-membered ring.

In one or more embodiments, a Y₁-containing monocyclic group in ring A₁ may be a 6-membered ring, and a Y₃-containing monocyclic group in ring A₃ may be a 5-membered ring.

In one or more embodiments, ring A₁ and ring A₃ in Formulae 2-1 and 2-2 may each independently be i) an A group, ii) a polycyclic group in which two or more A groups are condensed with each other, or iii) a polycyclic group in which at least one A group and at least one B group are condensed with each other,
the A group may be a pyridine group, a pyrimidine group, a pyridazine group, a pyrazine group, or a triazine group, and
the B group may be a cyclohexane group, a cyclohexene group, a norbornane group, a benzene group, a furan group, a thiophene group, a selenophene group, a pyrrole group, a cyclopentadiene group, or a silole group.

In one or more embodiments, in Formula 2-2, ring A₃ may be i) a C group, ii) a polycyclic group in which two or more C groups are condensed with each other, or iii) a polycyclic group in which at least one C group and at least one D group are condensed with each other,
the C group may be a pyrrole group, a pyrazole group, an imidazole group, a triazole group, an oxazole group, an isoxazole group, a thiazole group, or an isothiazole group, and
the D group may be a cyclohexane group, a cyclohexene group, a norbornane group, a benzene group, a furan group, a thiophene group, a selenophene group, a cyclopentadiene group, a silole group, a pyridine group, a pyrimidine group, a pyridazine group, a pyrazine group, or a triazine group.

In one or more embodiments, ring A₁ in Formula 2-1 may be:
a pyridine group, a pyrimidine group, a pyridazine group, or a pyrazine group; or
a pyridine group, a pyrimidine group, a pyridazine group, or a pyrazine group, each condensed with at least one of a cyclohexane group, a norbornane group, a benzene group, or a combination thereof.

In one or more embodiments, ring A₃ in Formula 2-2 may be:
a pyridine group, a pyrimidine group, a pyridazine group, or a pyrazine group;
a pyridine group, a pyrimidine group, a pyridazine group, or a pyrazine group, each condensed with at least one of a cyclohexane group, a norbornane group, a benzene group, or a combination thereof; or
an imidazole group, a benzimidazole group, a naphthoimidazole group, a phenanthrenoimidazole group, a pyridoimidazole group, an oxazole group, a benzoxazole group, a naphthooxazole group, a phenanthrenooxazole group, a pyridooxazole group, a thiazole group, a benzothiazole group, a naphthothiazole group, a phenanthrenothiazole group, or a pyridothiazole group.

In one or more embodiments, ring A₂ and ring A₄ in Formulae 2-1 and 2-2 may be different from each other.

In one or more embodiments, ring A₂ and ring A₄ in Formulae 2-1 and 2-2 may each independently be i) an E group, ii) a polycyclic group in which two or more E groups are condensed with each other, or iii) a polycyclic group in which at least one E group and at least one F group are condensed with each other,
the E group may be a benzene group, a pyridine group, a pyrimidine group, a pyridazine group, a pyrazine group, or a triazine group, and
the F group may be a furan group, a thiophene group, a selenophene group, a pyrrole group, a cyclopentadiene group, a silole group, a pyrazole group, an imidazole group, an oxazole group, a thiazole group, an isoxazole group, or an isothiazole group.

In one or more embodiments, ring A₂ in Formula 2-1 may be a polycyclic group in which two or more E groups and at least one F group are condensed with each other.

In one or more embodiments, ring A₄ in Formula 2-2 may be a polycyclic group in which two or more E groups and at least one F group are condensed with each other.

In one or more embodiments, ring A₂ in Formula 2-1 may be:
a benzene group, a naphthalene group, a phenanthrene group, a dibenzofuran group, a dibenzothiophene group, a dibenzoselenophene group, a carbazole group, a fluorene group, or a dibenzosilole group; or
a benzene group, a naphthalene group, a phenanthrene group, a dibenzofuran group, a dibenzothiophene group, a dibenzoselenophene group, a carbazole group, a fluorene group, or a dibenzosilole group, each condensed with at least one of a cyclohexane group, a norbornane group, a benzene group, or a combination thereof.

In one or more embodiments, ring A₄ in Formula 2-2 may be:
a benzene group, a naphthalene group, a phenanthrene group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, or a dibenzosilole group; or
a benzene group, a naphthalene group, a phenanthrene group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, or a dibenzosilole group, each condensed with at least one of a benzene group, a pyridine group, a pyrimidine group, a pyridazine group, a pyrazine group, a cyclohexane group, a norbornane group, a furan group, a thiophene group, a selenophene group, a pyrrole group, a cyclopentadiene group, a silole group, a pyrazole group, an imidazole group, an oxazole group, a thiazole group, an isoxazole group, an isothiazole group, or a combination thereof.

T₁₁ to T₁₄ in Formula 1 may each independently be a single bond, a double bond, *-N(R₅ₐ)-*', *-B(R₅ₐ)-*', *-P(R₅ₐ)-*', *-C(R₅ₐ)(R_{5b})-*', *-Si(R₅ₐ)(R_{5b})-*', *-Ge(R₅ₐ)(R_{5b})-*', *-S-*', *-Se-*', *-O-*', *-C(=O)-*', *-S(=O)-*', *-S(=O)₂-*', *-C(R₅ₐ)=*', *=C(R₅ₐ)-*', *-C(R₅ₐ)=C(R_{5b})-*', *-C(=S)-*', *-C≡C-*', a C₅-C₃₀ carbocyclic group that is unsubstituted or substituted with at least one R₁₀ₐ, or a C₁-C₃₀ heterocyclic group that is unsubstituted or substituted with at least one R₁₀ₐ.

For example, in Formula 1, T₁₁ and T₁₂ may each be a single bond, and T₁₃ may be a single bond, *-N(Rsa)-*', *-B(R₅ₐ)-*', *-P(R₅ₐ)-*', *-C(R₅ₐ)(R_{5b})-*', *-Si(R₅ₐ)(R_{5b})-*', *-Ge(R₅ₐ)(R_{5b})-*', *-S-*', or *-O-*'.

n1 to n4 in Formula 1 indicate the number of T₁₁(s) to the number of T₁₄(s), respectively, and may each independently be 0 or 1, wherein three or more of n1 to n4 may each be 1. That is, the organometallic compound represented by Formula 1 may have a tetradentate ligand.

In Formula 1, when n1 is 0, T₁₁ may not exist (that is, ring CY₁ and ring CY₂ are not linked to each other), when n2 is 0, T₁₂ may not exist (that is, ring CY₂ and ring CY₃ are not linked to each other), when n3 is 0, T₁₃ may not exist (that is, ring CY₃ and ring CY₄ are not linked to each other), and when n4 is 0, T₁₄ may not exist (that is, ring CY₄ and ring CY₁ are not linked to each other).

In one or more embodiments, n1 to n3 in Formula 1 may each be 1, and n4 may be 0.

L₁ to L₄ and W₁ to W₄ in Formulae 1, 2-1, and 2-2 may each independently be a single bond, a C₅-C₃₀ carbocyclic group that is unsubstituted or substituted with at least one R₁₀ₐ, or a C₁-C₃₀ heterocyclic group that is unsubstituted or substituted with at least one R₁₀ₐ.

For example, L₁ to L₄ and W₁ to W₄ in Formulae 1, 2-1, and 2-2 may each independently be:
a single bond; or
a cyclopentene group, a cyclohexane group, a cyclohexene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group, each substituted or unsubstituted with at least one R₁₀ₐ.

In one or more embodiments, L₁ to L₄ and W₁ to W₄ in Formulae 1, 2-1, and 2-2 may each independently be:
a single bond; or
a benzene group, a naphthalene group, a pyridine group, a fluorene group, a carbazole group, a dibenzofuran group, or a dibenzothiophene group, each unsubstituted or substituted with at least one R₁₀ₐ.

In one or more embodiments, L₁ to L₄ and W₁ to W₄ in Formulae 1, 2-1, and 2-2 may each independently be:
a single bond; or
a C₁-C₂₀ alkylene group, a benzene group, a naphthalene group, a dibenzofuran group, or a dibenzothiophene group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or a combination thereof.

b1 to b4 in Formula 1 indicate the number of L₁(s) to the number of L₄(s), respectively, and may each independently be an integer from 1 to 10. When b1 is 2 or more, two or more of L₁(s) may be identical to or different from each other, when b2 is 2 or more, two or more of L₂(s) may be identical to or different from each other, when b3 is 2 or more, two or more of L₃(s) may be identical to or different from each other, and when b4 is 2 or more, two or more of L₄(s) may be identical to or different from each other. For example, b1 to b4 may each independently be 1, 2, or 3.

R₁ to R₄, R₅ₐ, R_{5b}, R', R", and Z₁ to Z₄ in Formulae 1, 2-1, and 2-2 may each independently be hydrogen, deuterium, -F, -Cl, -Br, -I, -SFs, a hydroxyl group, a cyano group, a nitro group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ heteroarylalkyl group, a substituted or unsubstituted C₂-C₆₀ alkyl heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(=O)(Q₈)(Q₉), or -P(Q₈)(Q₉). Q₁ to Q₉ are each as described herein.

For example, R₁ to R₄, R₅ₐ, R_{5b}, R, R", and Z₁ to Z₄ in Formulae 1, 2-1, and 2-2 may each independently be:
hydrogen, deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₂-C₂₀ alkenyl group, a C₁-C₂₀ alkoxy group, or a C₁-C₂₀ alkylthio group;
a C₁-C₂₀ alkyl group, a C₂-C₂₀ alkenyl group, a C₁-C₂₀ alkoxy group, or a C₁-C₂₀ alkylthio group, each substituted with at least one of deuterium, -F, -CI, - Br, -I, -SF₅, CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group (i.e., a bicyclo[2.2.1]heptyl group), a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with at least one of deuterium, -F, -Cl, -Br, -I, -SFs, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterated C₁-C₂₀ alkyl group, a fluorinated C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a deuterated phenyl group, a fluorinated phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or
-N(Q₁)(Q₂), -Si(Q₃)(Q₄)(Q₅), -Ge(Q₃)(Q₄)(Q₅), -B(Q₆)(Q₇), -P(=O)(Q₈)(Q₉), or -P(Q₈)(Q₉), and
Q₁ to Q₉ may each independently be:
   deuterium, -F, -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, -CD₂CDH₂, -CF₃, -CF₂H, -CFH₂, -CH₂CF₃, -CH₂CF₂H, -CH₂CFH₂, -CHFCH₃, - CHFCF₂H, -CHFCFH₂, -CHFCF₃, -CF₂CF₃, -CF₂CF₂H, or -CF₂CFH₂; or
   an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, -F, a C₁-C₁₀ alkyl group, a phenyl group, or a combination thereof.

In one or more embodiments, R₁ to R₄, R₅ₐ, R_{5b}, R', R", and Z₁ to Z₄ in Formulae 1, 2-1, and 2-2 may each independently be:
hydrogen, deuterium, -F, or a cyano group;
a C₁-C₂₀ alkyl group unsubstituted or substituted with at least one of deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or a combination thereof;
a C₃-C₁₀ cycloalkyl group, a C₁-C₁₀ heterocycloalkyl group, a phenyl group, a biphenyl group, a naphthyl group, a pyridinyl group, a fluorenyl group, a carbazolyl group, a dibenzofuranyl, or a dibenzothiophenyl group, each unsubstituted or substituted with at least one of deuterium, -F, a cyano group, a C₁-C₂₀ alkyl group, a deuterated C₁-C₂₀ alkyl group, fluorinated C₁-C₂₀ alkyl group, a C₁-C₂₀ alkoxy group, a deuterated C₁-C₂₀ alkoxy group, a fluorinated C₁-C₂₀ alkoxy group, a C₁-C₂₀ alkylthio group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or a combination thereof; or
-Si(Q₃)(Q₄)(Q₅) or -Ge(Q₃)(Q₄)(Q₅).

In one or more embodiments, in Formula 2-1, each of e1 and d1 may not be 0, and at least one of Z₁(s) may be a deuterated C₁-C₂₀ alkyl group, -Si(Q₃)(Q₄)(Q₅), or - Ge(Q₃)(Q₄)(Q₅). Q₃ to Q₅ are each as described herein.

For example, Q₃ to Q₅ may each independently be:
a C₁-C₆₀ alkyl group unsubstituted or substituted with at least one of deuterium, a C₁-C₆₀ alkyl group, a C₆-C₆₀ aryl group, or a combination thereof; or
a C₆-C₆₀ aryl group unsubstituted or substituted with at least one of deuterium, a C₁-C₆₀ alkyl group, a C₆-C₆₀ aryl group, or a combination thereof.

In one or more embodiments, Q₃ to Q₅ may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or - CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, a C₁-C₁₀ alkyl group, a phenyl group, or a combination thereof.

In one or more embodiments, Q₃ to Q₅ may be identical to each other.

In one or more embodiments, two or more of Q₃ to Q₅ may be different from each other.

In one or more embodiments, the organometallic compound represented by Formula 2 may satisfy at least one of Condition (1) to Condition (8):
Condition (1)
   each of e1 and d1 in Formula 2-1 is not 0, and at least one Z₁ includes deuterium;
Condition (2)
   each of e2 and d2 in Formula 2-1 is not 0, and at least one Z₂ includes deuterium;
Condition (3)
   each of e3 and d3 in Formula 2-2 is not 0, and at least one Z₃ includes deuterium;
Condition (4)
   each of e4 and d4 in Formula 2-2 is not 0, and at least one Z₄ includes deuterium;
Condition (5)
   each of e1 and d1 in Formula 2-1 is not 0, and at least one Z₁ includes a fluoro group;
Condition (6)
   each of e2 and d2 in Formula 2-1 is not 0, and at least one Z₂ includes a fluoro group;
Condition (7)
   each of e3 and d3 in Formula 2-2 is not 0, and at least one Z₃ includes a fluoro group; and
Condition (8)
   each of e4 and d4 in Formula 2-2 is not 0, and at least one Z₄ includes a fluoro group.

In one or more embodiments, R₁ to R₄, R₅ₐ, R_{5b}, R', R", and Z₁ to Z₄ in Formulae 1, 2-1, and 2-2 may each independently be hydrogen, deuterium, -F, -CH₃, -CD₃, -CD₂H, -CDH₂, -CF₃, -CF₂H, -CFH₂, a C₂-C₁₀ alkenyl group, a C₁-C₁₀ alkoxy group, a C₁-C₁₀ alkylthio group, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-227, a group represented by one of Formulae 9-201 to 9-227 in which at least one hydrogen is substituted with deuterium, a group represented by one of Formulae 9-201 to 9-227 in which at least one hydrogen is substituted with -F, a group represented by one of Formulae 10-1 to 10-129, a group represented by one of Formulae 10-1 to 10-129 in which at least one hydrogen is substituted with deuterium, a group represented by one of Formulae 10-1 to 10-129 in which at least one hydrogen is substituted with -F, a group represented by one of Formulae 10-201 to 10-350, a group represented by one of Formulae 10-201 to 10-350 in which at least one hydrogen is substituted with deuterium, a group represented by one of Formulae 10-201 to 10-350 in which at least one hydrogen is substituted with -F, -Si(Q₃)(Q₄)(Q₅), or -Ge(Q₃)(Q₄)(Q₅) (where Q₃ to Q₅ are each as described herein):

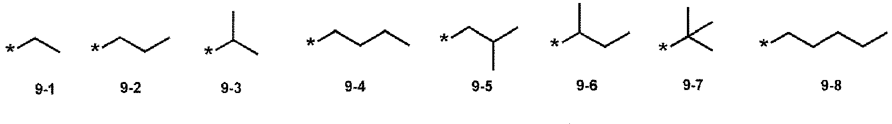

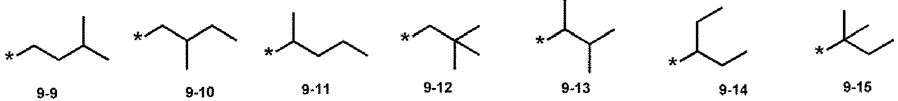

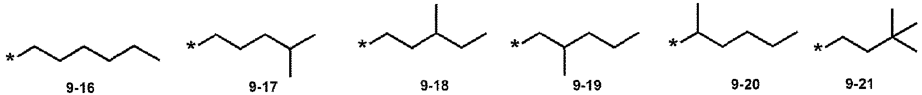

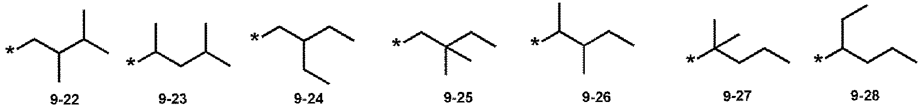

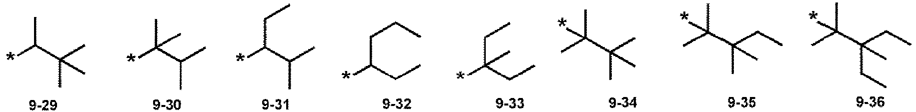

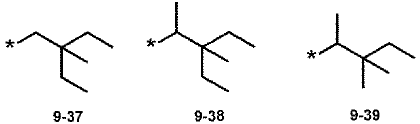

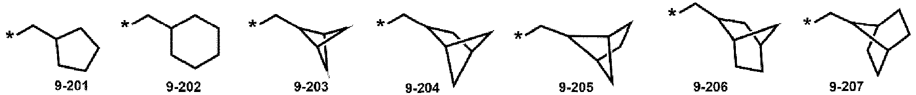

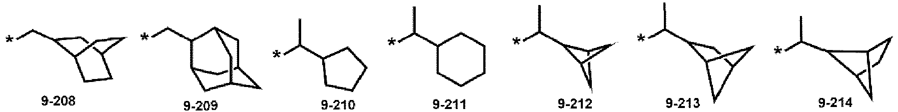

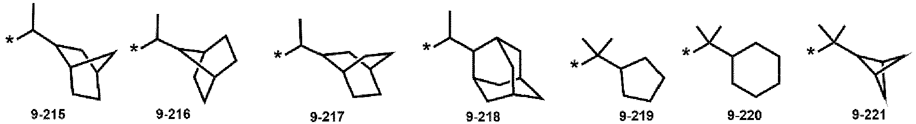

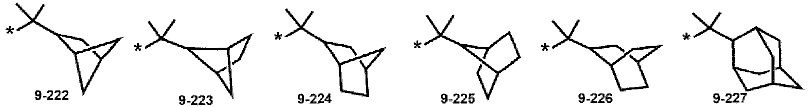

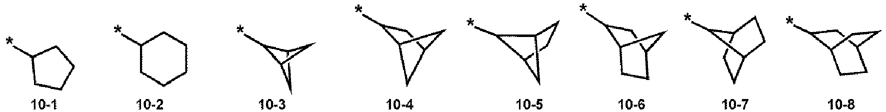

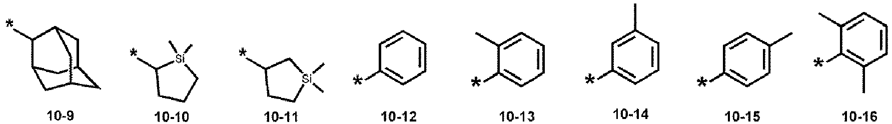

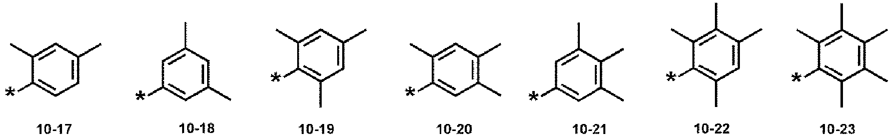

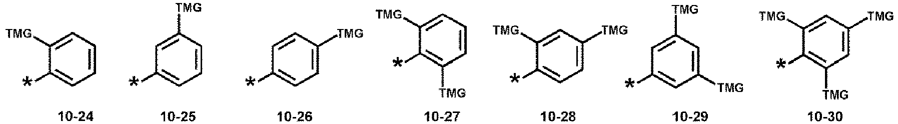

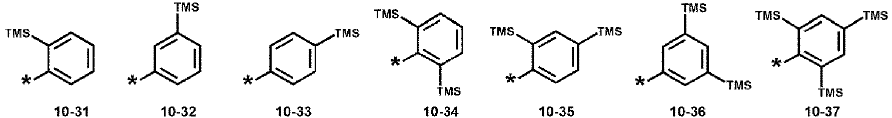

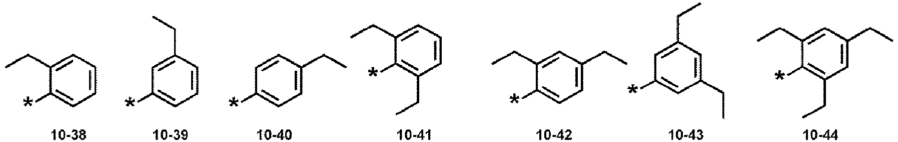

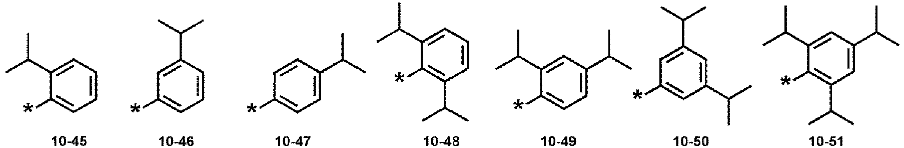

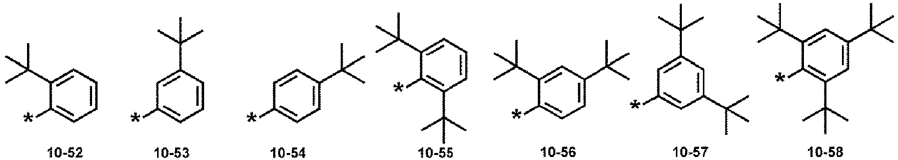

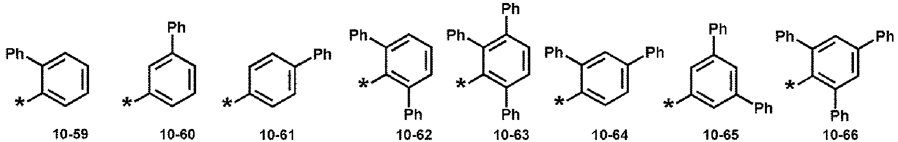

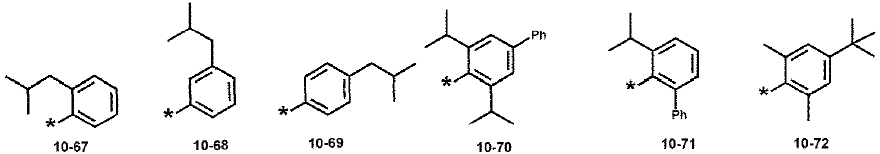

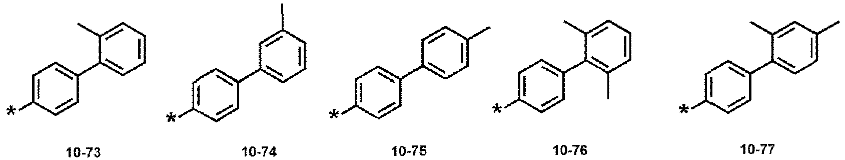

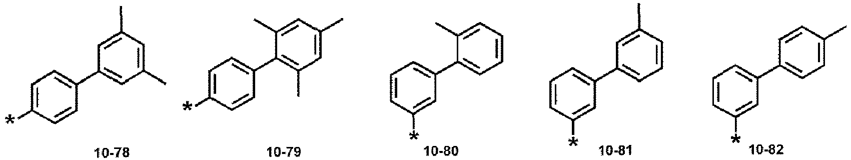

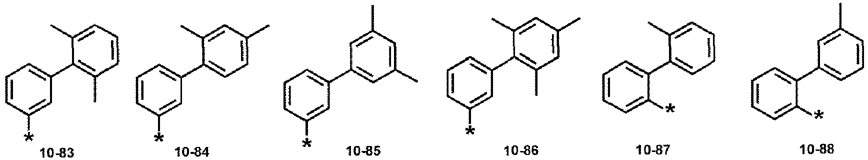

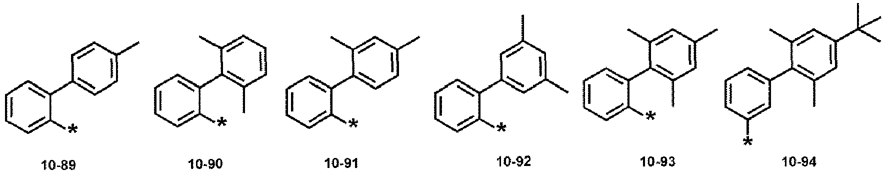

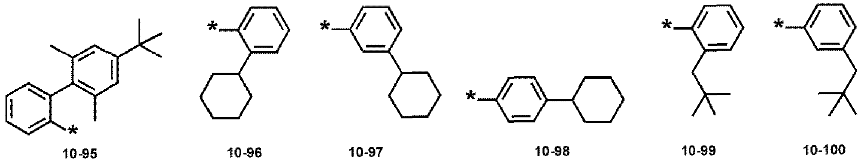

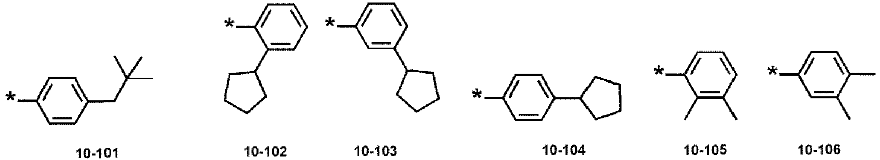

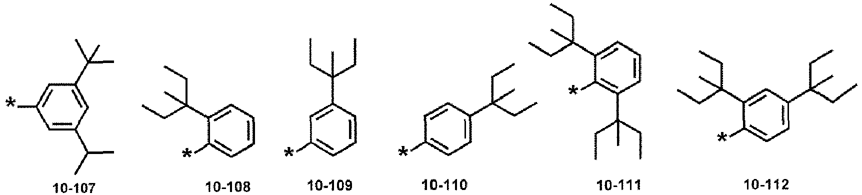

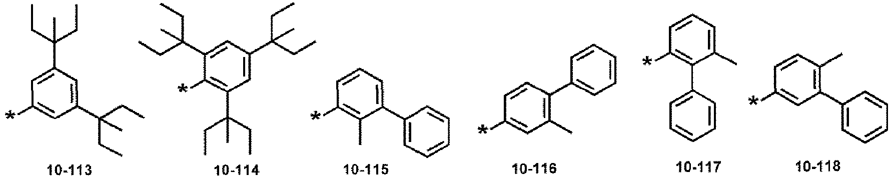

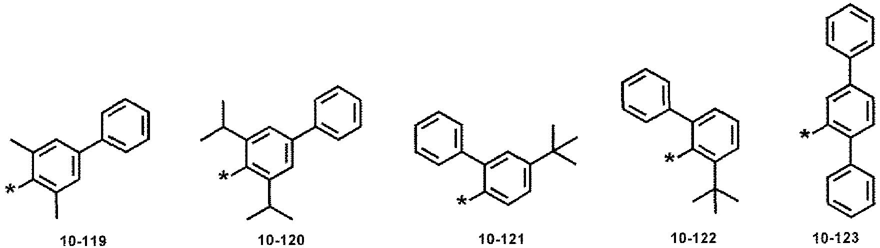

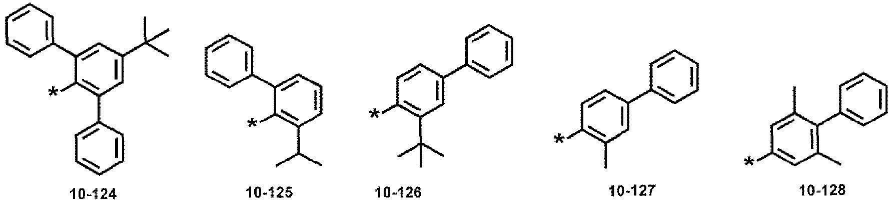

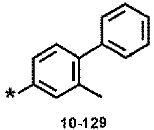

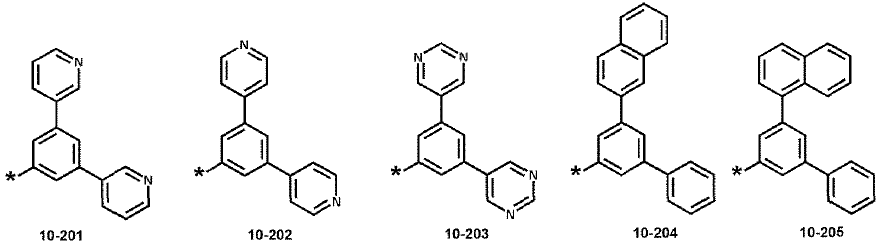

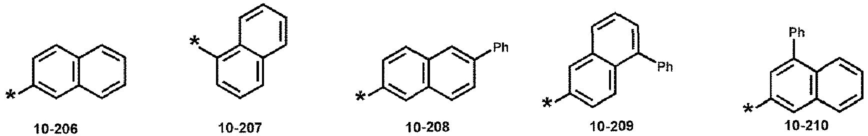

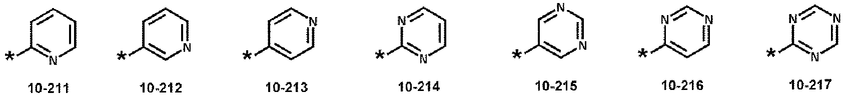

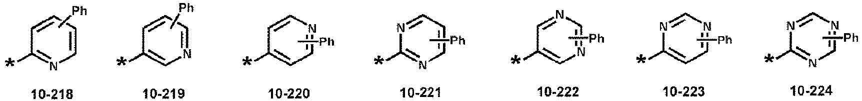

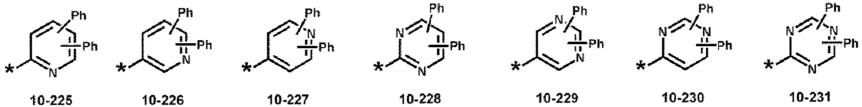

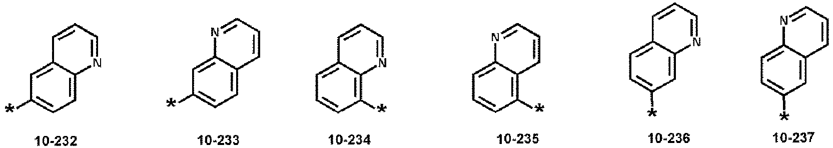

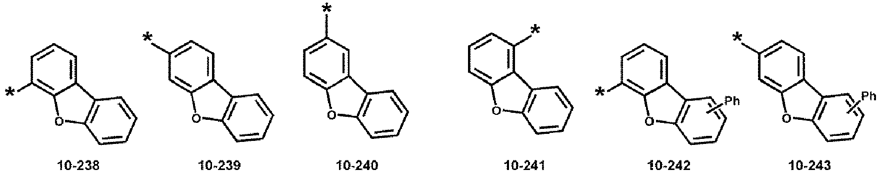

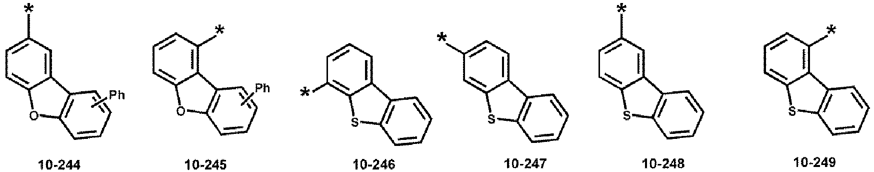

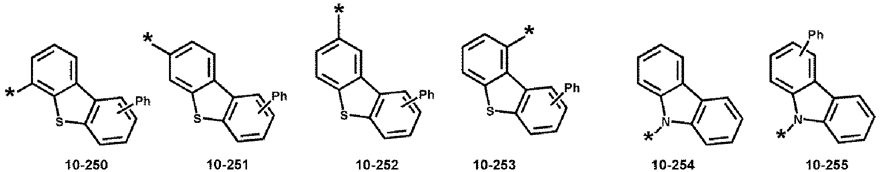

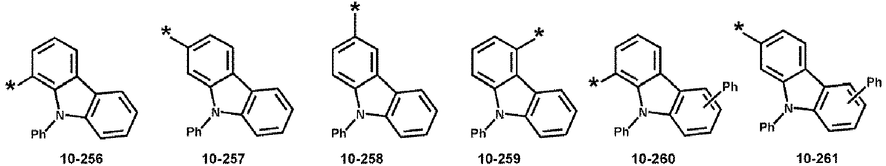

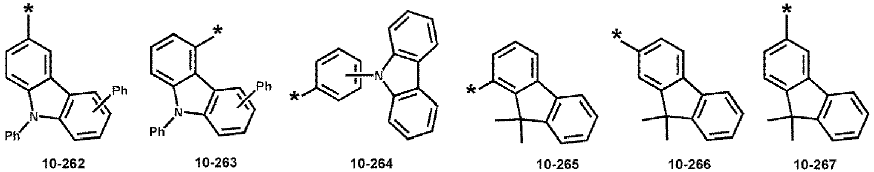

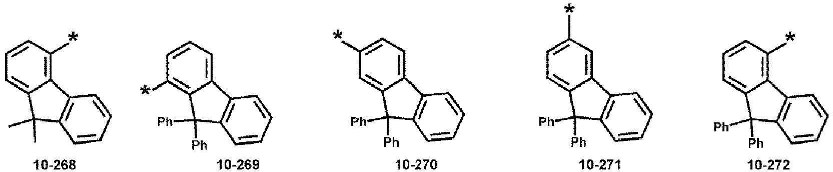

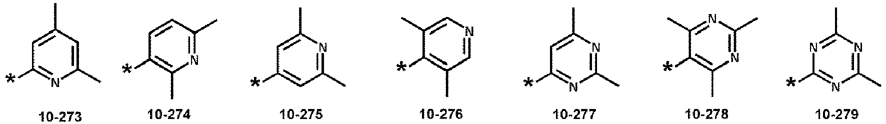

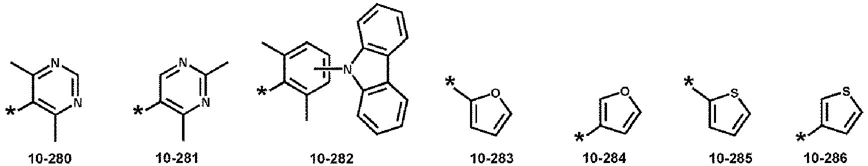

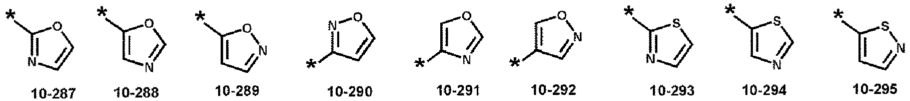

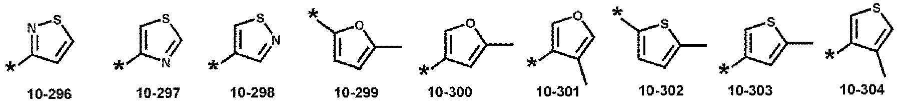

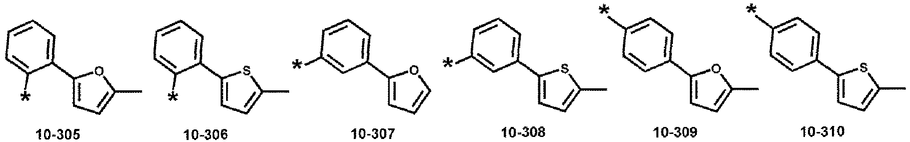

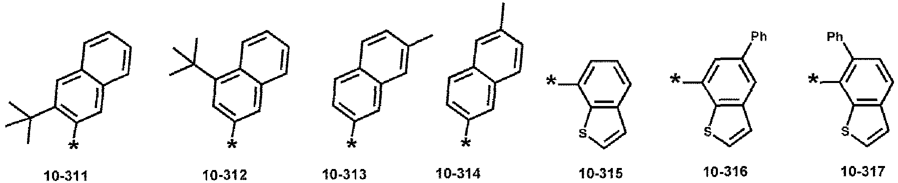

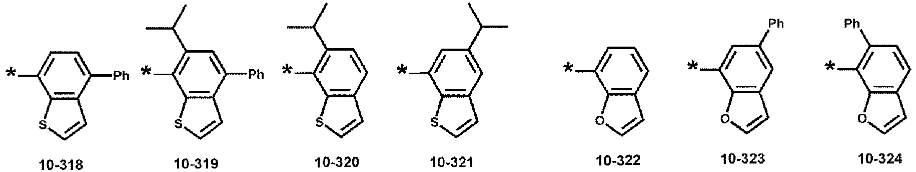

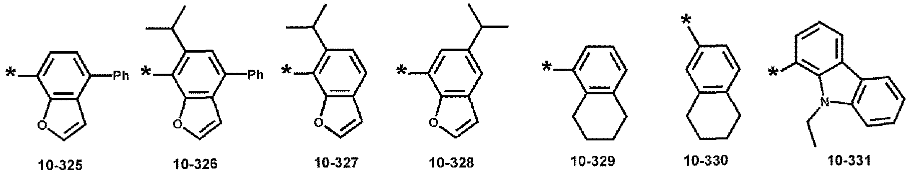

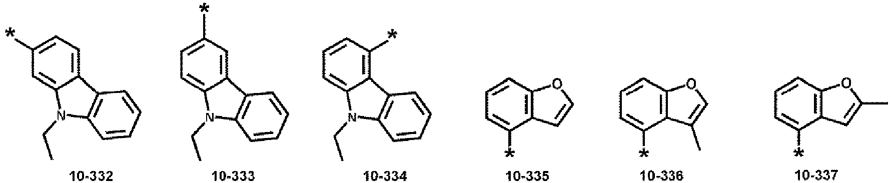

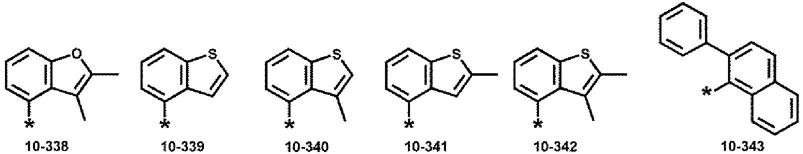

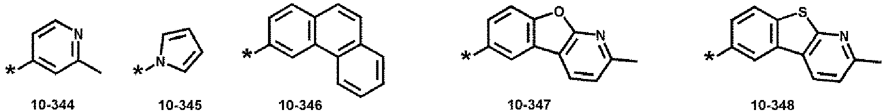

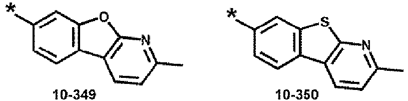

In Formulae 9-1 to 9-39, 9-201 to 9-227, 10-1 to 10-129, and 10-201 to 10-350, * indicates a binding site to a neighboring atom, "Ph" is a phenyl group, "TMS" is a trimethylsilyl group, and "TMG" is a trimethylgermyl group.

The "group represented by one of Formulae 9-1 to 9-39 in which at least one hydrogen is substituted with deuterium" and the "group represented by one of Formulae 9-201 to 9-227 in which at least one hydrogen is substituted with deuterium" may each be, for example, a group represented by one of Formulae 9-501 to 9-514 or 9-601 to 9-636:

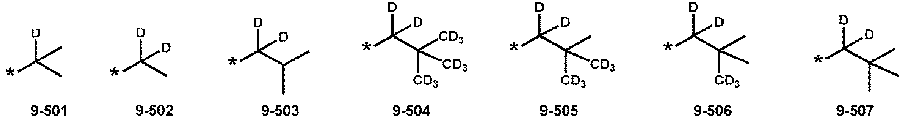

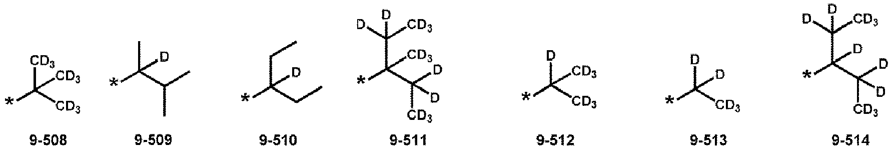

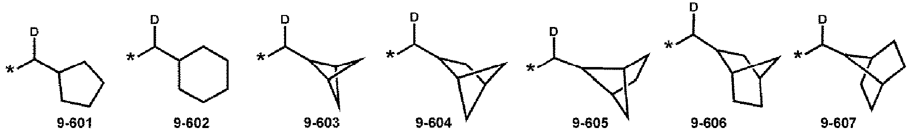

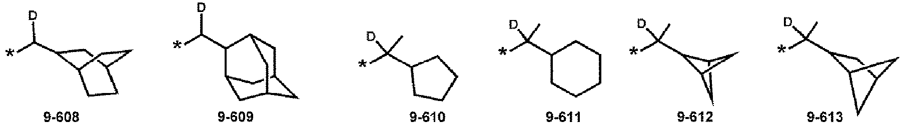

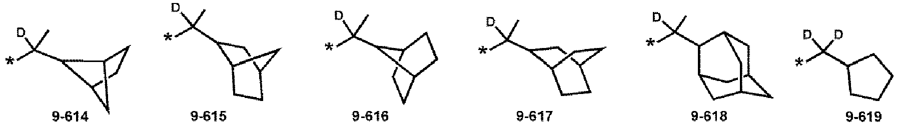

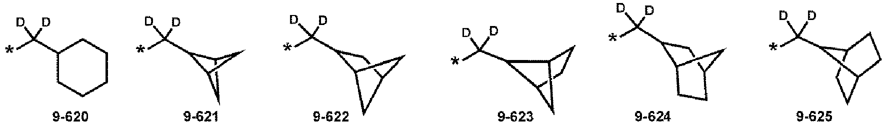

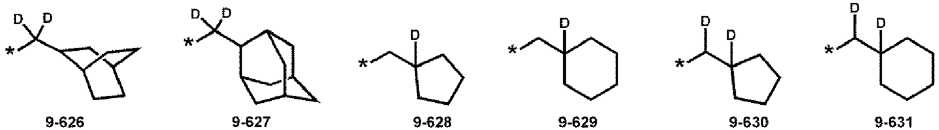

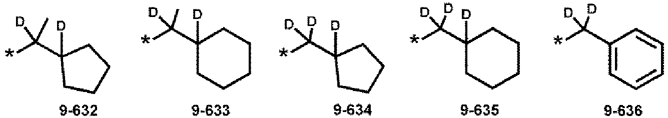

The "group represented by one of Formulae 9-1 to 9-39 in which at least one hydrogen is substituted with -F" and the "group represented by one of Formulae 9-201 to 9-227 in which at least one hydrogen is substituted with -F" may each be, for example, a group represented by one of Formulae 9-701 to 9-710:

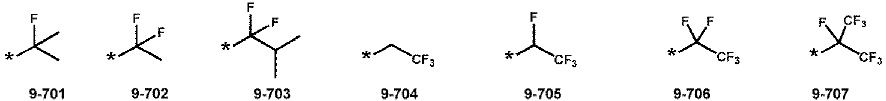

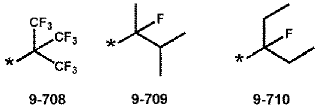

The "group represented by one of Formulae 10-1 to 10-129 in which at least one hydrogen is substituted with deuterium" and the "group represented by one of Formulae 10-201 to 10-350 in which at least one hydrogen is substituted with deuterium" may be, for example, a group represented by one of Formulae 10-501 to 10-553:

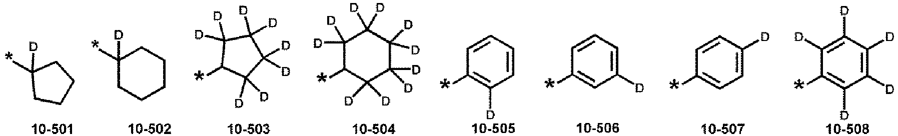

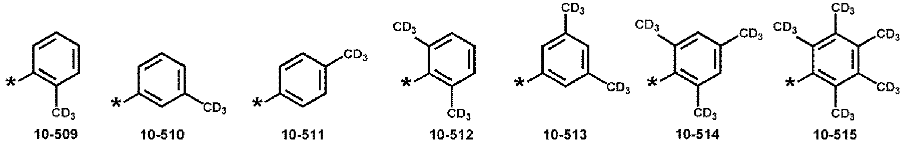

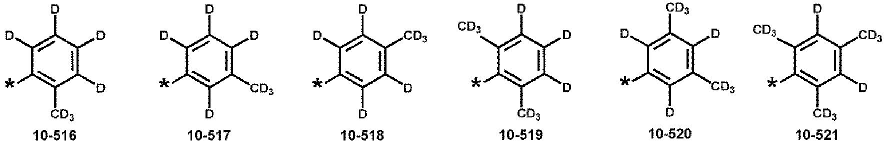

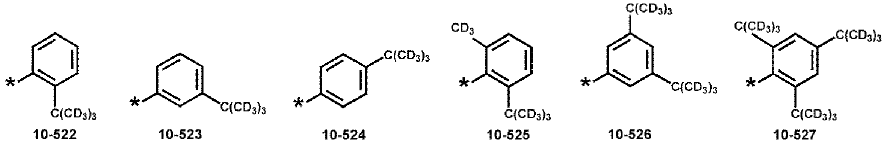

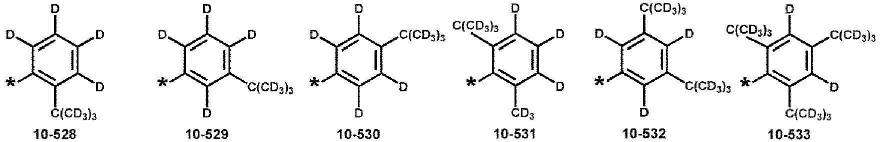

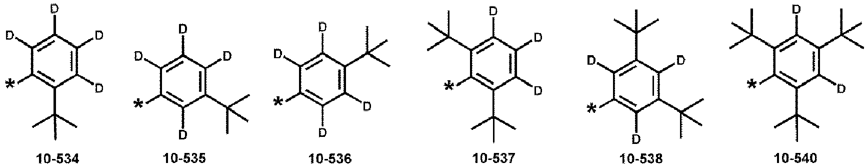

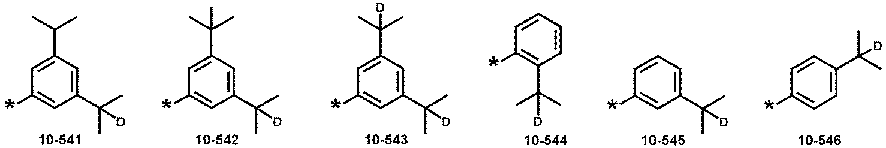

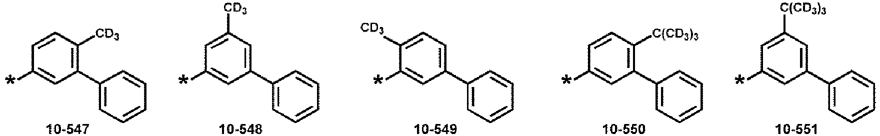

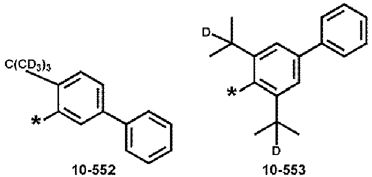

The "group represented by one of Formulae 10-1 to 10-129 in which at least one hydrogen is substituted with -F" and the "group represented by one of Formulae 10-201 to 10-350 in which at least one hydrogen is substituted with -F" may be, for example, a group represented by one of Formulae 10-601 to 10-617:

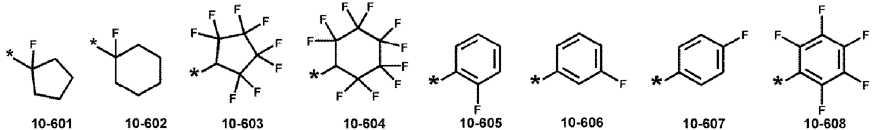

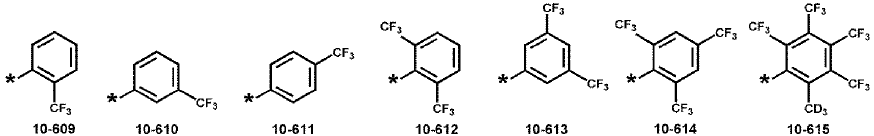

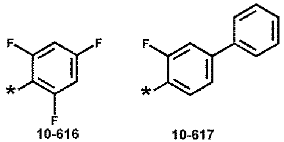

In Formulae 1, 2-1, and 2-2, c1 to c4 indicate the number of R₁(s) to the number of R₄(s), respectively; a1 to a4 indicate the number of groups represented by *-[(L₁)_{b1}-(R₁)_{c1}], the number of groups represented by *-[(L₂)_{b2}-(R₂)_{c2}], the number of groups represented by *-[(L₃)_{b3}-(R₃)_{c3}], and the number of groups represented by *-[(L₄)_{b4}-(R₄)_{c4}], respectively; e1 to e4 indicate the number of Z₁(s) to the number of Z₄(s), respectively; and d1 to d4 indicate the number of a group(s) represented by *-[W₁-(Z₁)ₑ₁], the number of groups represented by *-[W₂-(Z₂)ₑ₂], the number of groups represented by *-[W₃-(Z₃)ₑ₃], and the number of groups represented by *-[W₄-(Z₄)ₑ₄], respectively, and c1 to c4, a1 to a4, e1 to e4, and d1 to d4 may each independently be an integer from 0 to 20. When c1 is 2 or more, two or more of R₁(s) may be identical to or different from each other, when c2 is 2 or more, two or more of R₂(s) may be identical to or different from each other, when c3 is 2 or more, two or more of R₃(s) may be identical to or different from each other, when c4 is 2 or more, two or more of R₄(s) may be identical to or different from each other, when a1 is 2 or more, two or more of groups represented by *-[(L₁)_{b1}-(R₁)_{c1}] may be identical to or different from each other, when a2 is 2 or more, two or more of groups represented by *-[(L₂)_{b2}-(R₂)_{c2}] may be identical to or different from each other, when a3 is 2 or more, two or more of groups represented by *-[(L₃)_{b3}-(R₃)_{c3}] may be identical to or different from each other, when a4 is 2 or more, two or more of groups represented by *-[(L₄)_{b4}-(R₁)_{c4}] may be identical to or different from each other, when e1 is 2 or more, two or more of Z₁(s) may be identical to or different from each other, when e2 is 2 or more, two or more of Z₂(s) may be identical to or different from each other, when e3 is 2 or more, two or more of Z₃(s) may be identical to or different from each other, when e4 is 2 or more, two or more of Z₄(s) may be identical to or different from each other, when d1 is 2 or more, two or more of groups represented by *-[W₁-(Z₁)ₑ₁] may be identical to or different from each other, when d2 is 2 or more, two or more of groups represented by *-[W₂-(Z₂)ₑ₂] may be identical to or different from each other, when d3 is 2 or more, two or more of groups represented by *-[W₃-(Z₃)ₑ₃] may be identical to or different from each other, and when d4 is 2 or more, two or more of groups represented by *-[W₄-(Z₄)ₑ₁] may be identical to or different from each other. For example, c1 to c4, a1 to a4, e1 to e4, and d1 to d4 in Formulae 1, 2-1, and 2-2 may each independently be 0, 1, 2, or 3.

In one or more embodiments, the first compound and the second compound may each not be tris[2-phenyl pyridine]iridium.

In one or more embodiments, in Formula 2-1, a case where Y₁ is N, ring A₁ is a pyridine group, Y₂ is C, ring A₂ is a benzene group, and d1 and d2 are each 0 may be excluded.

In Formulae 1, 2-1, and 2-2, at least one of i) two or more of a plurality of R₁(s), ii) two or more of a plurality of R₂(s), iii) two or more of a plurality of R₃(s), iv) two or more of a plurality of R₄(s), v) R₅ₐ and R_{5b}, vi) two or more of a plurality of Z₁(s), vii) two or more of a plurality of Z₂(s), viii) two or more of a plurality of Z₃(s), ix) two or more of a plurality of Z₄(s), x) two or more of R₁ to R₄, R₅ₐ, and R_{5b}, and xi) two or more of Z₁ to Z₄, may optionally be linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ. For example, in Formulae 1, 2-1, and 2-2, i) two or more of a plurality of R₁(s) may optionally be linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, ii) two or more of a plurality of R₂(s) may optionally be linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, iii) two or more of a plurality of R₃(s) may optionally be linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, iv) two or more of a plurality of R₄(s) may optionally be linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, v) R₅ₐ and R_{5b} may optionally be linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, vi) two or more of a plurality of Z₁(s) may optionally be linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, vii) two or more of a plurality of Z₂(s) may optionally be linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, viii) two or more of a plurality of Z₃(s) may optionally be linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, ix) two or more of a plurality of Z₄(s) may optionally be linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, x) two or more of R₁ to R₄, R₅ₐ, and R_{5b}may optionally be linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, and/or xi) two or more of Z₁ to Z₄ may optionally be linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ.

R₁₀ₐ is as described in connection with R₁ herein.

The symbols * and *' as used herein each indicate a binding site to a neighboring atom, unless otherwise stated.

In one or more embodiments, in Formula 1, n1 may not be 0, n4 may be 0, and a group represented by 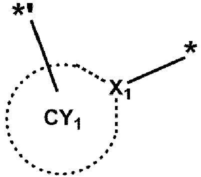
may be a group represented by one of Formulae CY1(1) to CY1(23): 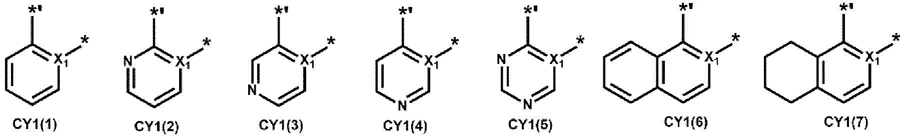 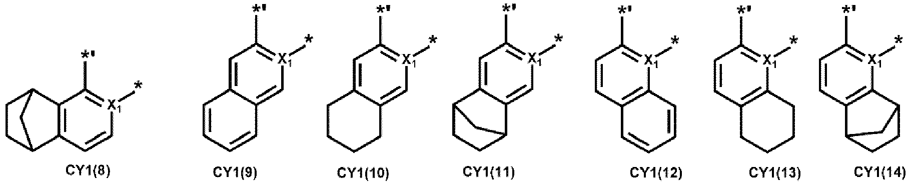 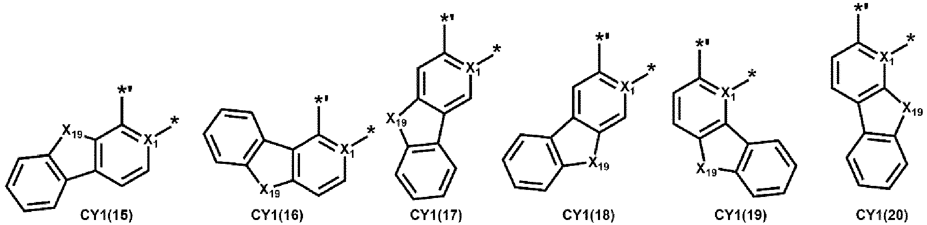 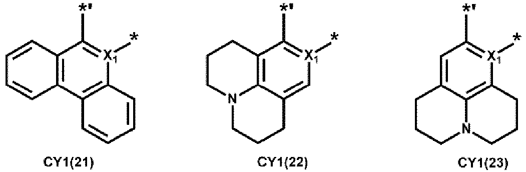
wherein, in Formulae CY1(1) to CY1(23),
   X₁ is as described herein,
   X₁₉ may be O, S, Se, N(R₁₉ₐ), C(R₁₉ₐ)(R_{19b}), or Si(R₁₉ₐ)(R_{19b}),
   R₁₉ₐ and R_{19b} are each as described in connection with R₁ herein,
   * indicates a binding site to X₅ or M₁ in Formula 1, and
   *' indicates a binding site to T₁₁ in Formula 1.

In one or more embodiments, in Formula 1, n1 may be 1, n4 may be 0, and a group represented by 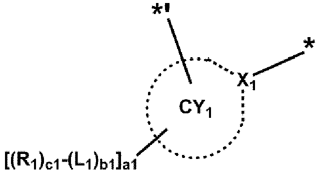
may be a group represented by one of Formulae CY1-1 to CY1-18: 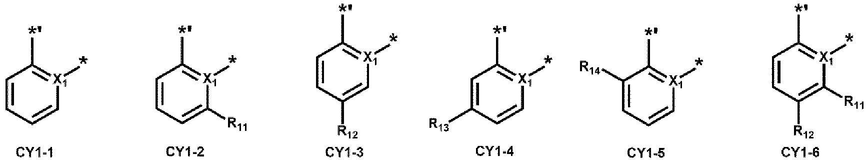 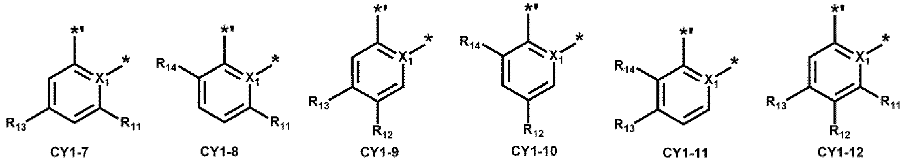 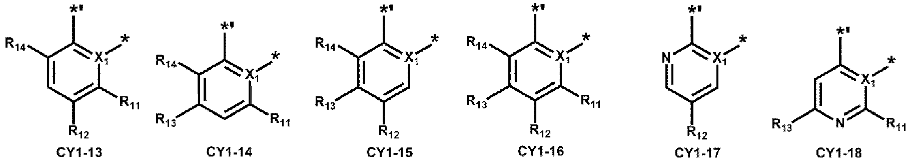
wherein, in Formulae CY1-1 to CY1-18,
   X₁ is as described herein,
   R₁₁ to R₁₄ are each as described in connection with R₁ herein, wherein R₁₁ to R₁₄ are each not hydrogen,
   * indicates a binding site to X₅ or M₁ in Formula 1, and
   *' indicates a binding site to T₁₁ in Formula 1.

In one or more embodiments, in Formula 1, n1 and n2 may each be 1, and ring CY₂ may be a group represented by Formula CY2A or CY2B: 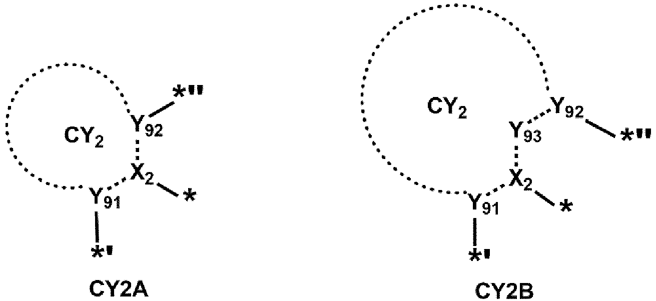 wherein, in Formulae CY2A and CY2B,
X₂ and ring CY₂ are each as described herein,
Y₉₁ and Y₉₂ may each independently be N, C, or Si, and Y₉₃ may be O, S, N, C, or Si,
in Formulae CY2A and CY2B, a bond between X₂ and Y₉₁, a bond between X₂ and Y₉₂, a bond between X₂ and Y₉₃, and a bond between Y₉₂ and Y₉₃ may each be a chemical bond,
*' indicates a binding site to T₁₁ in Formula 1,
* indicates a binding site to X₆ or M₁ in Formula 1, and
*" indicates a binding site to T₁₂ in Formula 1.

In one or more embodiments, in Formula 1, n1 and n2 may each not be 0, and a group represented by 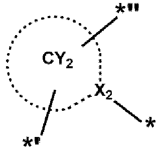
may be a group represented by one of Formulae CY2(1) to CY2(21): 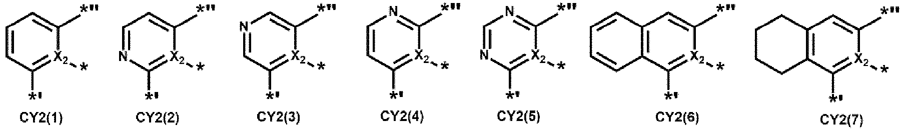 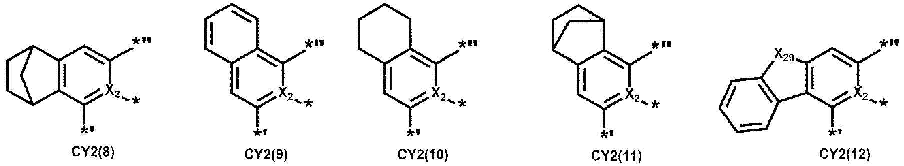 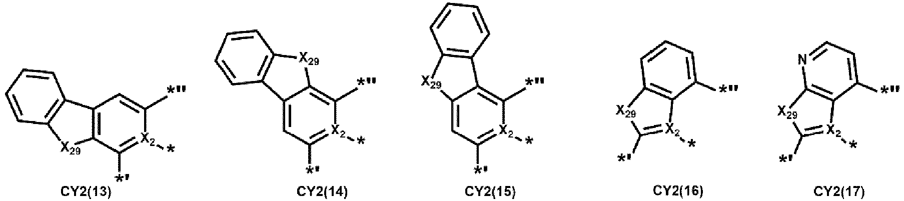 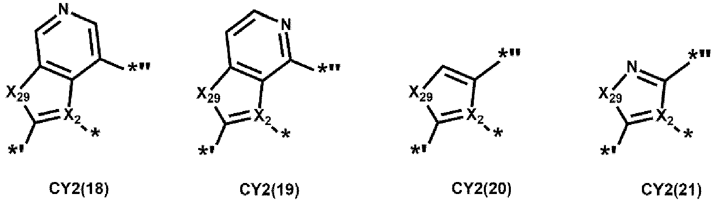
wherein, in Formulae CY2(1) to CY2(21),
   X₂ is as described herein,
   X₂₉ may be O, S, N-[(L₂)_{b2}-(R₂)_{c2}], C(R₂₉ₐ)(R_{29b}), or Si(R₂₉ₐ)(R_{29b}),
   L₂, b2, R₂, and c2 are each as described herein,
   R₂₉ₐ and R_{29b} are each as described in connection with R₂ herein,
   *' indicates a binding site to T₁₁ in Formula 1,
   * indicates a binding site to X₆ or M₁ in Formula 1, and
   *" indicates a binding site to T₁₂ in Formula 1.

In one or more embodiments, in Formula 1, n1 and n2 may each be 1, and a group represented by 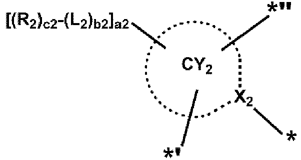
may be a group represented by one of Formulae CY2-1 to CY2-16: 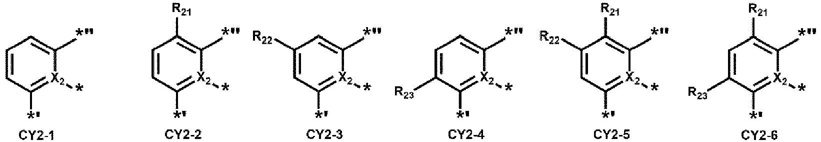 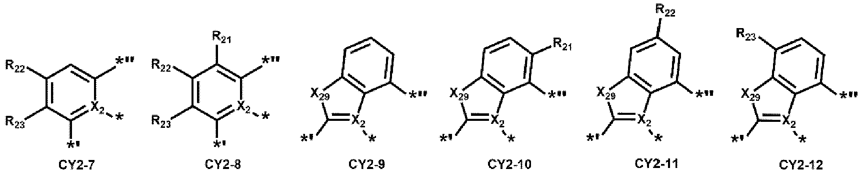 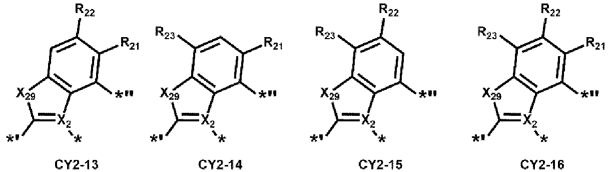
wherein, in Formulae CY2-1 to CY2-16,
   X₂ is as described herein,
   X₂₉ may be O, S, N-[(L₂)_{b2}-(R₂)_{c2}], C(R₂₉ₐ)(R_{29b}), or Si(R₂₉ₐ)(R_{29b}),
   L₂, b2, R₂, and c2 are each as described herein,
   R₂₁ to R₂₃, R₂₉ₐ, and R_{29b} are each as described in connection with R₂ herein, wherein R₂₁ to R₂₃ are each not hydrogen,
   *' indicates a binding site to T₁₁ in Formula 1,
   * indicates a binding site to M₁ in Formula 1, and
   *" indicates a binding site to T₁₂ in Formula 1.

In one or more embodiments, in Formula 1,
n1 and n2 may each be 1,
a group represented by 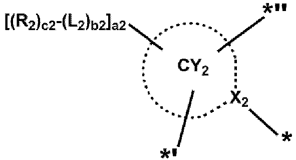
may be represented by one of Formulae CY2-9 to CY2-16,
X₂₉ in Formulae CY2-9 to CY2-16 may be N-[(L₂)_{b2}-(R₂)_{c2}],
L₂ may be a benzene group unsubstituted or substituted with at least one R₁₀ₐ,
b2 may be 1 or 2,
c2 may be 1 or 2,
when c2 is 1, R₂ may be a phenyl group unsubstituted or substituted with at least one of deuterium, a C₁-C₂₀ alkyl group, a phenyl group, a deuterated phenyl group, a (C₁-C₂₀alkyl)phenyl group, or a combination thereof; and when c2 is 2, a) one of two R₂(s) may be a phenyl group unsubstituted or substituted with deuterium, a C₁-C₂₀ alkyl group, a phenyl group, a deuterated phenyl group, a (C₁-C₂₀ alkyl)phenyl group, or a combination thereof, and b) the other R₂ may be a C₄-C₂₀ alkyl group or a deuterated C₁-C₂₀ alkyl group, each unsubstituted or substituted with a C₃-C₁₀ cycloalkyl group.

In one or more embodiments, in Formula 1, n2 and n3 may each not be 0, and a group represented by 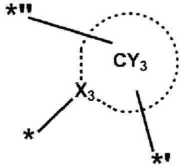
may be a group represented by one of Formulae CY3(1) to CY3(15): 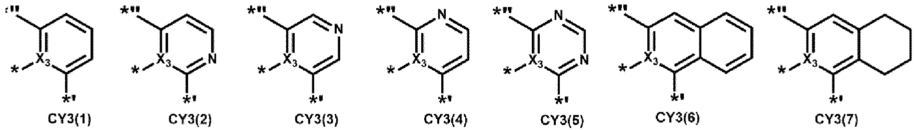 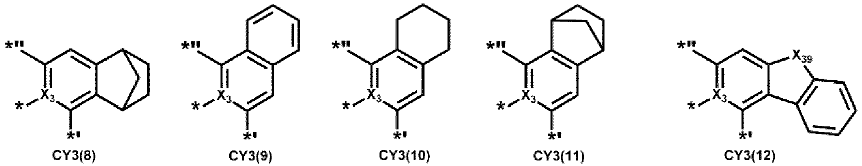 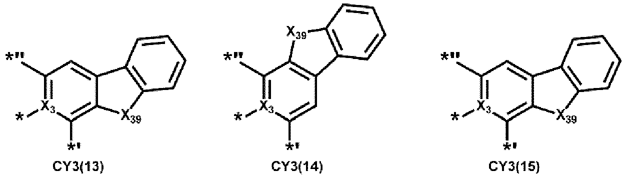
wherein, in Formulae CY3(1) to CY3(15),
   X₃ is as described herein,
   X₃₉ may be O, S, N(Z₃₉ₐ), C(R₃₉ₐ)(R_{39b}), or Si(R₃₉ₐ)(R_{39b}),
   R₃₉ₐ and R_{39b} are each as described in connection with R₃ herein,
   *" indicates a binding site to T₁₂ in Formula 1,
   * indicates a binding site to X₇ or M₁ in Formula 1, and
   *' indicates a binding site to T₁₃ in Formula 1.

In one or more embodiments, in Formula 1, n2 and n3 may each be 1, and a group represented by 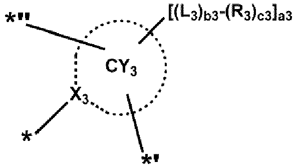
may be a group represented by one of Formulae CY3-1 to CY3-13: 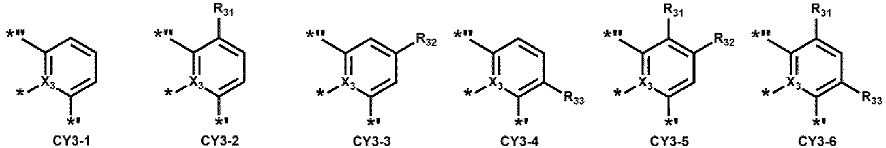 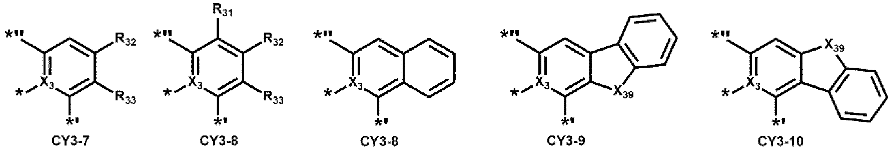 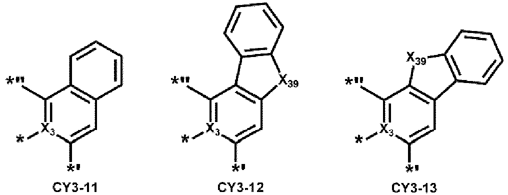
wherein, in Formulae CY3-1 to CY3-13,
   X₃ is as described herein,
   X₃₉ may be O, S, N-[(L₃)_{b3}-(R₃)_{c3}], C(R₃₉ₐ)(R_{39b}), or Si(R₃₉ₐ)(R_{39b}),
   L₃, b3, R₃, and c3 are each as described herein,
   R₃₁ to R₃₃, R₃₉ₐ, and R_{39b} are each as described in connection with R₃ herein, wherein R₃₁ to R₃₃ are each not hydrogen,
   *" indicates a binding site to T₁₂ in Formula 1,
   * indicates a binding site to X₇ or M₁ in Formula 1, and
   *' indicates a binding site to T₁₃ in Formula 1.

In one or more embodiments, in Formula 1, n3 may not be 0, n4 may be 0, and a group represented by 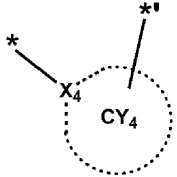
may be a group represented by one of Formulae CY4(1) to CY4(20): 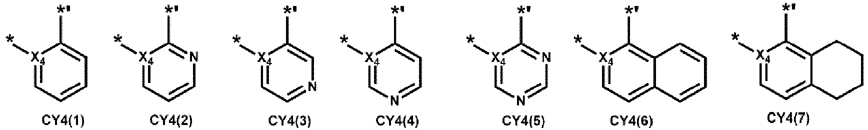 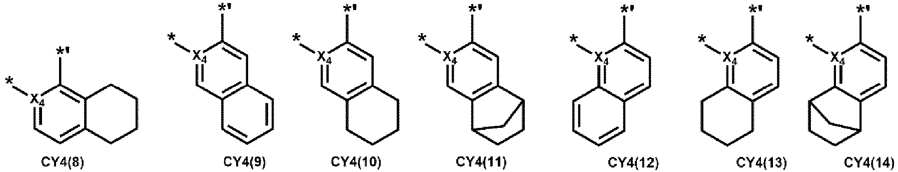 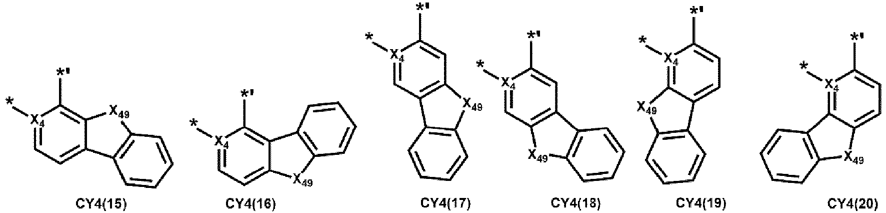
wherein, in Formulae CY4(1) to CY4(20),
   X₄ is as described herein,
   X₄₉ may be O, S, N(R₄₉ₐ), C(R₄₉ₐ)(R_{49b}), or Si(R₄₉ₐ)(R_{49b}),
   R₄₉ₐ and R_{49b} are each as described in connection with R₄ herein,
   *' indicates a binding site to T₁₃ in Formula 1, and
   * indicates a binding site to X₈ or M₁ in Formula 1.

In one or more embodiments, in Formula 1, n3 may be 1, n4 may be 0, and a group represented by 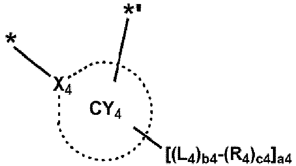
may be a group represented by one of Formulae CY4-1 to CY4-16: 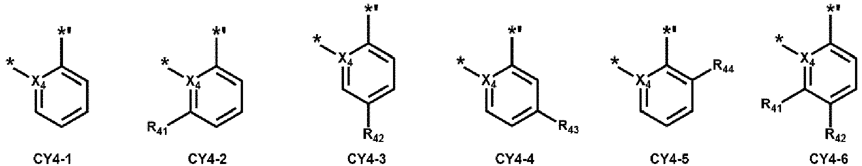 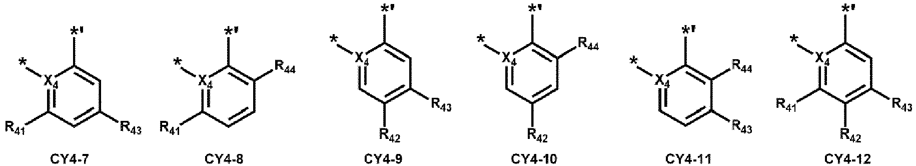 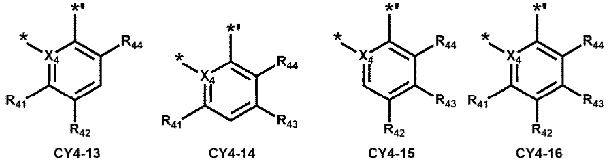
wherein, in Formulae CY4-1 to CY4-16,
   X₄ is as described herein,
   R₄₁ to R₄₄ are each as described in connection with R₄ herein, wherein R₄₁ to R₄₄ are each not hydrogen,
   *' indicates a binding site to T₁₃ in Formula 1, and
   * indicates a binding site to X₈ or M₁ in Formula 1.

In one or more embodiments, the organometallic compound represented by Formula 1 may be a compound represented by one of Formulae 1-1 to 1-3: 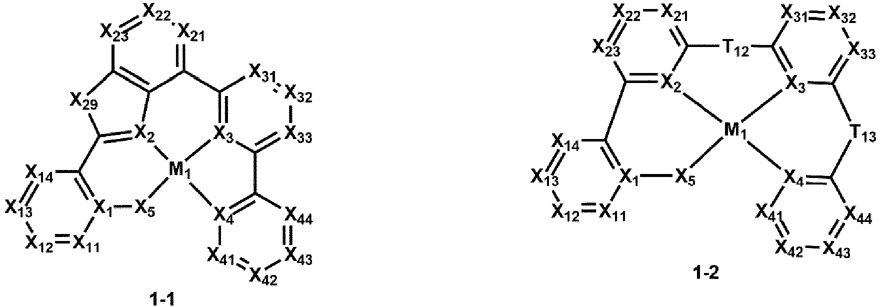 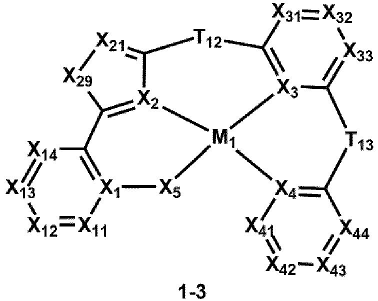 wherein, in Formulae 1-1 to 1-3,
M₁, X₁ to Xs, T₁₂, and T₁₃ are each as described herein,
X₁₁ may be N or C(R₁₁), X₁₂ may be N or C(R₁₂), X₁₃ may be N or C(R₁₃), and X₁₄ may be N or C(R₁₄),
R₁₁ to R₁₄ are each as described in connection with R₁ herein,
two or more of R₁₁ to R₁₄ may optionally be linked to each other to form a C₅-C₃₀ carbocyclic group unsubstituted or substituted with at least one R₁₀ₐ, or a C₁-C₃₀ heterocyclic group unsubstituted or substituted with at least one R₁₀ₐ,
X₂₁ may be N or C(R₂₁), X₂₂ may be N or C(R₂₂), and X₂₃ may be N or C(R₂₃),
X₂₉ may be O, S, N-[(L₂)_{b2}-(R₂)_{c2}], C(R₂₉ₐ)(R_{29b}), or Si(R₂₉ₐ)(R_{29b}),
L₂, b2, R₂, and c2 are each as described herein,
R₂₁ to R₂₃, R₂₉ₐ, and R_{29b} are each as described in connection with R₂ herein,
two or more of R₂₁ to R₂₃ may optionally be linked to each other to form a C₅-C₃₀ carbocyclic group unsubstituted or substituted with at least one R₁₀ₐ, or a C₁-C₃₀ heterocyclic group unsubstituted or substituted with at least one R₁₀ₐ,
X₃₁ may be N or C(R₃₁), X₃₂ may be N or C(R₃₂), and X₃₃ may be N or C(R₃₃),
R₃₁ to R₃₃ are each as described in connection with R₃ herein,
two or more of R₃₁ to R₃₃ may optionally be linked to each other to form a C₅-C₃₀ carbocyclic group unsubstituted or substituted with at least one R₁₀ₐ, or a C₁-C₃₀ heterocyclic group unsubstituted or substituted with at least one R₁₀ₐ,
X₄₁ may be N or C(R₄₁), X₄₂ may be N or C(R₄₂), X₄₃ may be N or C(R₄₃), and X₄₄ may be N or C(R₄₄),
R₄₁ to R₄₄ are each as described in connection with R₄ herein, and
two or more of R₄₁ to R₄₄ may optionally be linked to each other to form a C₅-C₃₀ carbocyclic group unsubstituted or substituted with at least one R₁₀ₐ, or a C₁-C₃₀ heterocyclic group unsubstituted or substituted with at least one R₁₀ₐ.

In one or more embodiments,
Y₁ in Formula 2-1 may be N, and
a group represented by 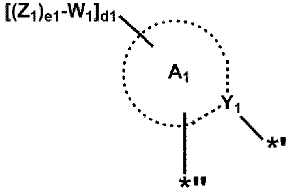
in Formula 2-1 may be a group represented by one of Formulae A1-1 to A1-3: 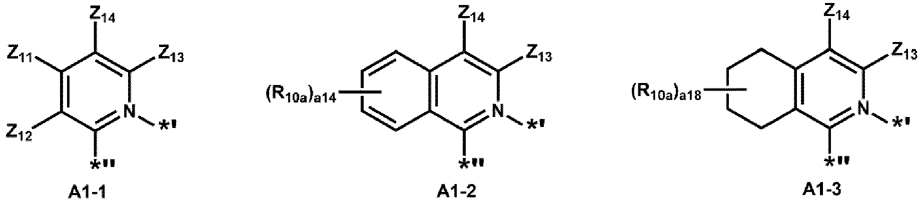 wherein, in Formulae A1-1 to A1-3,
   Z₁₁ to Z₁₄ are each as described in connection with Z₁ herein,
   R₁₀ₐ is as described herein,
   a14 may be an integer from 0 to 4,
   a18 may be an integer from 0 to 8,
   *' indicates a binding site to M₂ in Formula 2, and
   *" indicates a binding site to ring A₂.

For example, at least one of Z₁₁, Z₁₂, and Z₁₄ (for example, Z₁₄) in Formulae A1-1 to A1-3 may be:
a C₁-C₂₀ alkyl group unsubstituted or substituted with at least one of deuterium, -F, a phenyl group, or a combination thereof;
-Si(Q₃)(Q₄)(Q₅); or
-Ge(Q₃)(Q₄)(Q₅).

In one or more embodiments,
Y₃ in Formula 2-2 may be N, and
a group represented by 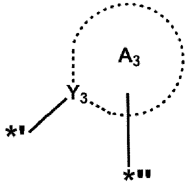
in Formula 2-2 may be a group represented by one of Formulae NR1 to NR48: 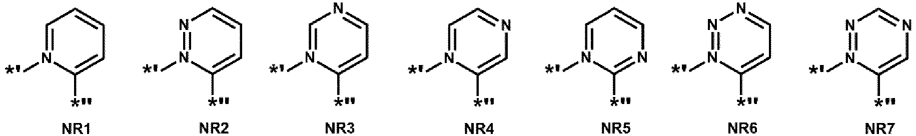 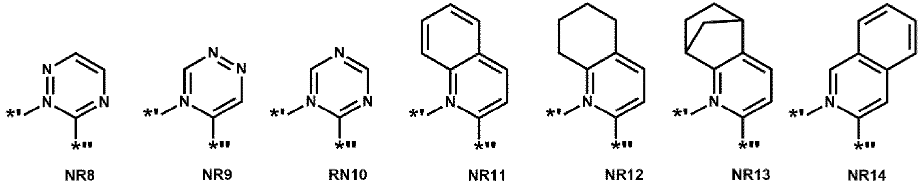 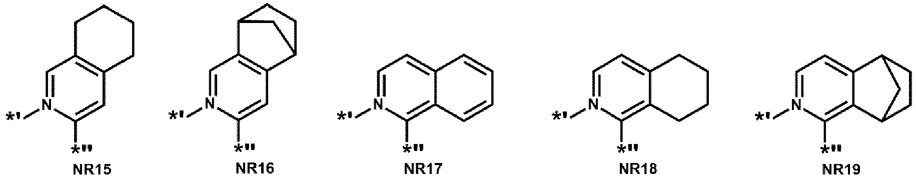 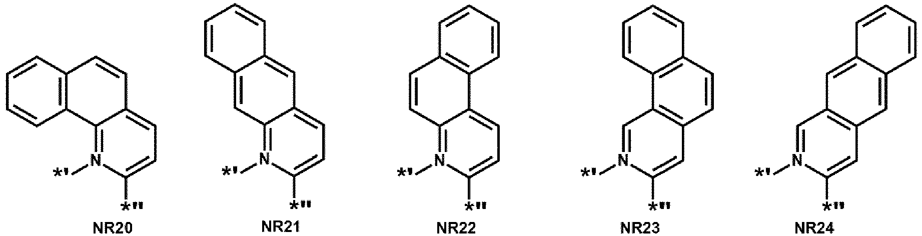 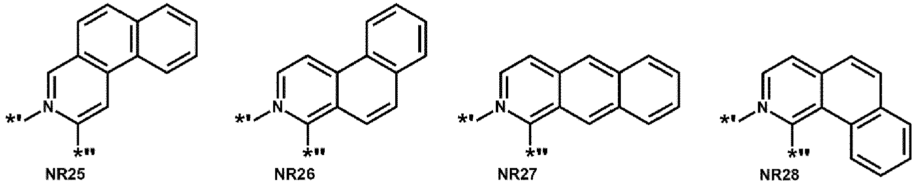 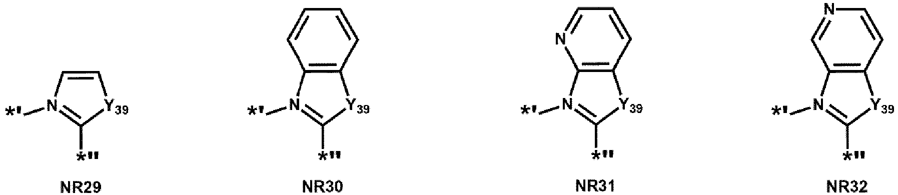 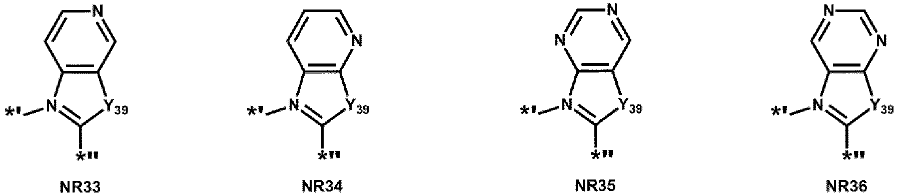 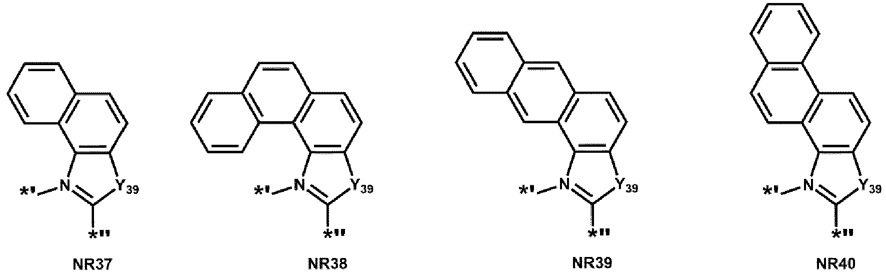 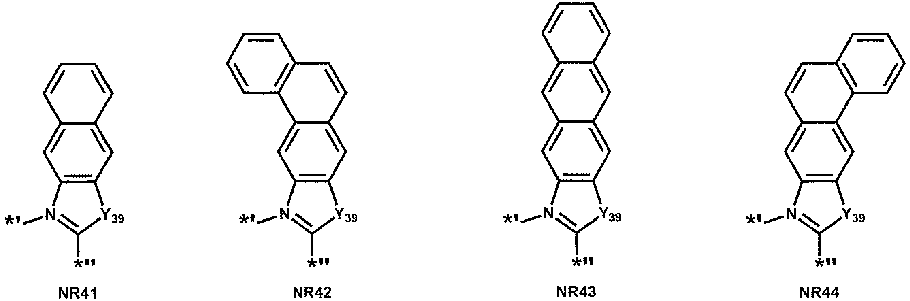 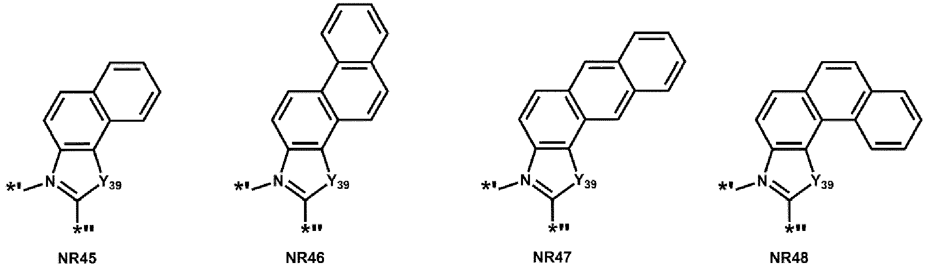 wherein, in Formulae NR1 to NR48,
   Y₃₉ may be O, S, Se, N-[W₃-(Z₃)ₑ₃], C(Z₃₉ₐ)(Z_{39b}), or Si(Z₃₉ₐ)(Z_{39b}),
   W₃, Z₃, and e3 are each as described herein, and Z₃₉ₐ and Z_{39b} are each as described in connection with Z₃ herein,
   *' indicates a binding site to M₂ in Formula 2, and
   *" indicates a binding site to ring A₄.

In one or more embodiments,
Y₂ and Y₄ in Formulae 2-1 and 2-2 may each be C, and
a group represented by 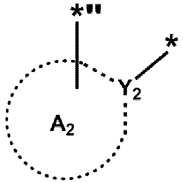
in Formula 2-1 and a group represented by 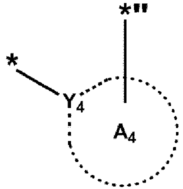
in Formula 2-2 may each independently be a group represented by one of Formulae CR1 to CR29: 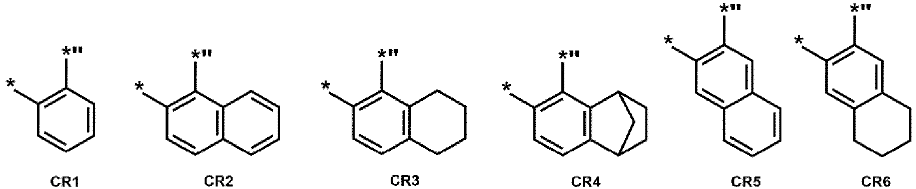 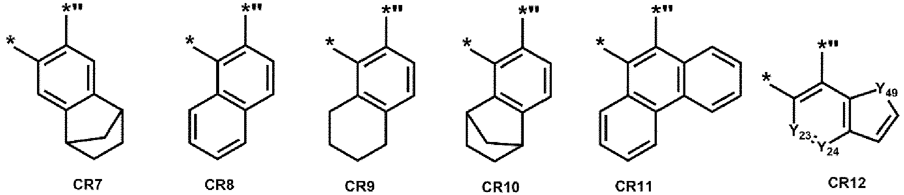 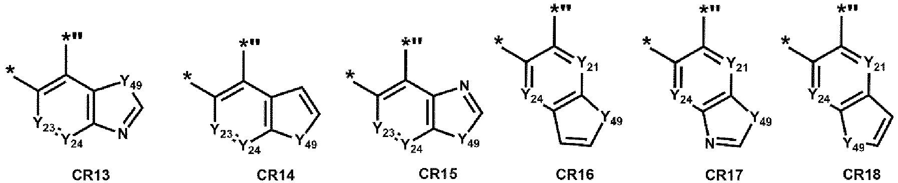 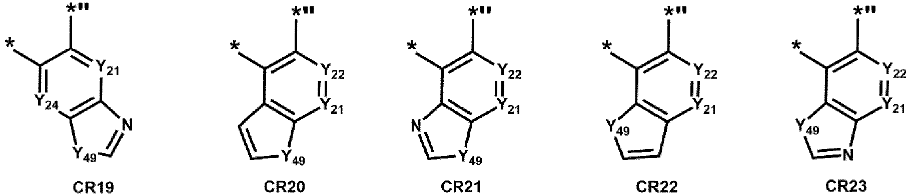 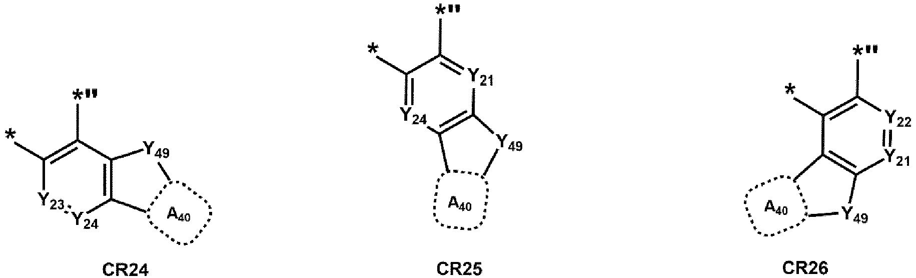 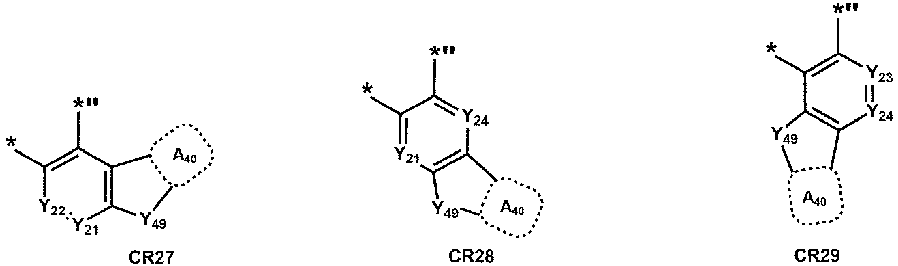 wherein, in Formulae CR1 to CR29,
   Y₄₉ may be O, S, Se, N-[W₂-(Z₂)ₑ₂], N-[W₄-(Z₄)ₑ₄], C(Z₂₉ₐ)(Z_{29b}), C(Z₄₉ₐ)(Z_{49b}), Si(Z₂₉ₐ)(Z_{29b}), or Si(Z₄₉ₐ)(Z_{49b}),
   W₂, W₄, Z₂, Z₄, e2, and e4 are each as described herein, Z₂₉ₐ and Z_{29b} are each as described in connection with Z₂ herein, and Z₄₉ₐ and Z_{49b} are each as described in connection with Z₄ herein,
   Y₂₁ to Y₂₄ may each independently be N or C,
   ring A₄₀ may be a C₅-C₃₀ carbocyclic group or a C₁-C₃₀ heterocyclic group (for example, a benzene group, a naphthalene group, a phenanthrene group, a pyridine group, a pyrimidine group, a pyrazine group, a pyridazine group, a quinoline group, an isoquinoline group, a benzoquinoline group, a benzoisoquinoline group, a quinoxaline group, a benzoquinoxaline group, a quinazoline group, or a benzoquinazoline group),
   * indicates a binding site to M₂ in Formula 2, and
   *" indicates a binding site to ring A₁ or ring A₃.

In one or more embodiments,
a group represented by 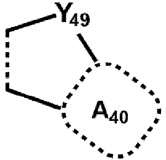
in Formulae CR24 to CR29 may be a group represented by one of Formulae CR(1) to CR(13): 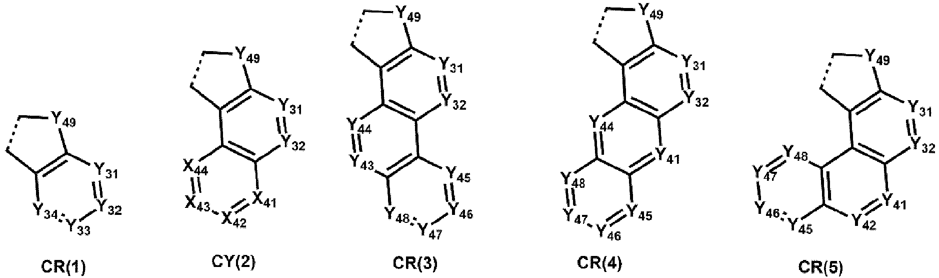 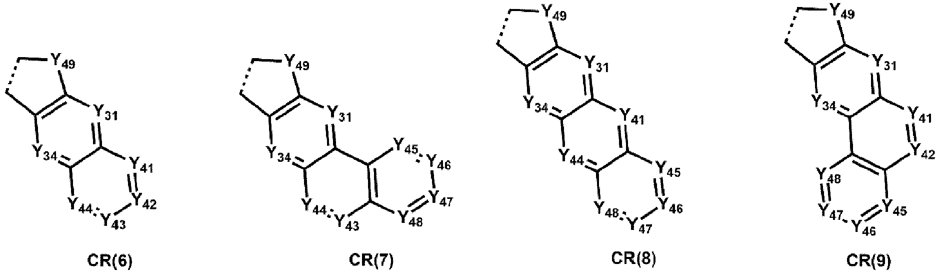 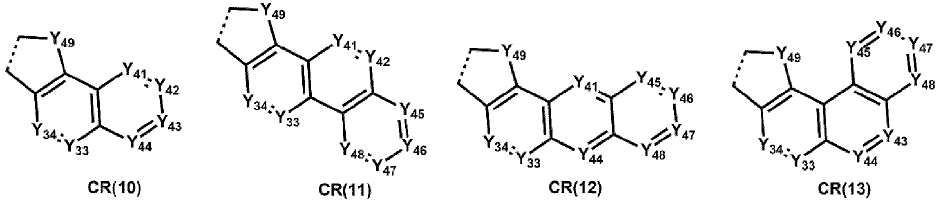 wherein, in Formulae CR(1) to CR(13),
   Y₄₉ is as described herein, and
   Y₃₁ to Y₃₄ and Y₄₁ to Y₄₈ may each independently be C or N.

In one or more embodiments, the first compound may include at least one deuterium.

In one or more embodiments, the second compound may include at least one deuterium.

For example, the first compound and the second compound may each independently be a compound of Group 1-1 to Group 1-4 or a compound of Group 2-1 to Group 2-5:

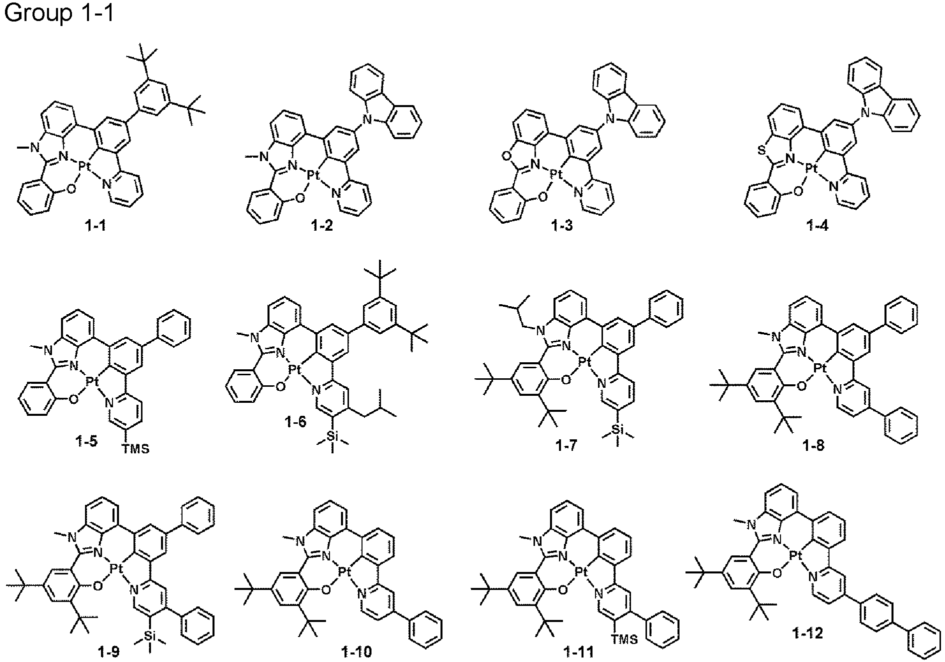

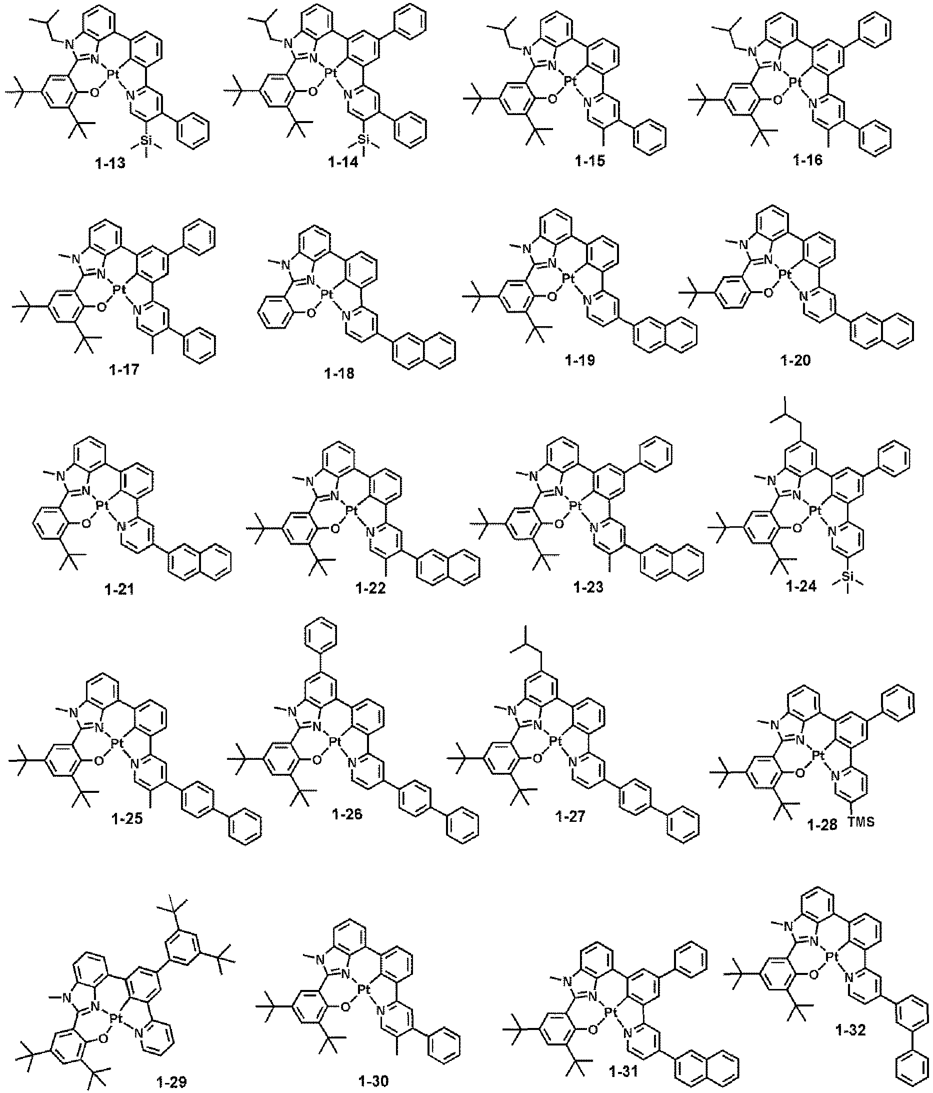

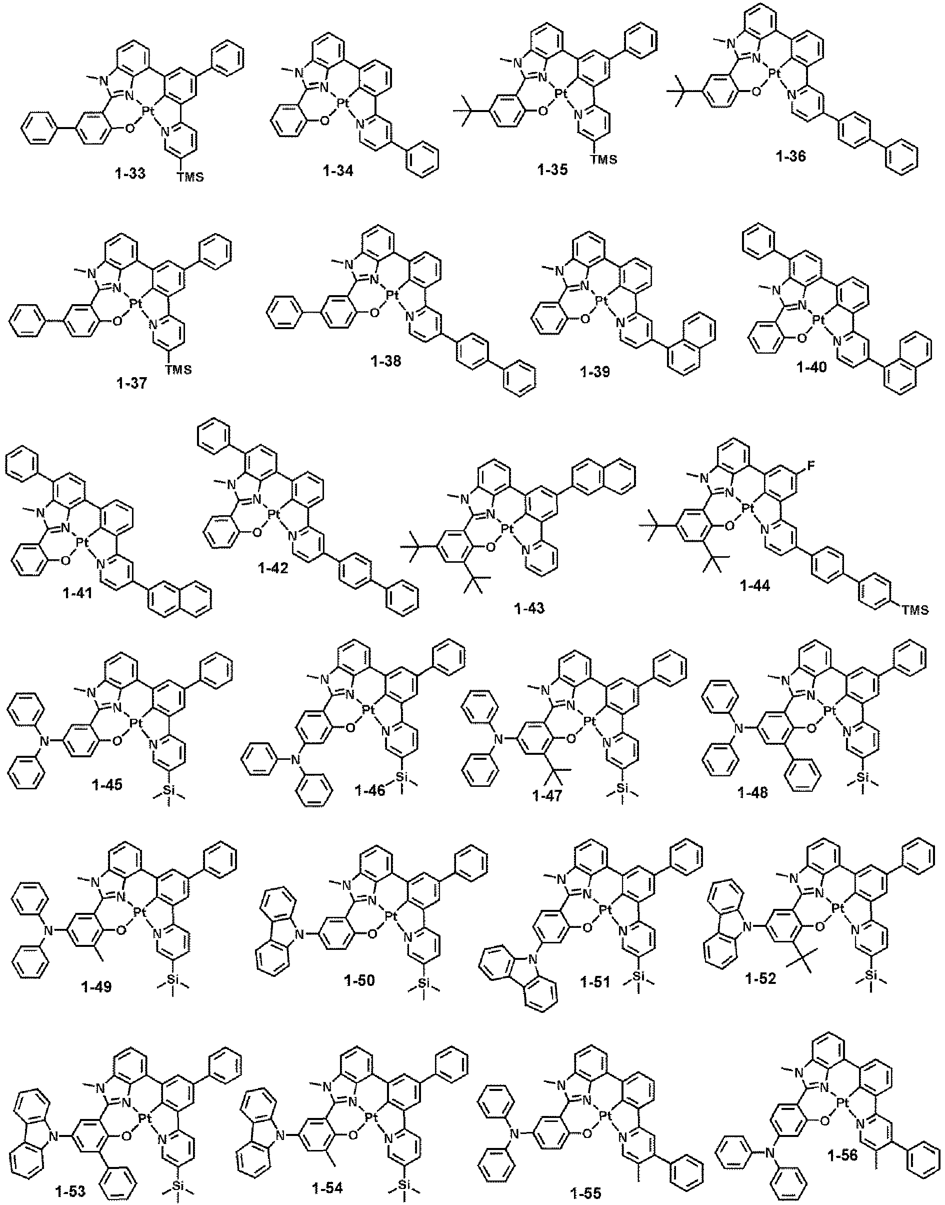

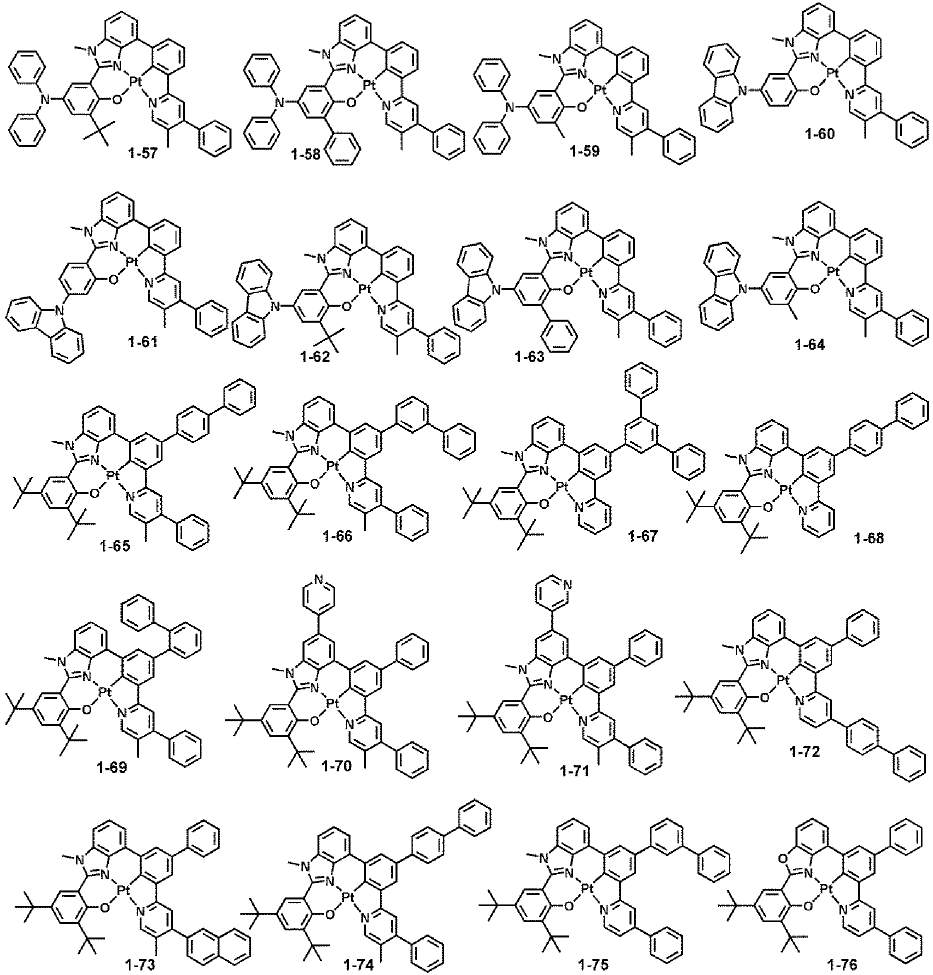

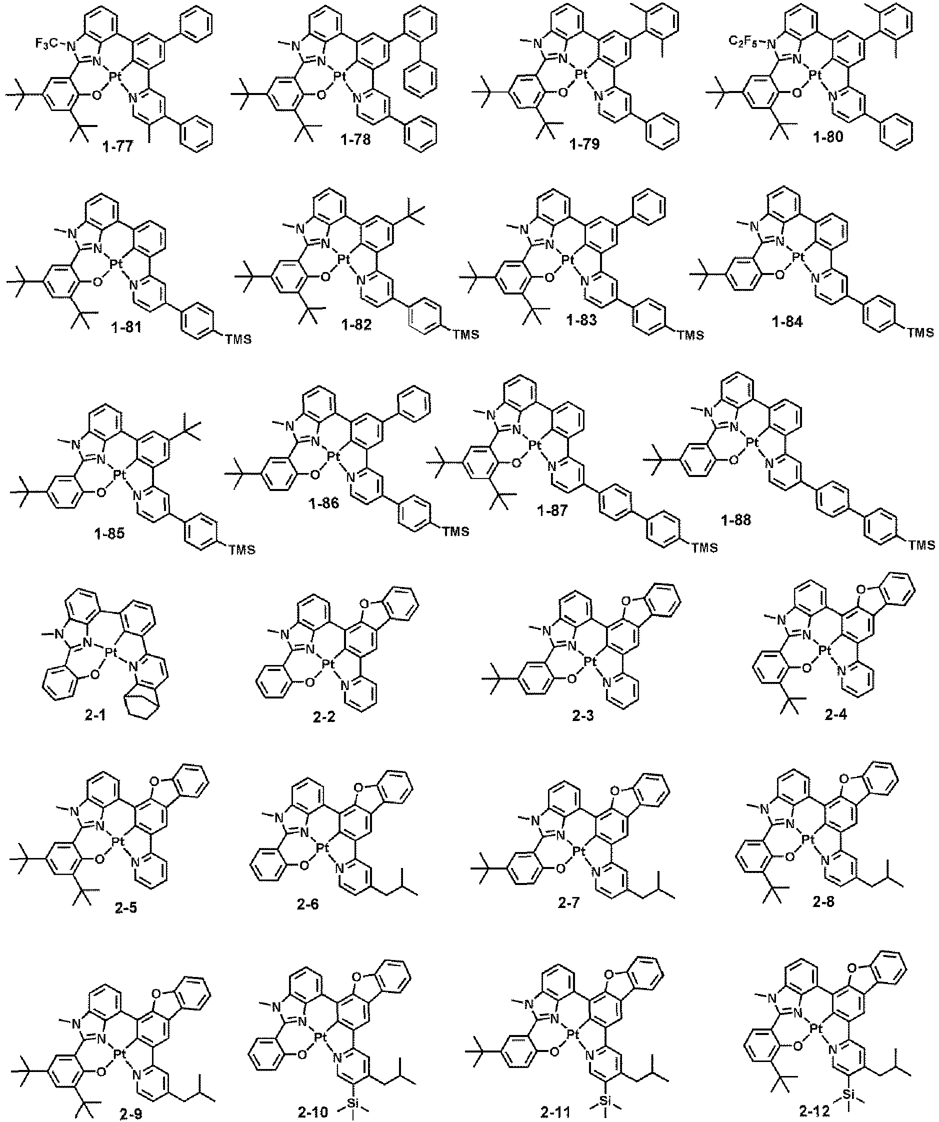

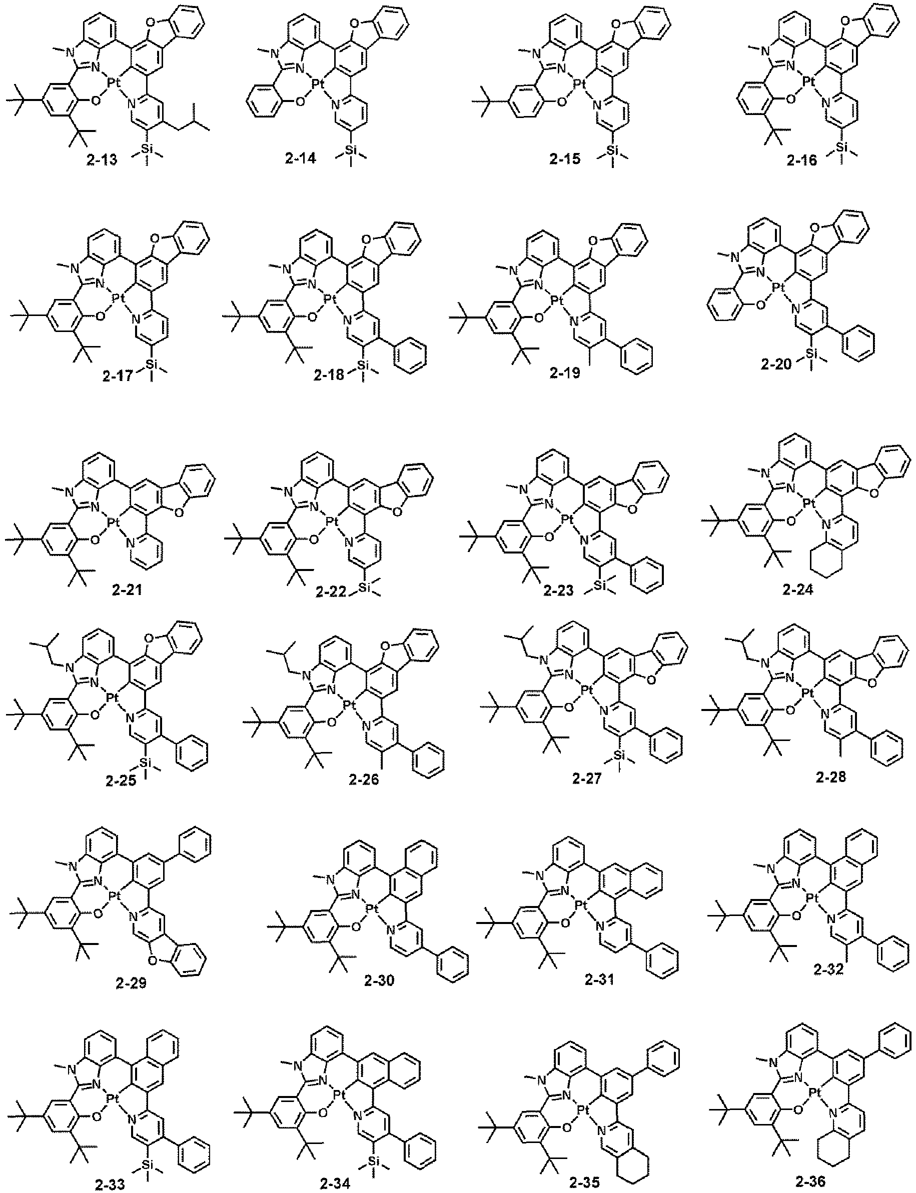

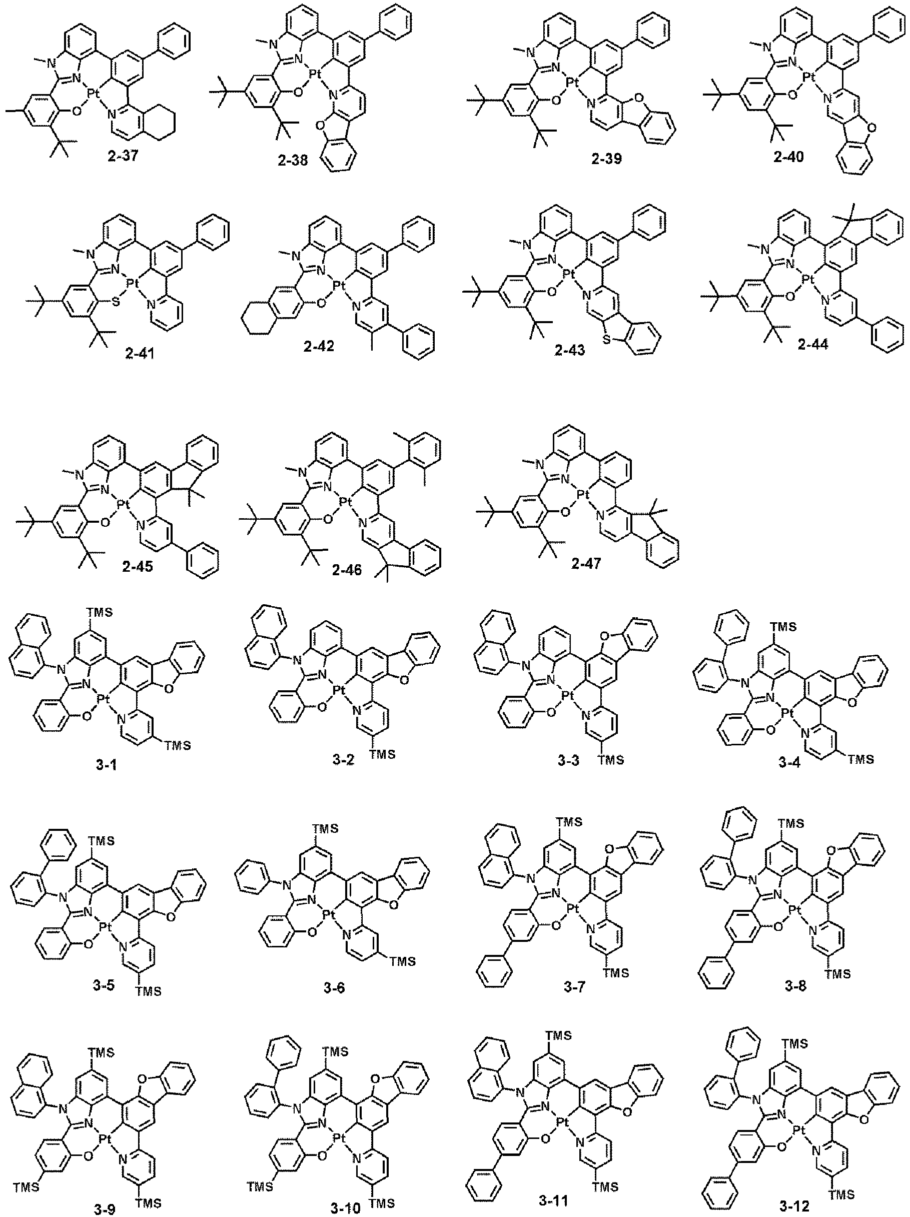

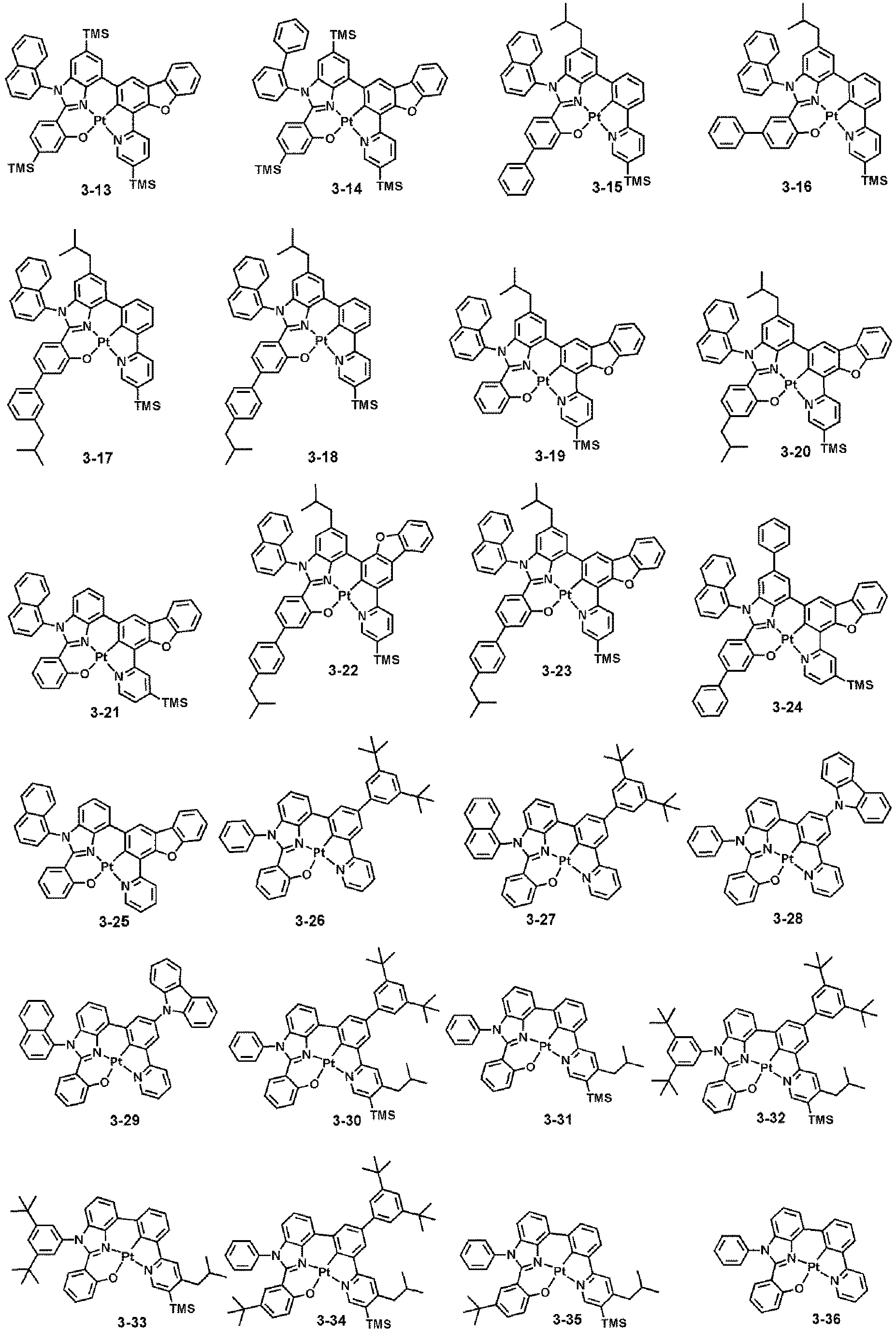

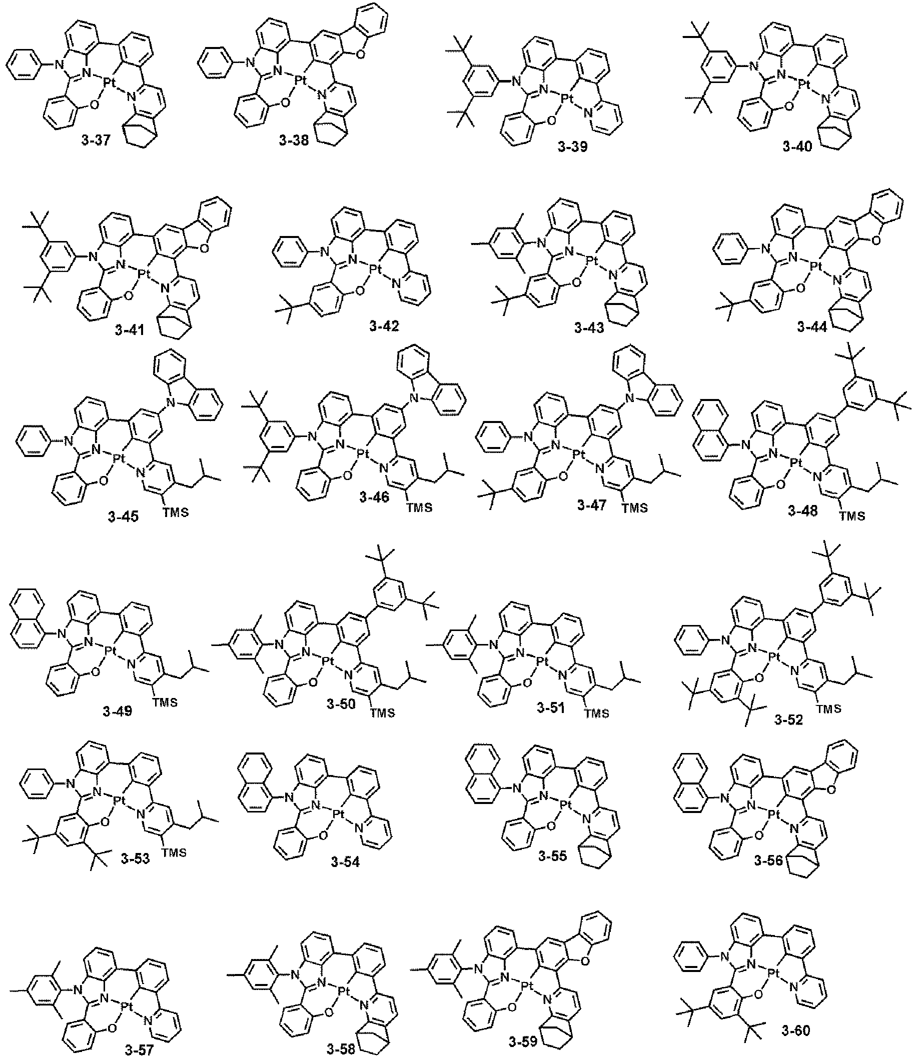

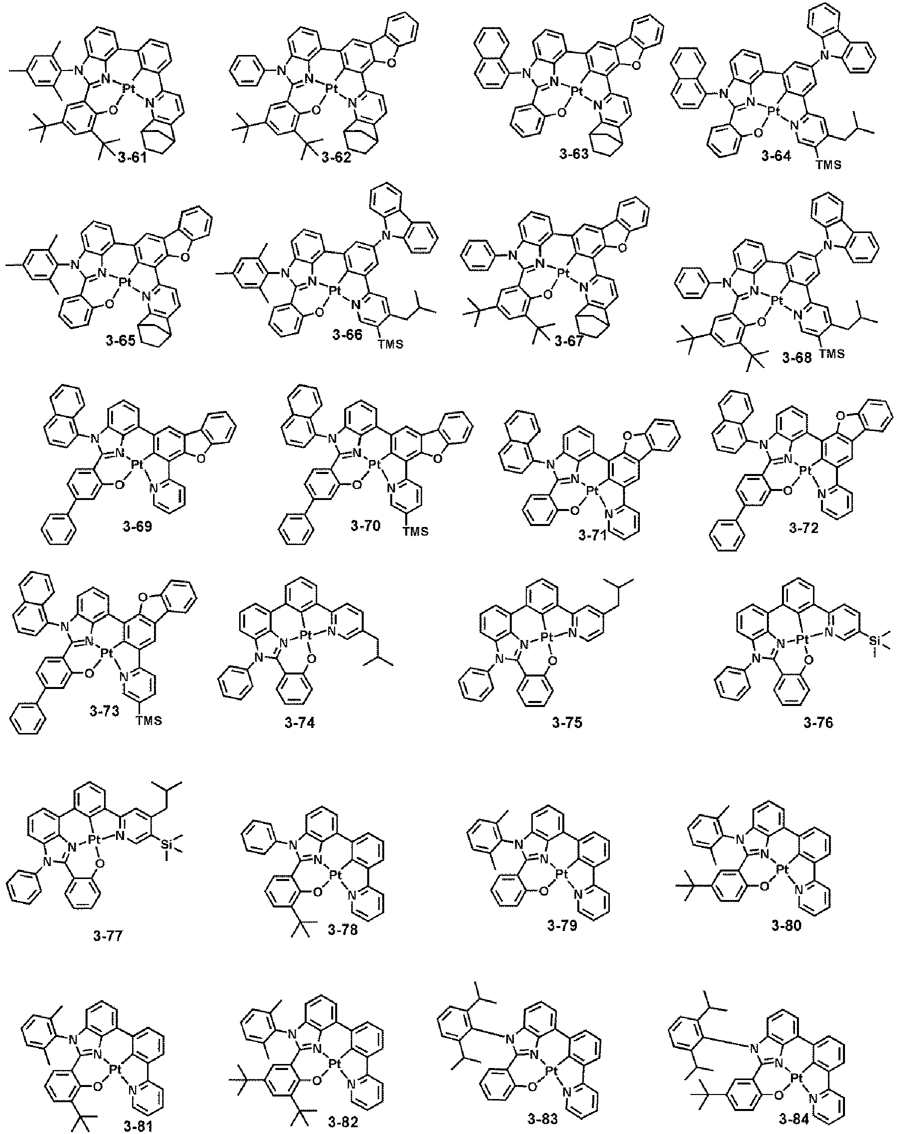

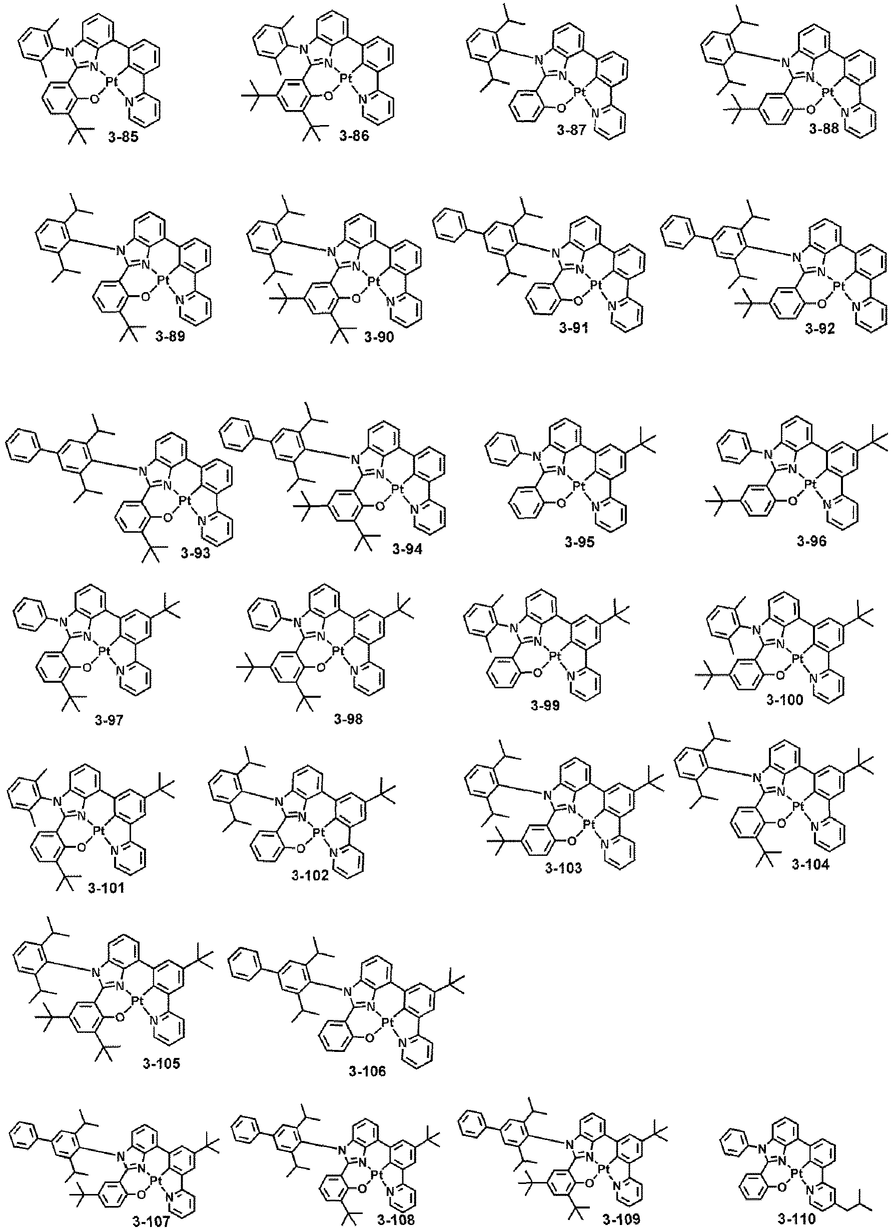

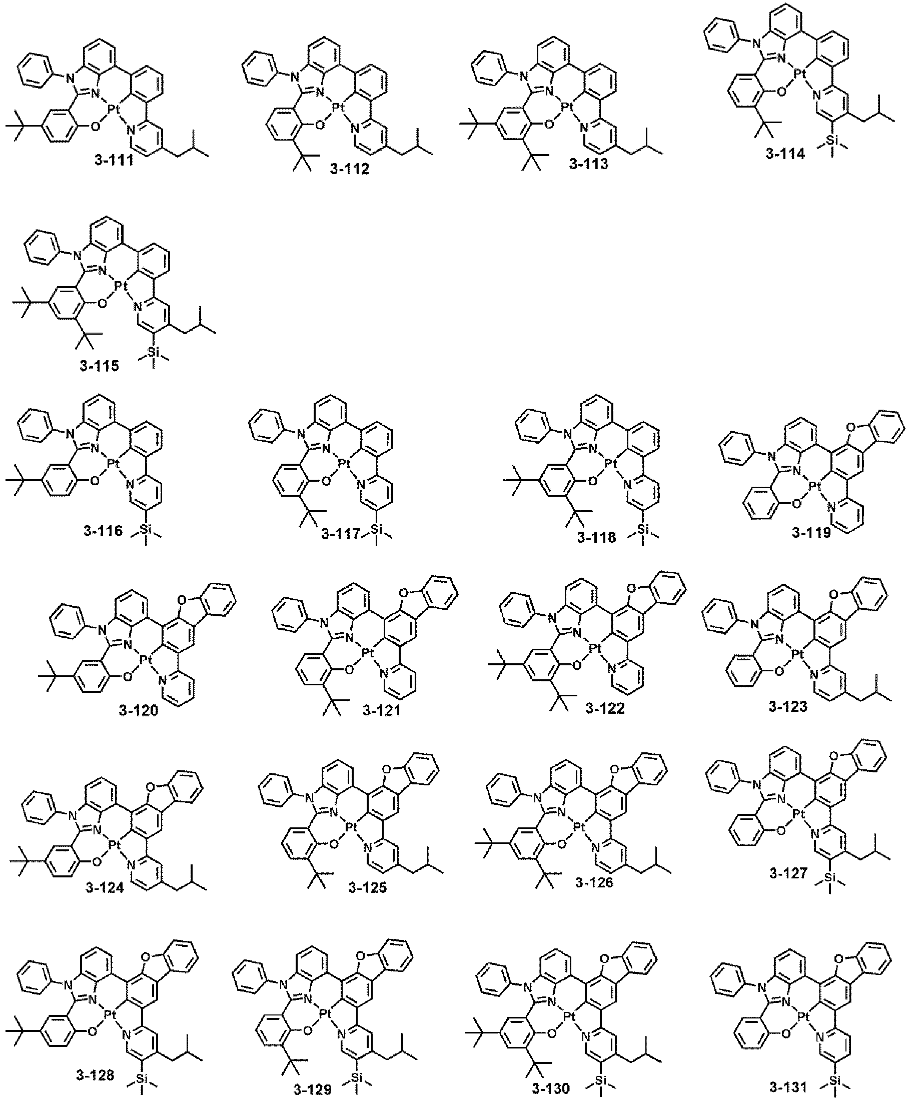

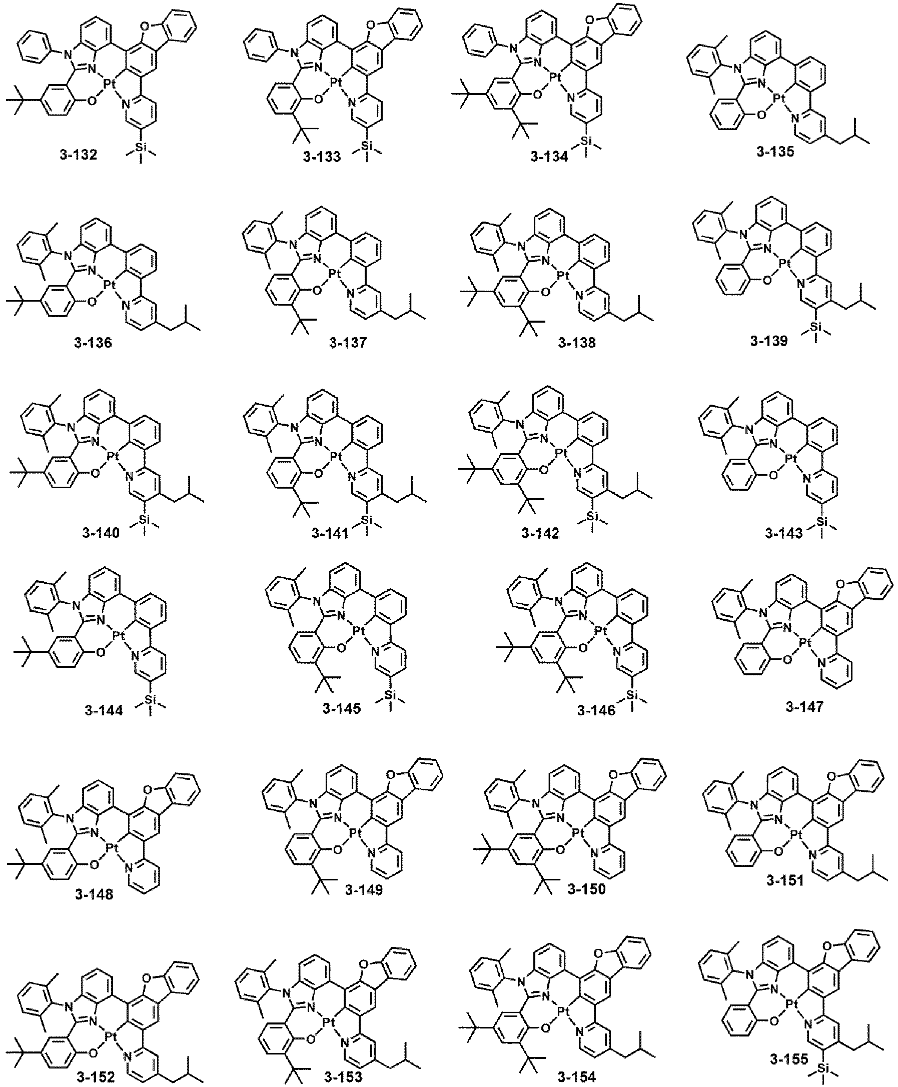

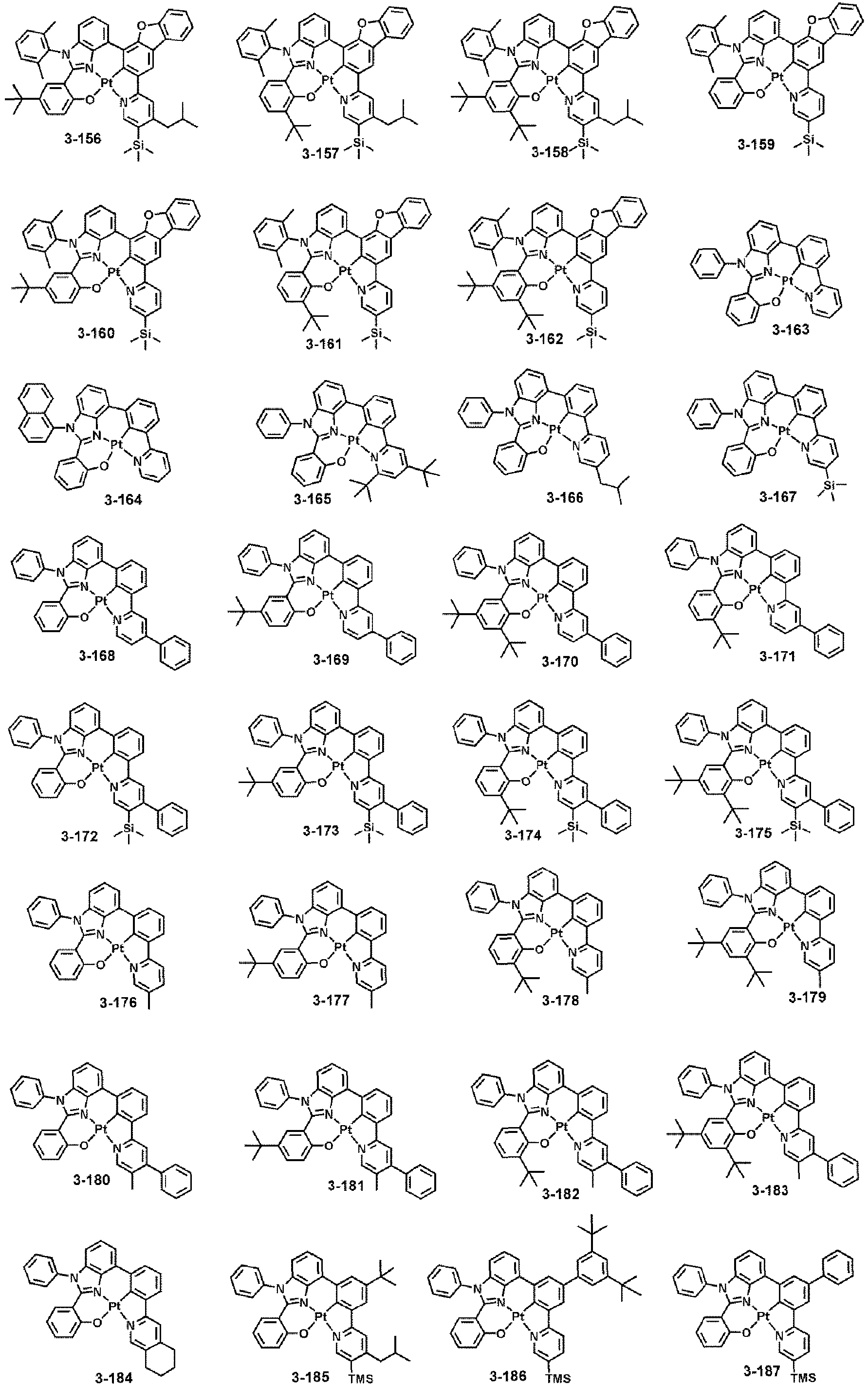

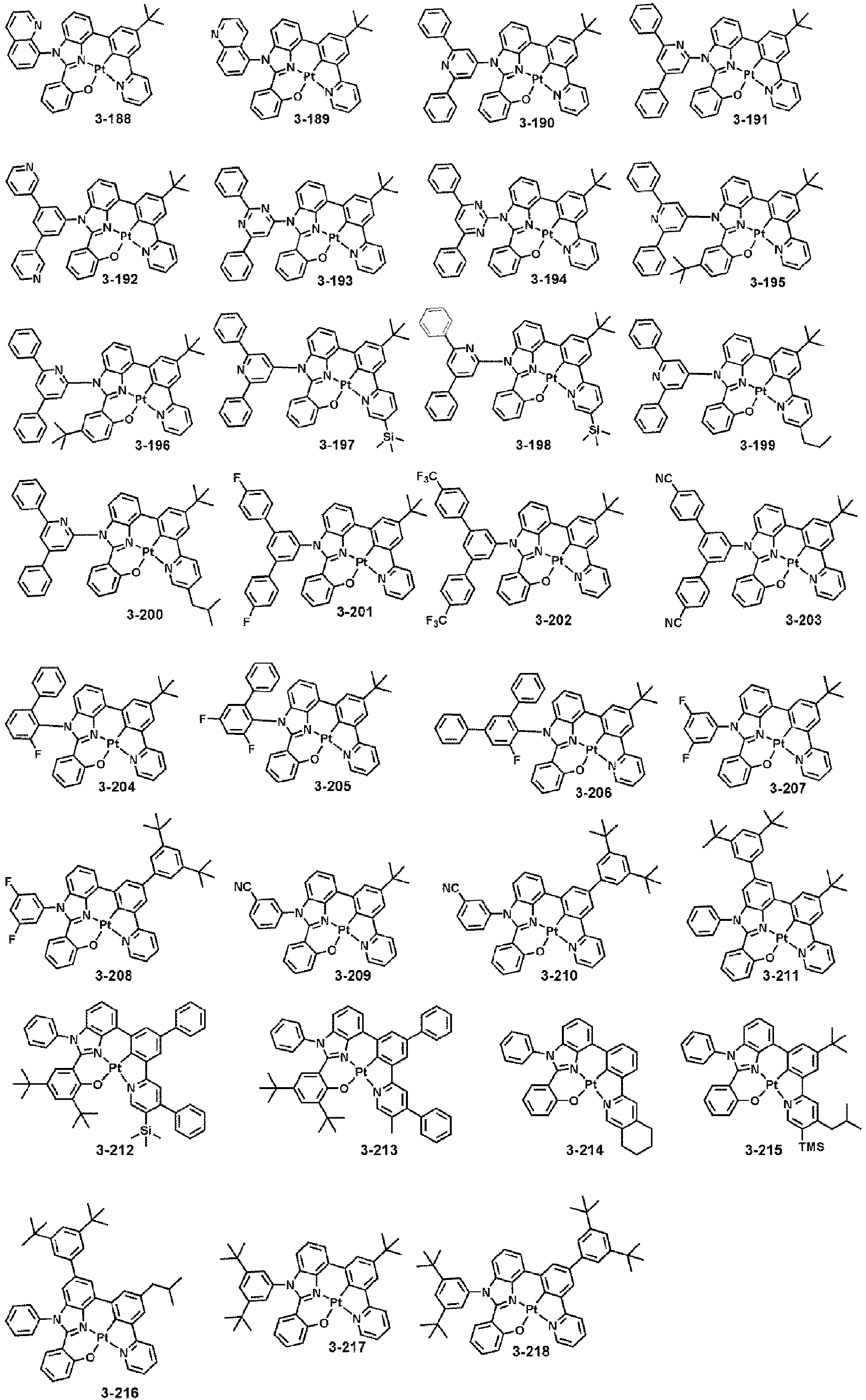

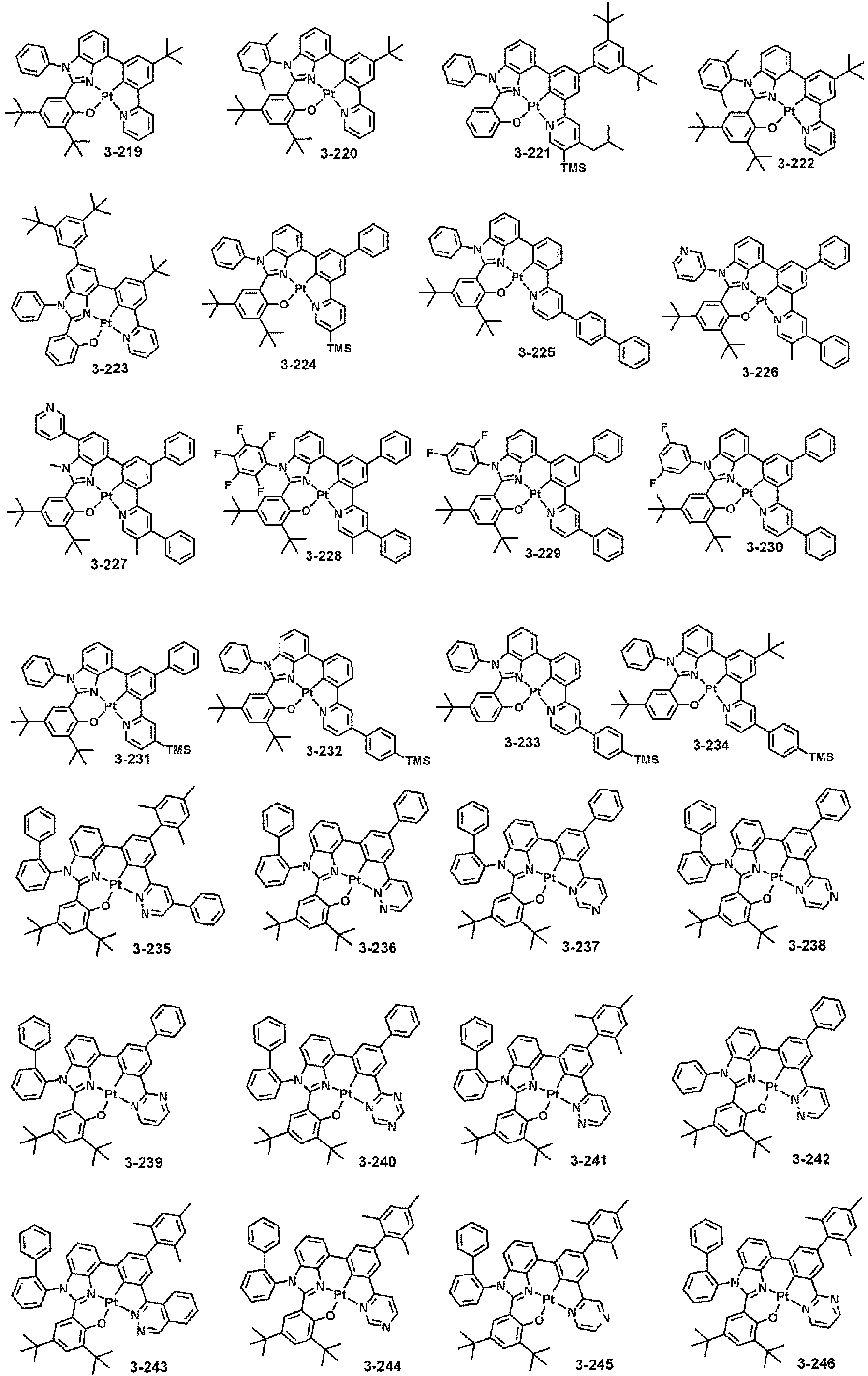

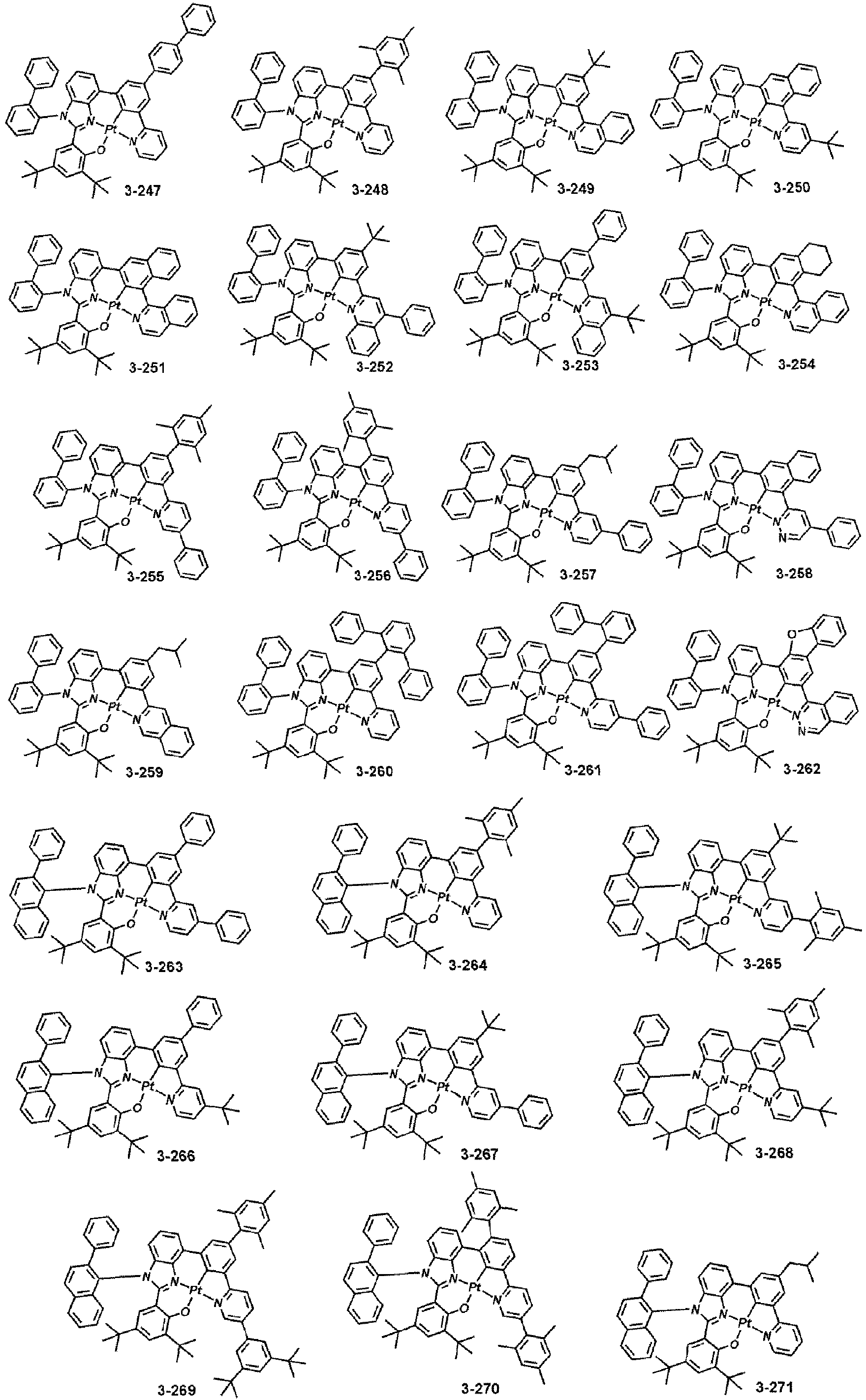

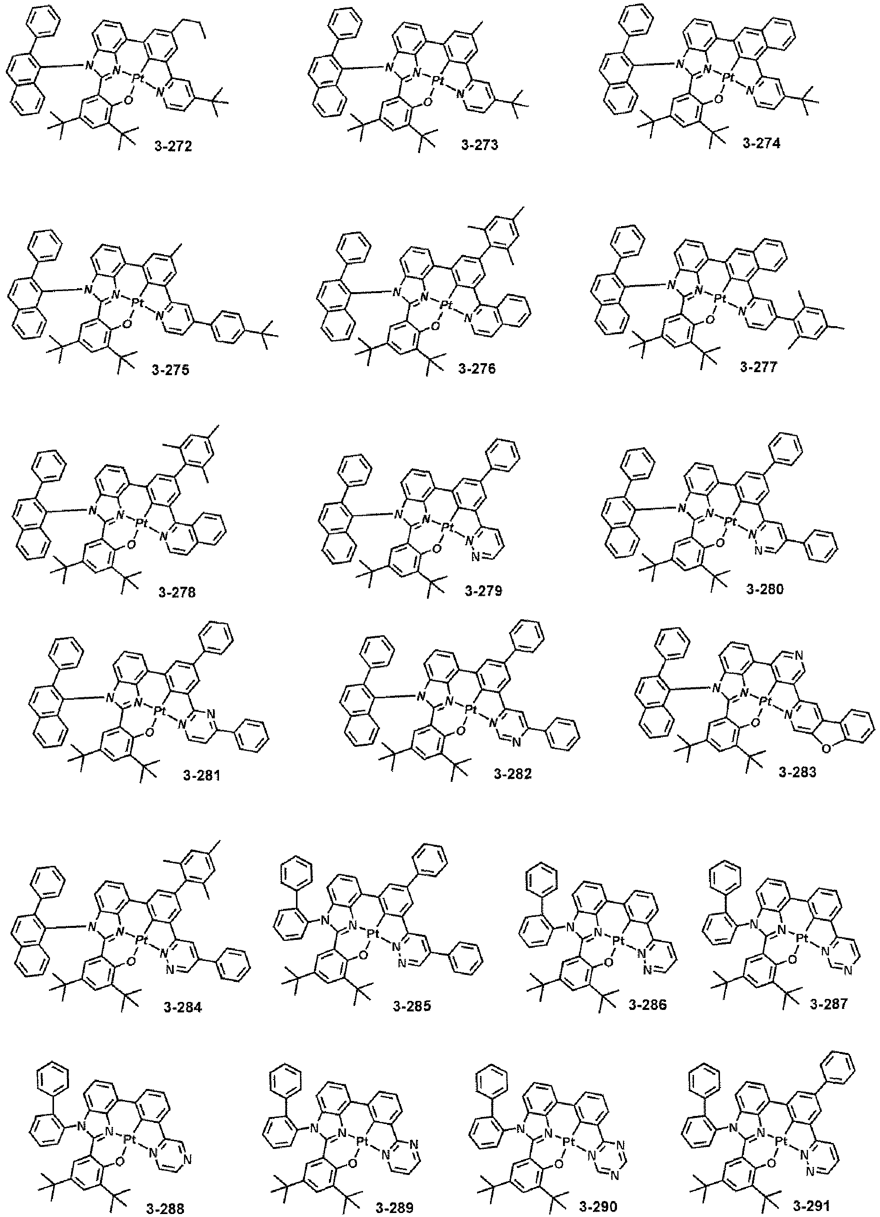

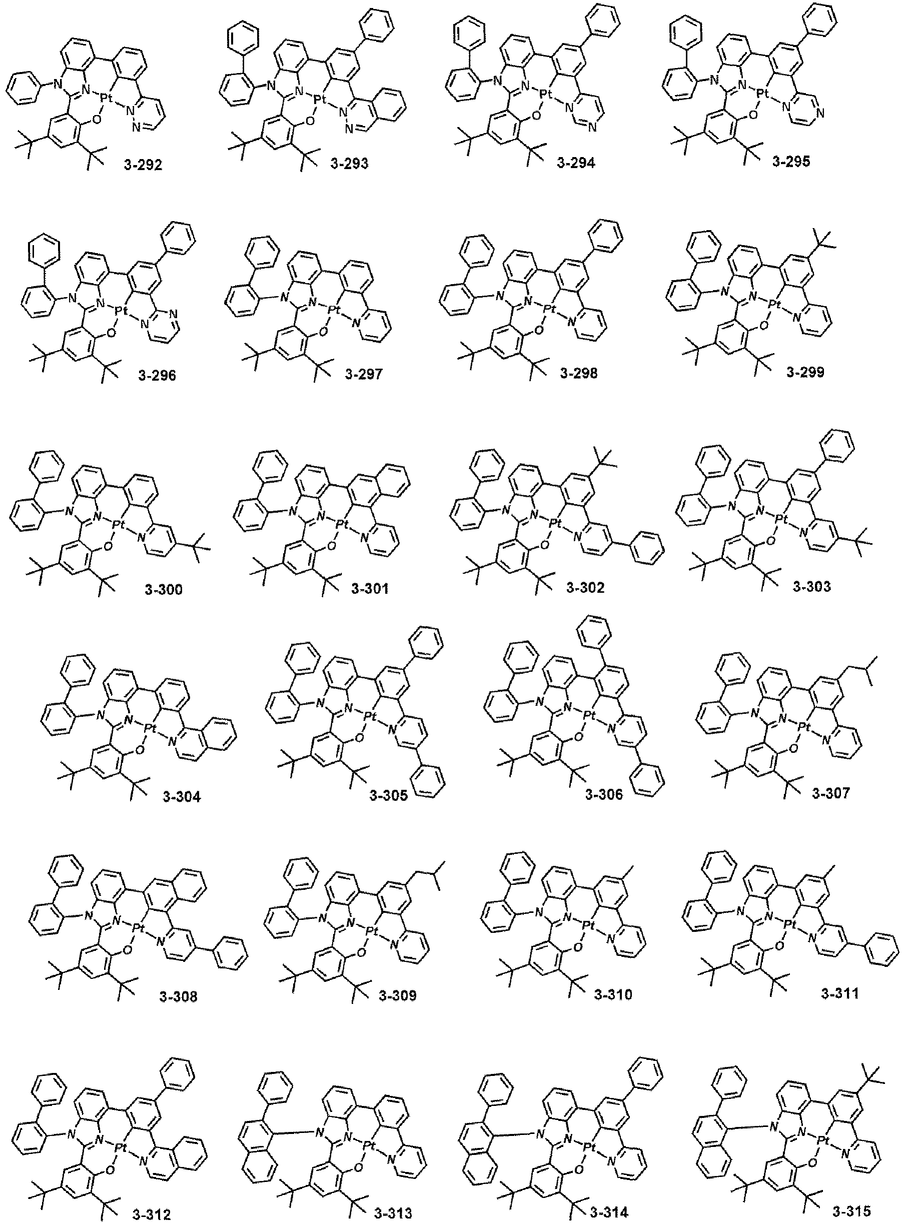

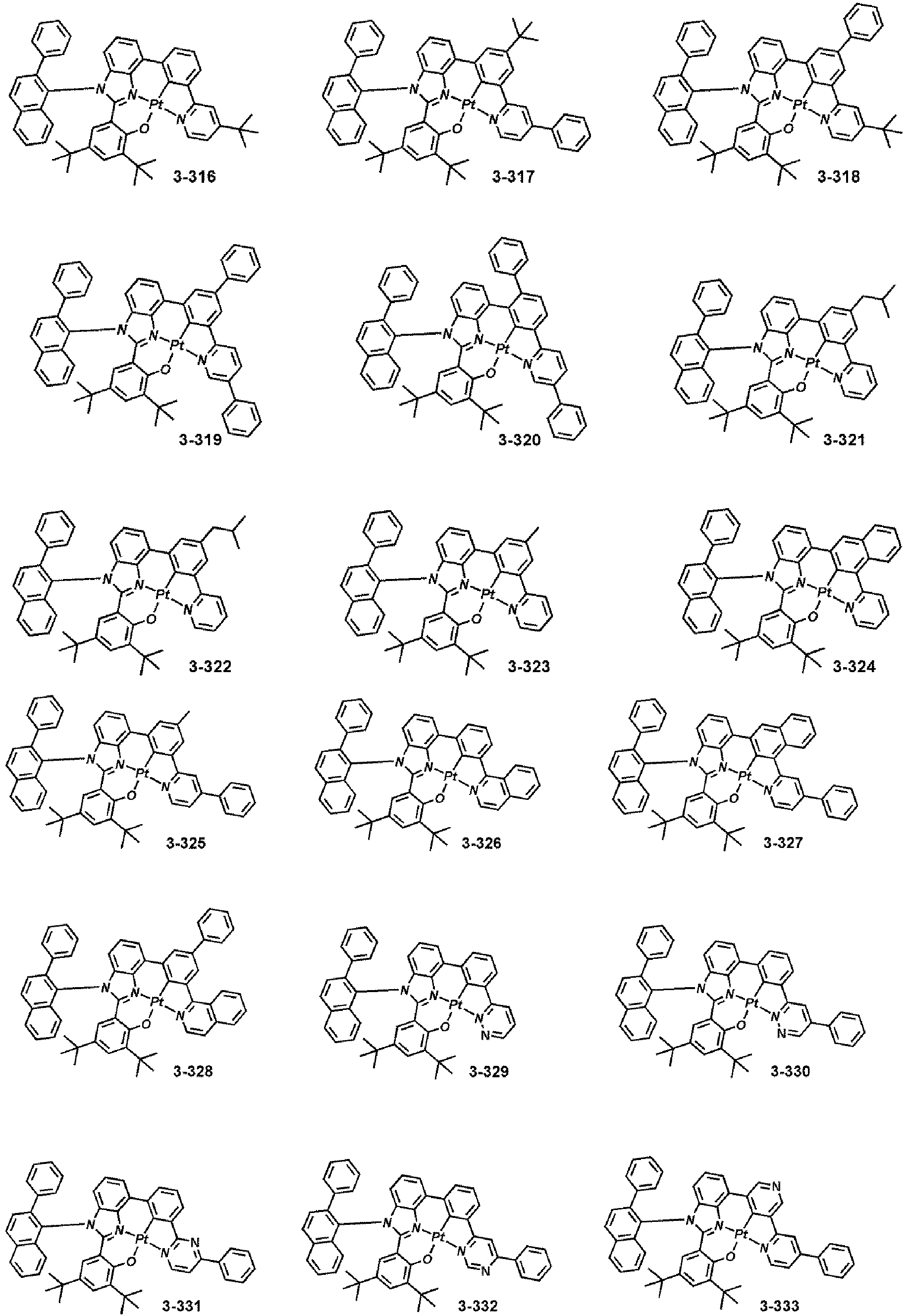

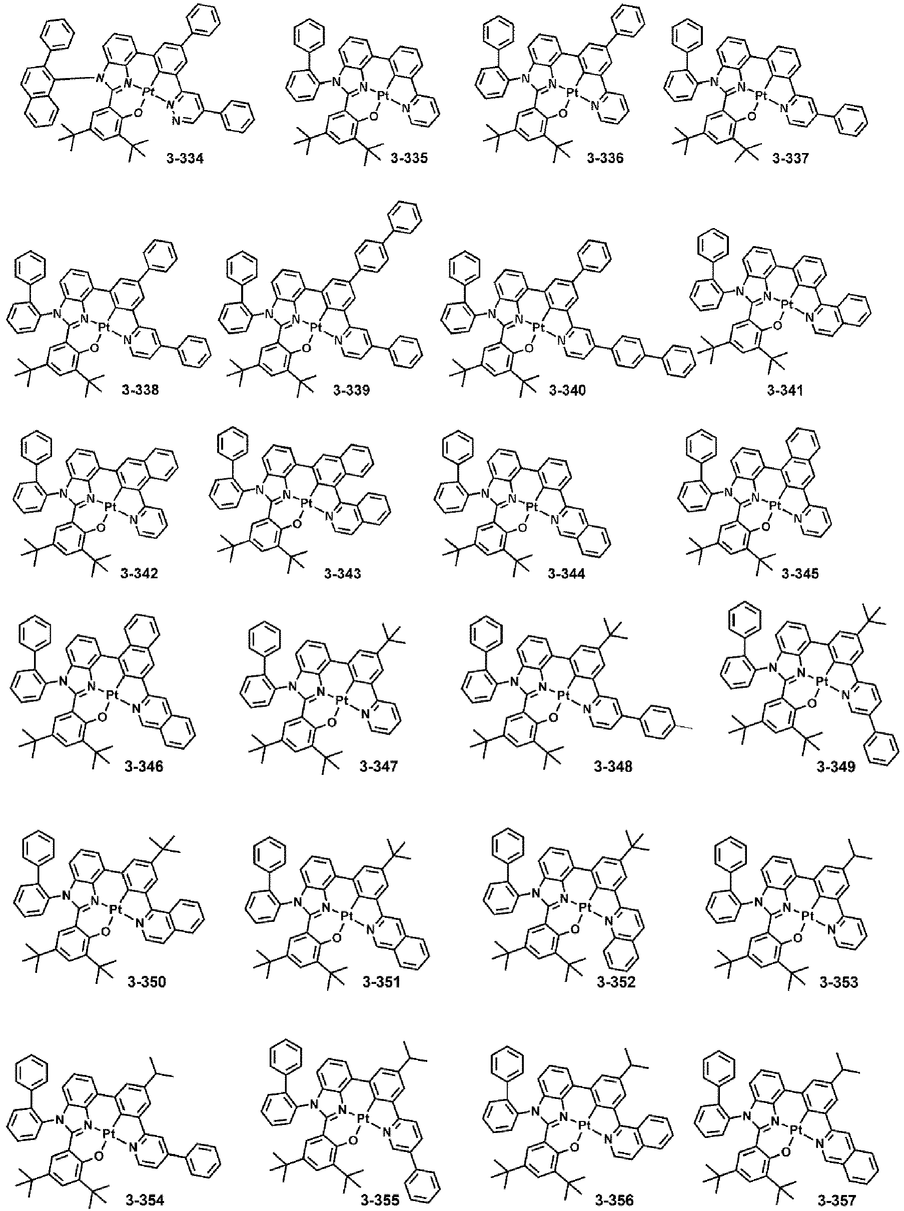

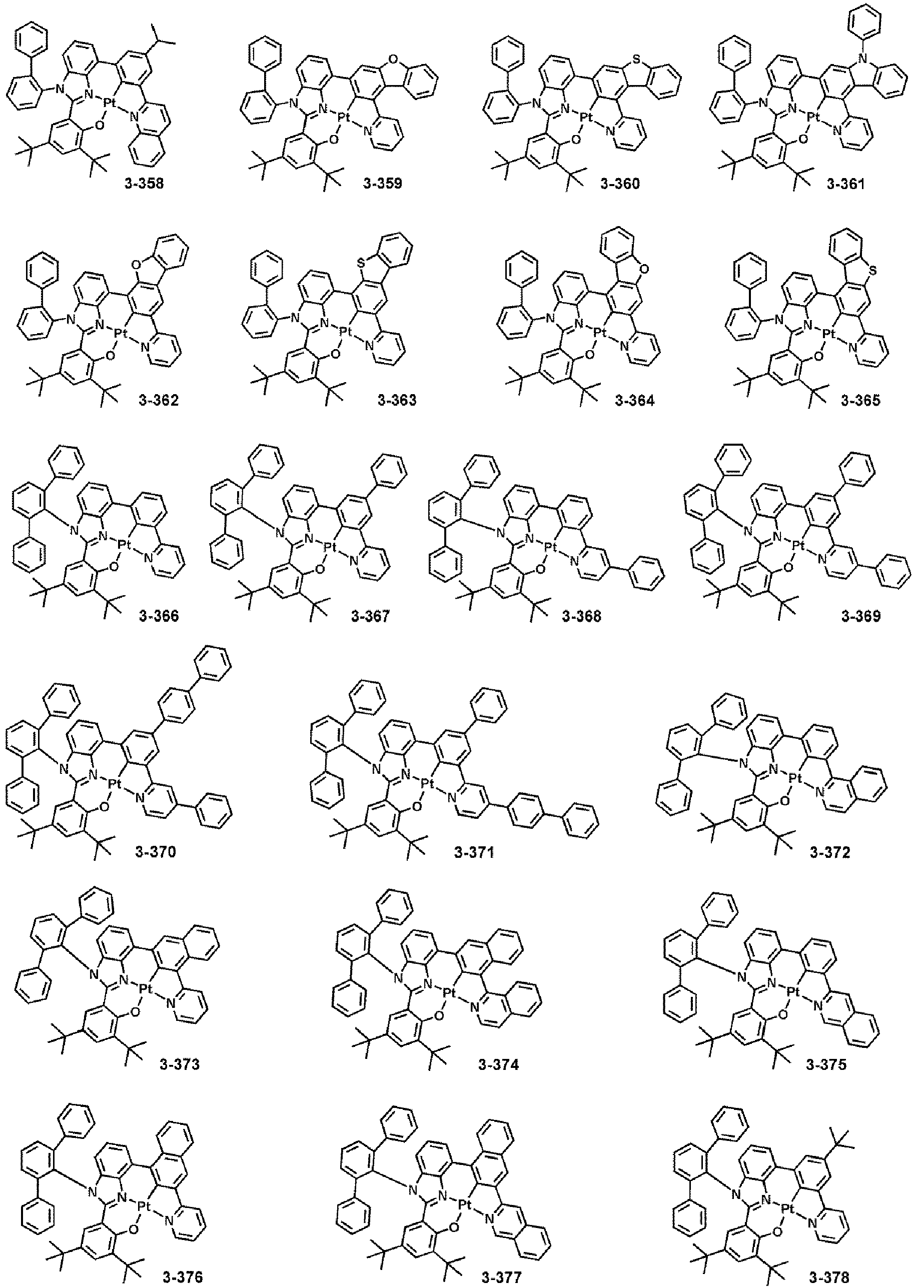

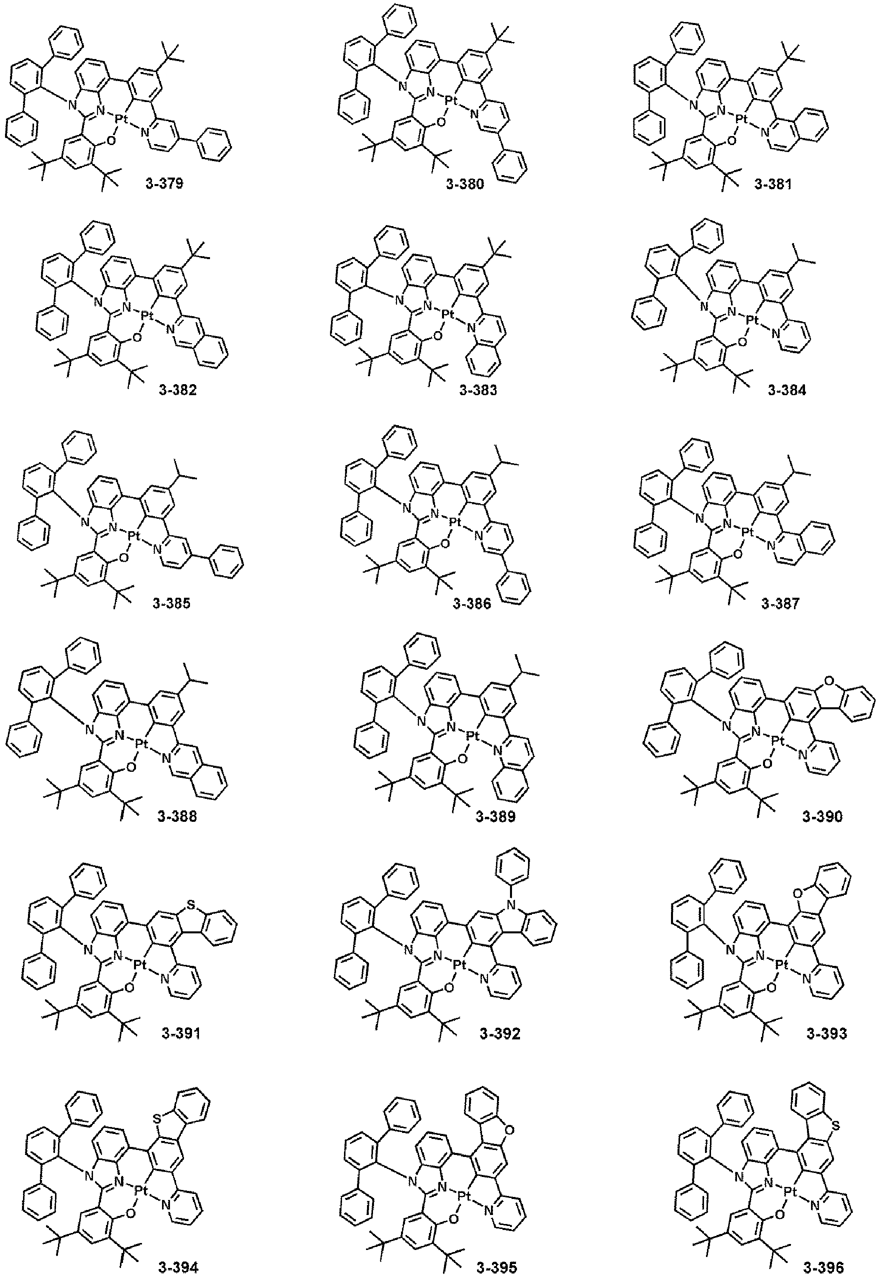

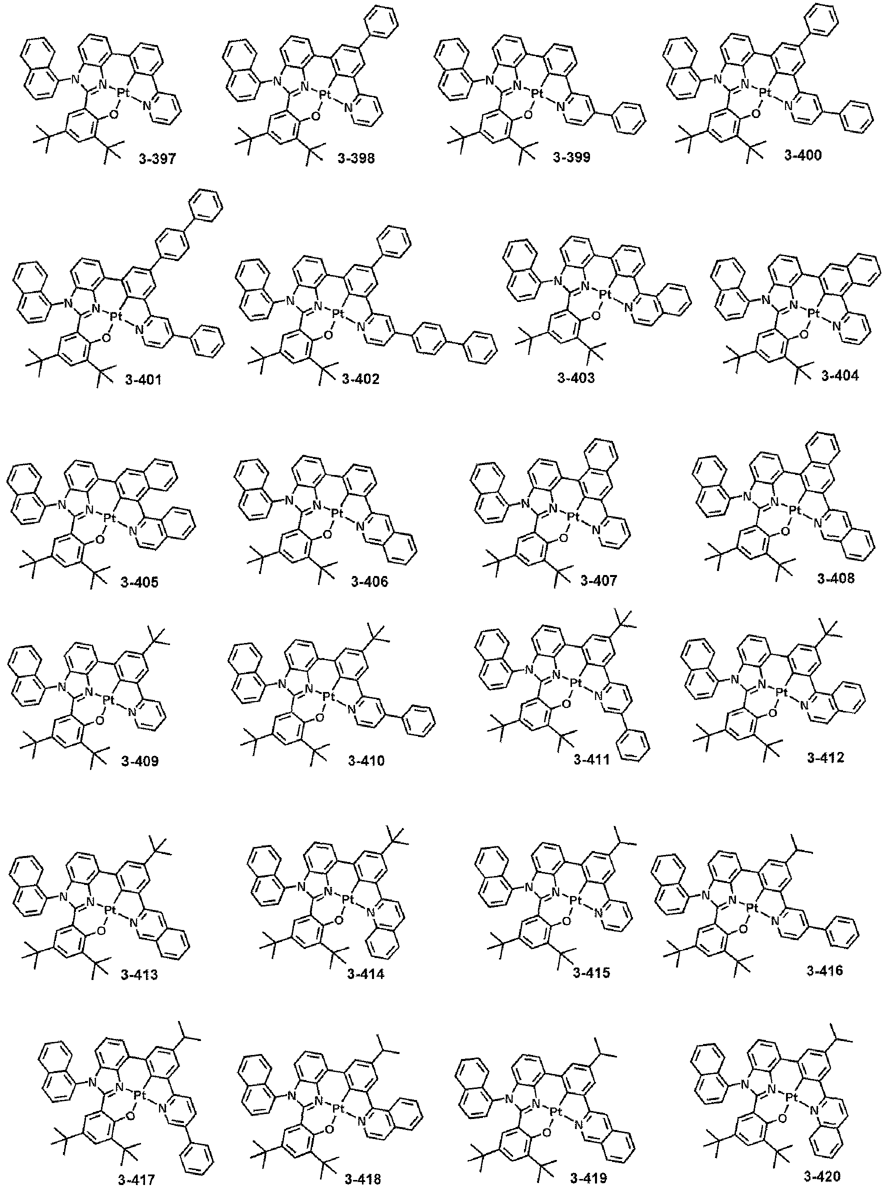

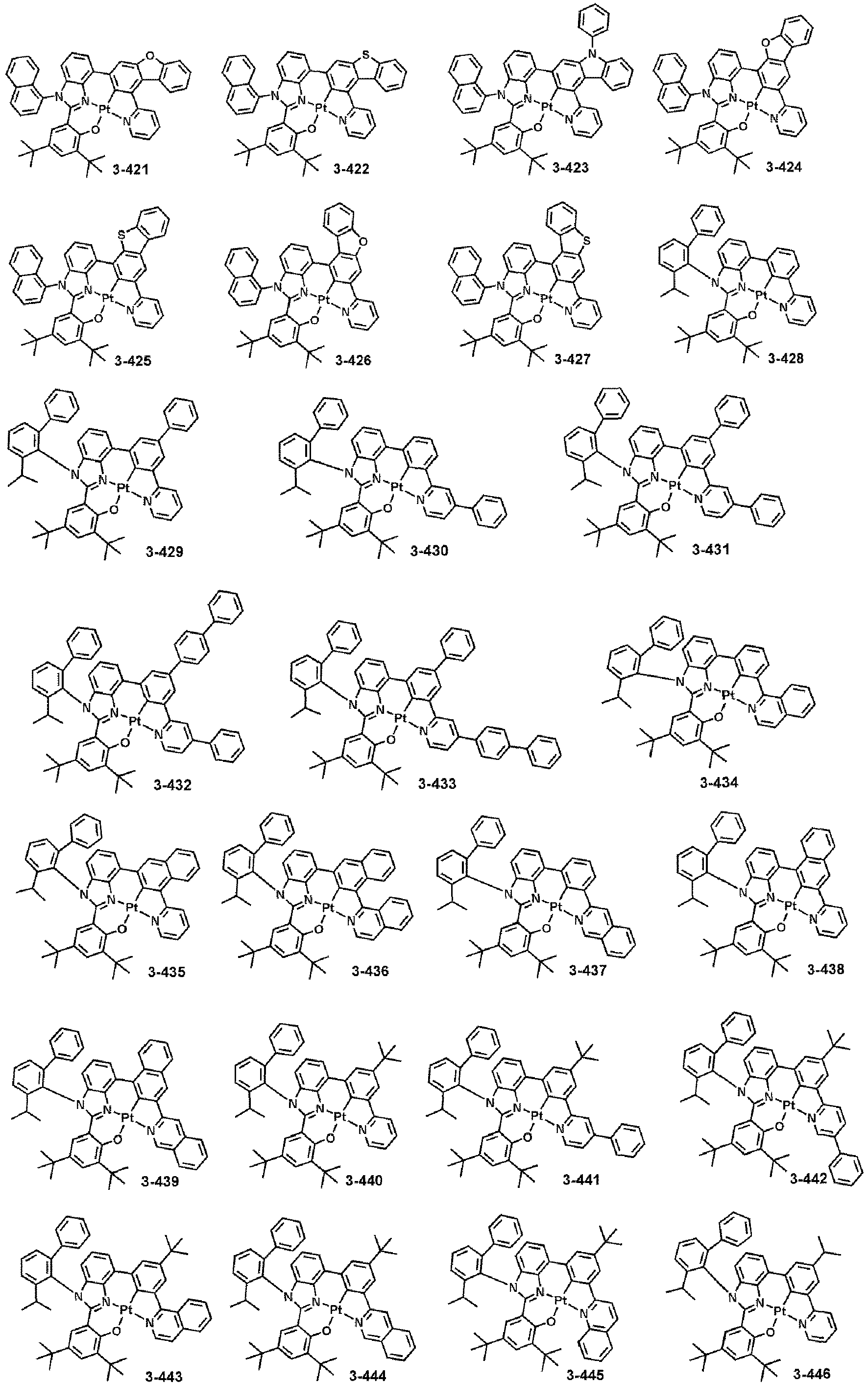

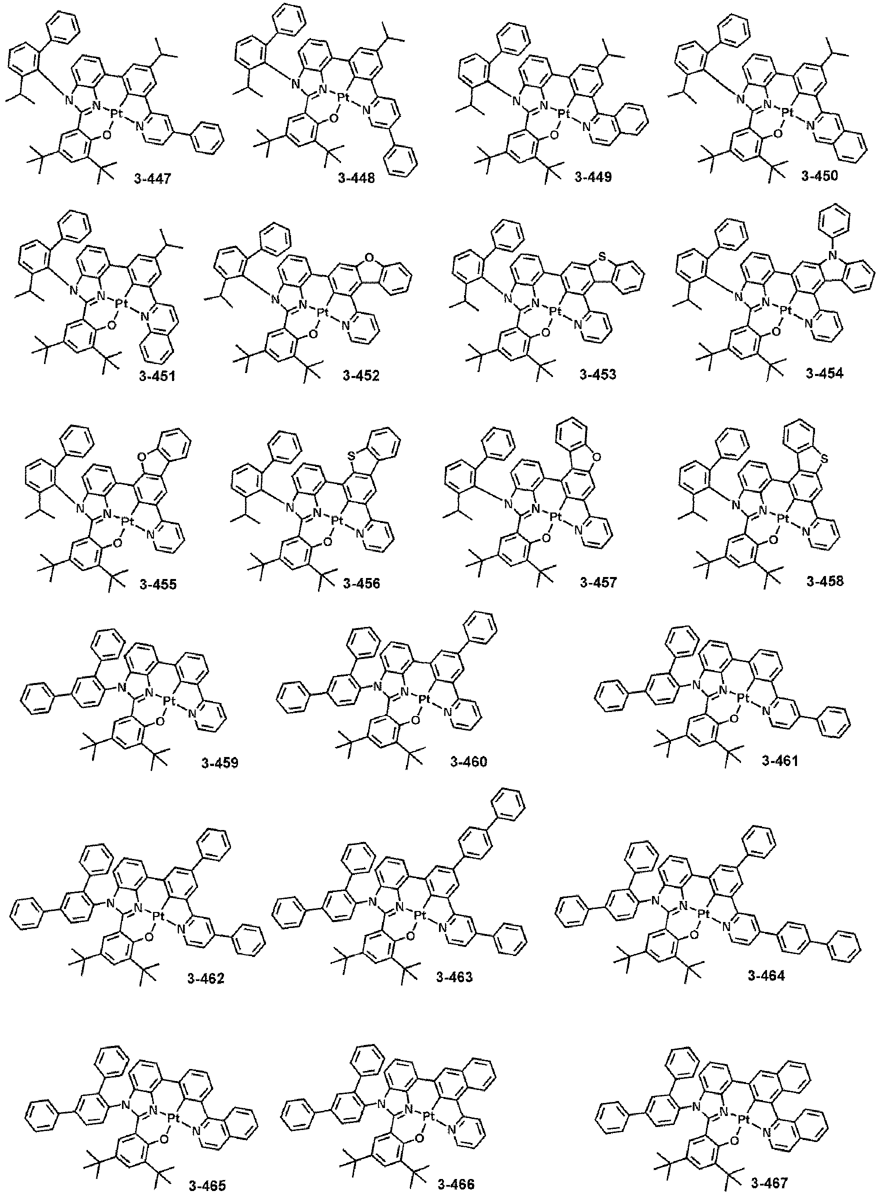

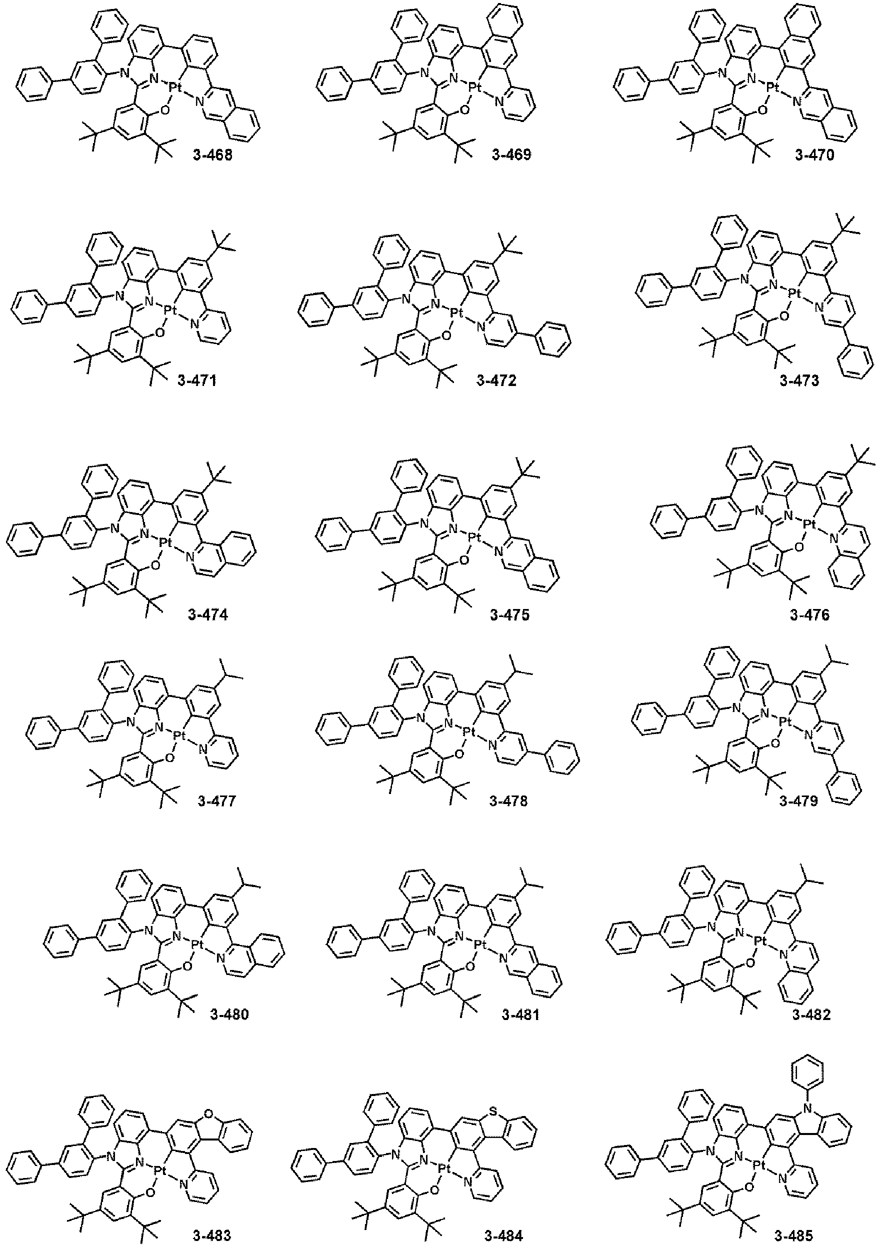

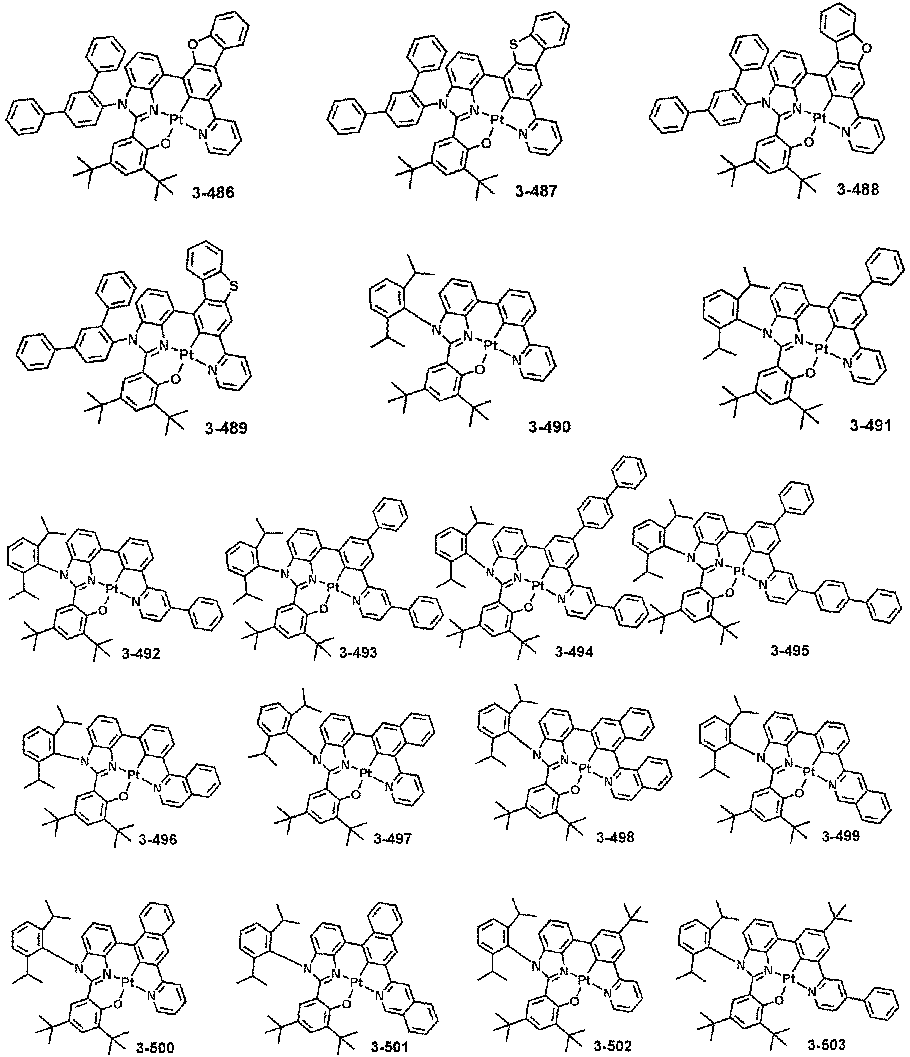

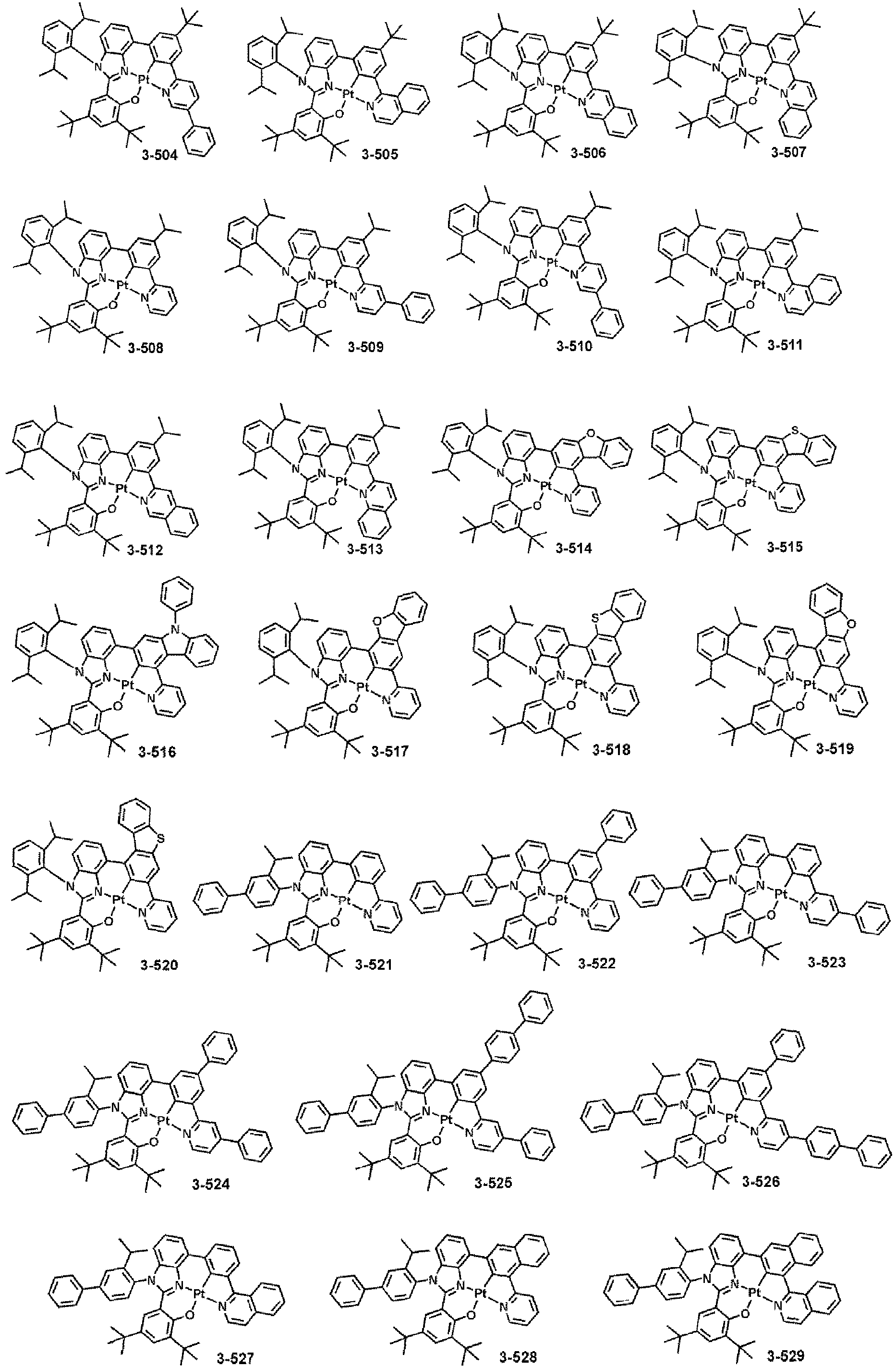

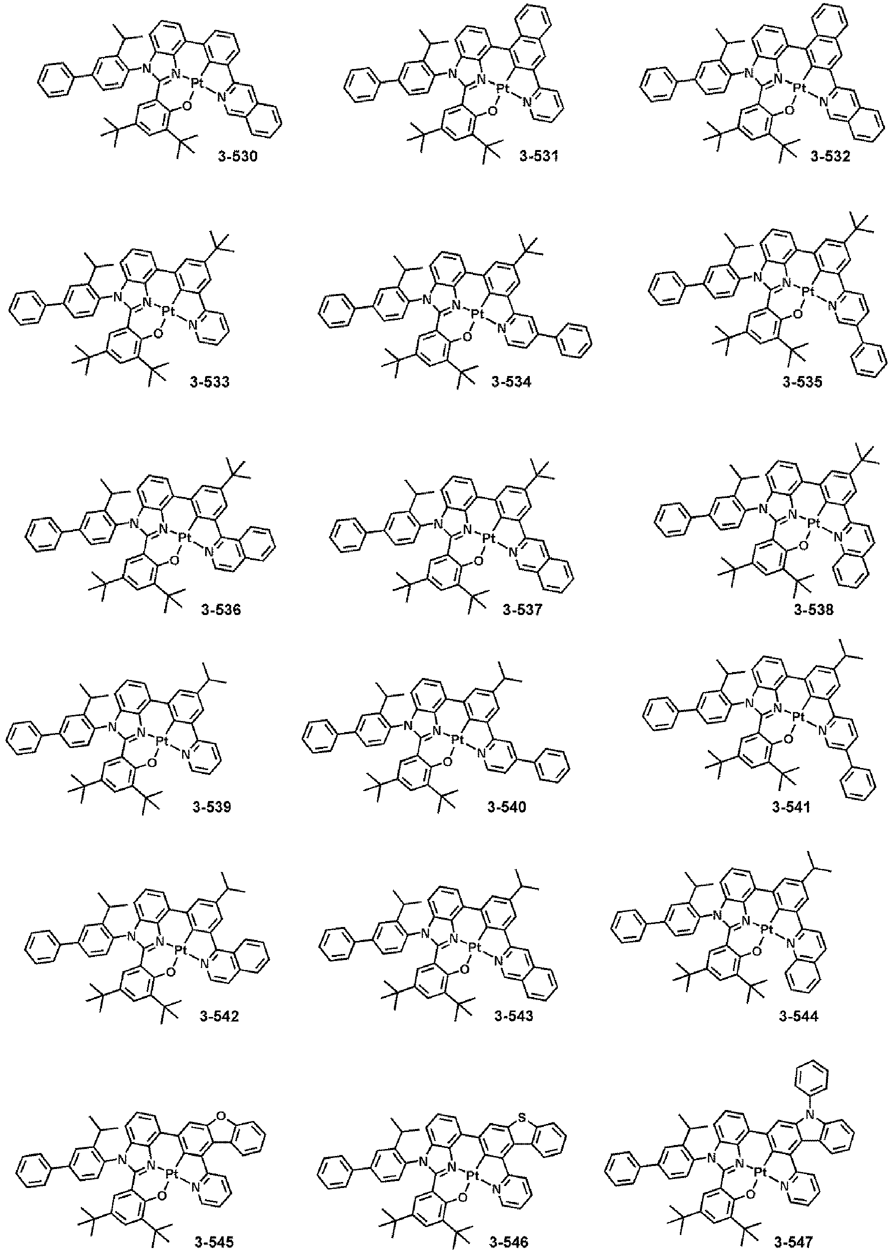

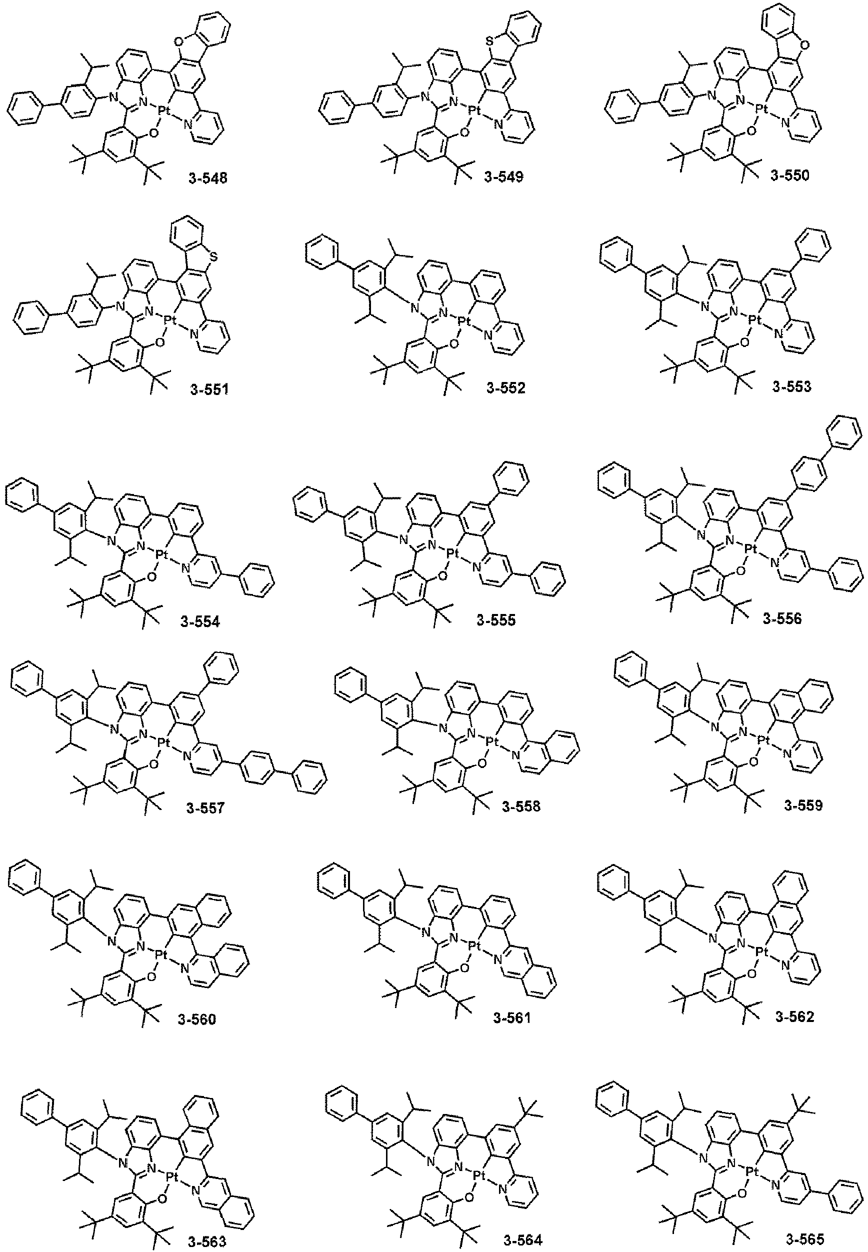

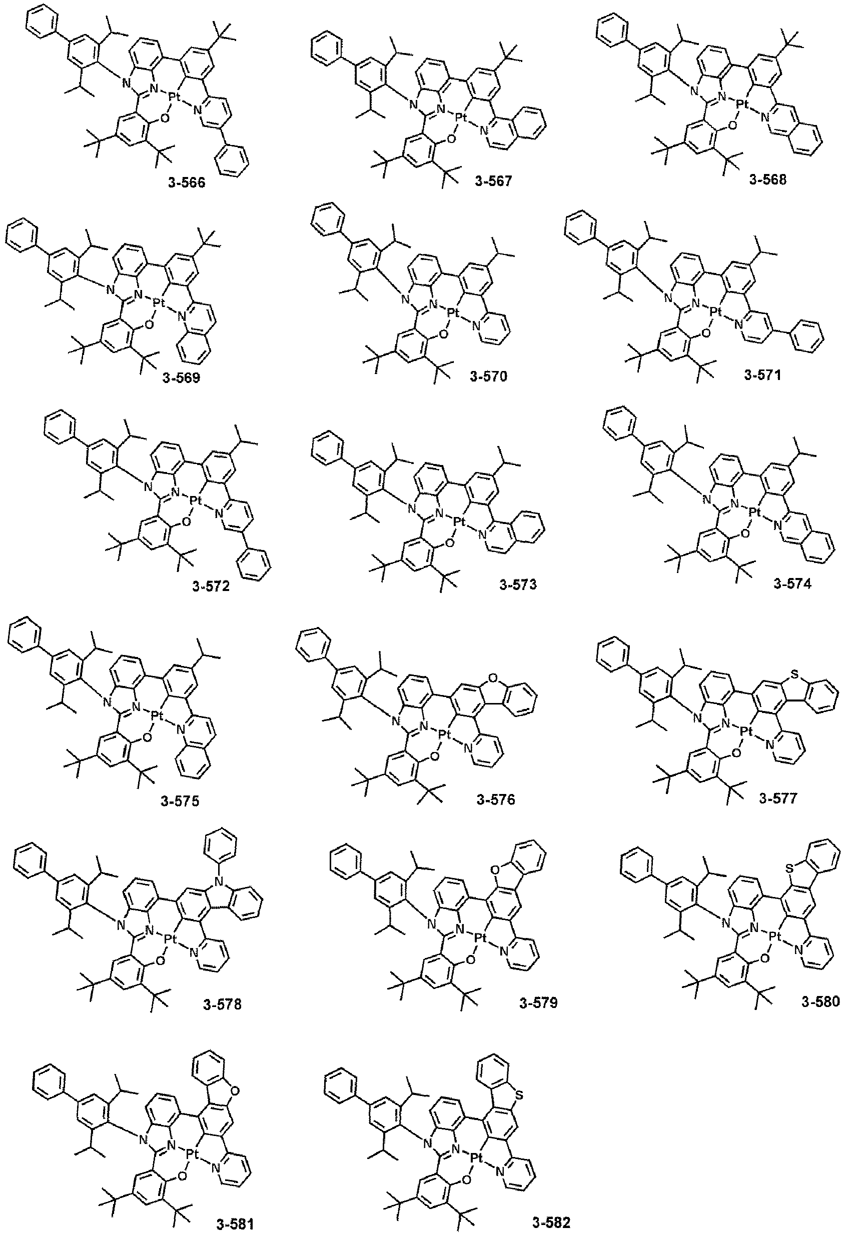

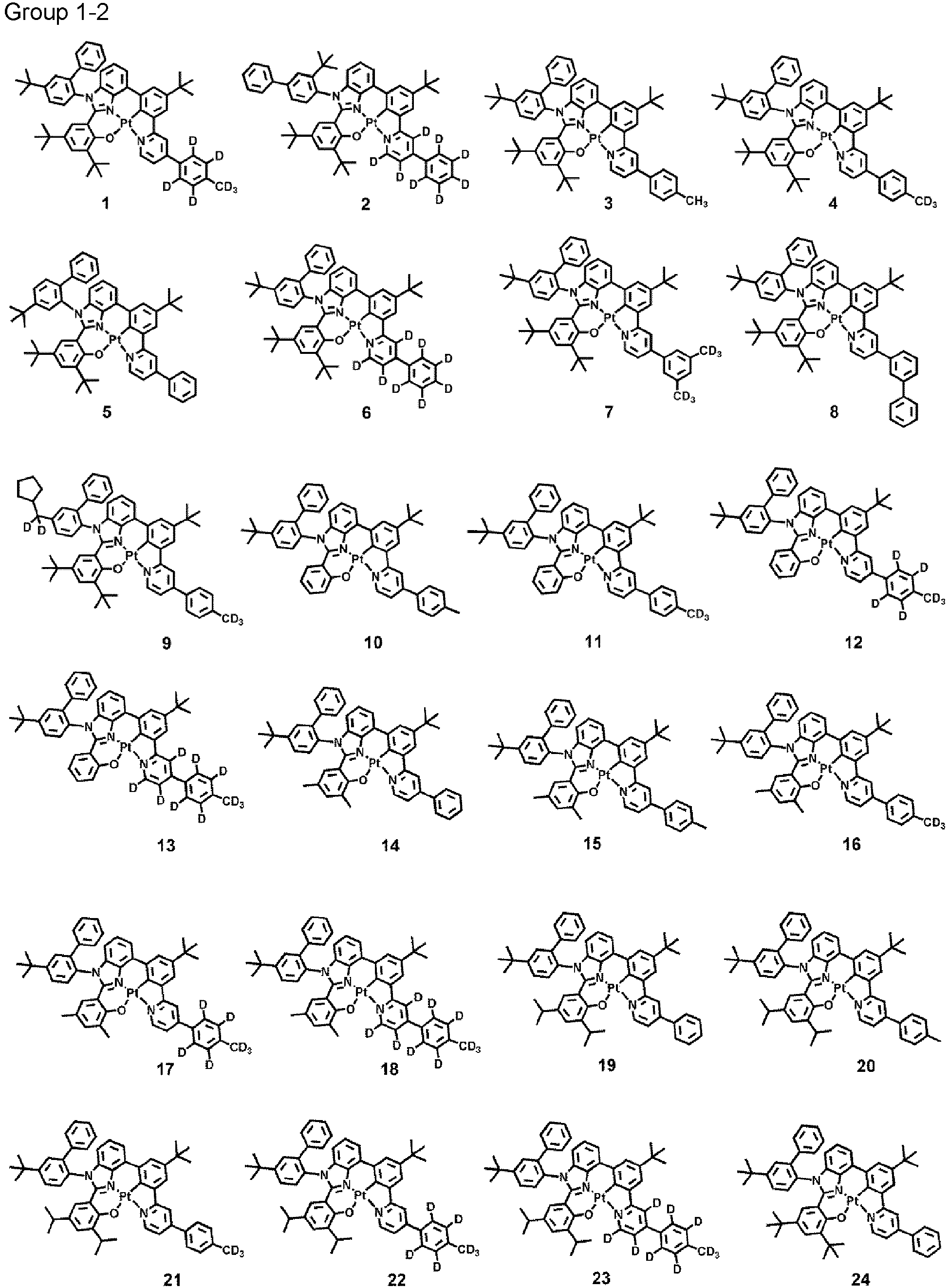

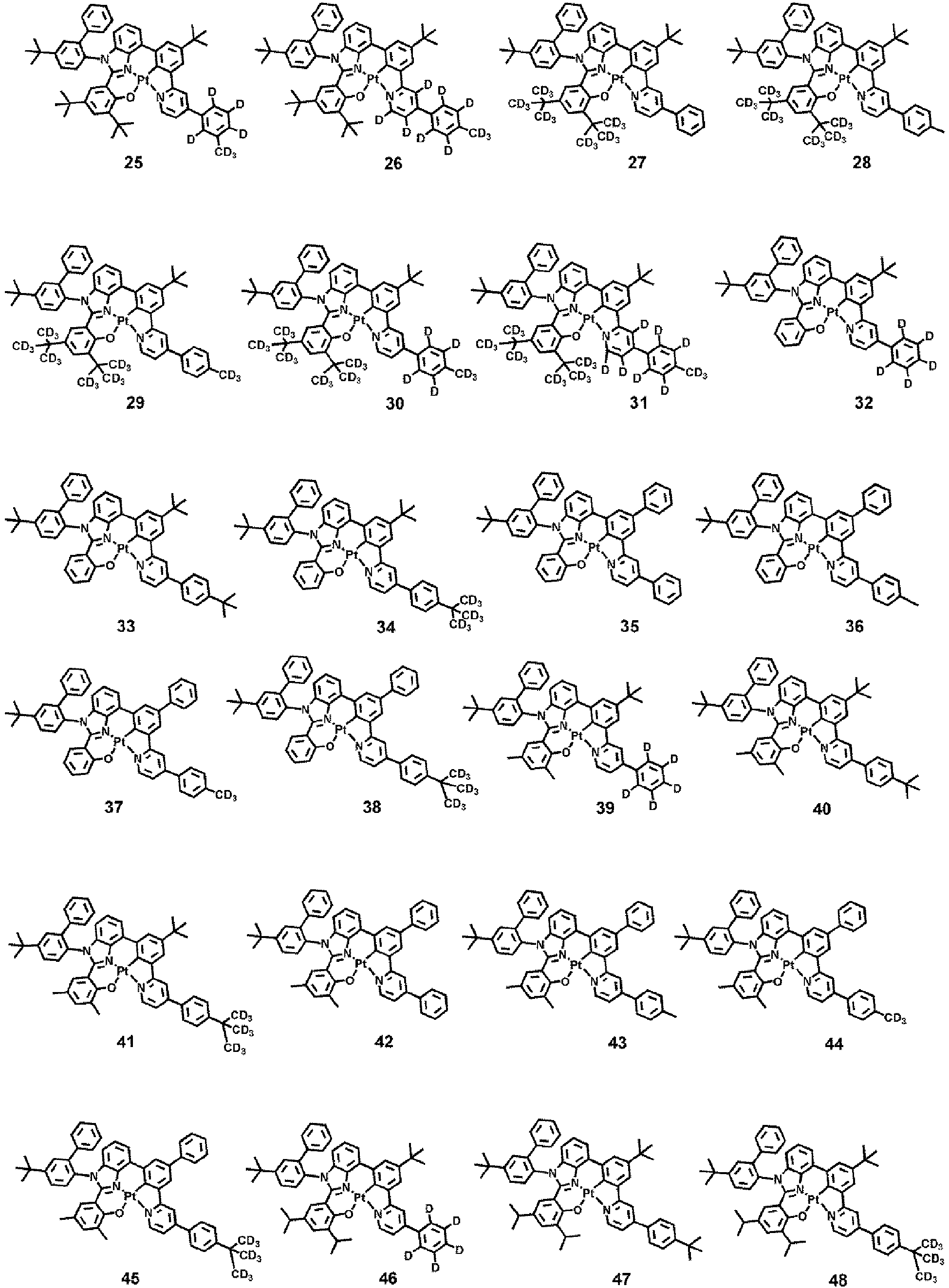

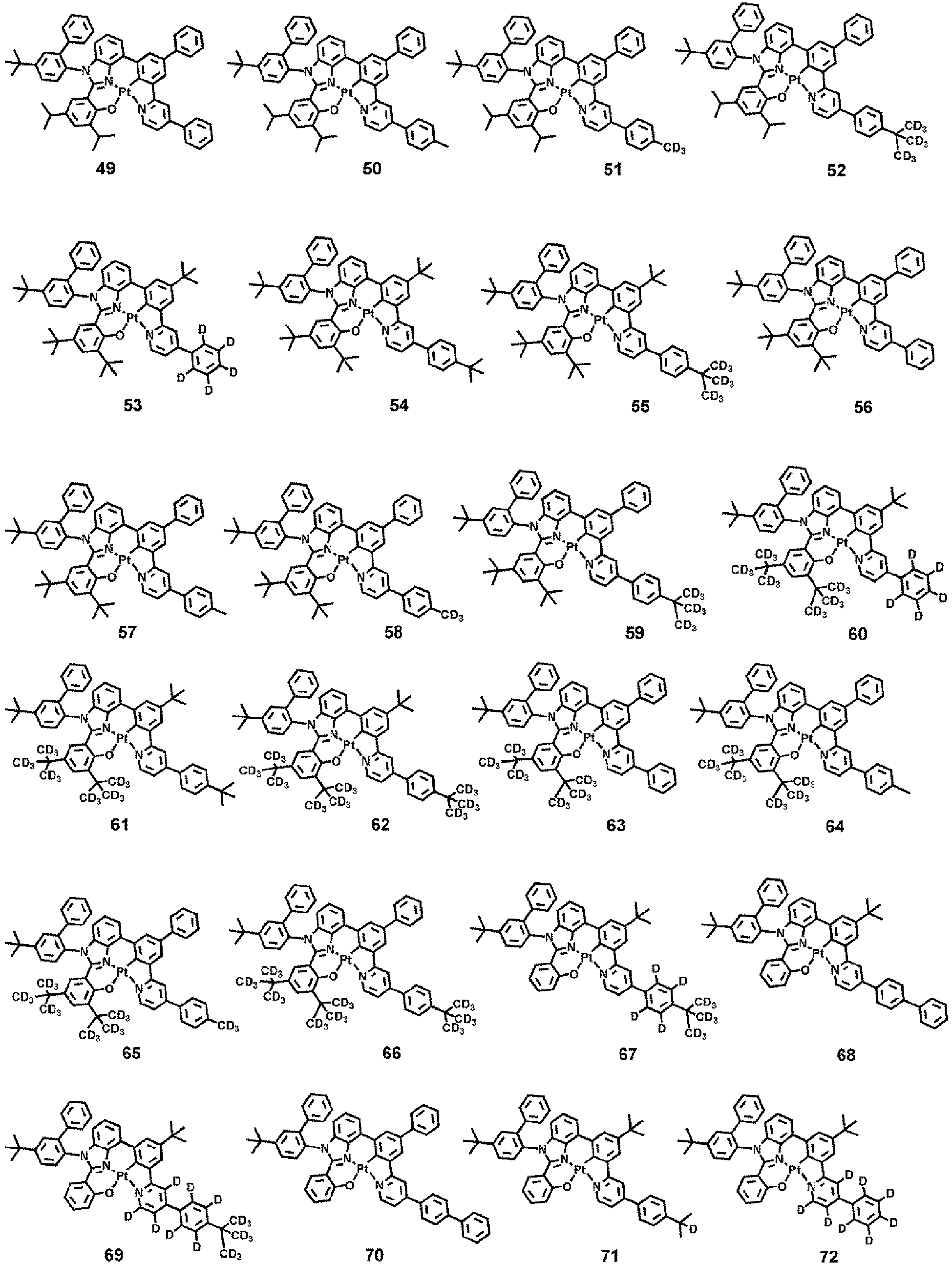

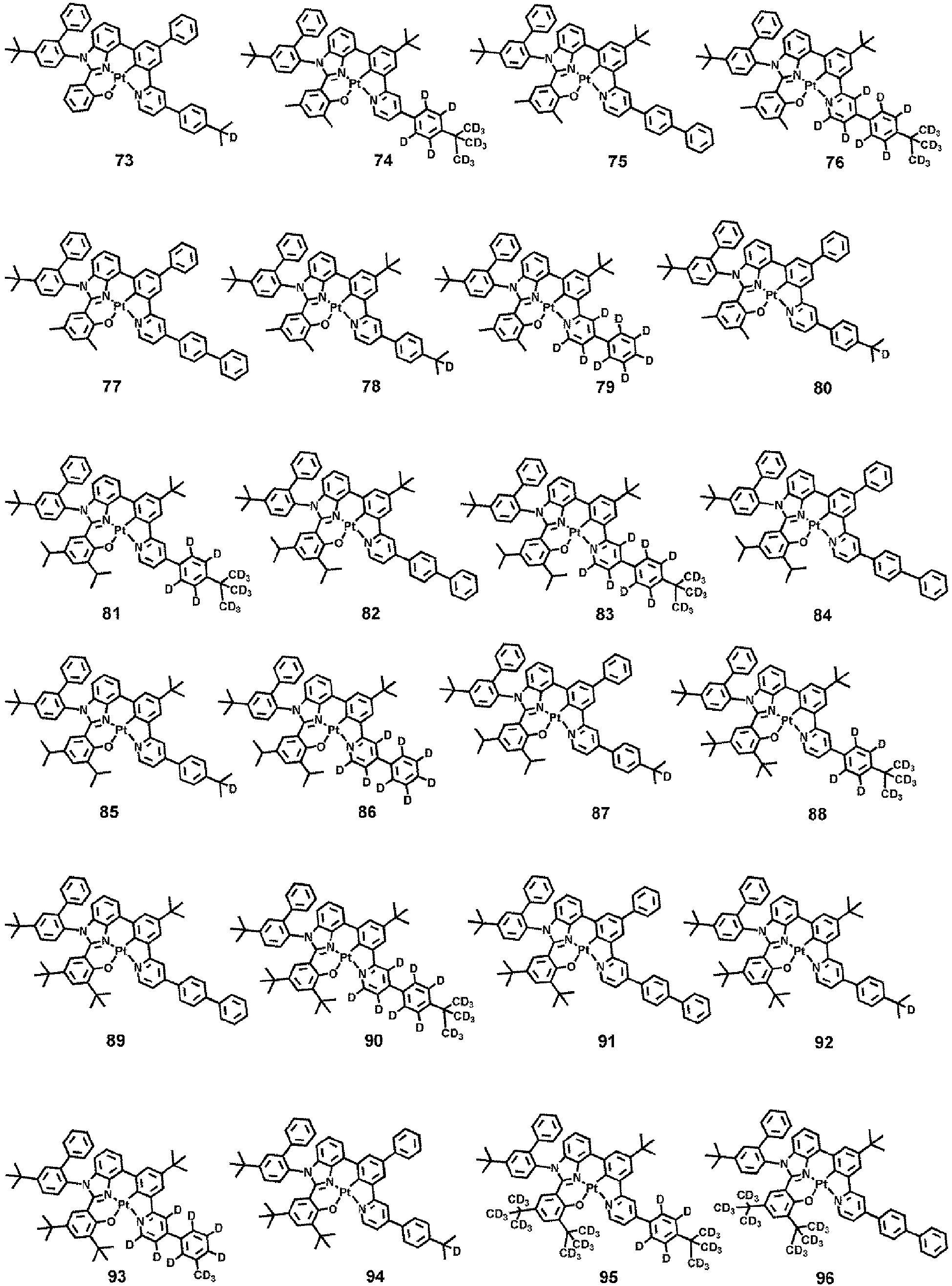

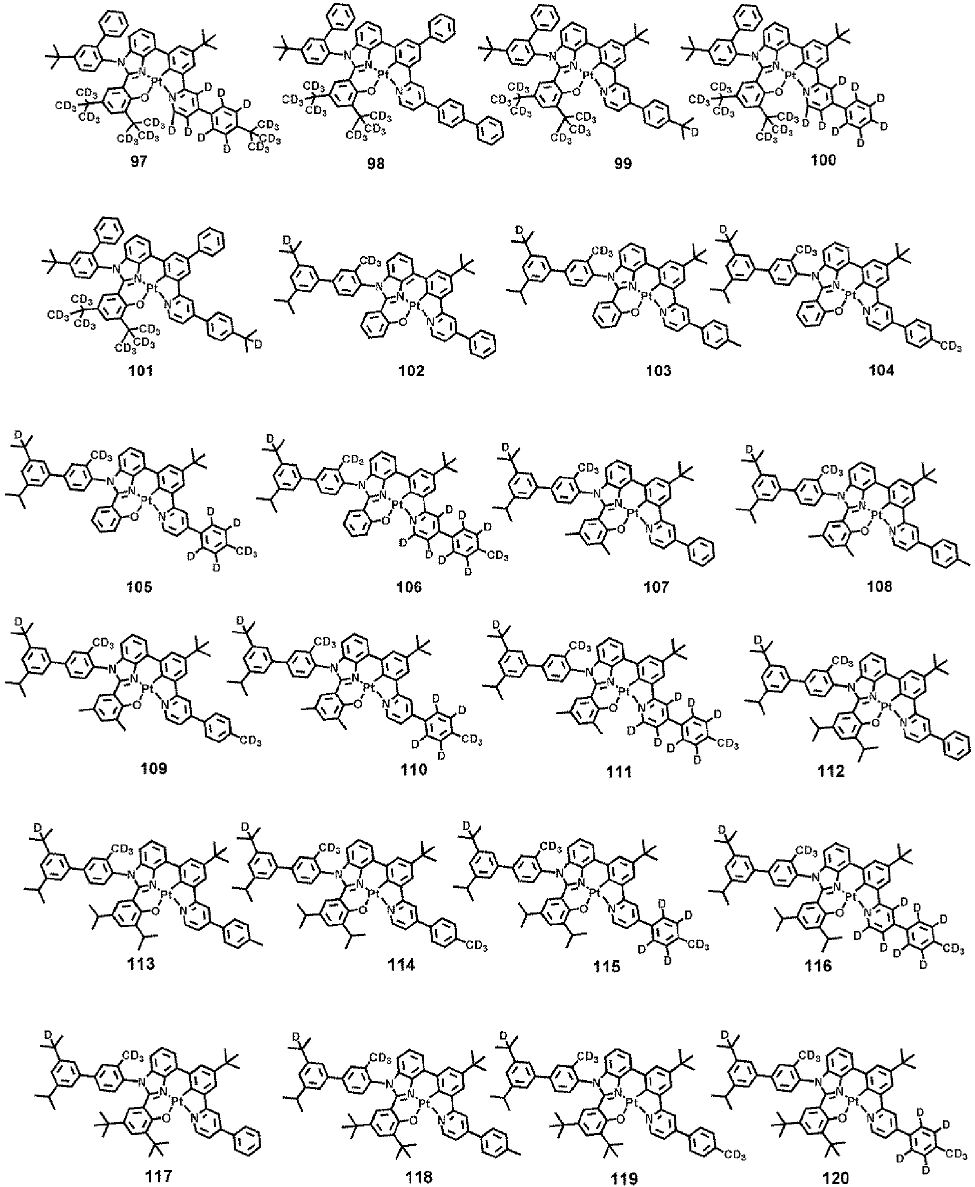

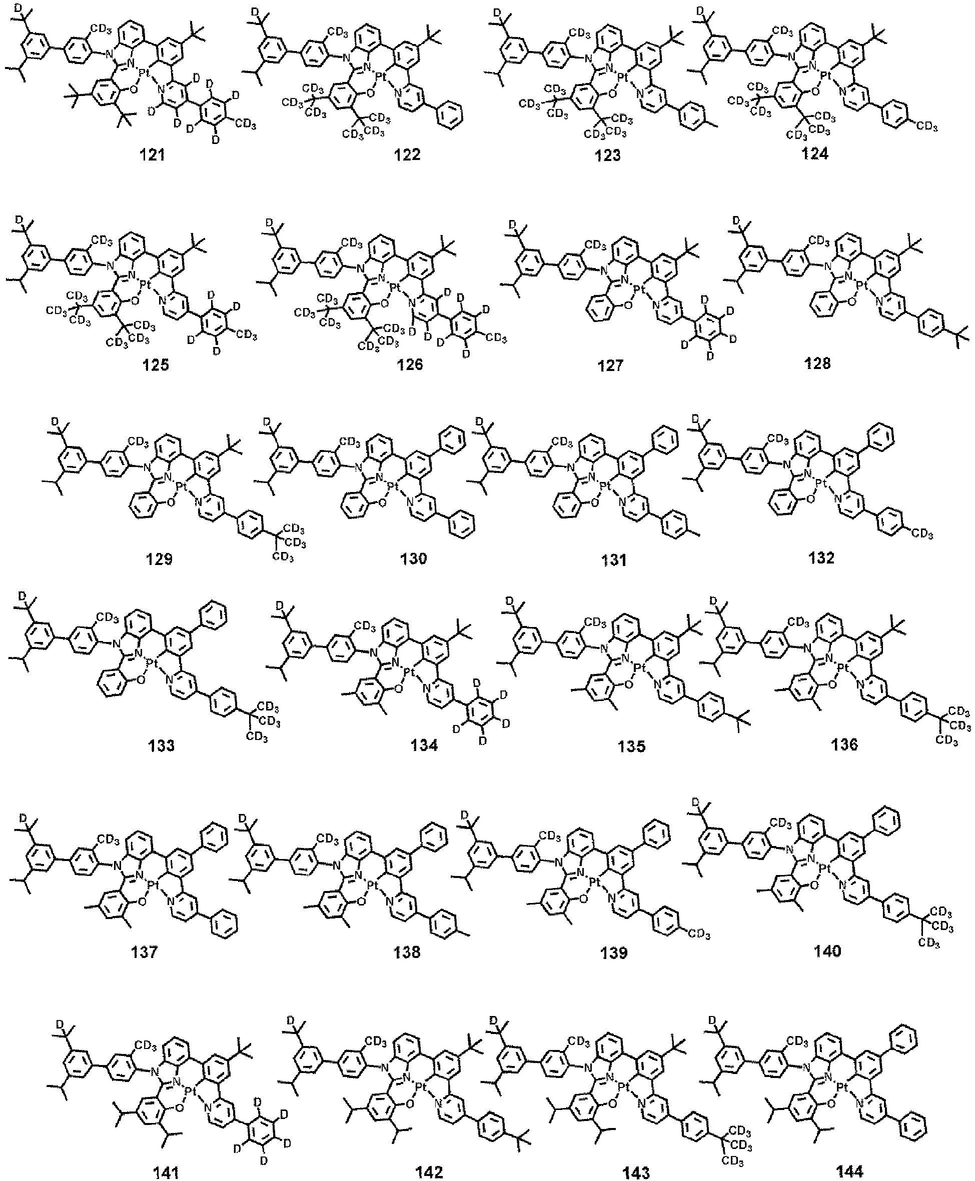

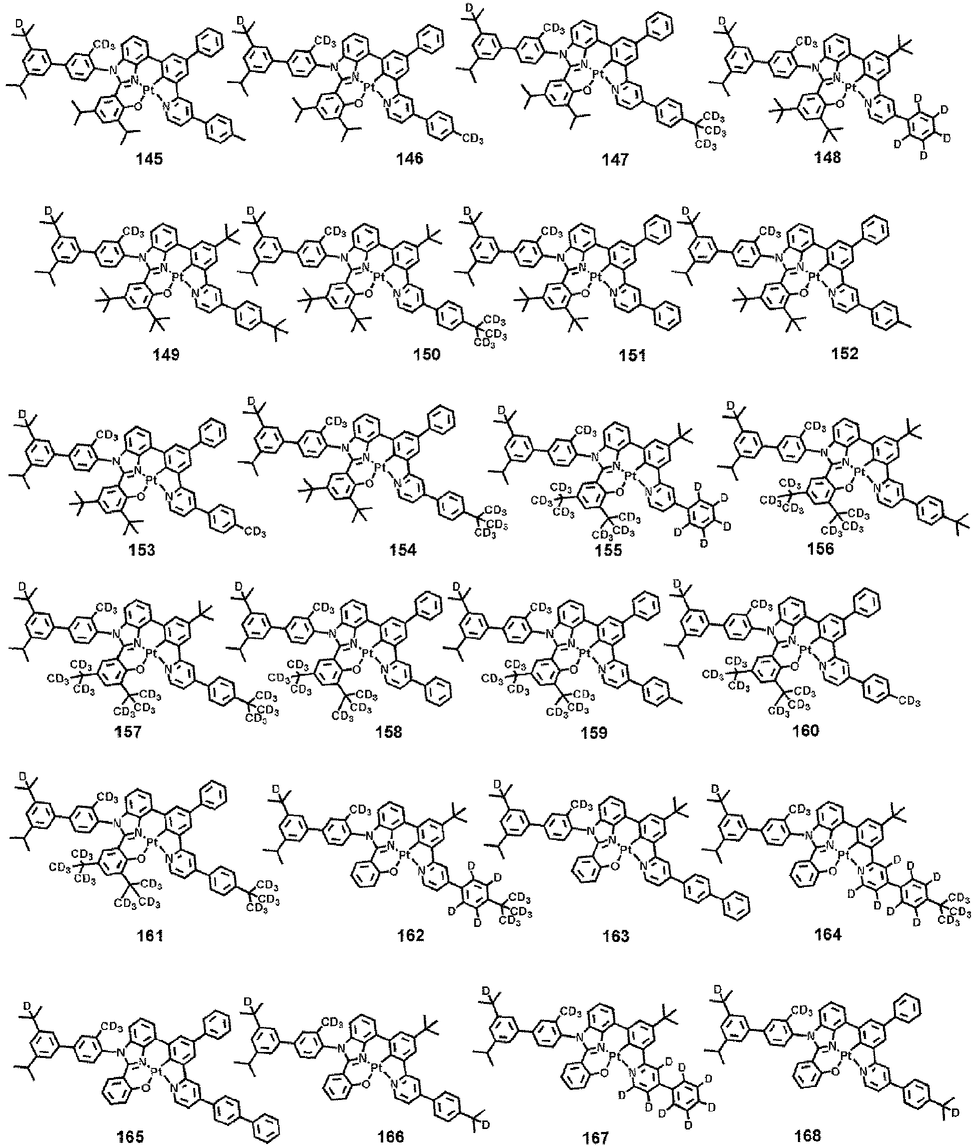

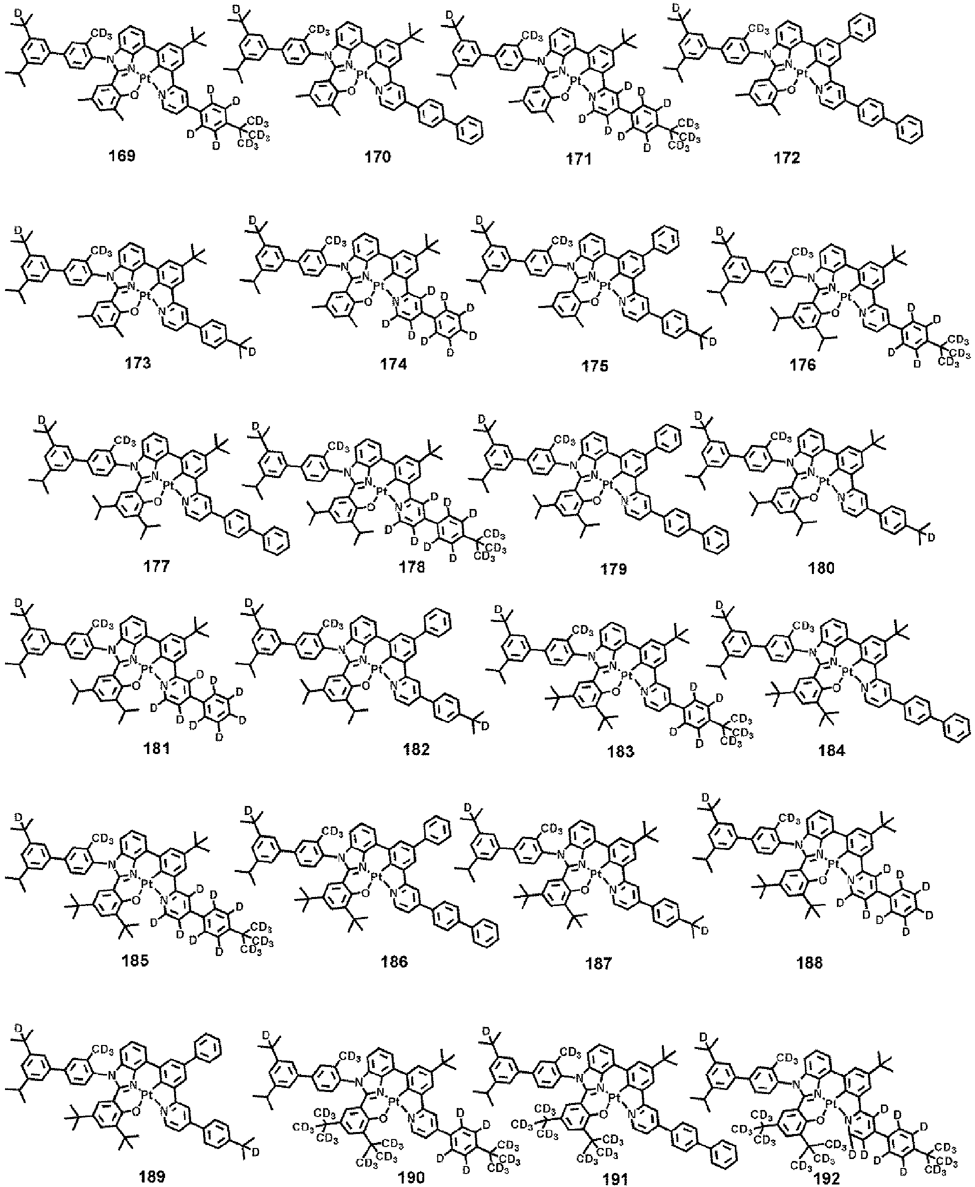

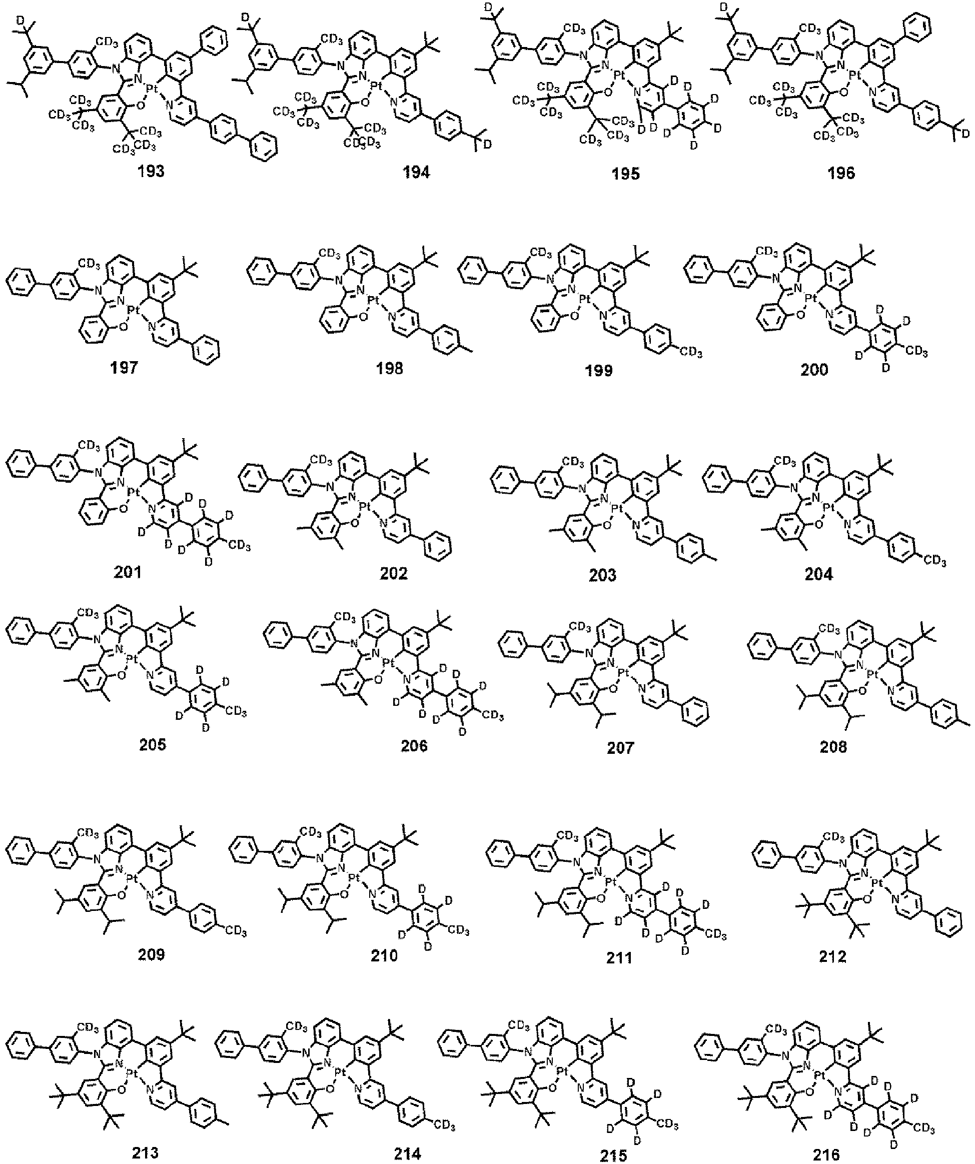

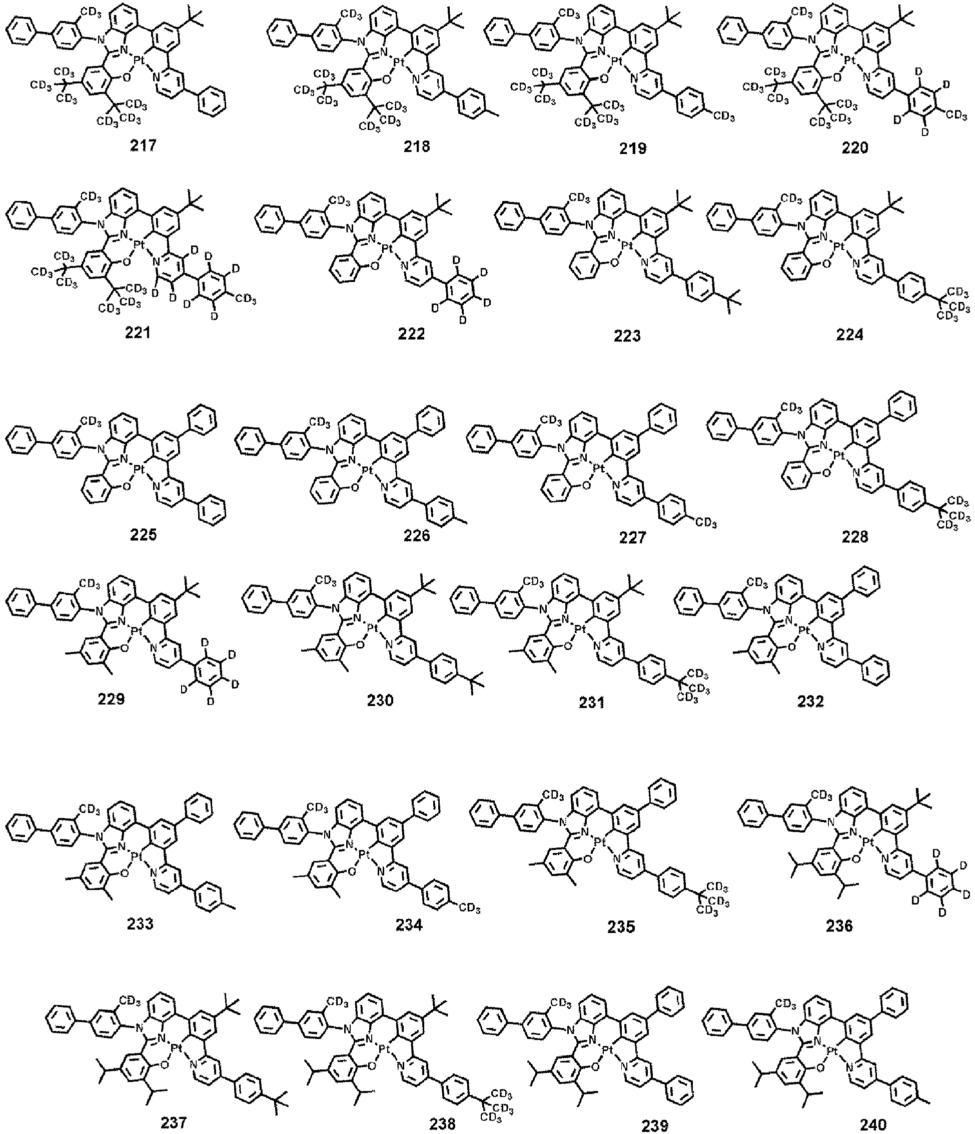

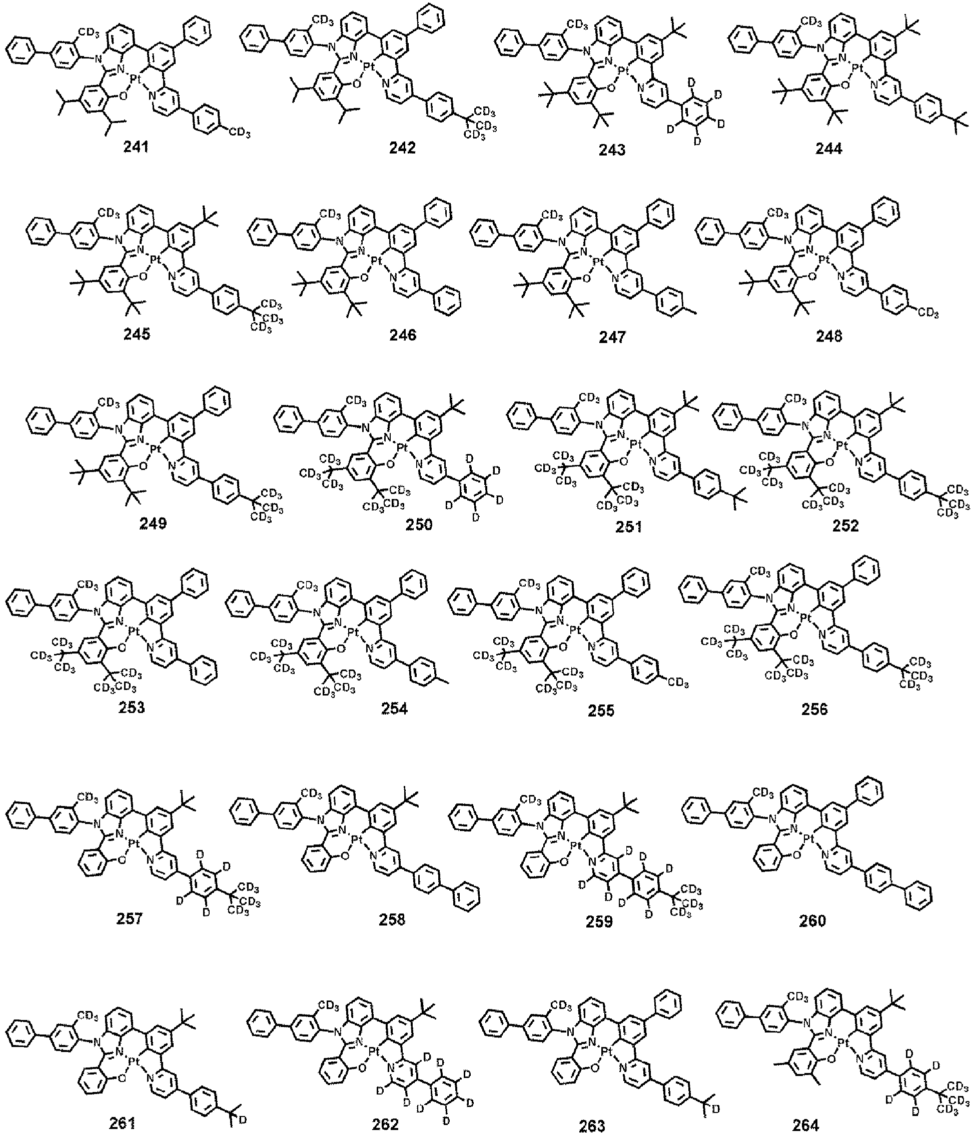

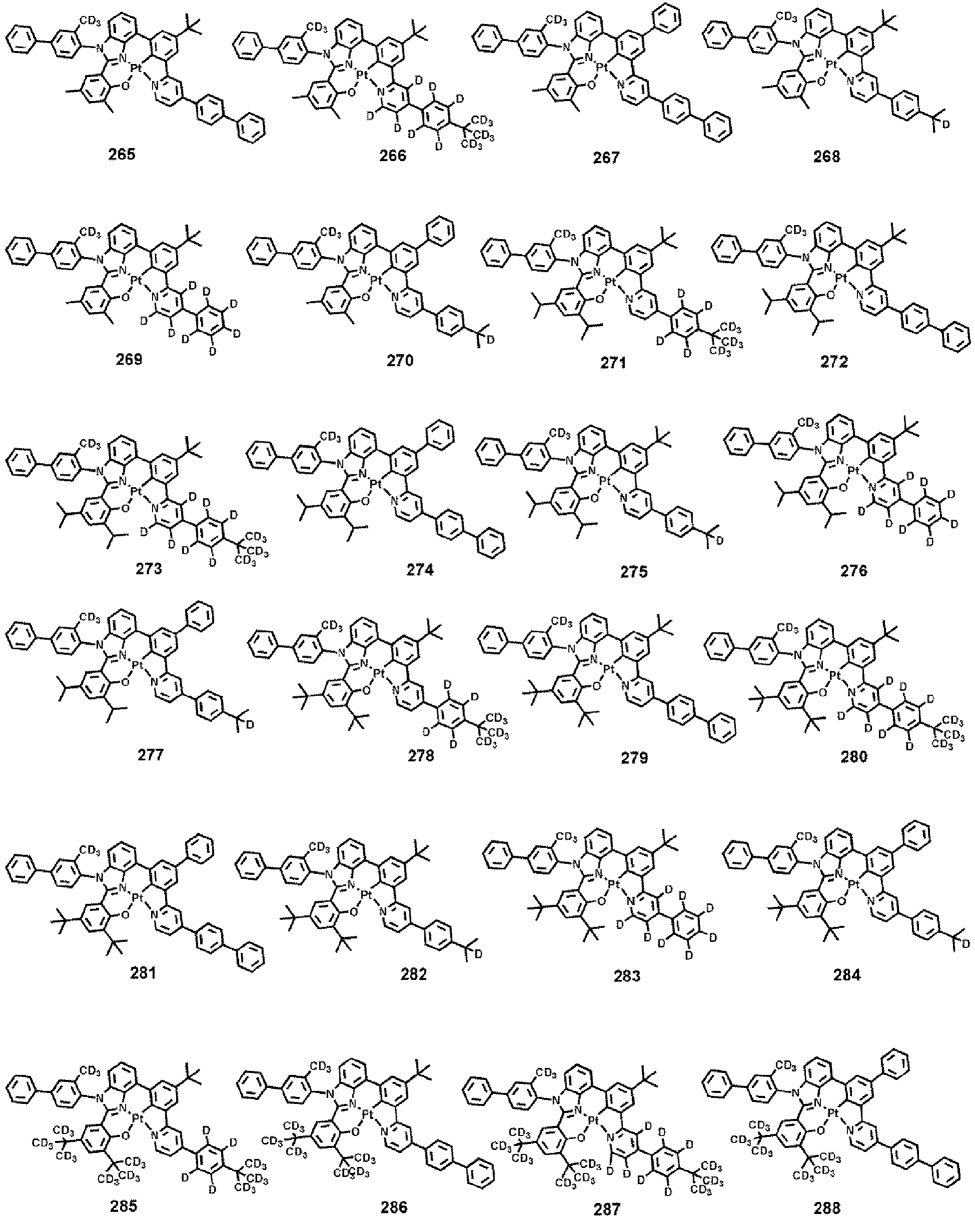

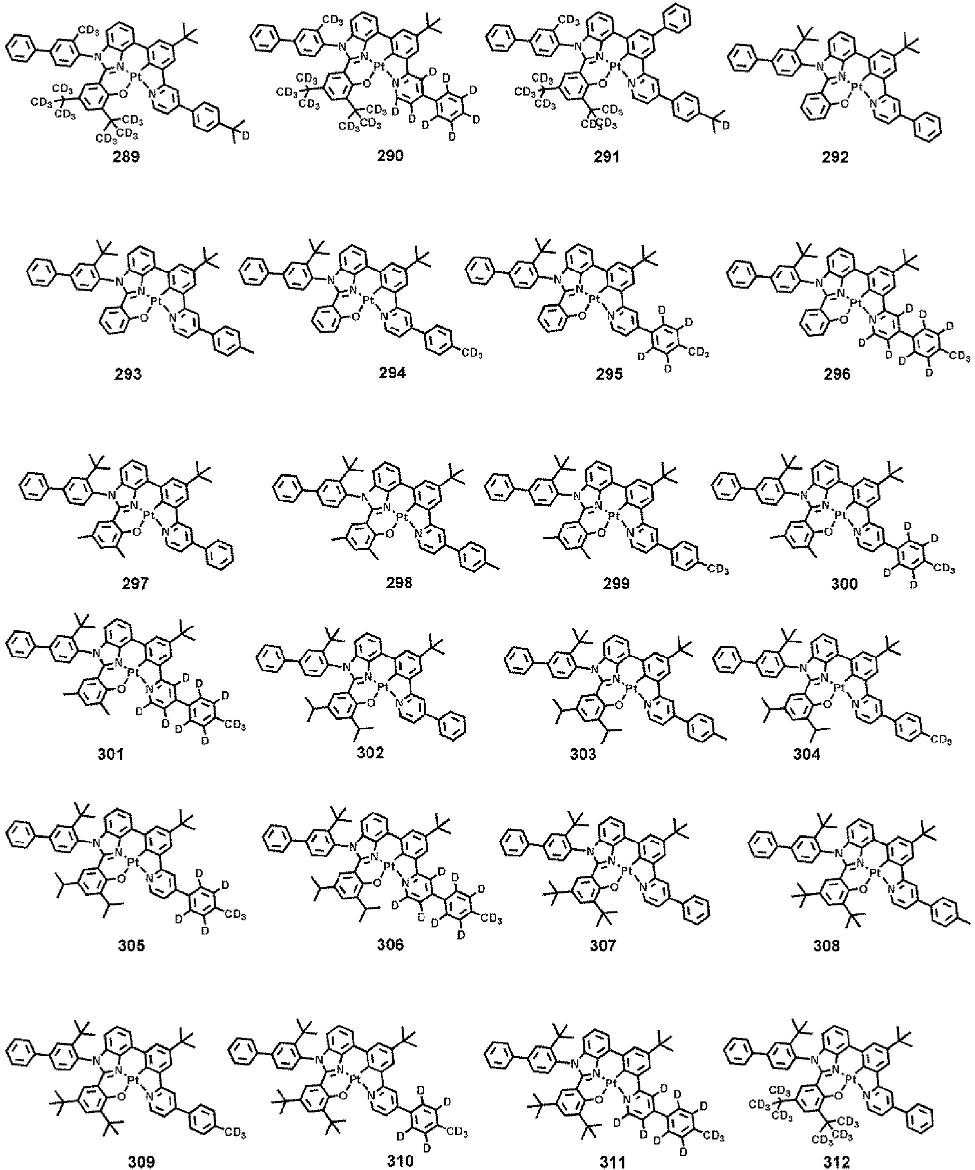

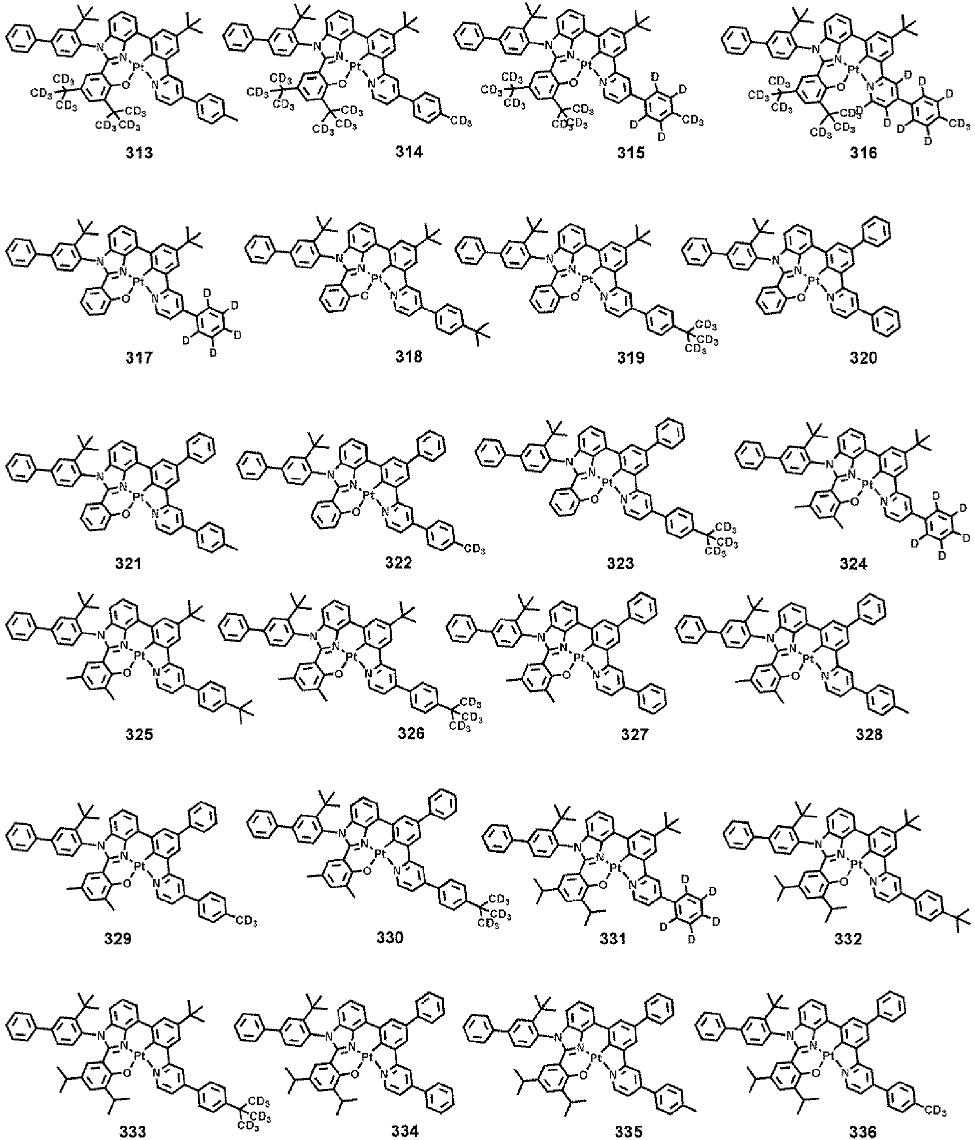

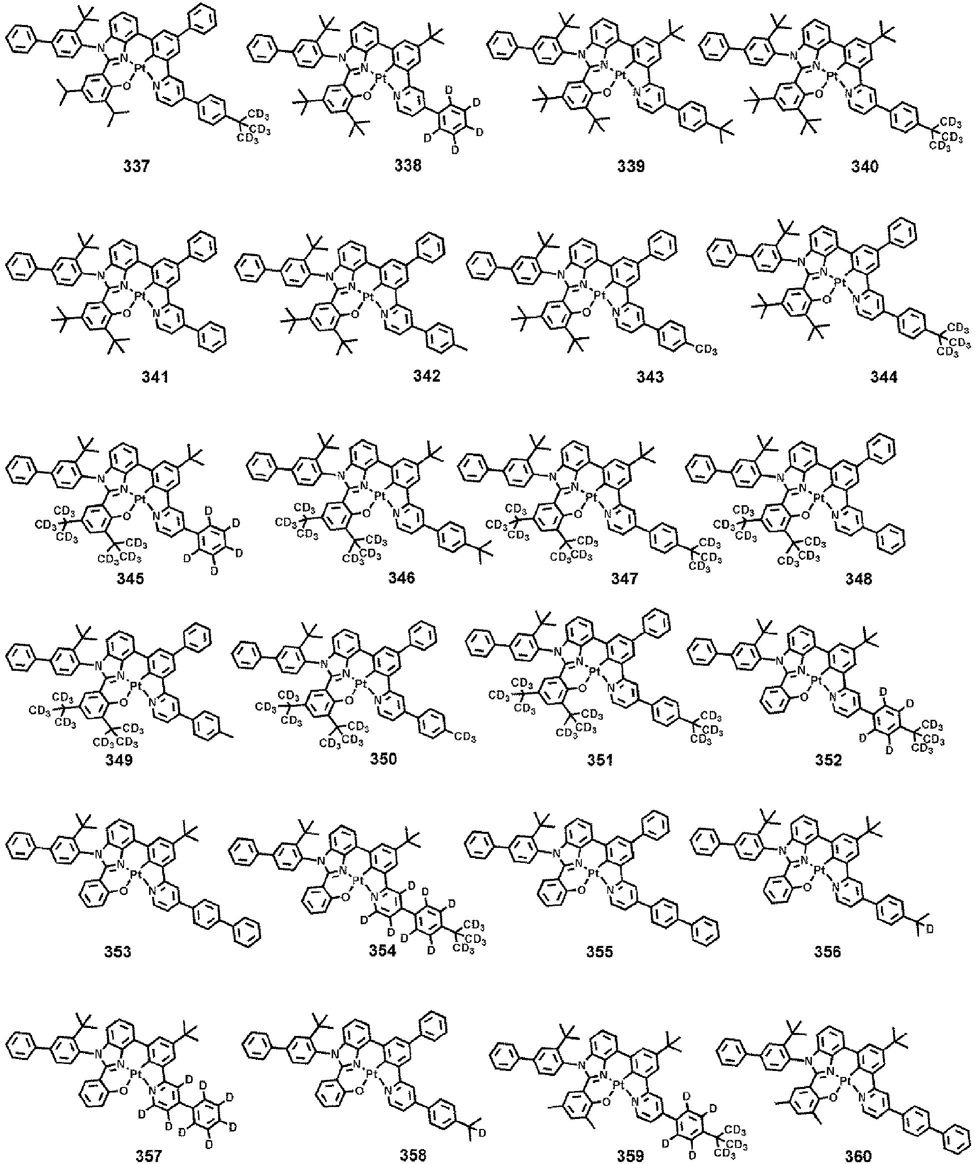

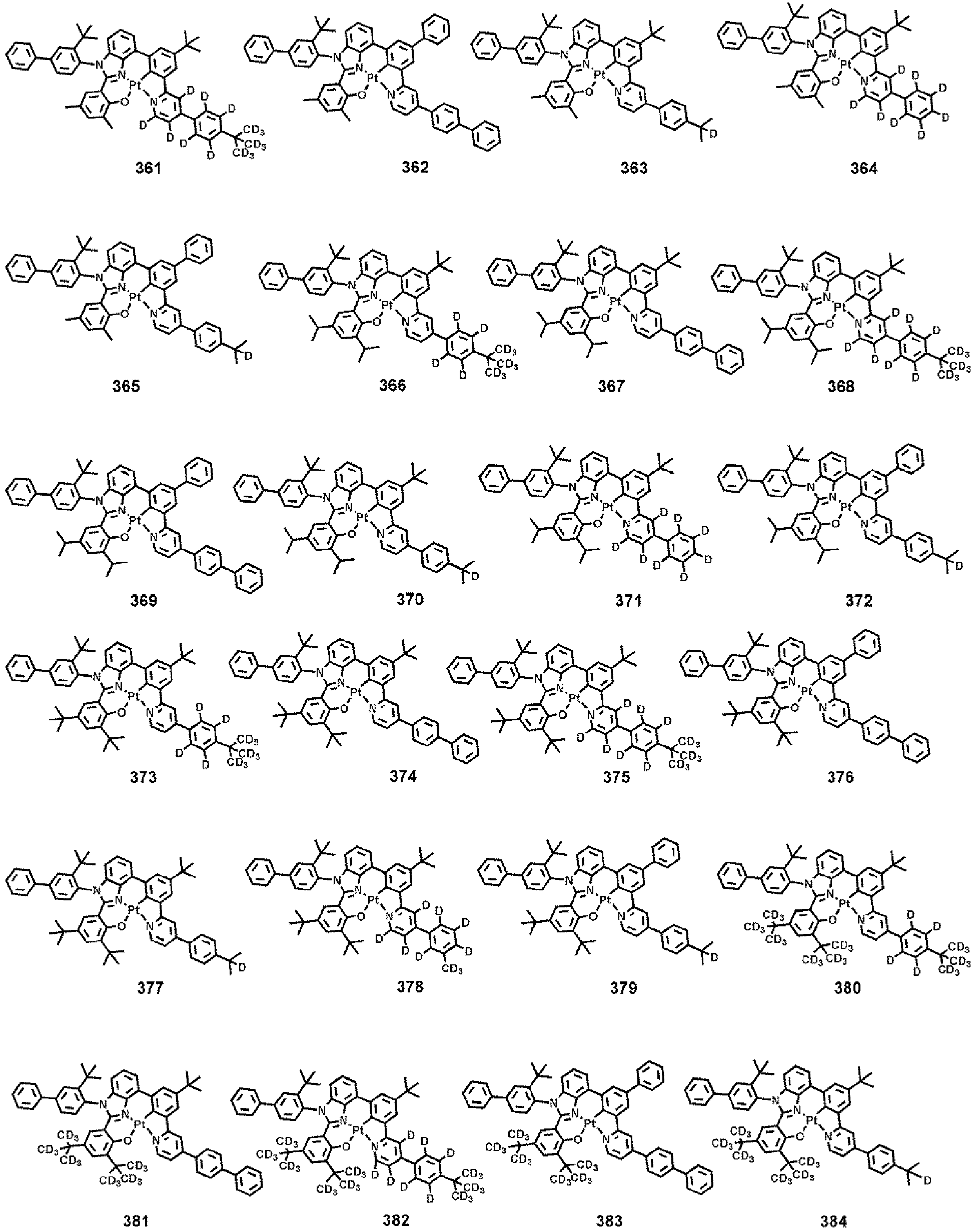

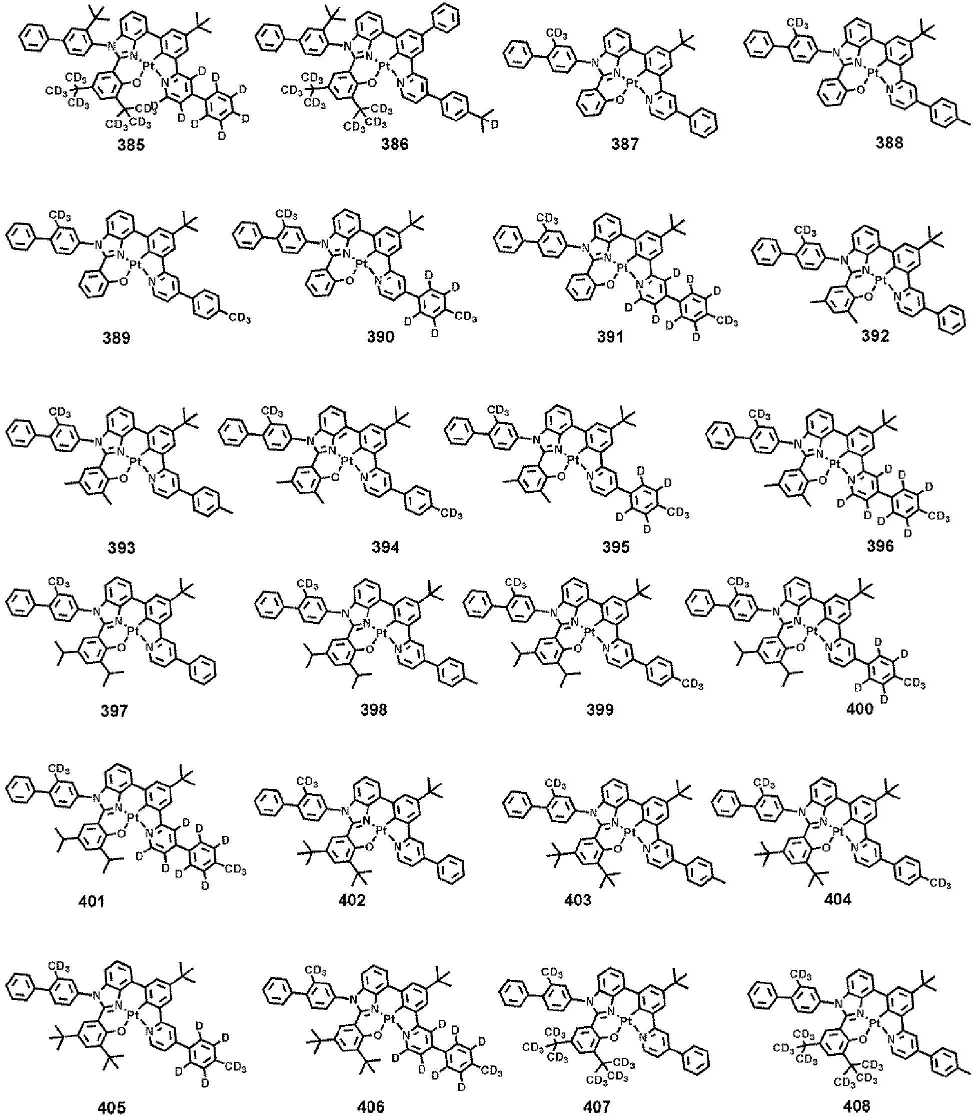

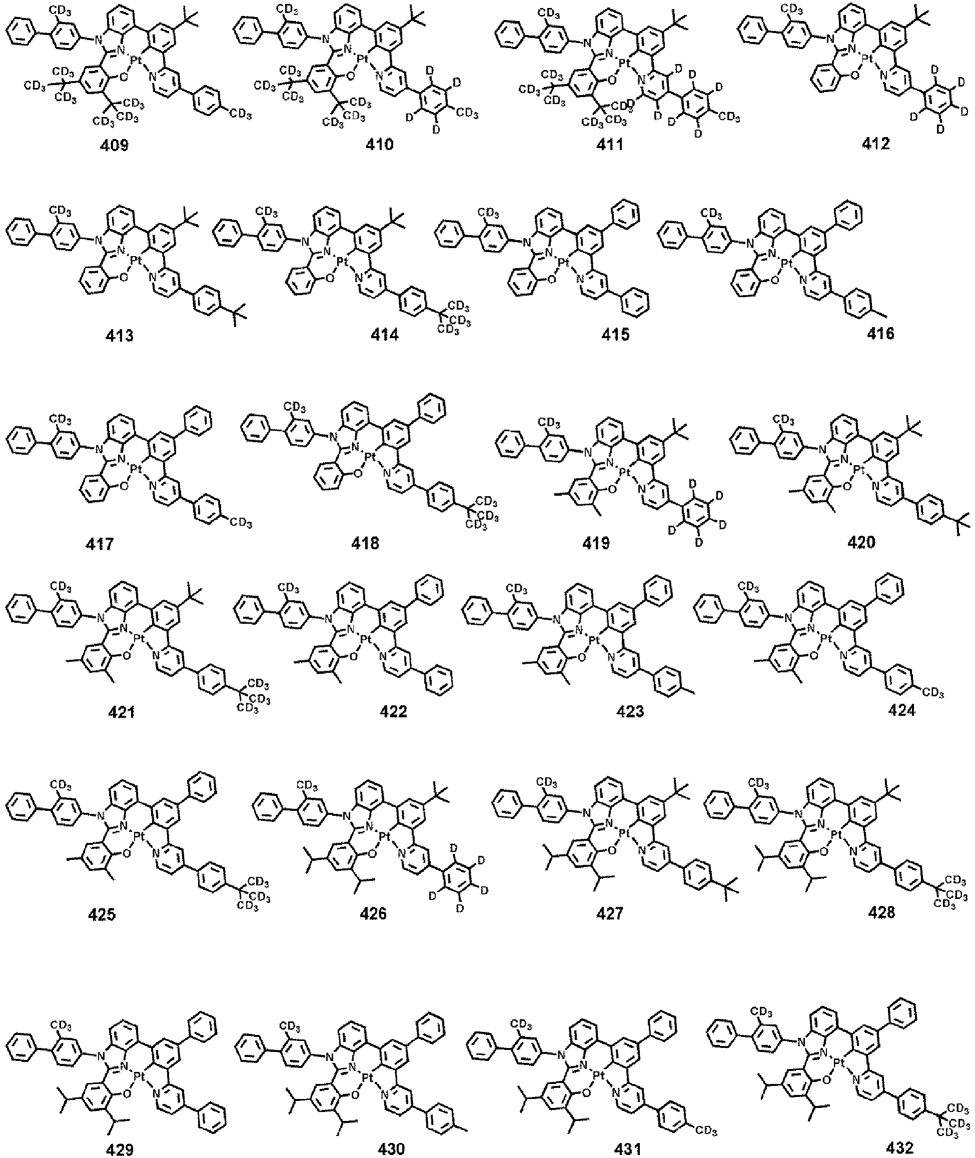

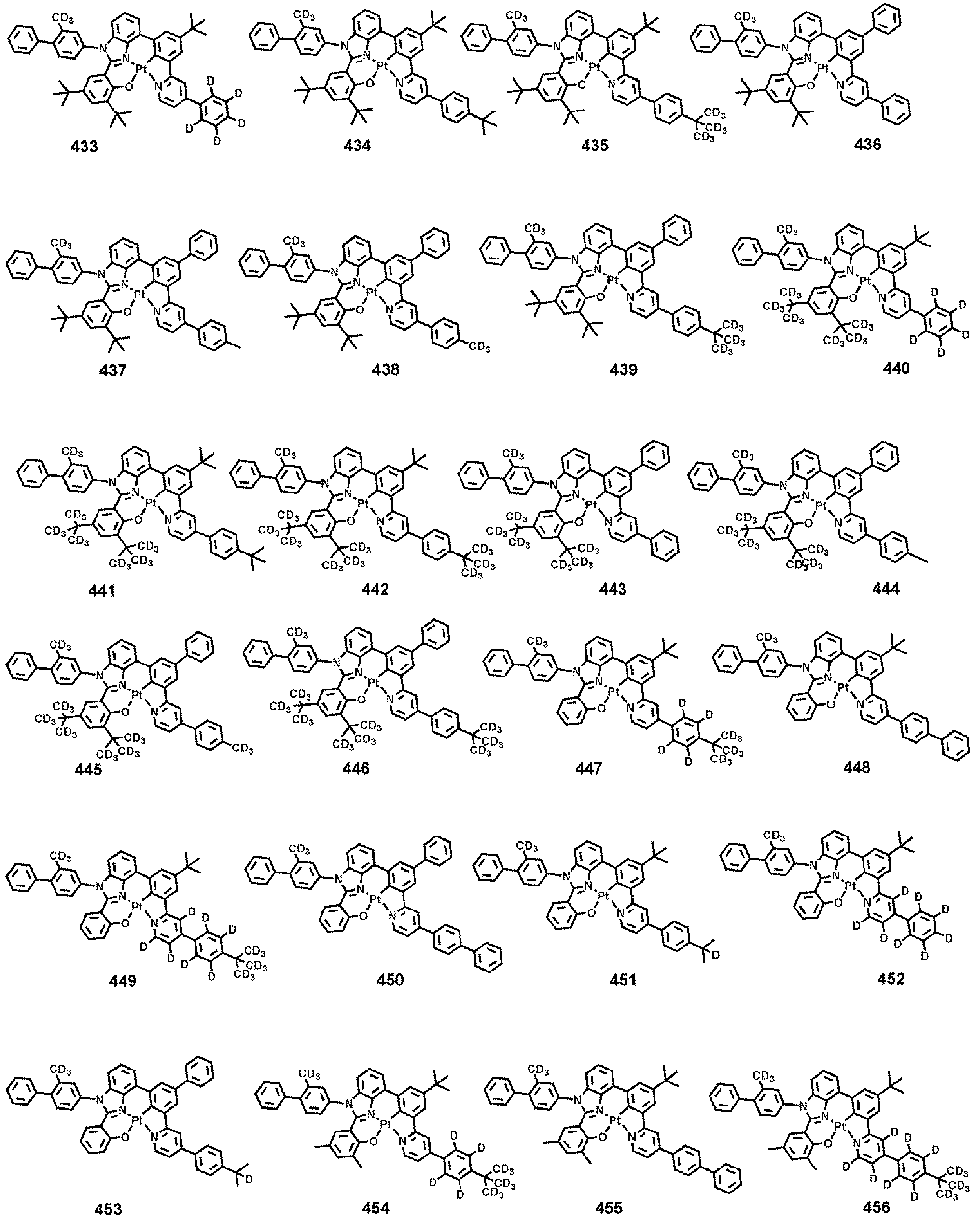

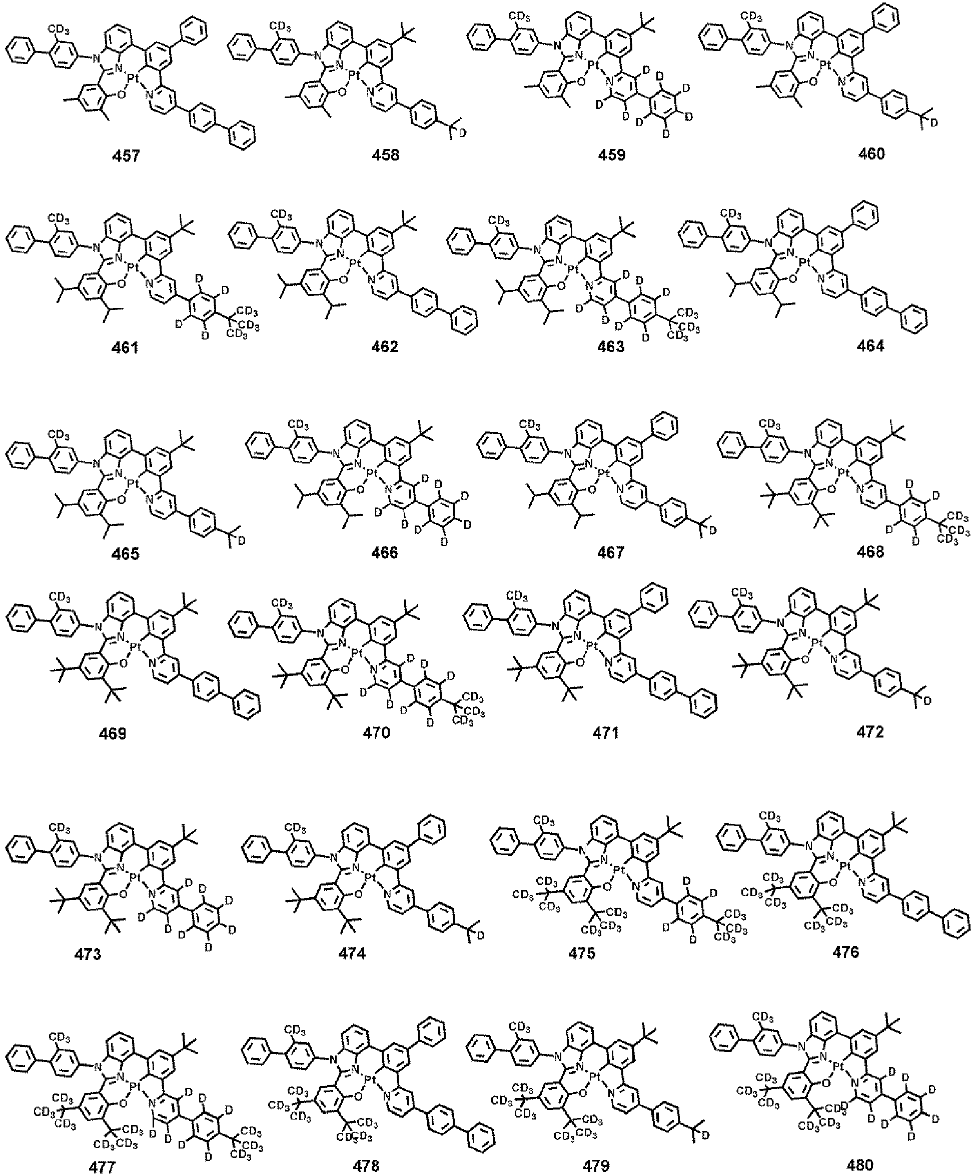

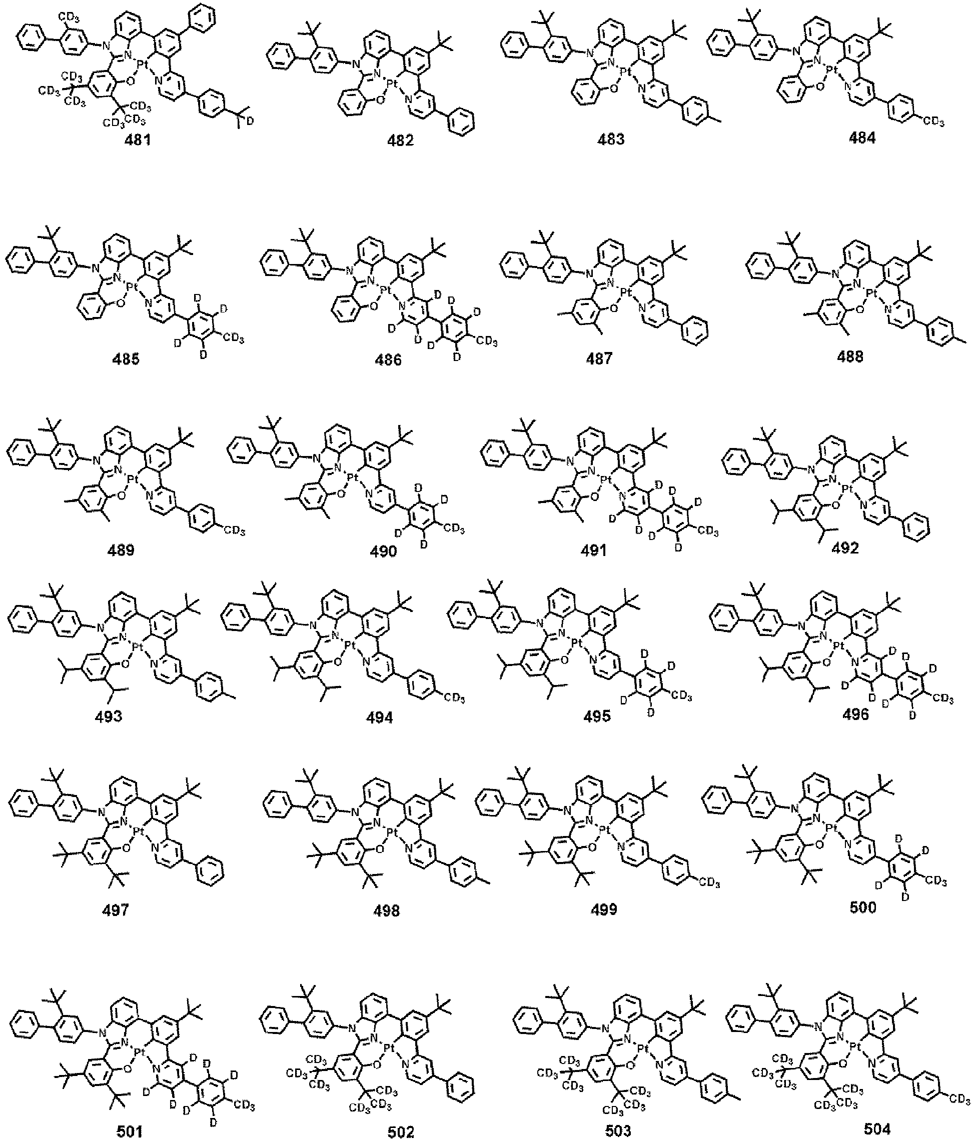

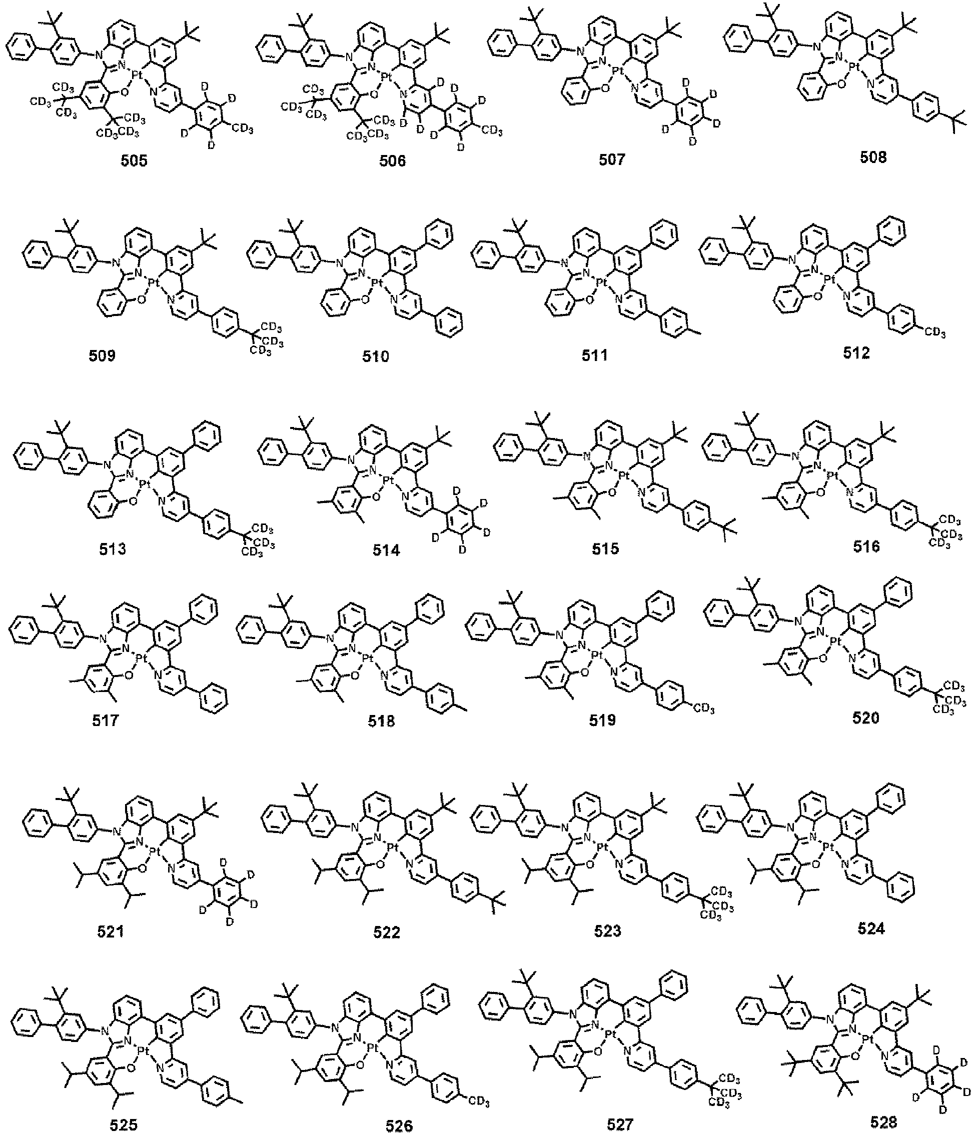

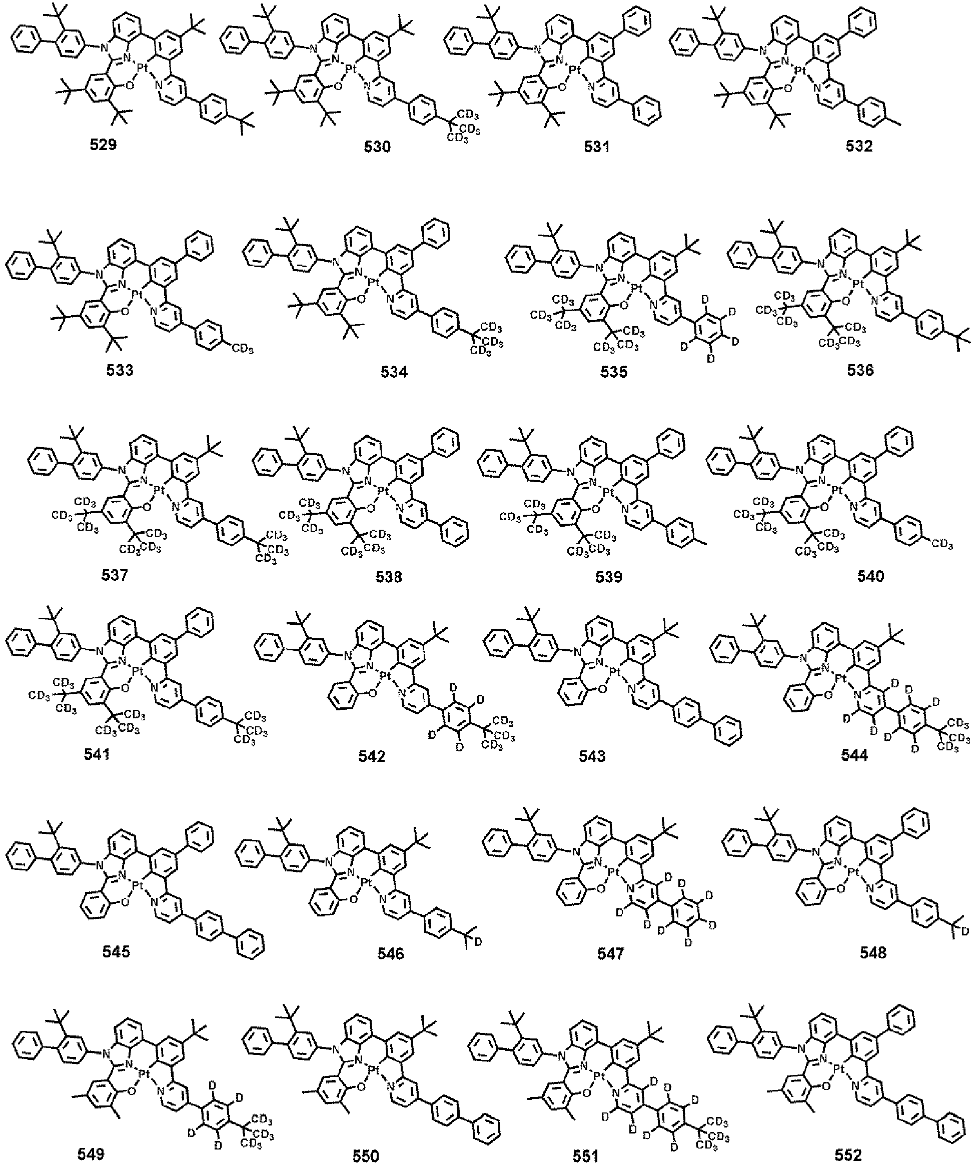

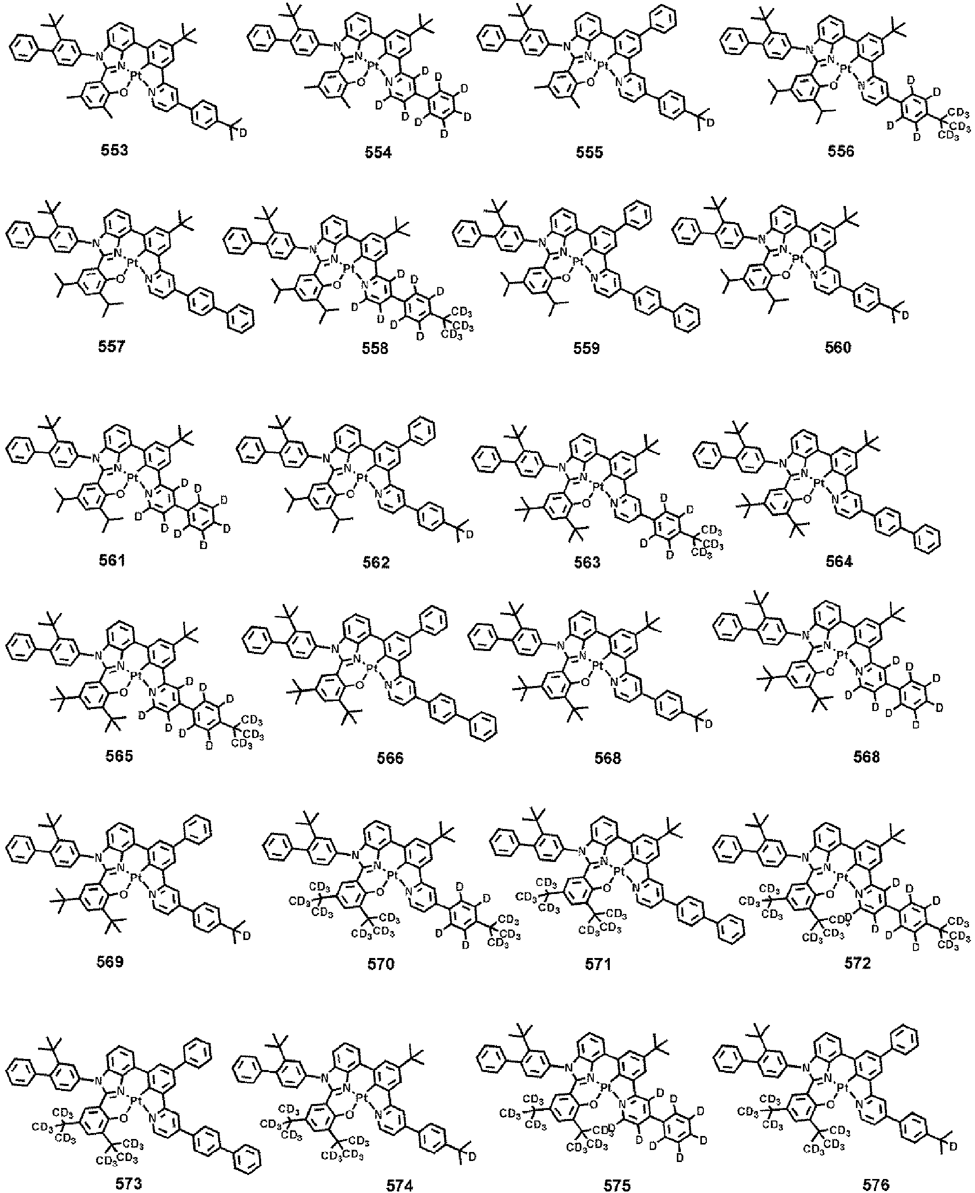

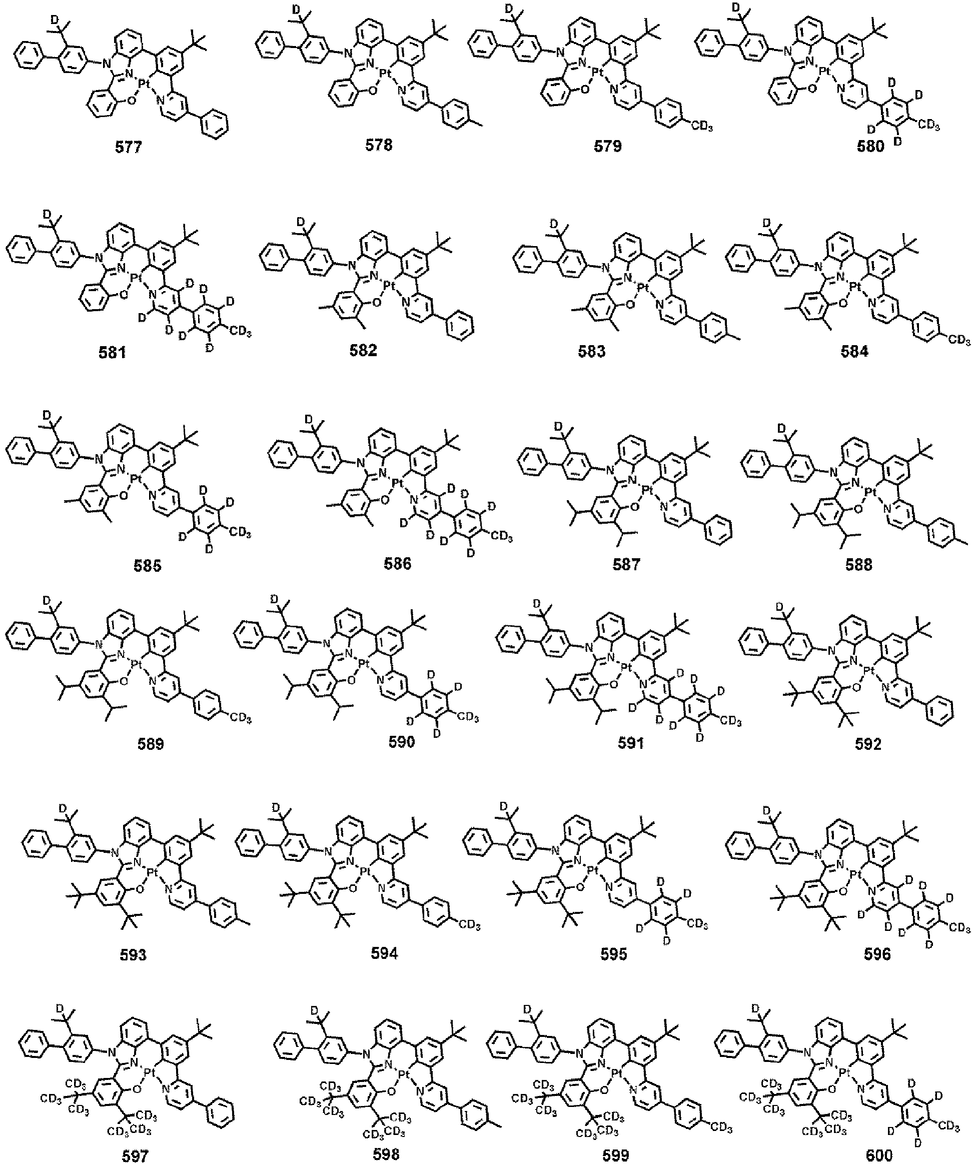

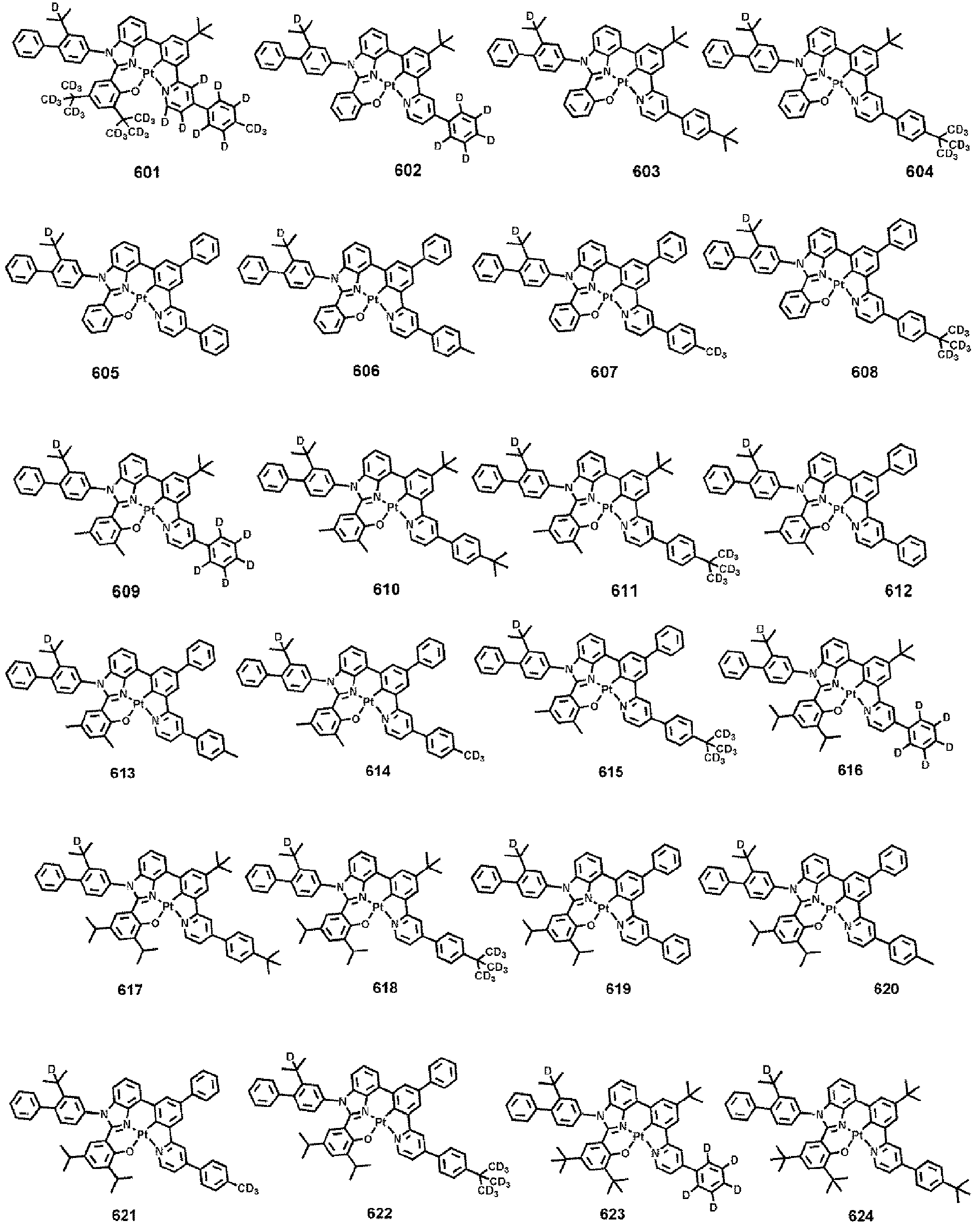

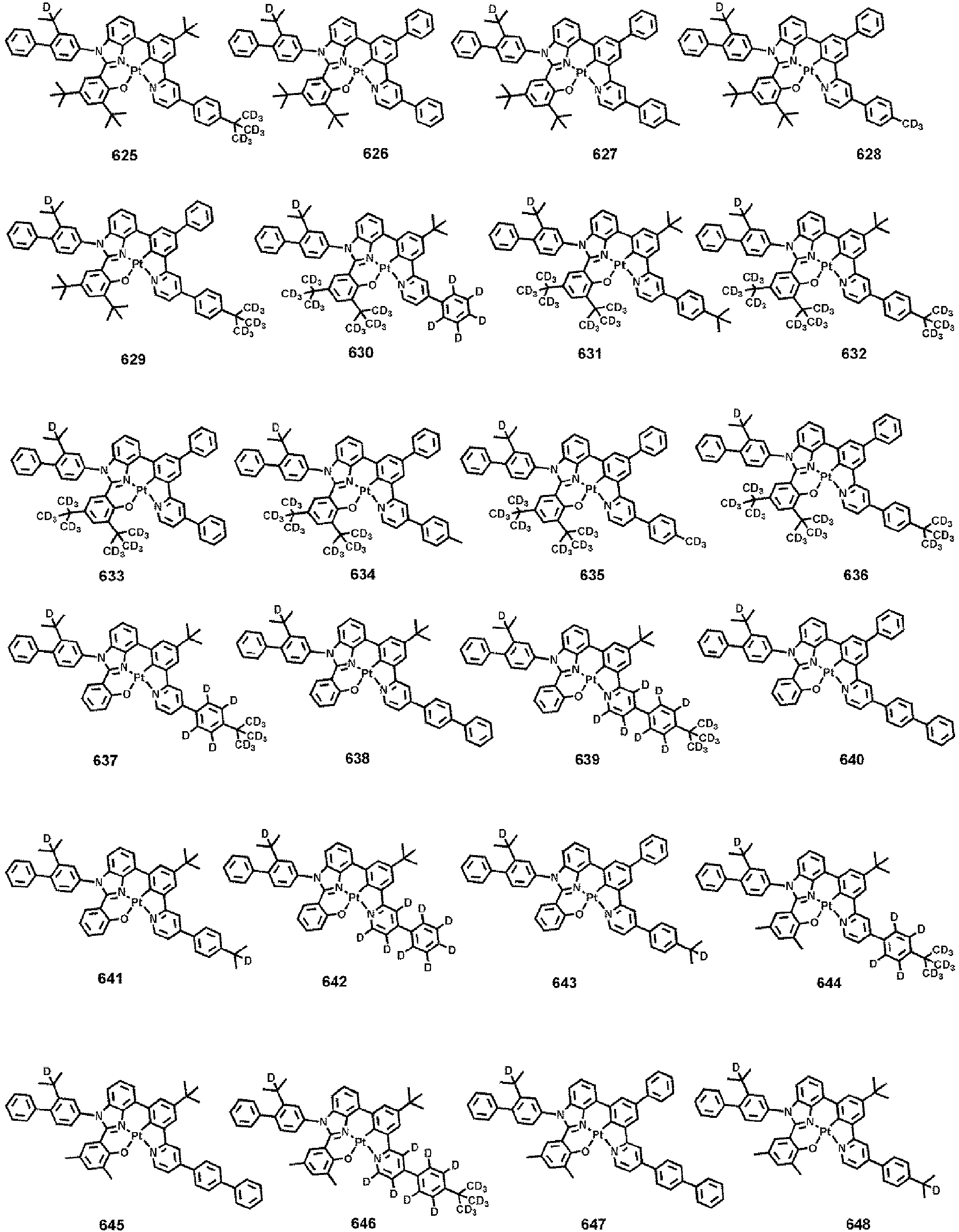

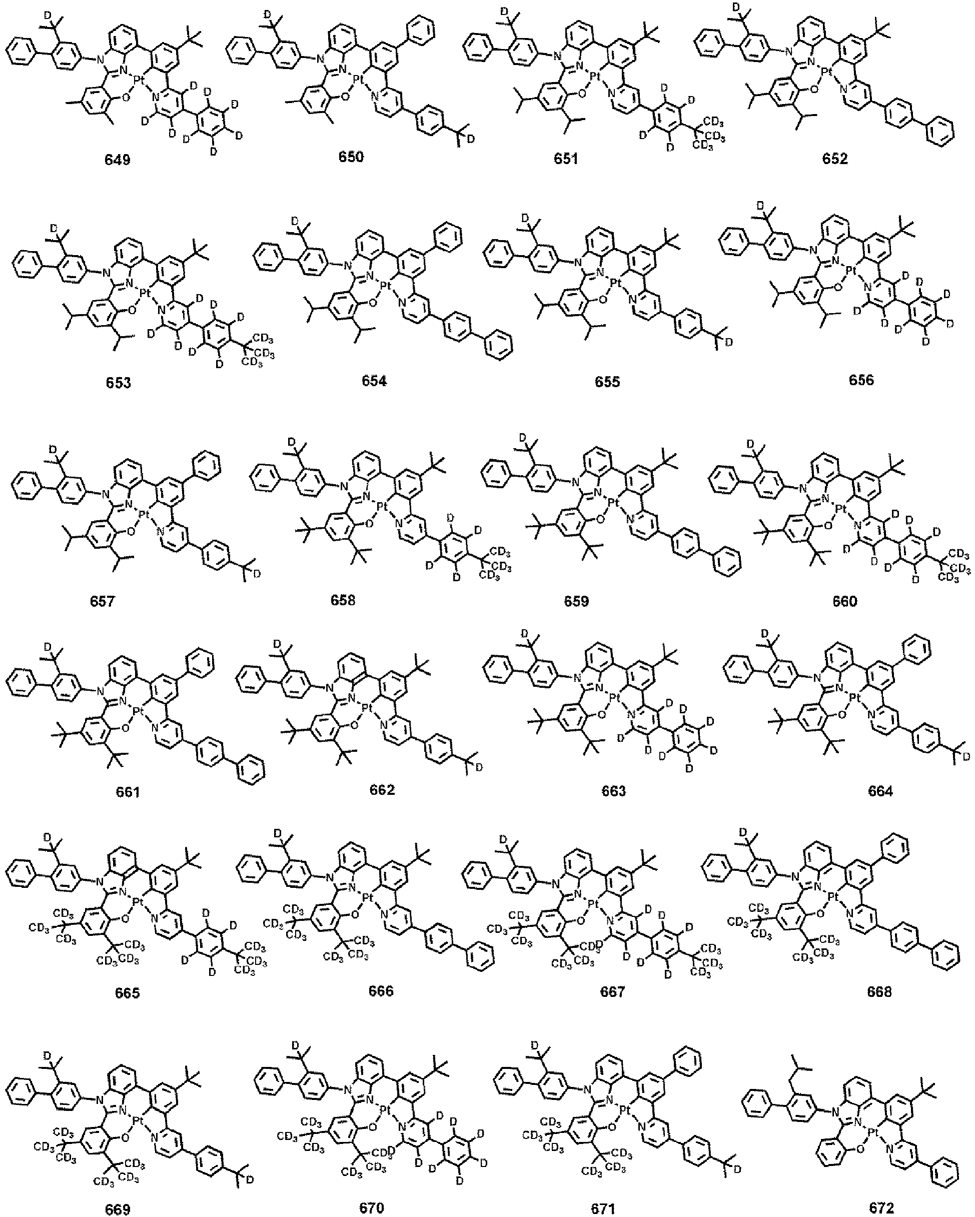

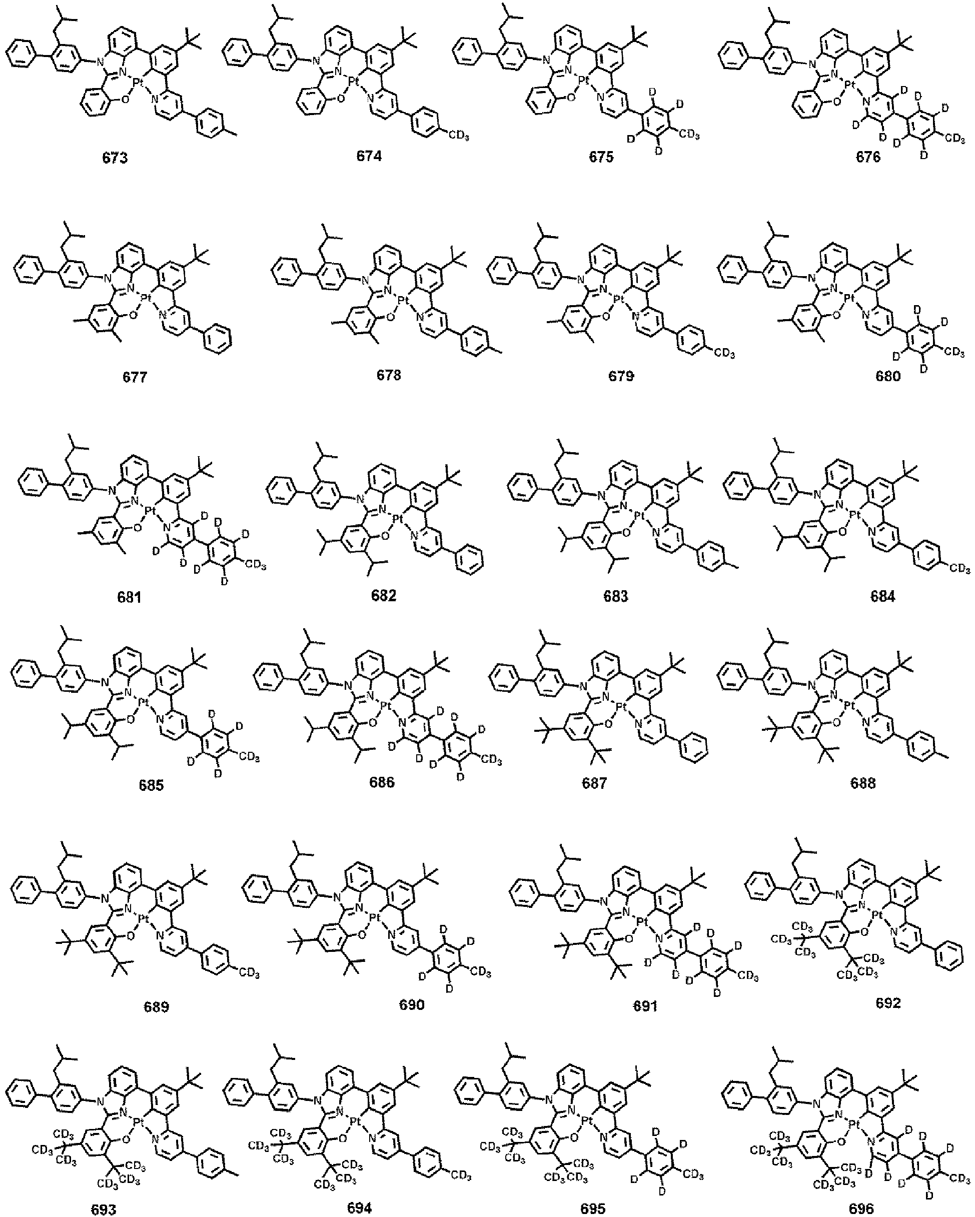

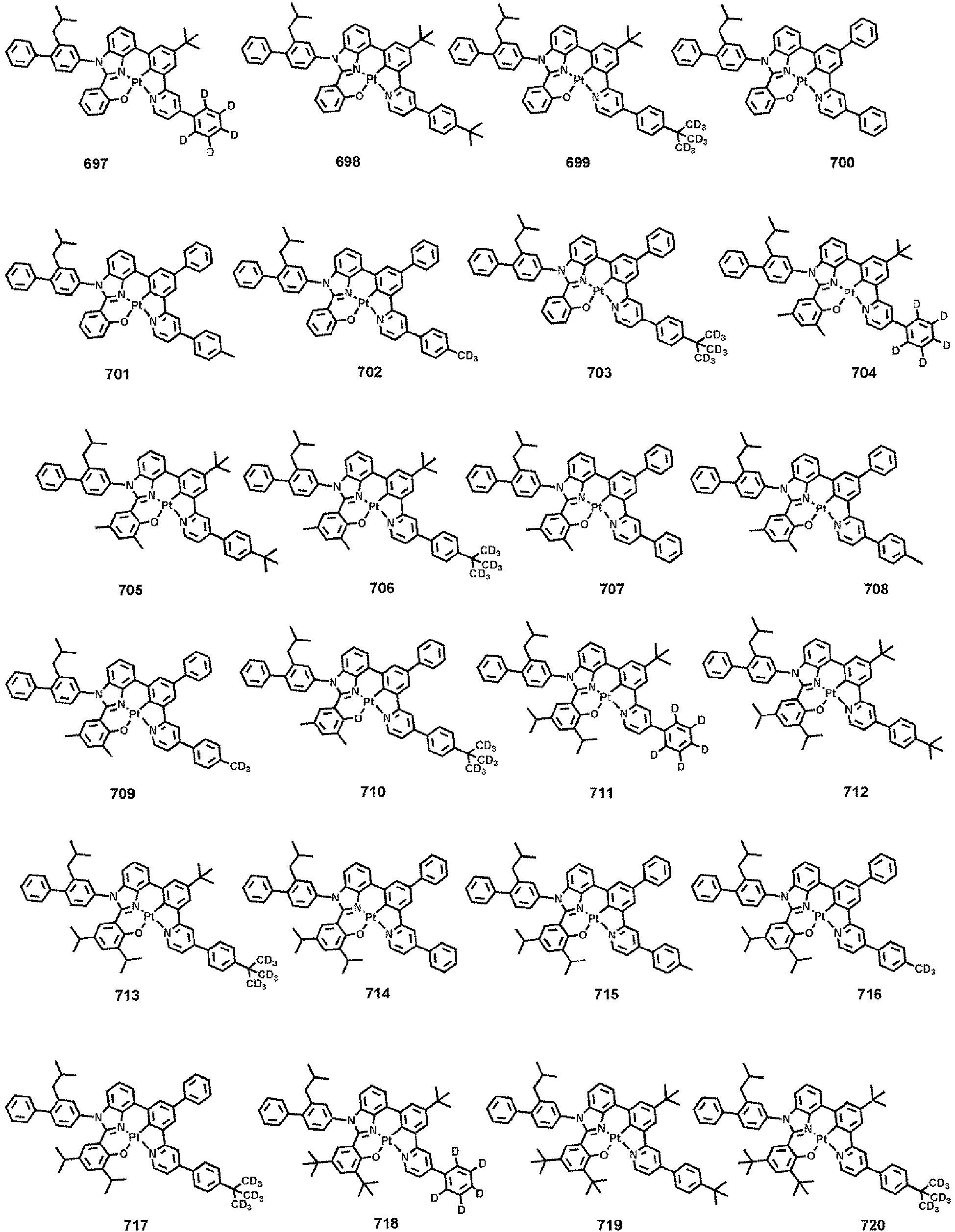

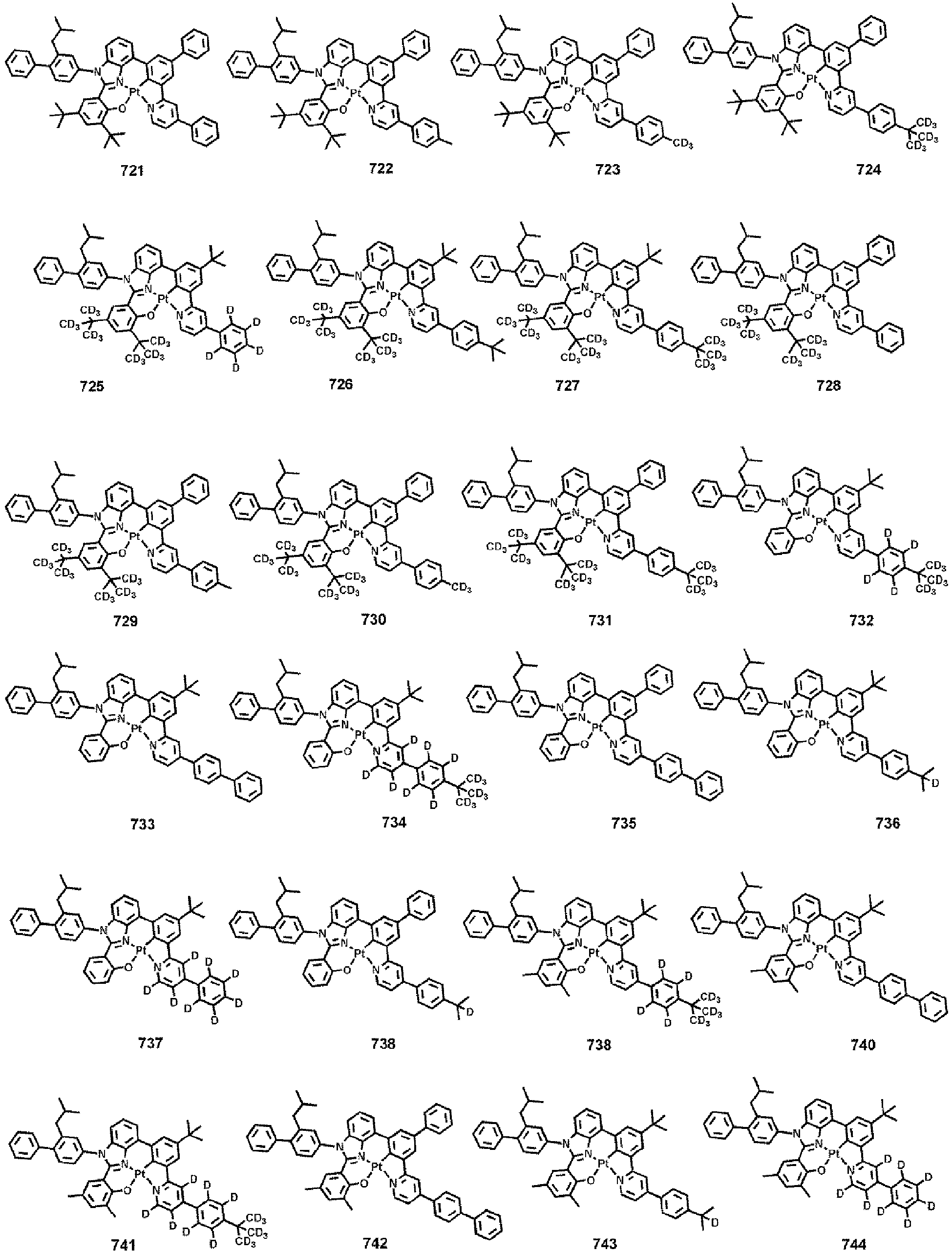

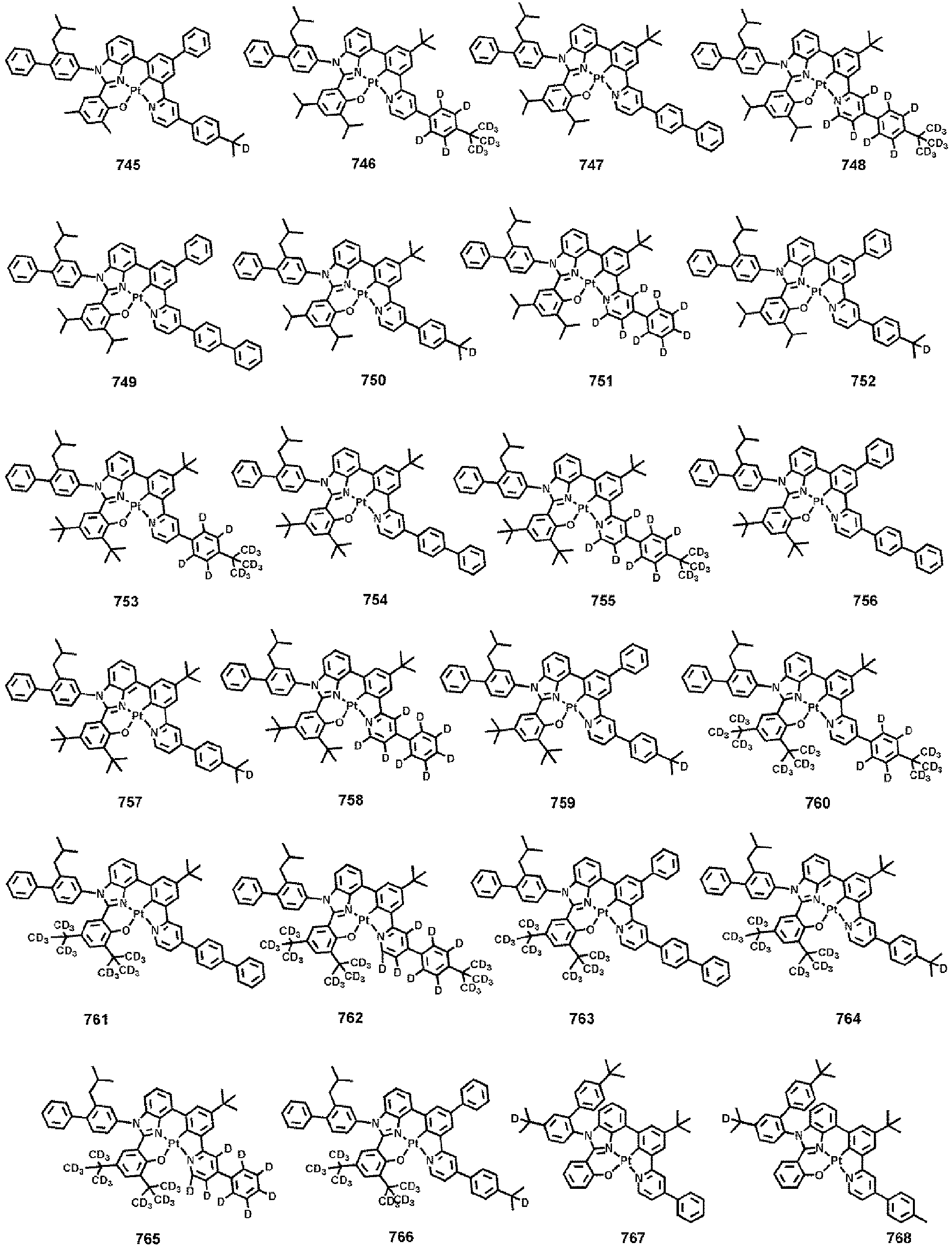

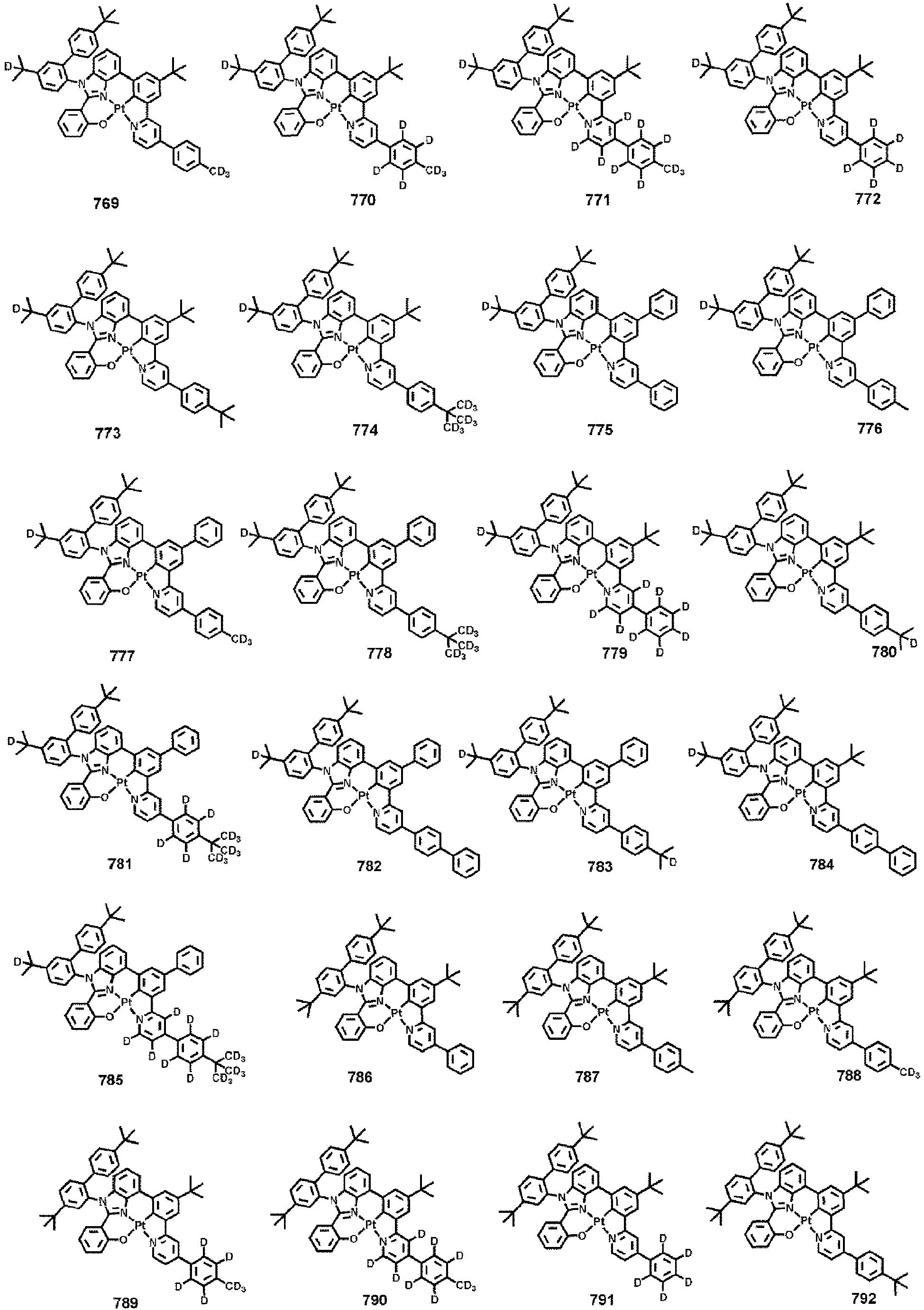

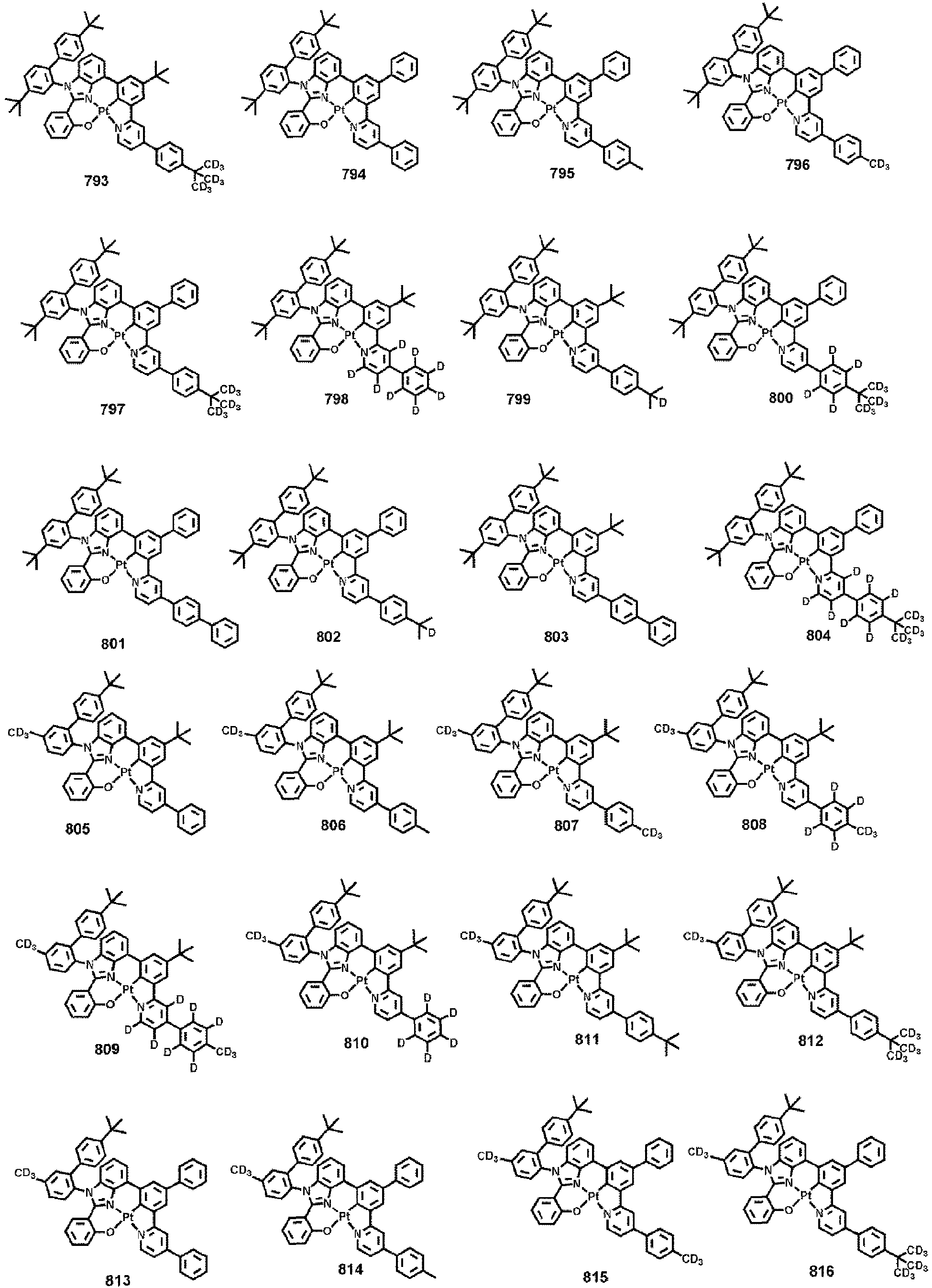

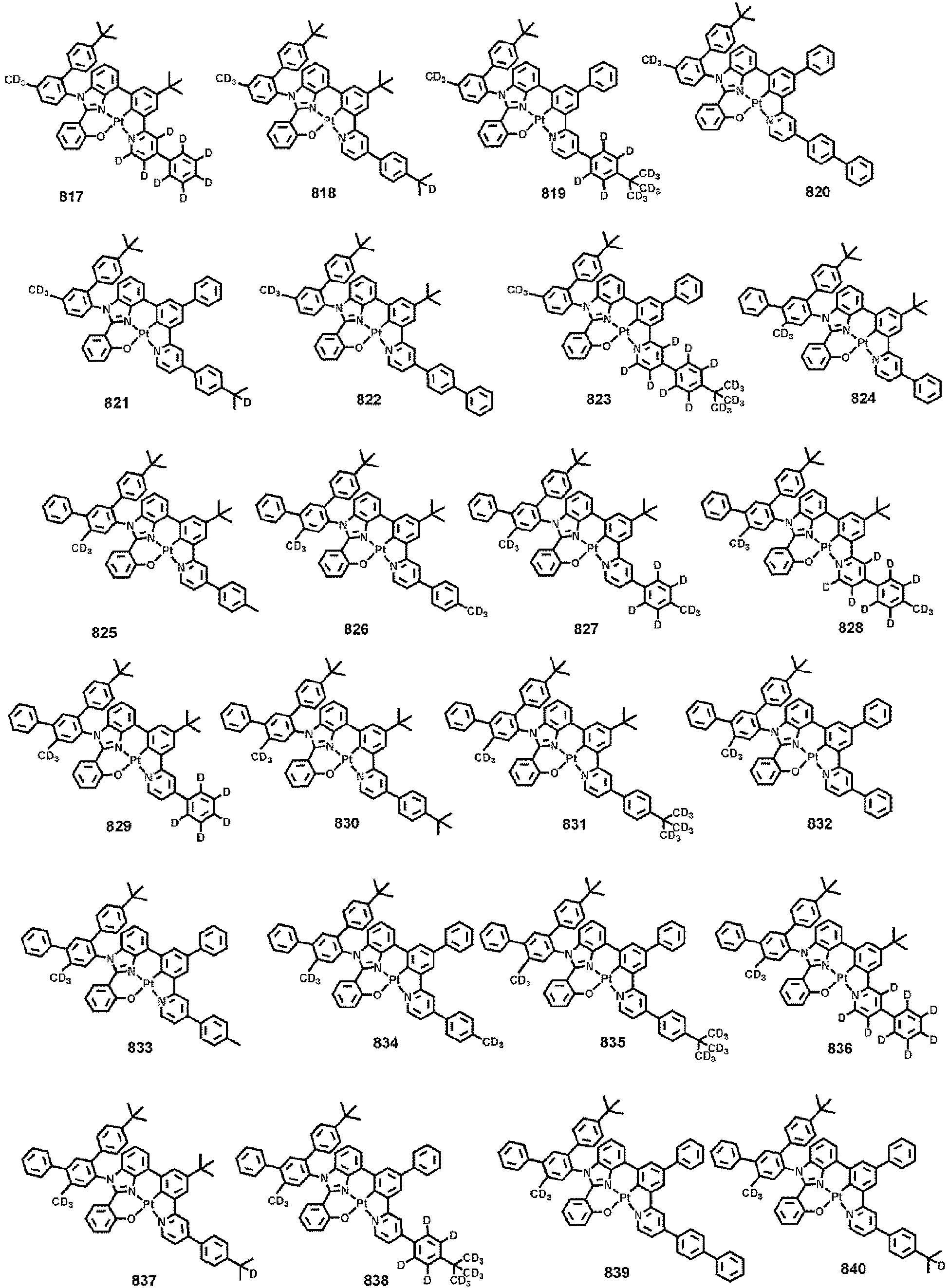

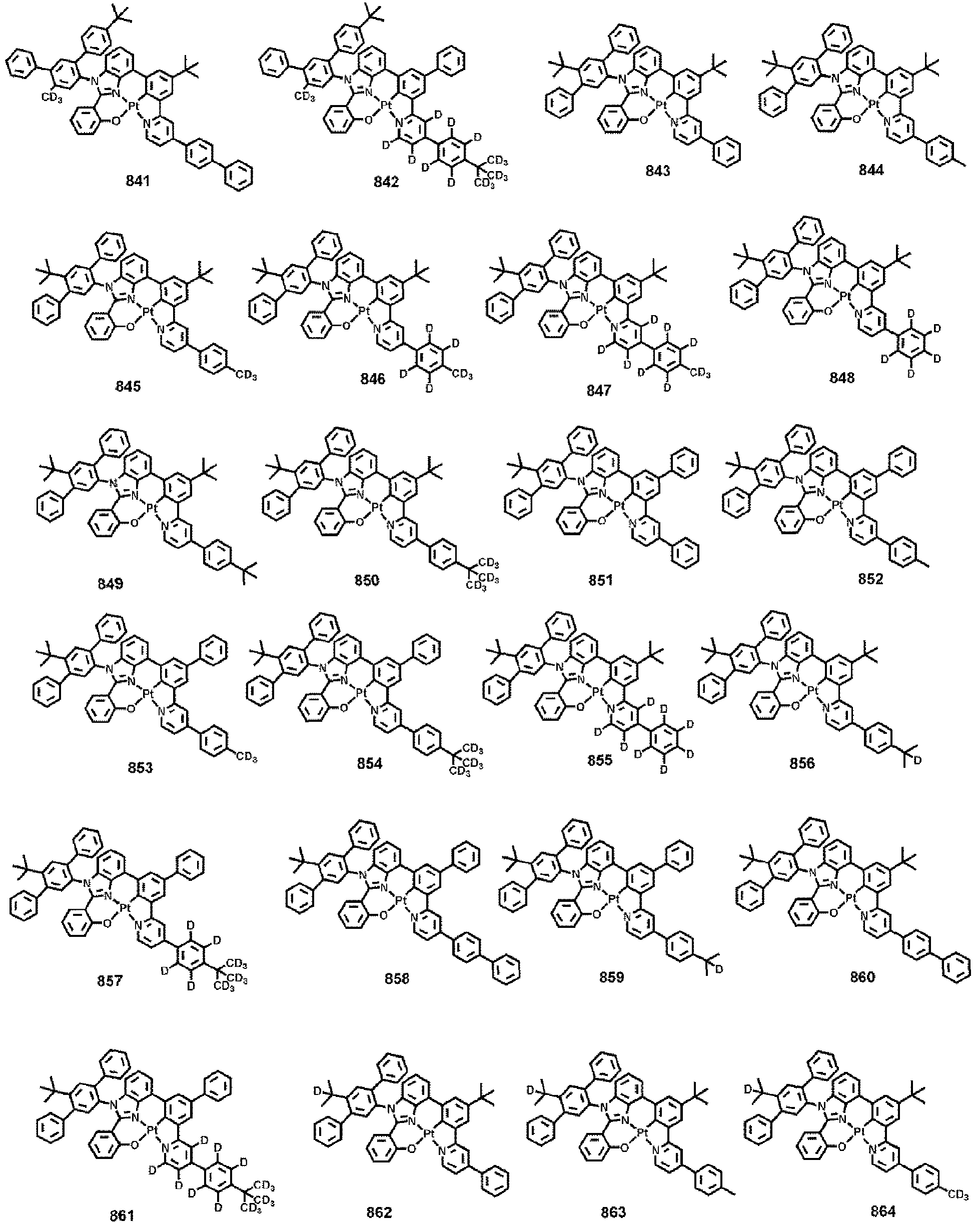

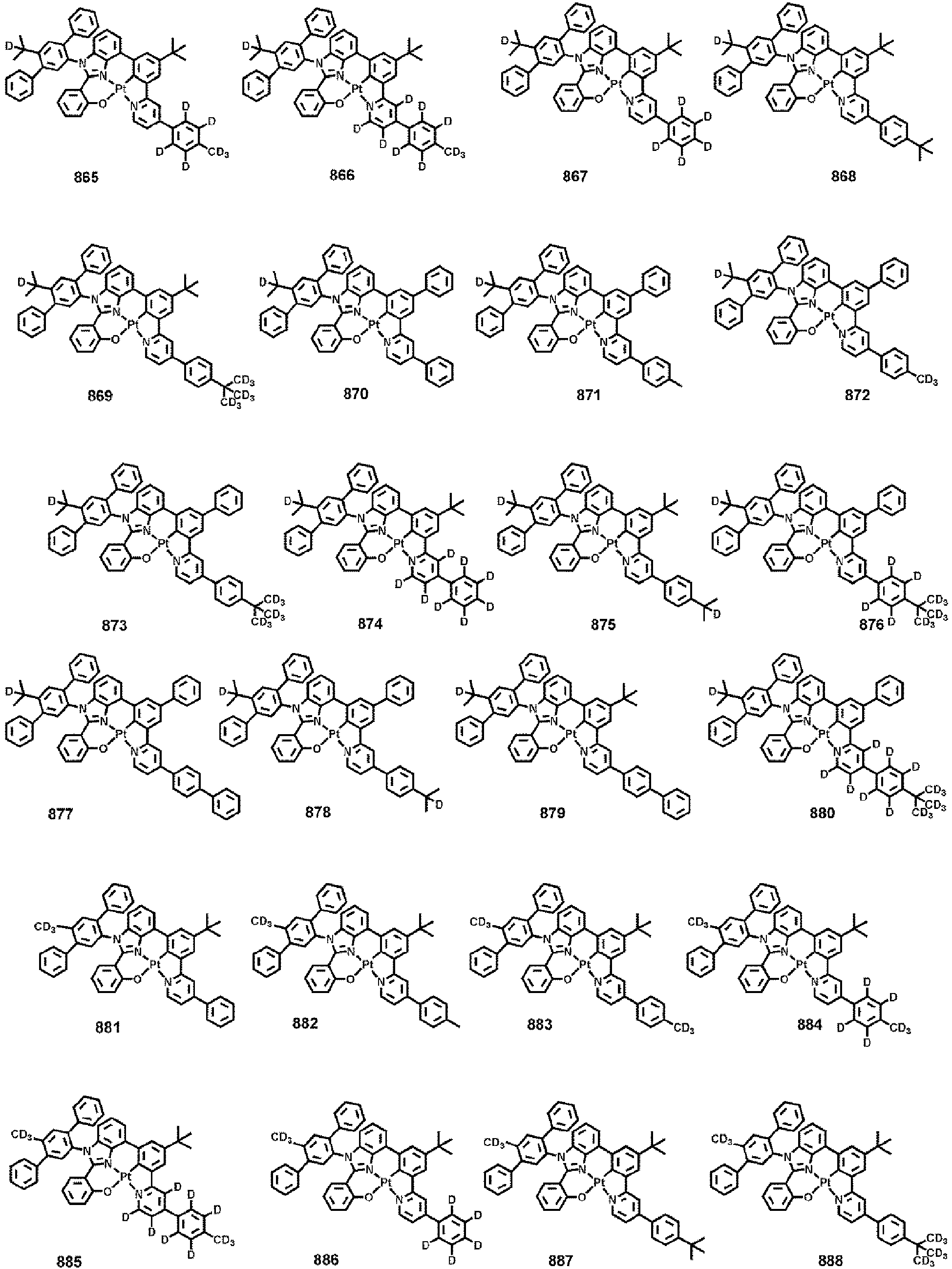

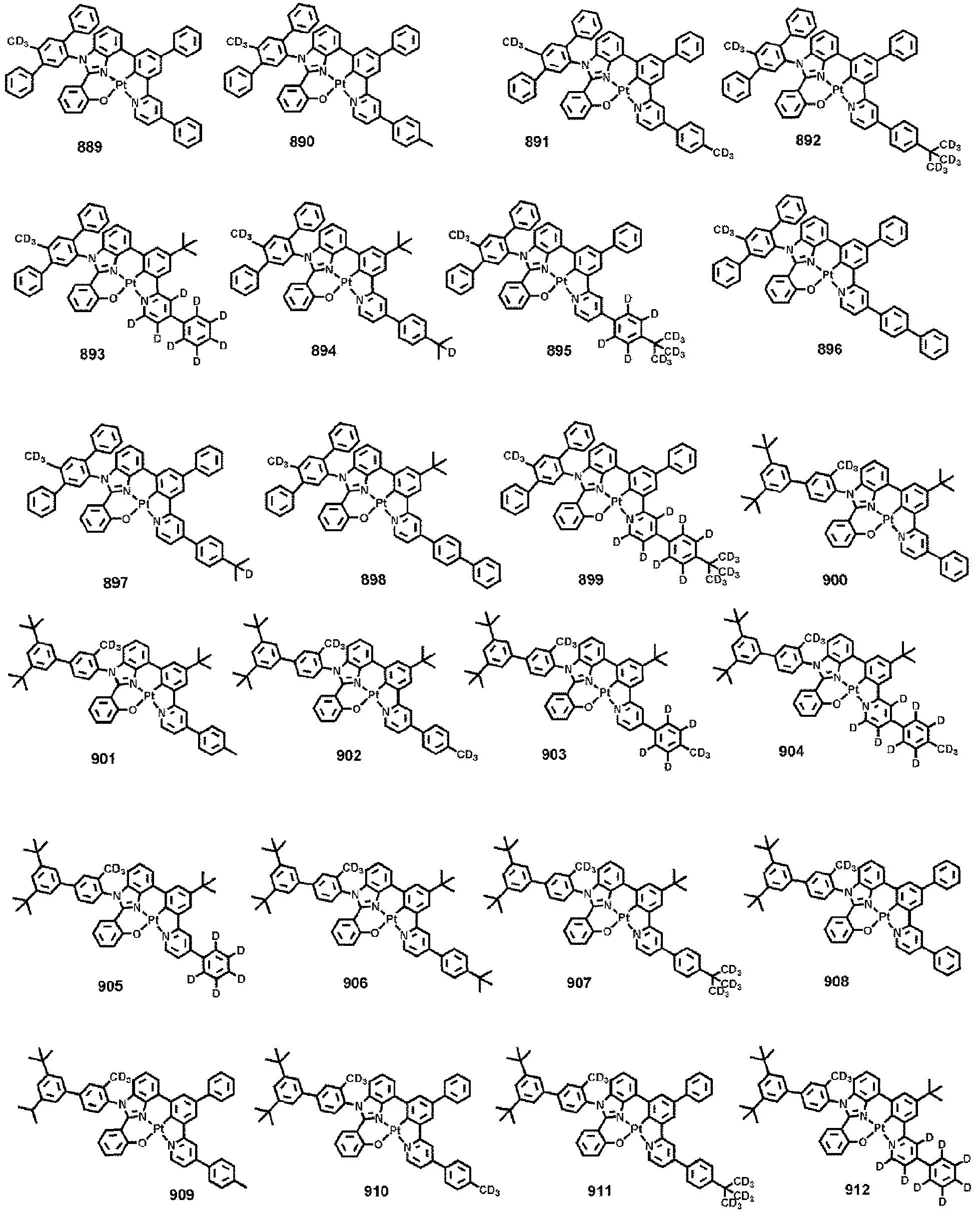

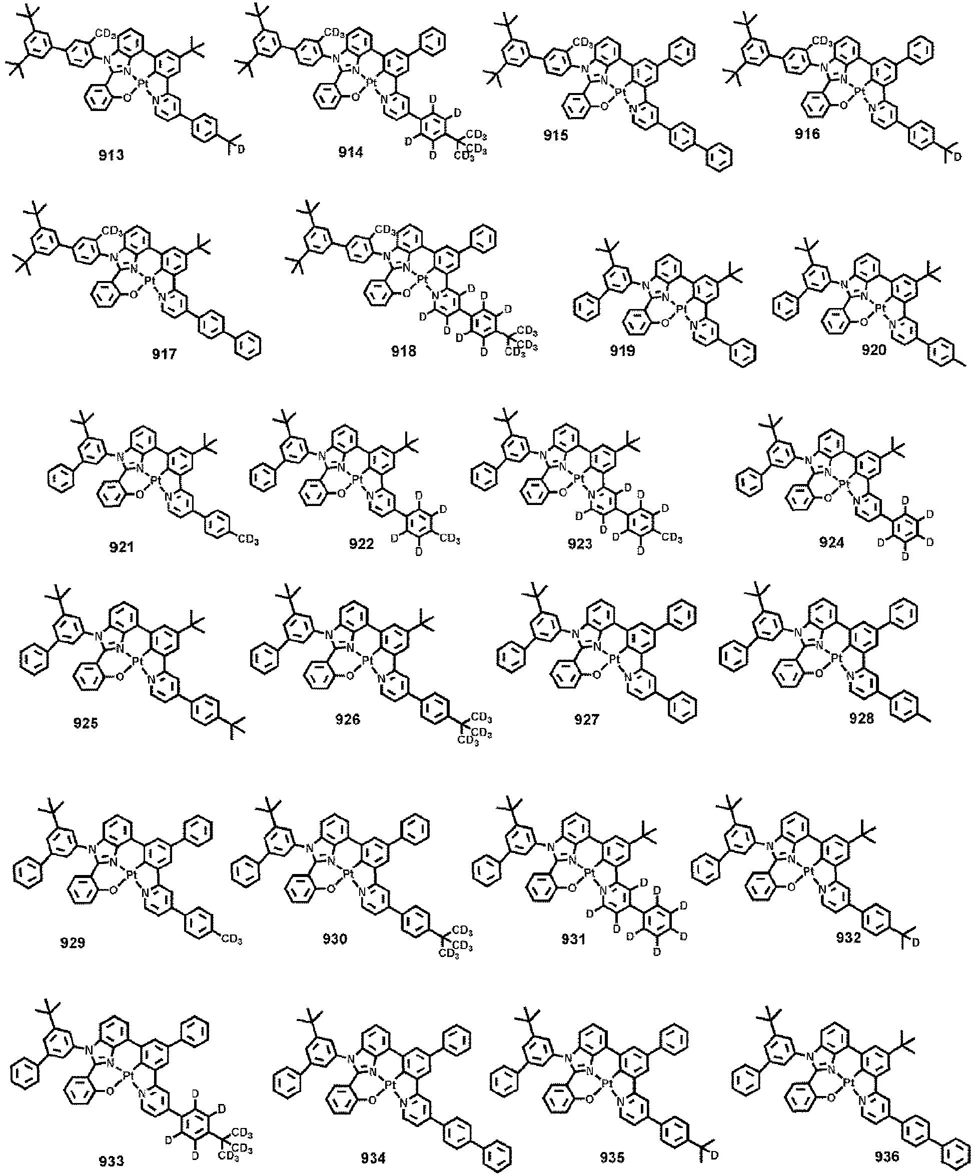

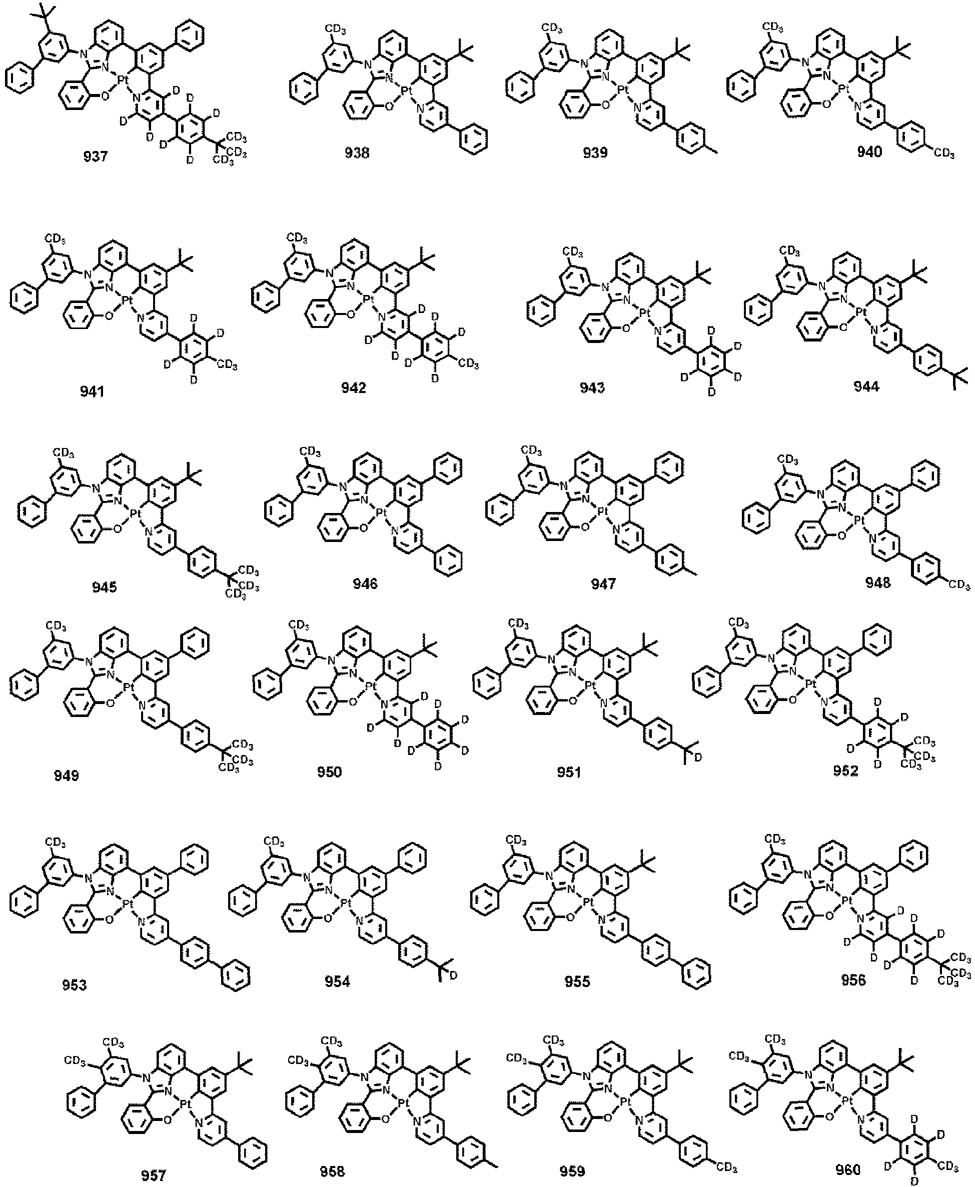

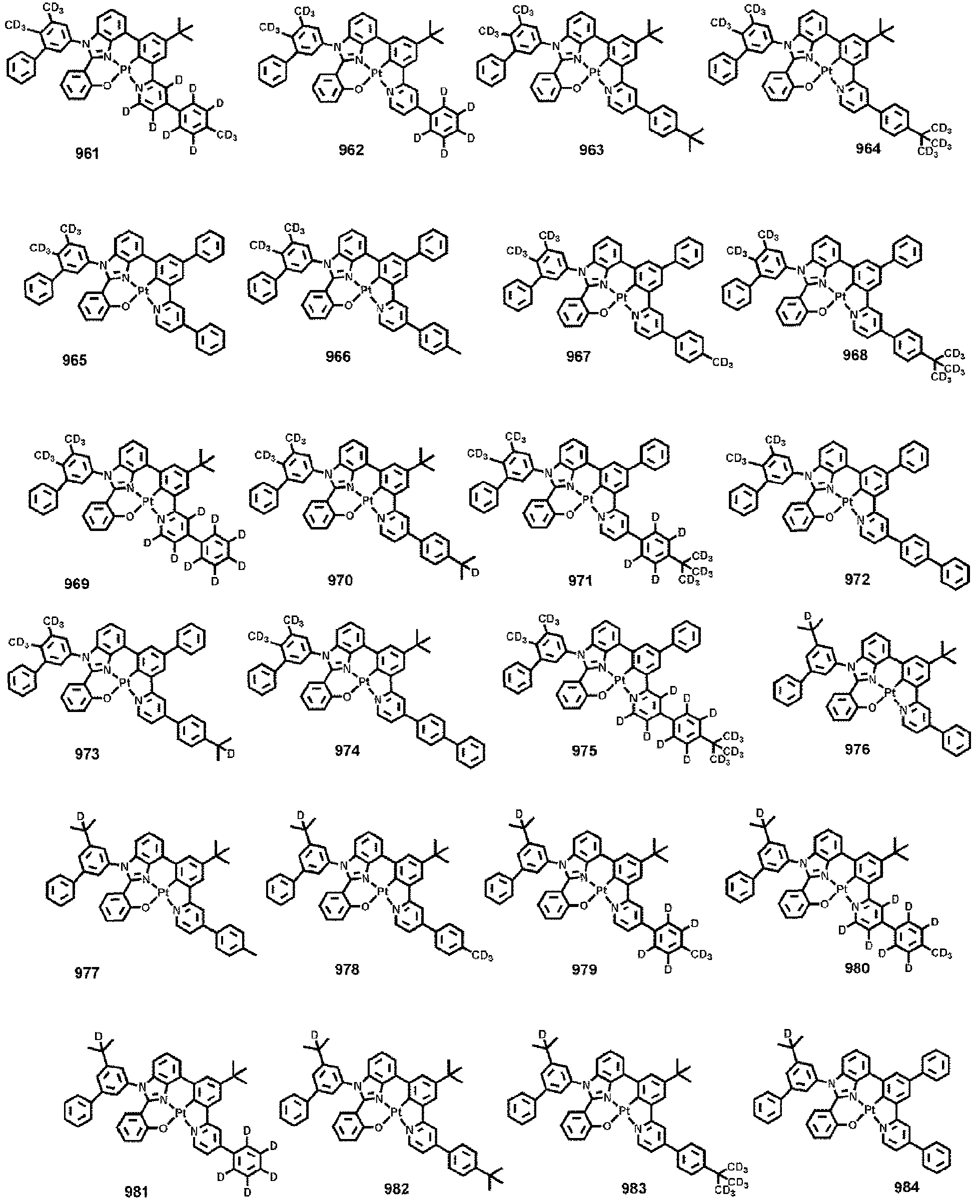

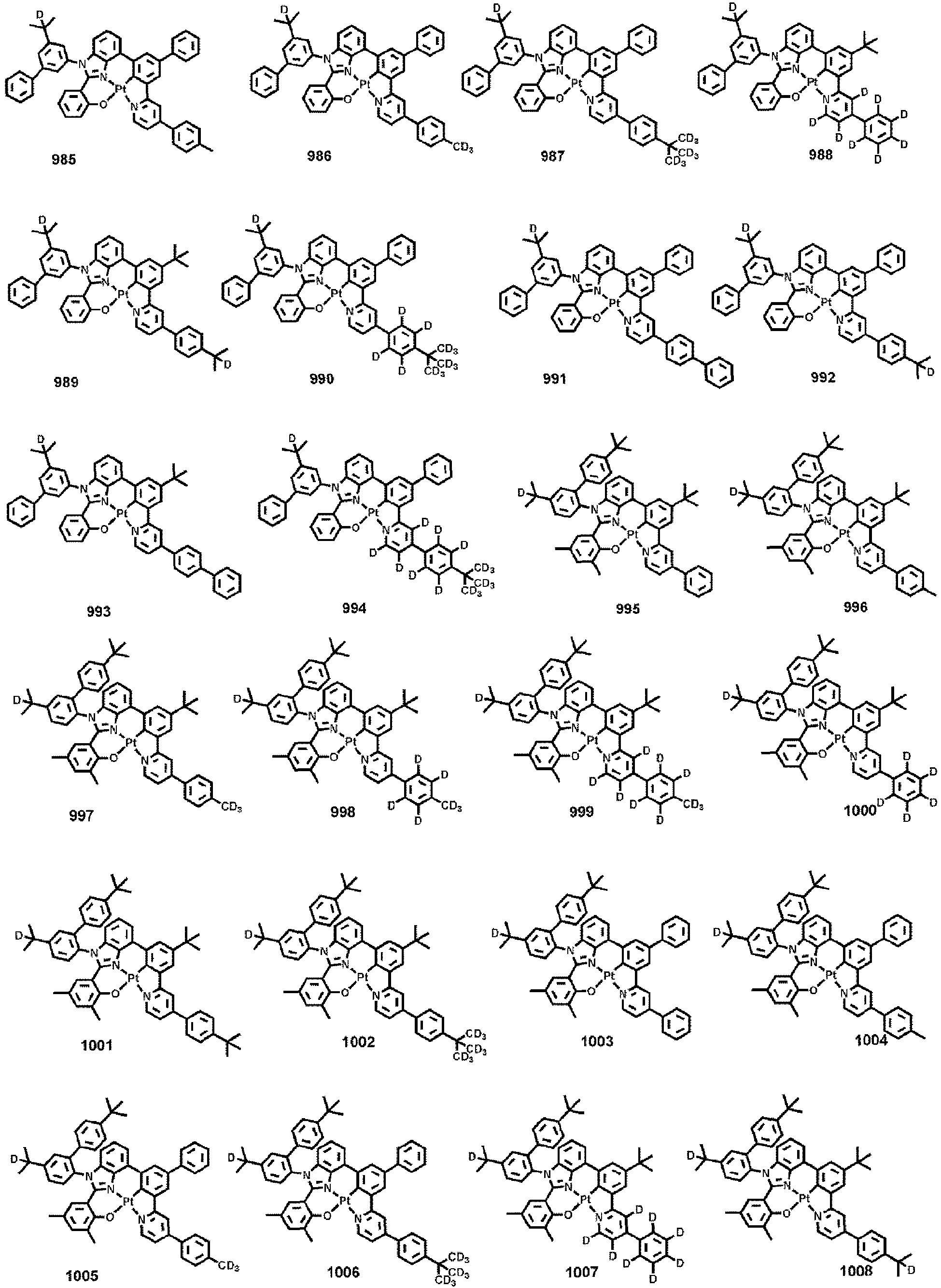

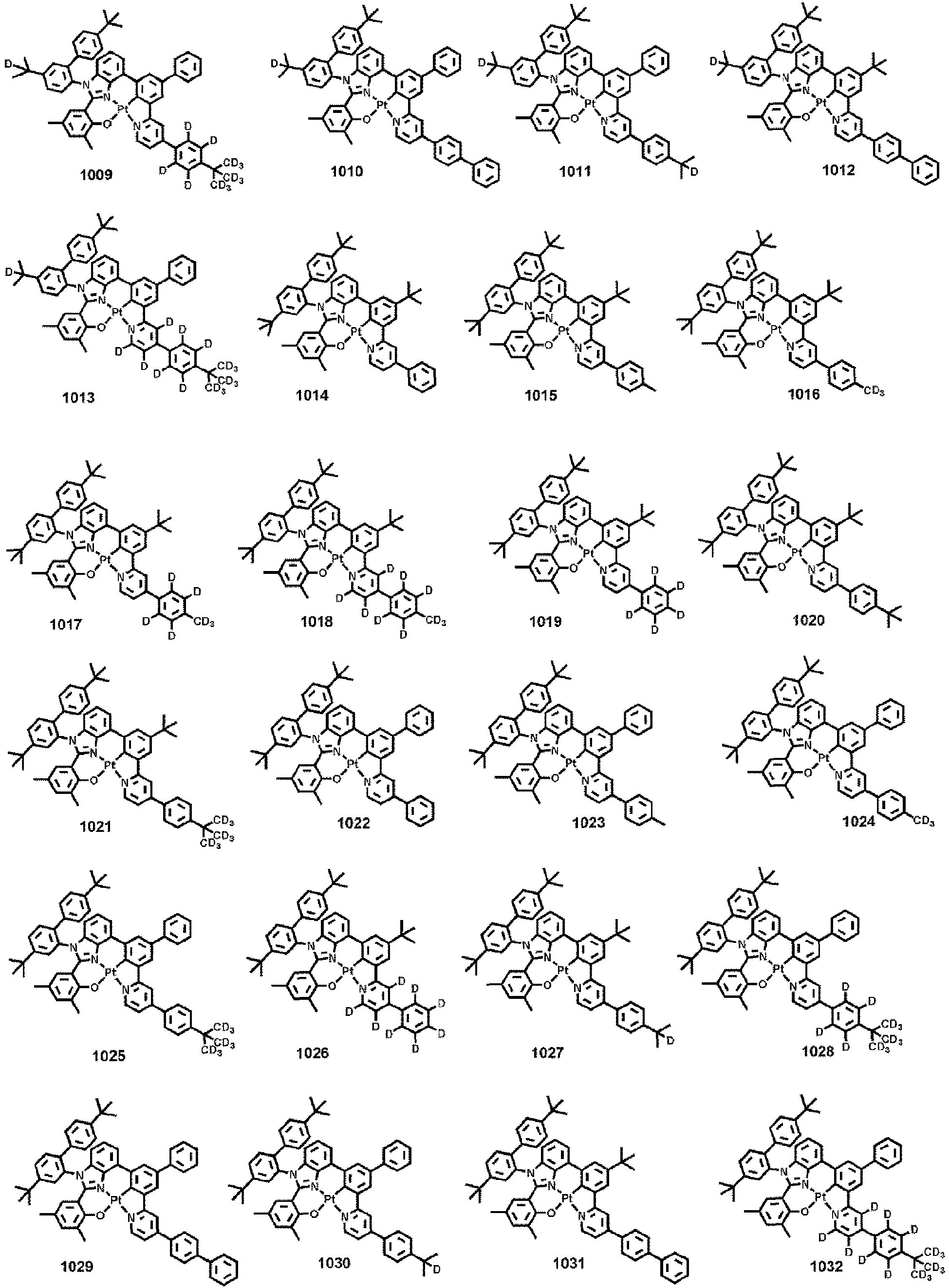

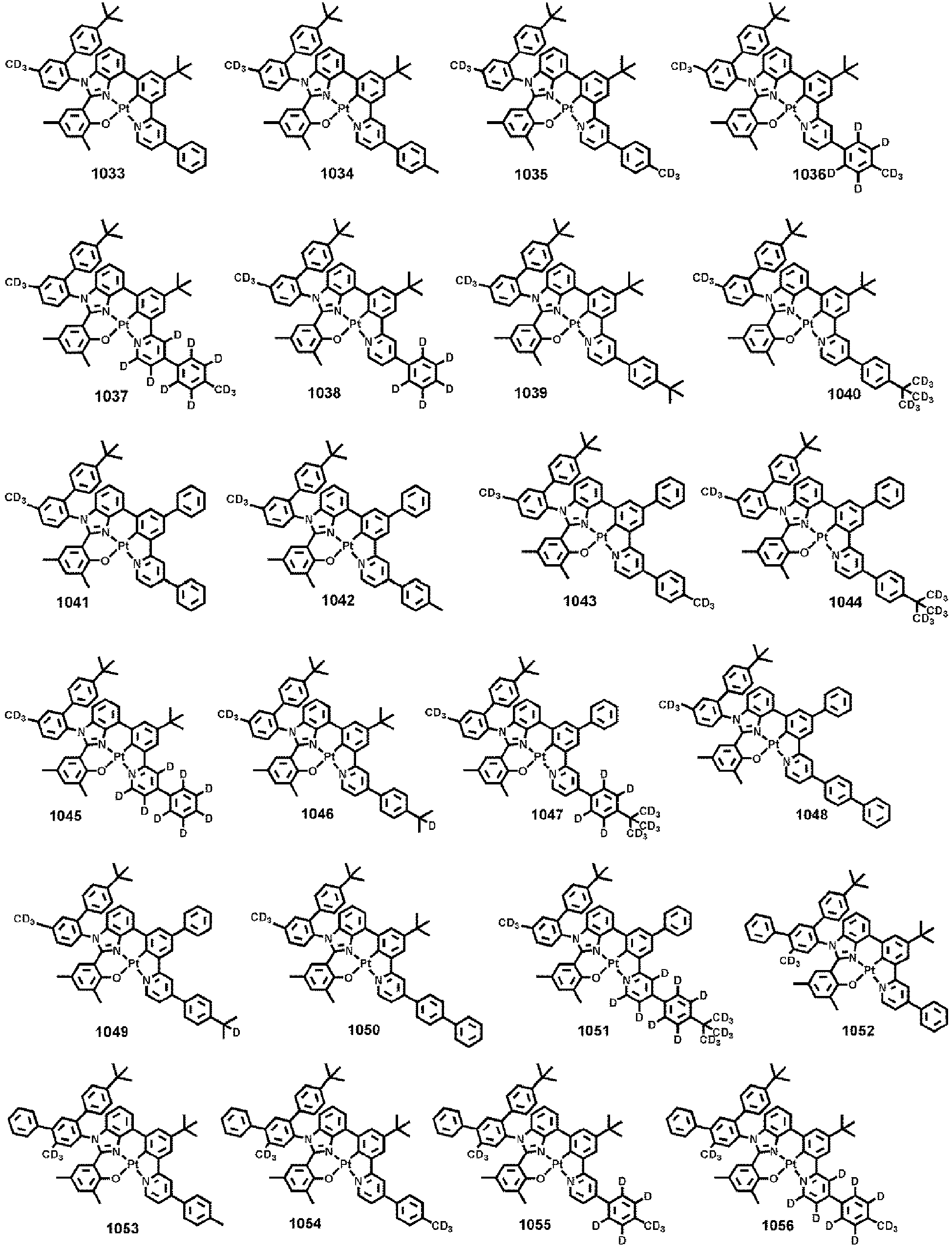

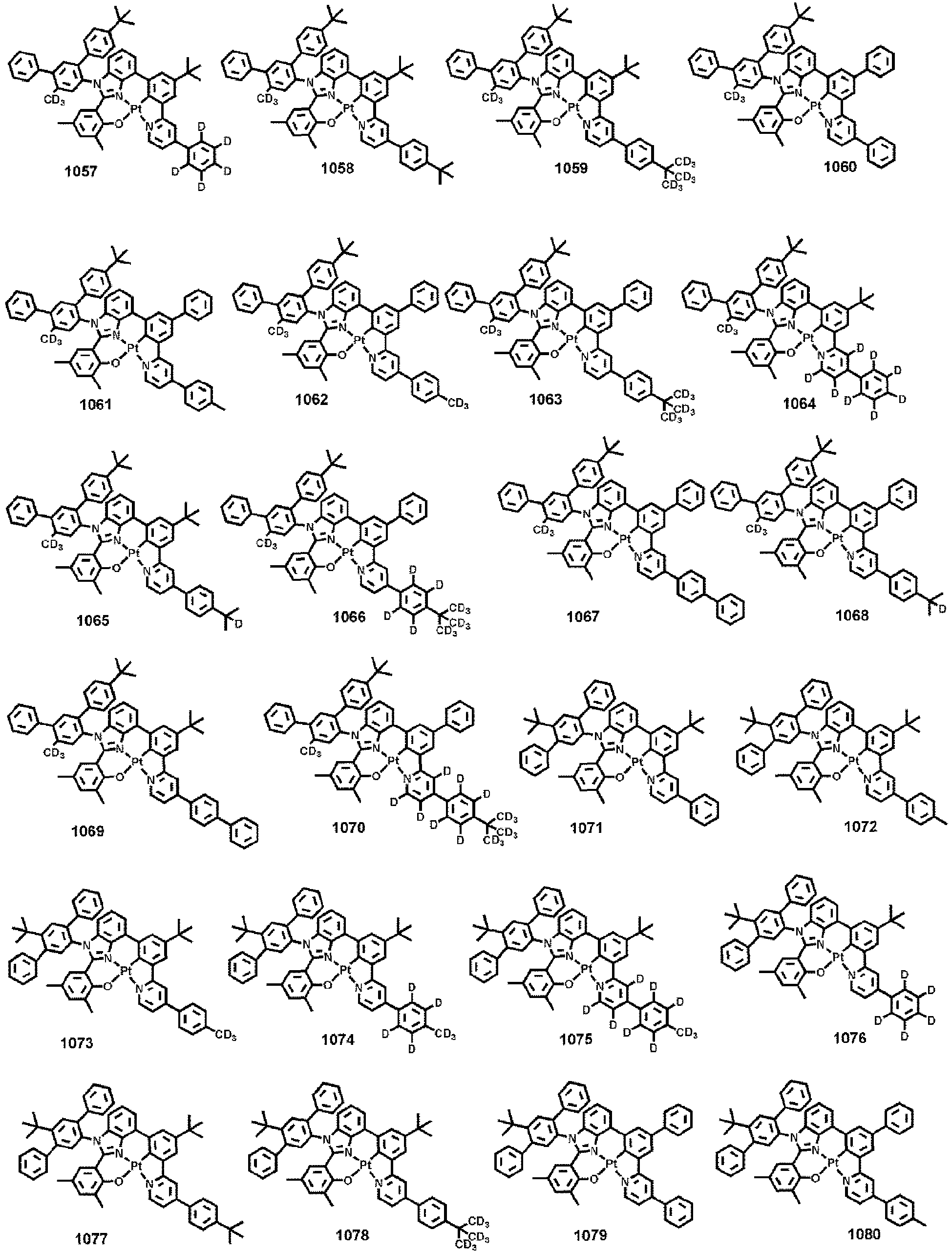

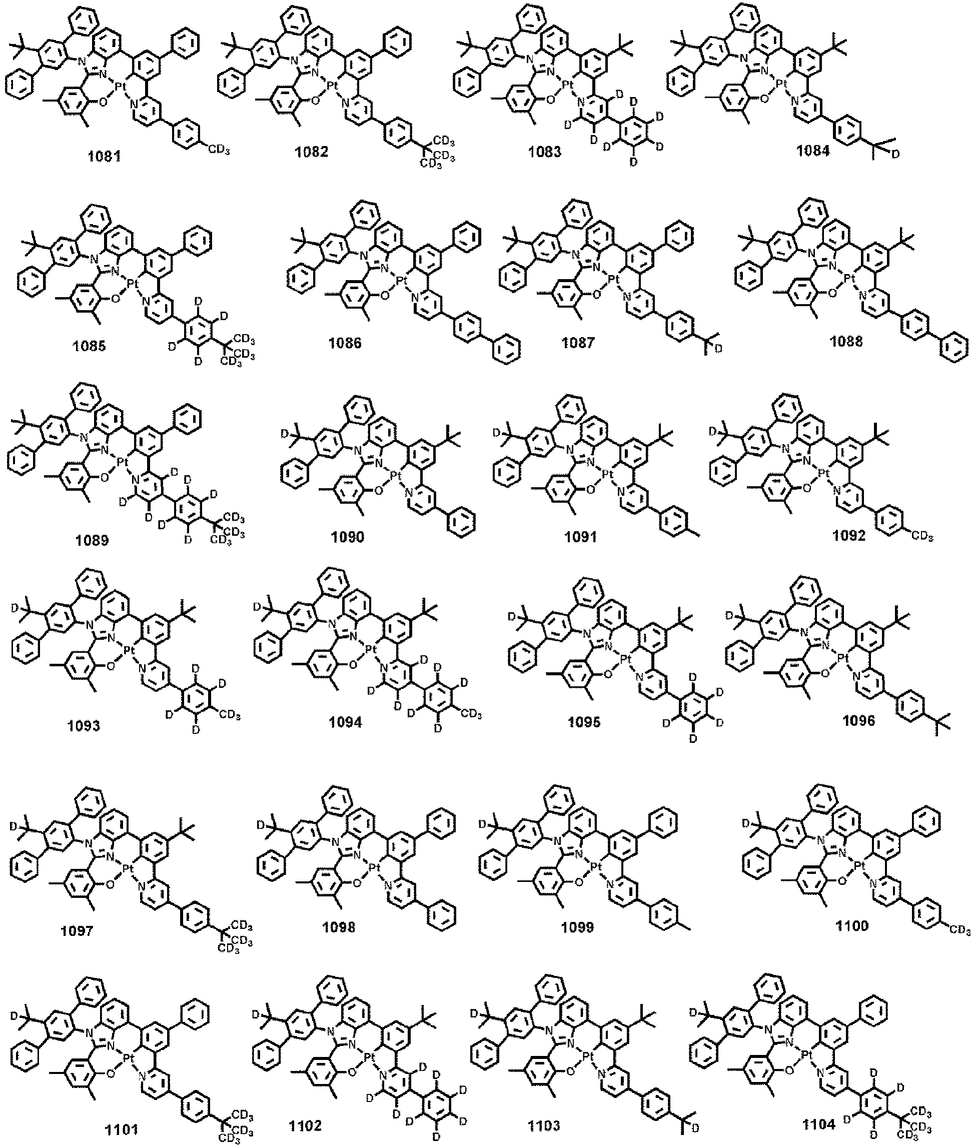

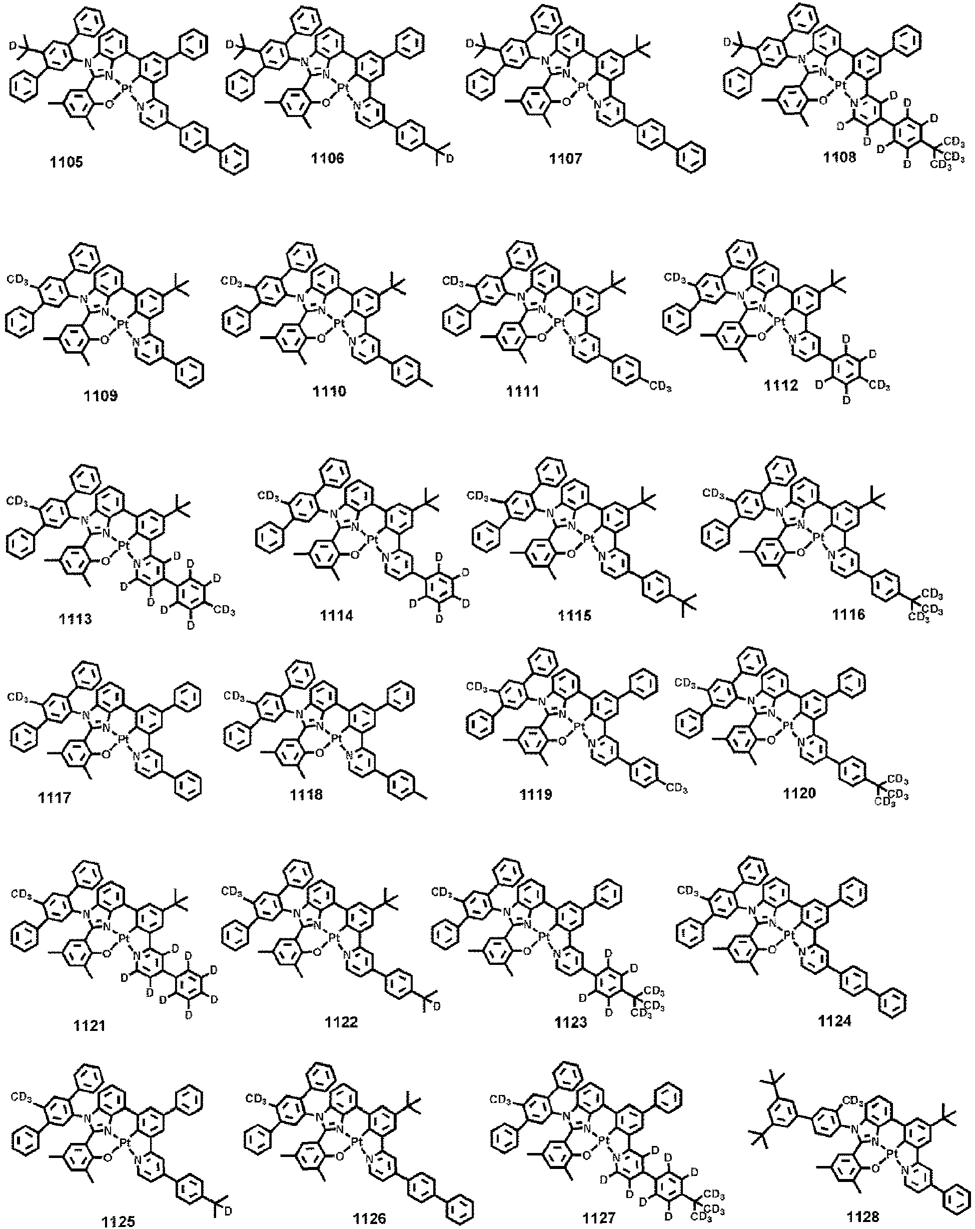

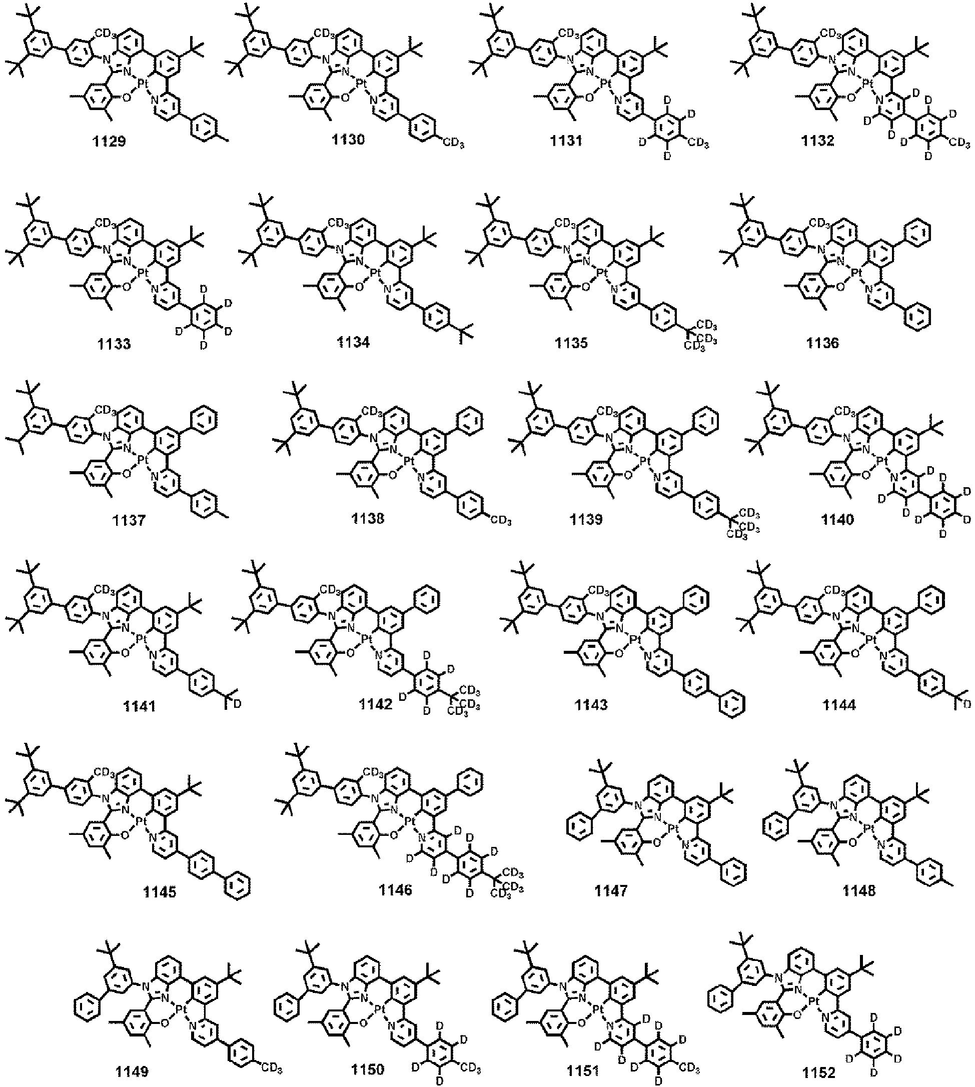

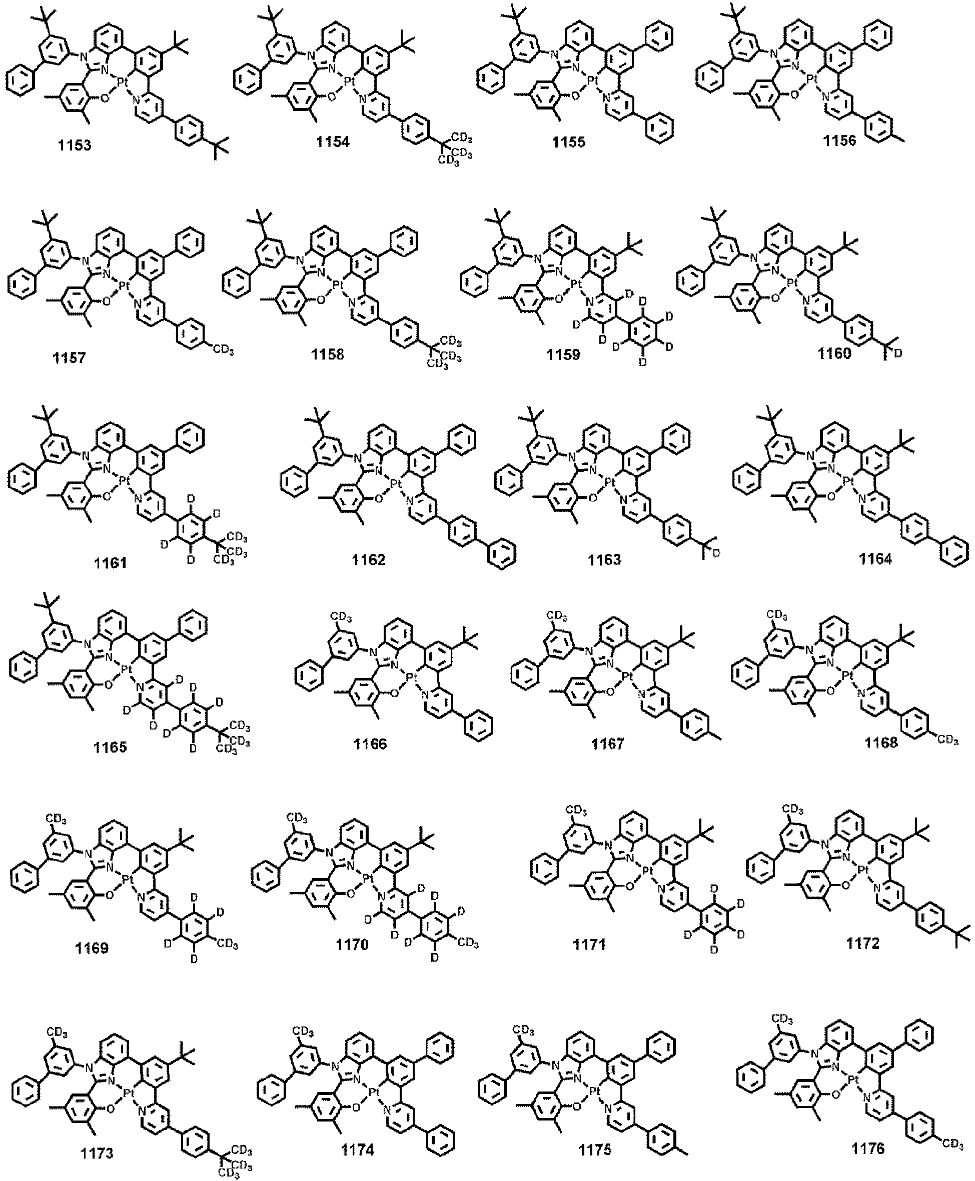

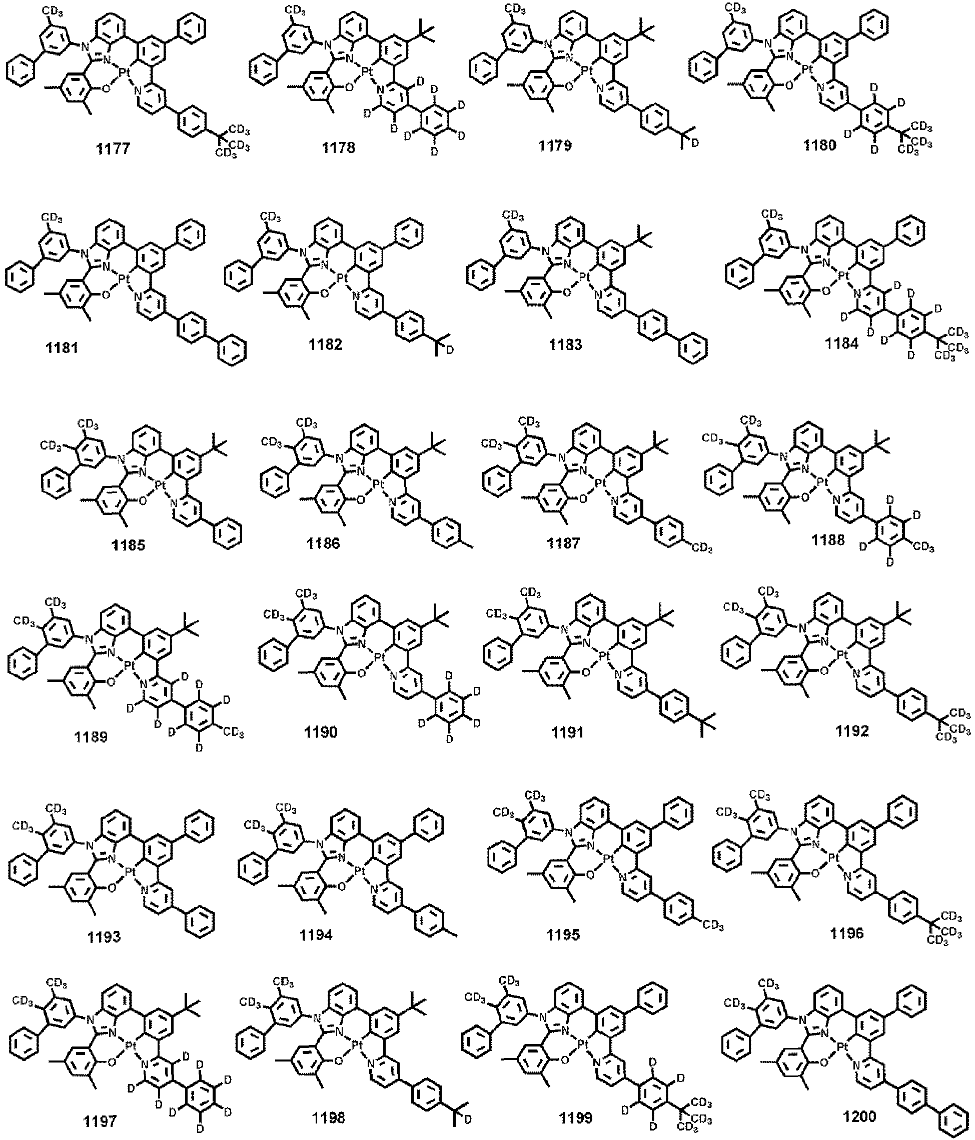

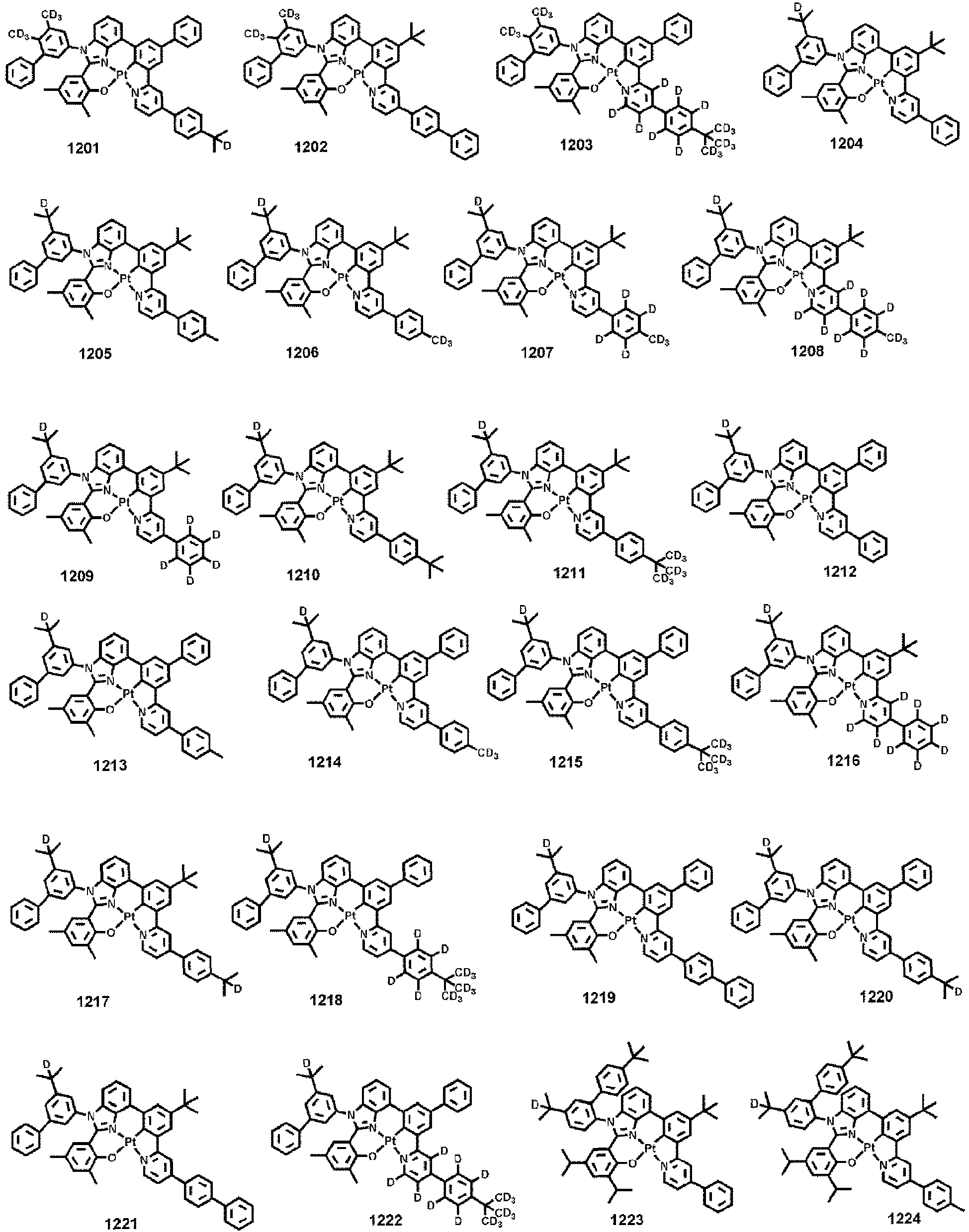

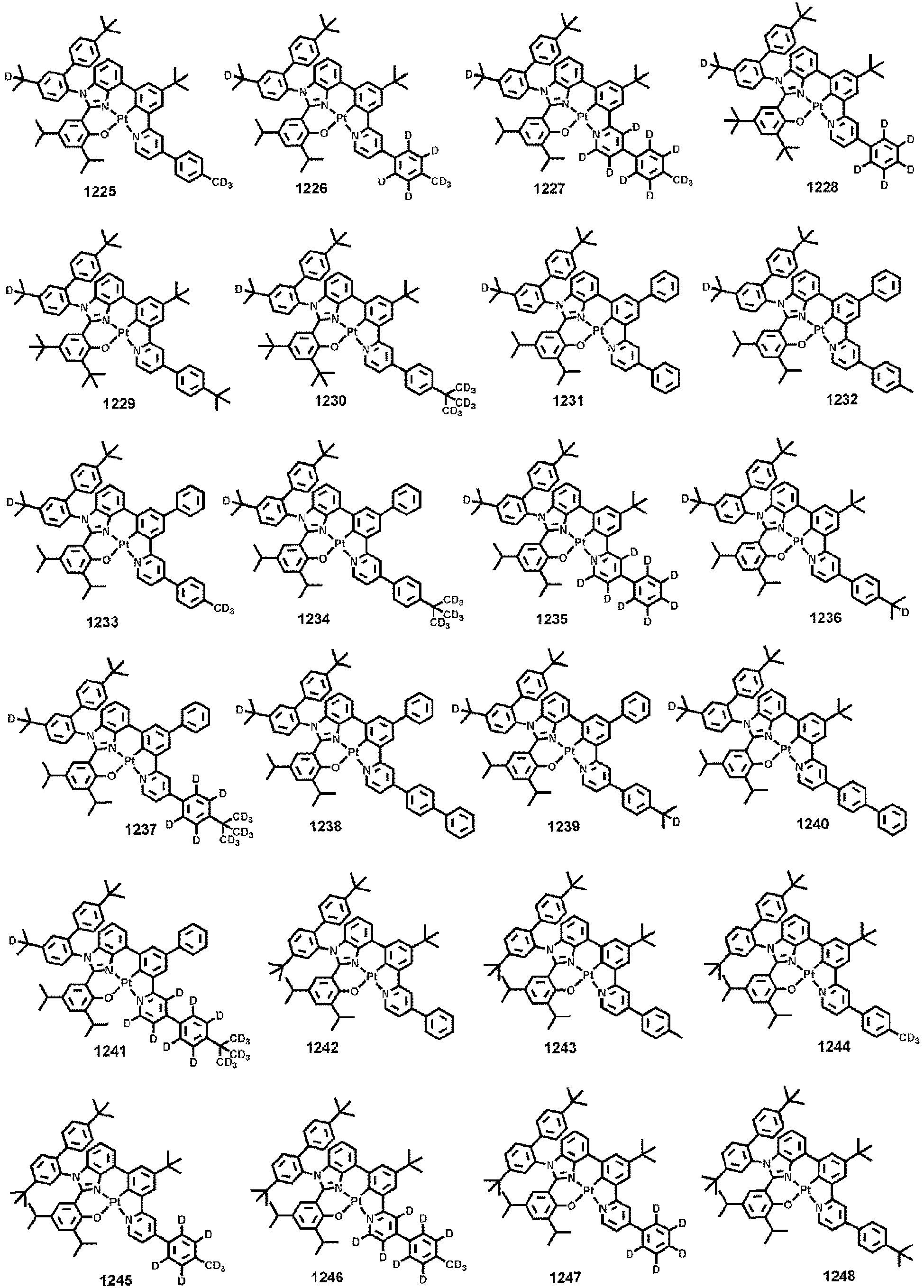

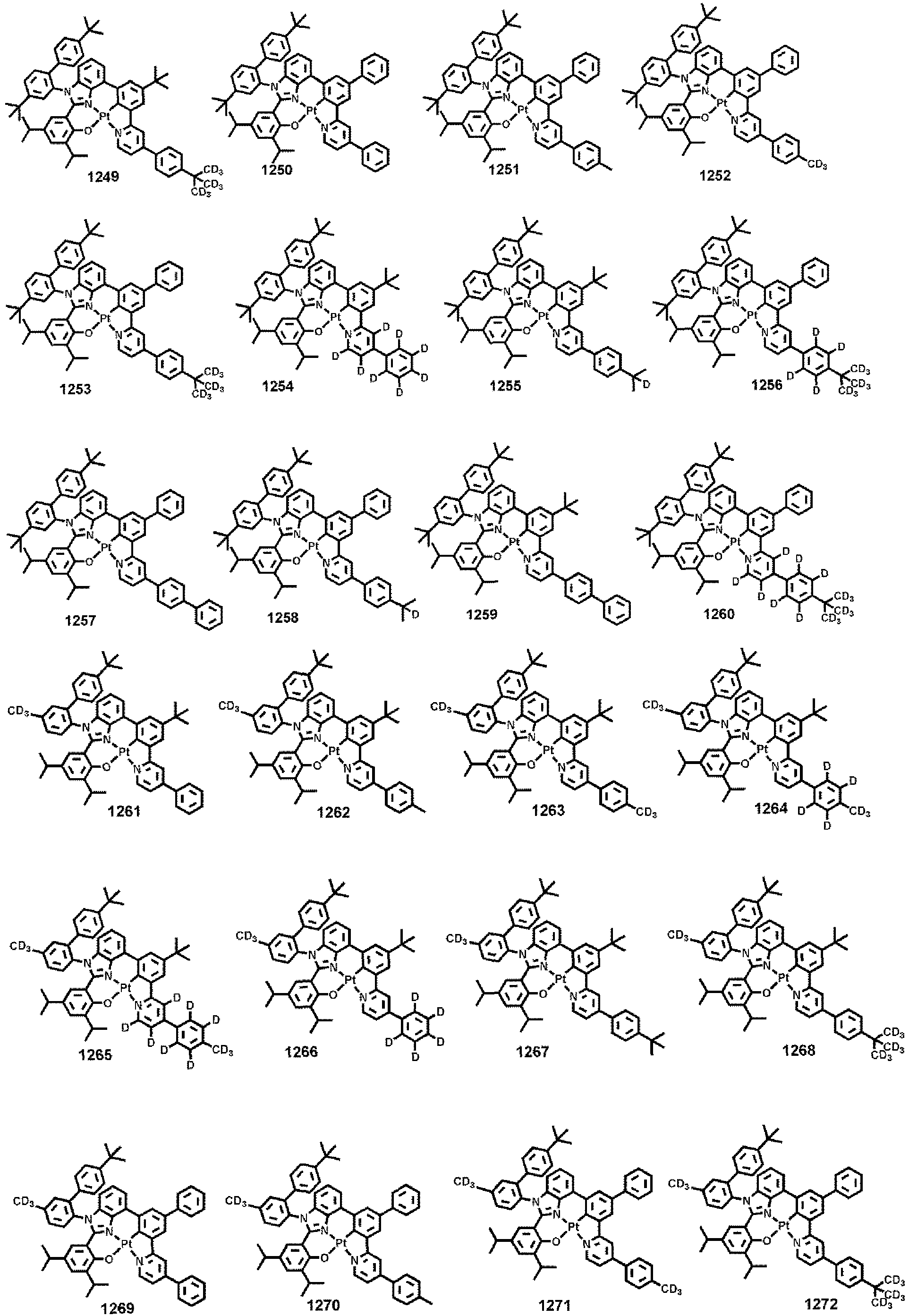

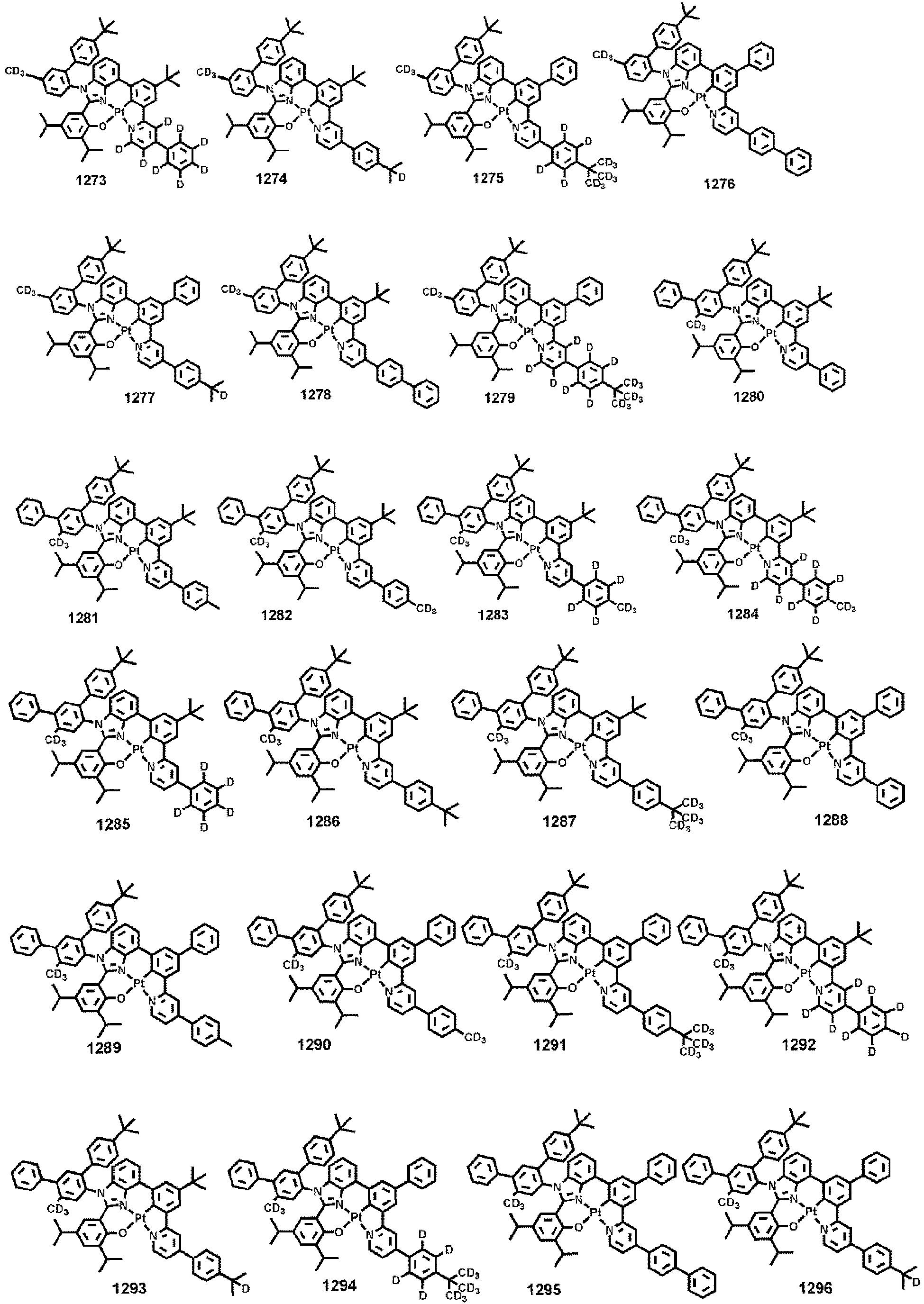

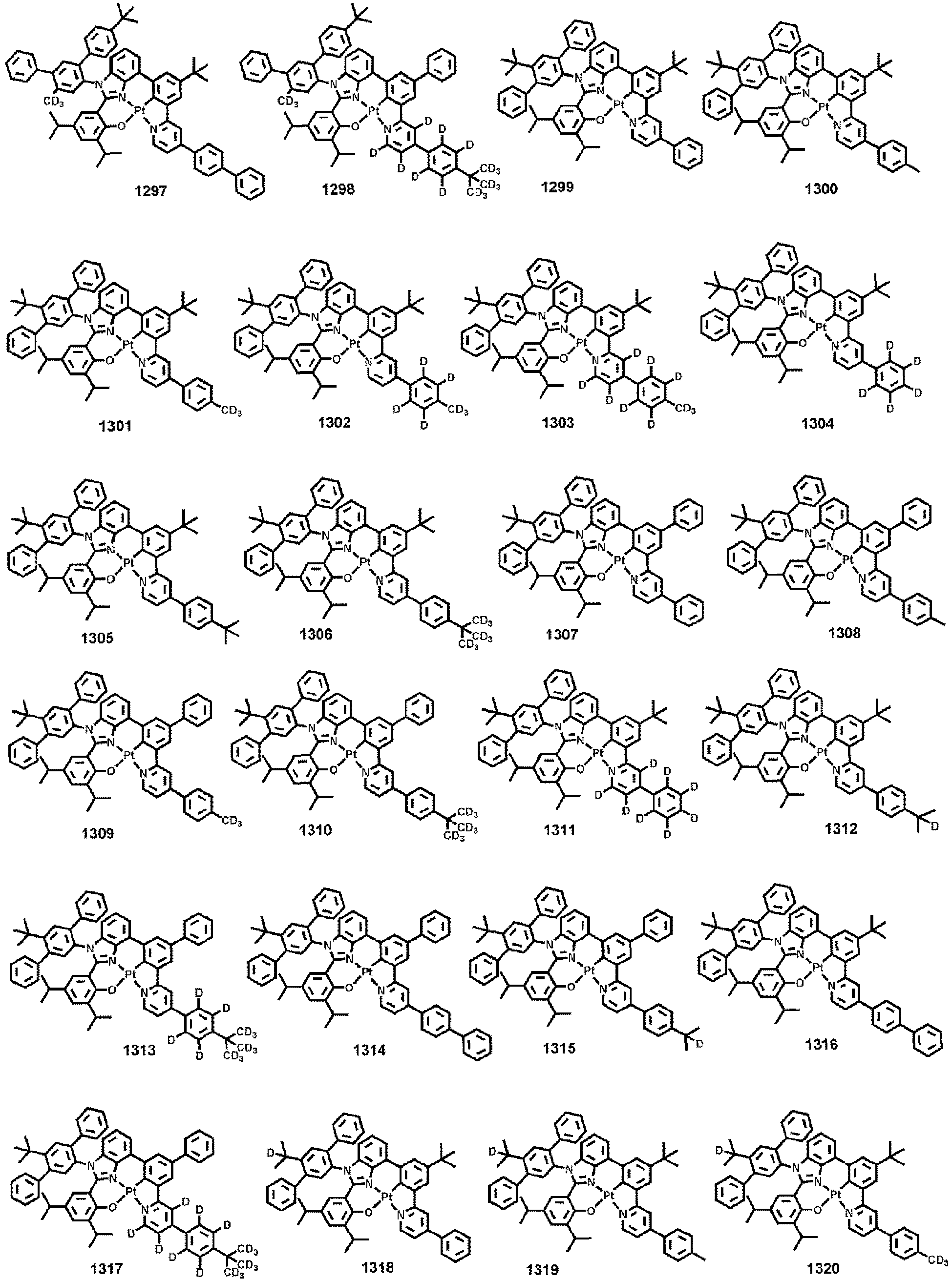

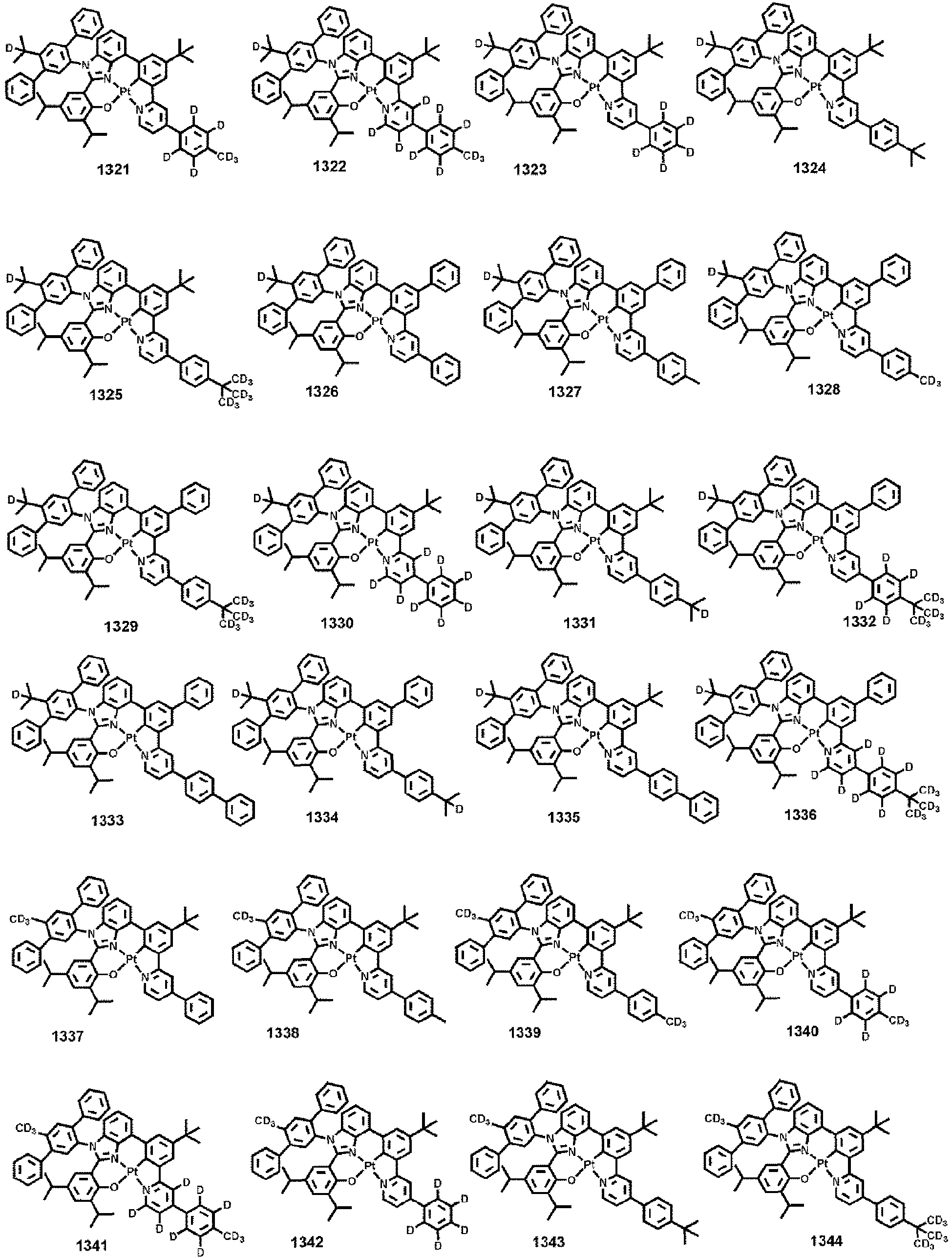

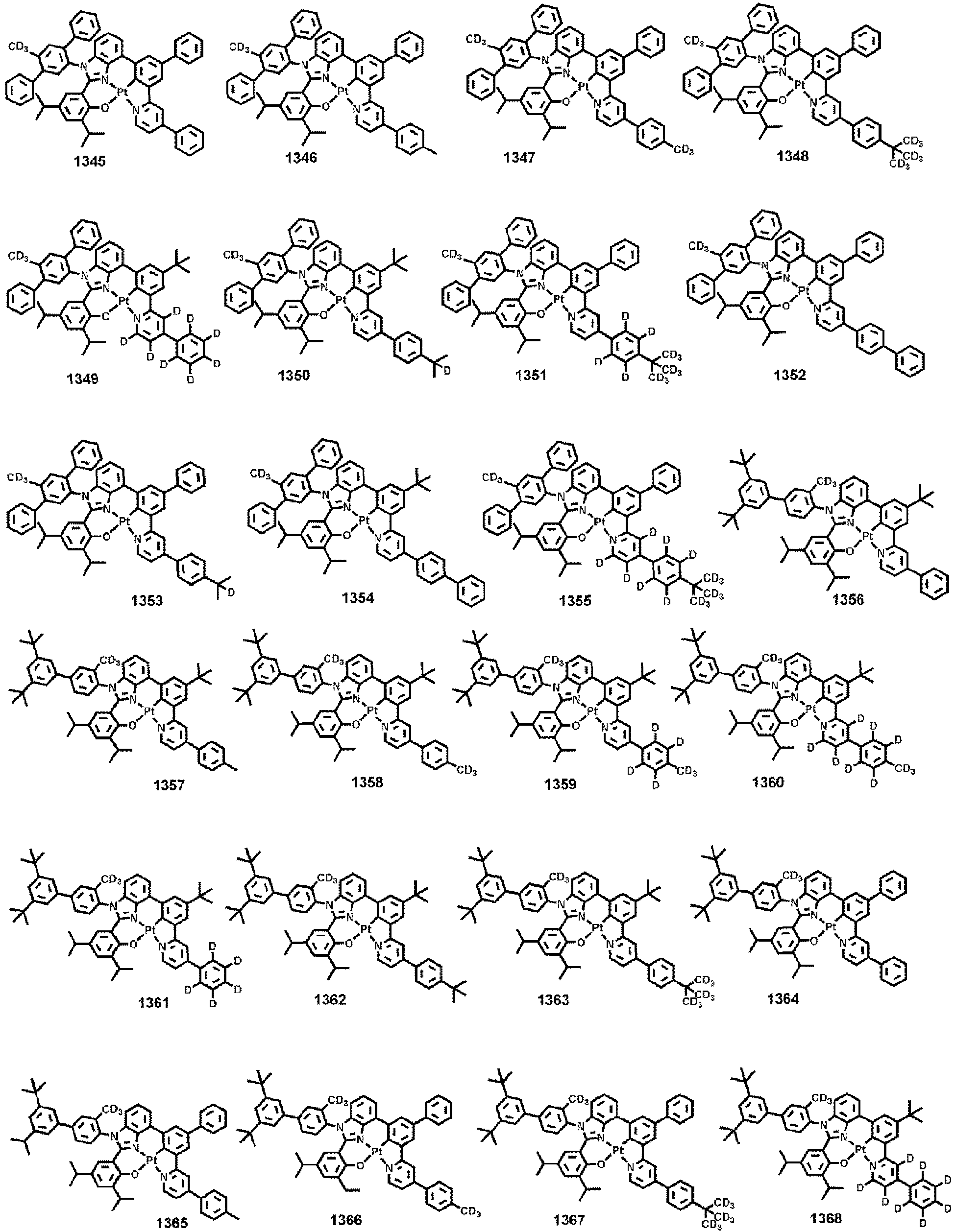

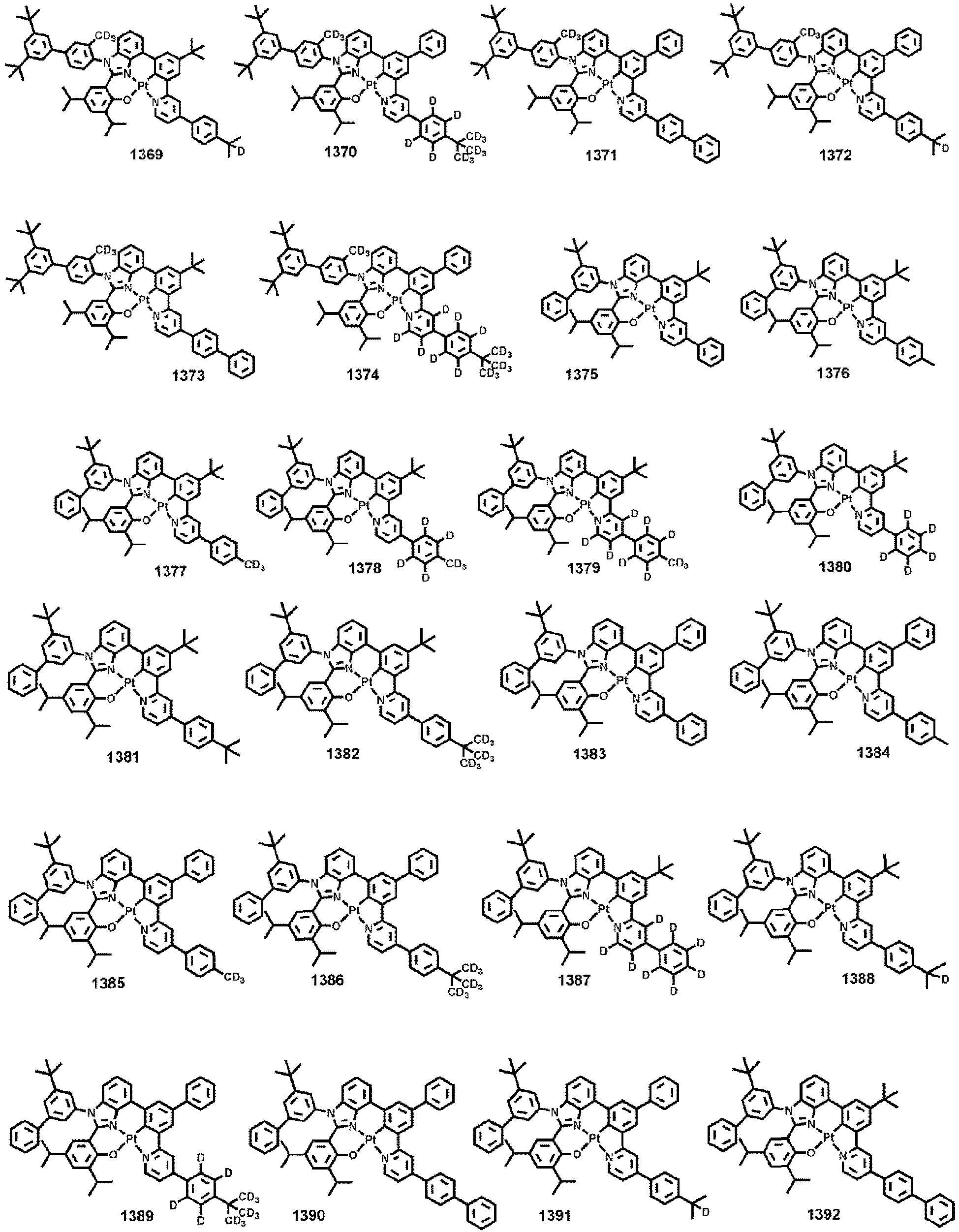

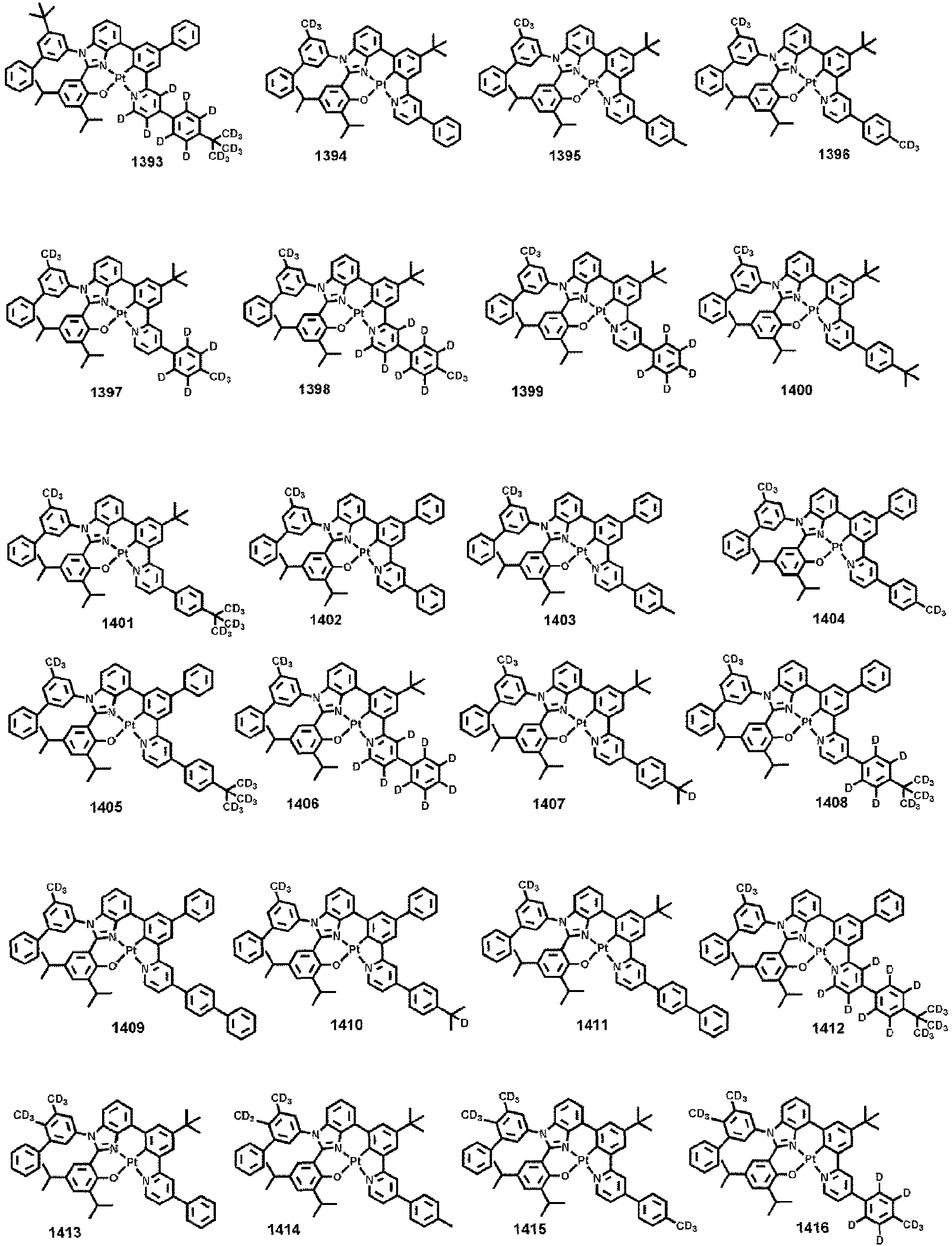

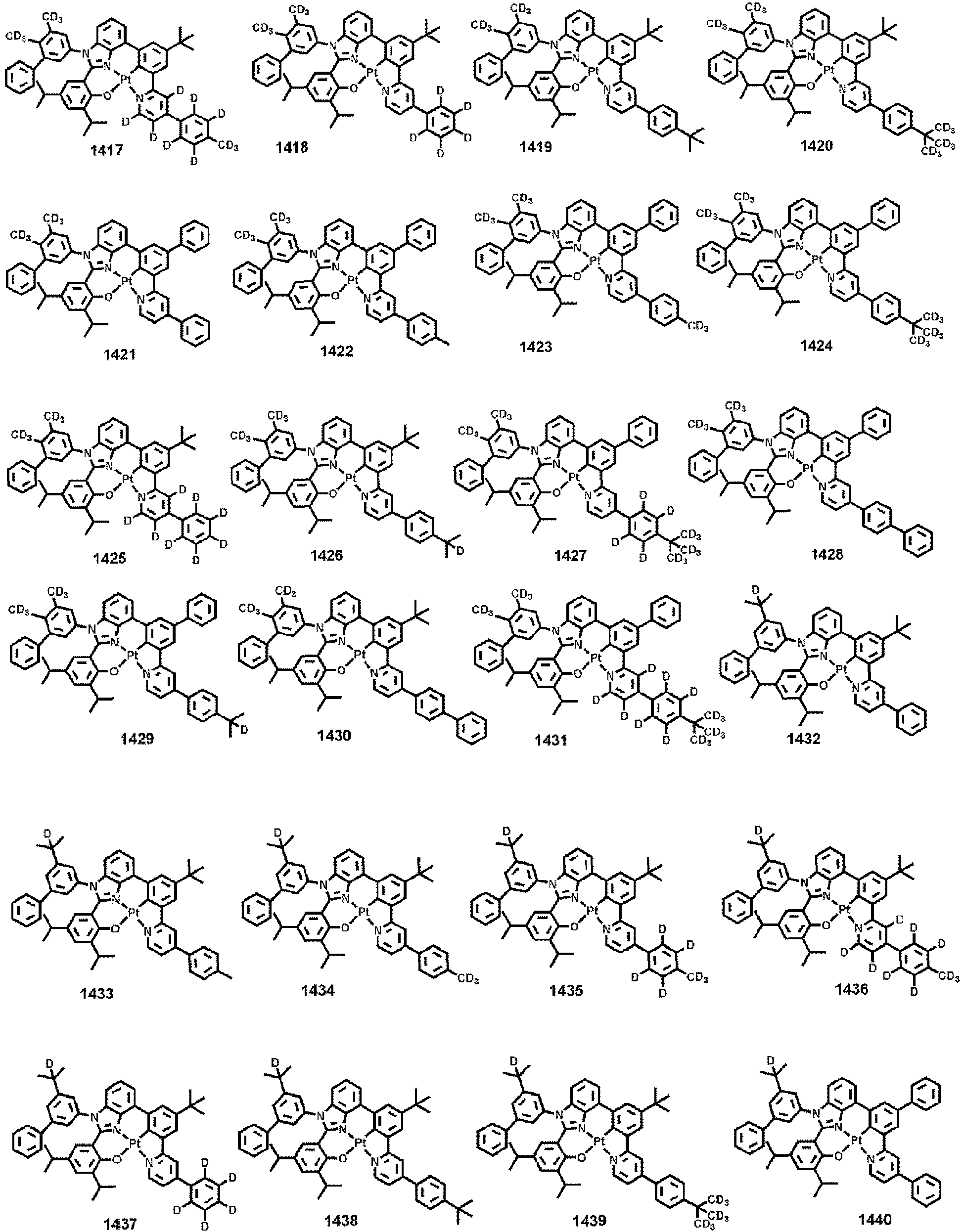

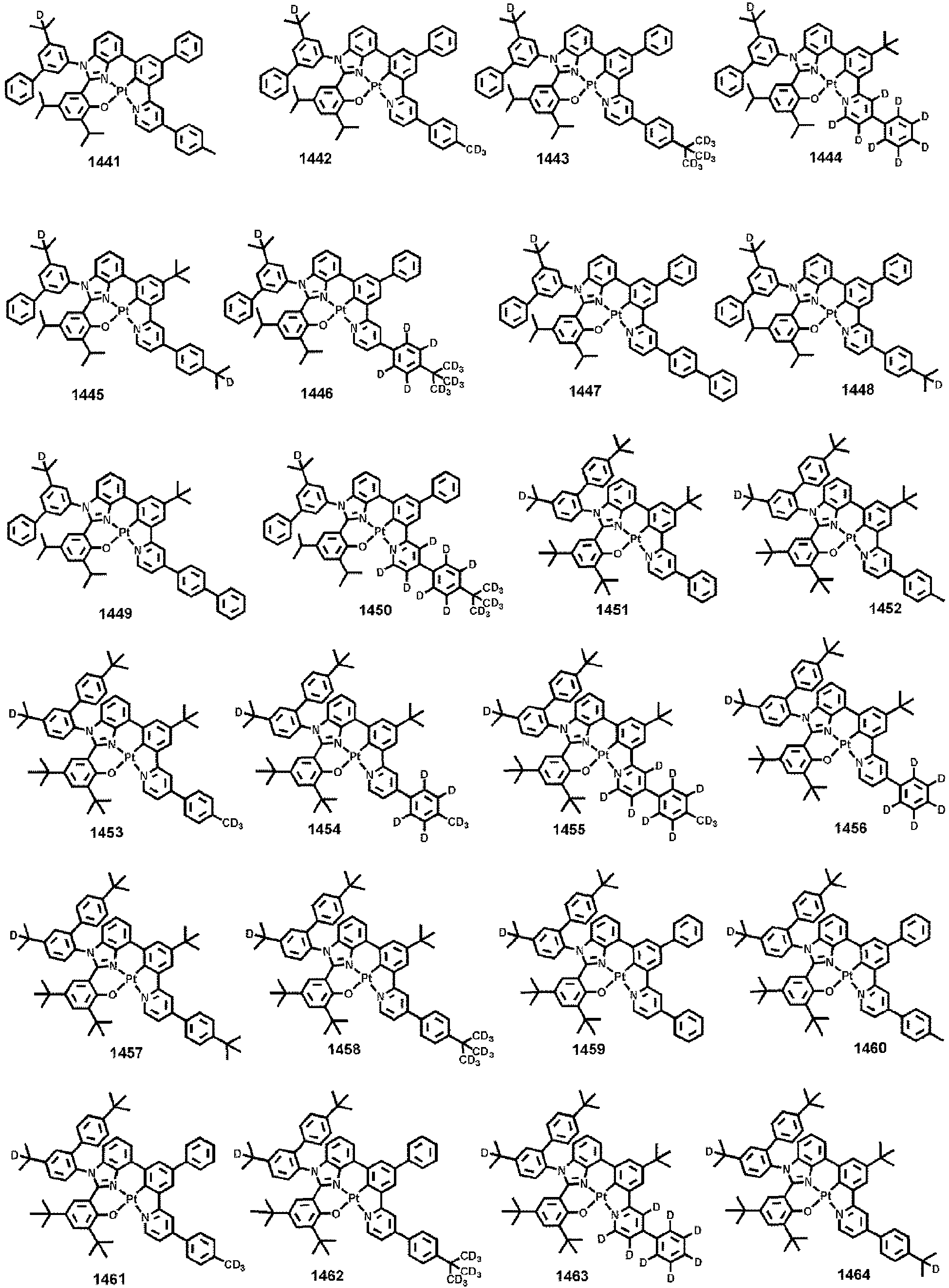

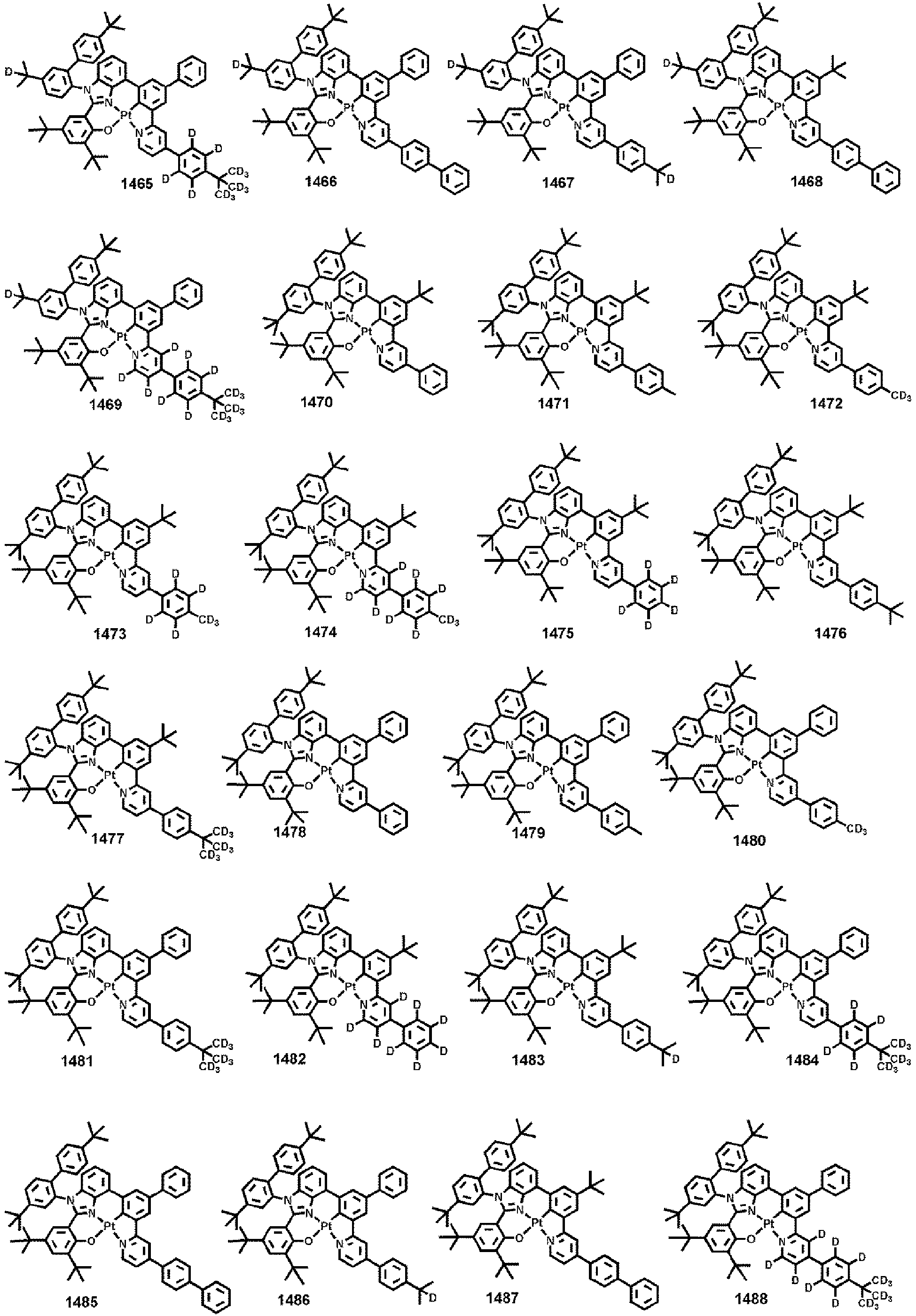

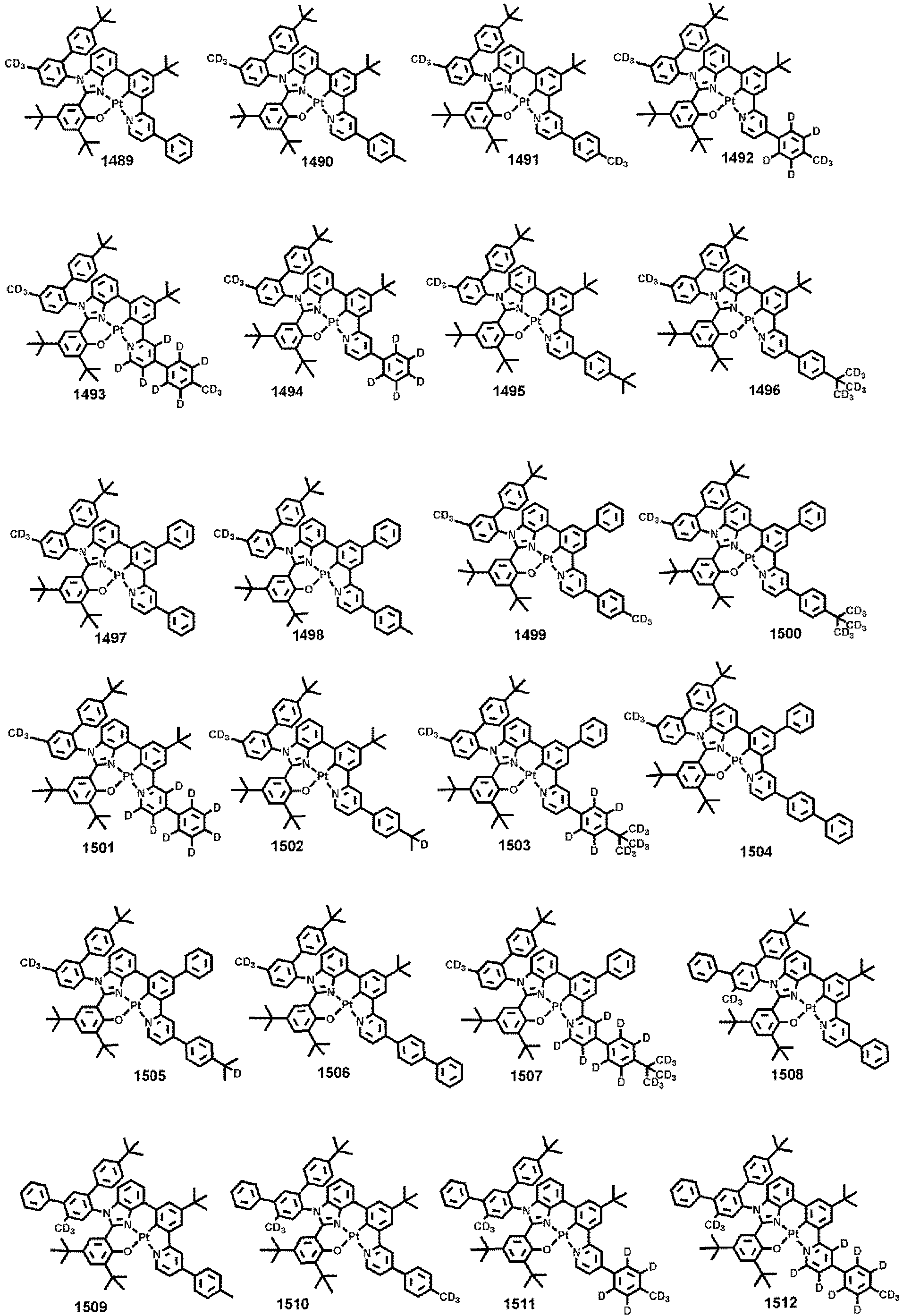

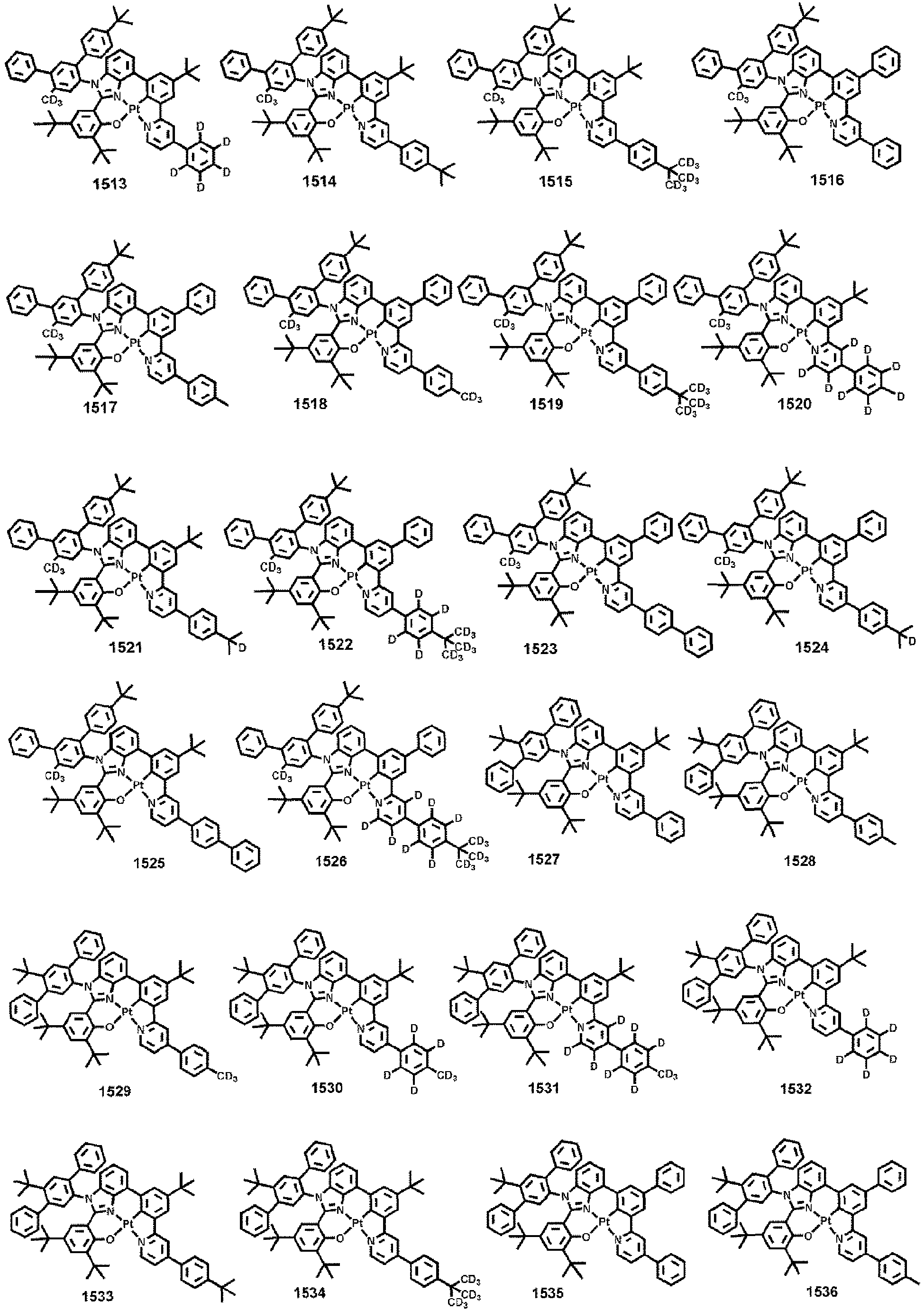

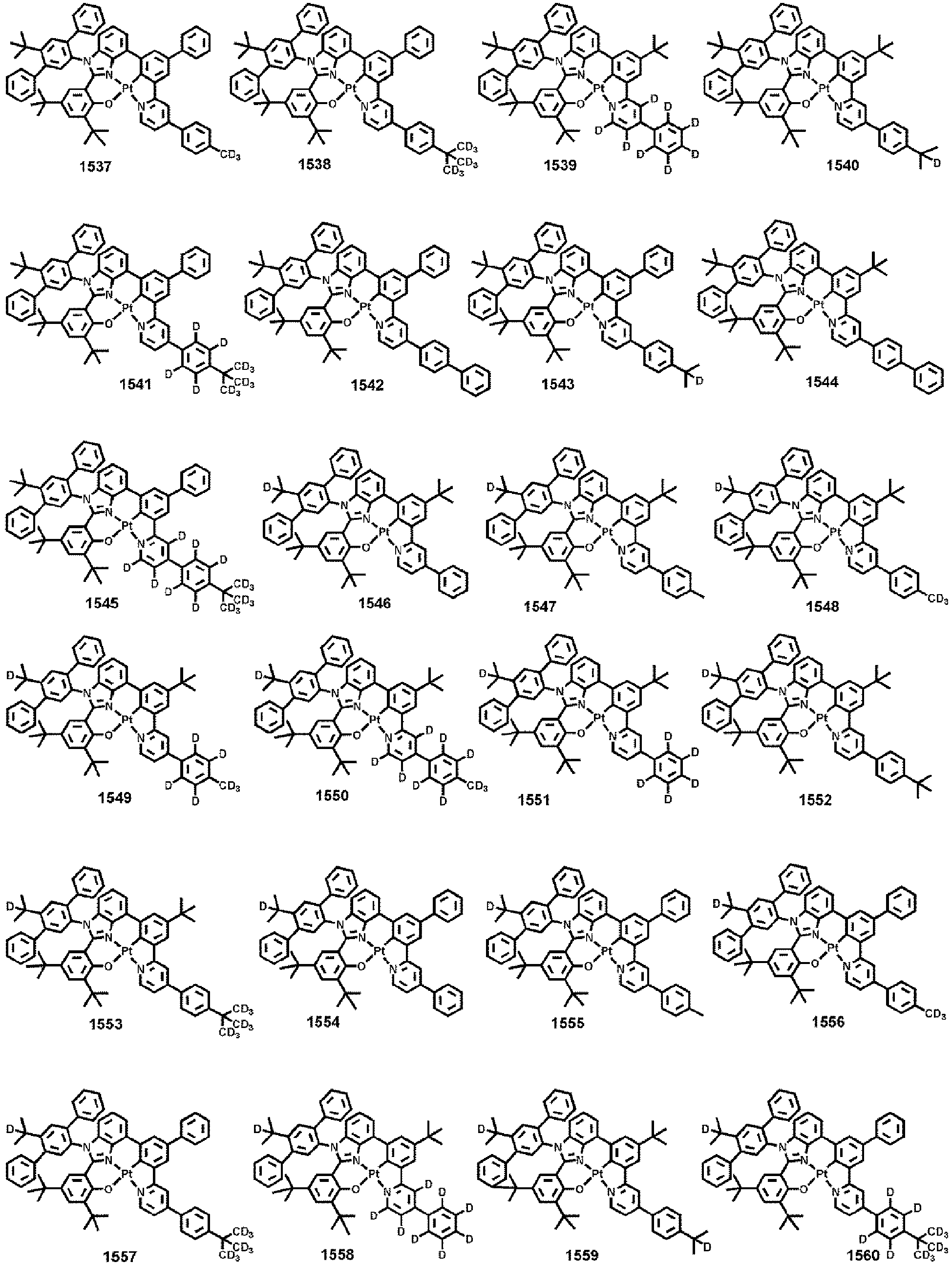

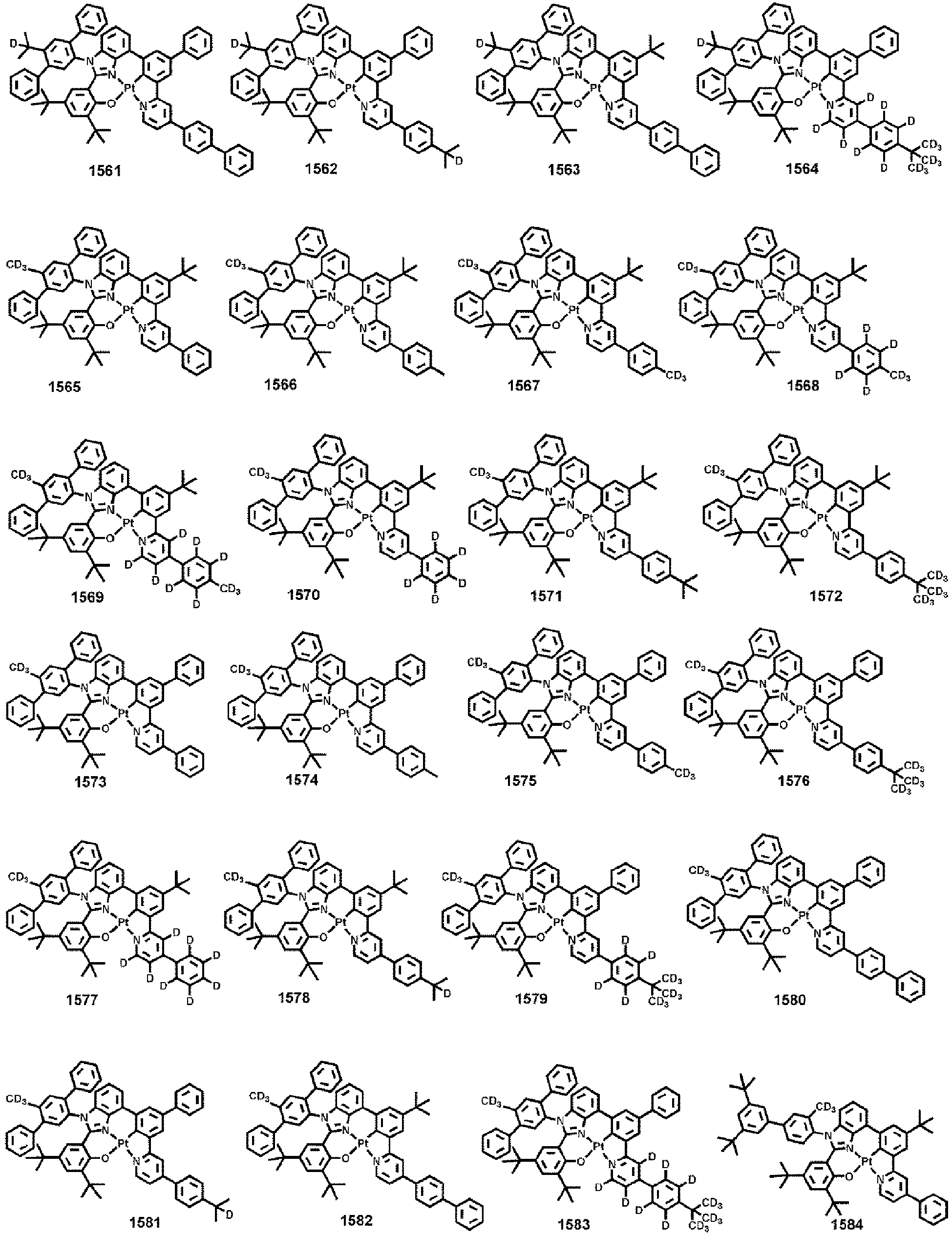

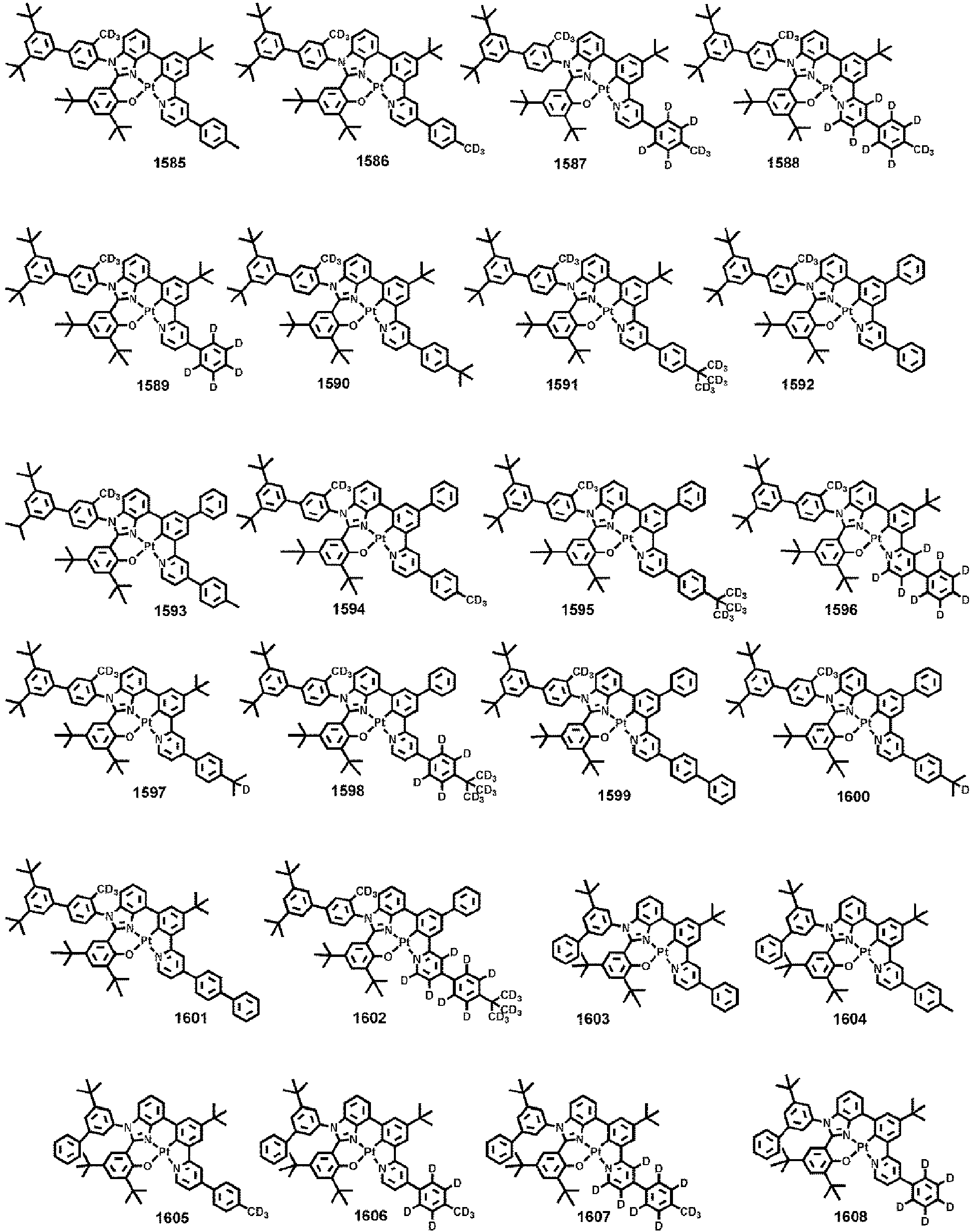

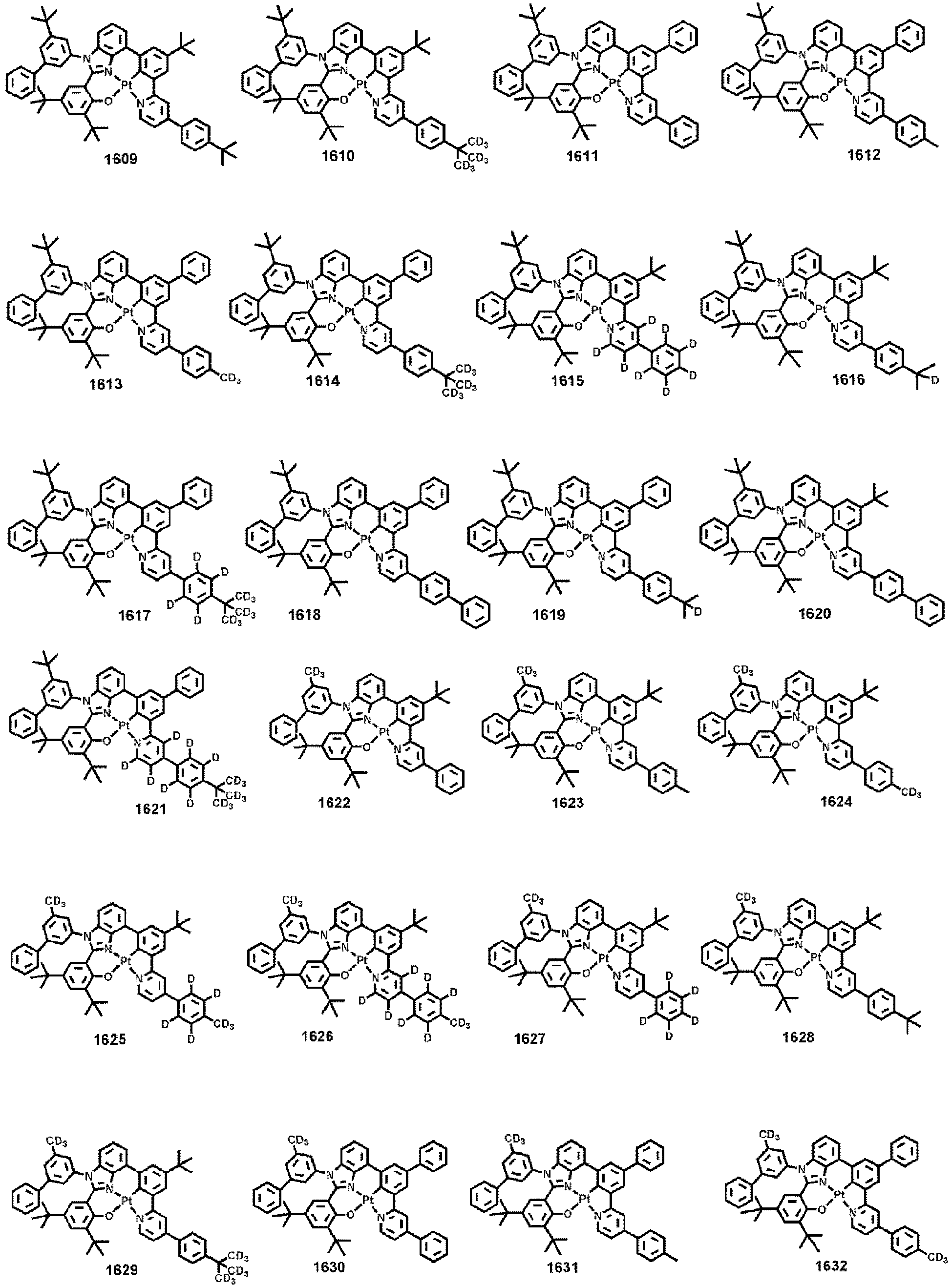

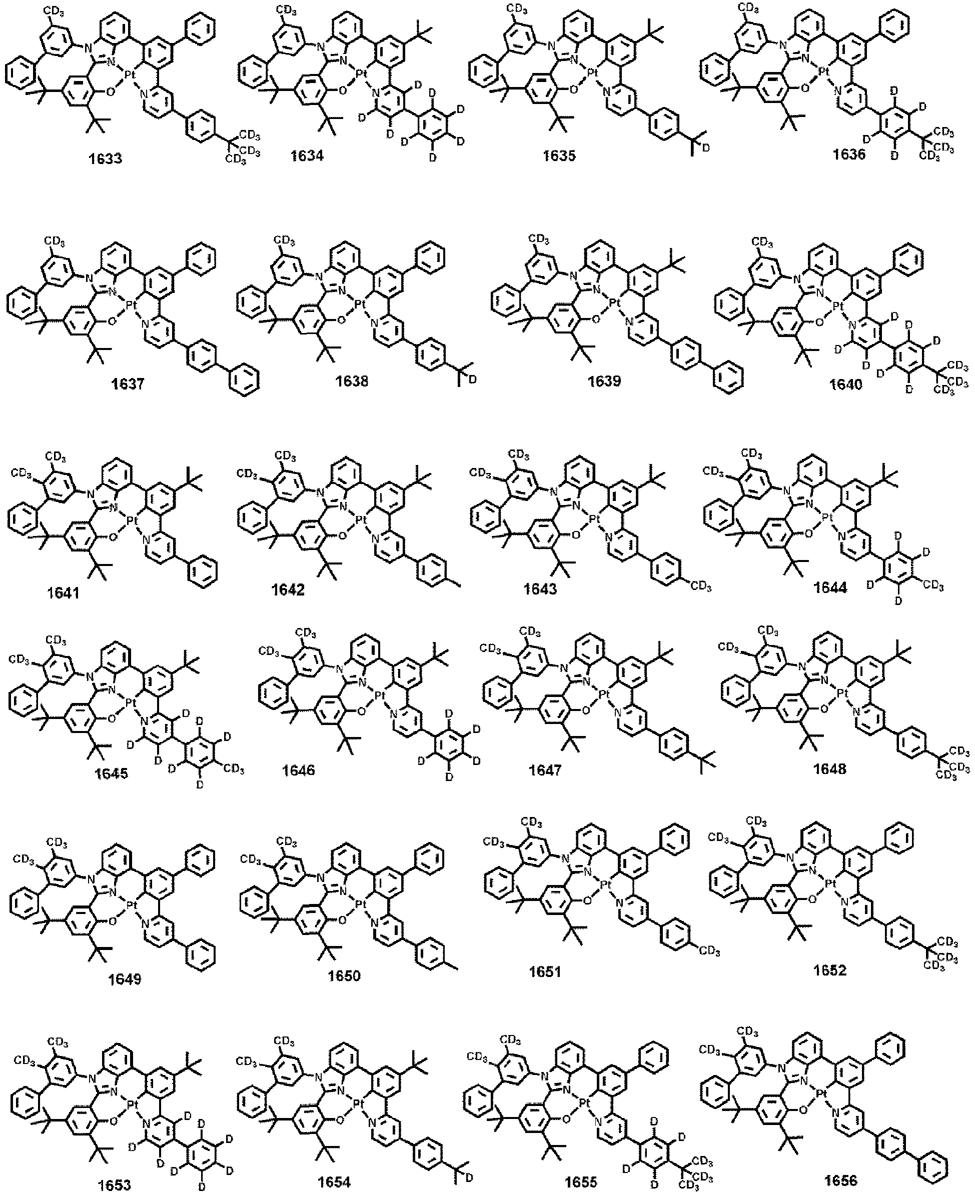

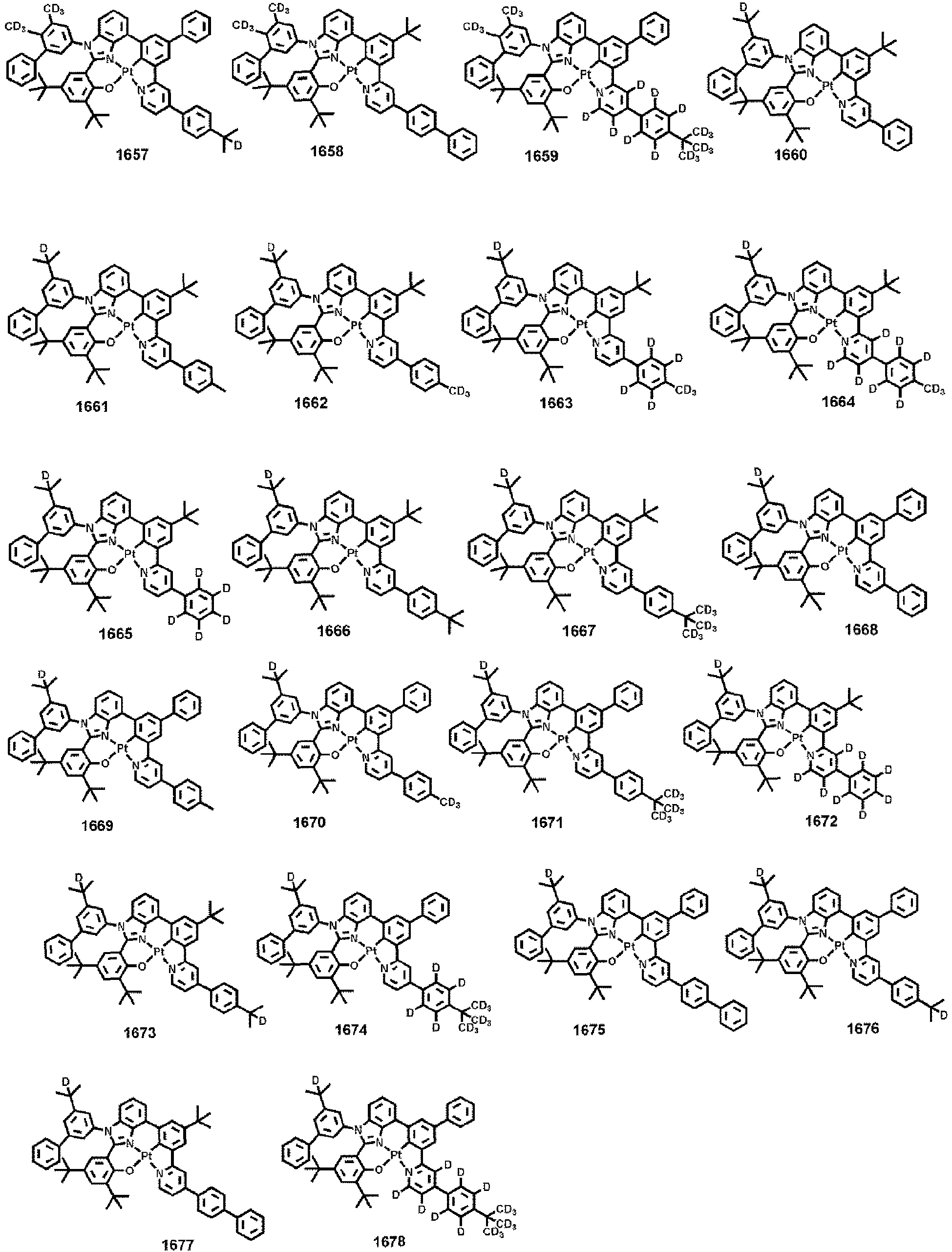

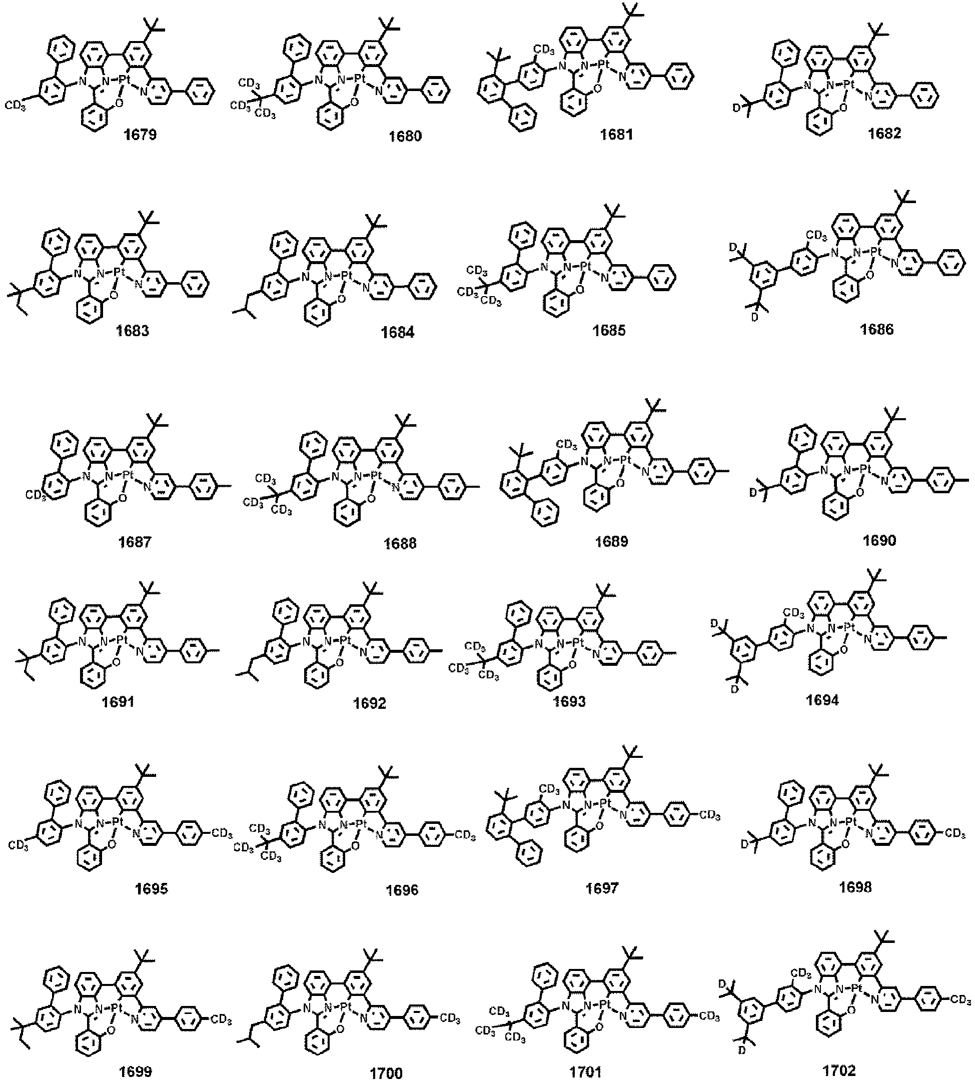

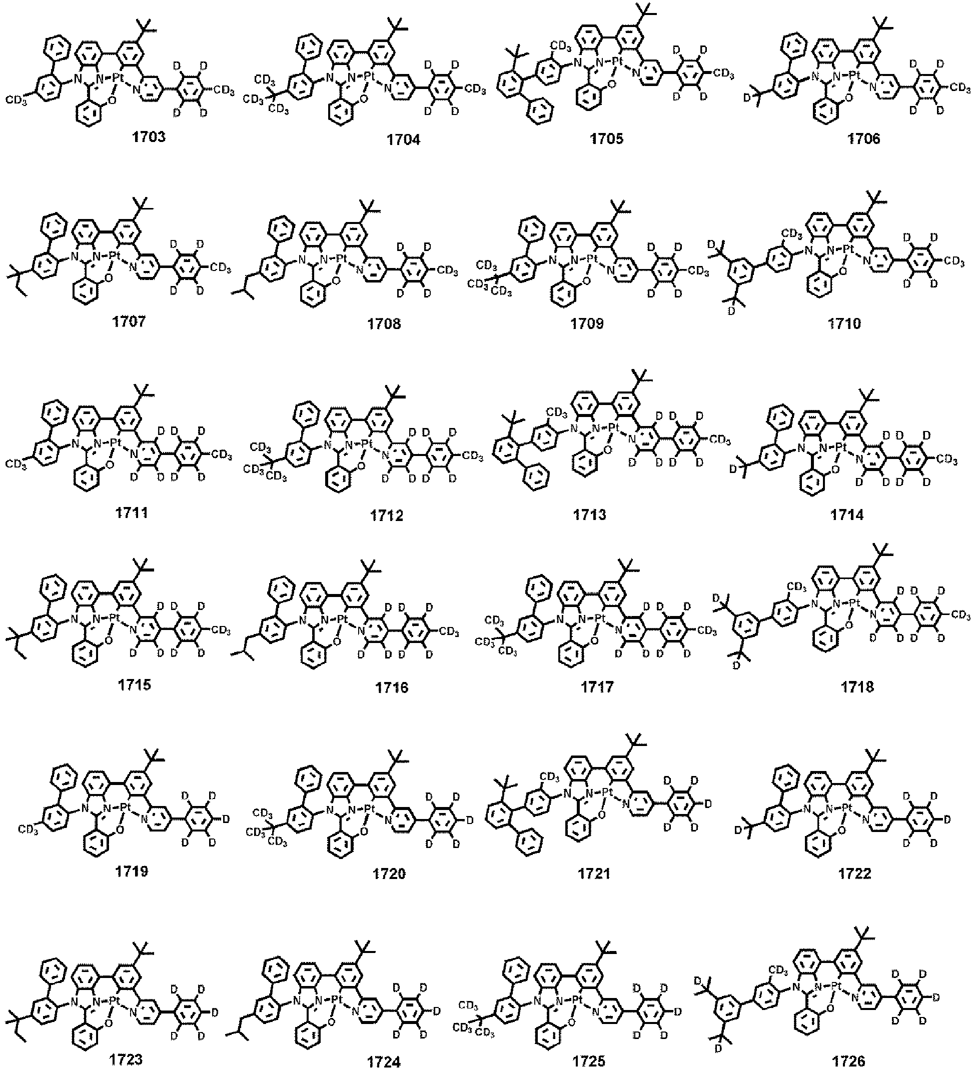

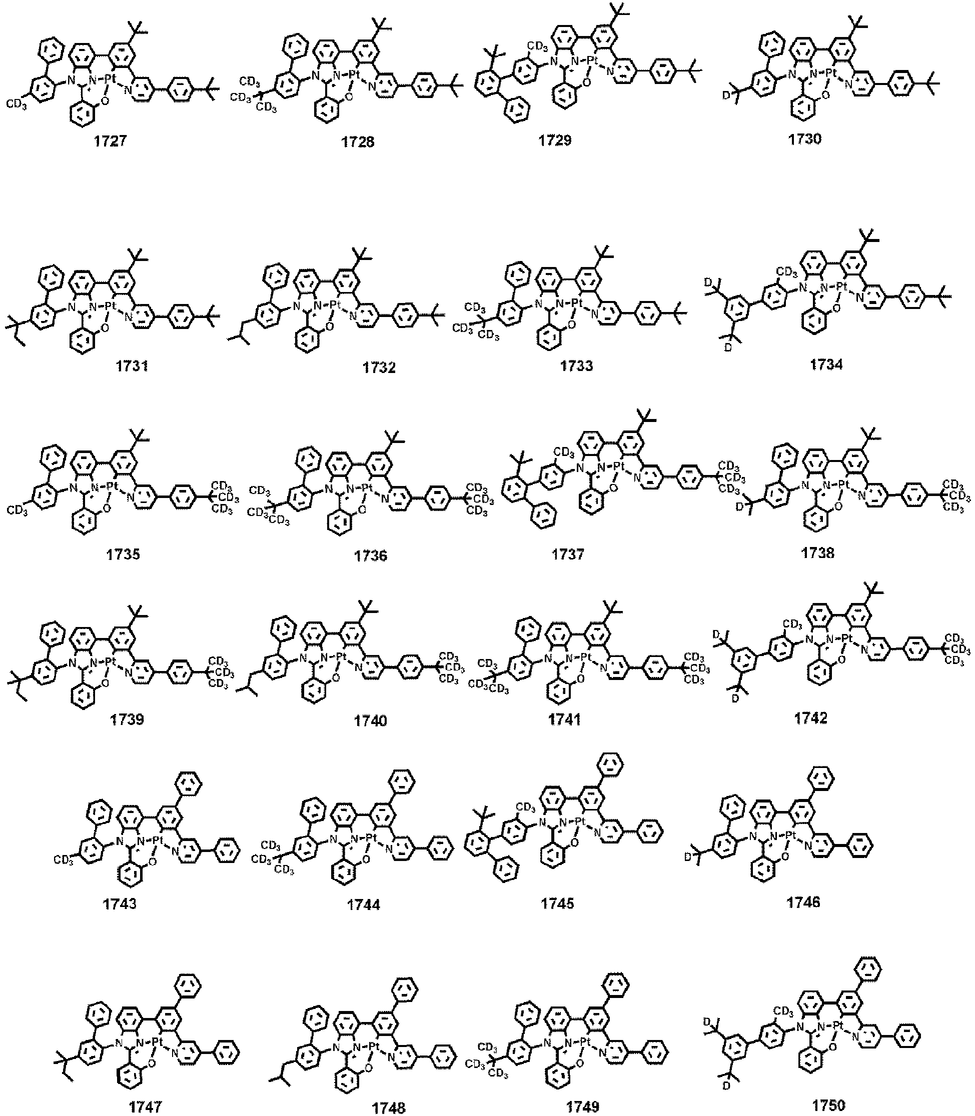

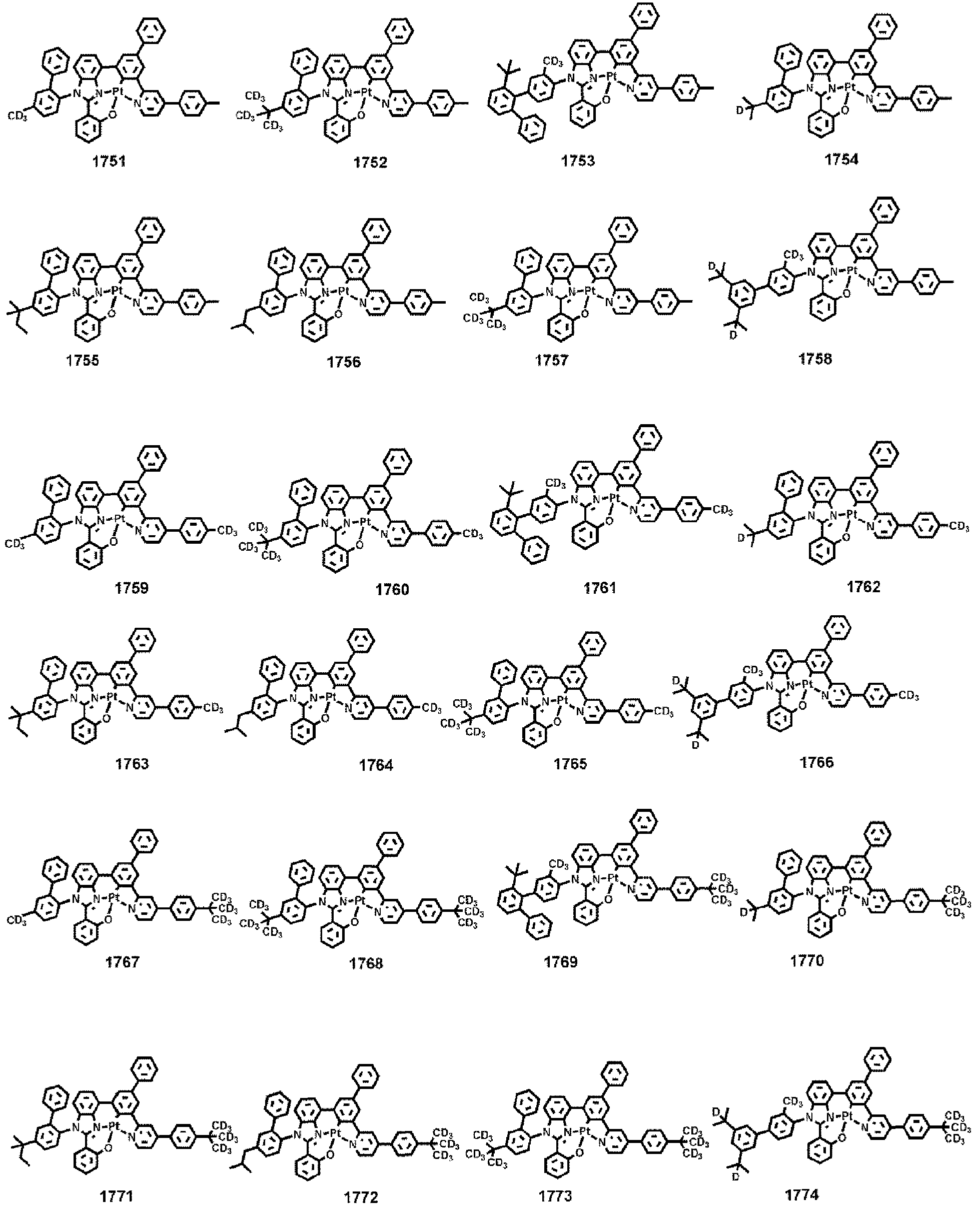

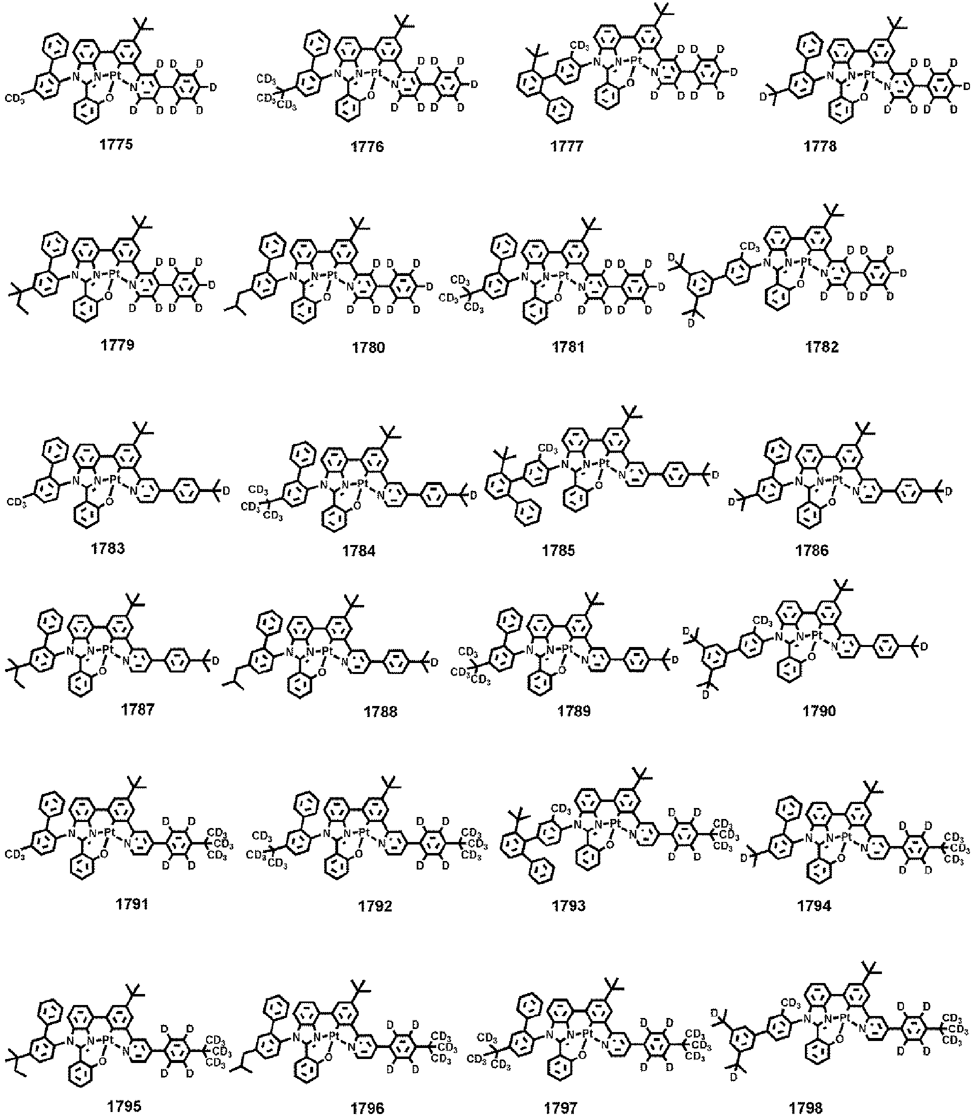

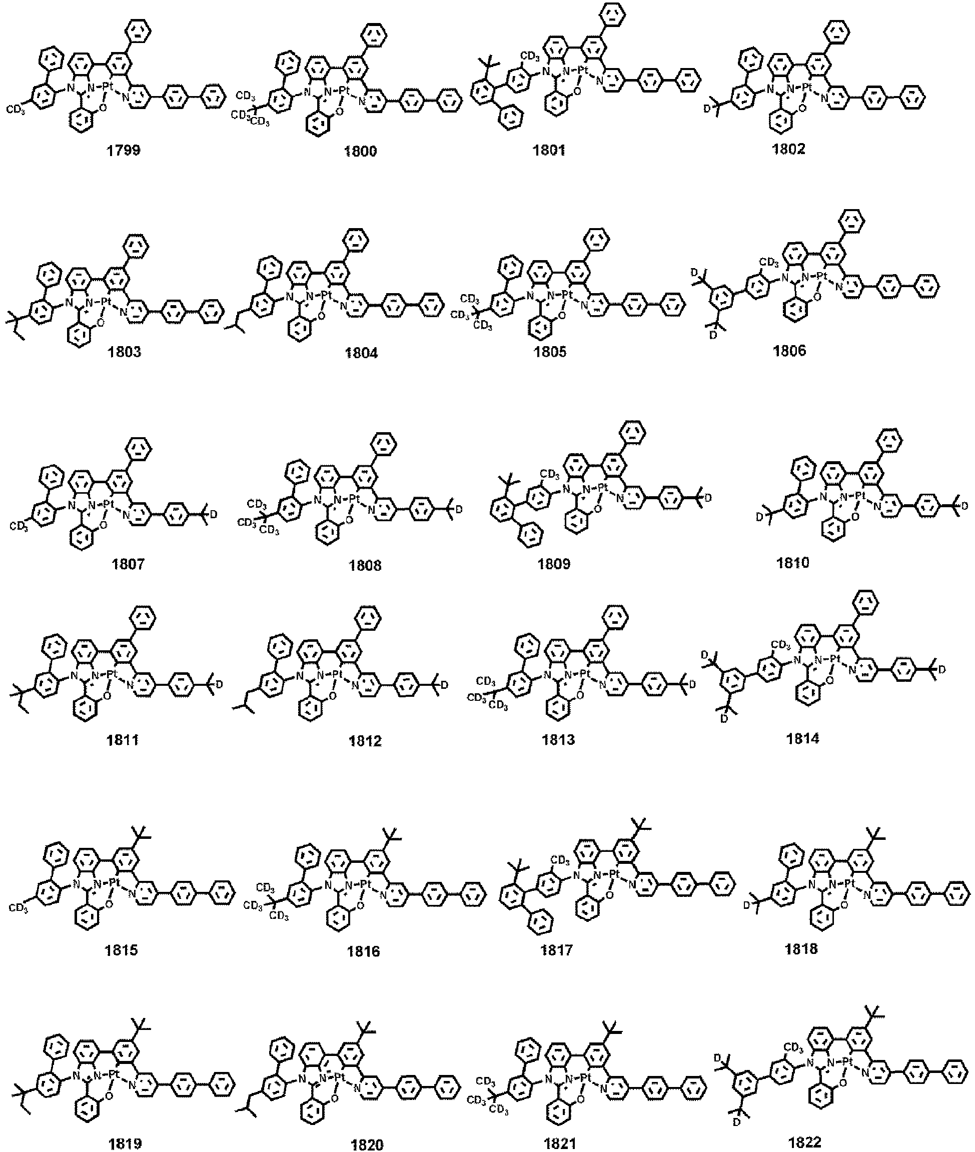

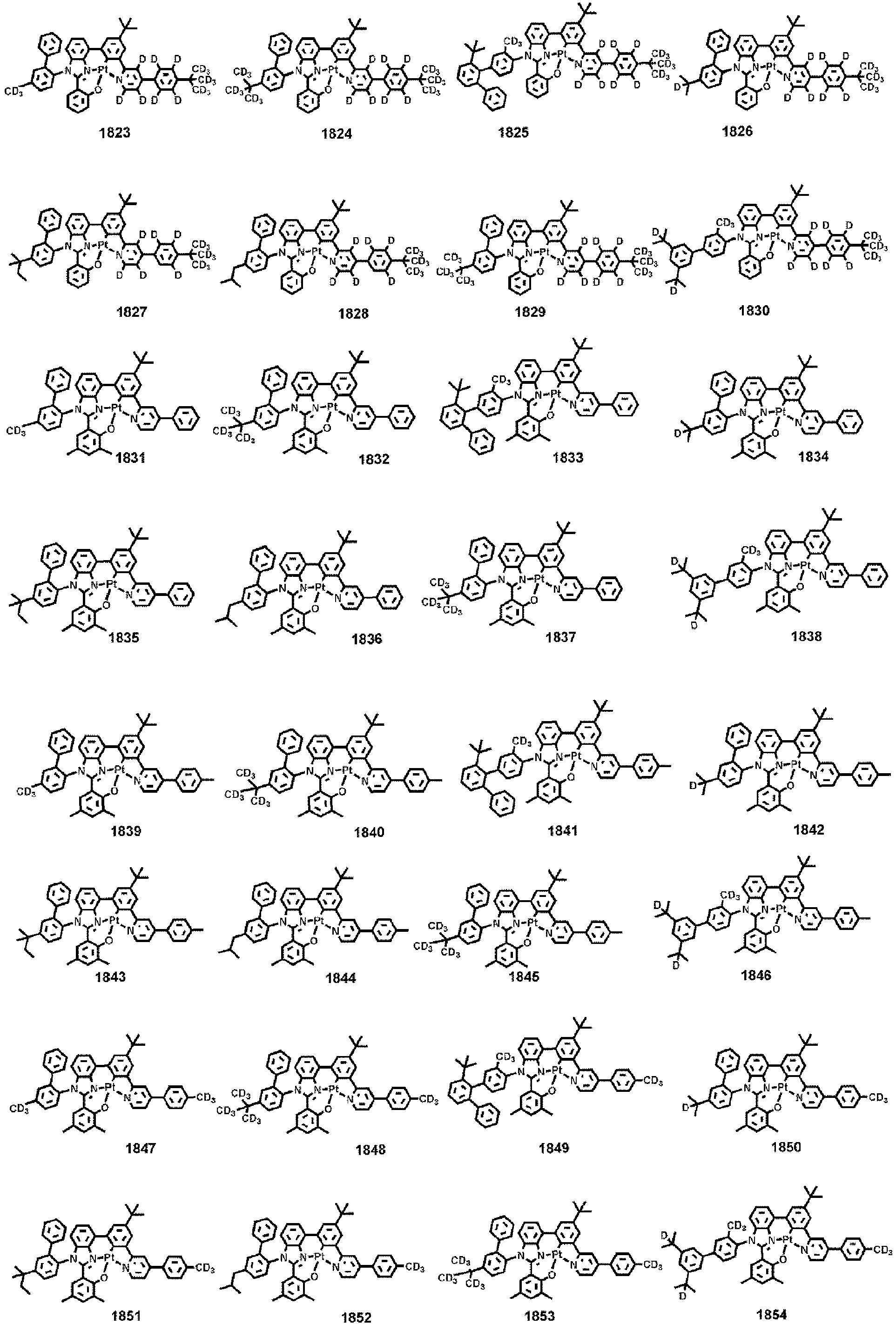

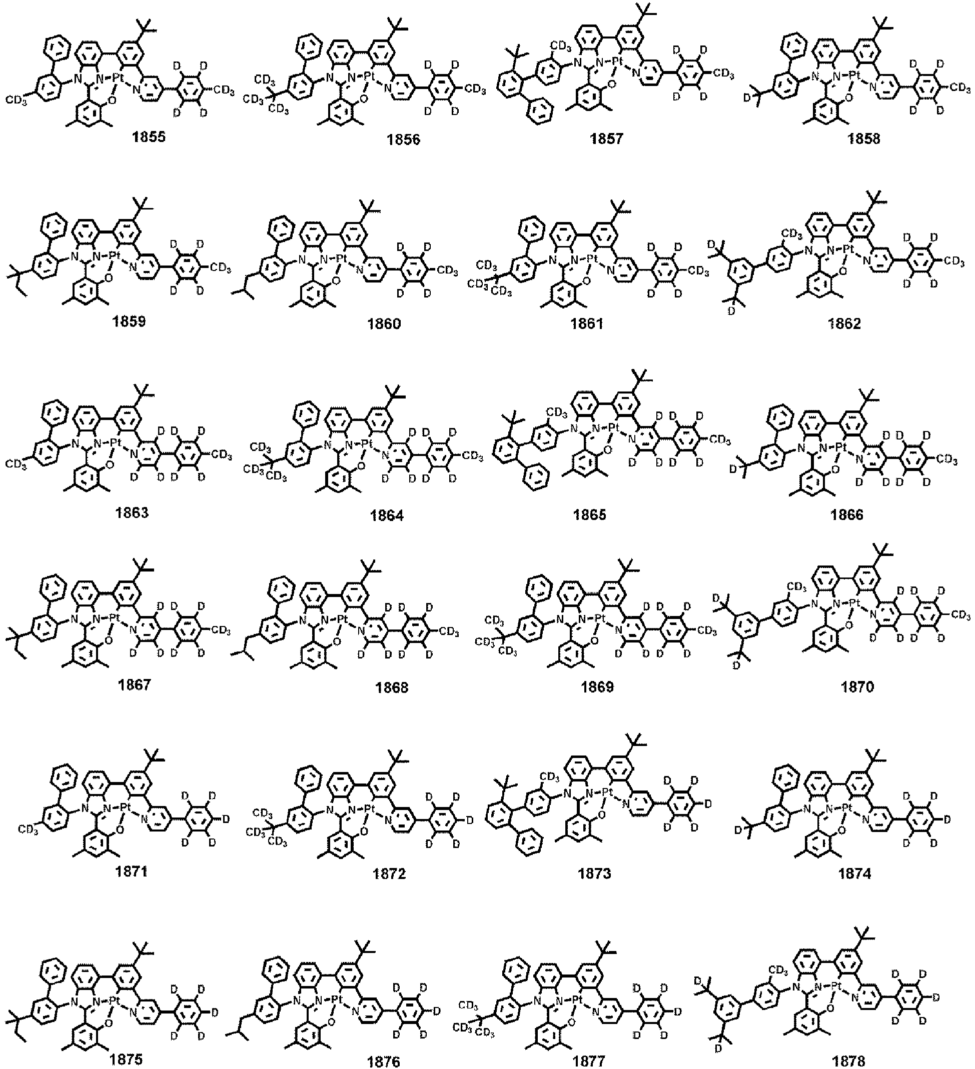

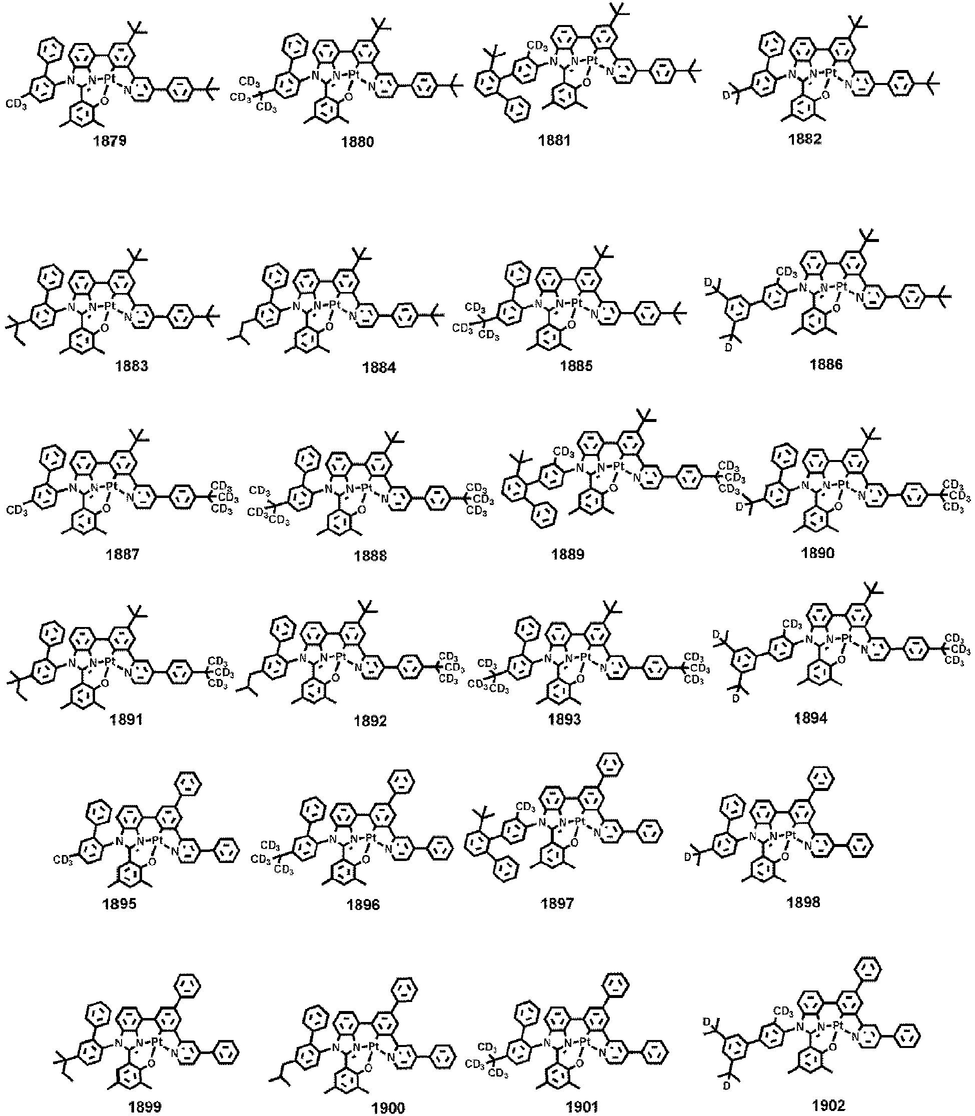

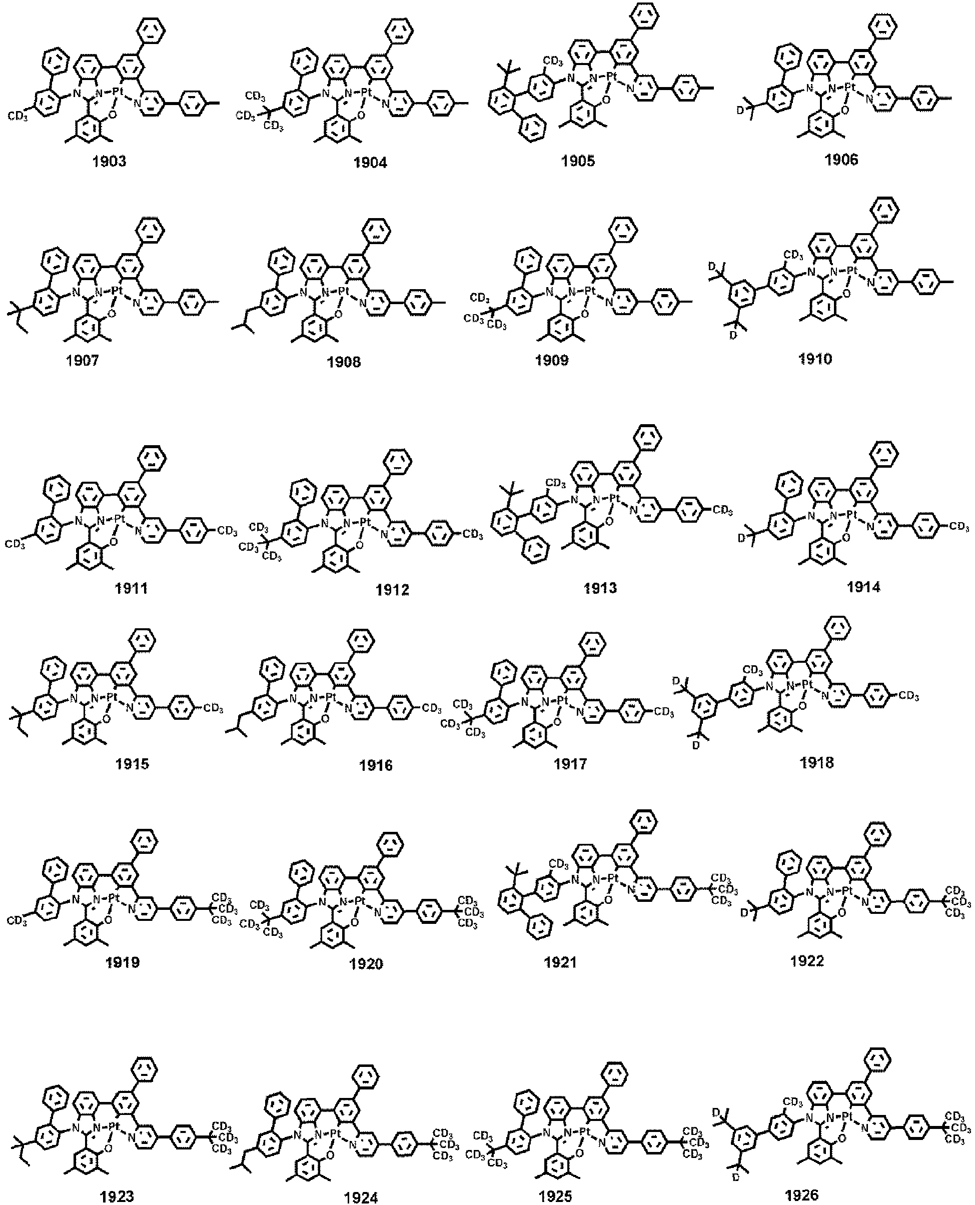

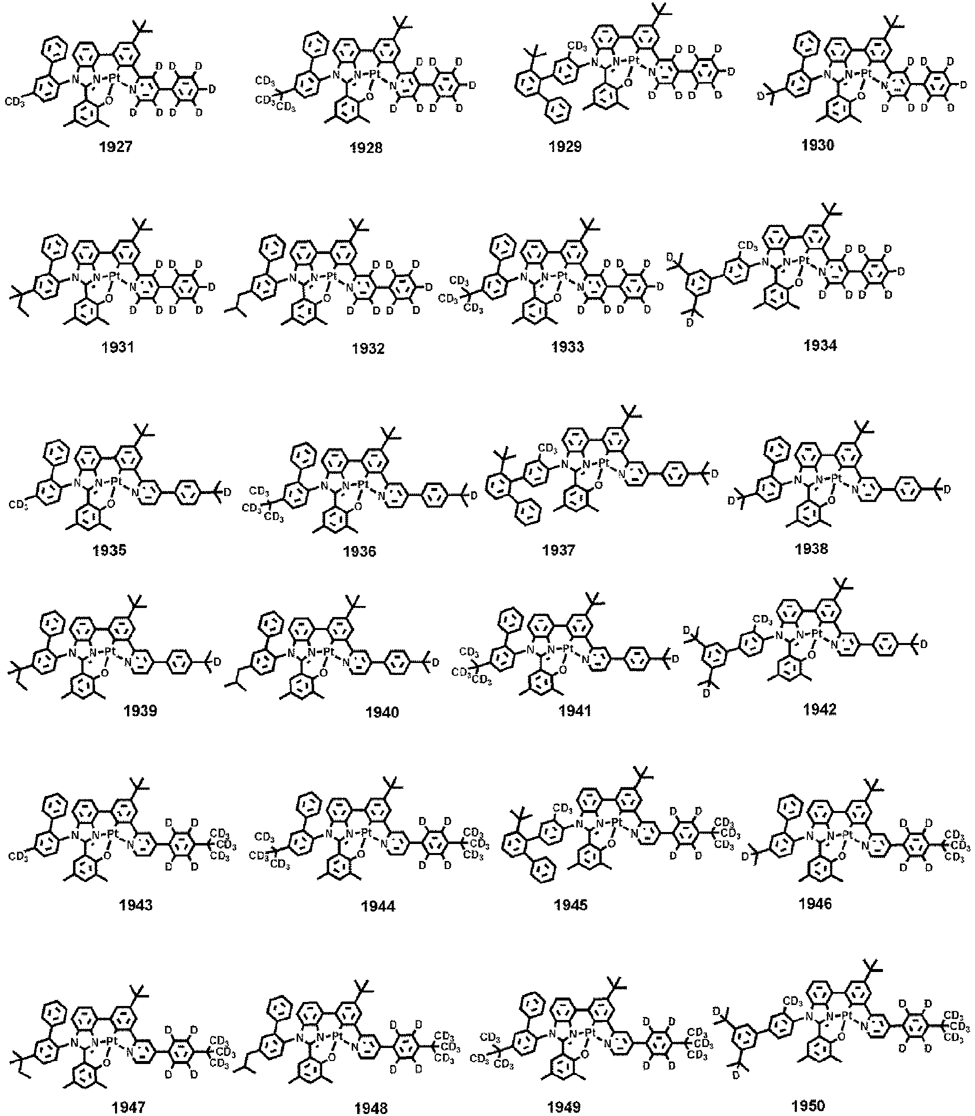

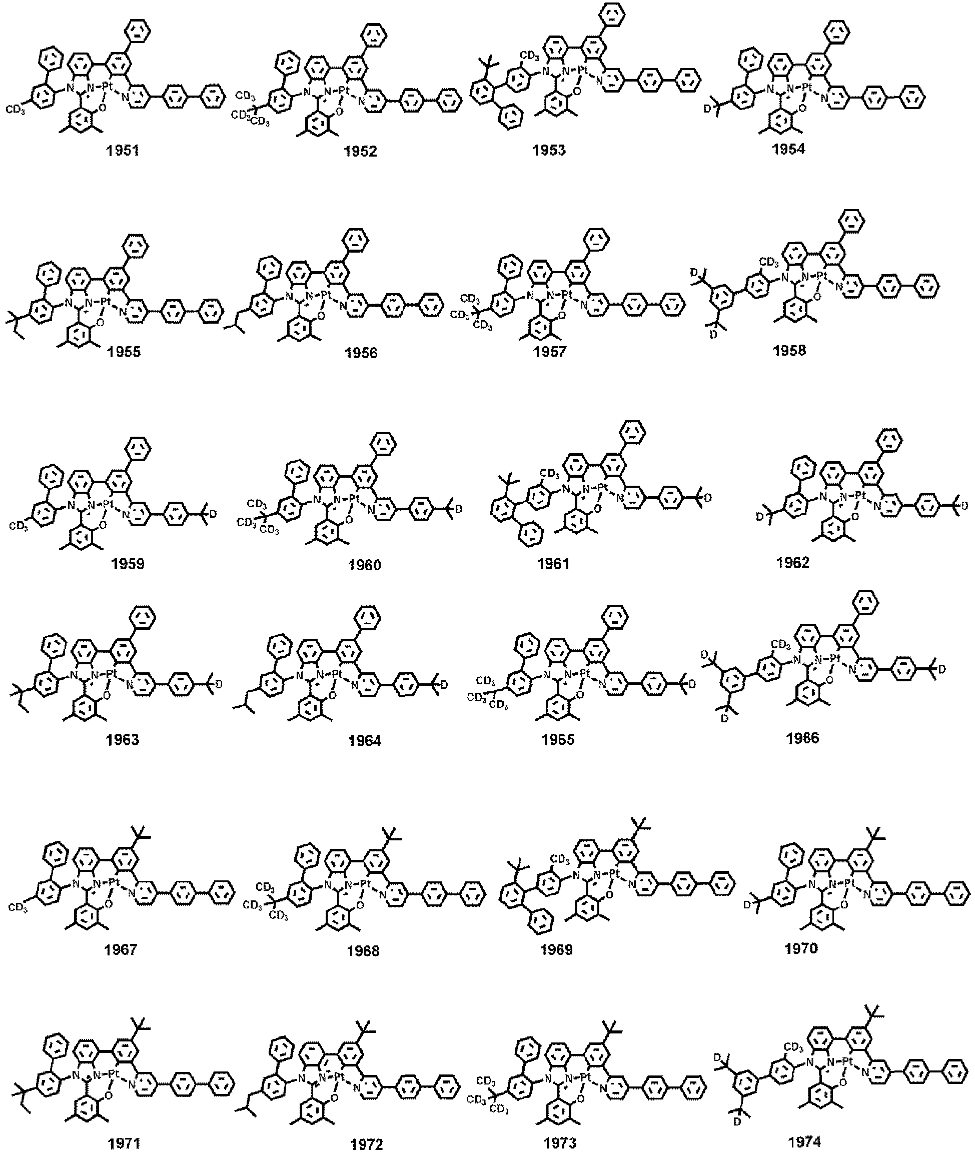

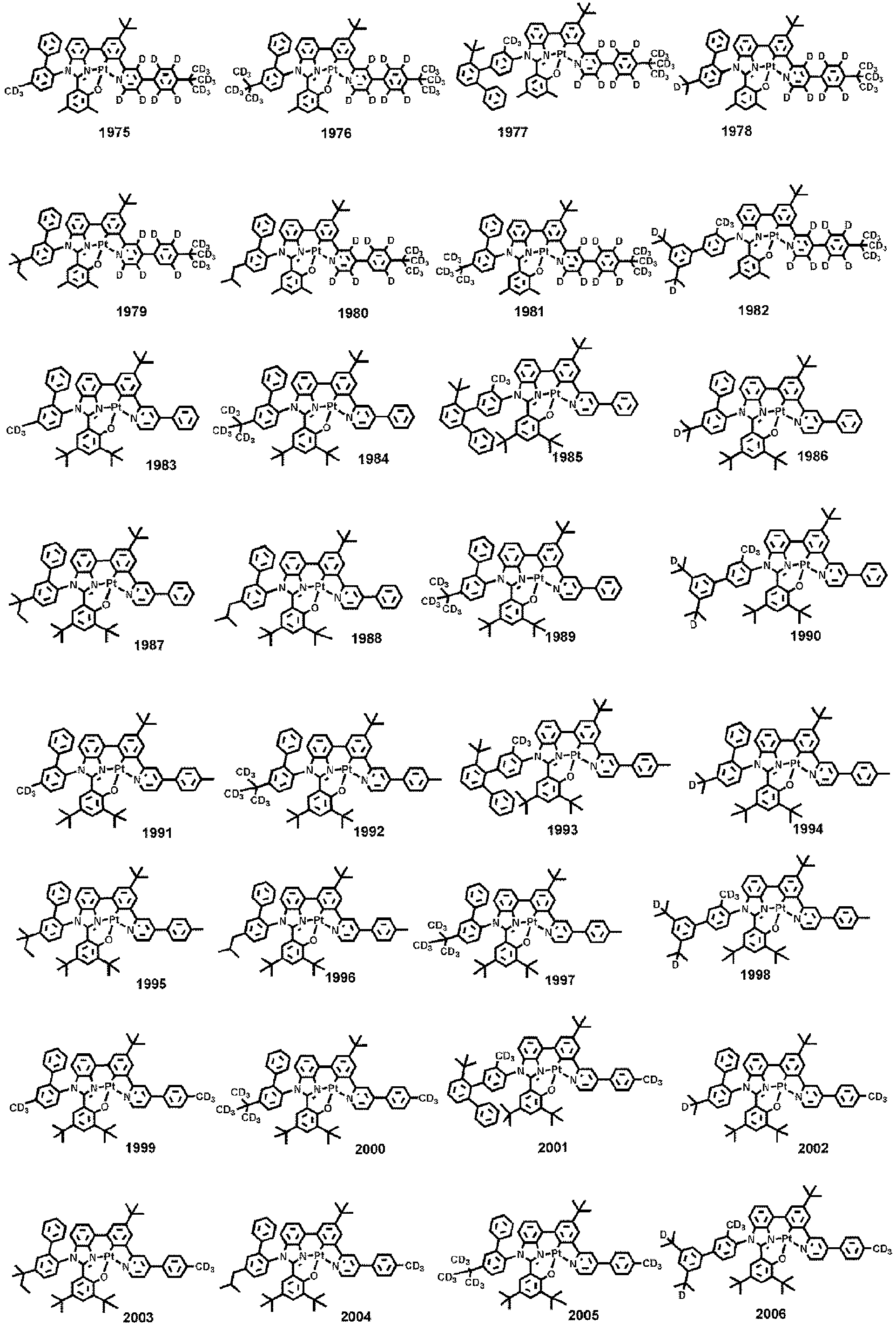

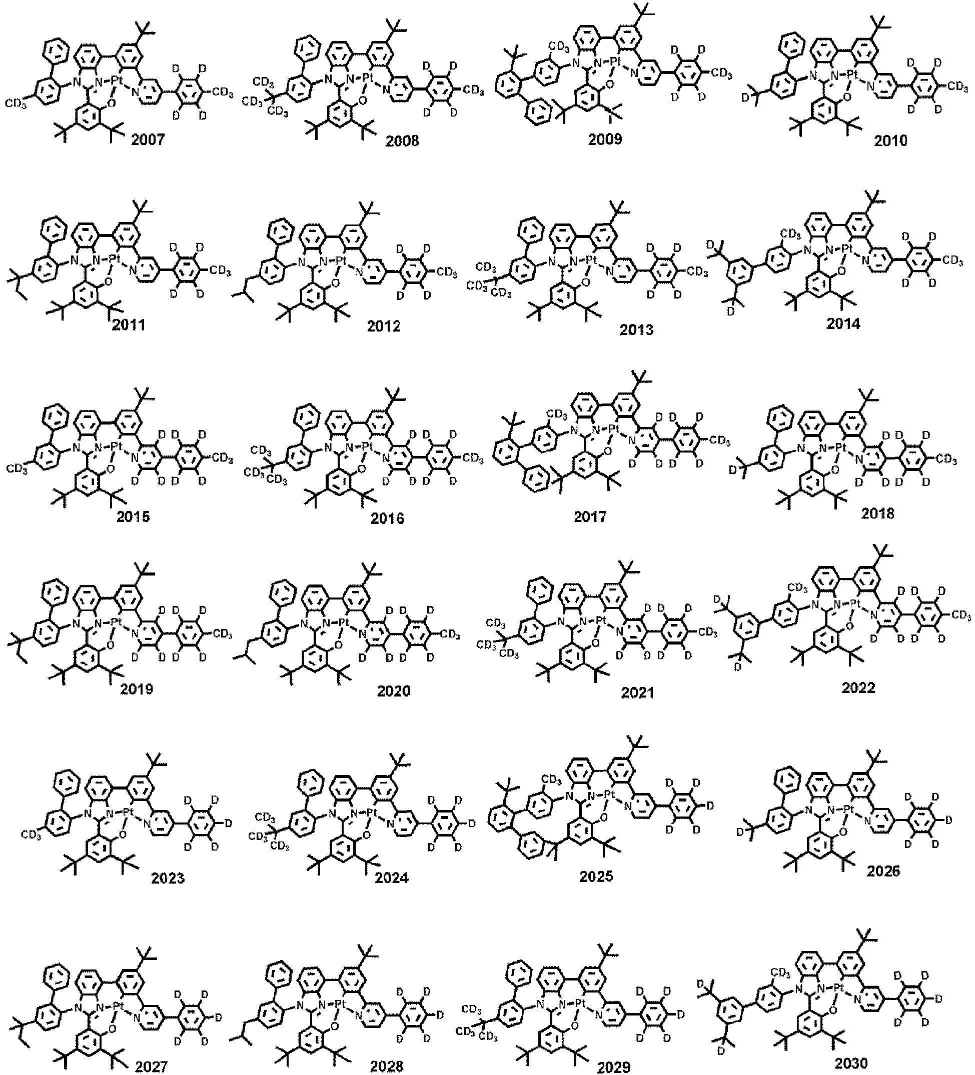

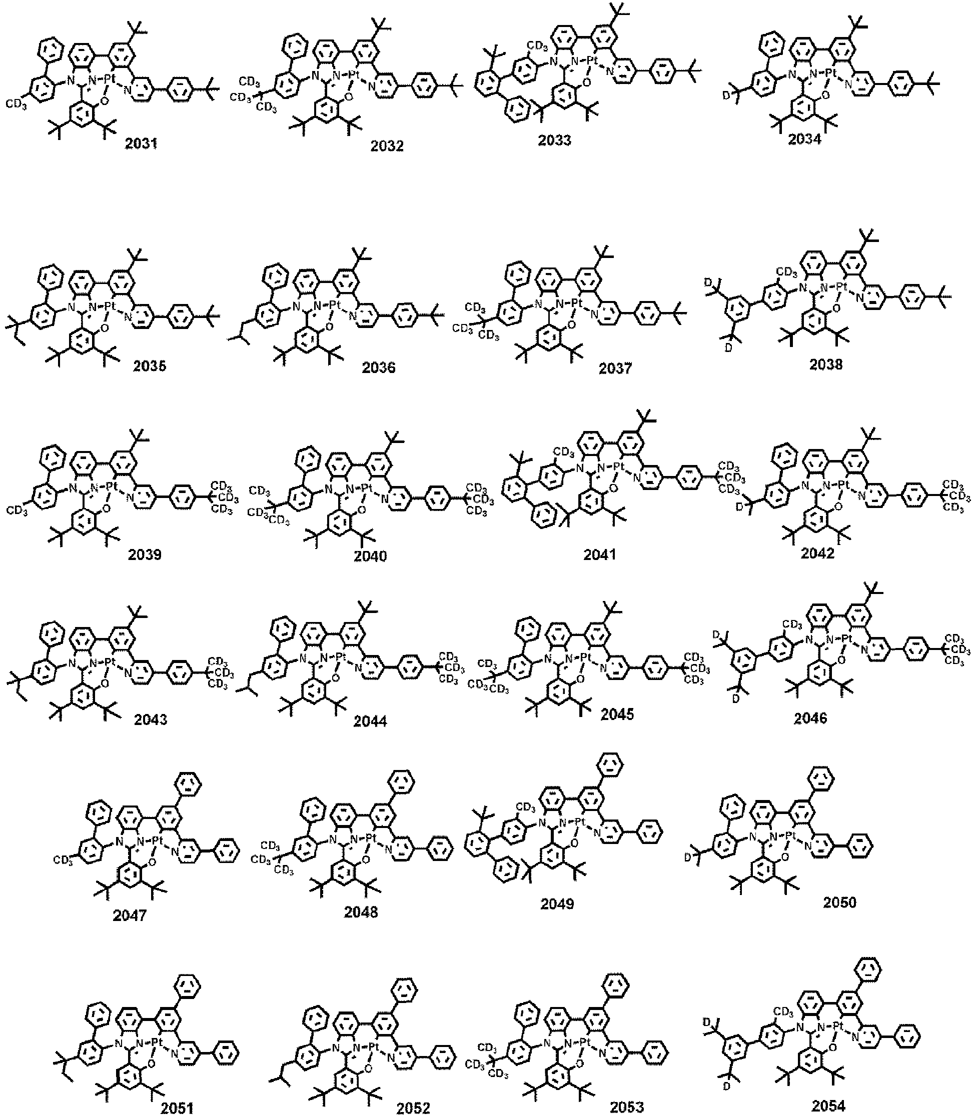

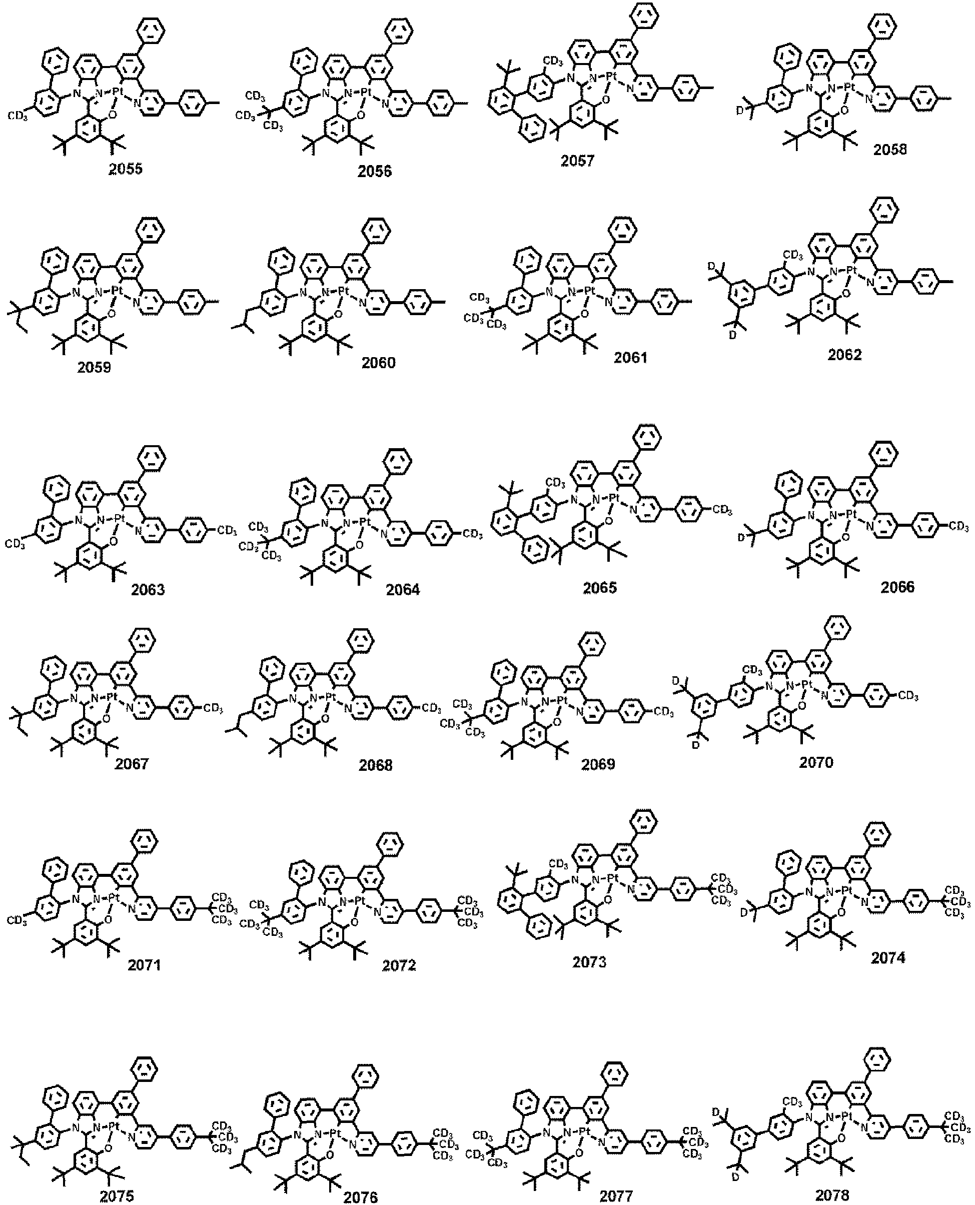

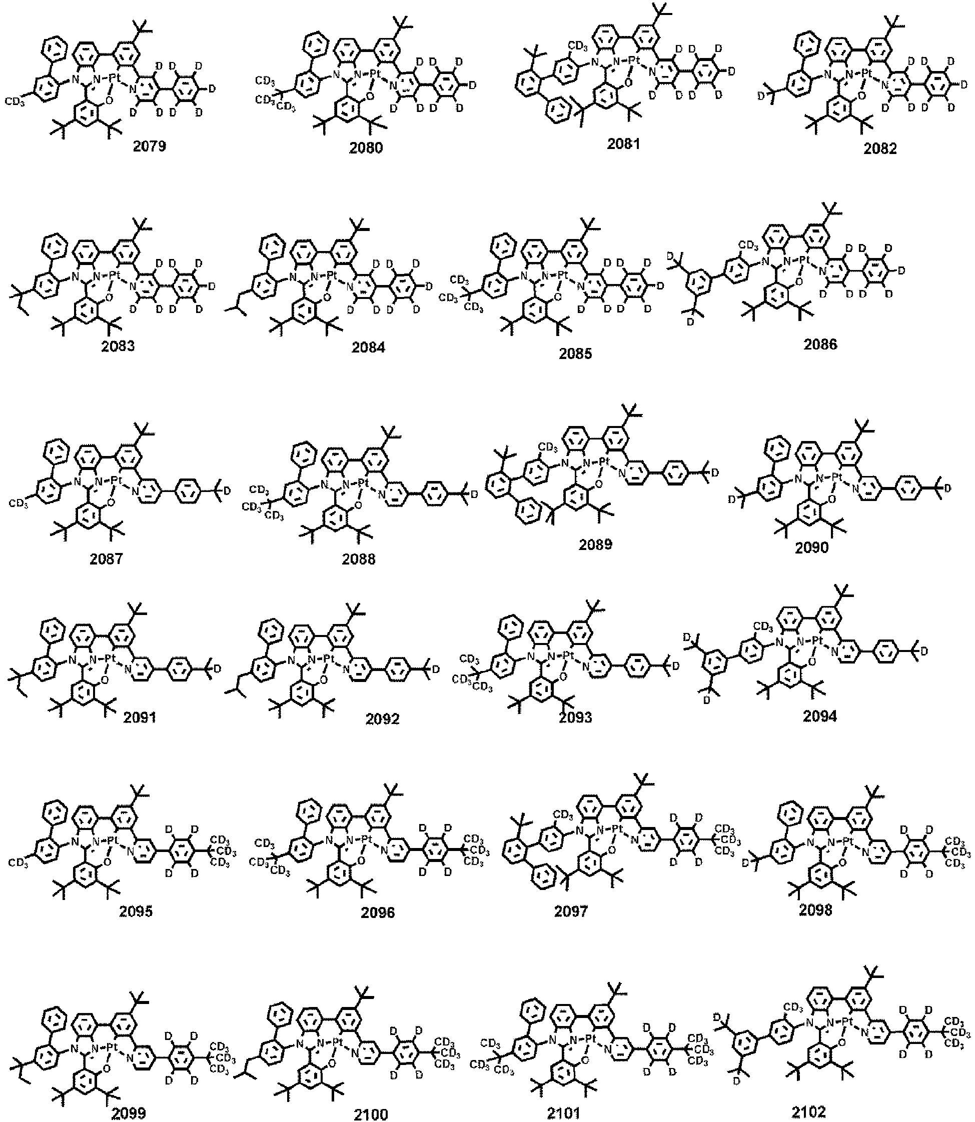

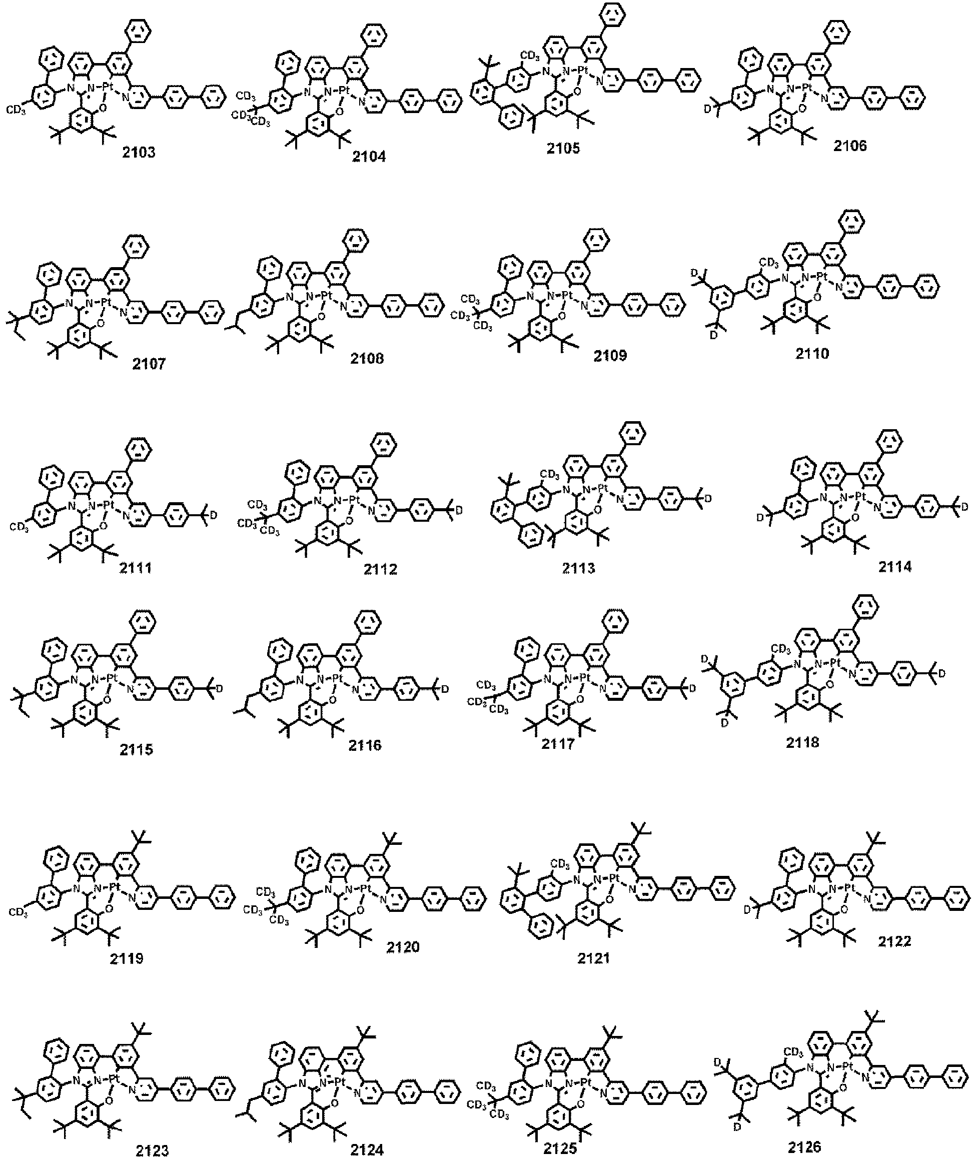

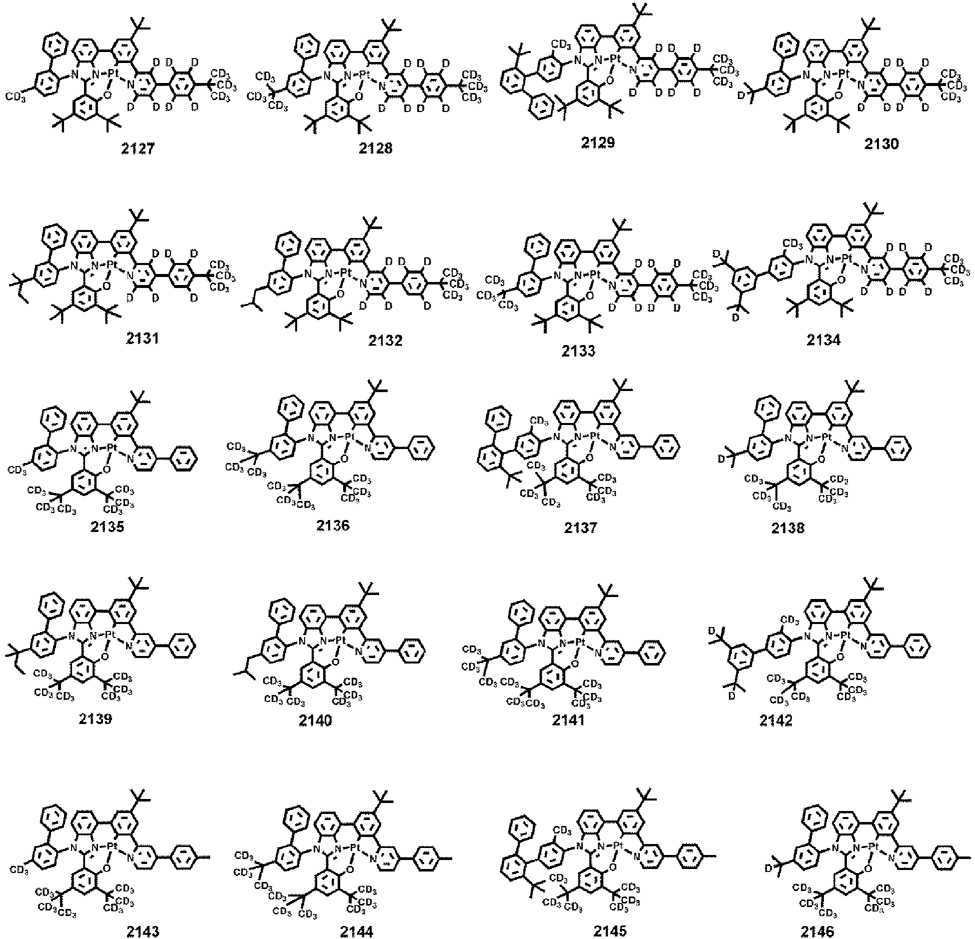

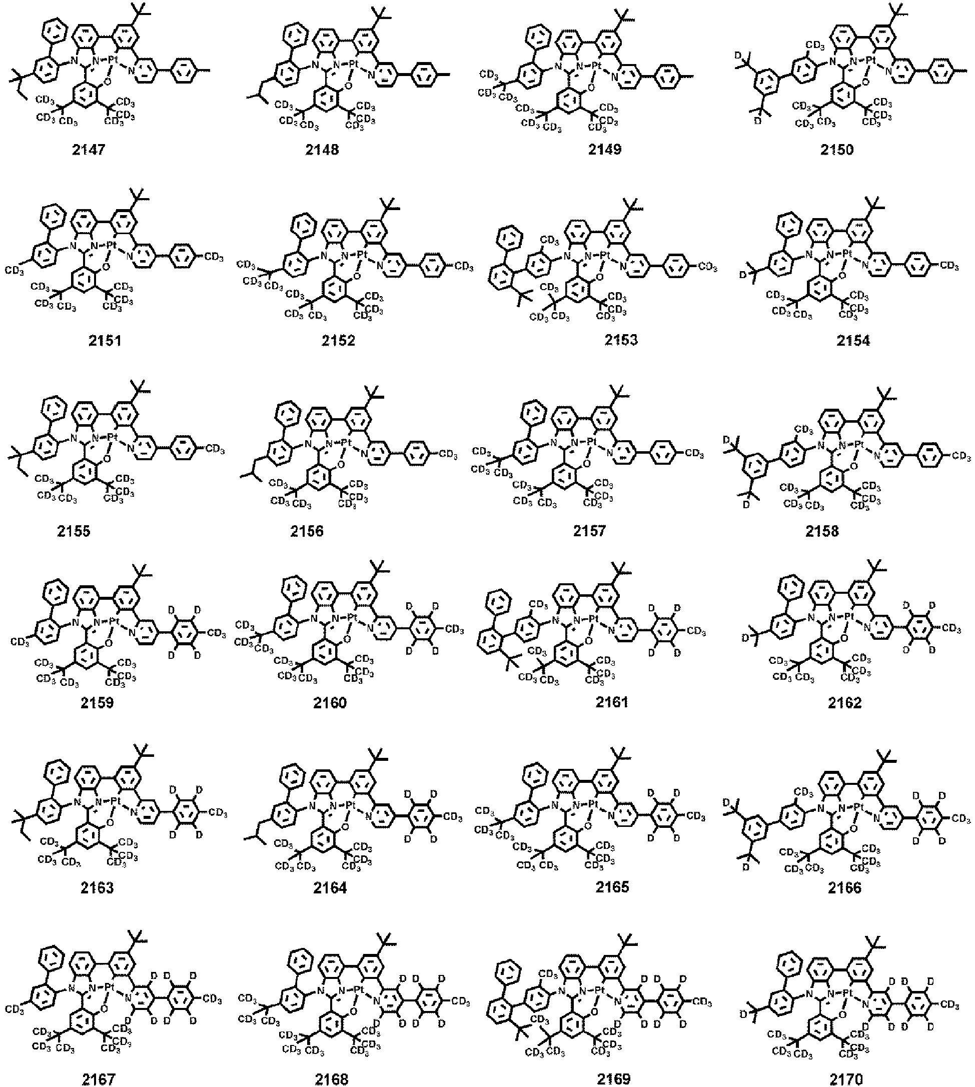

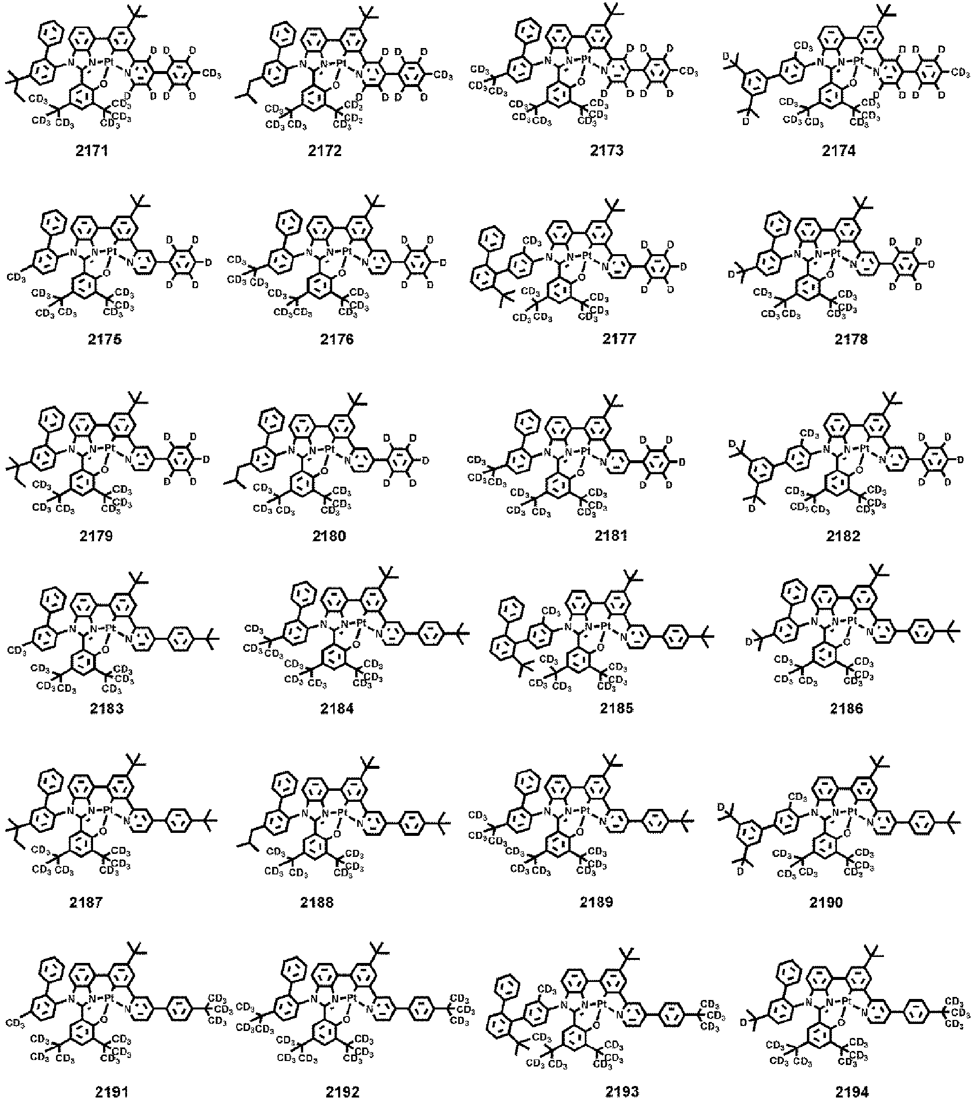

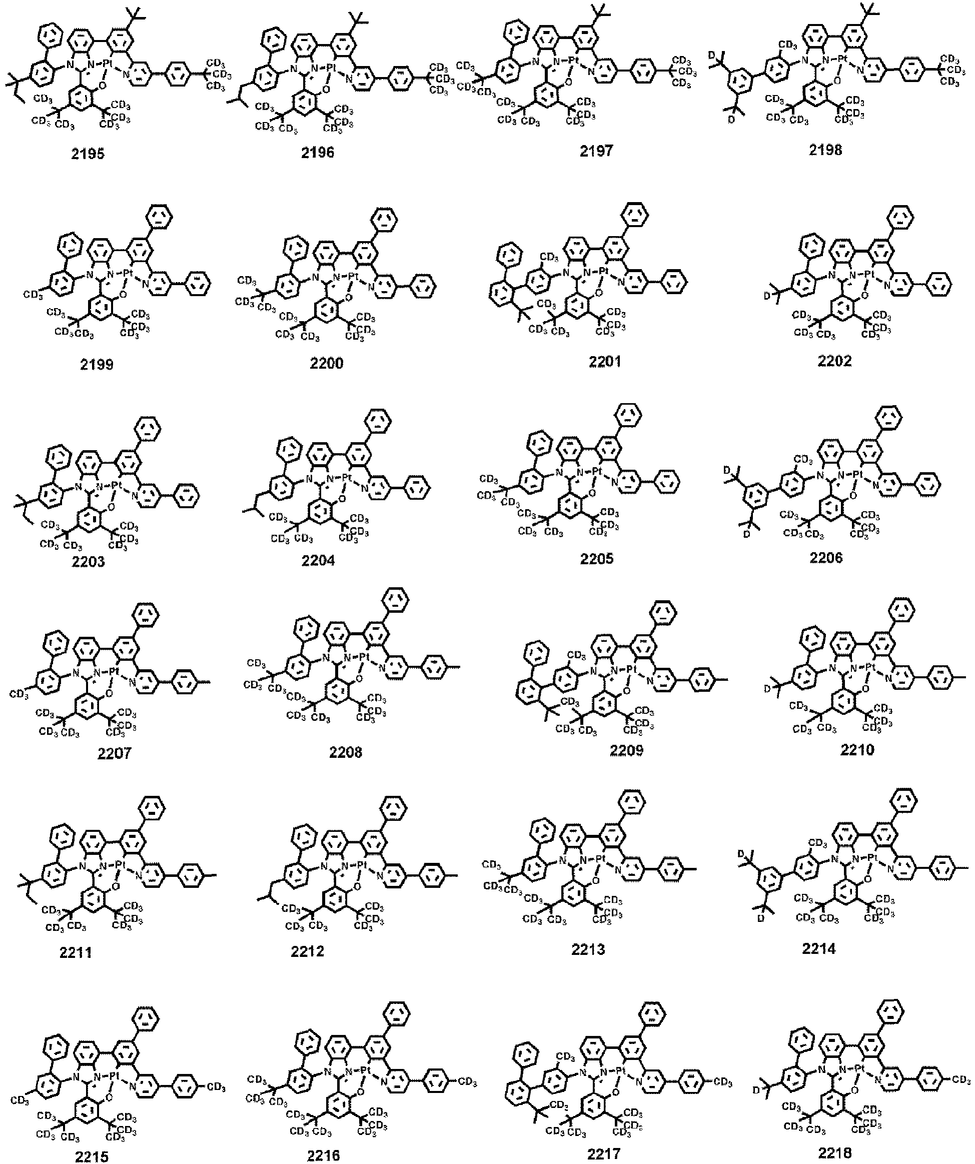

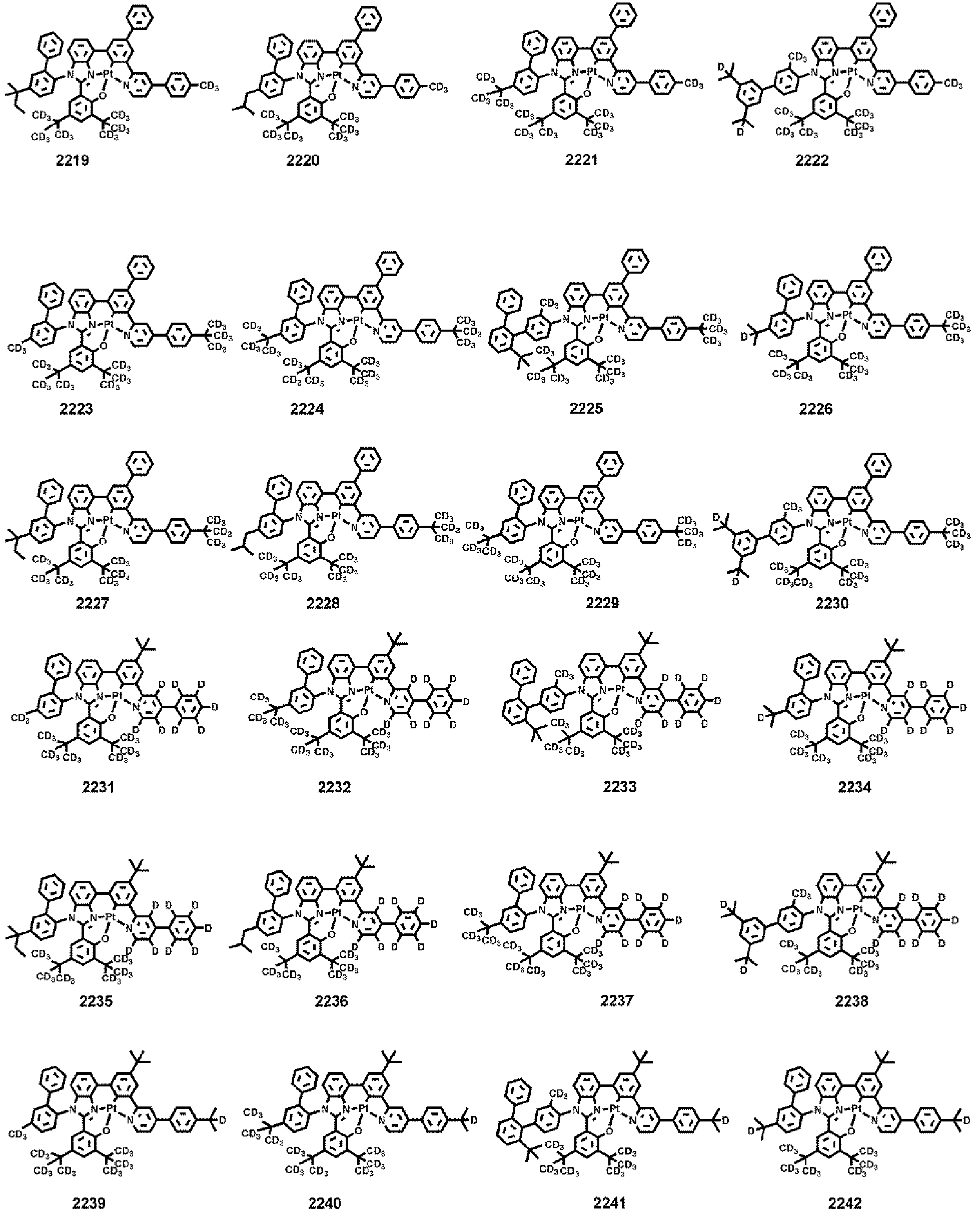

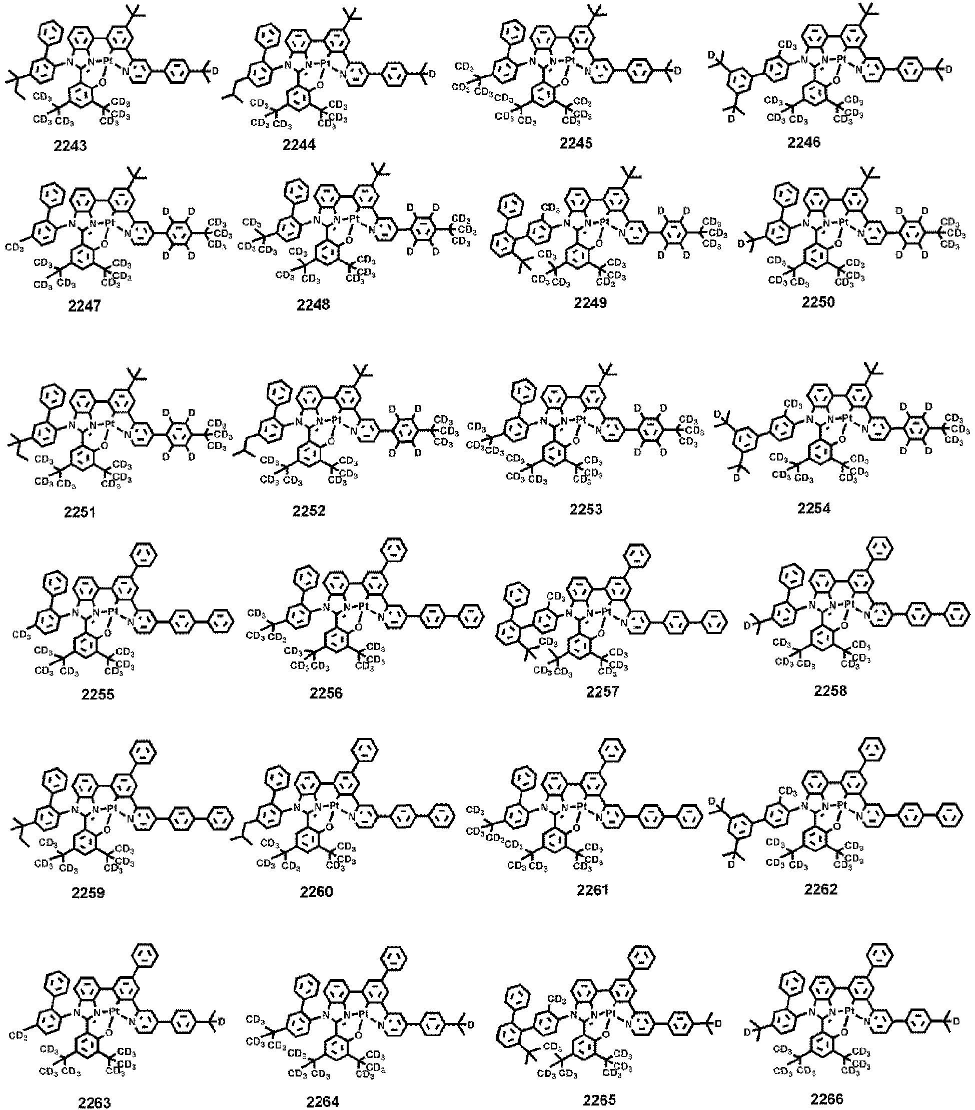

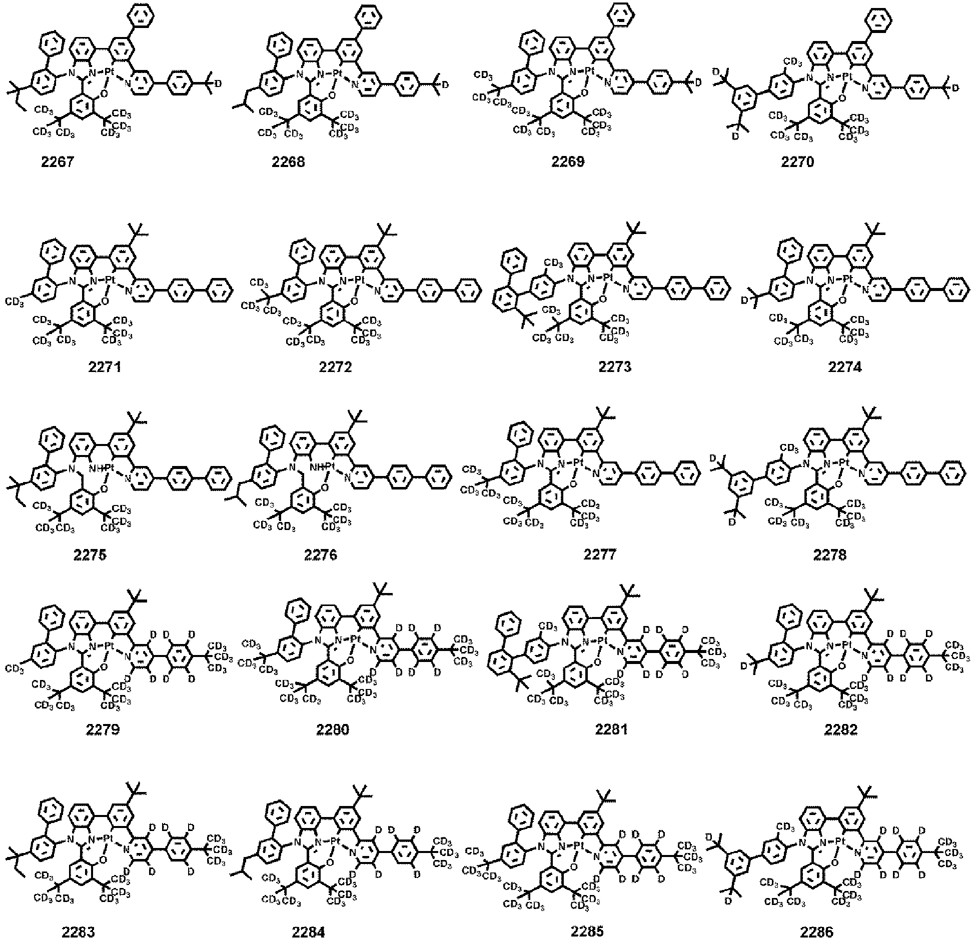

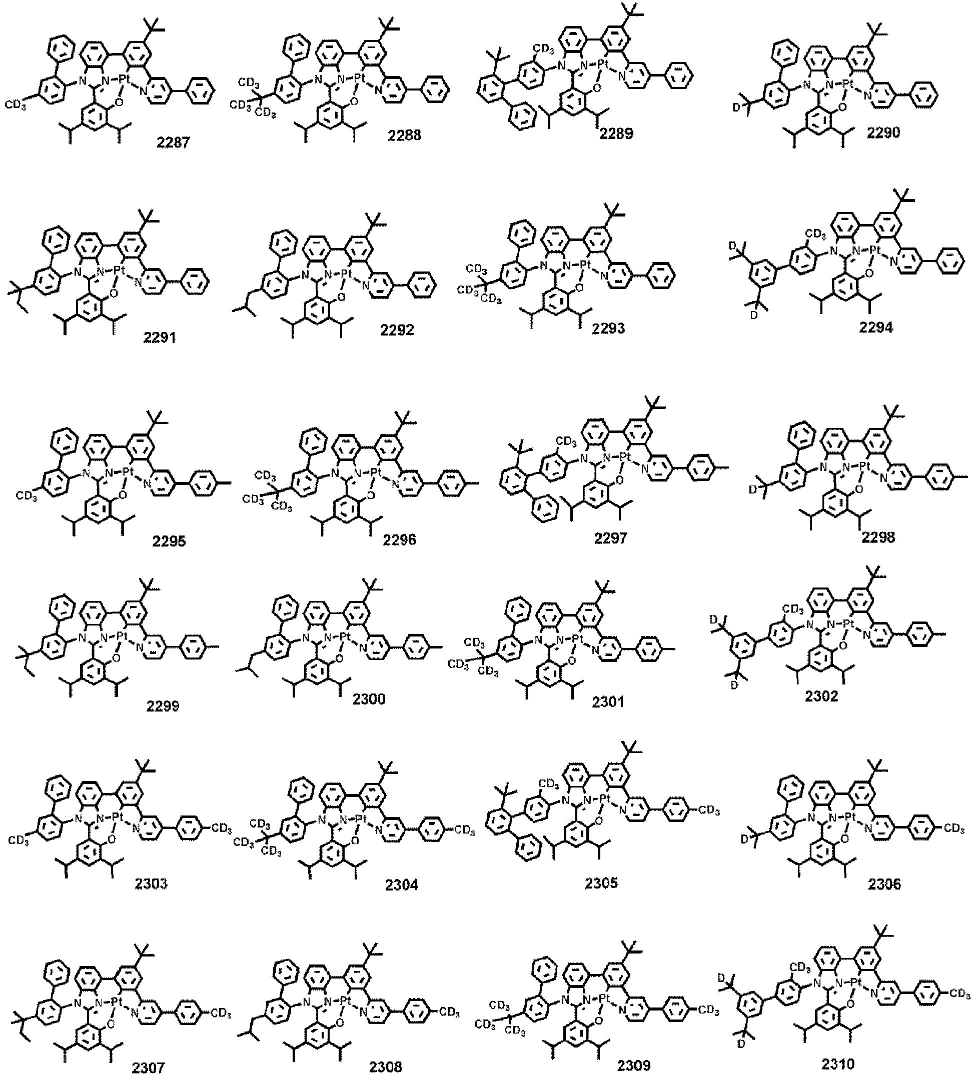

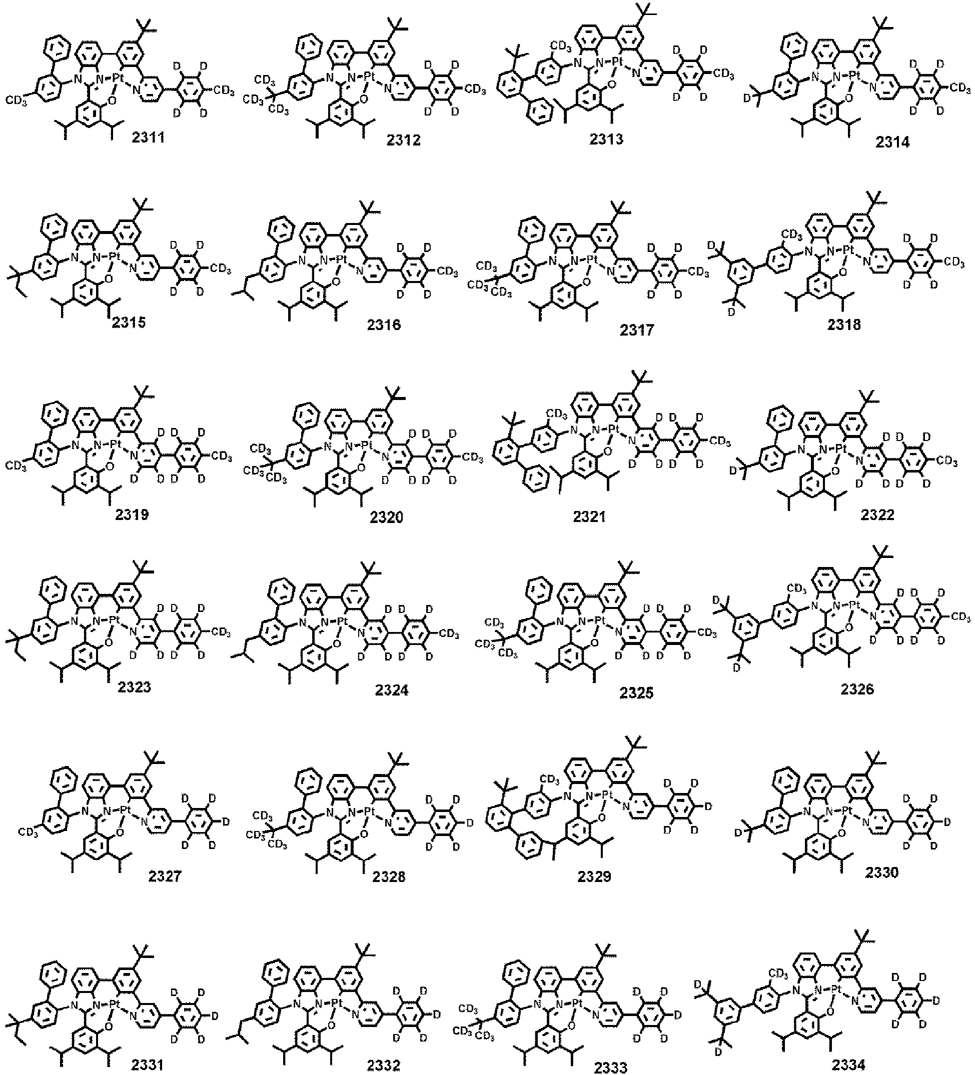

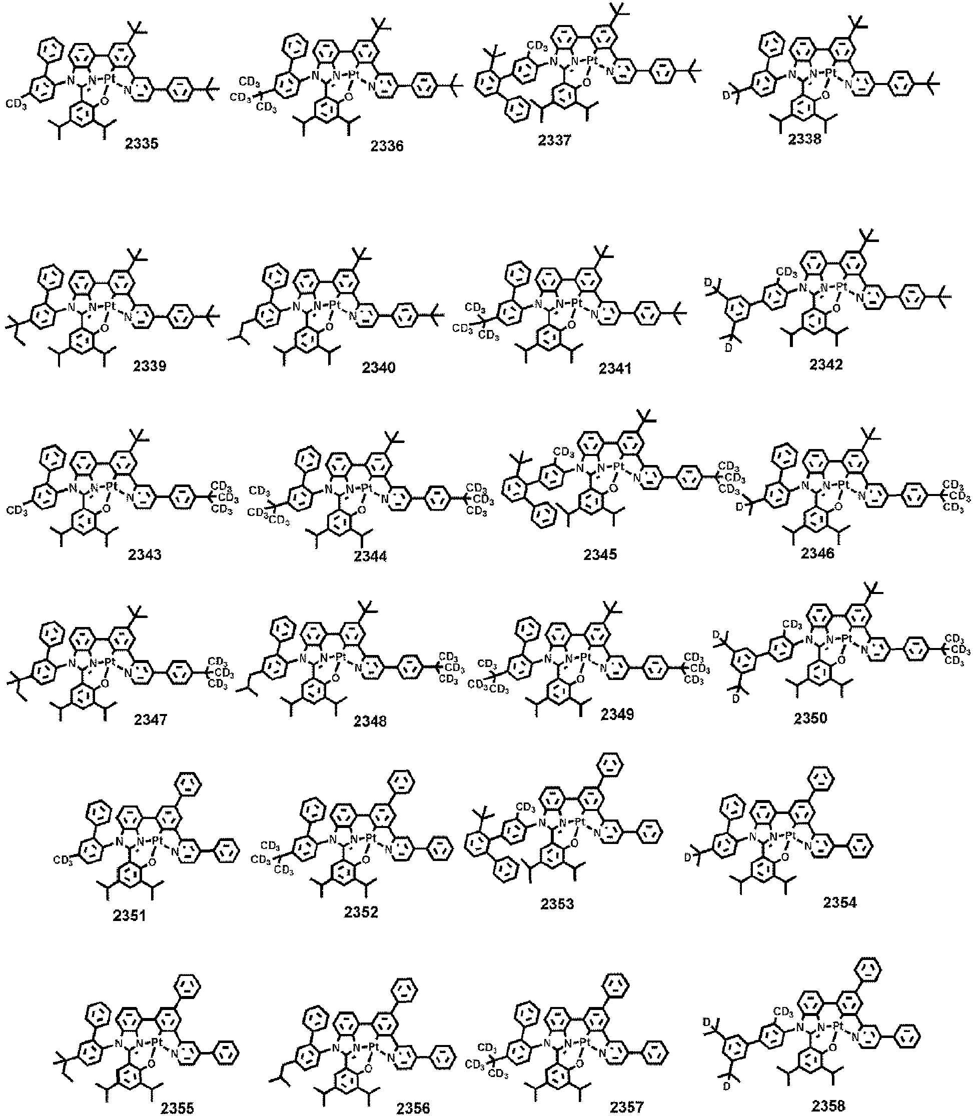

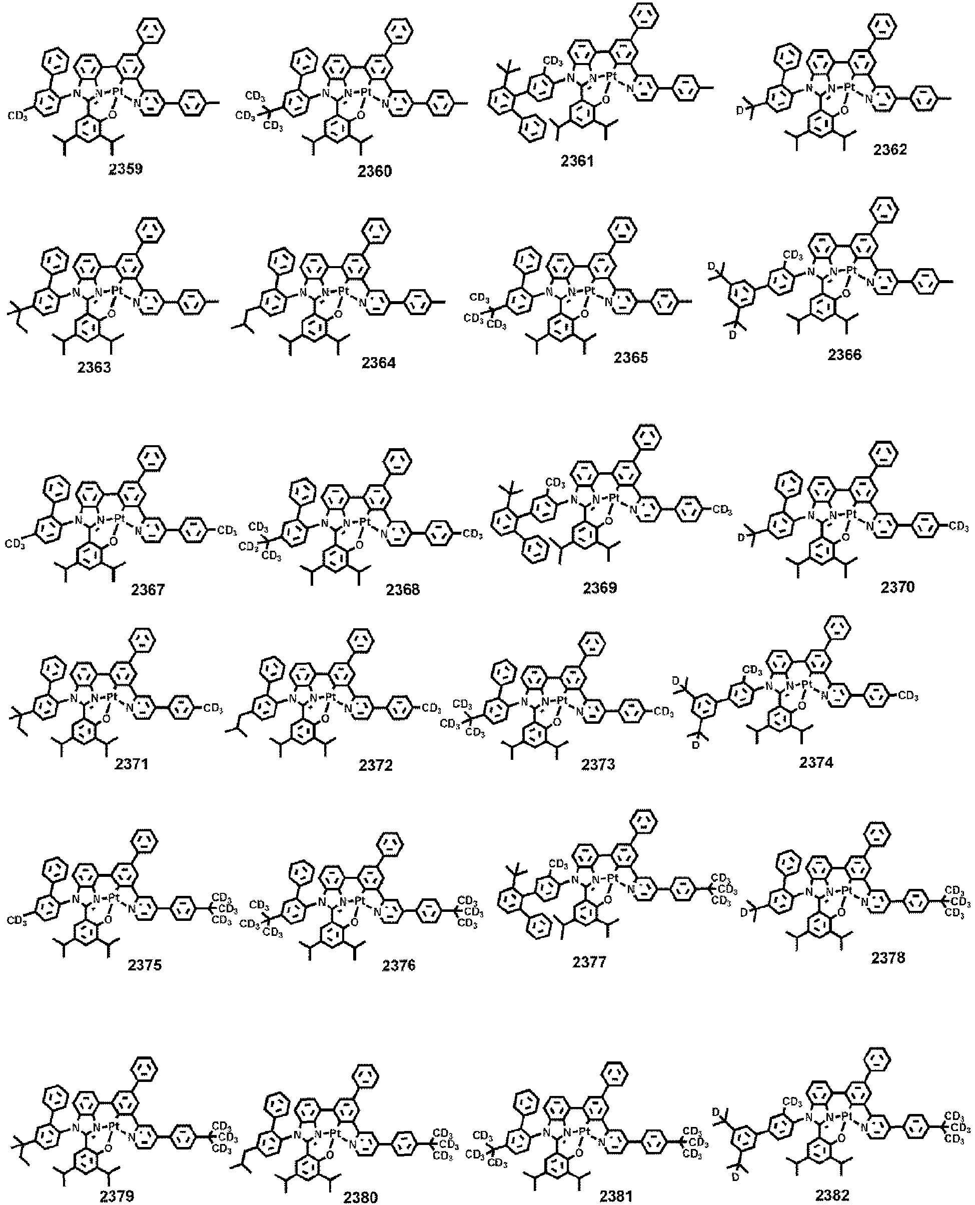

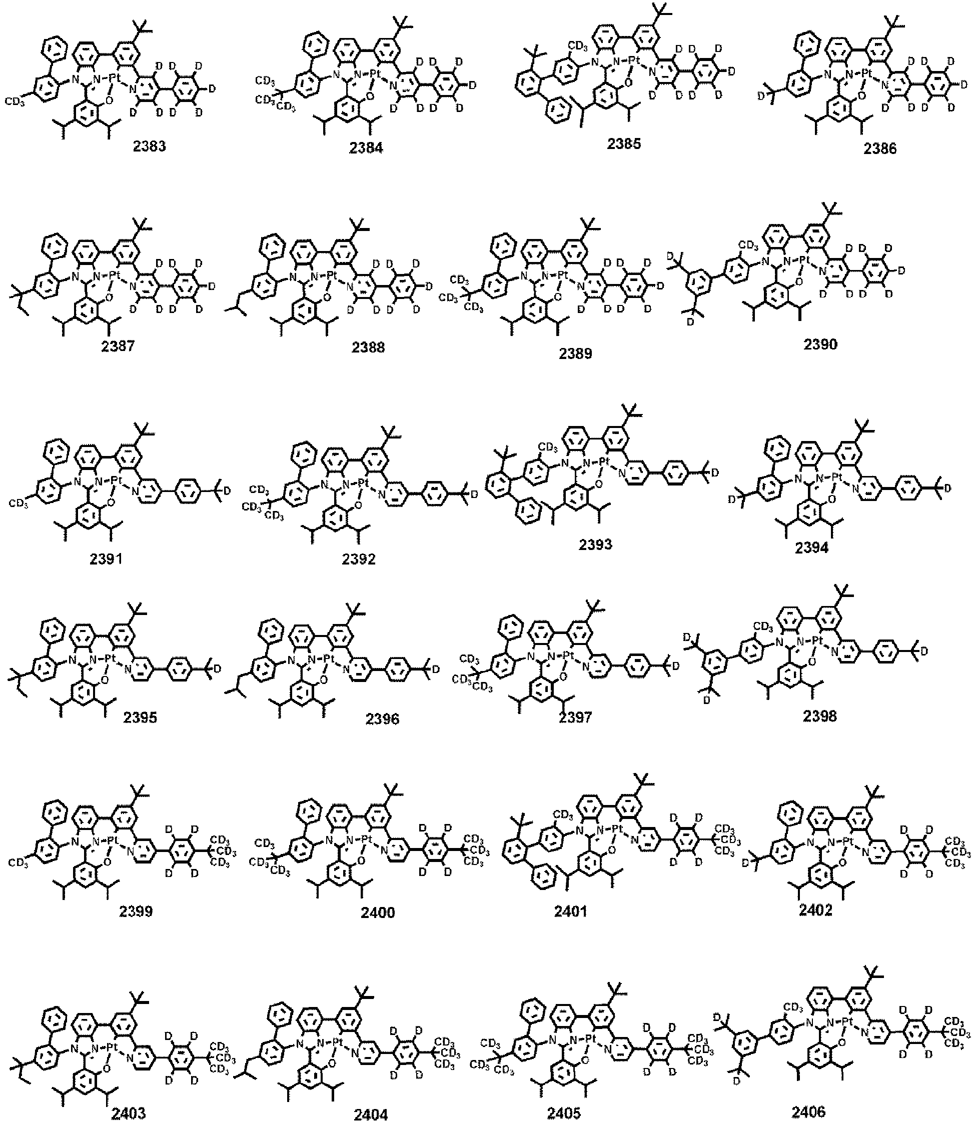

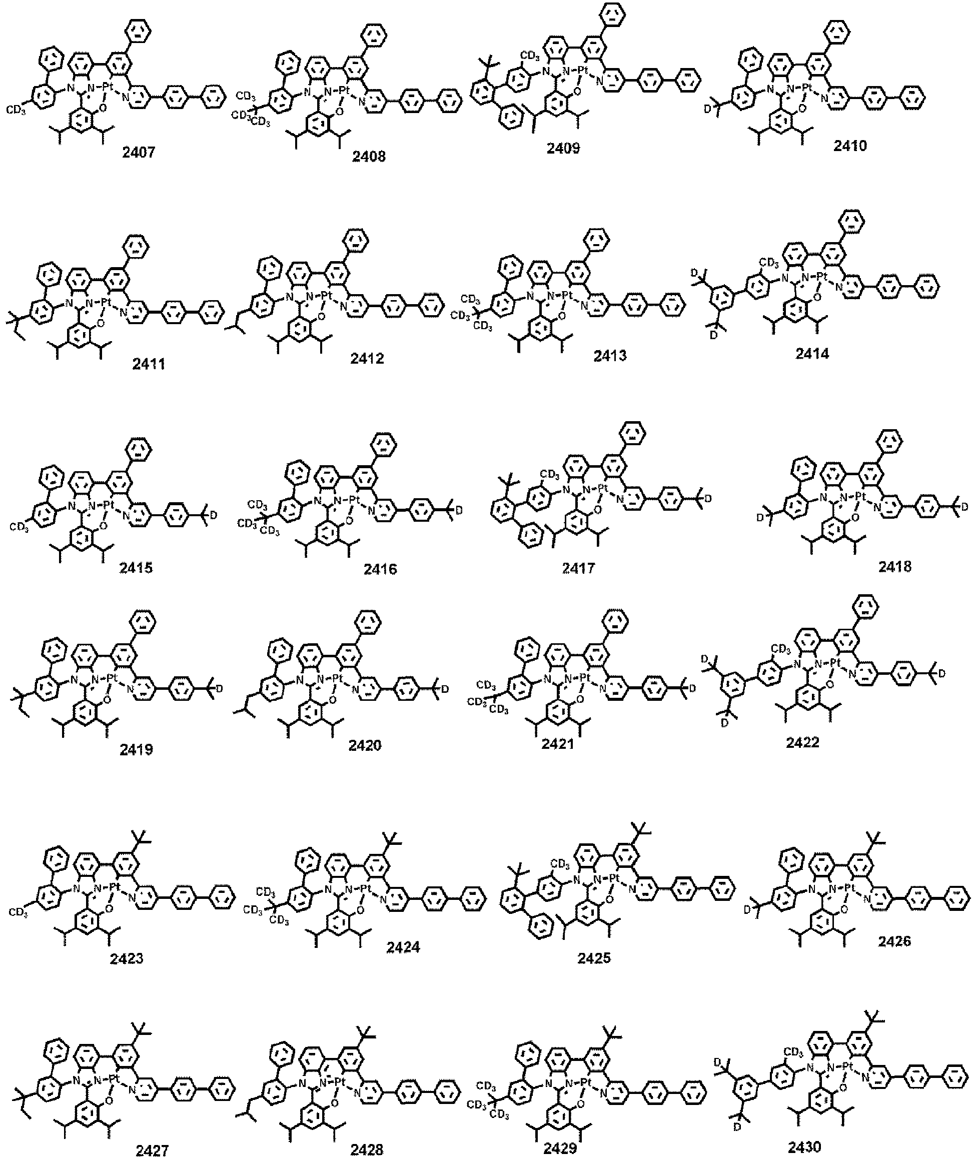

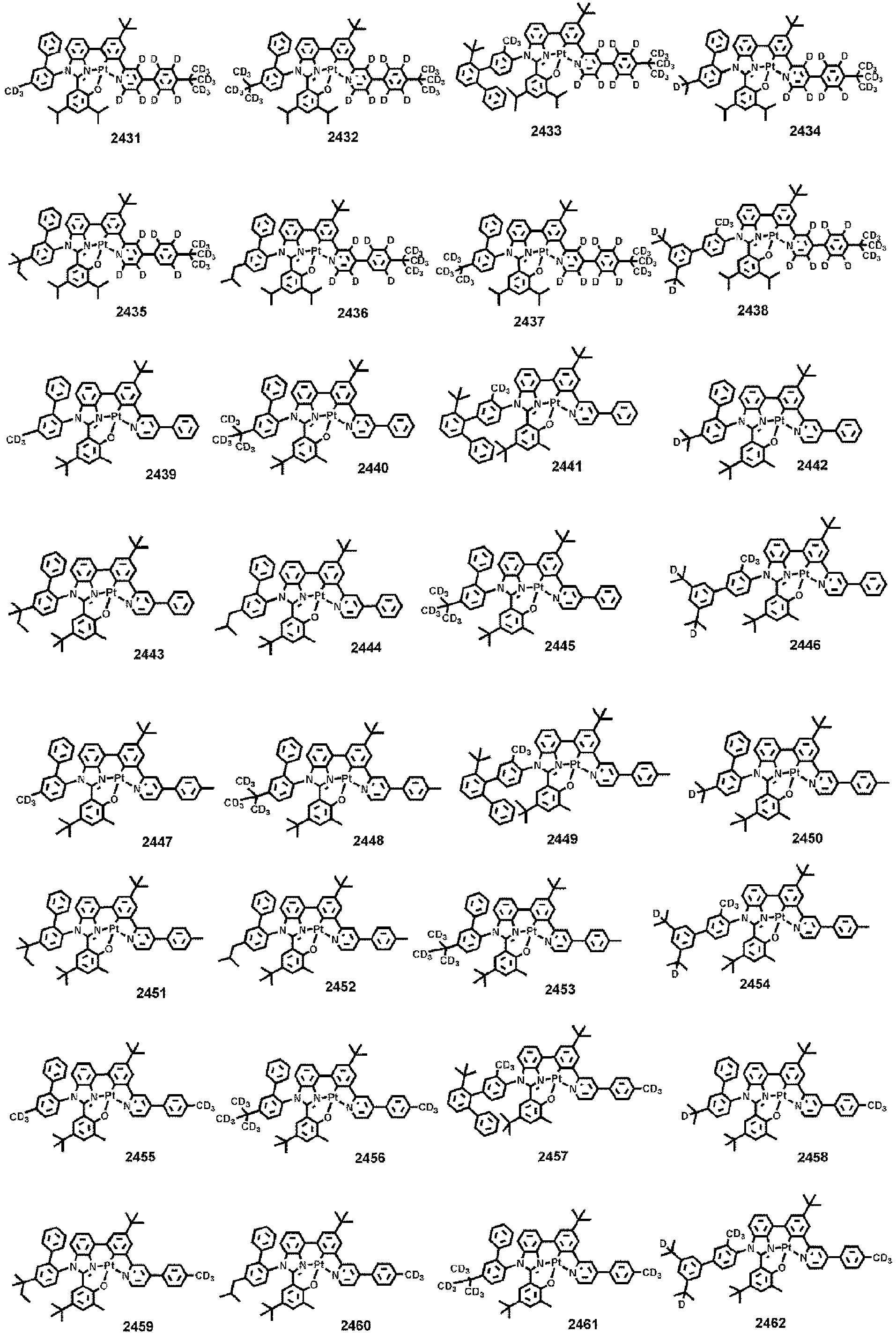

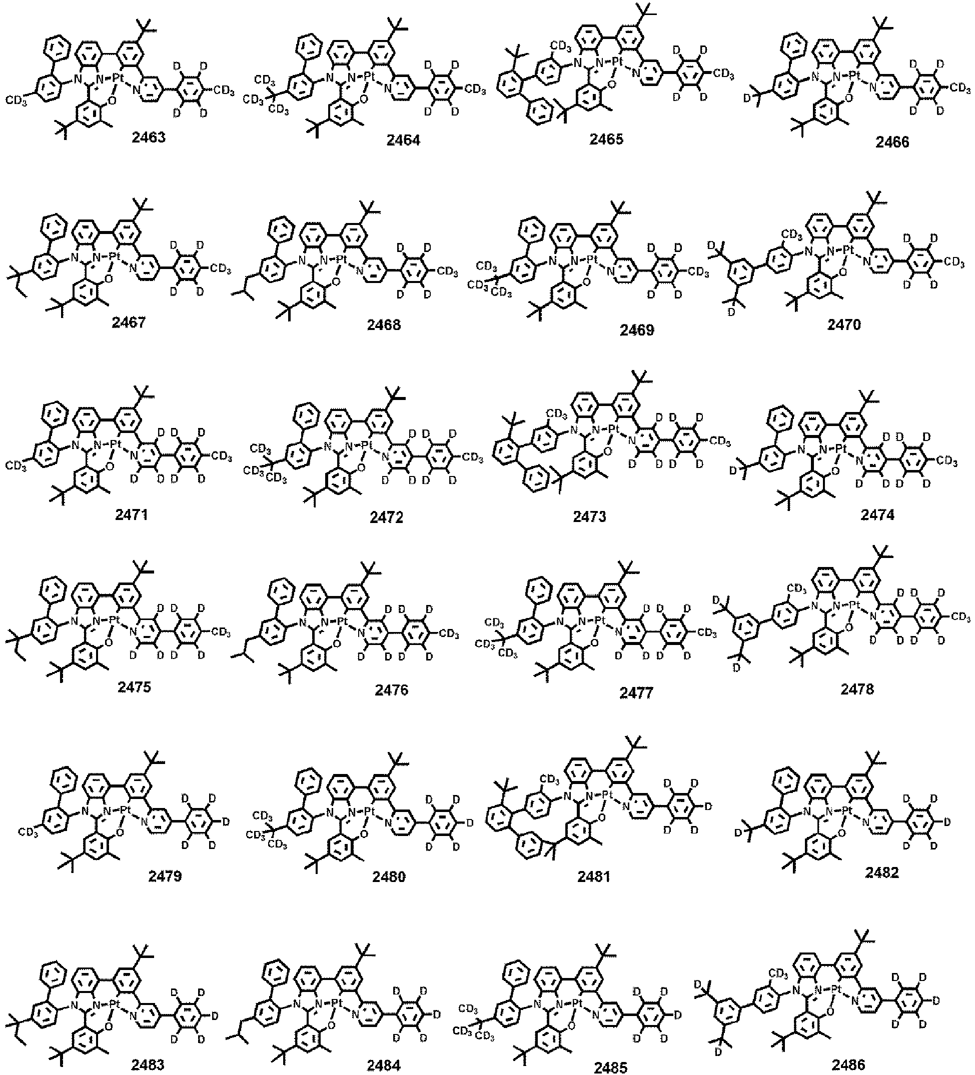

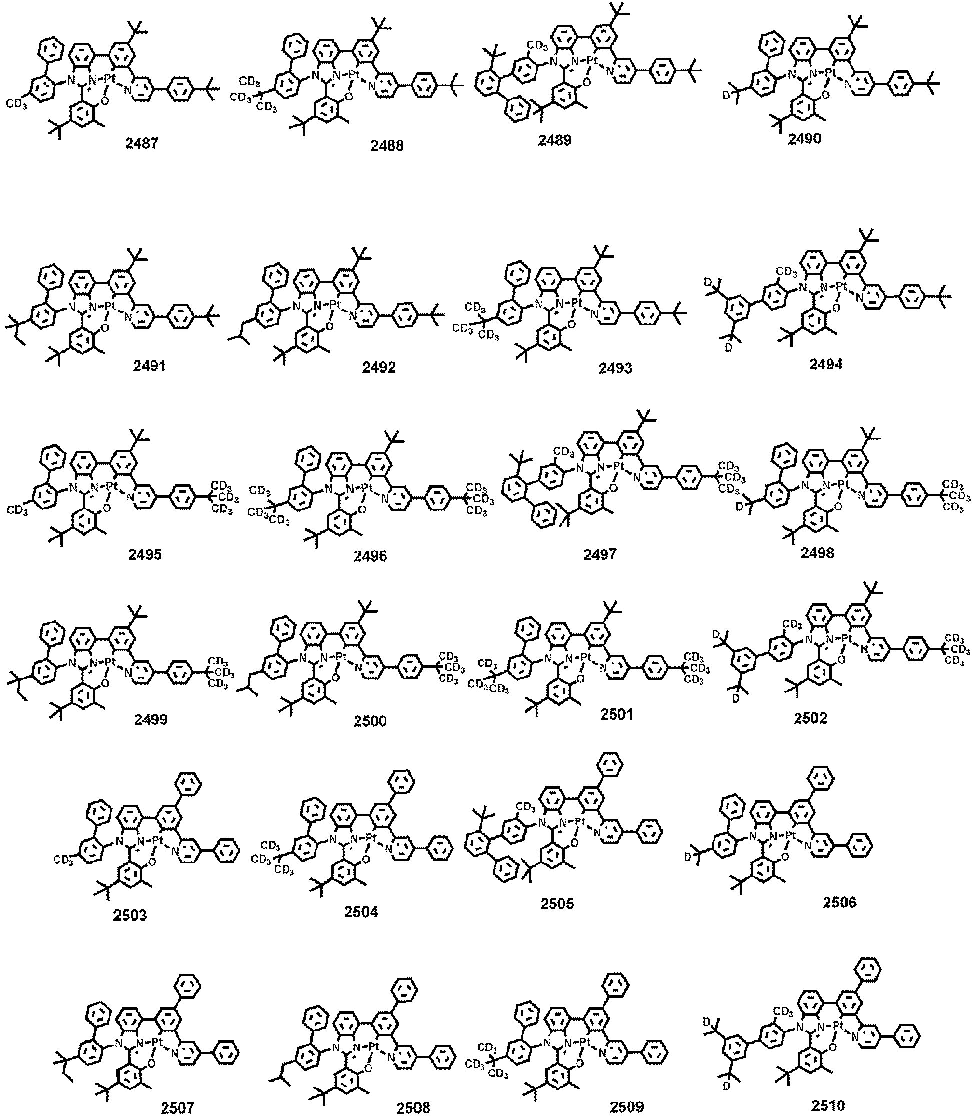

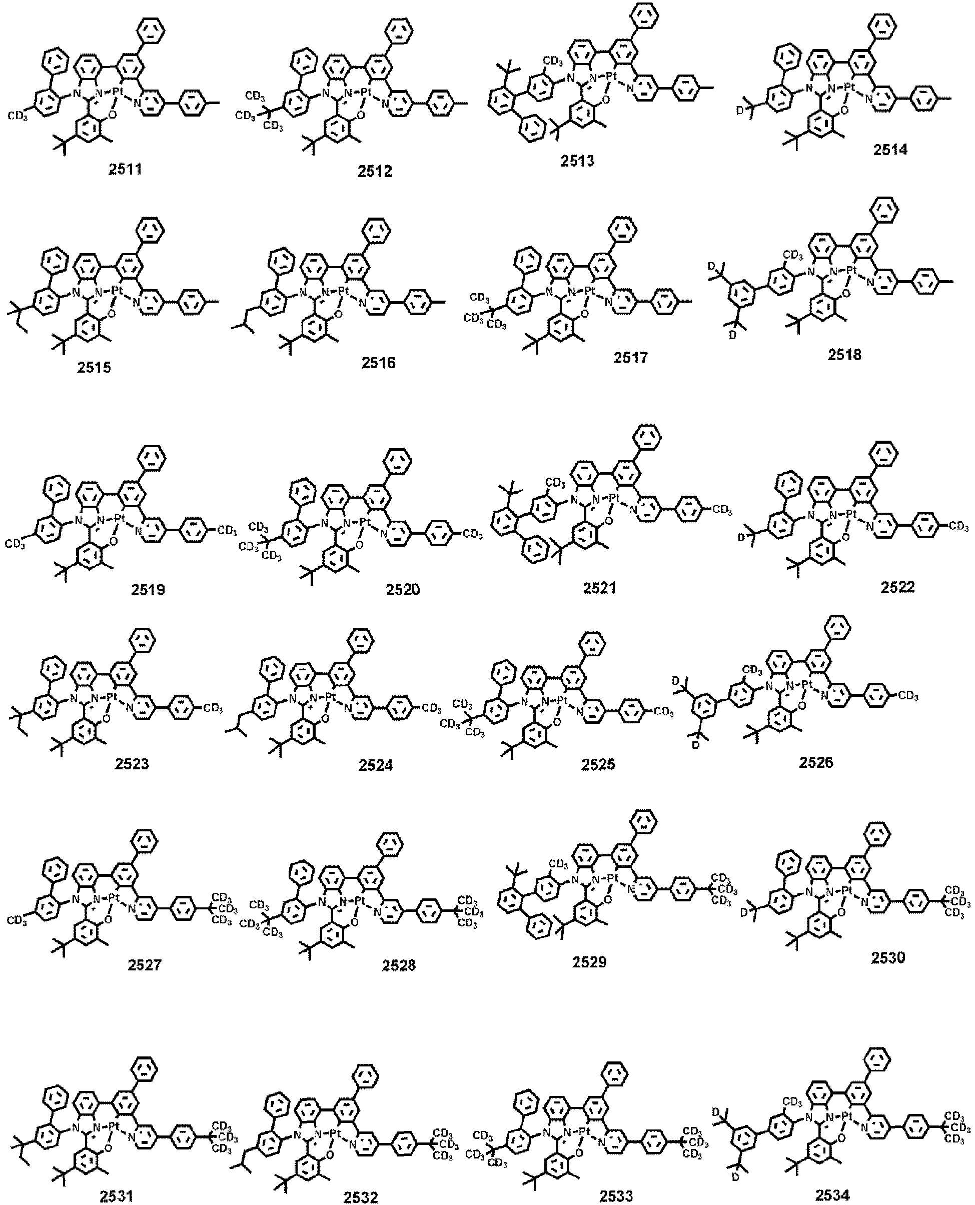

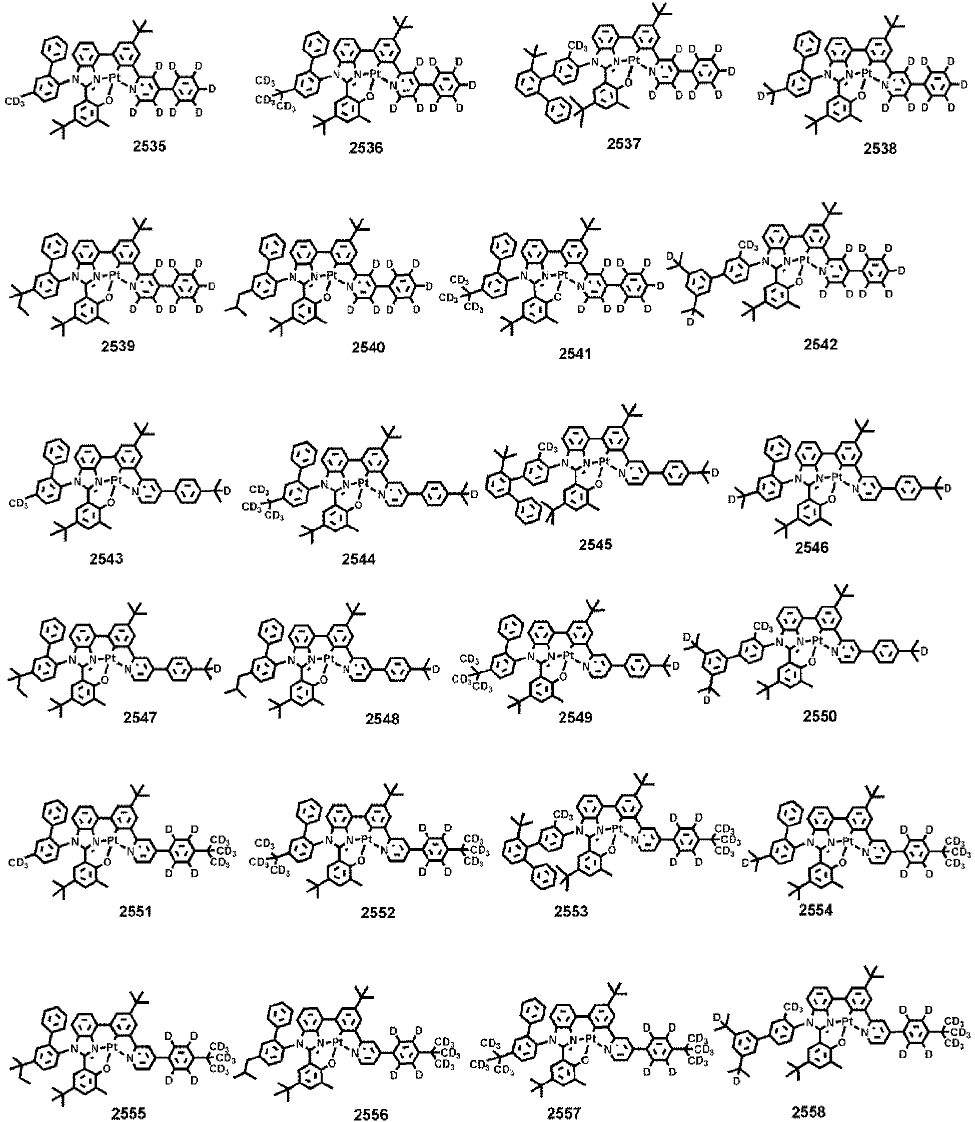

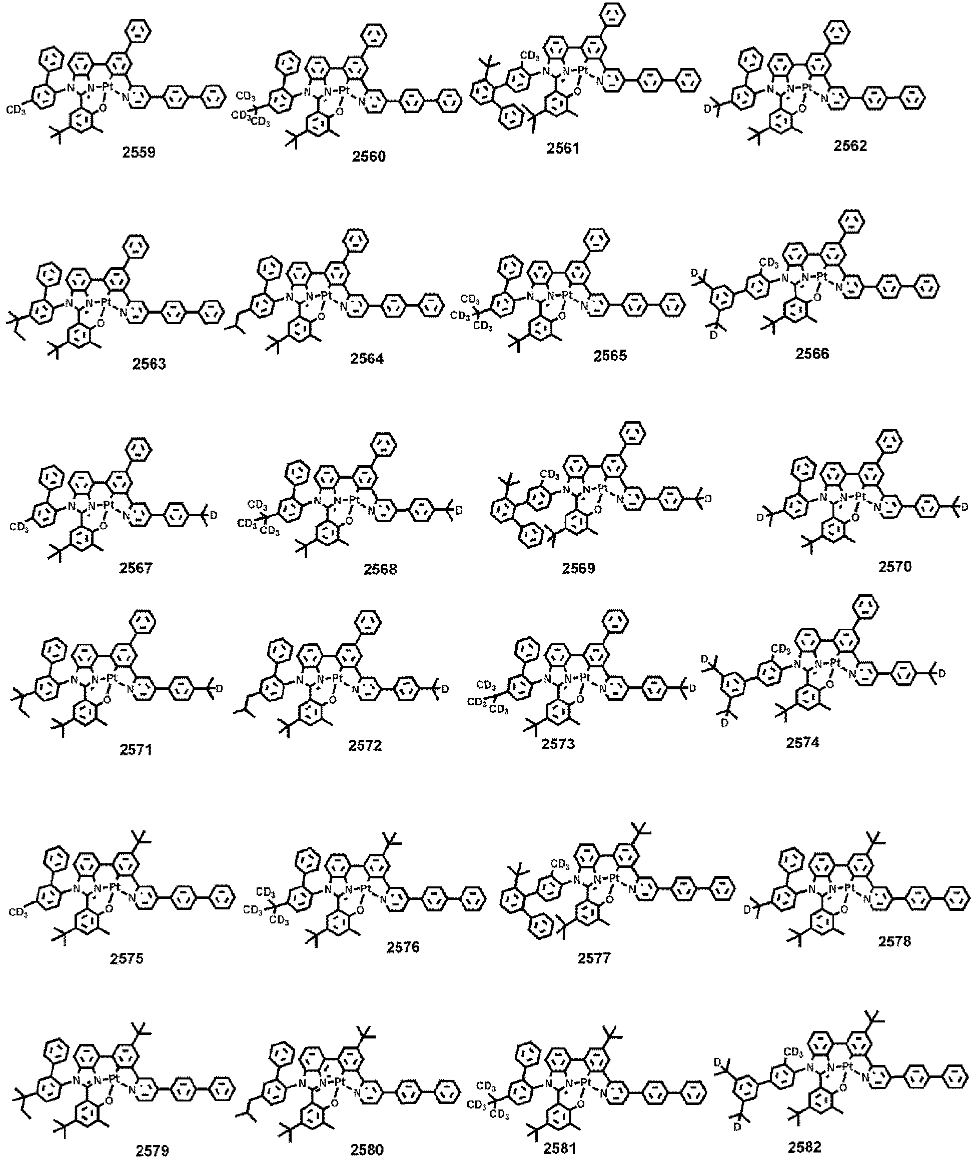

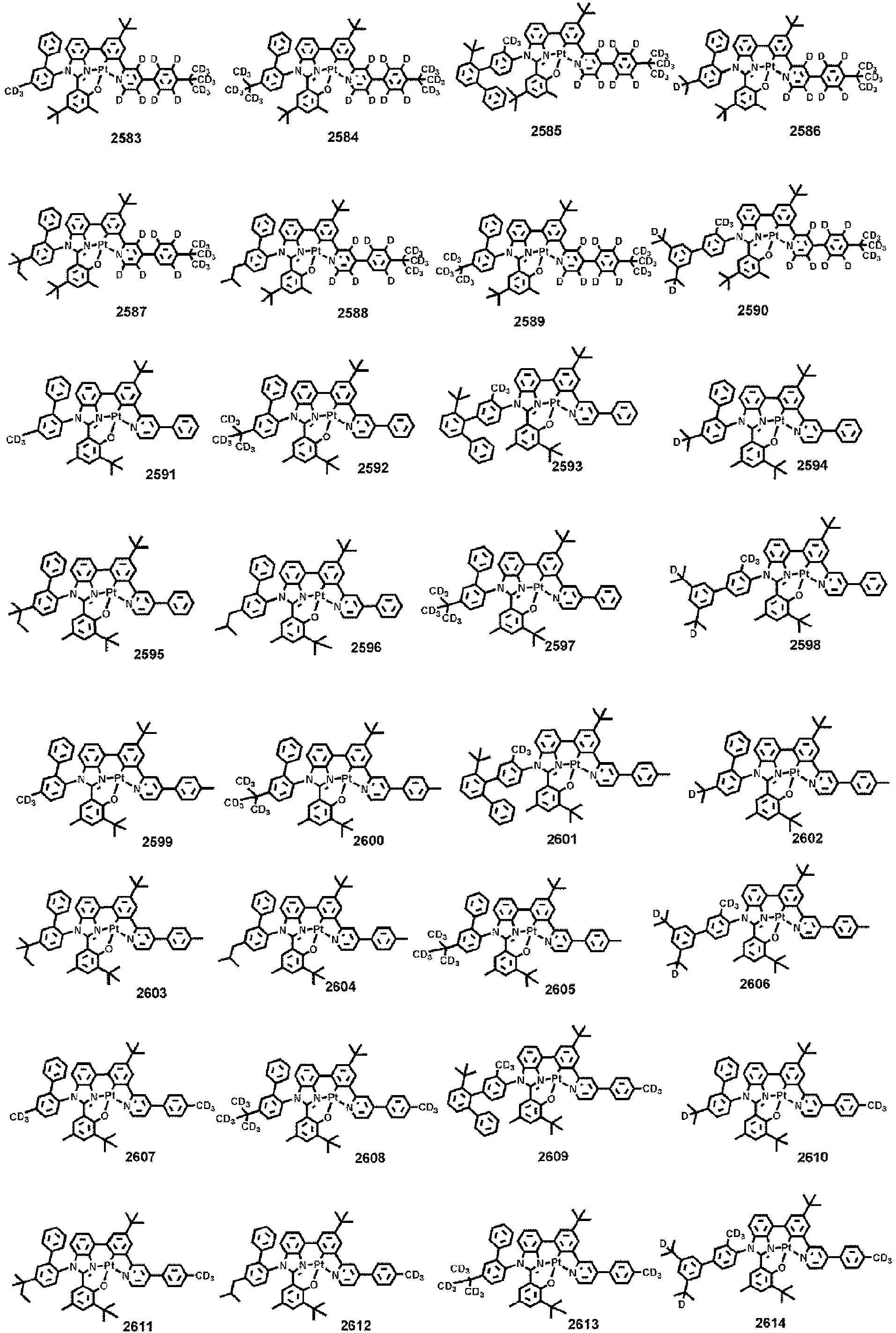

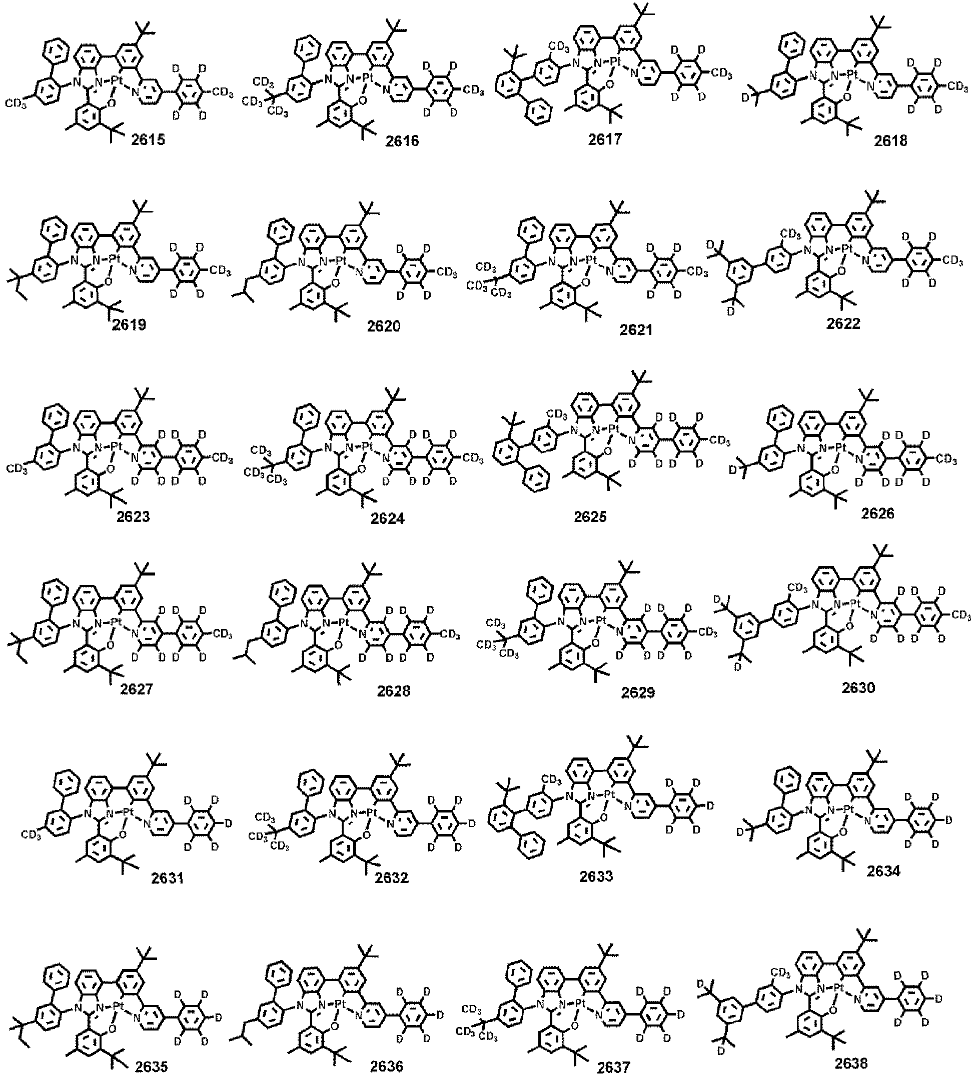

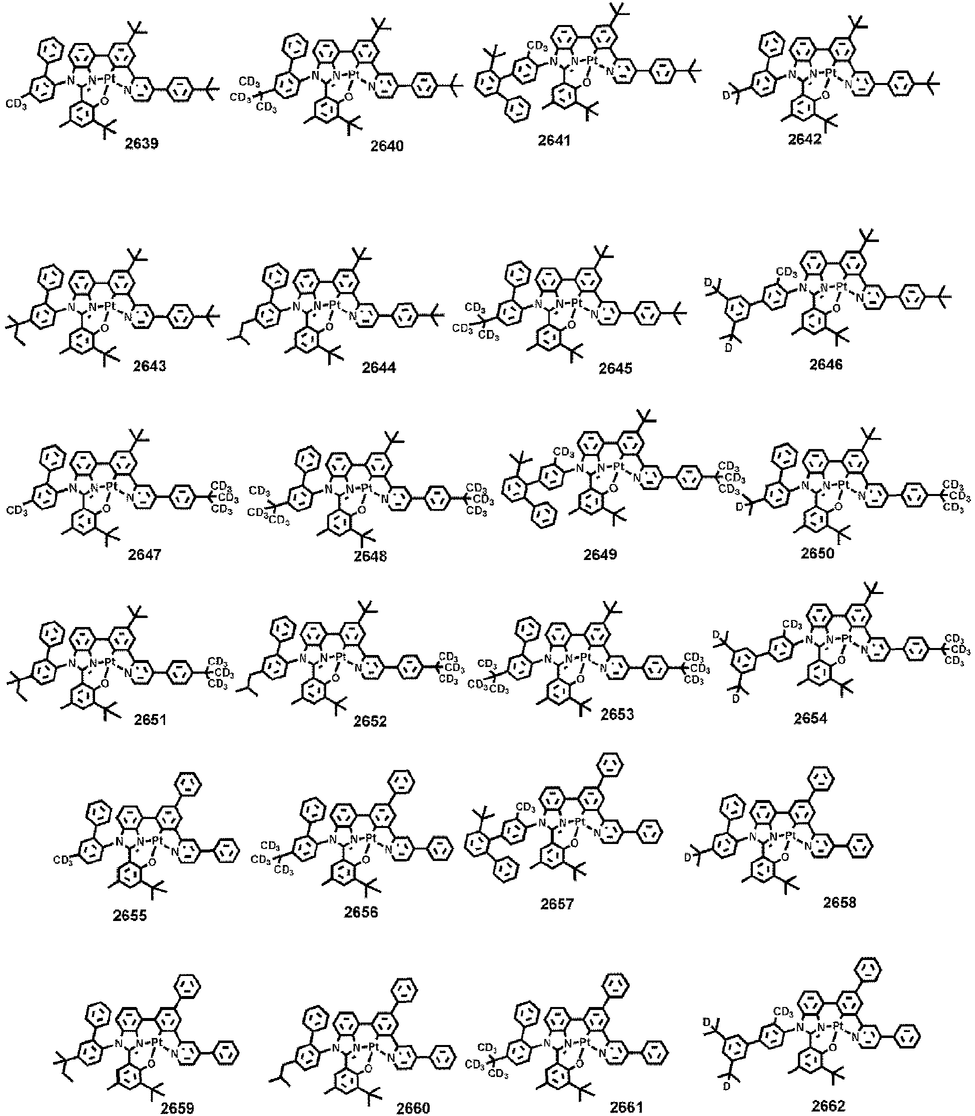

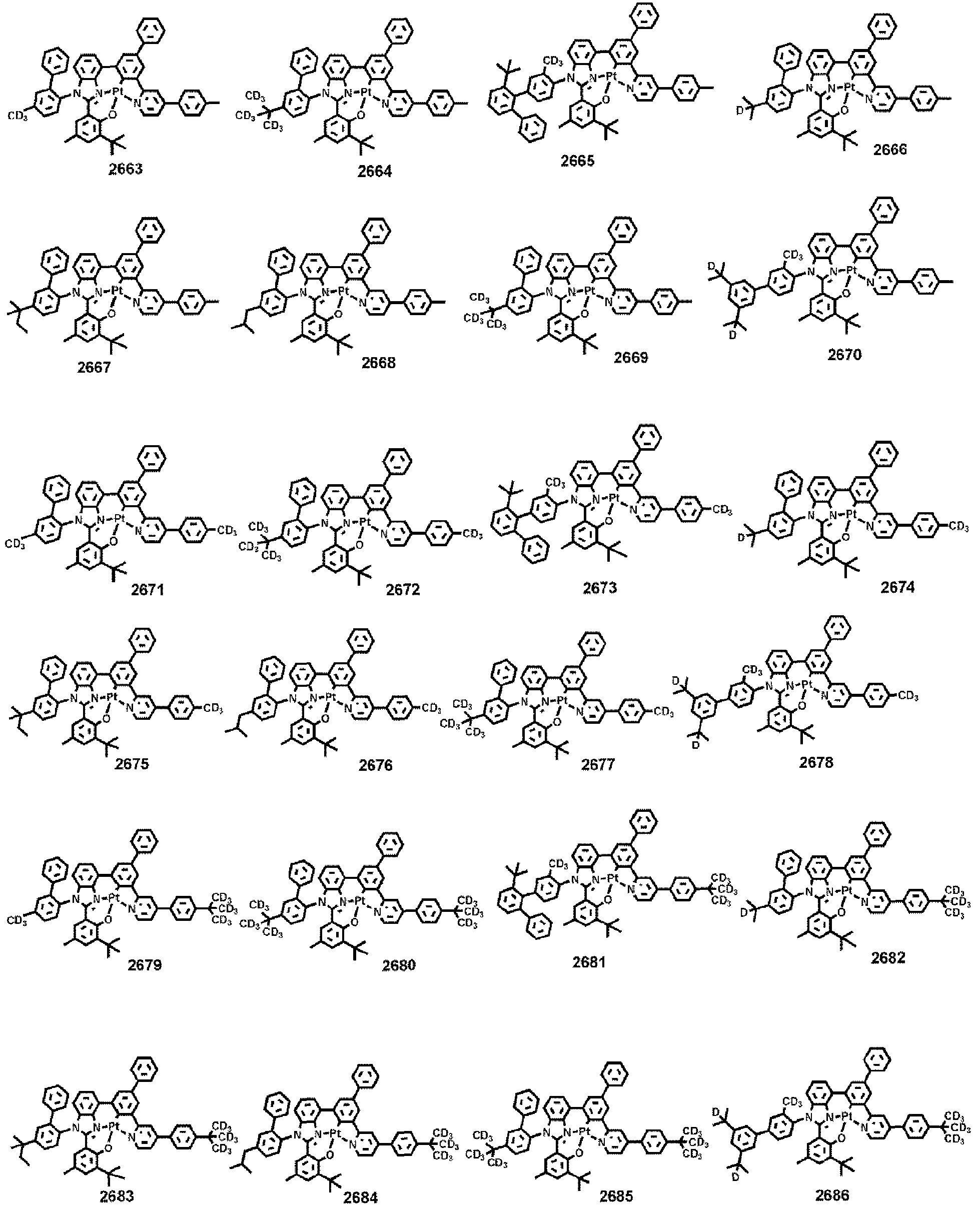

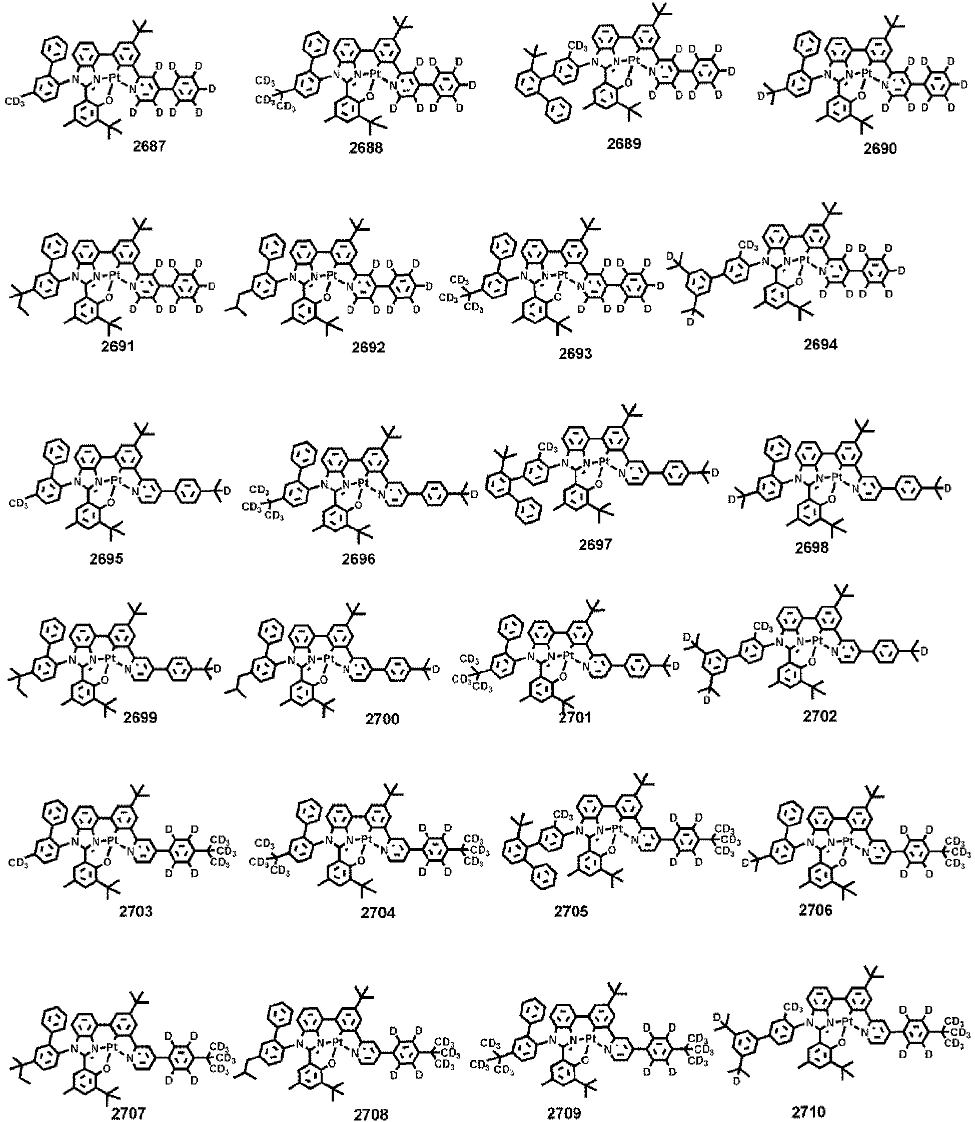

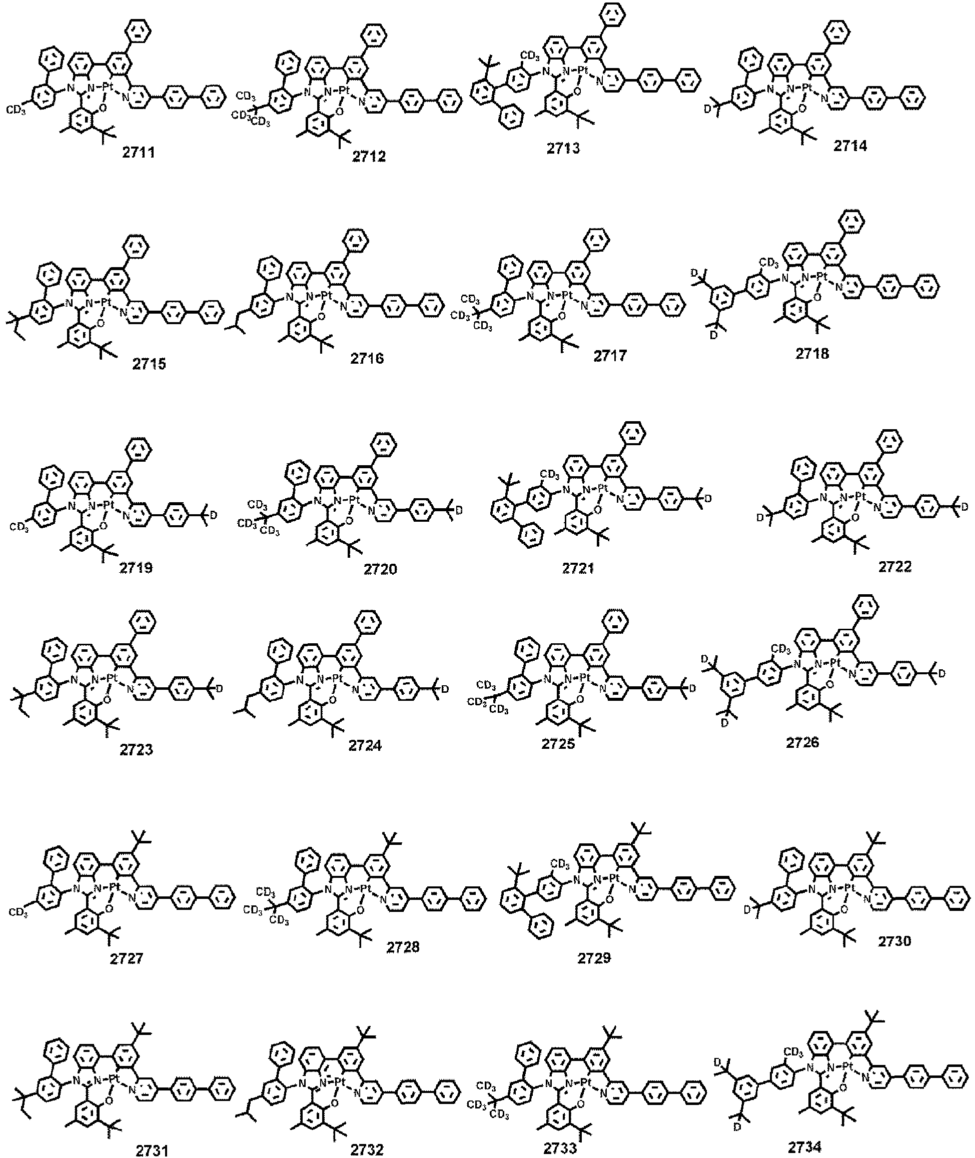

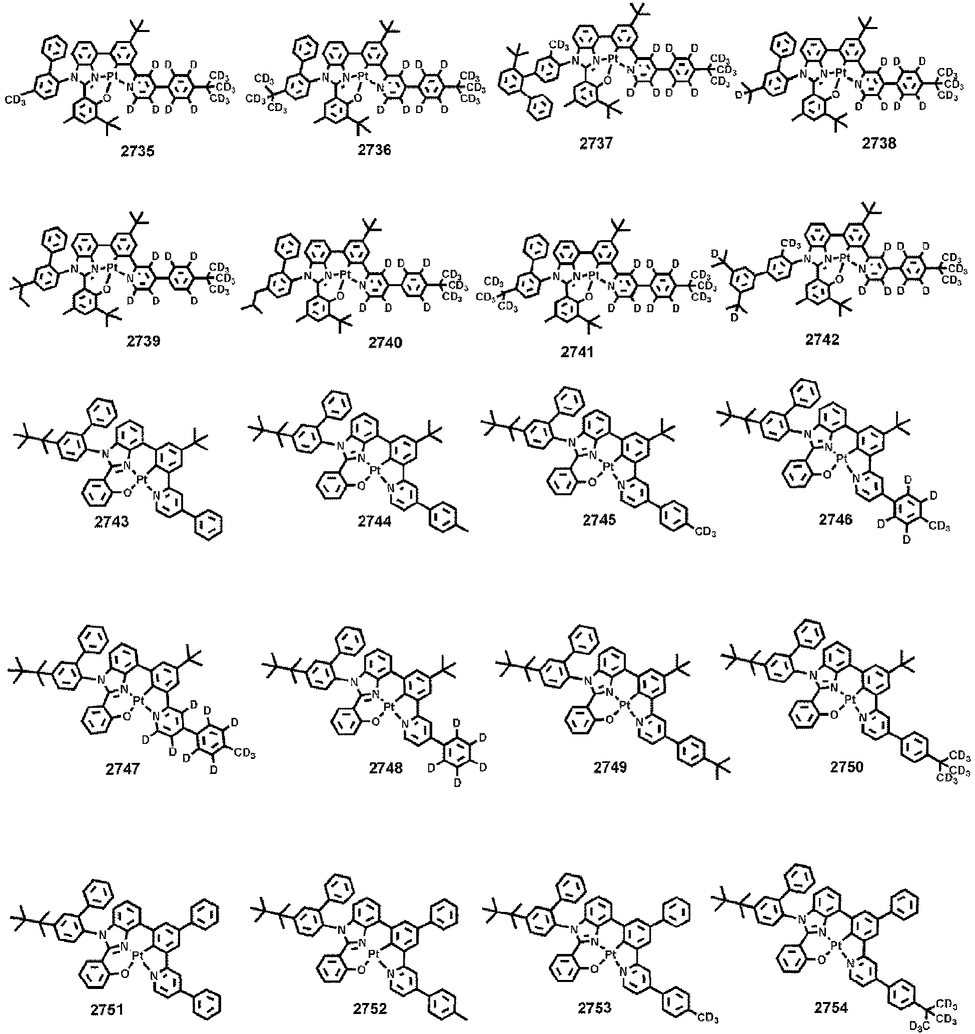

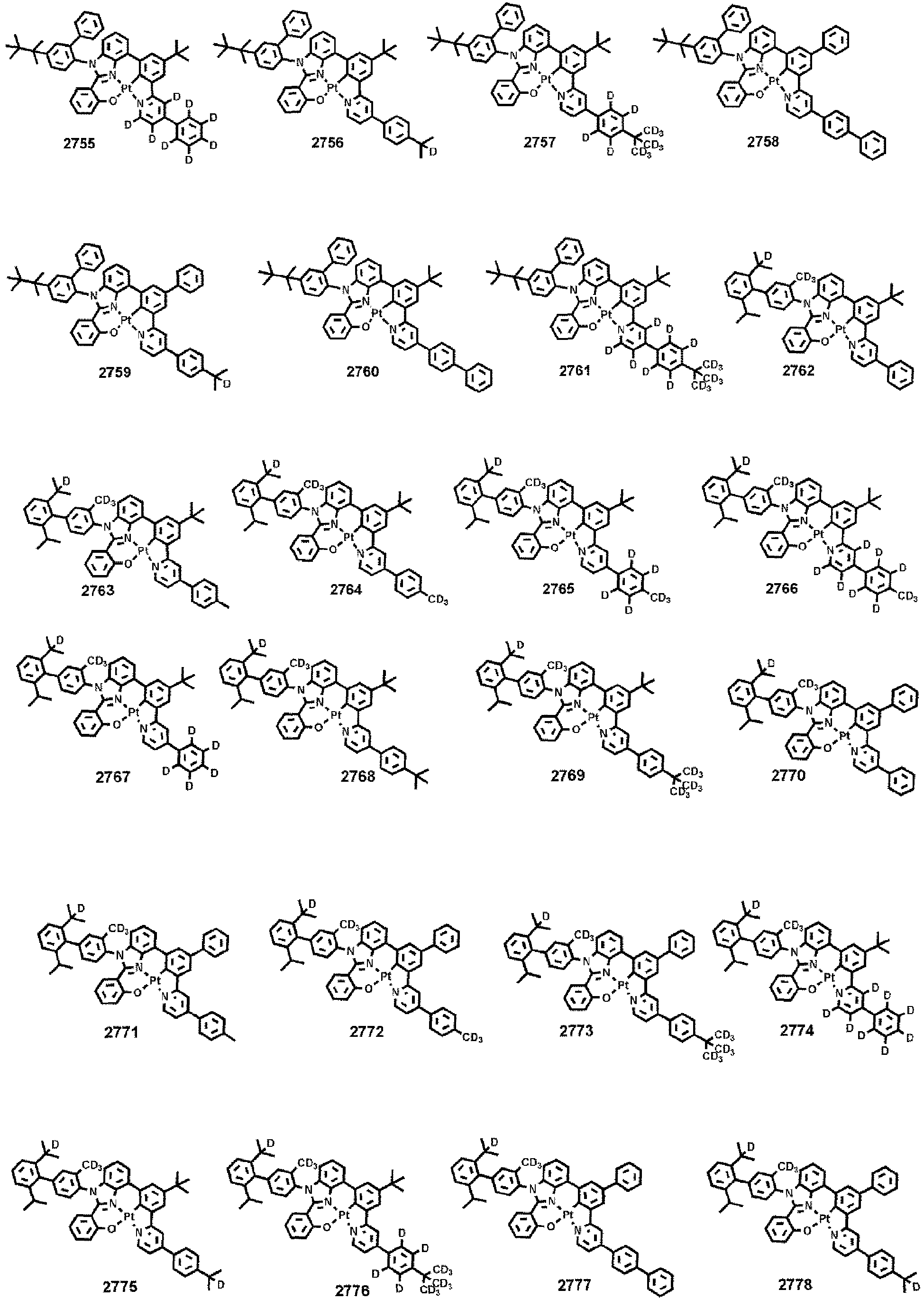

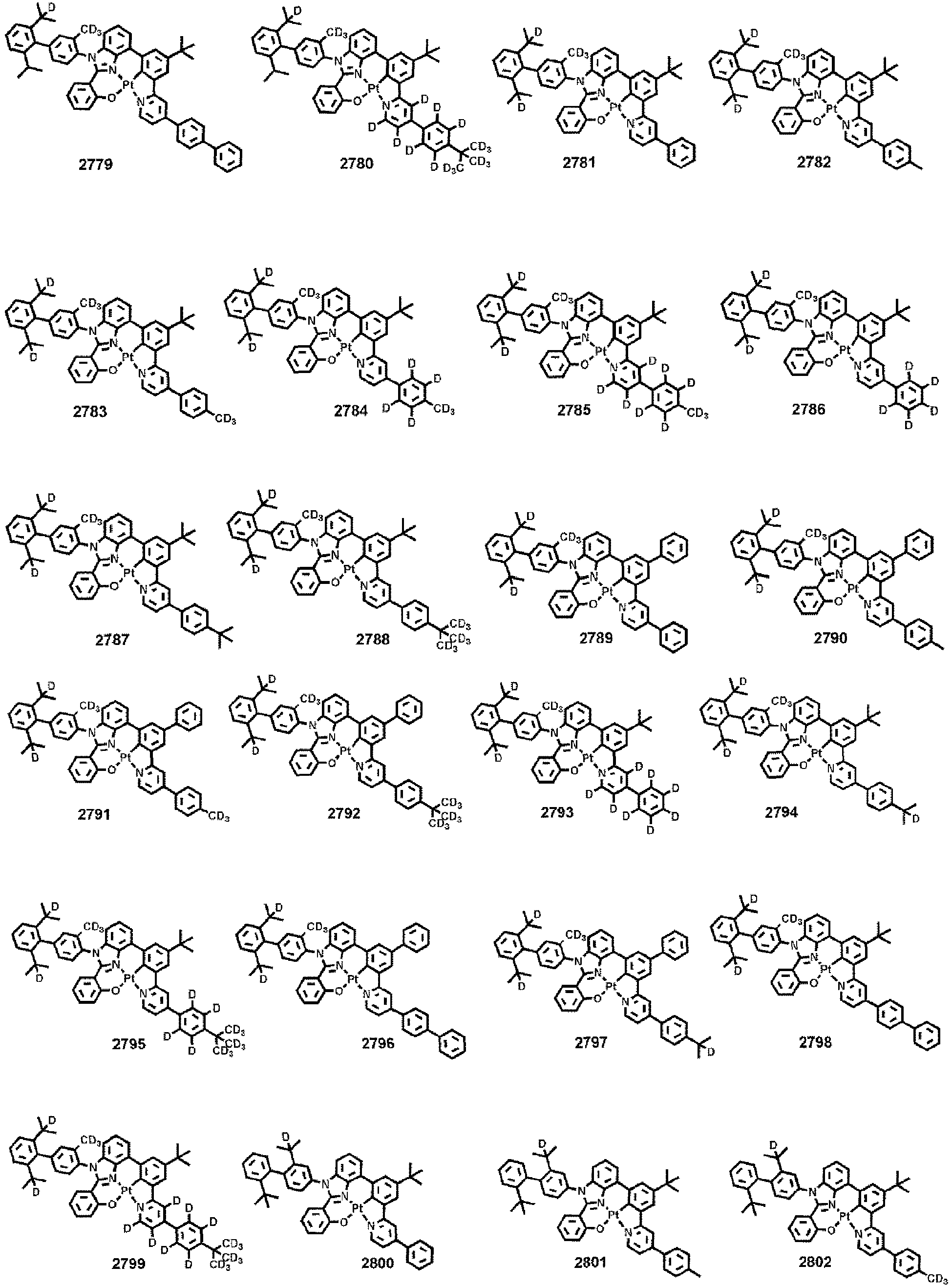

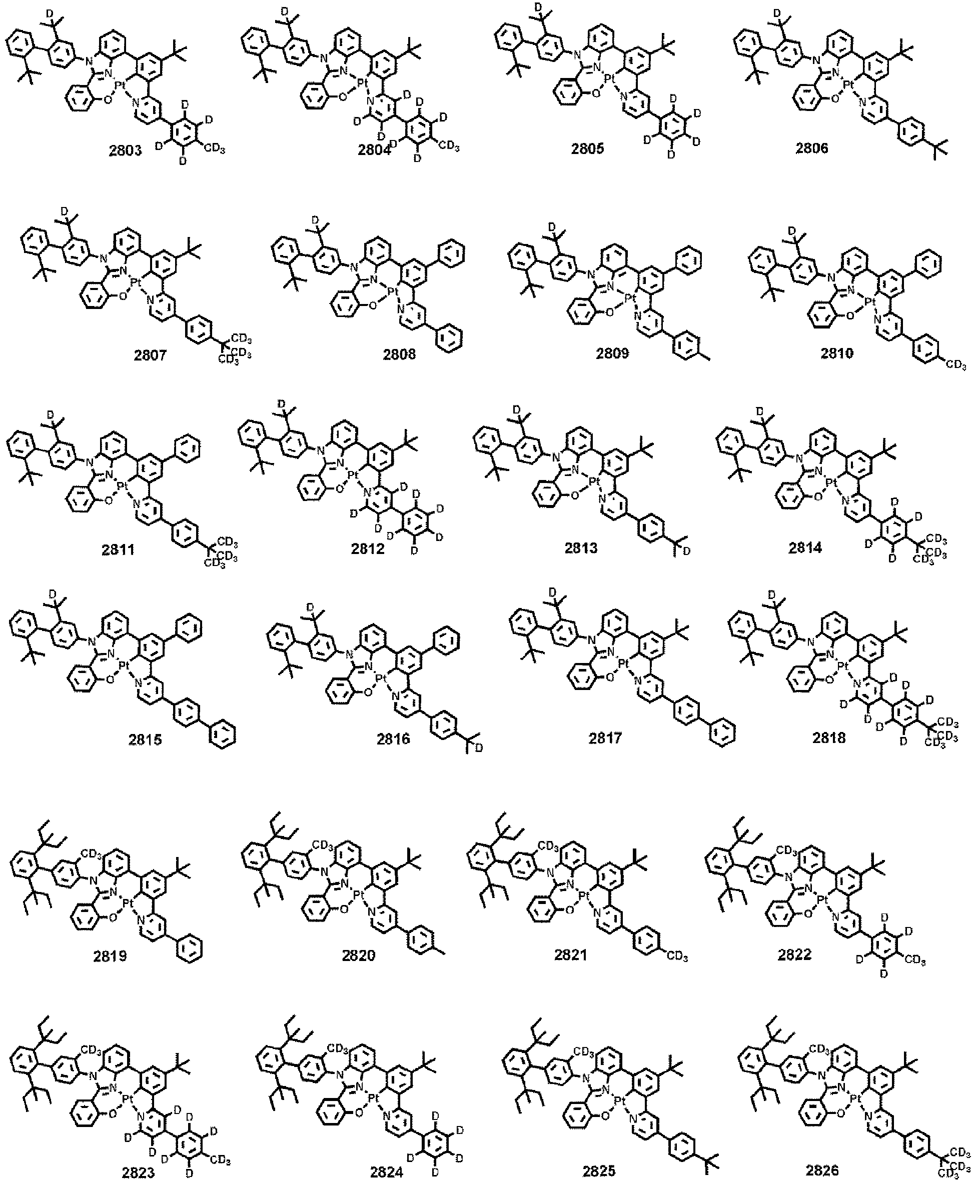

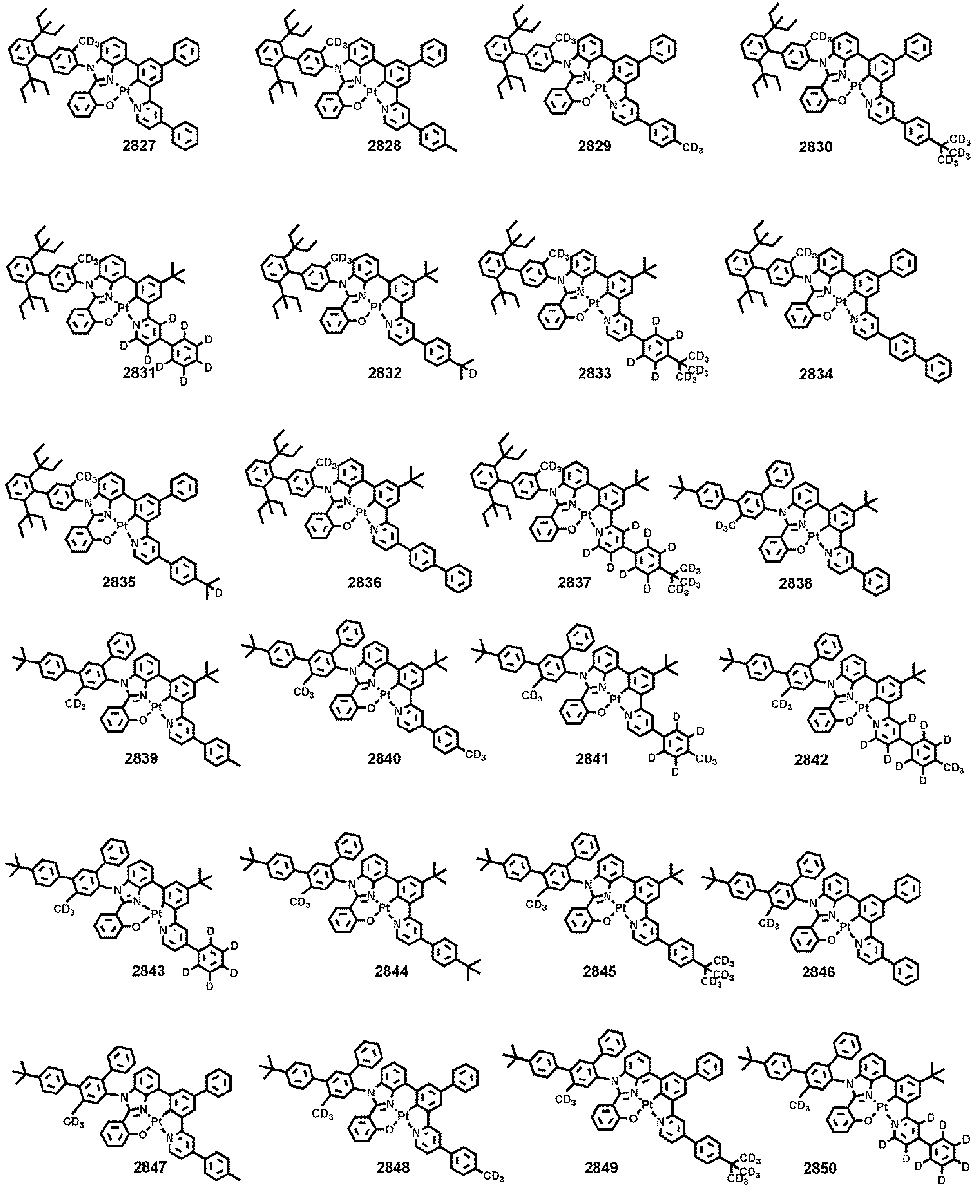

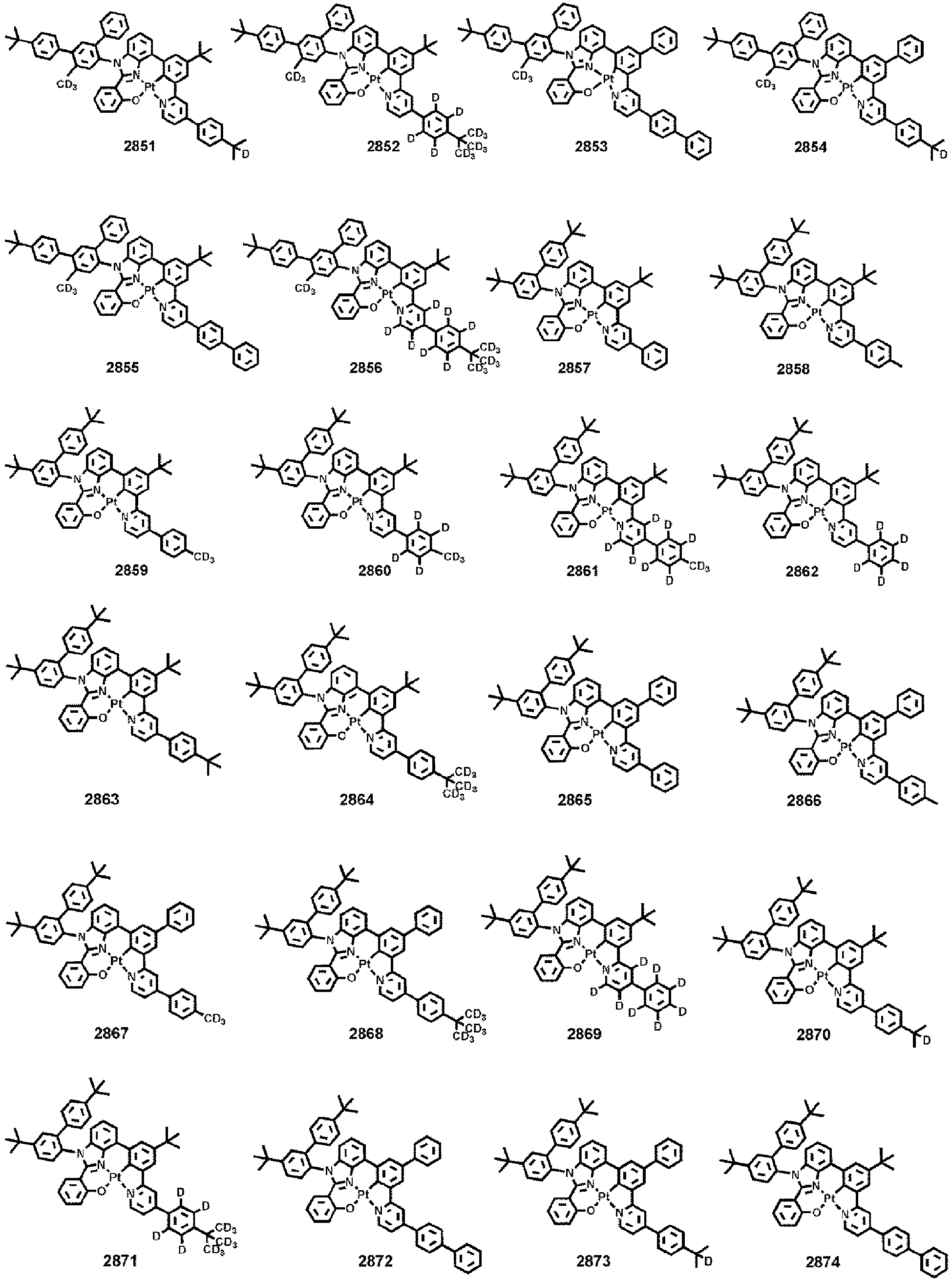

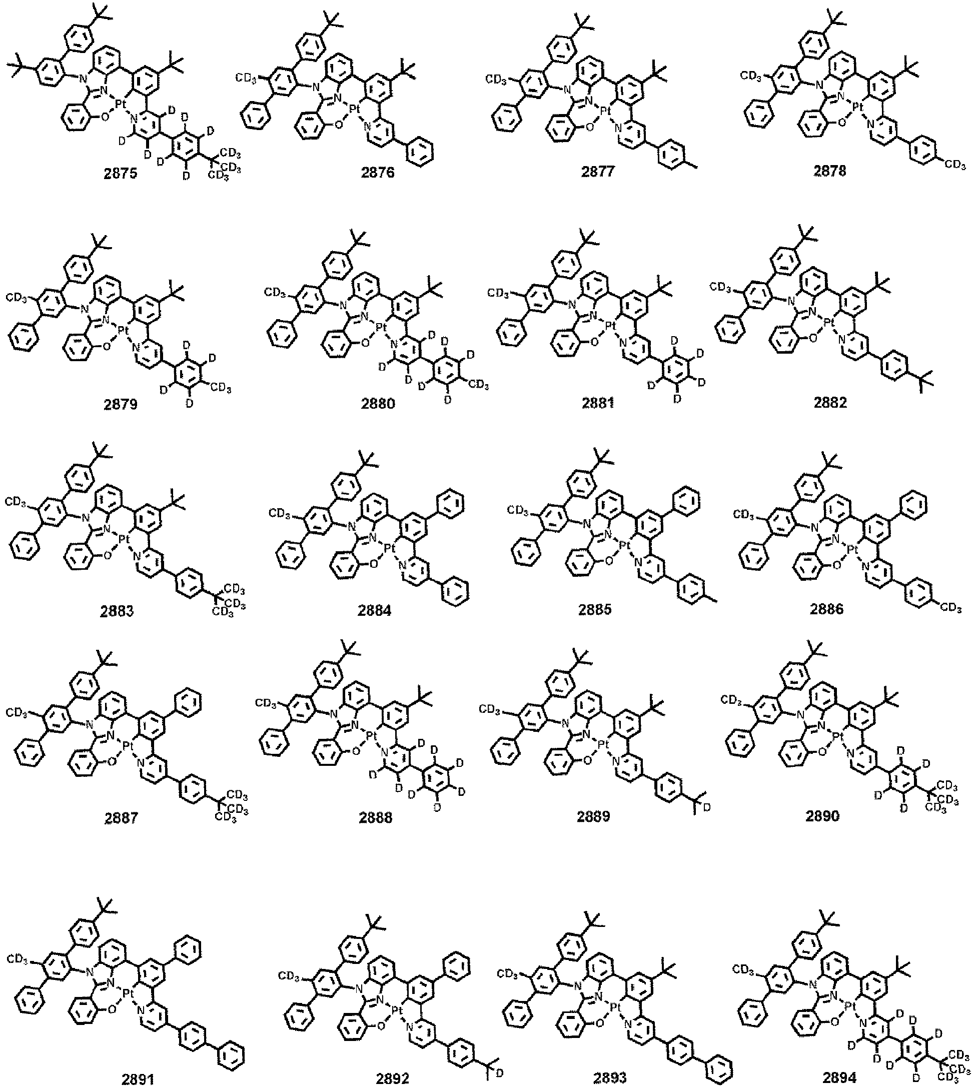

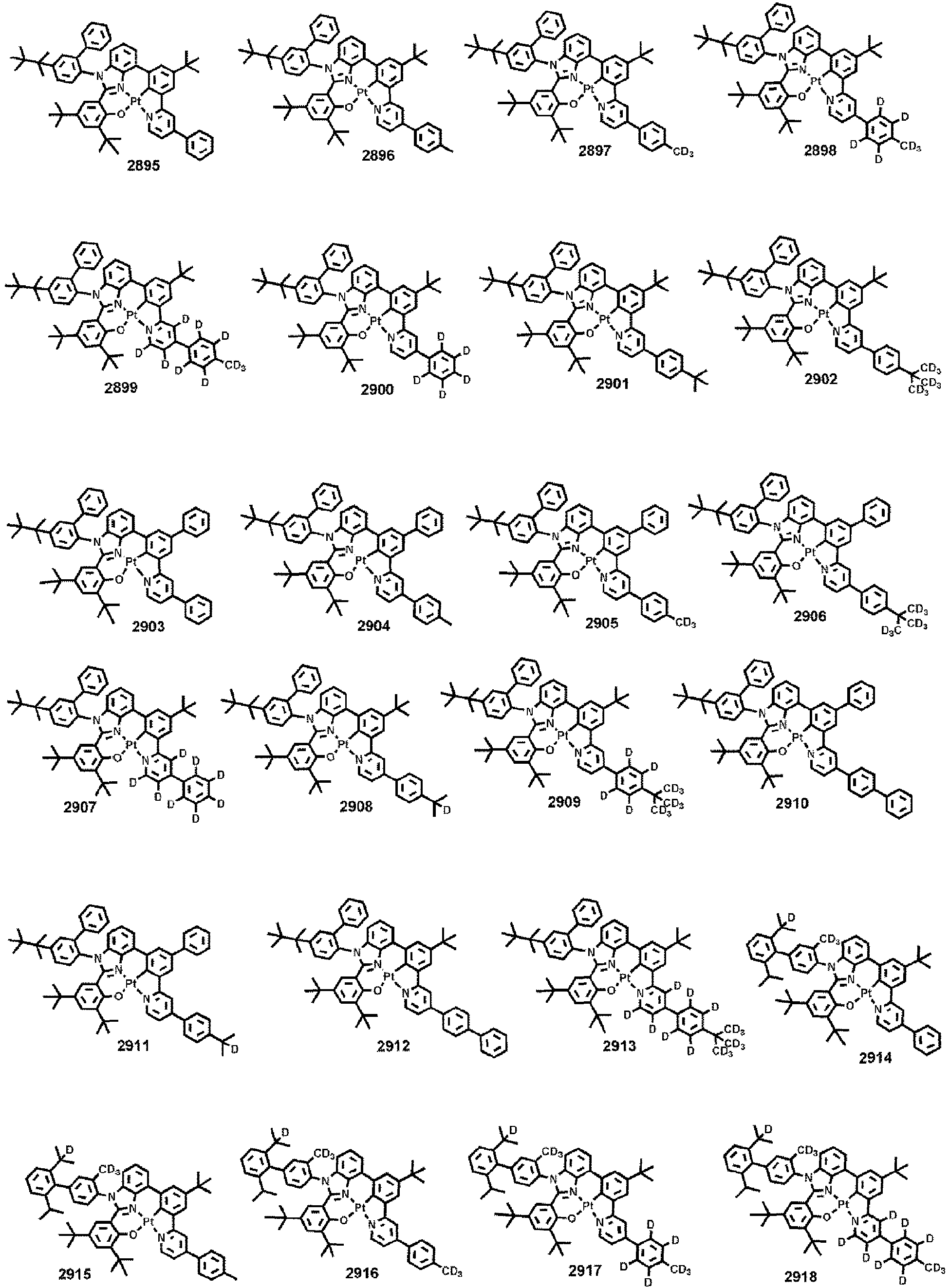

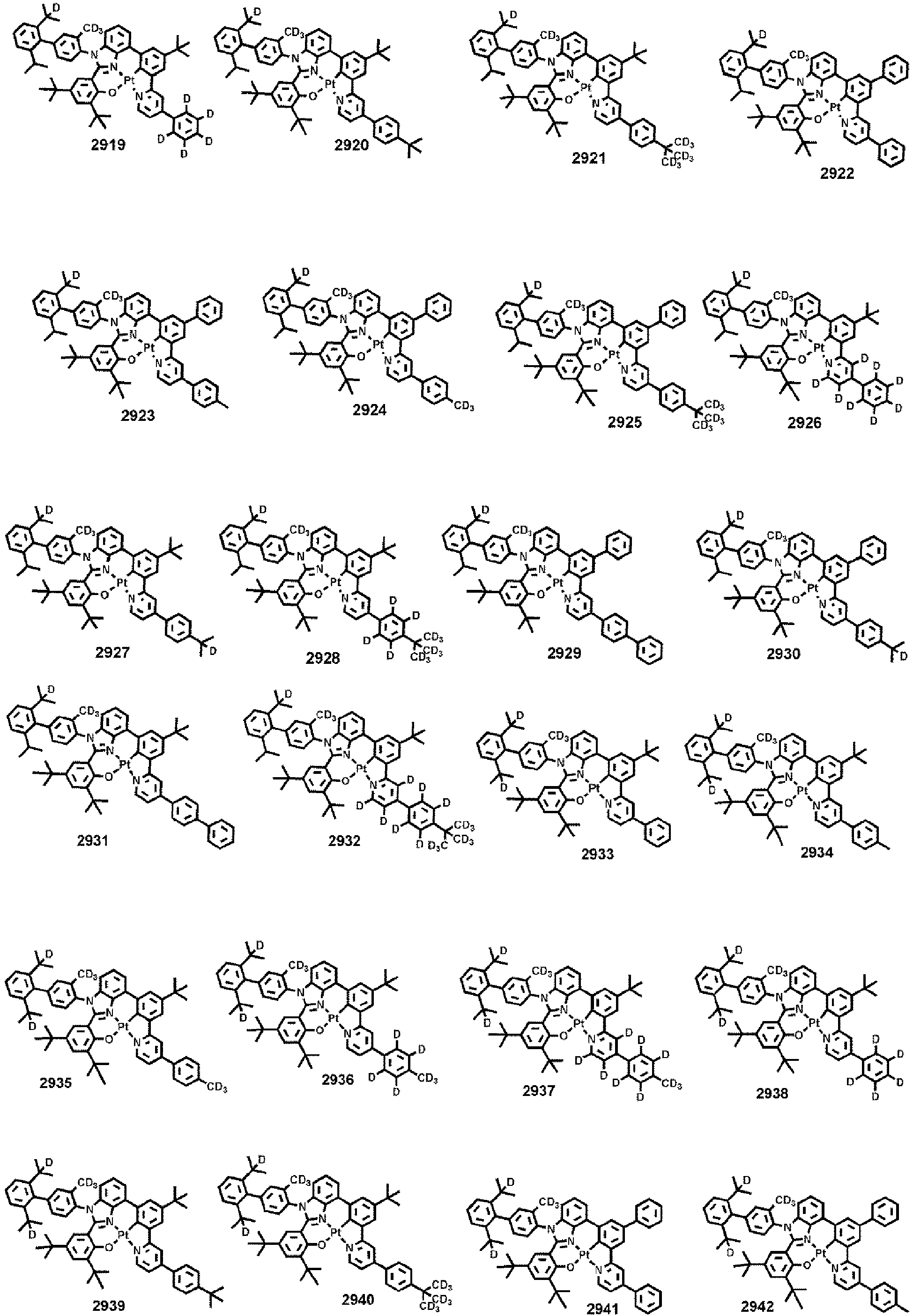

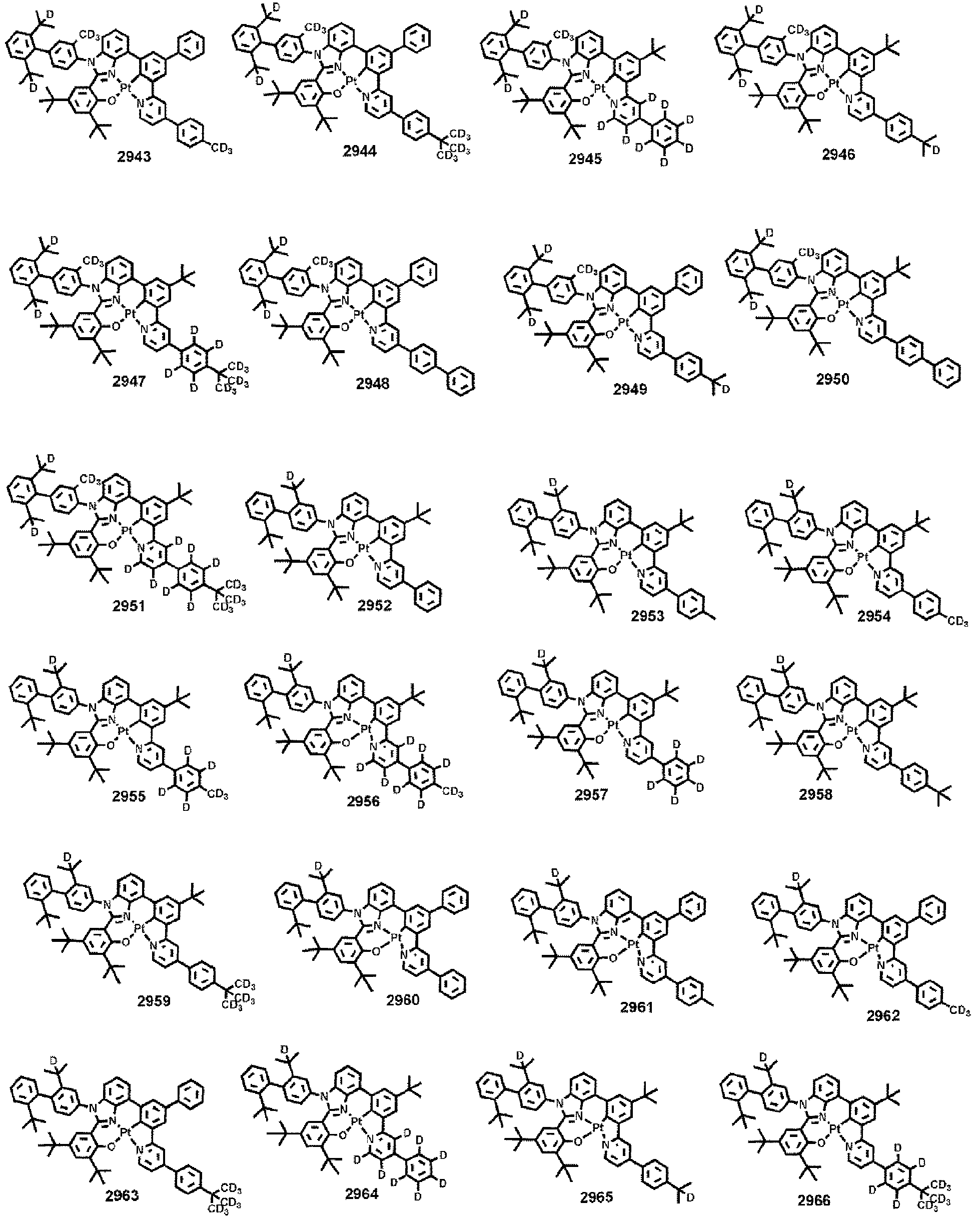

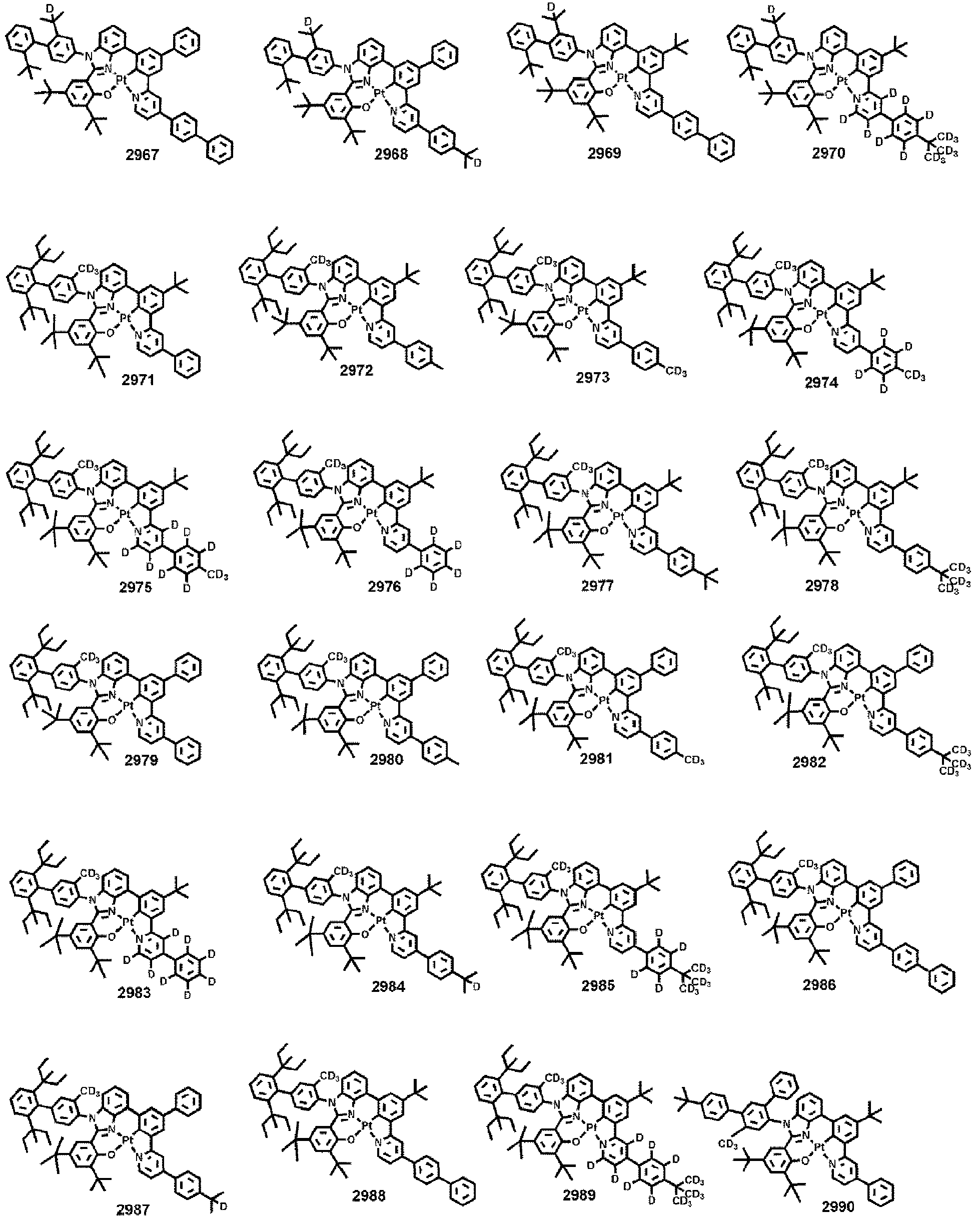

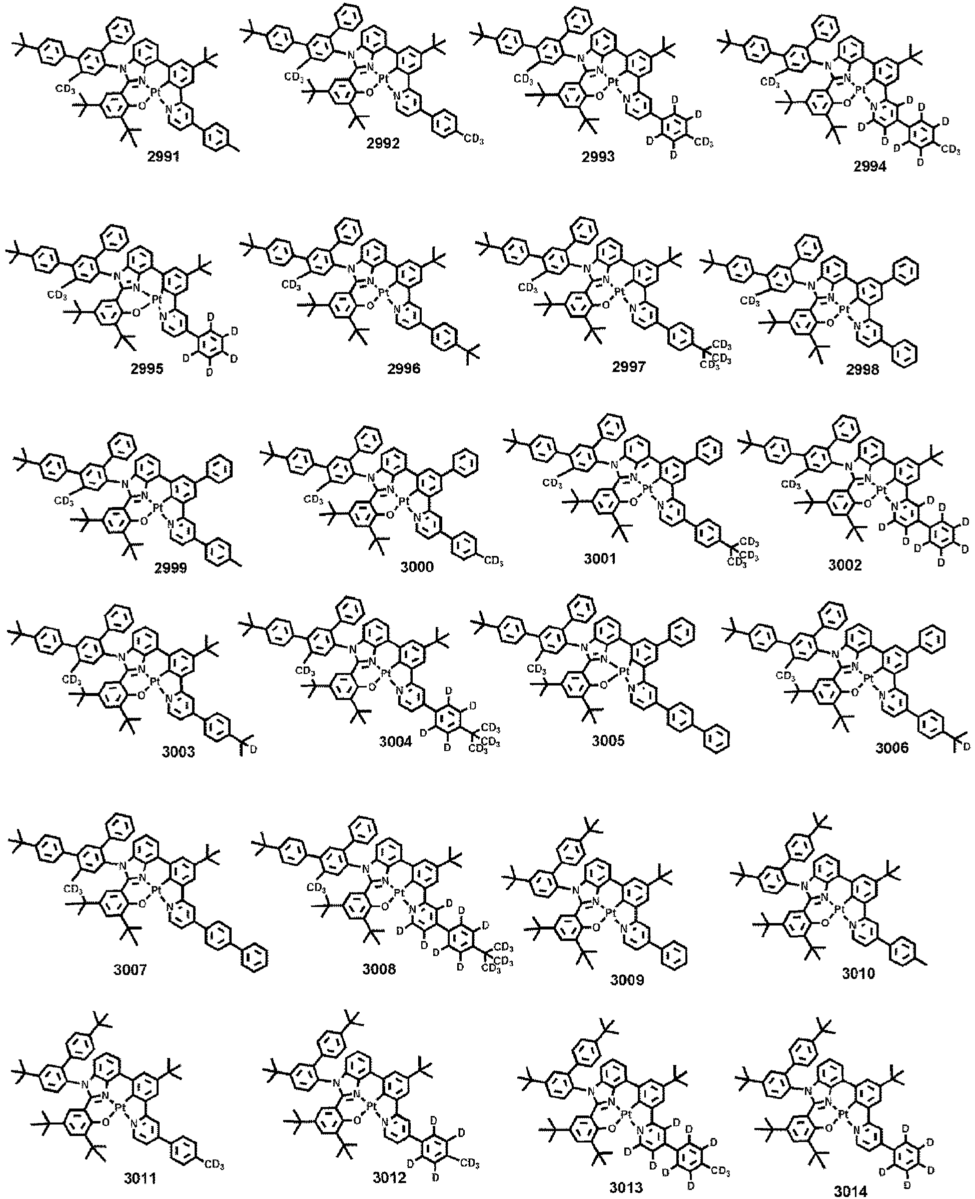

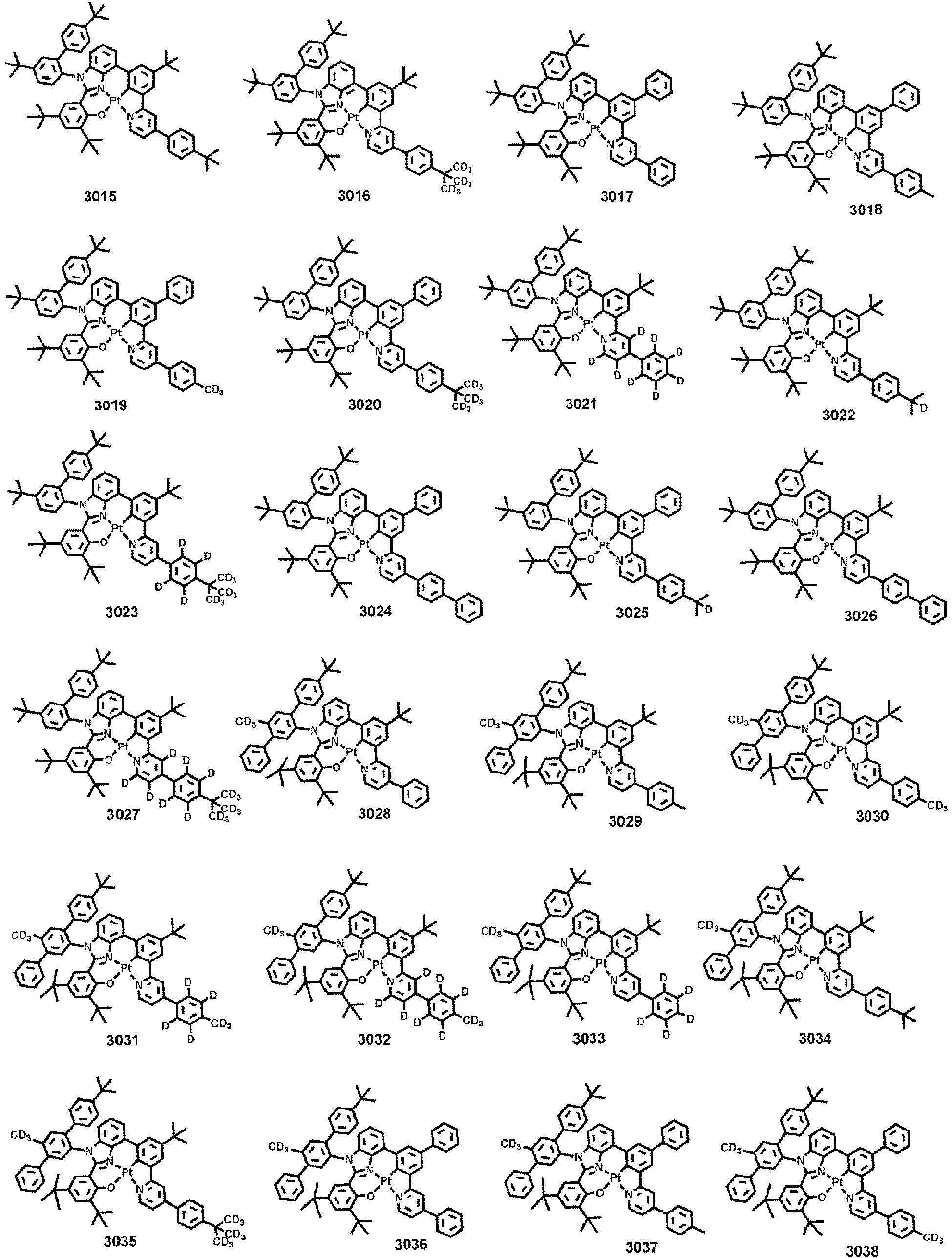

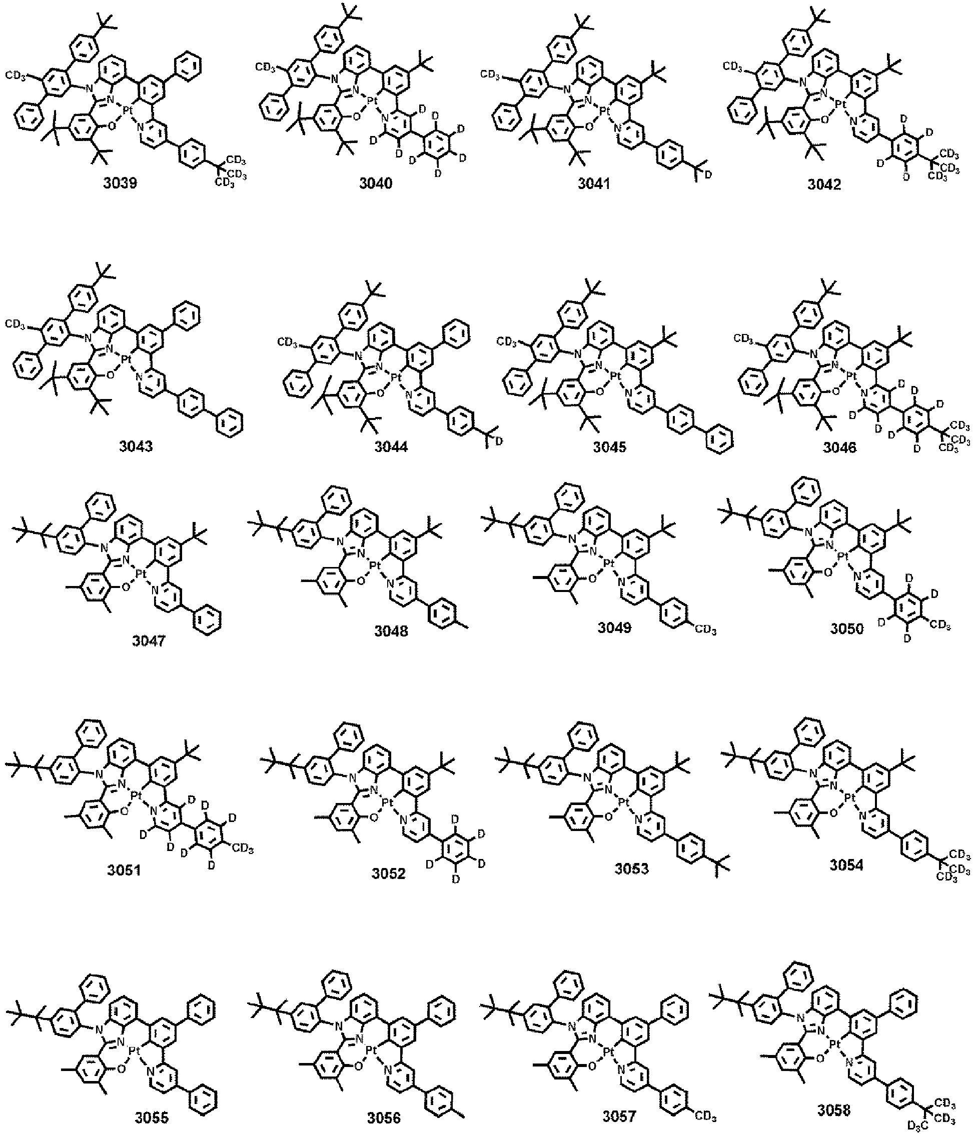

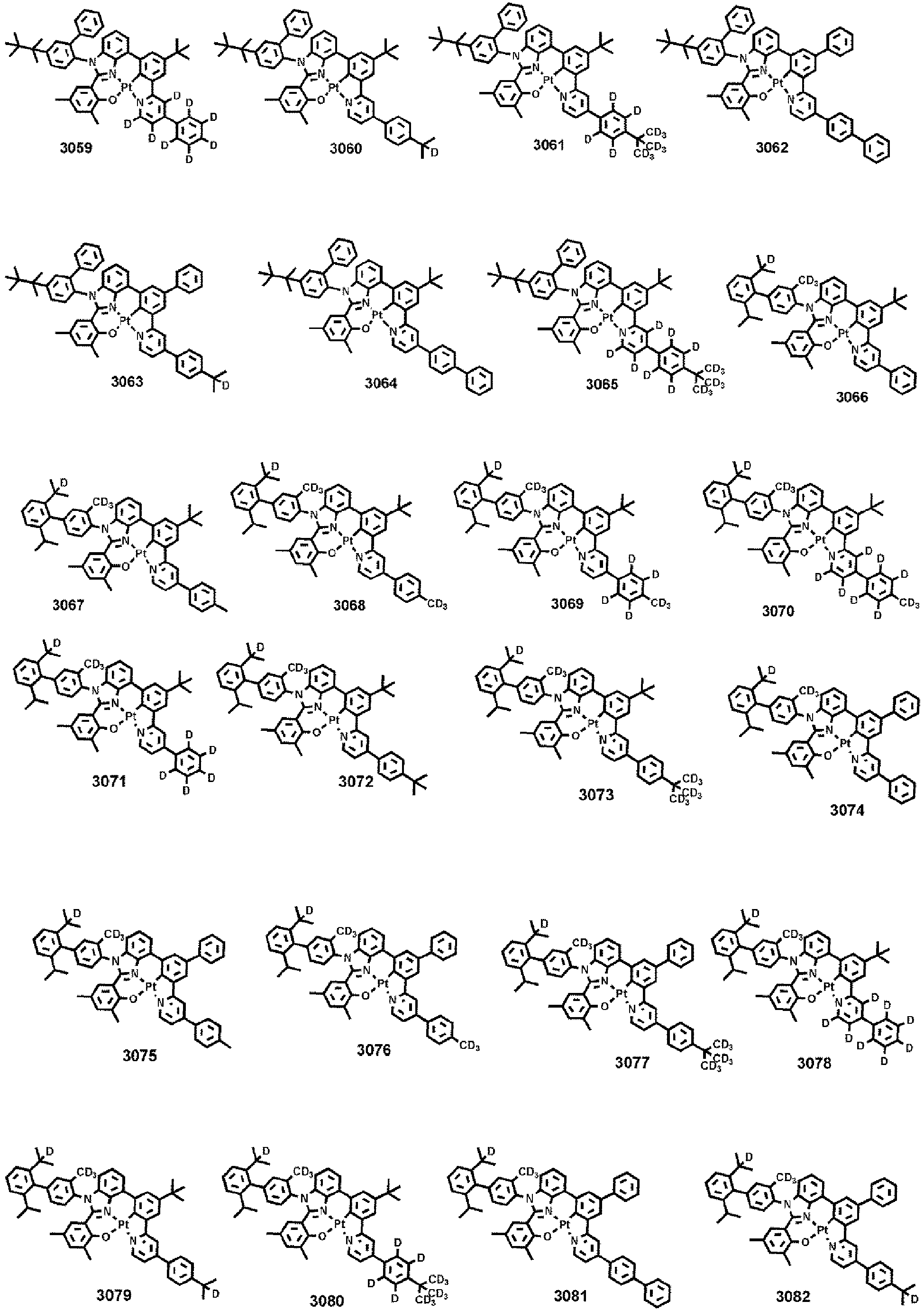

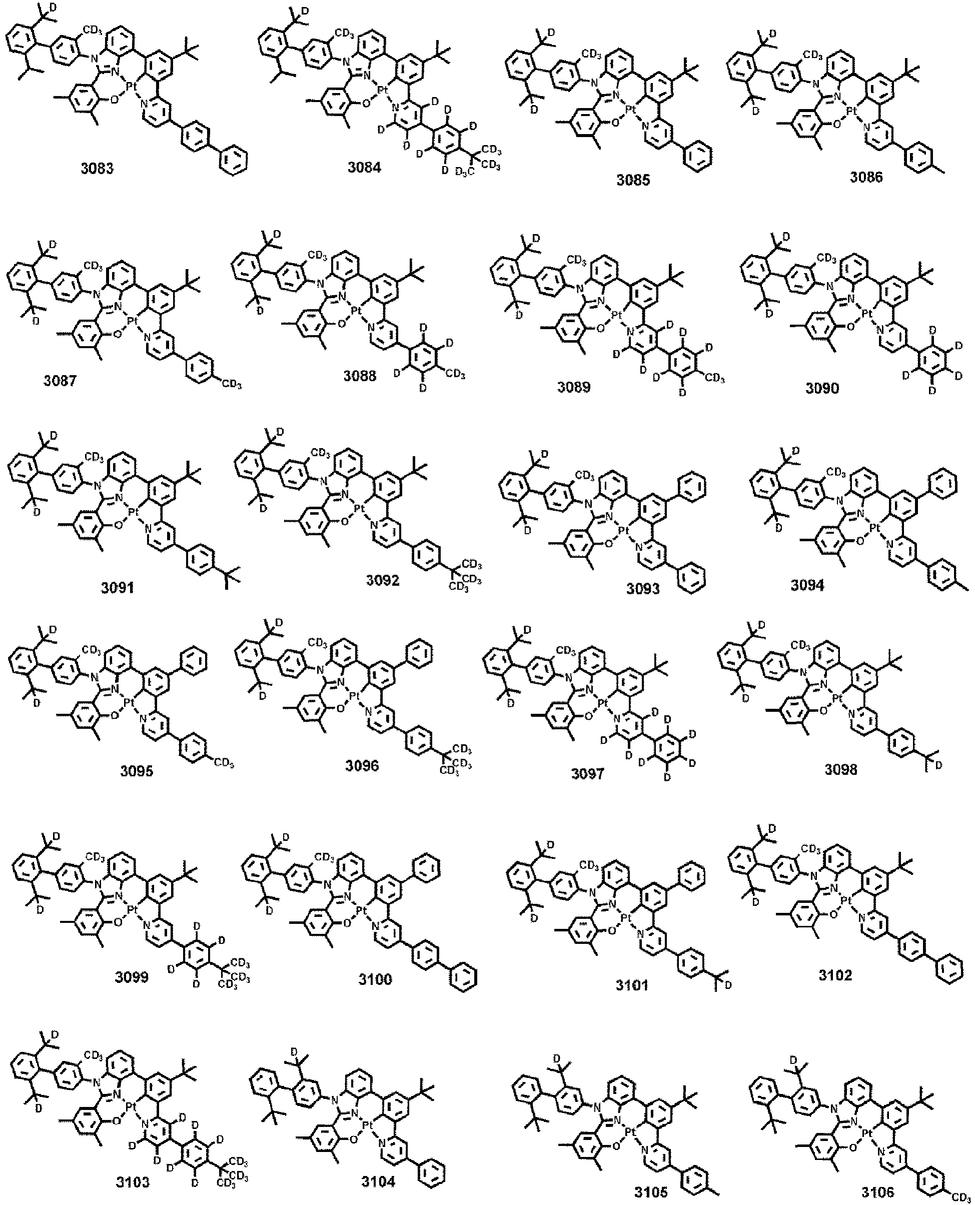

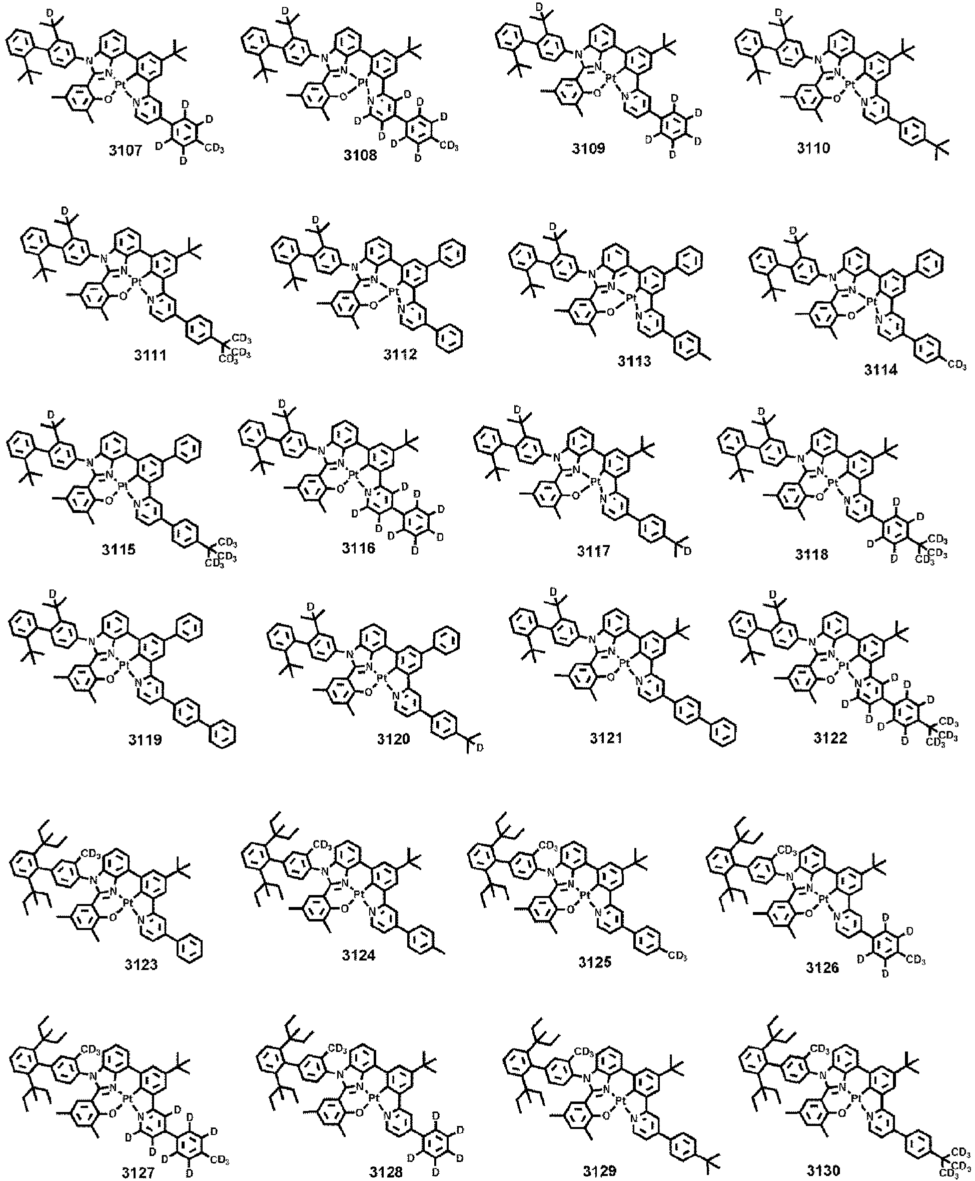

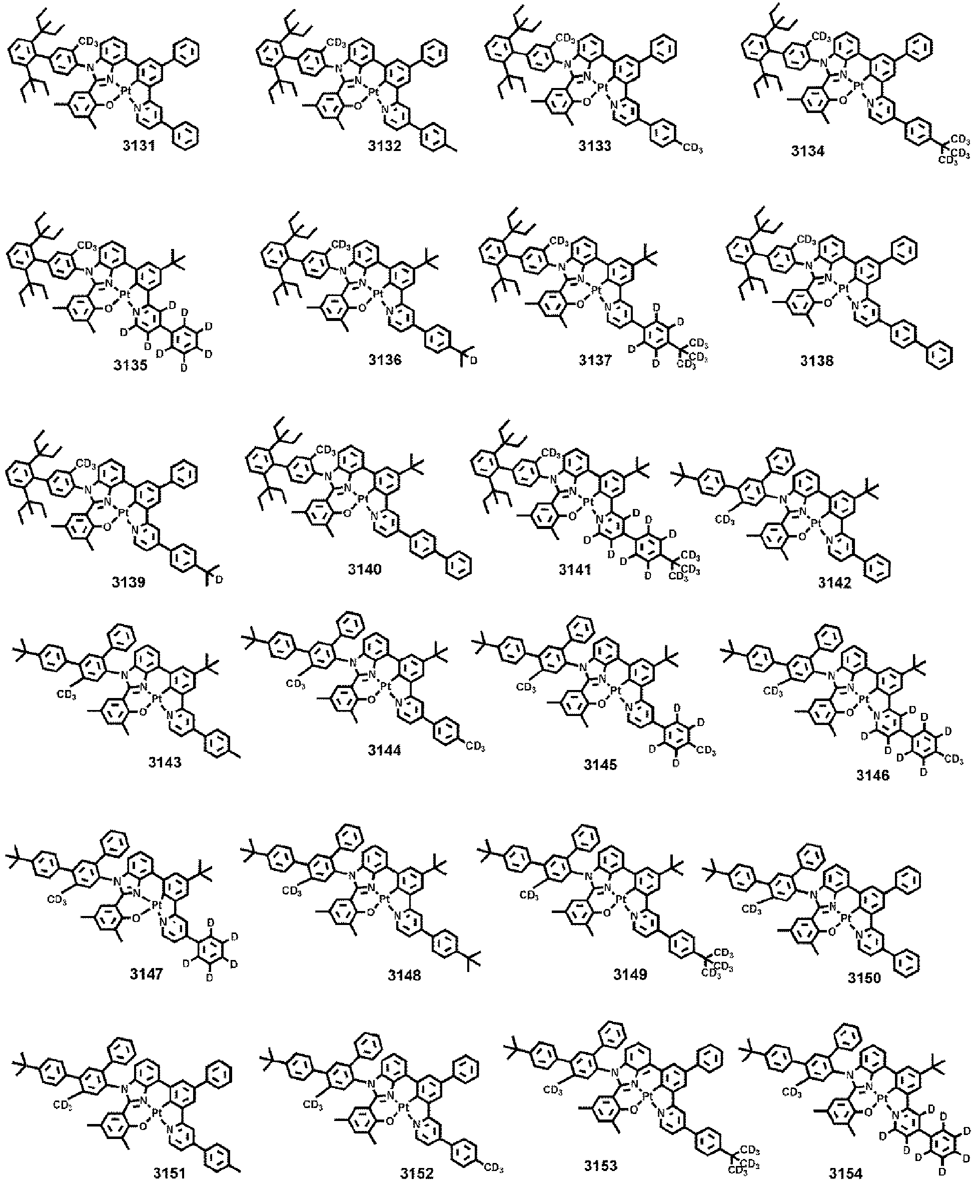

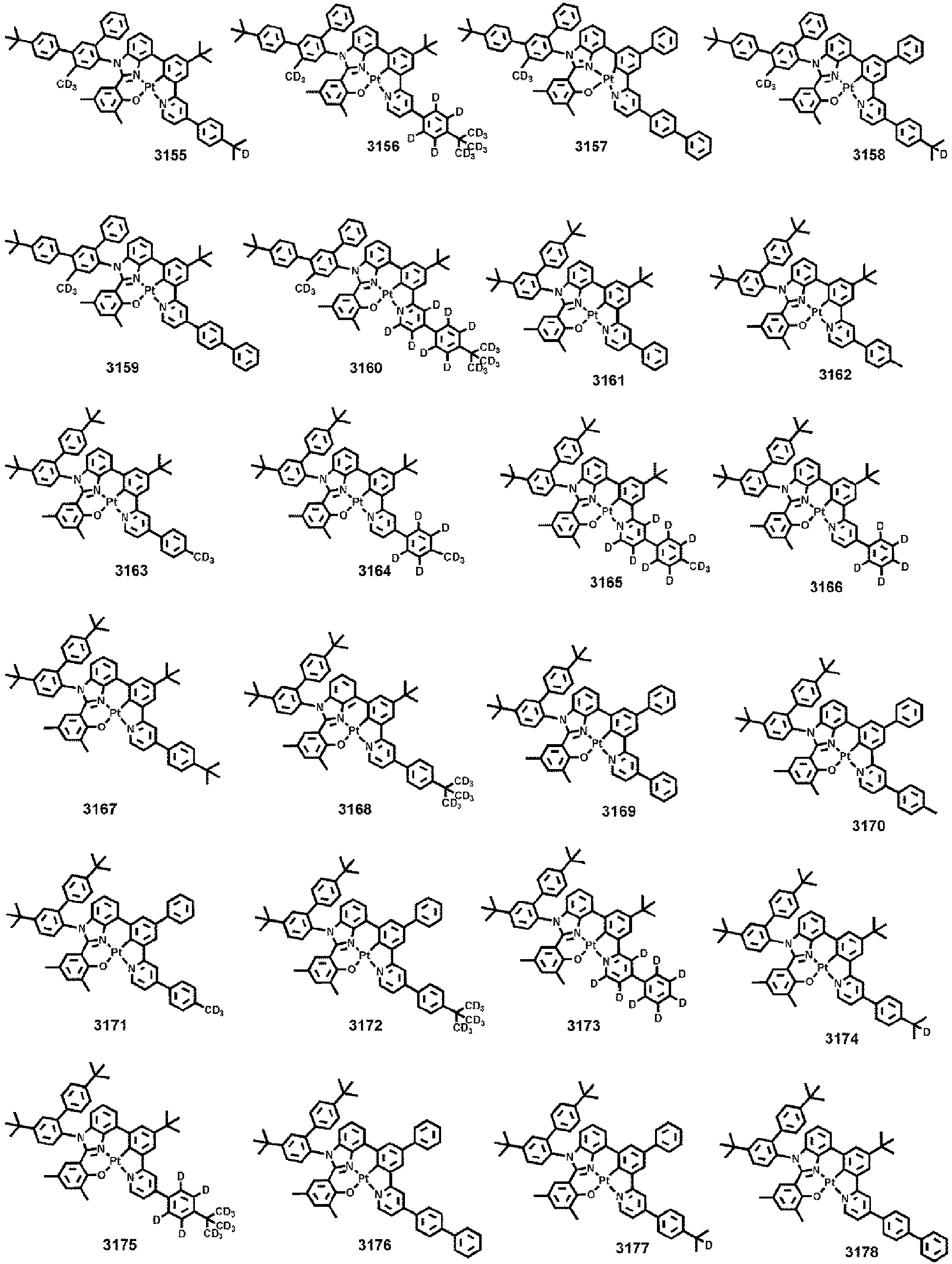

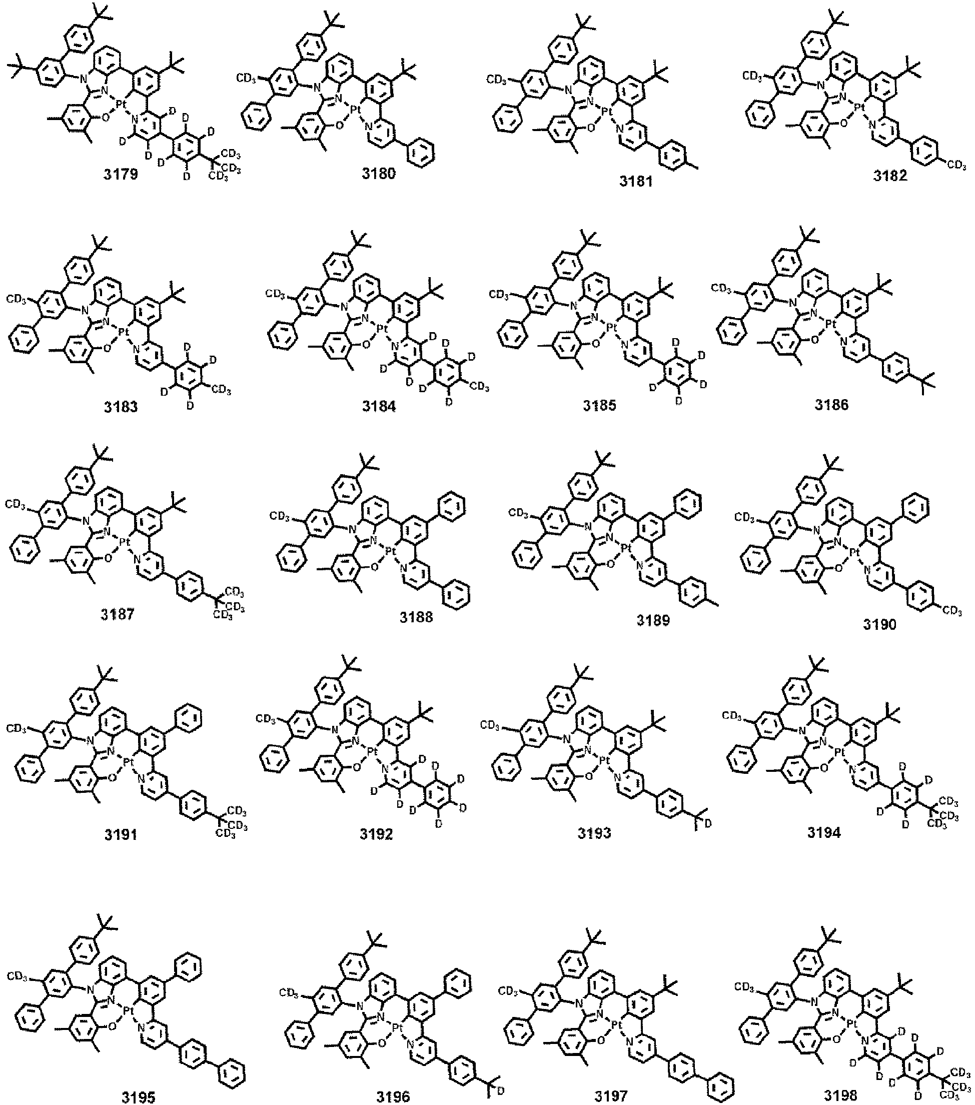

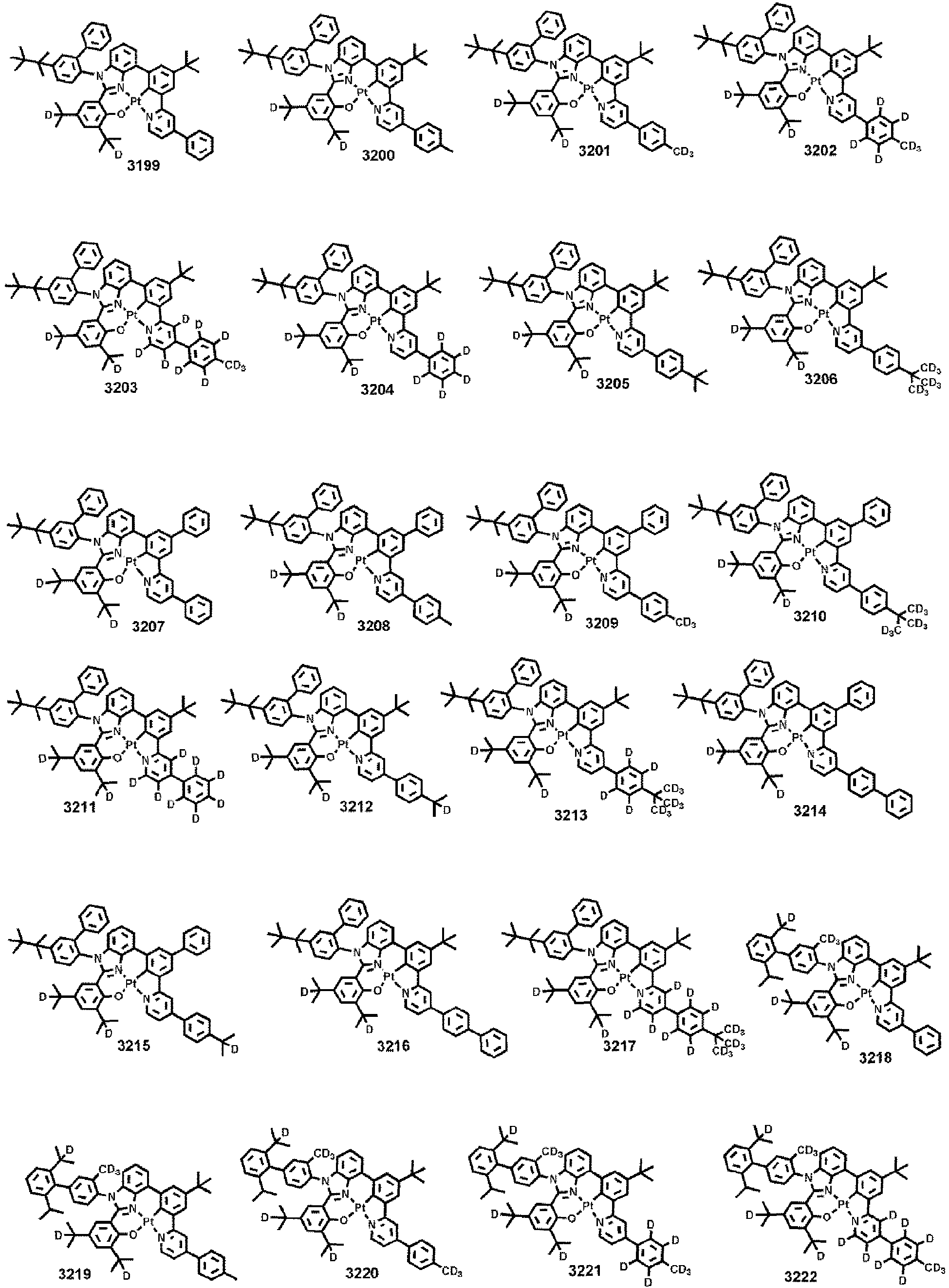

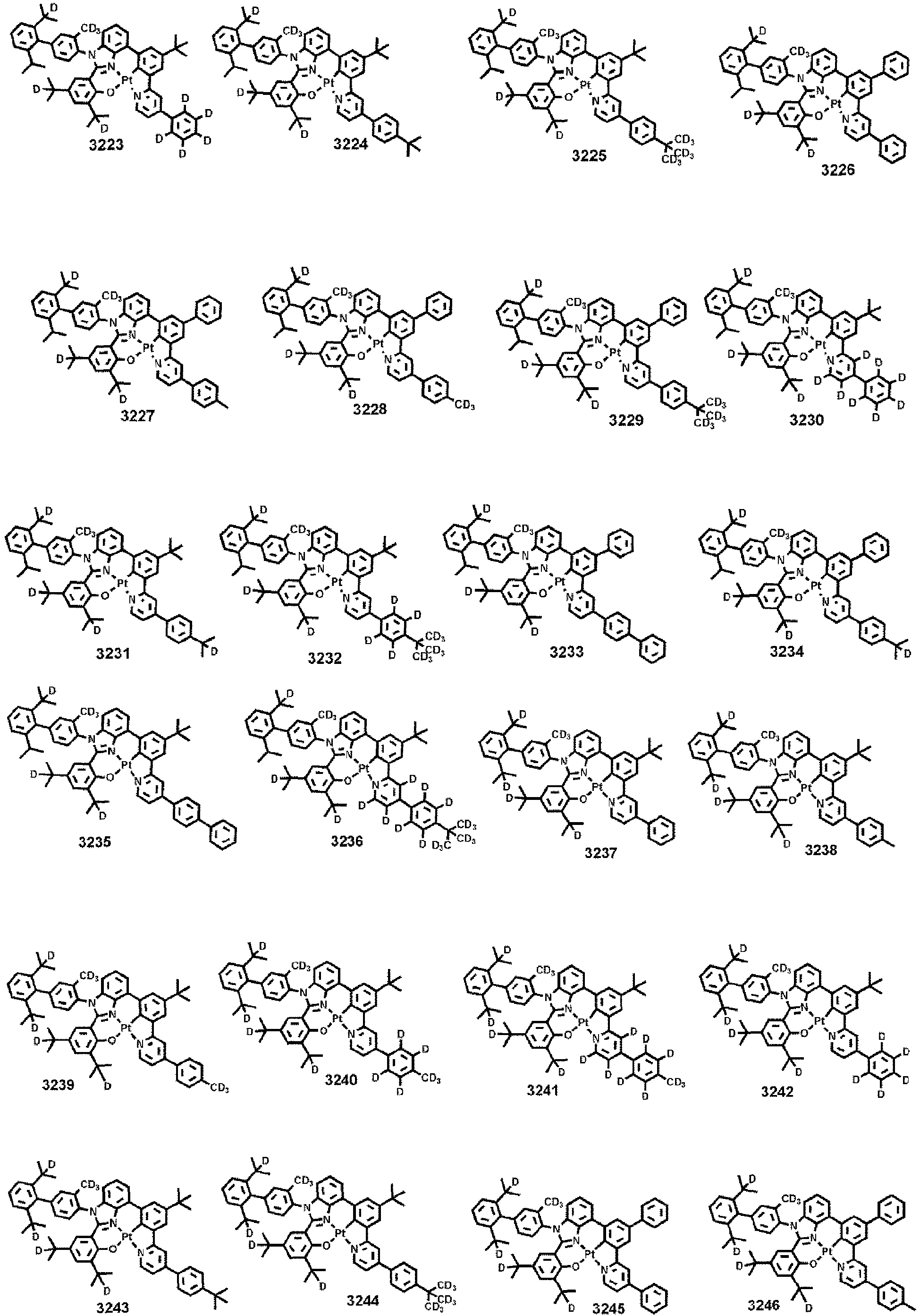

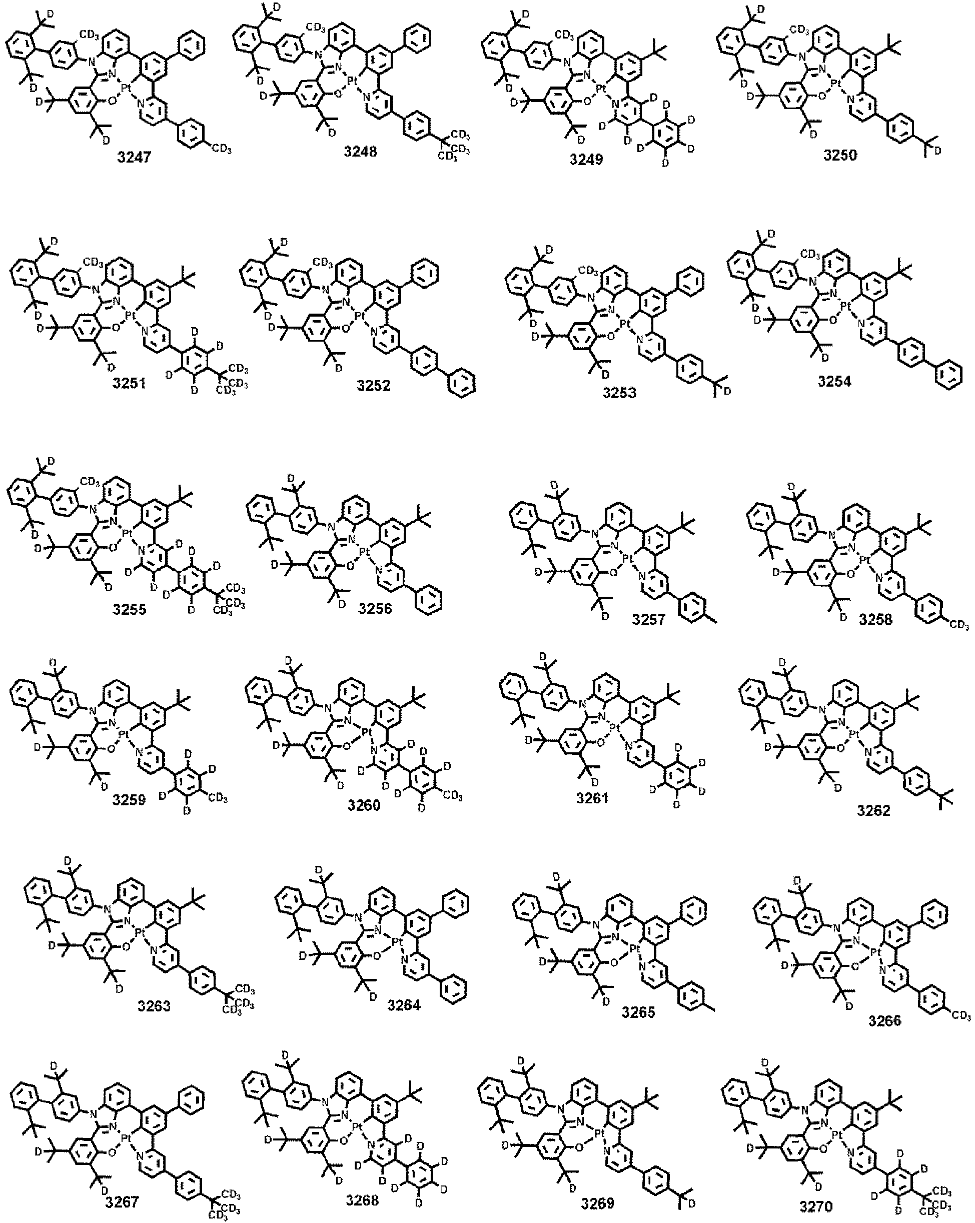

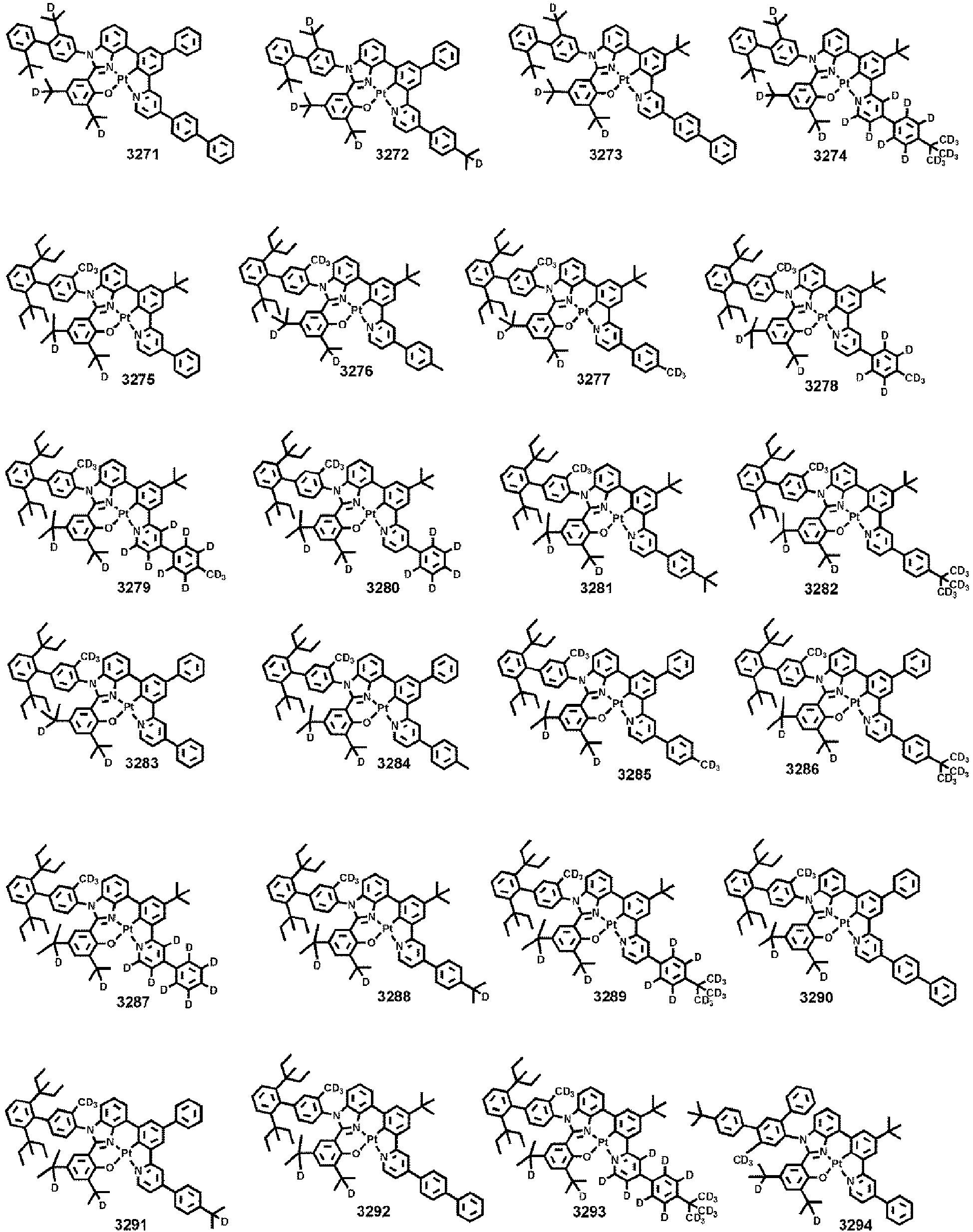

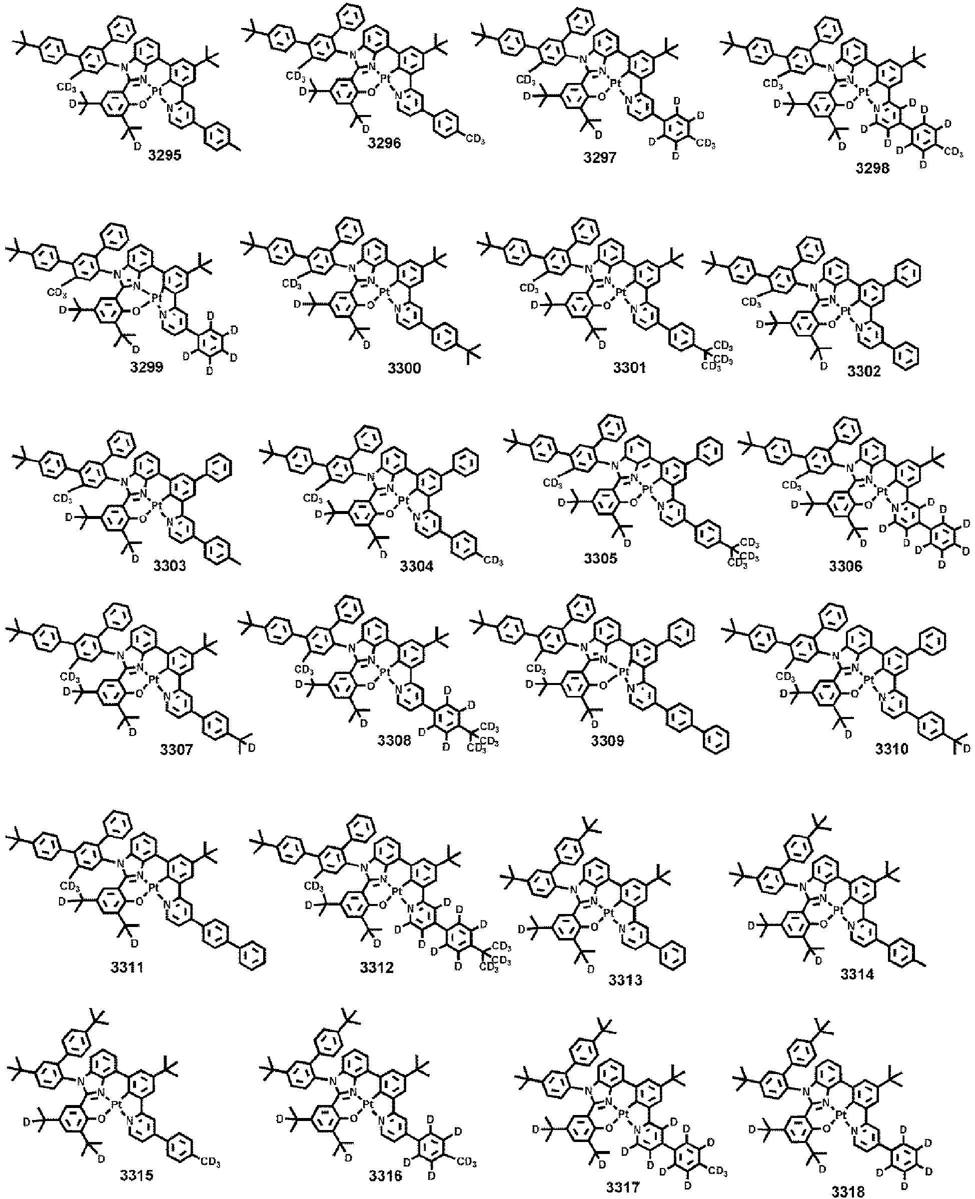

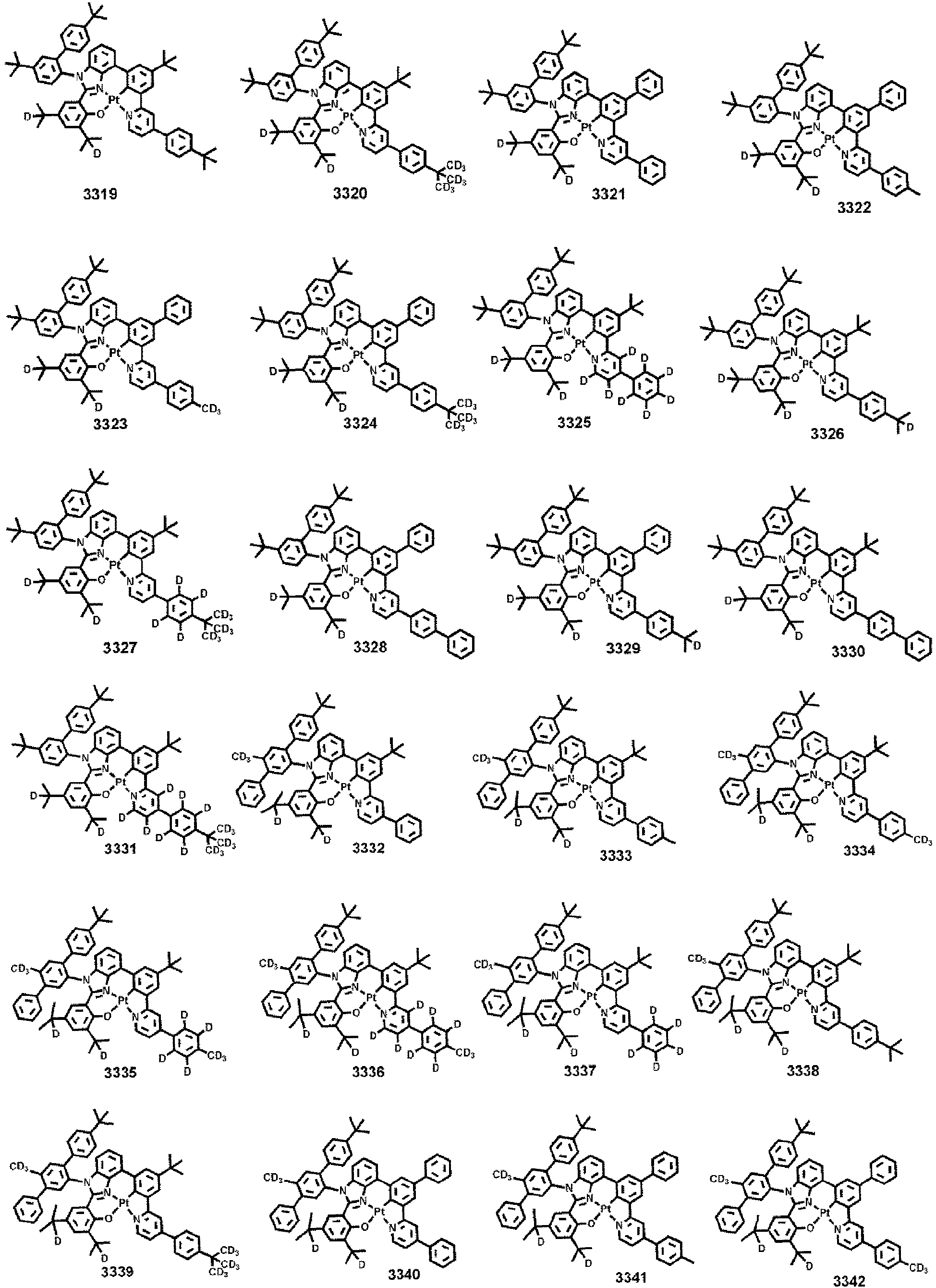

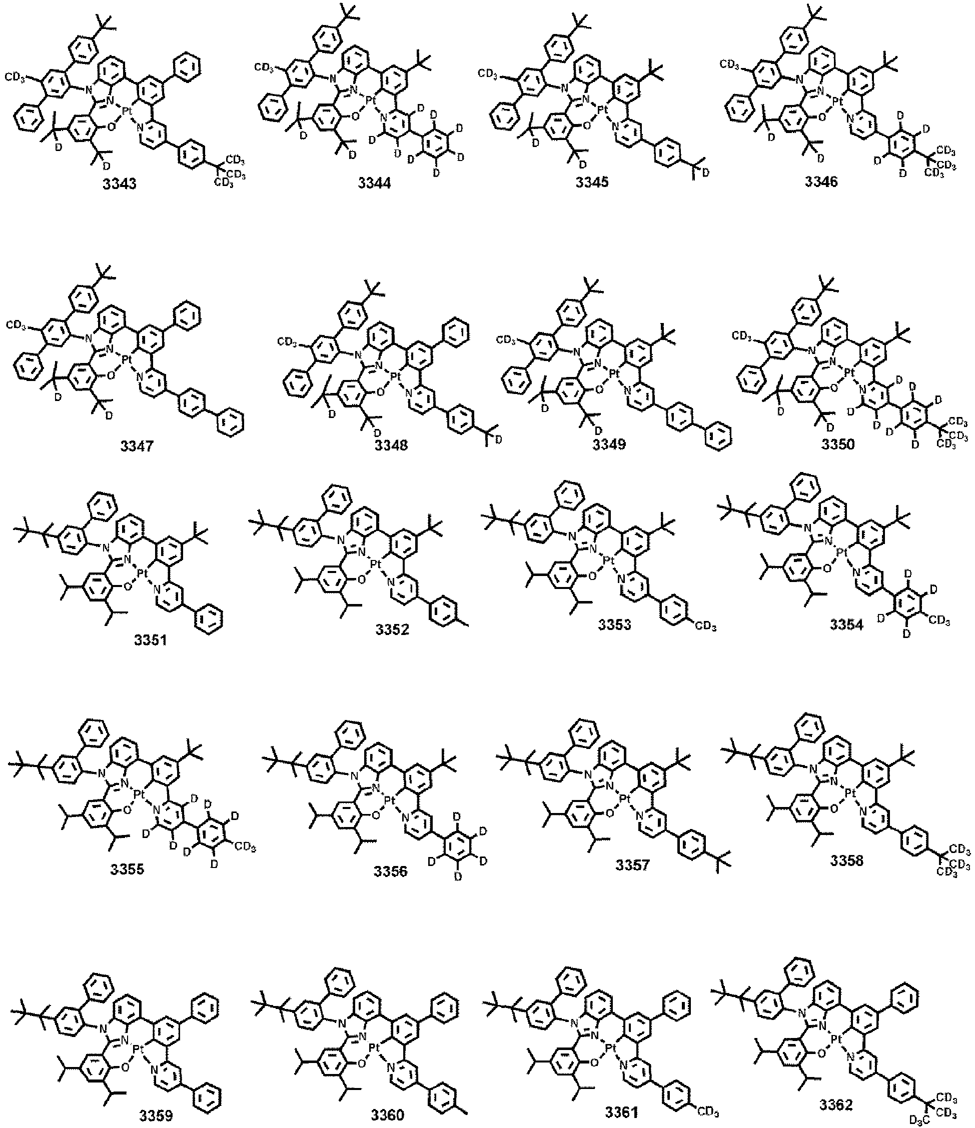

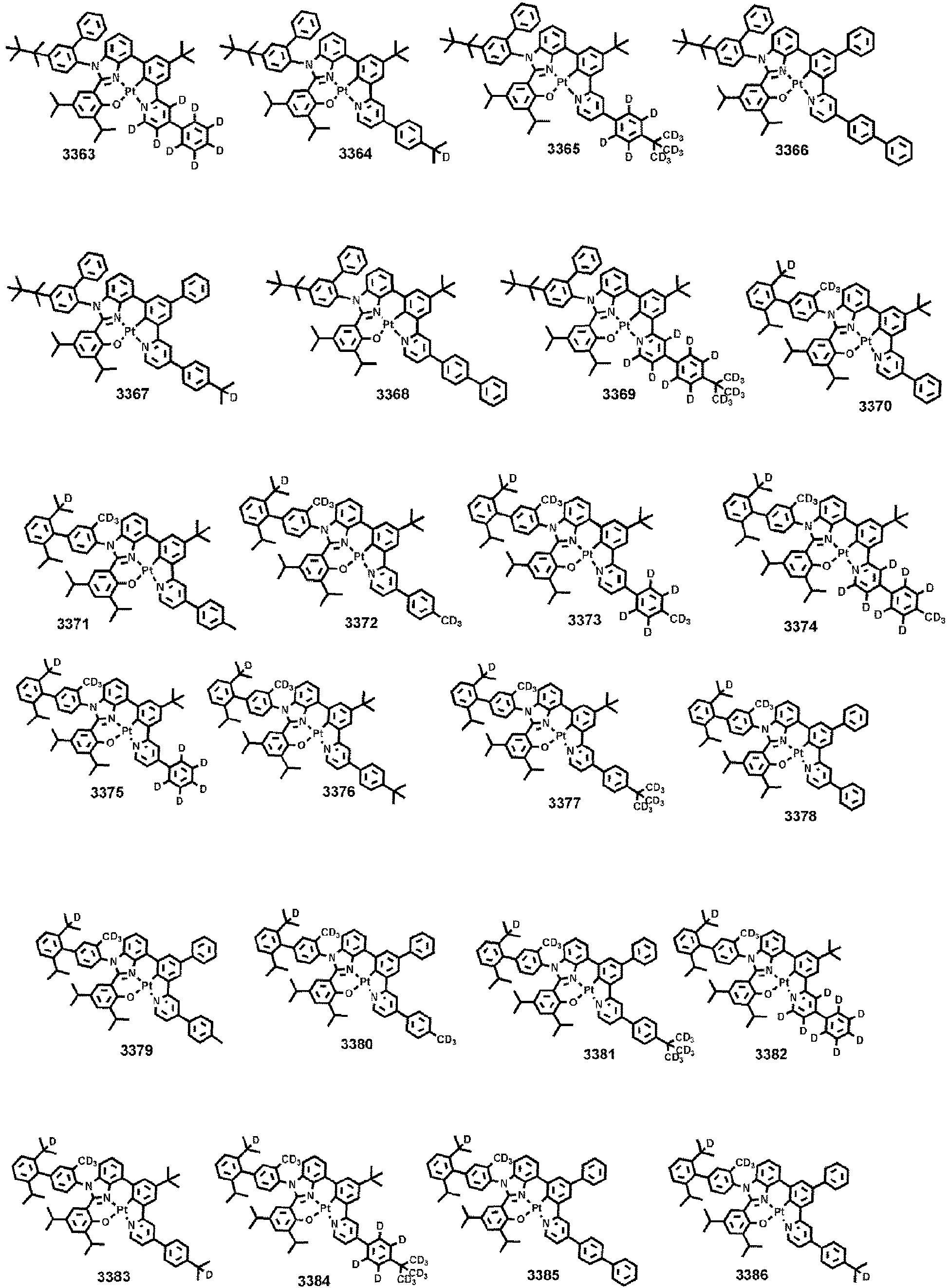

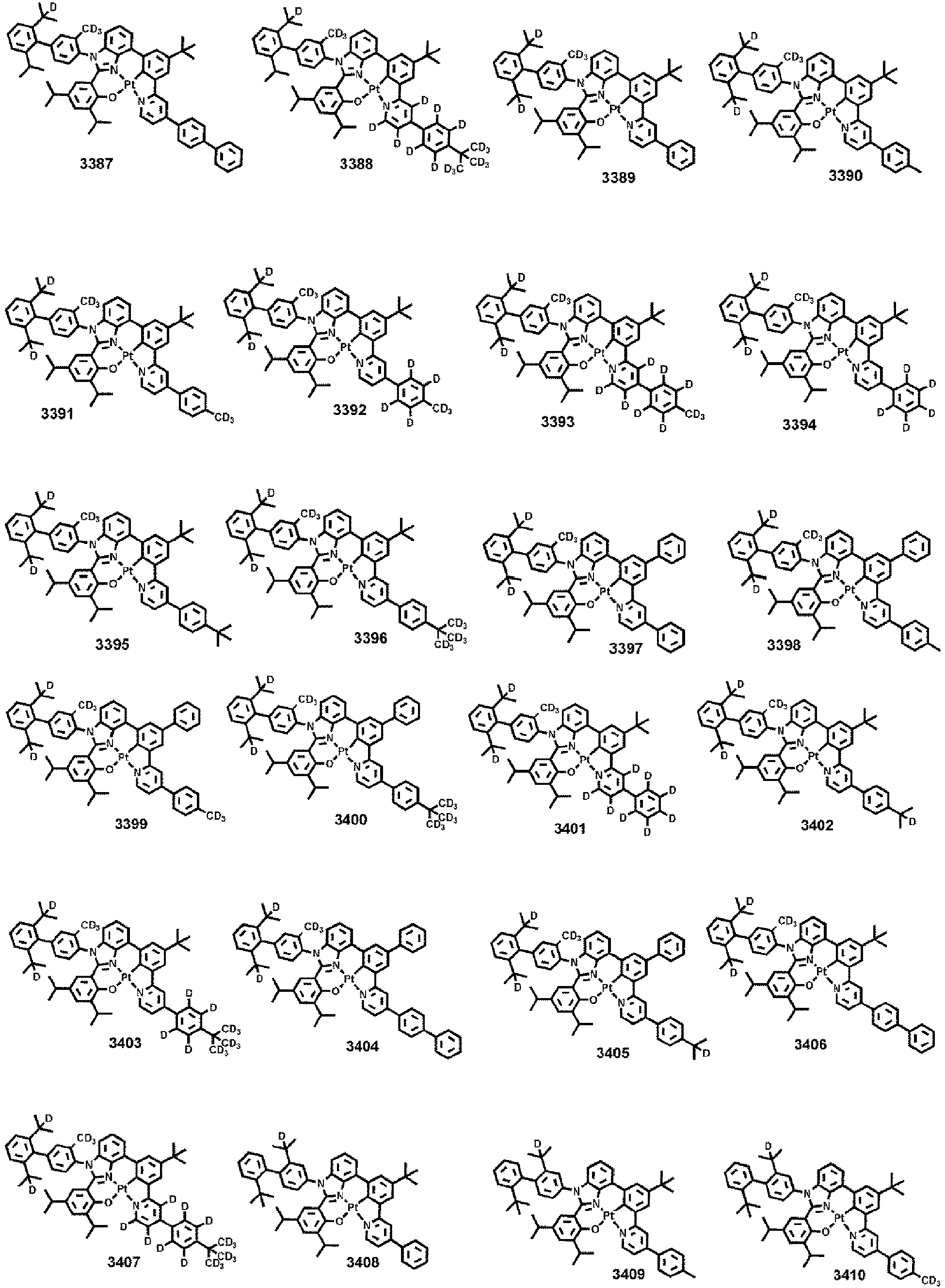

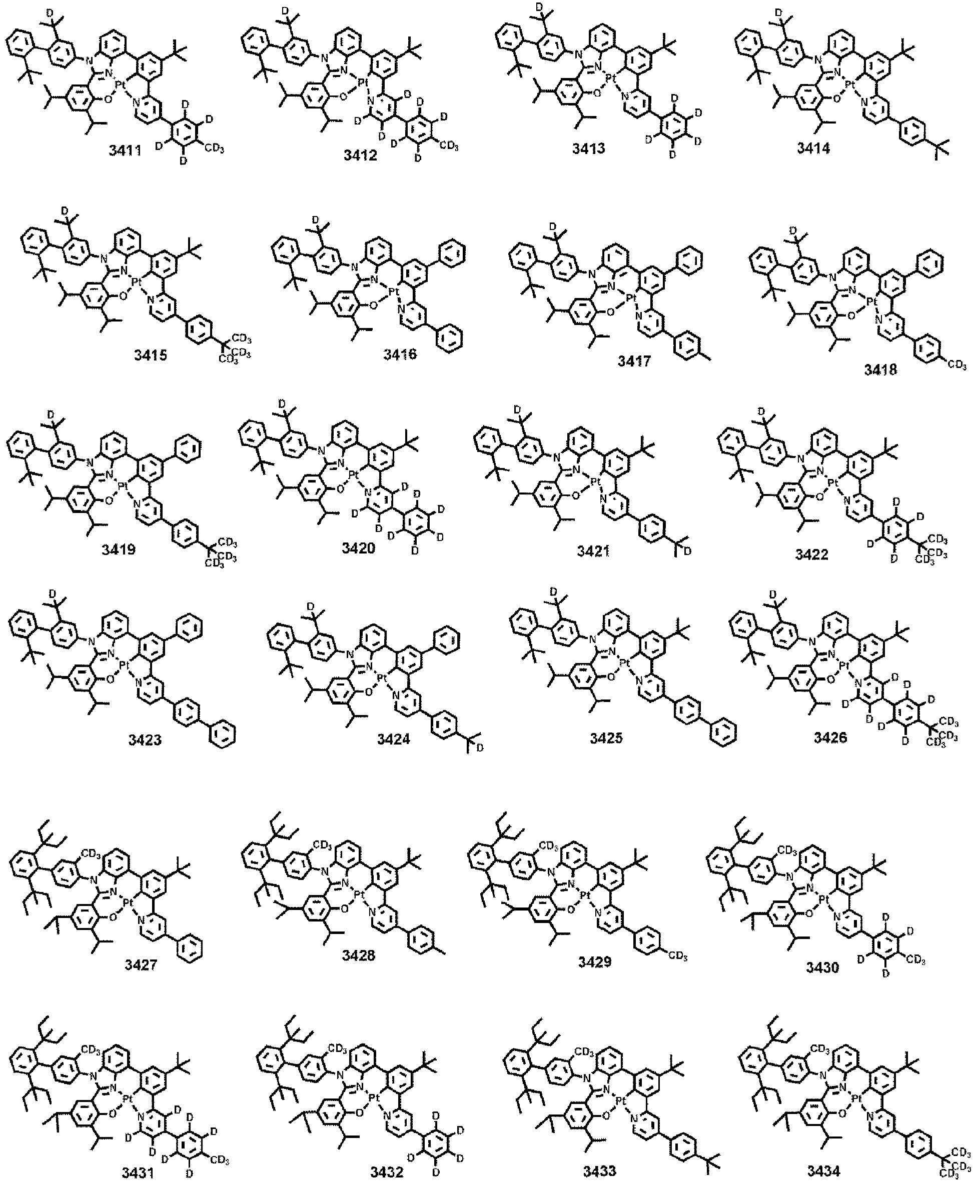

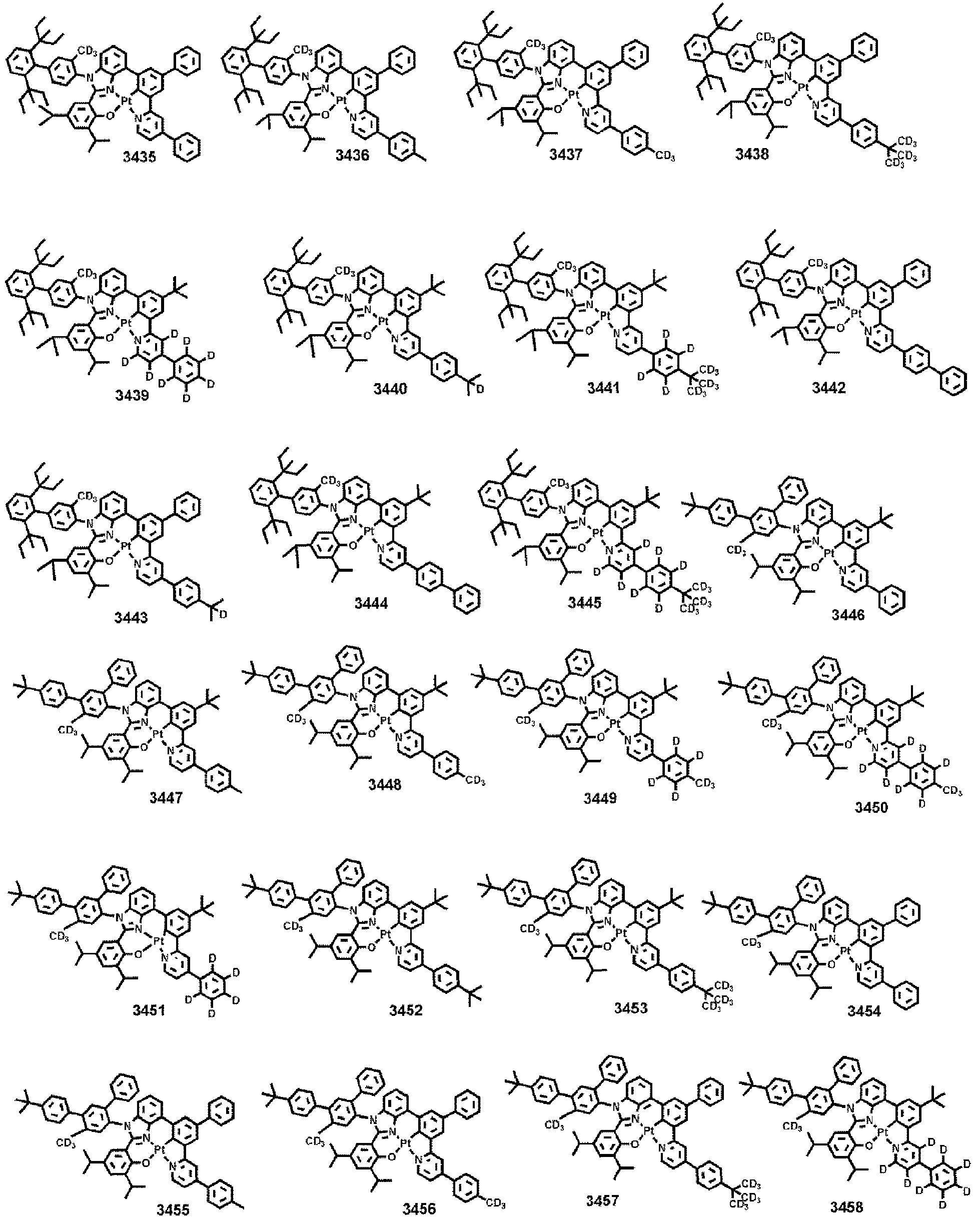

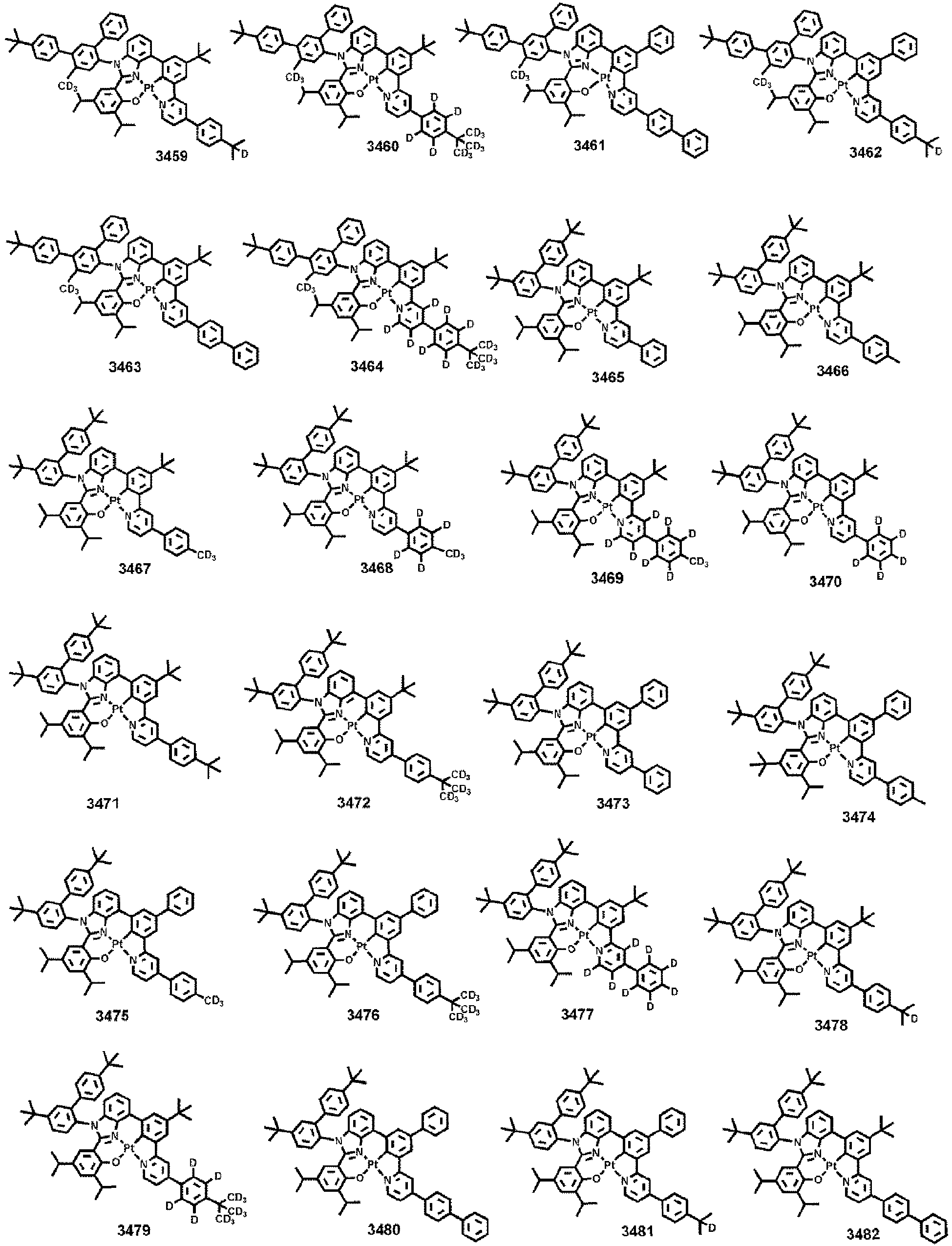

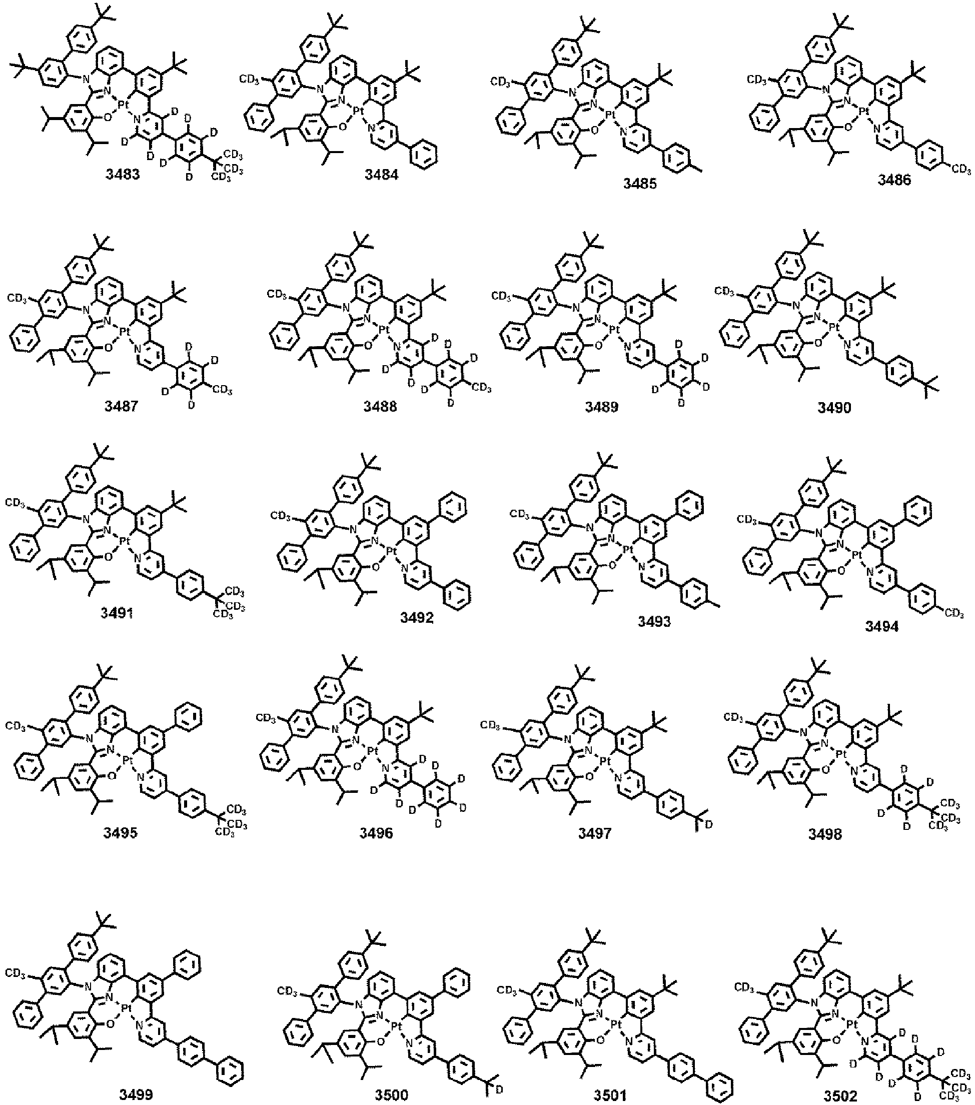

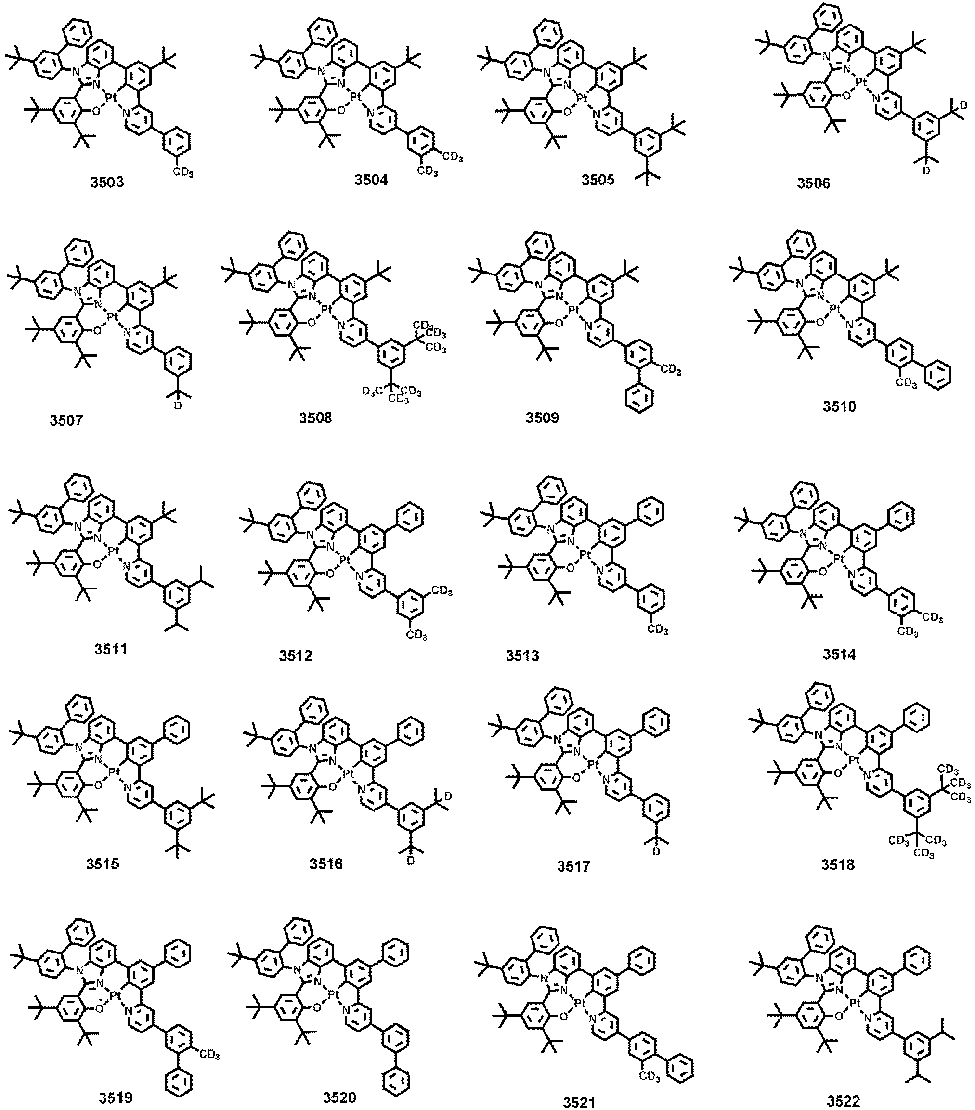

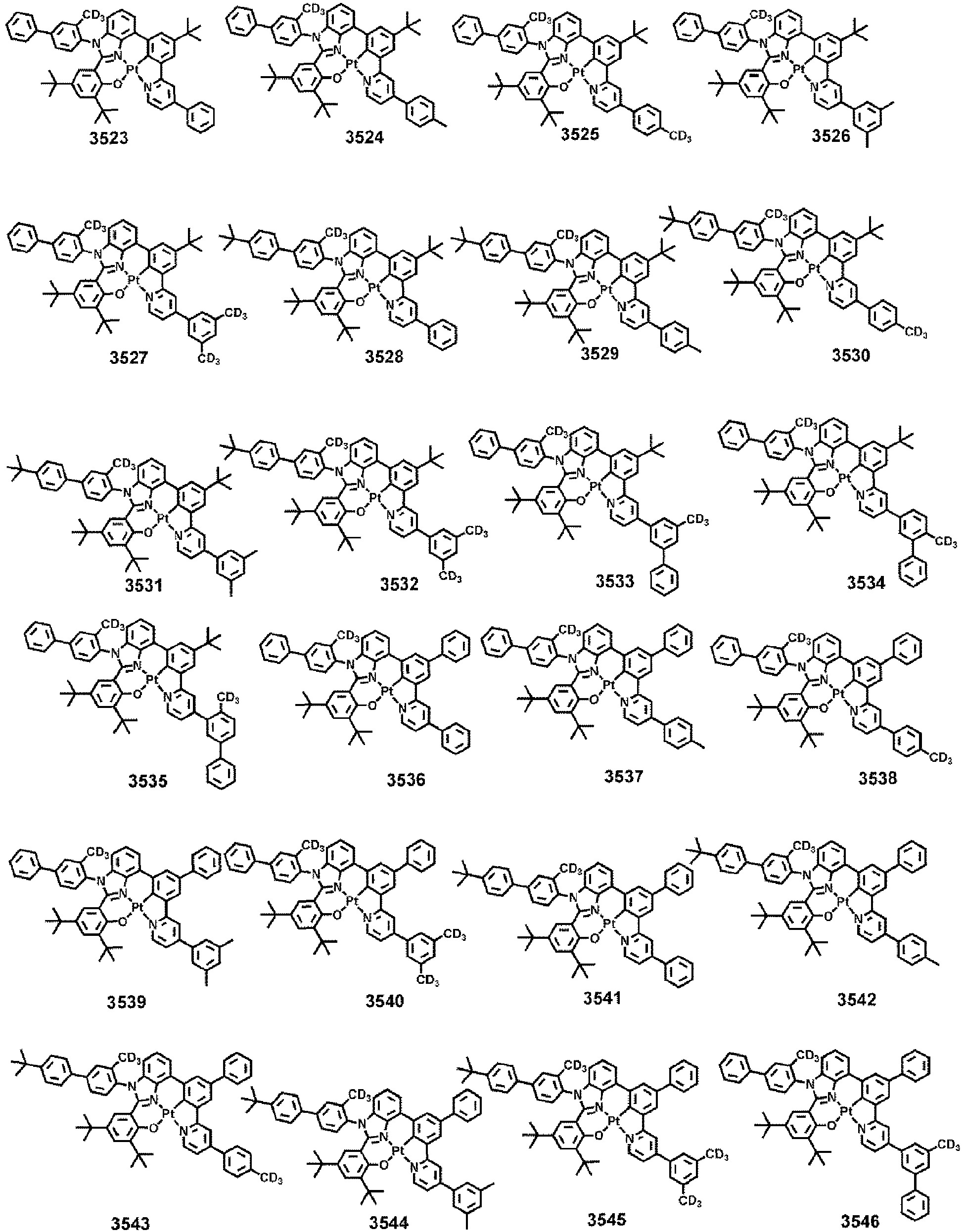

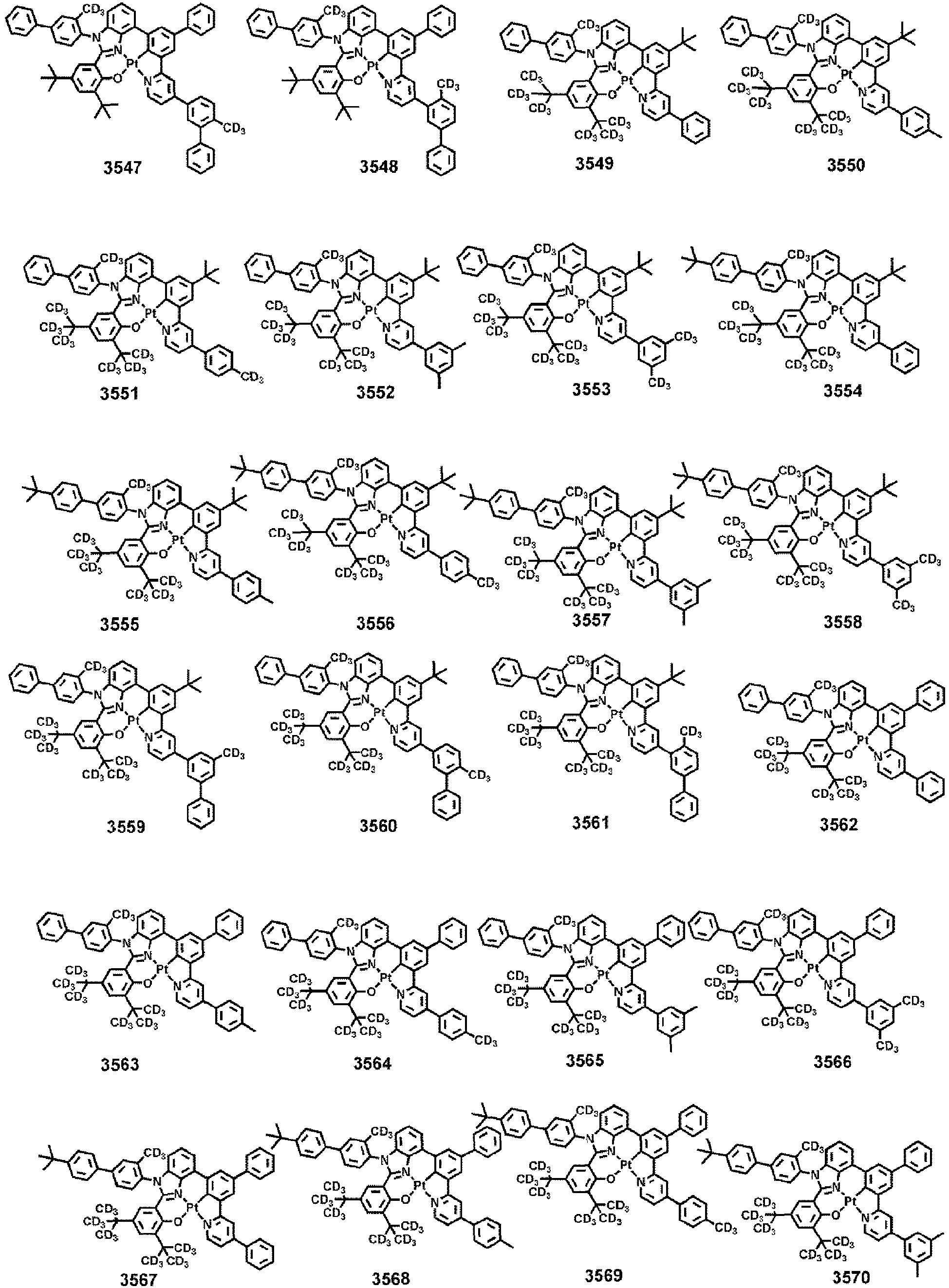

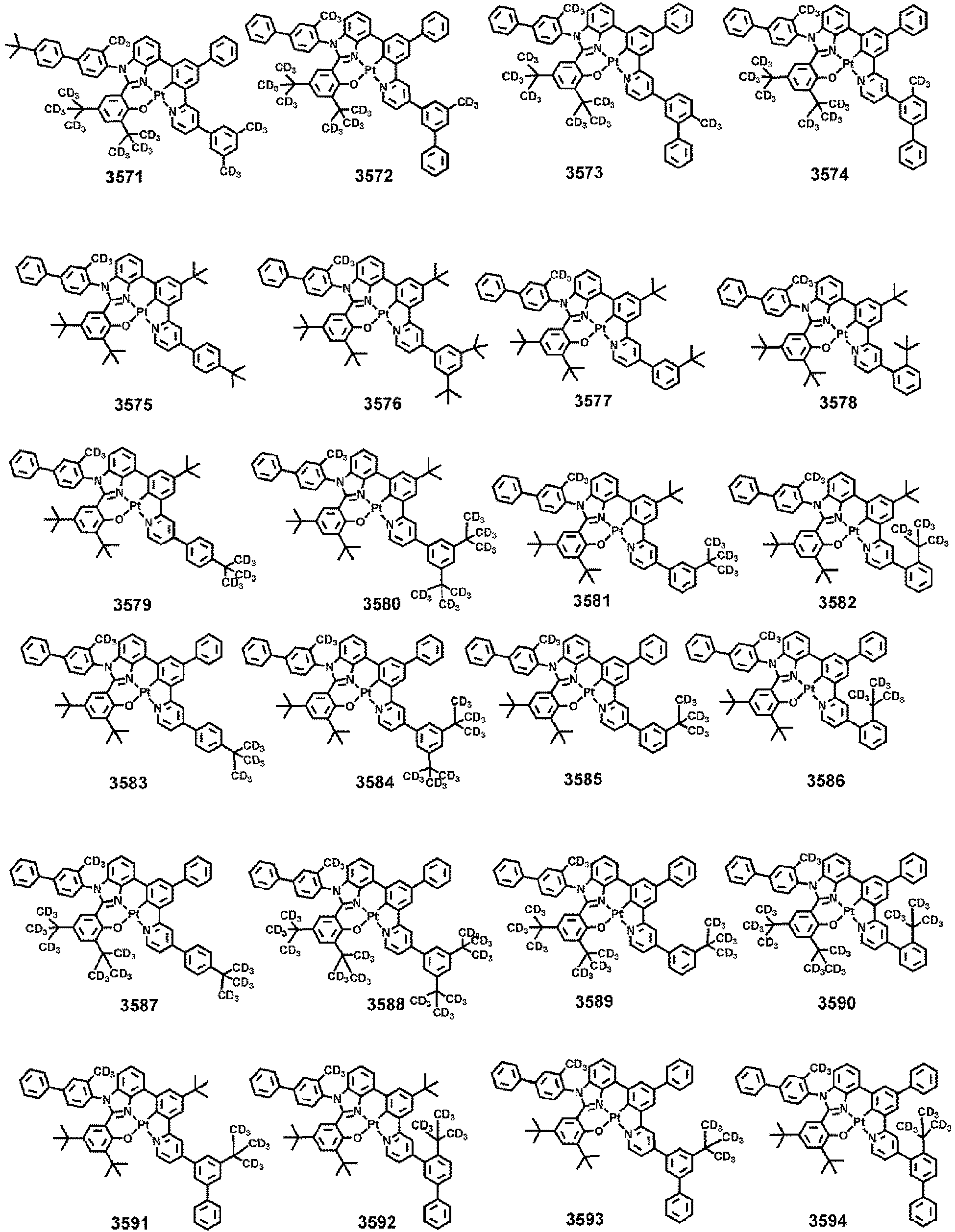

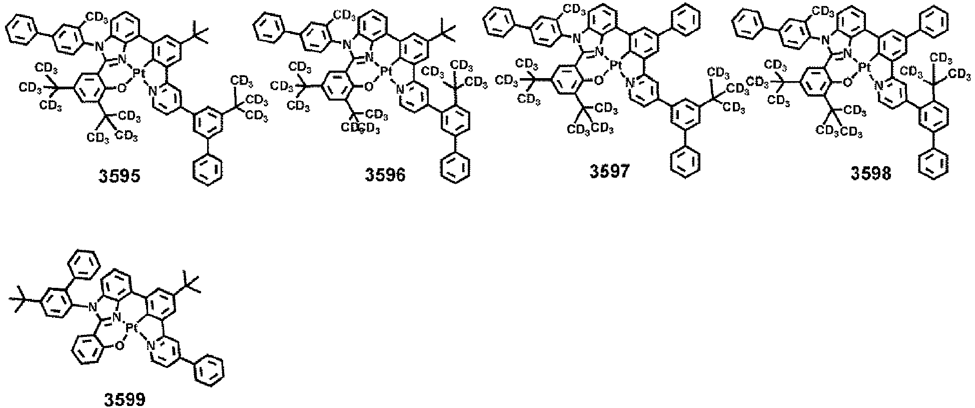

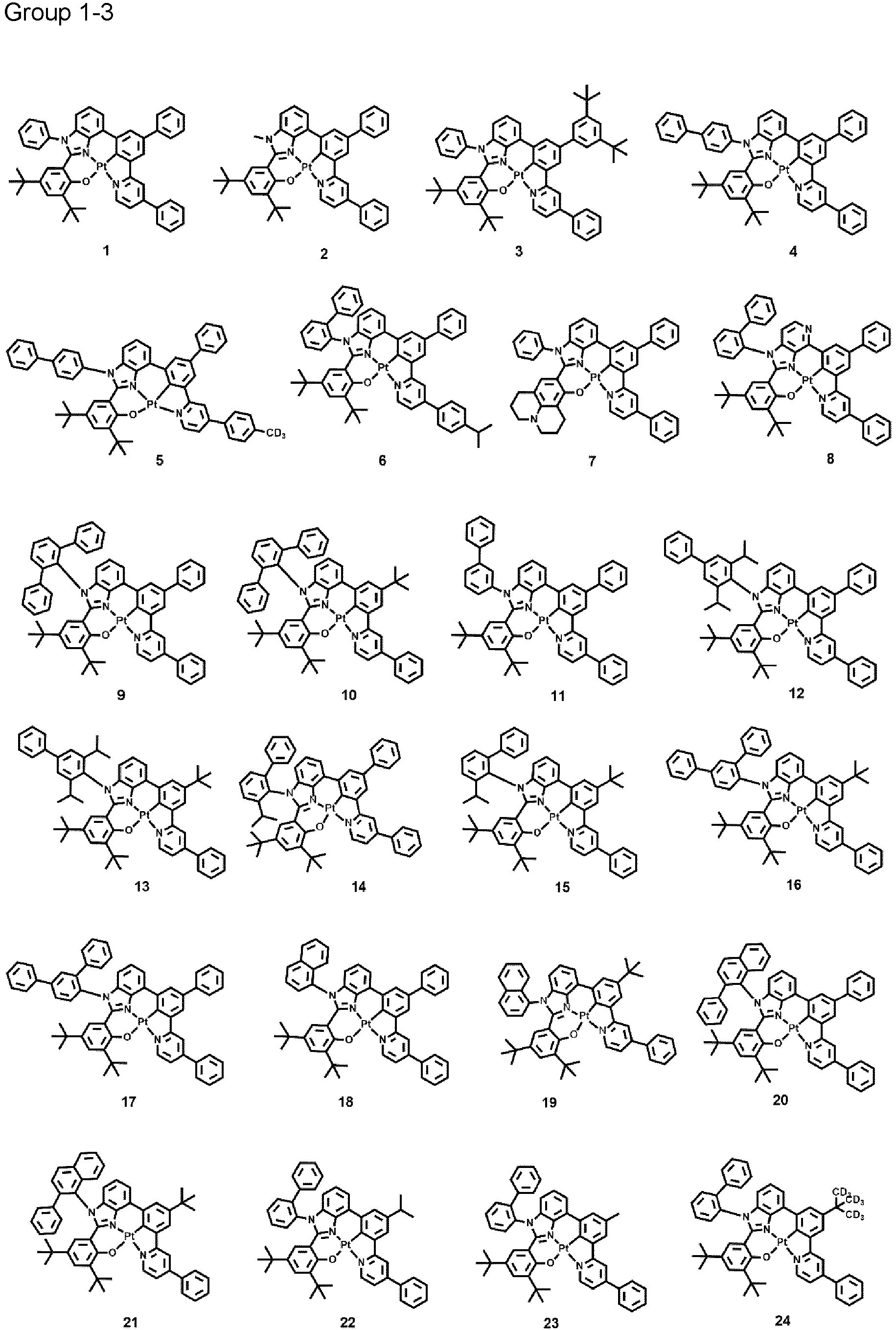

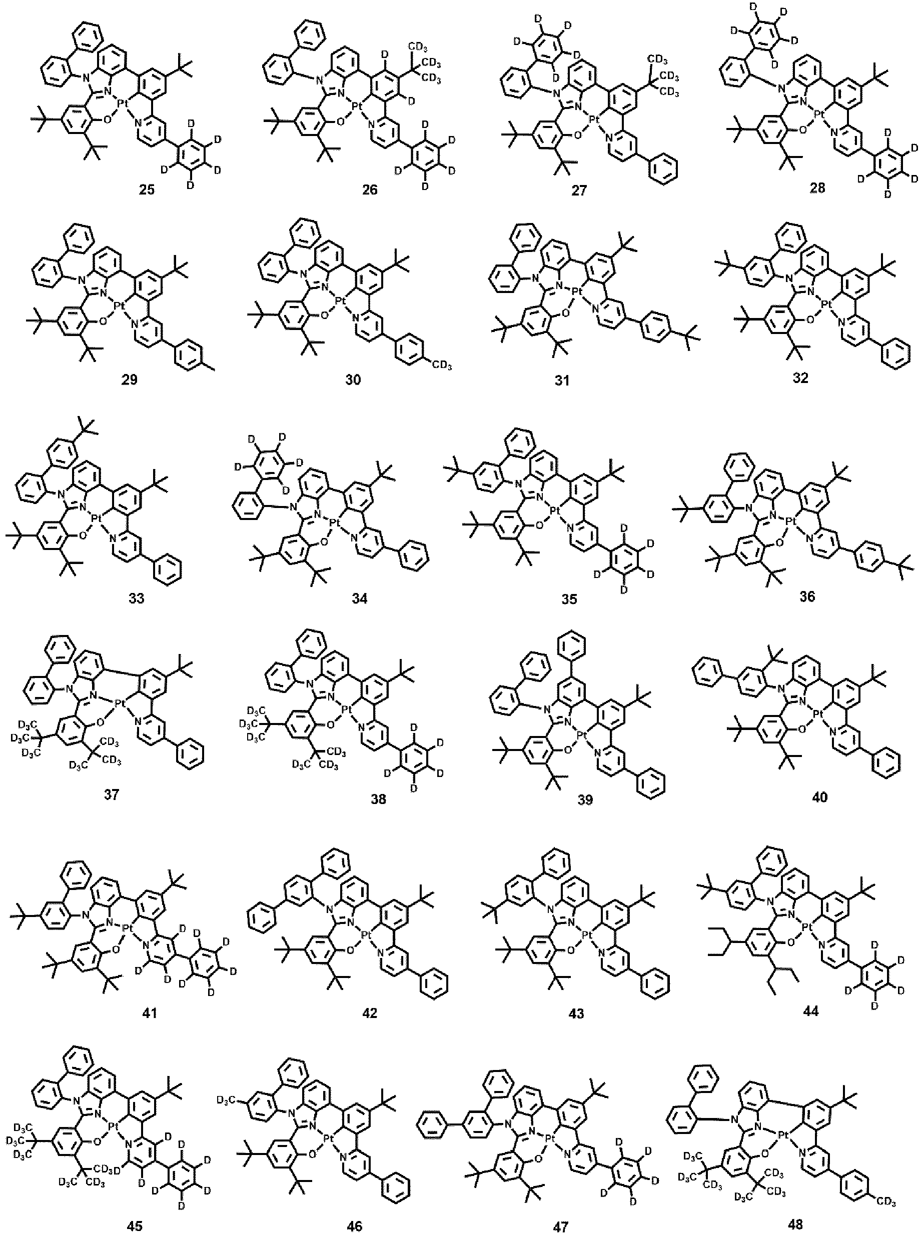

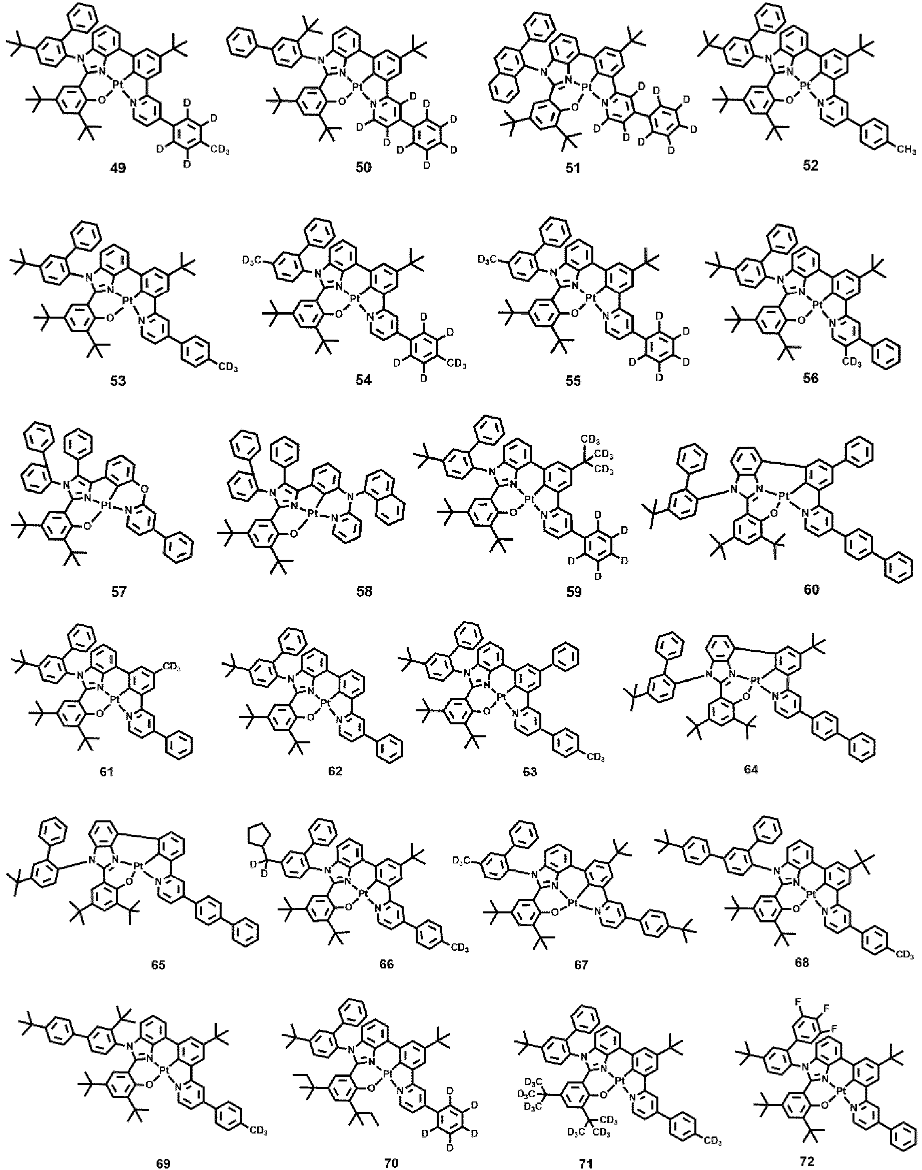

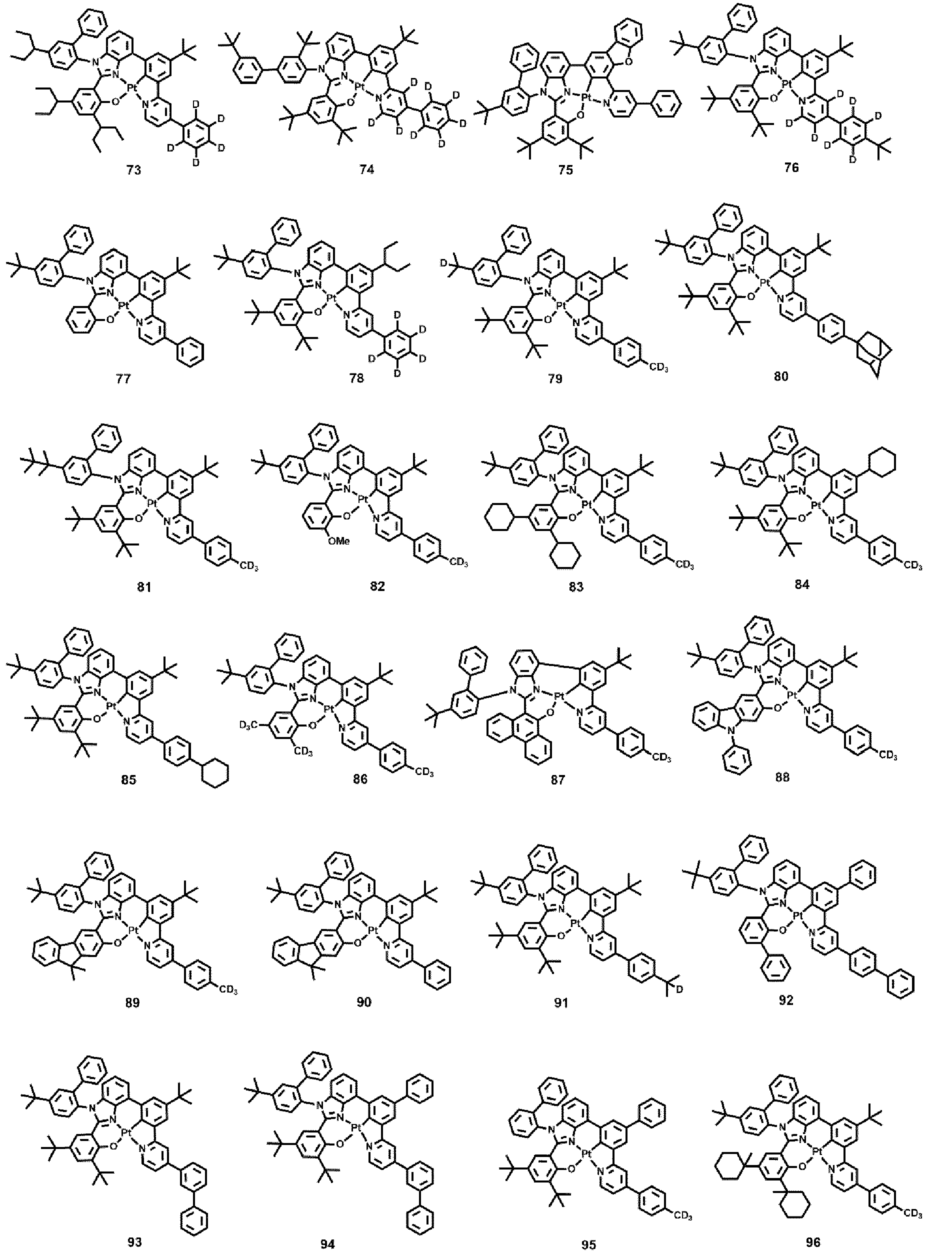

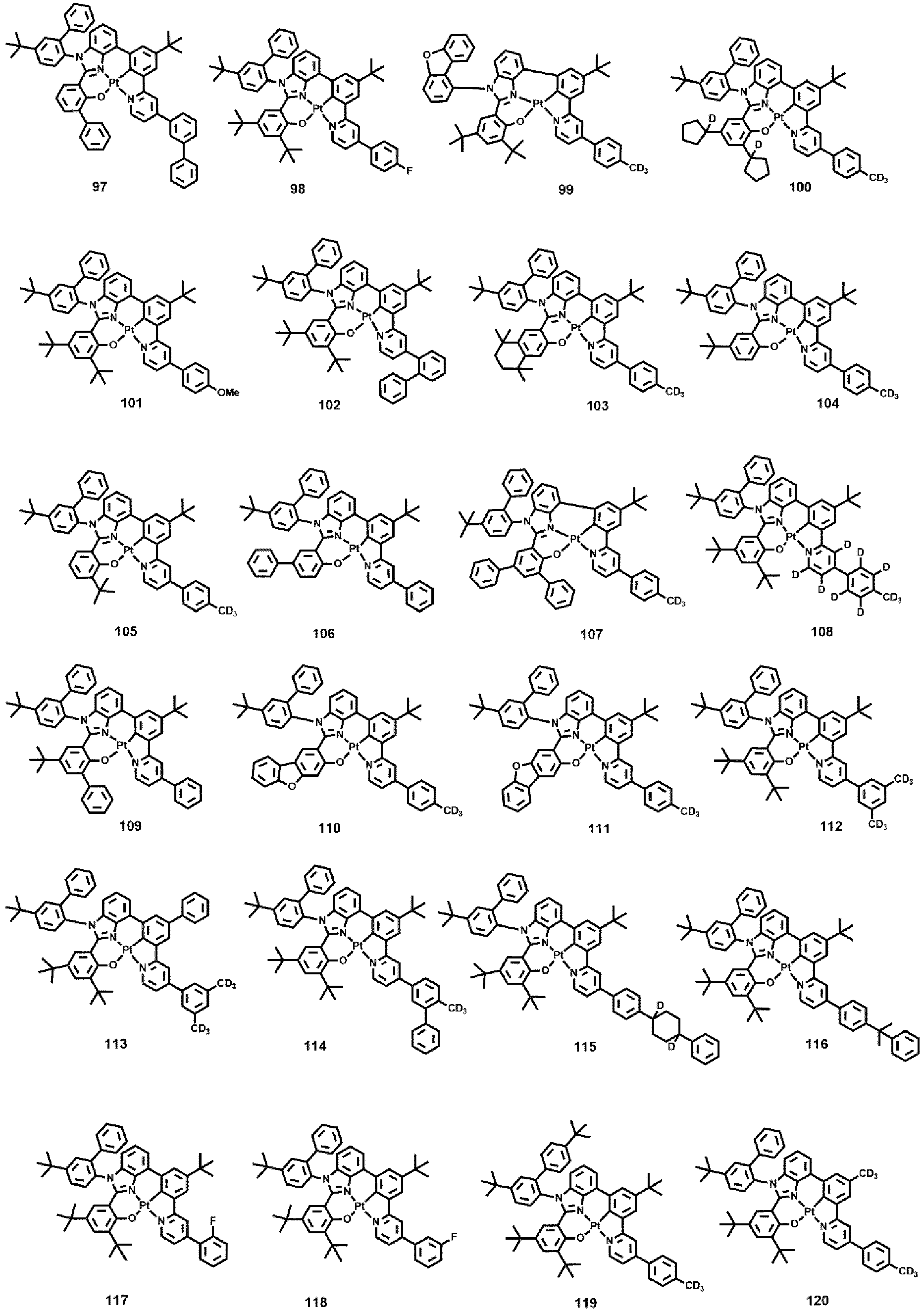

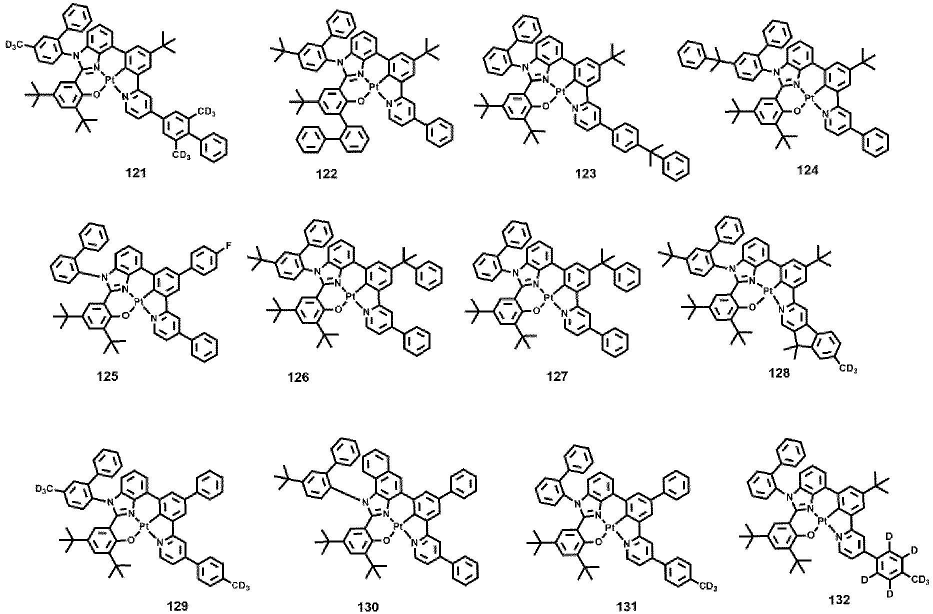

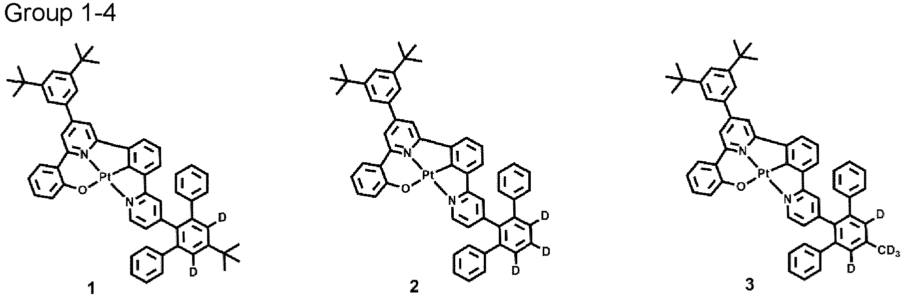

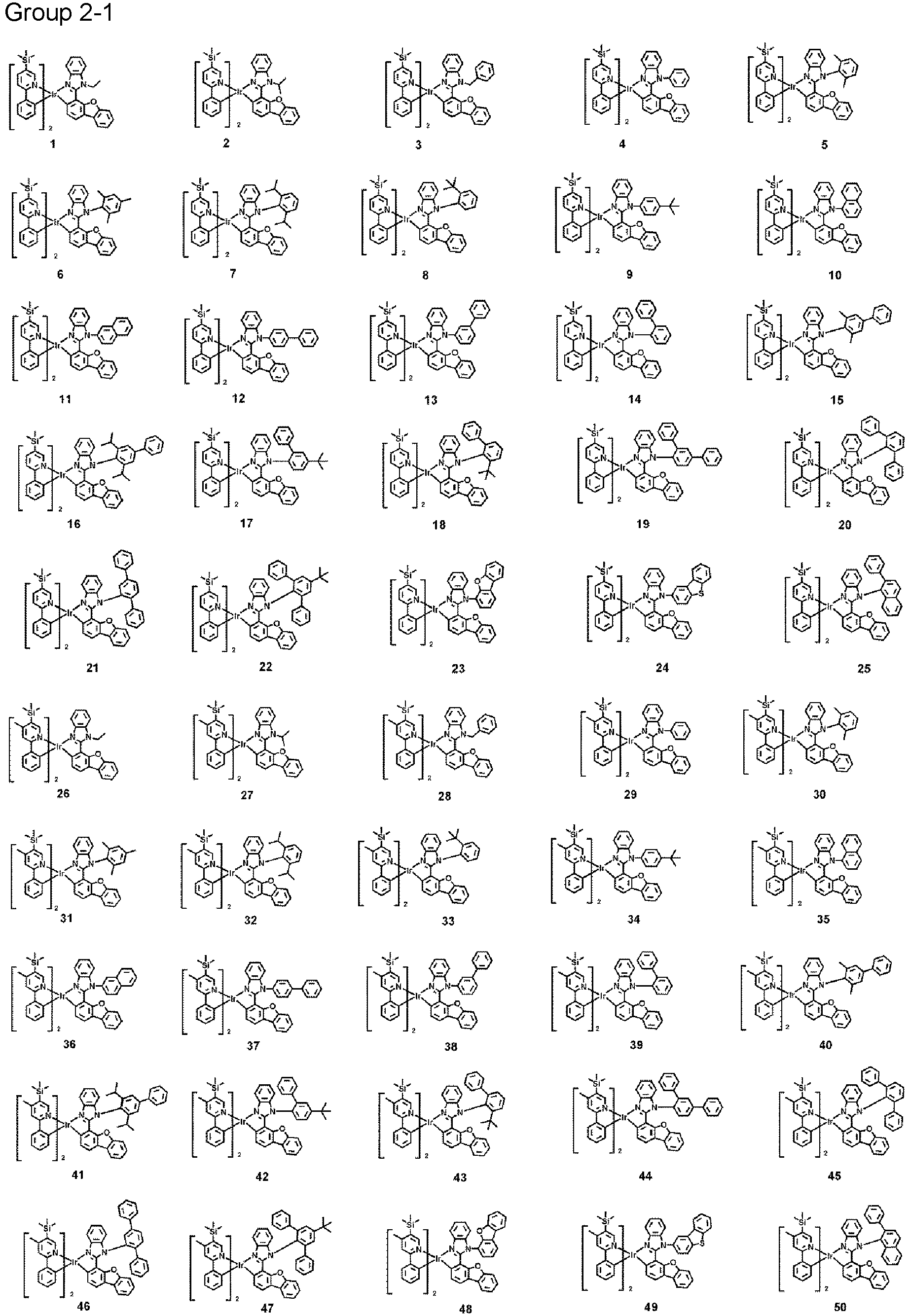

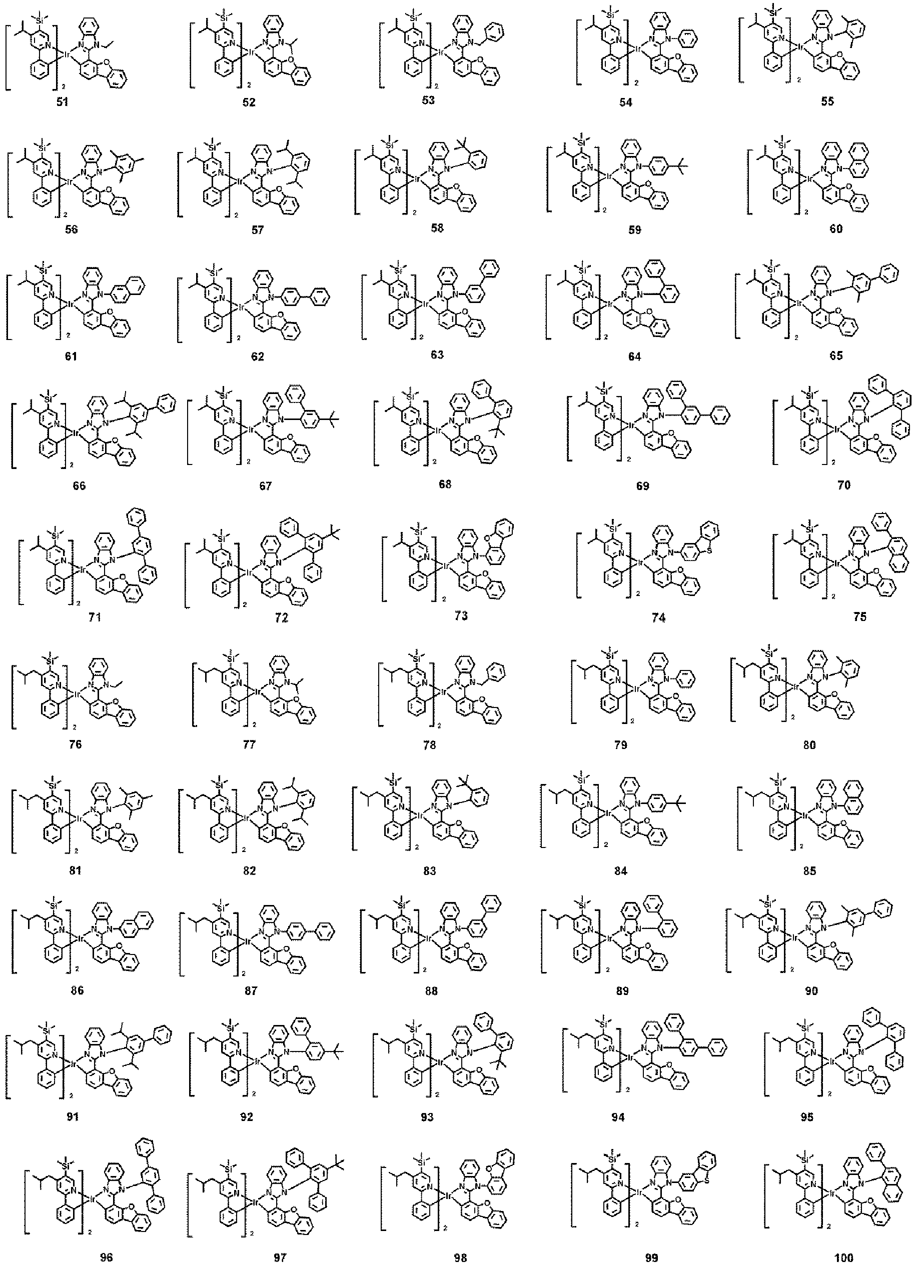

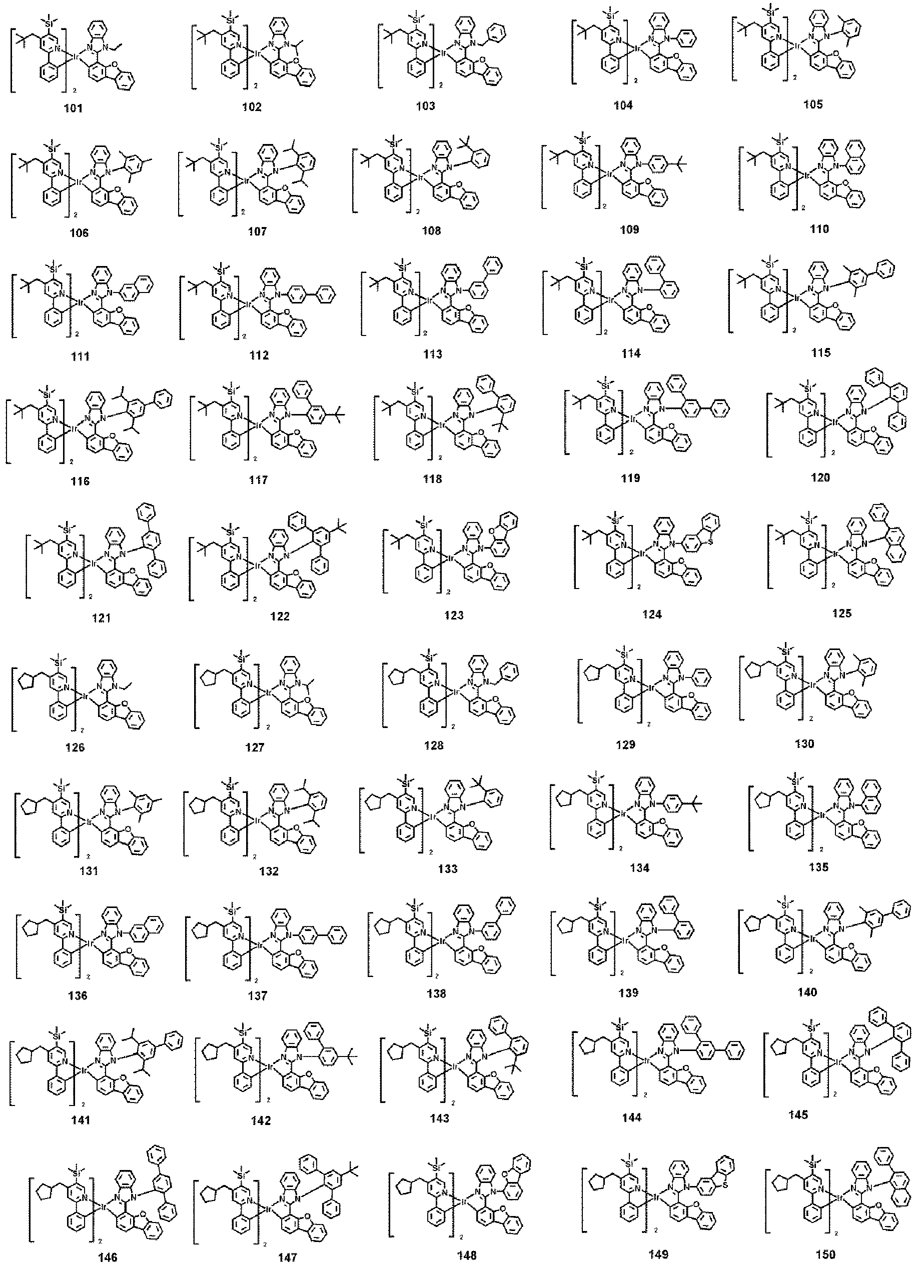

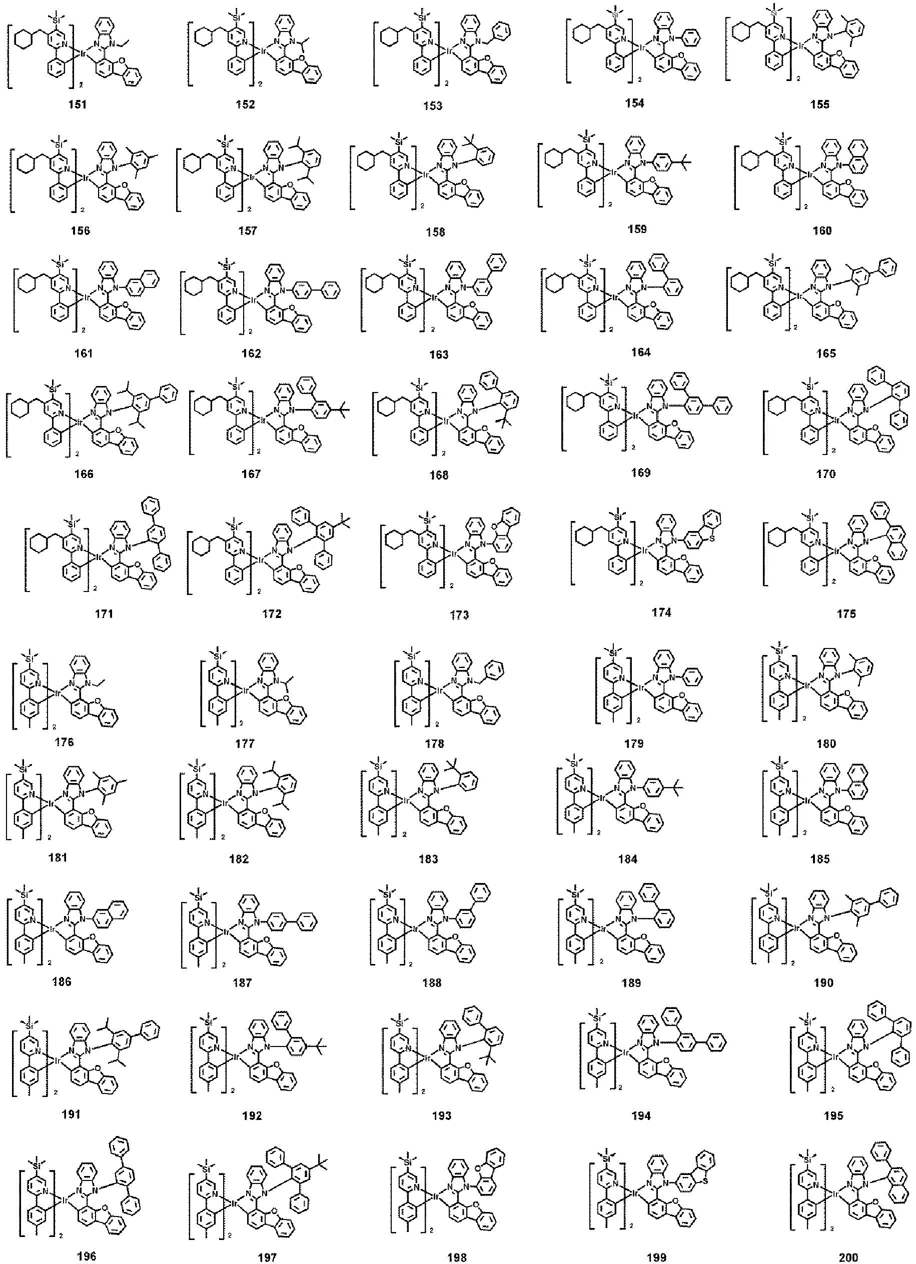

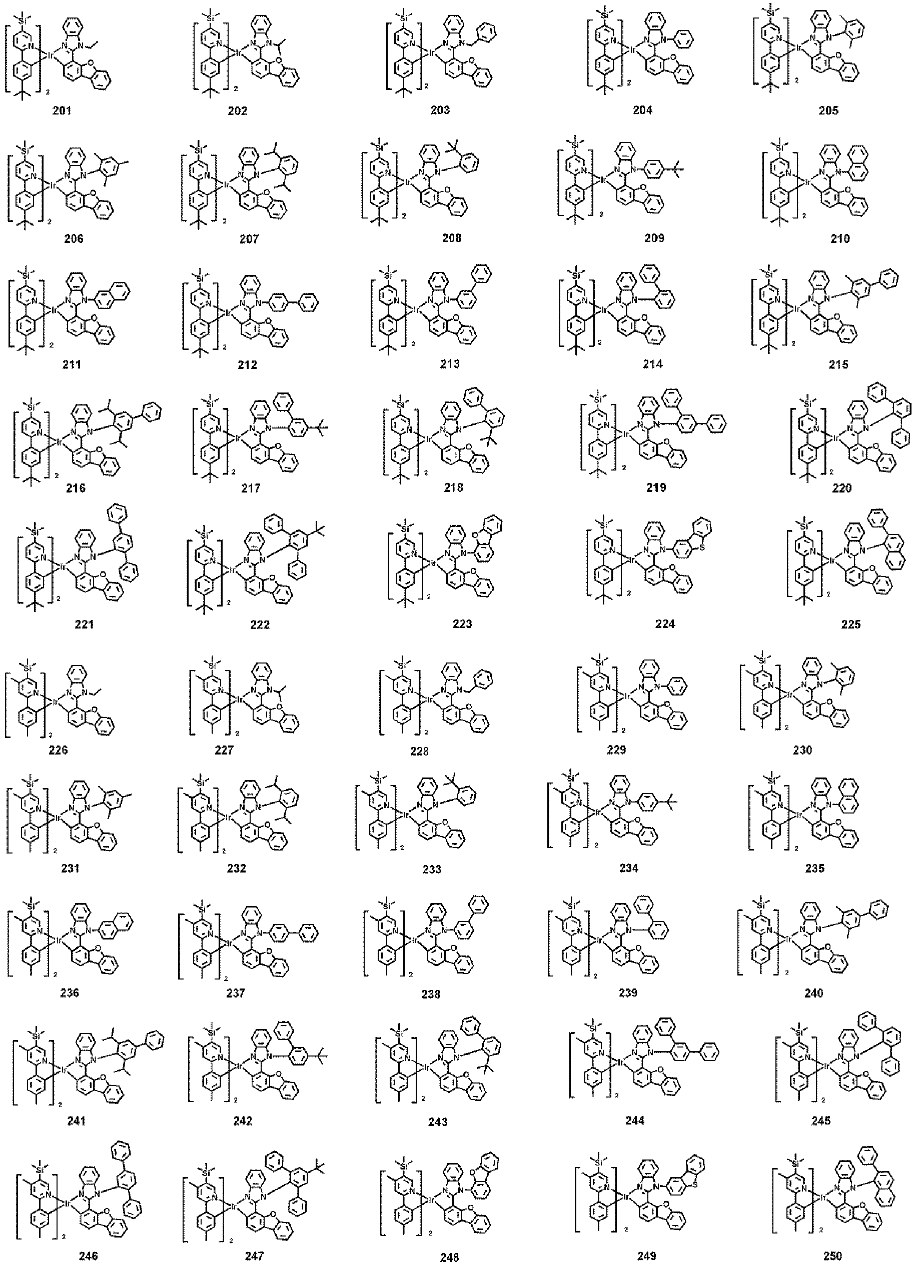

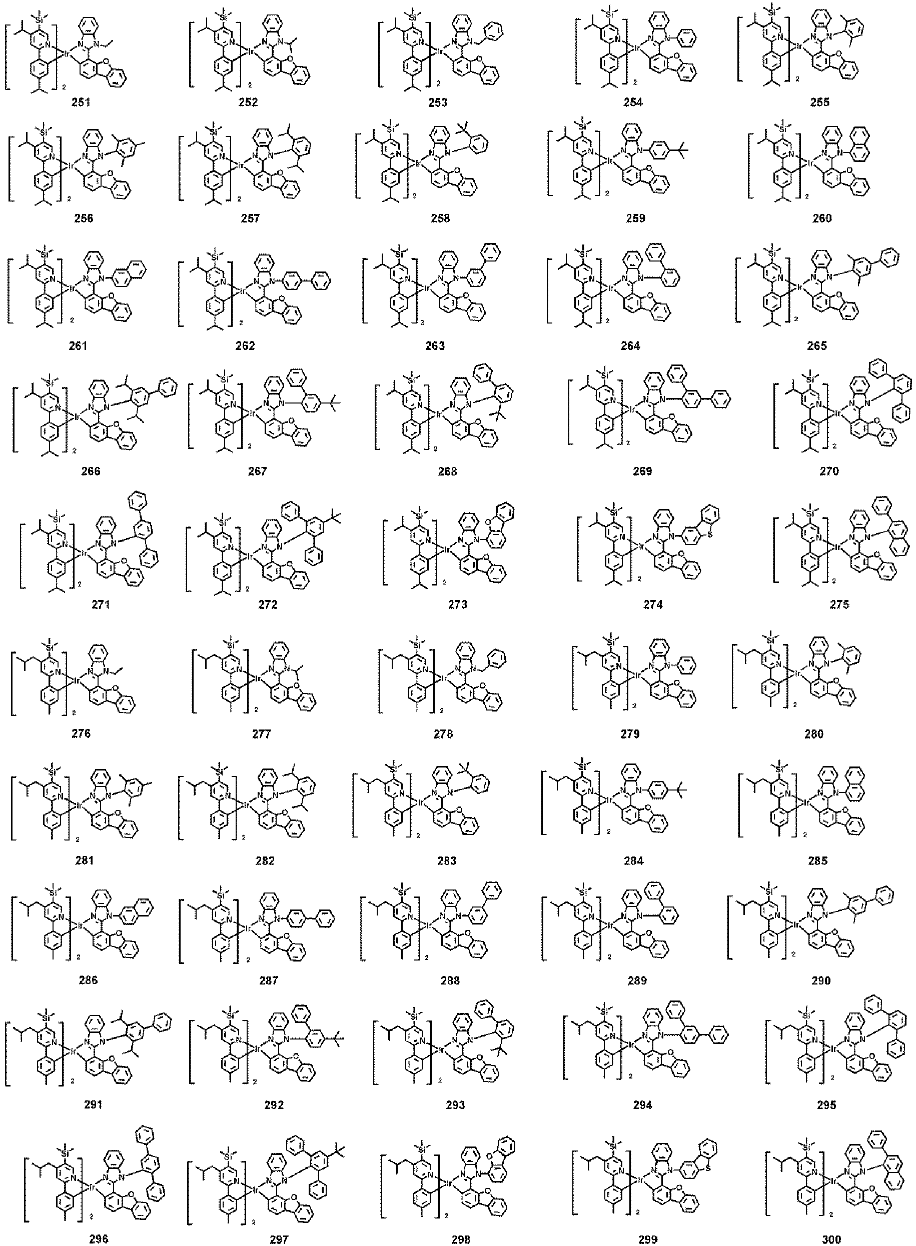

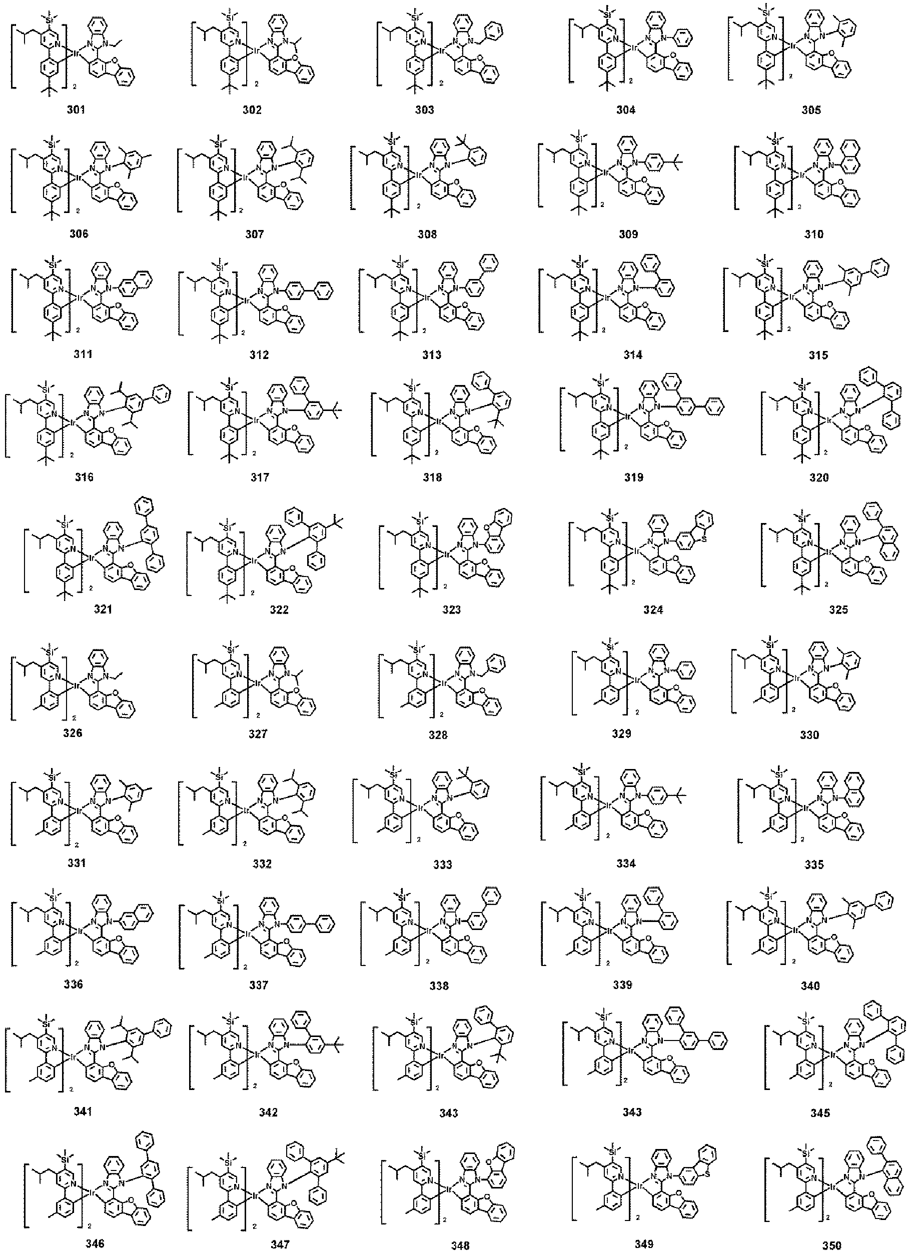

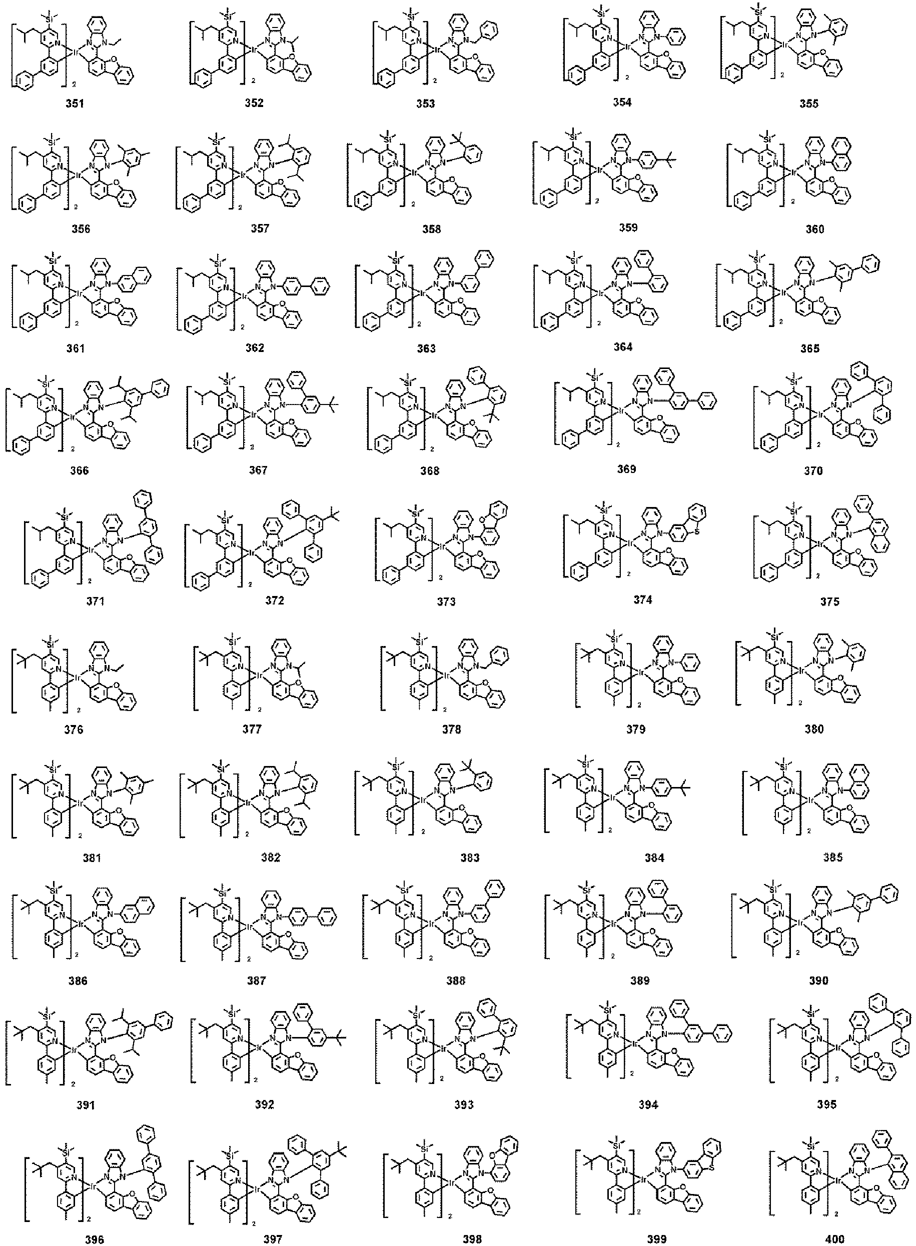

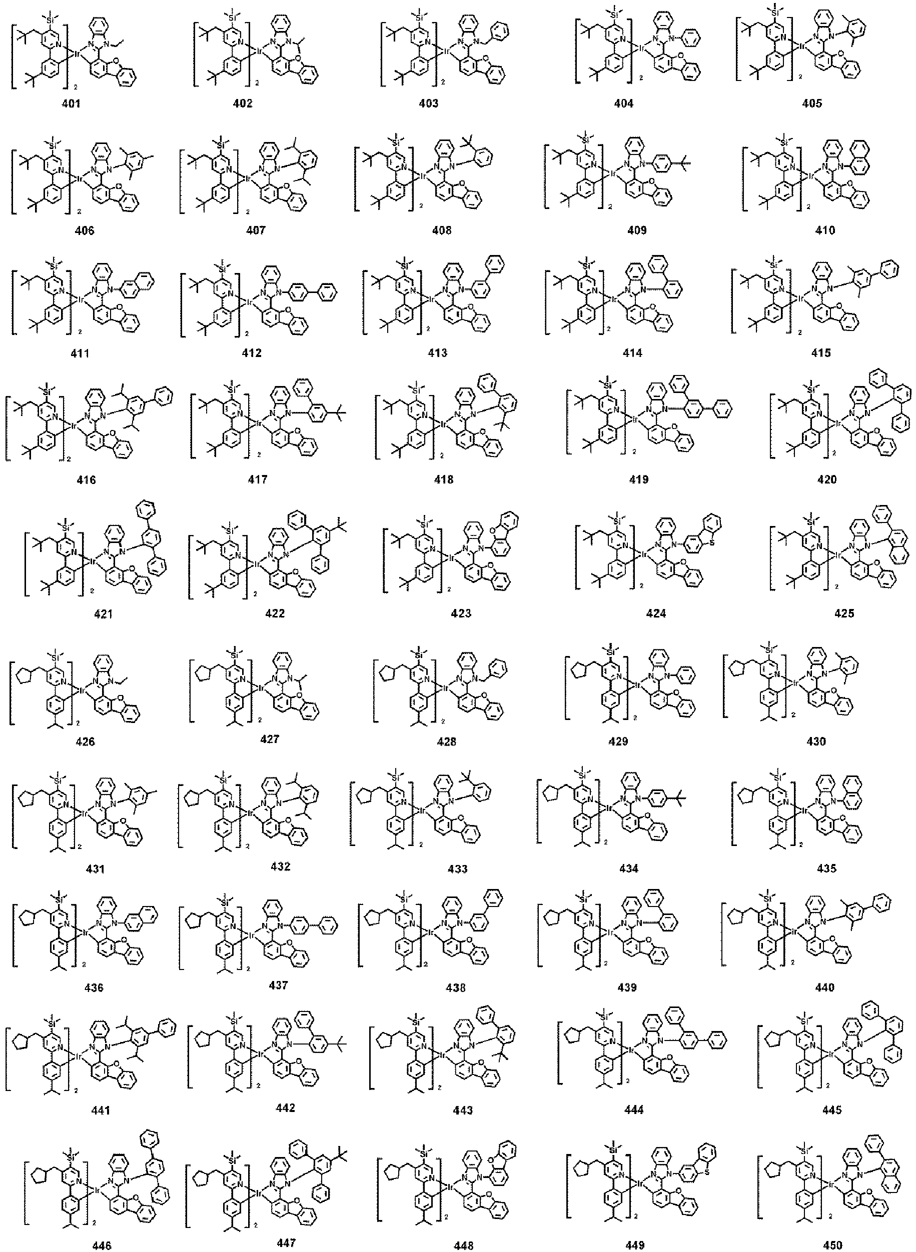

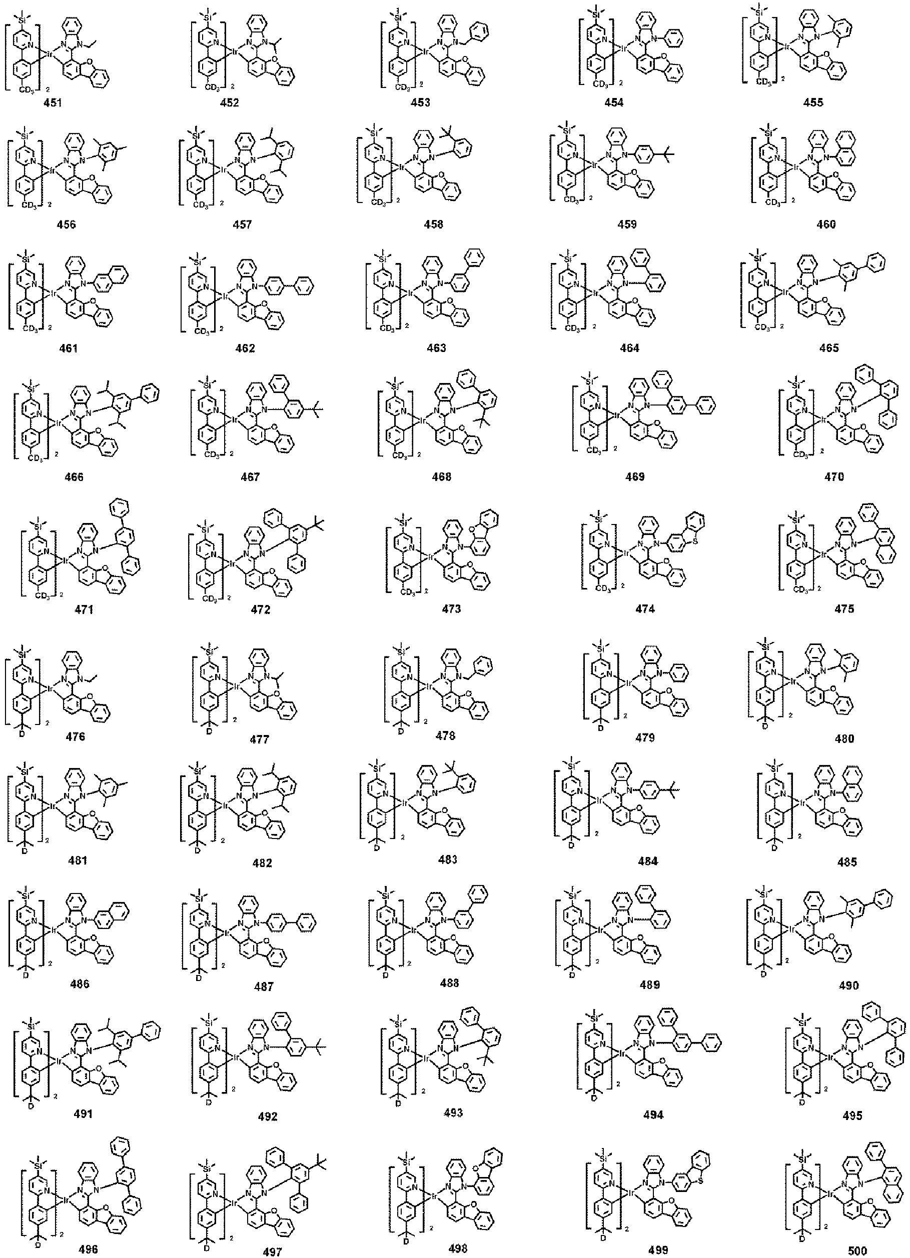

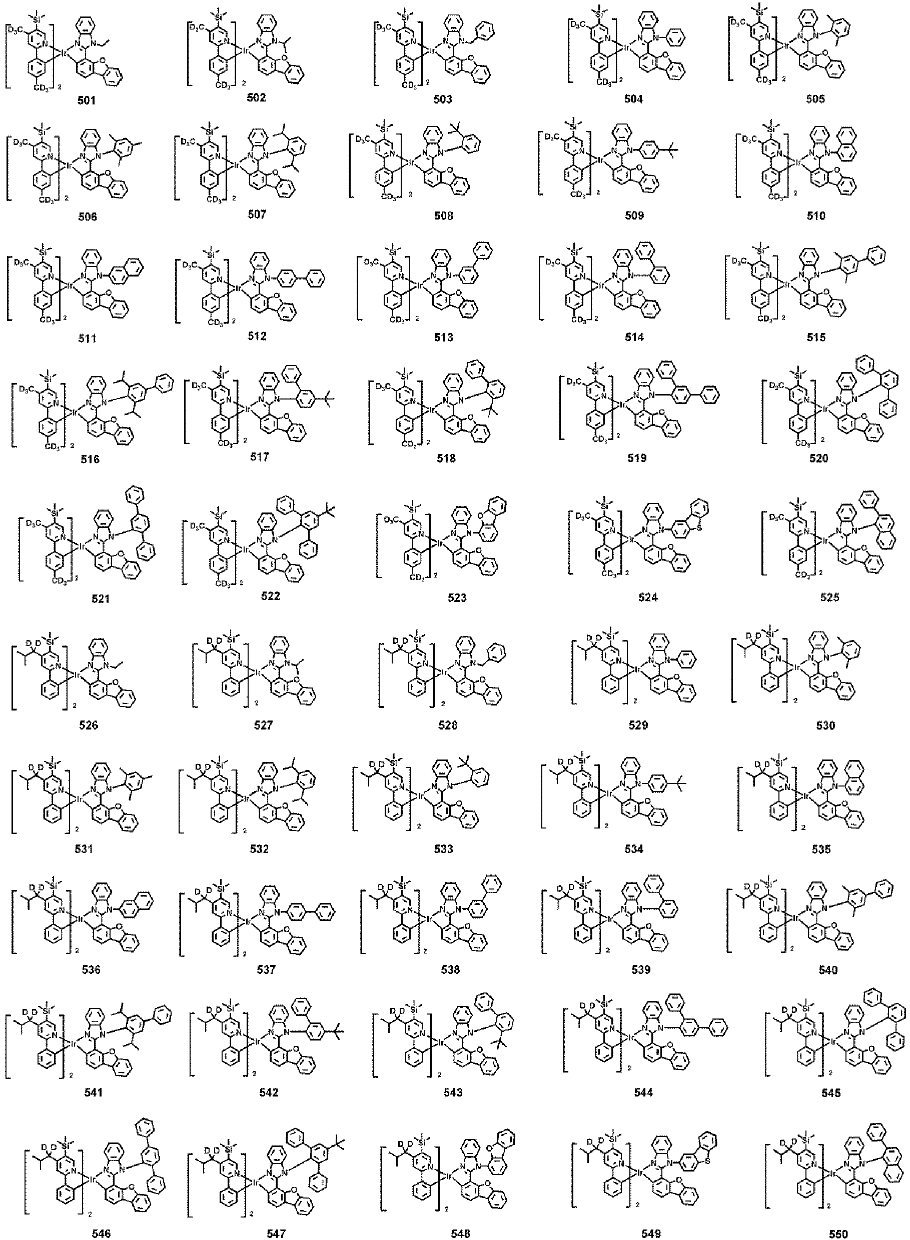

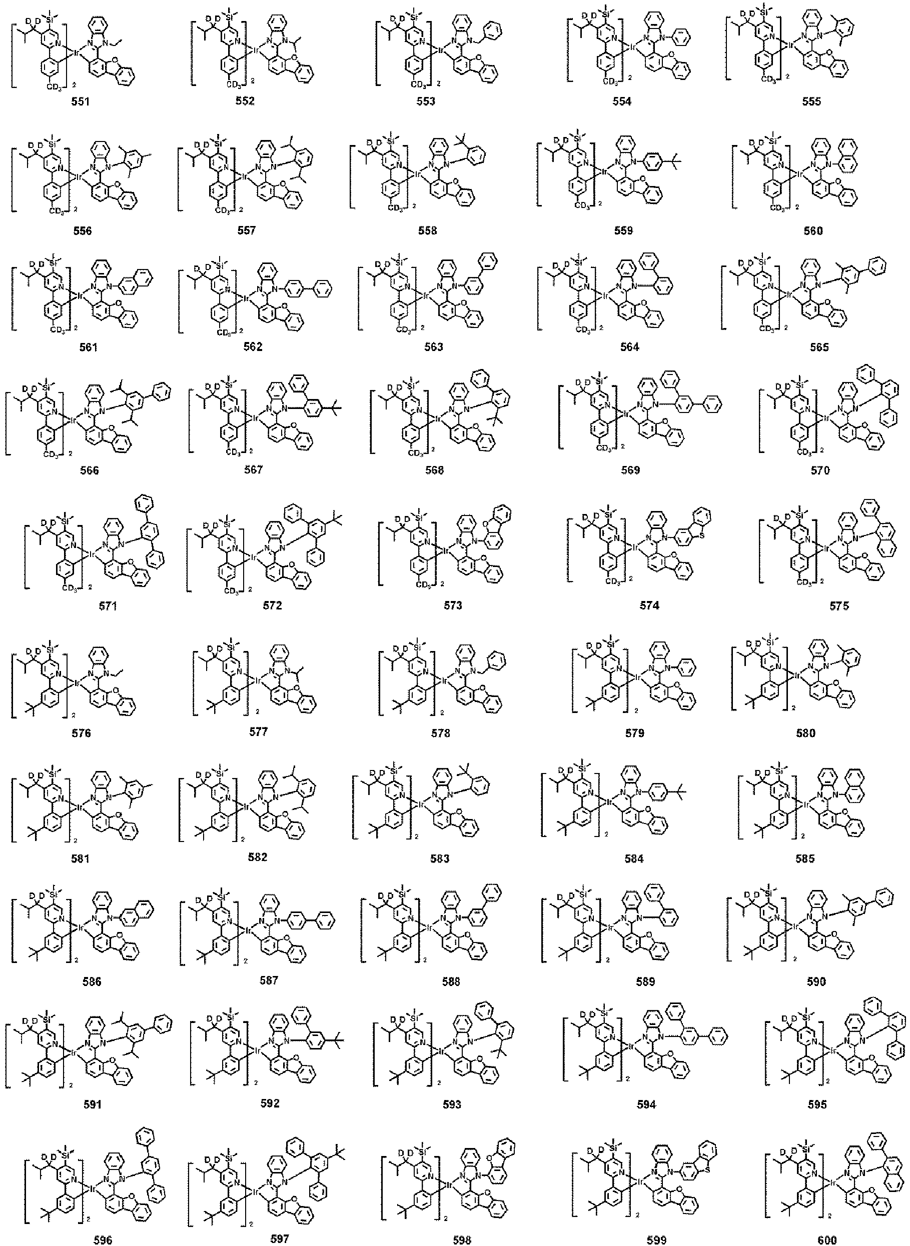

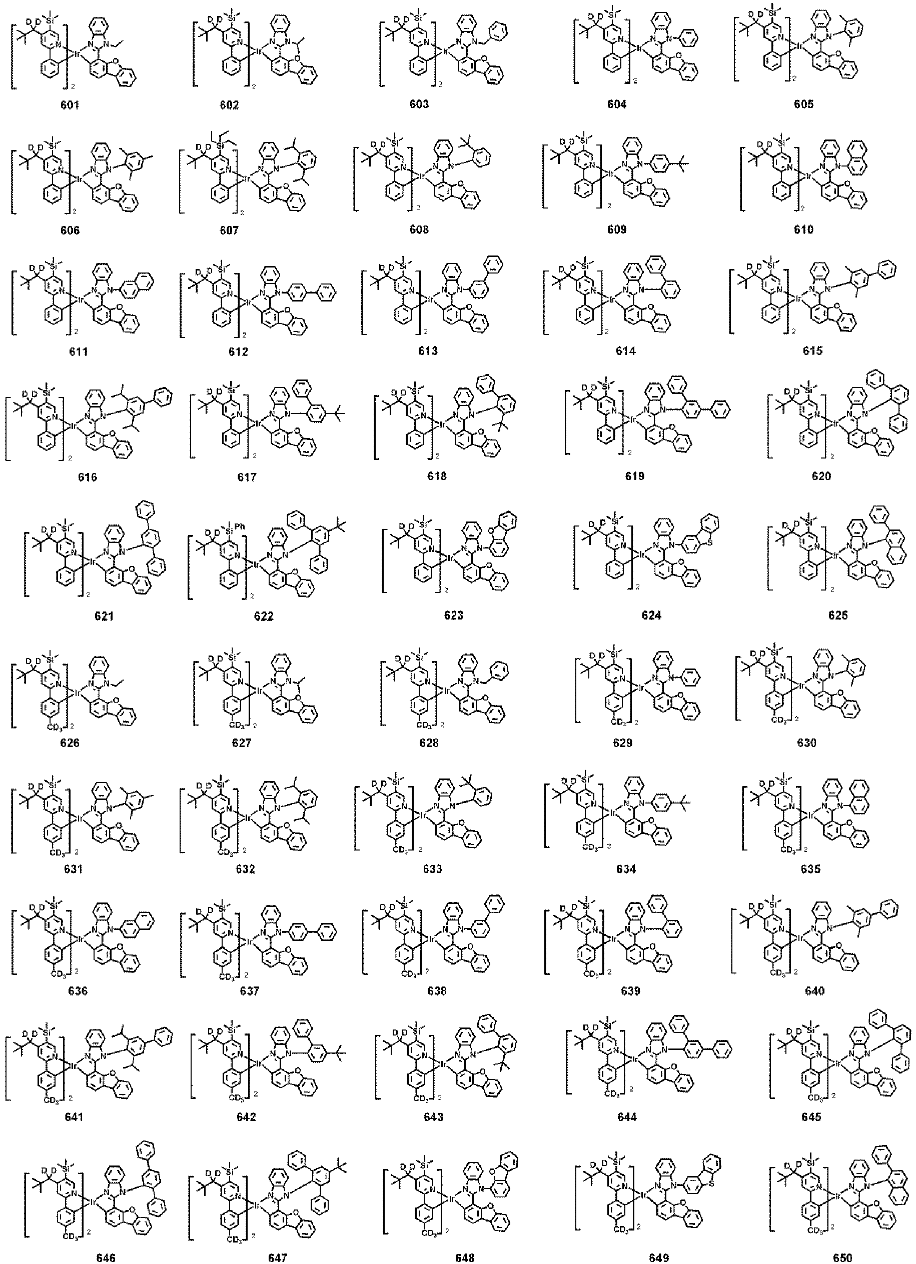

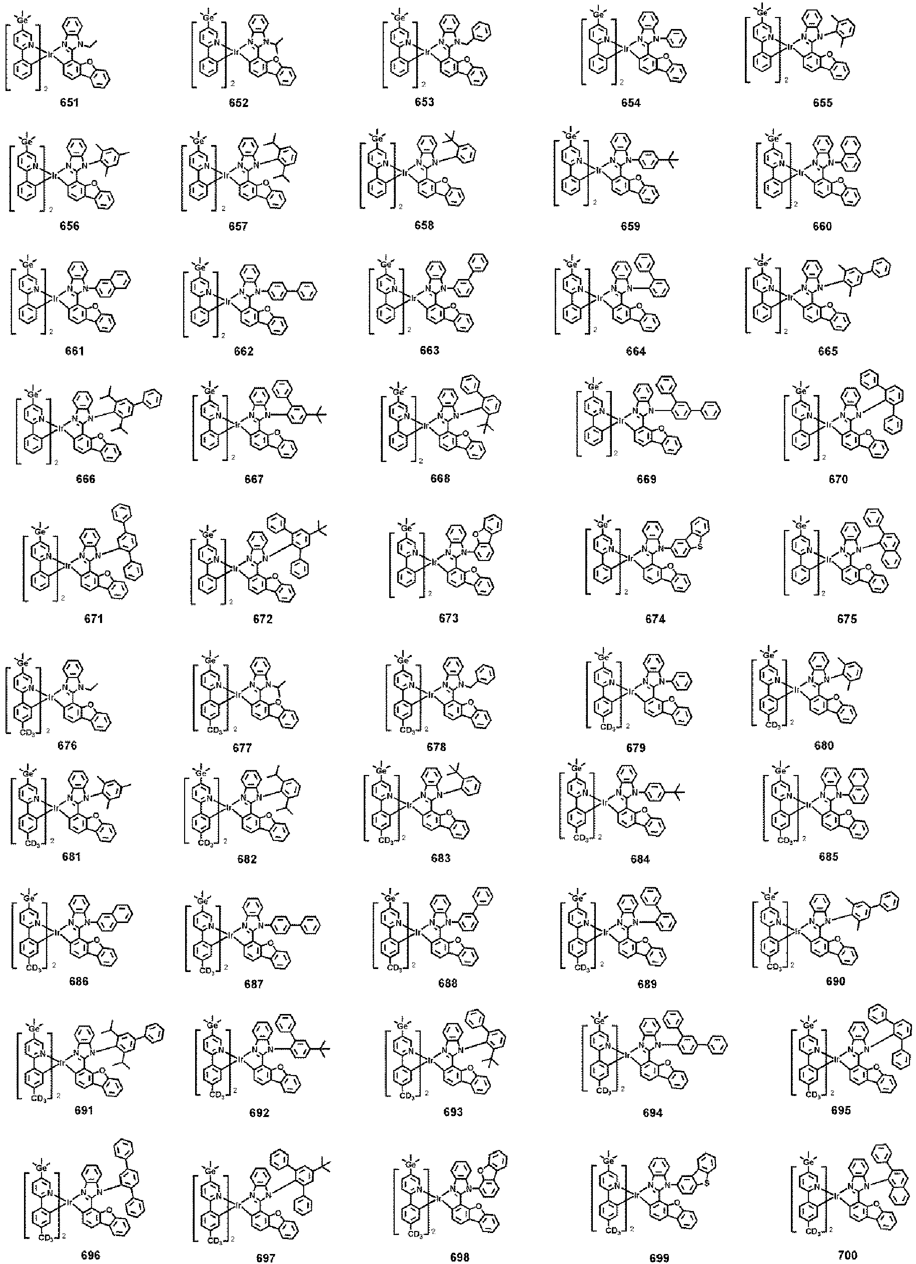

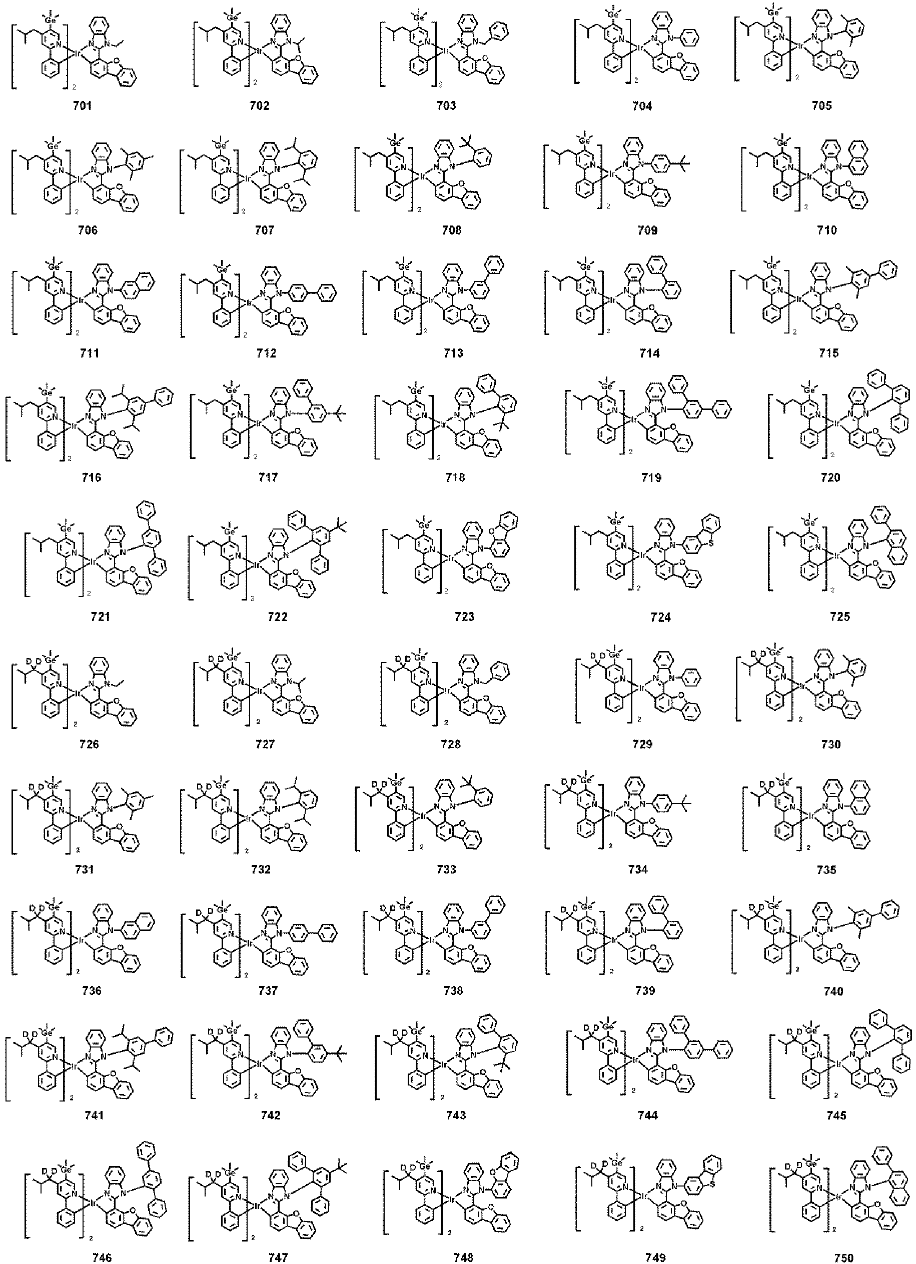

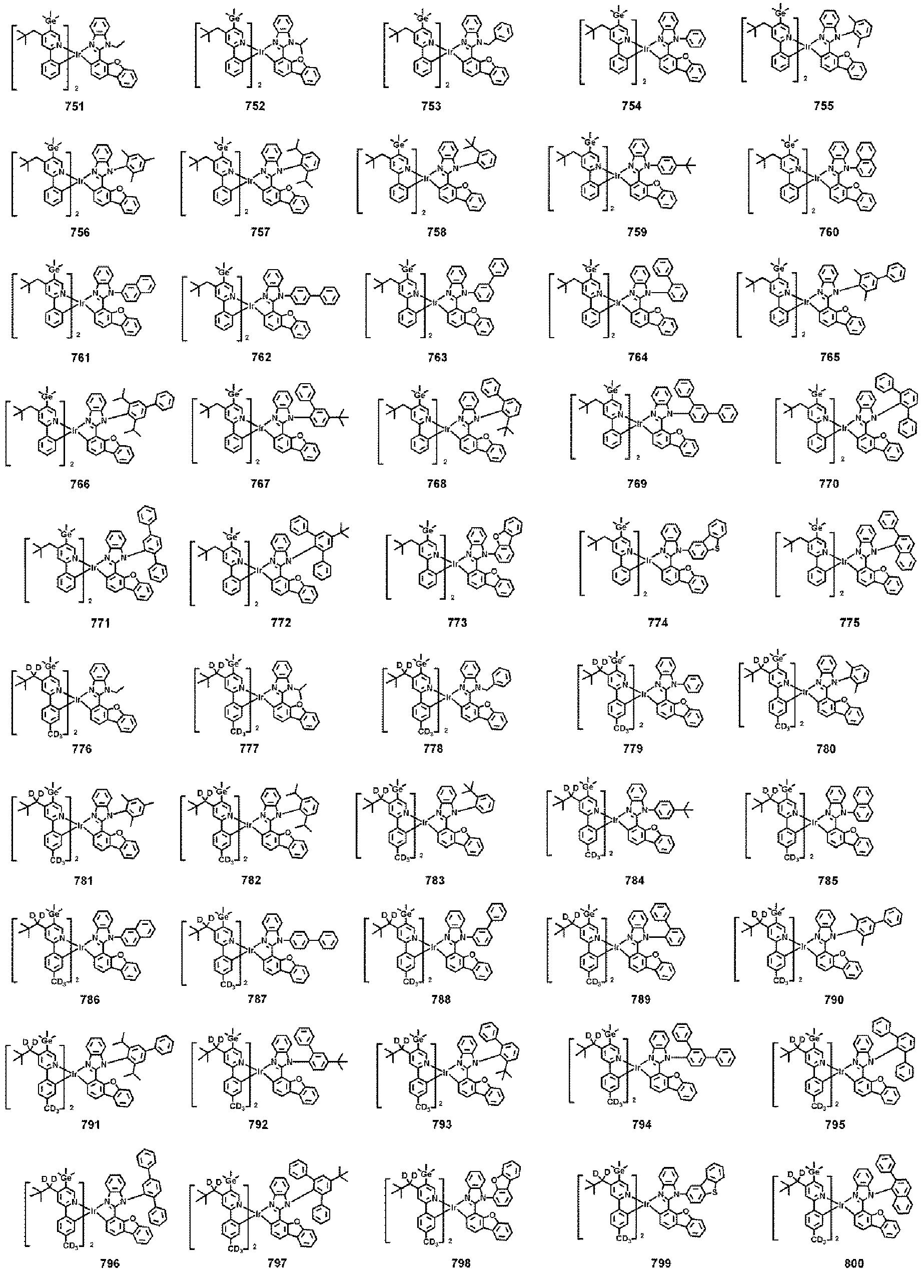

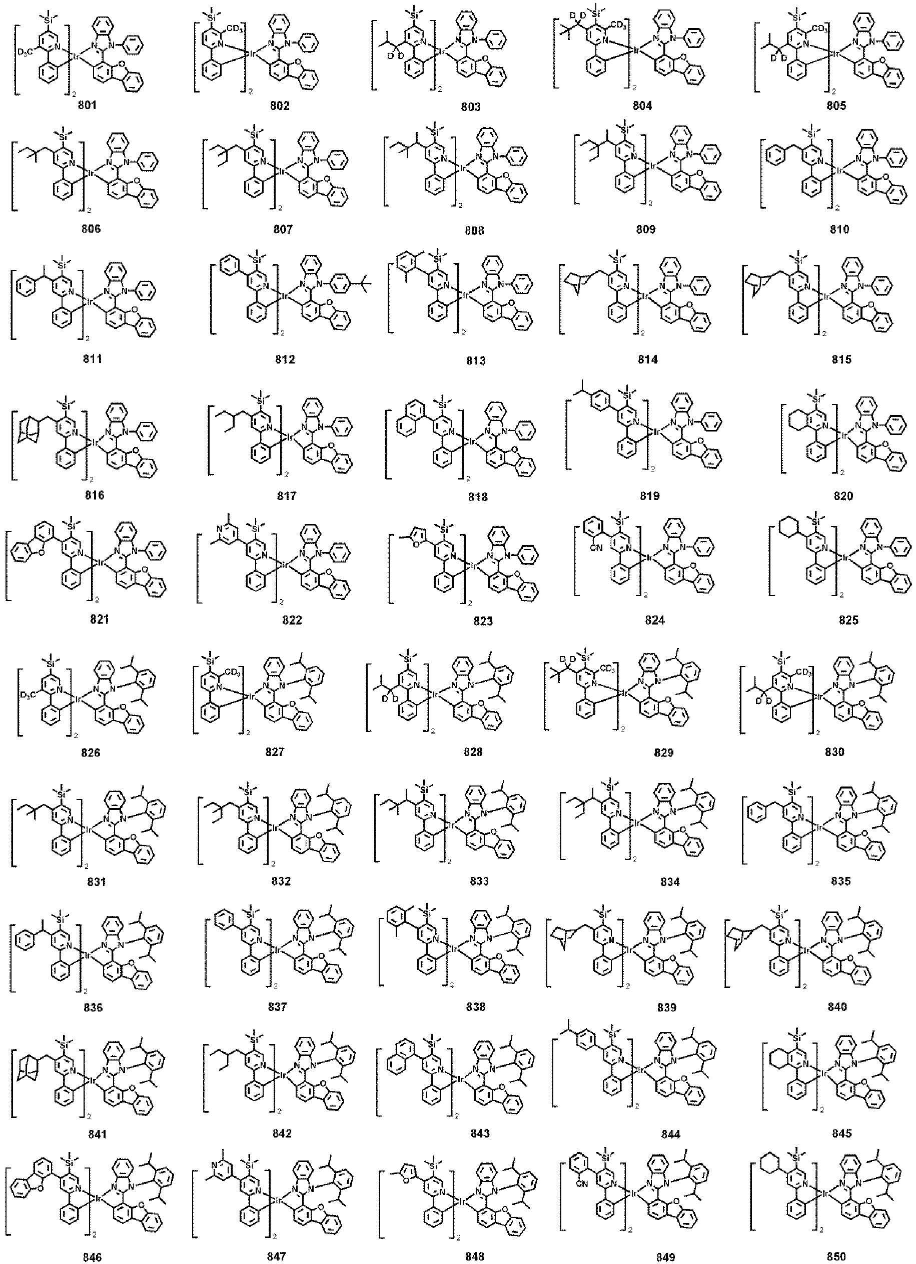

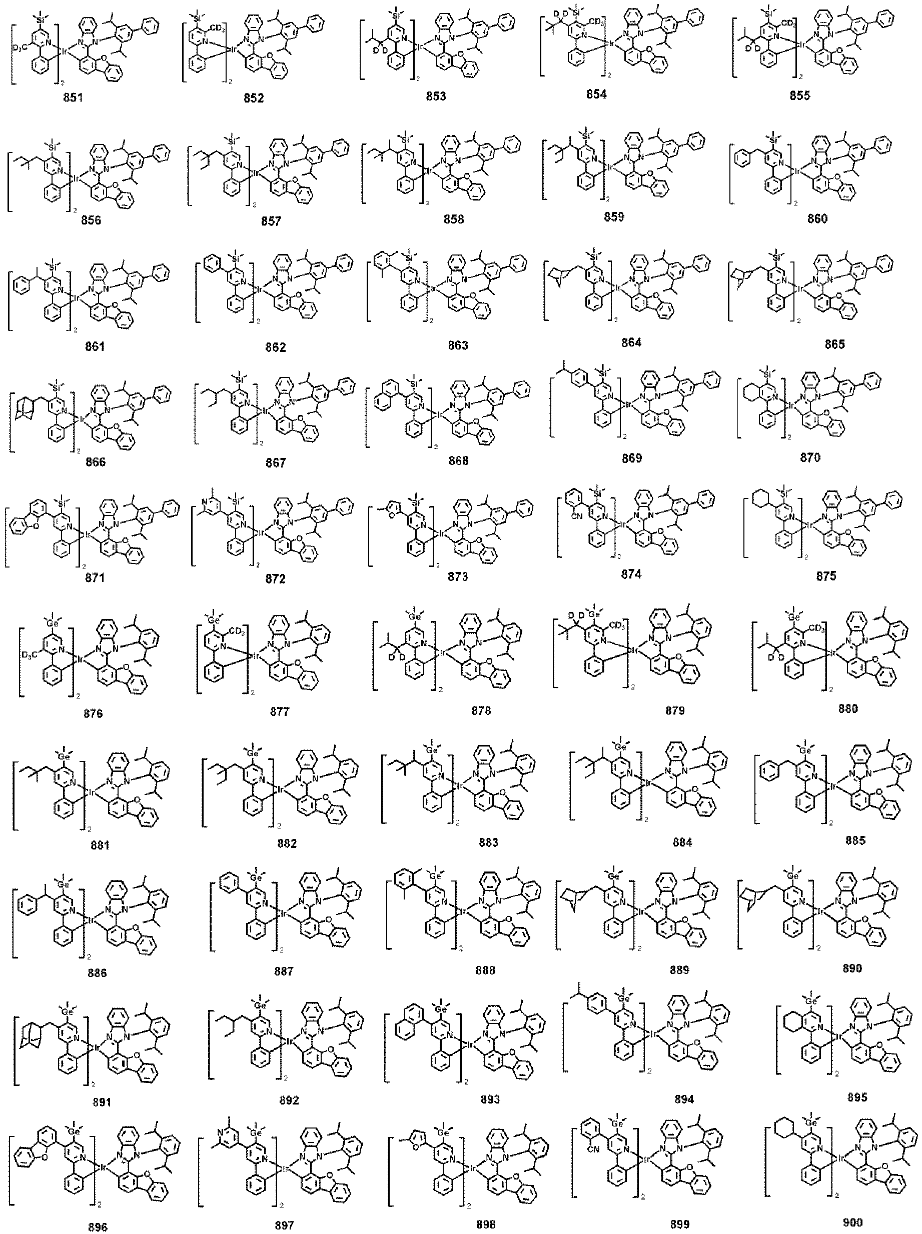

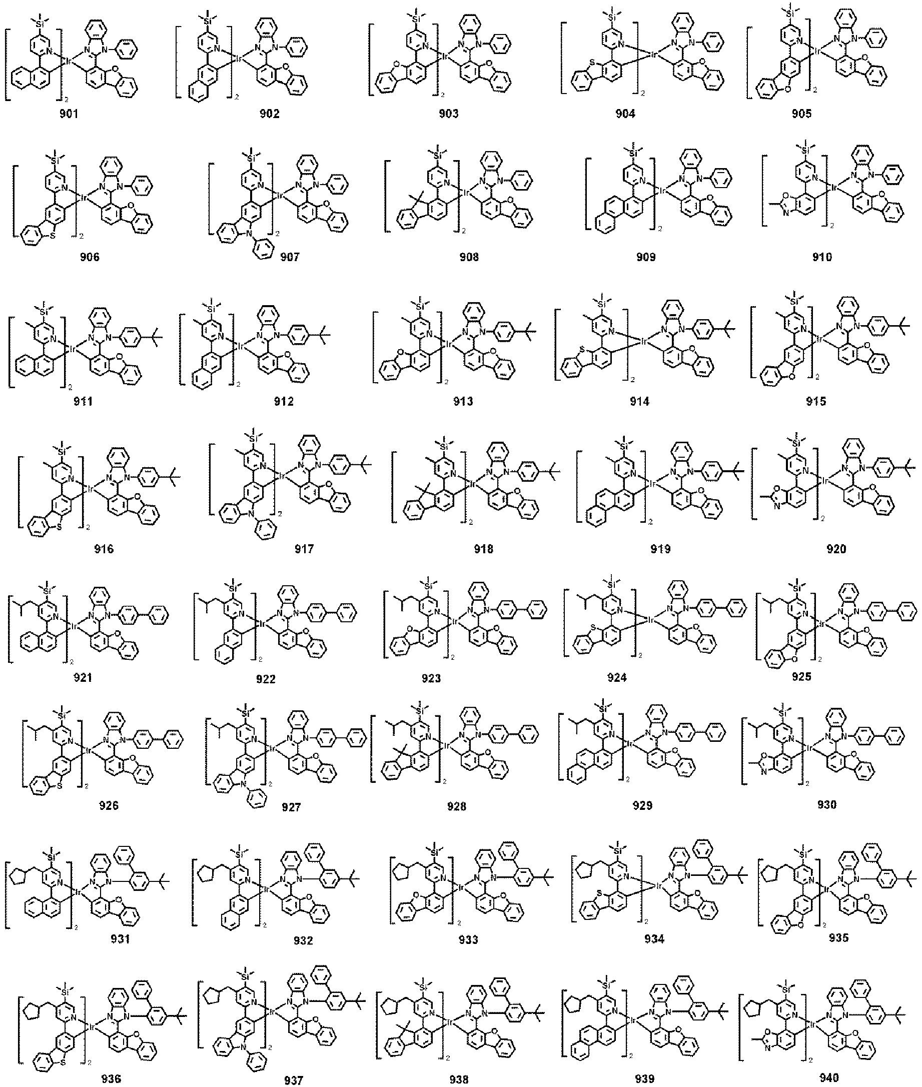

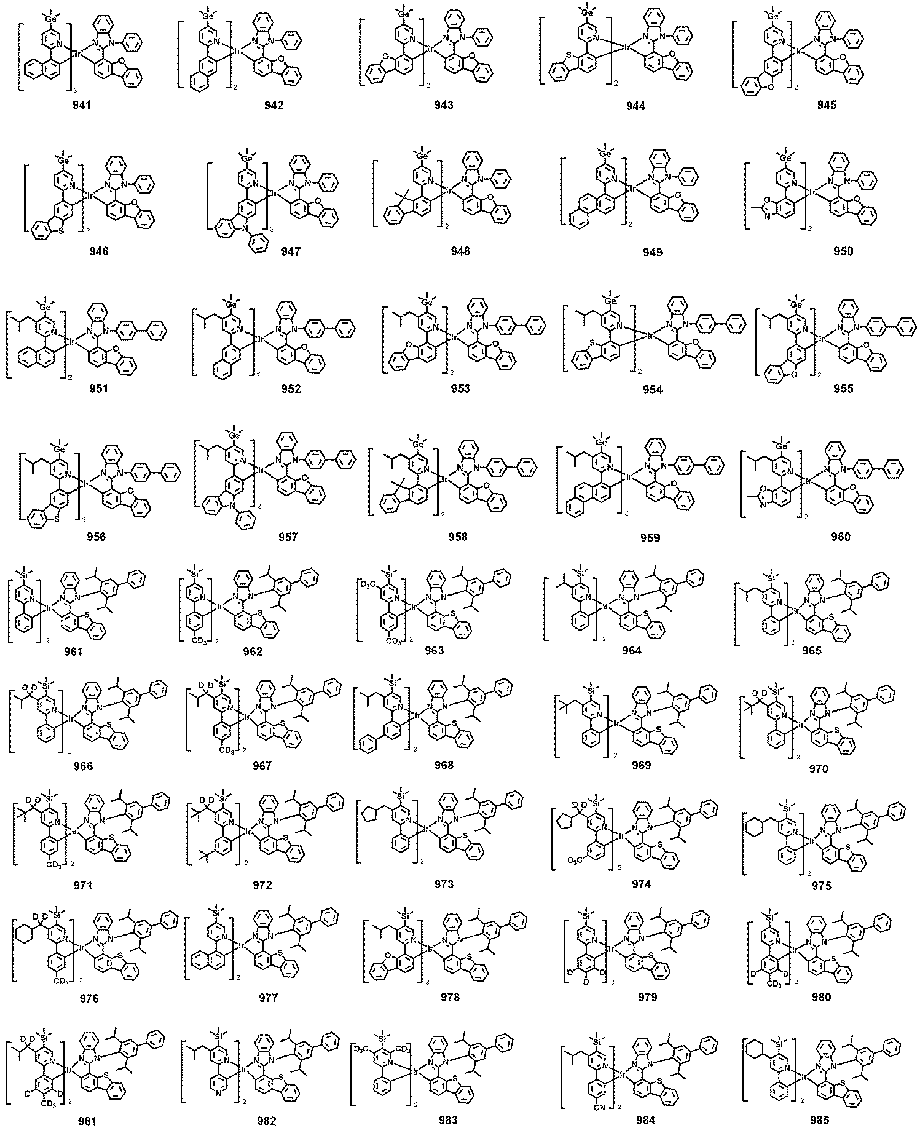

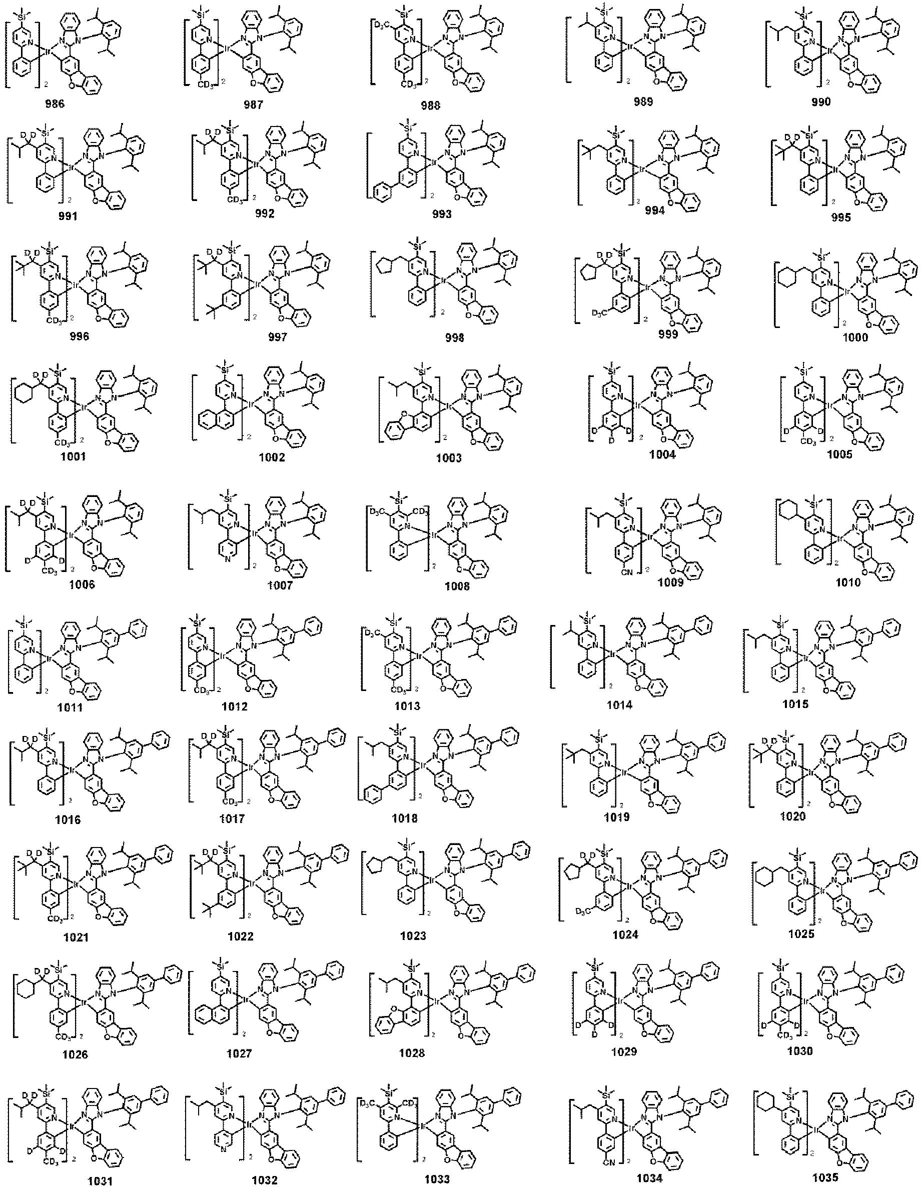

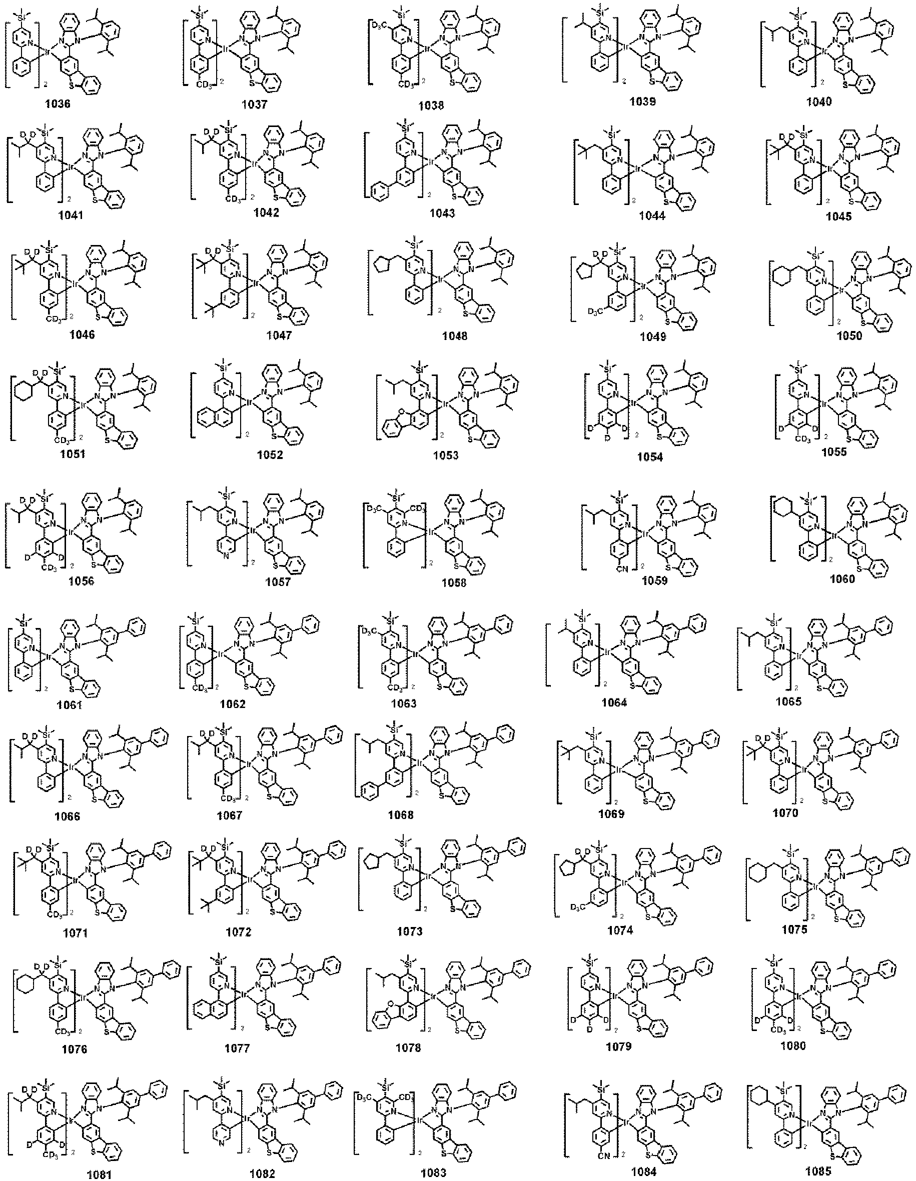

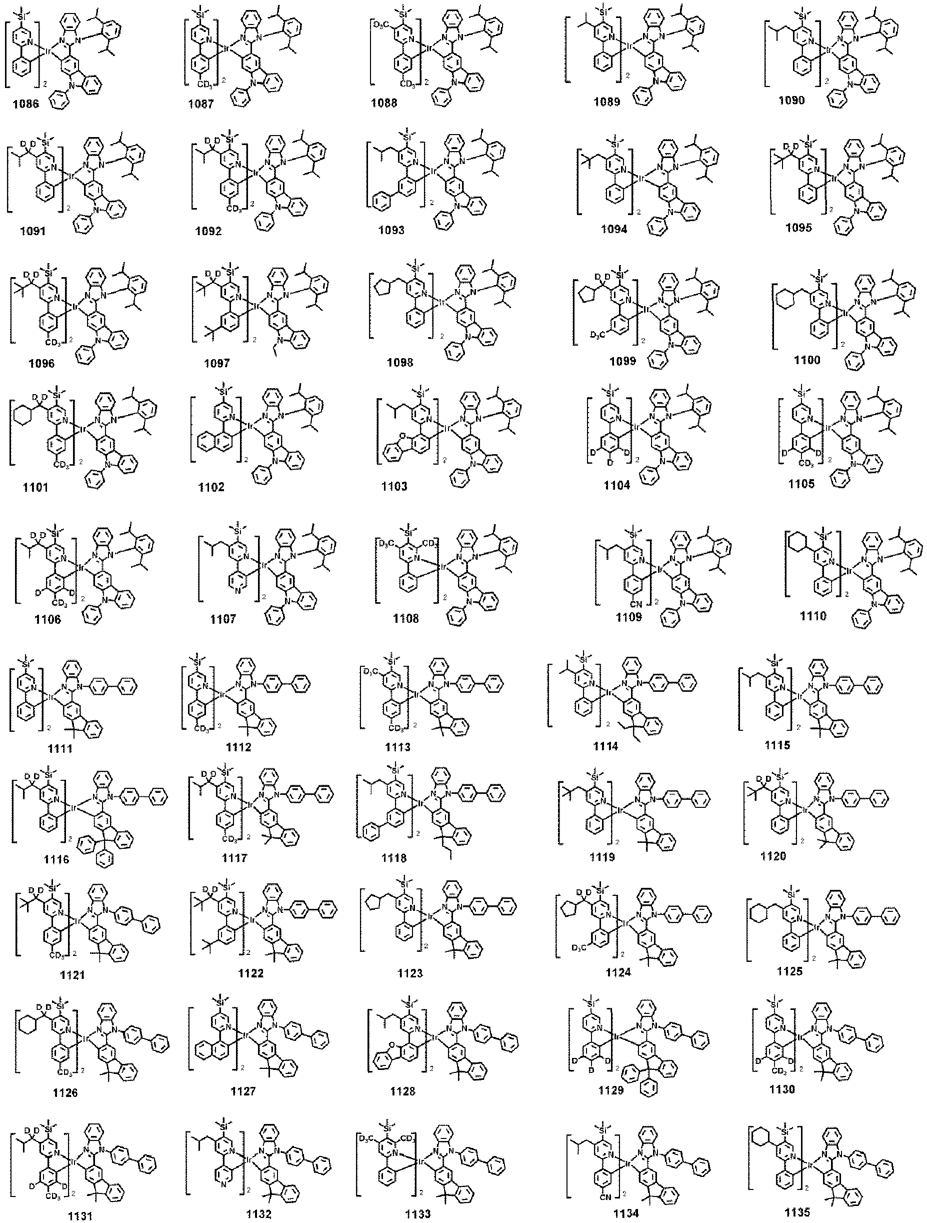

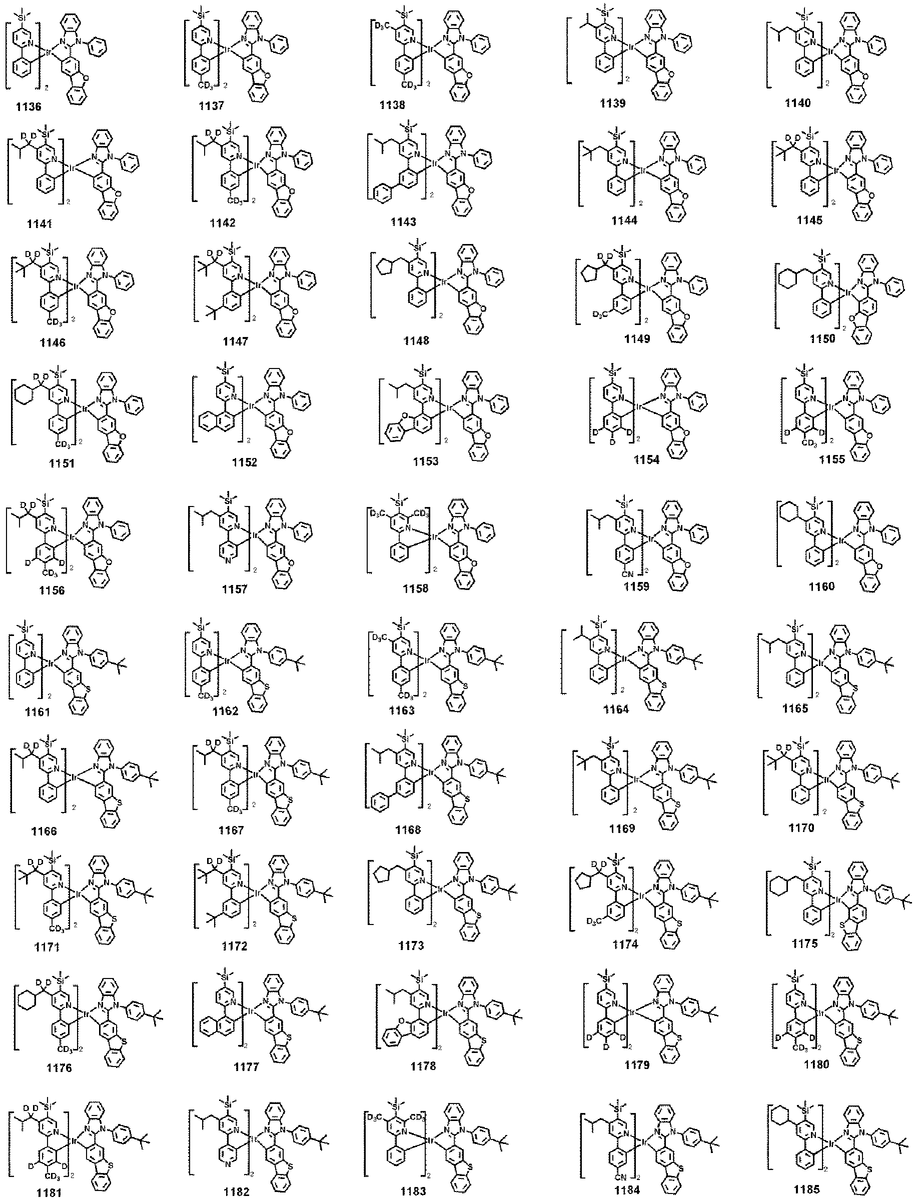

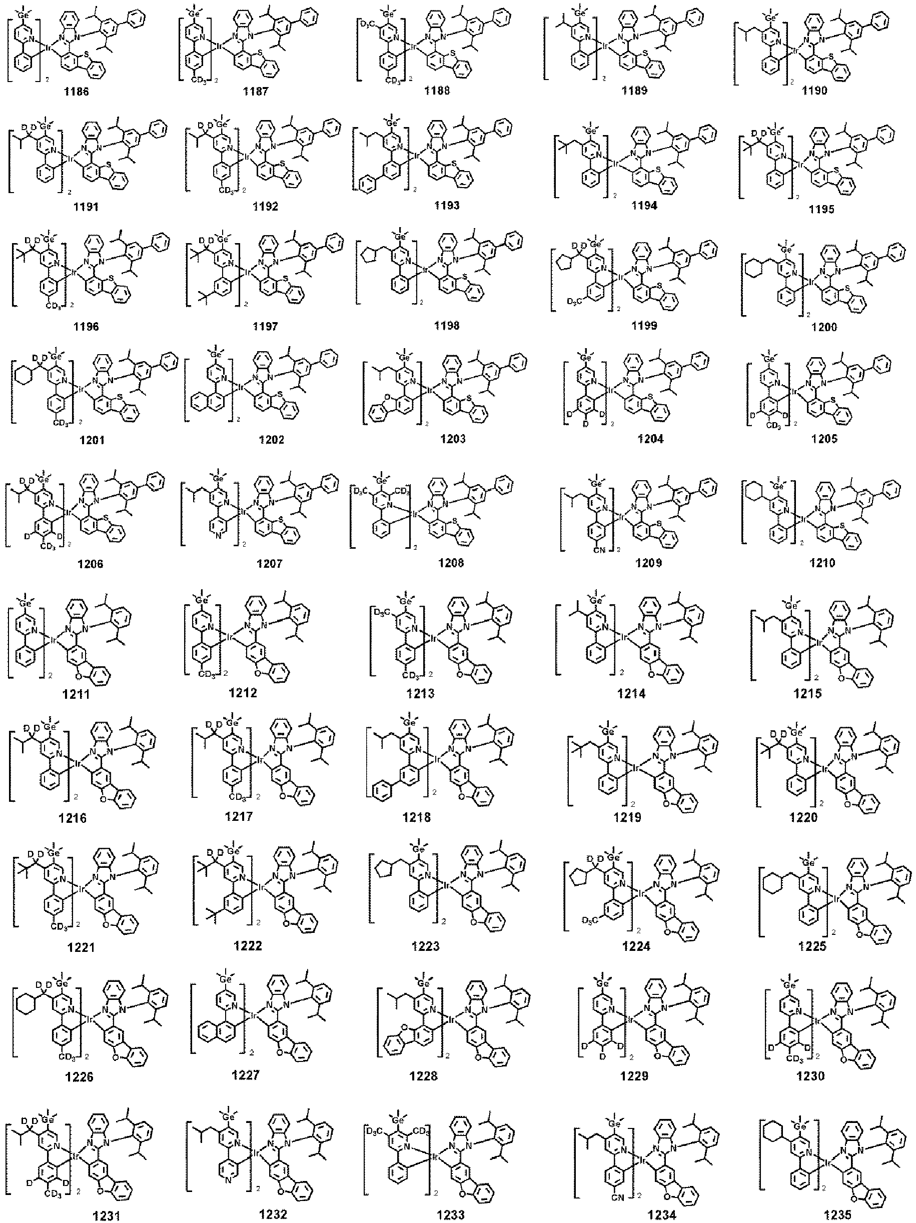

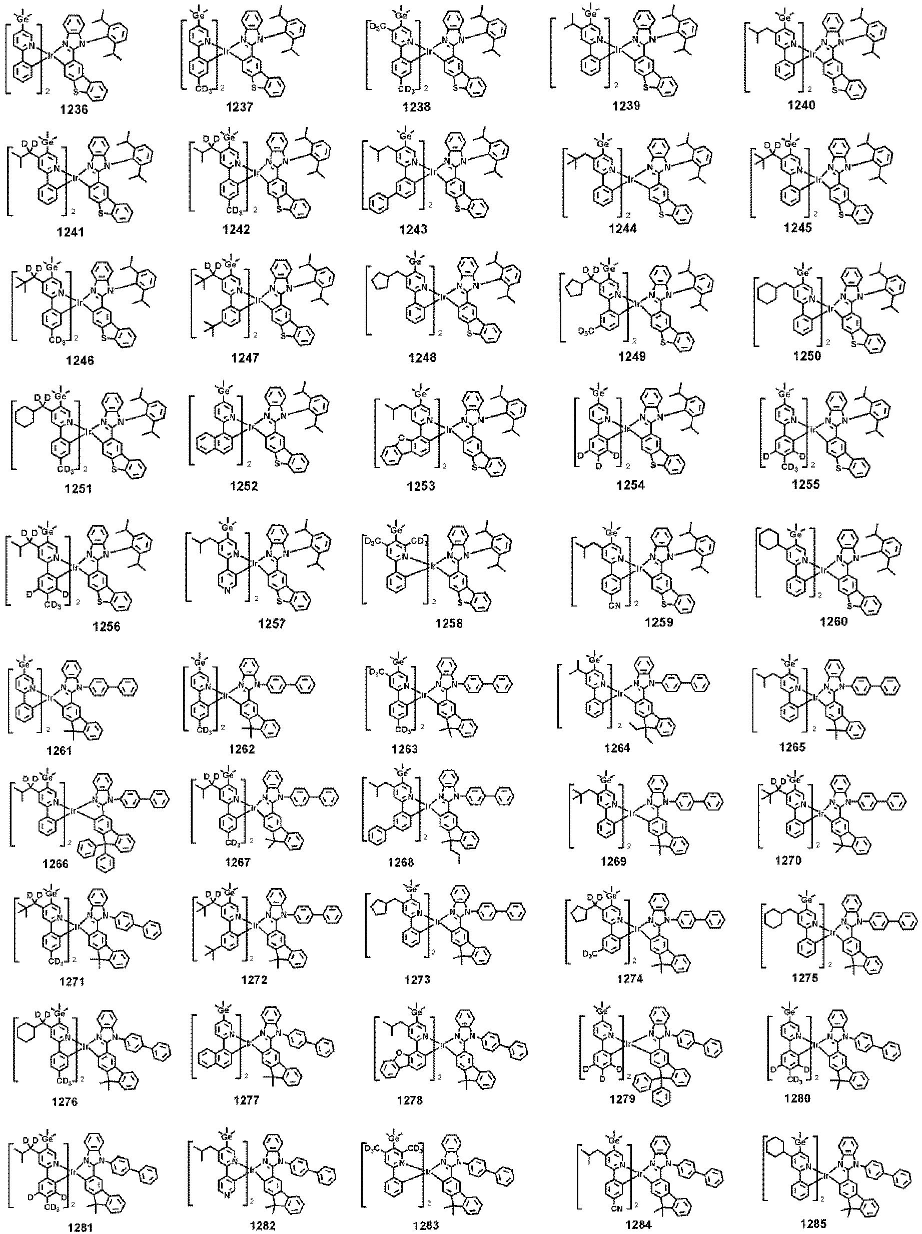

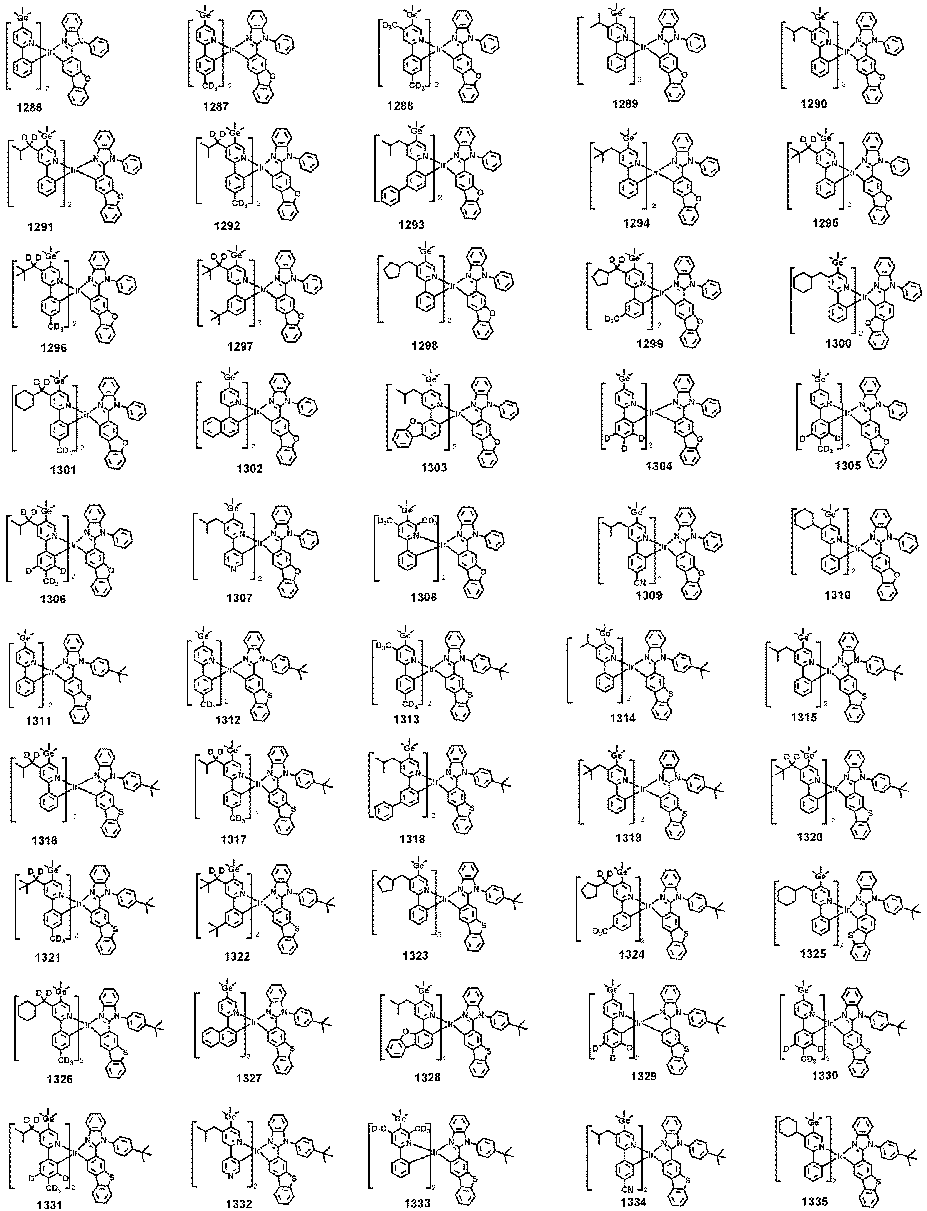

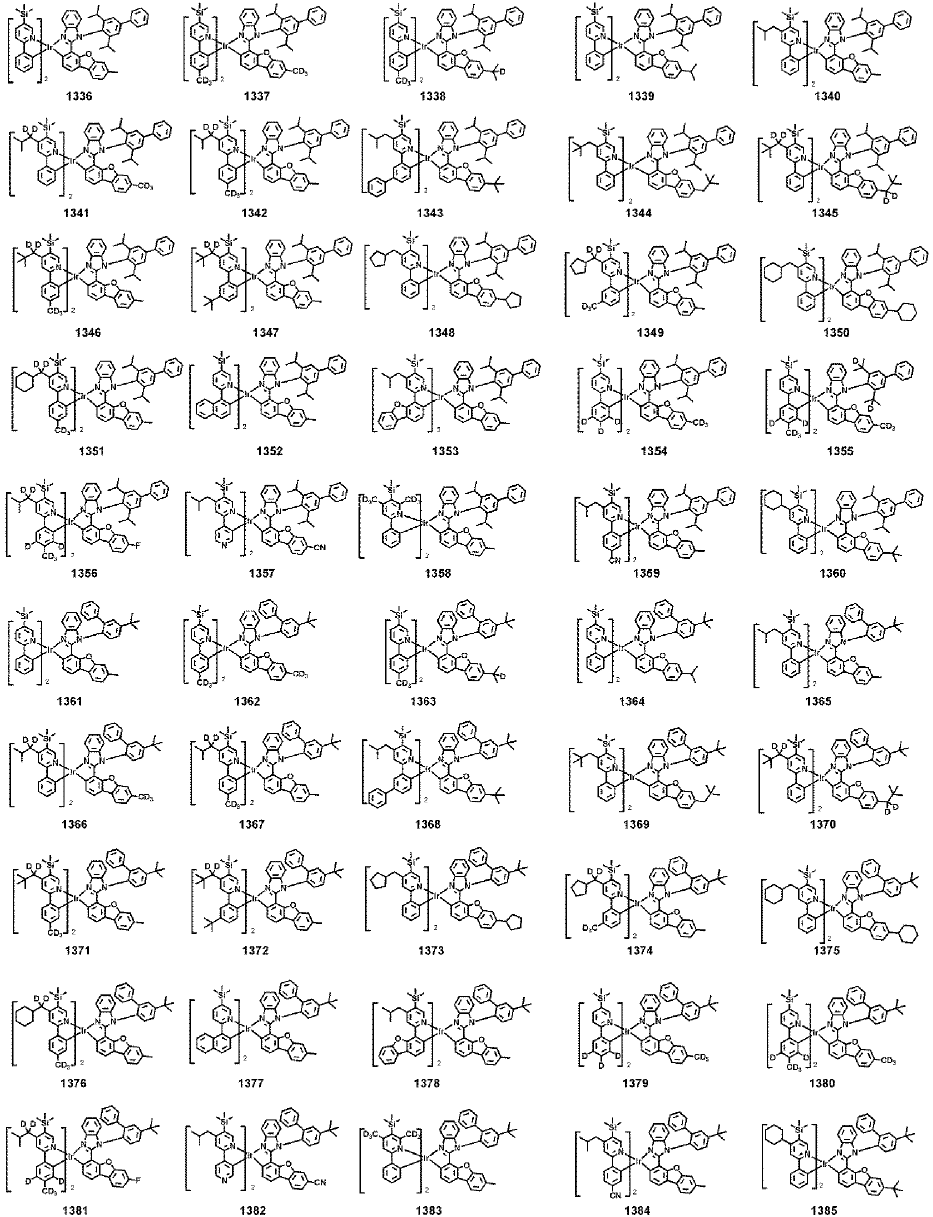

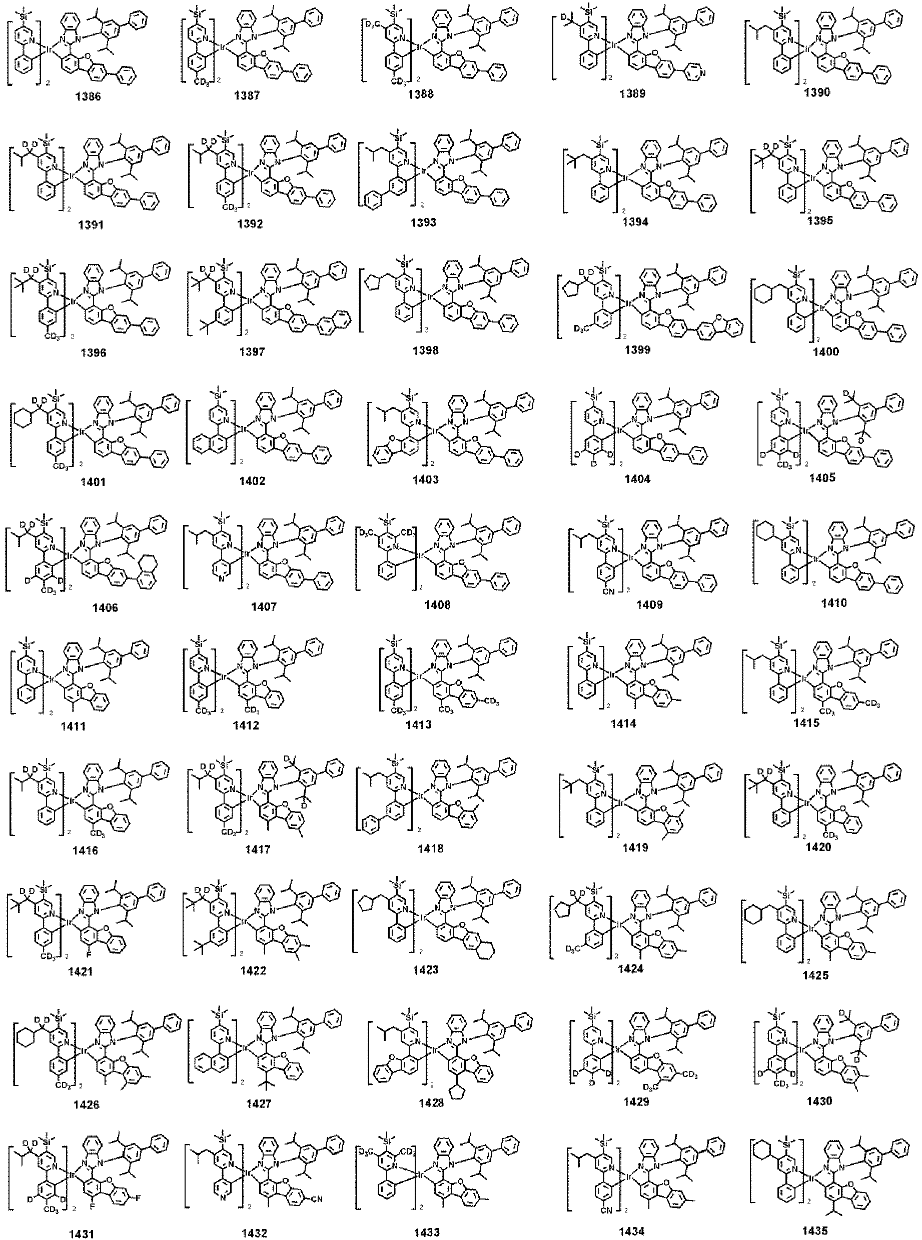

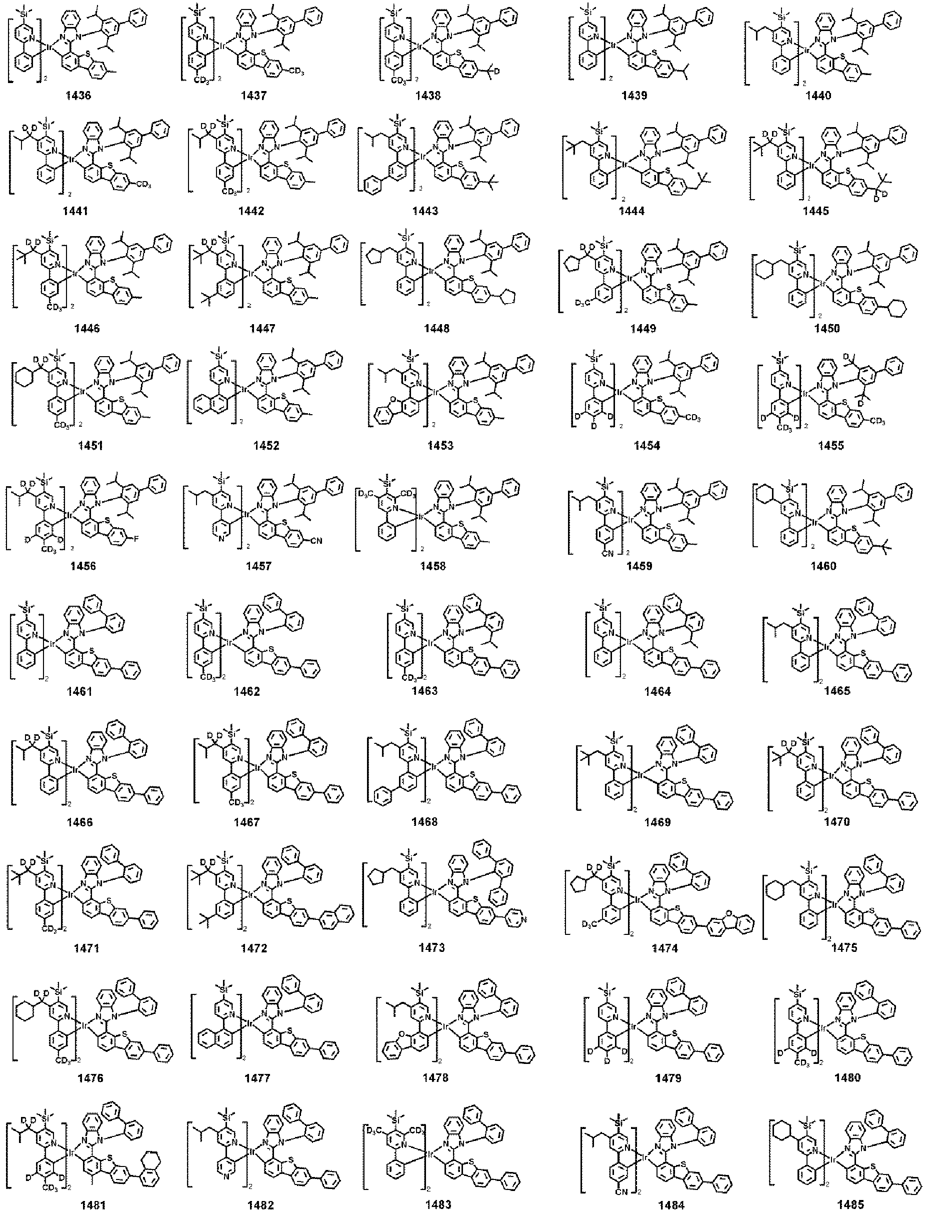

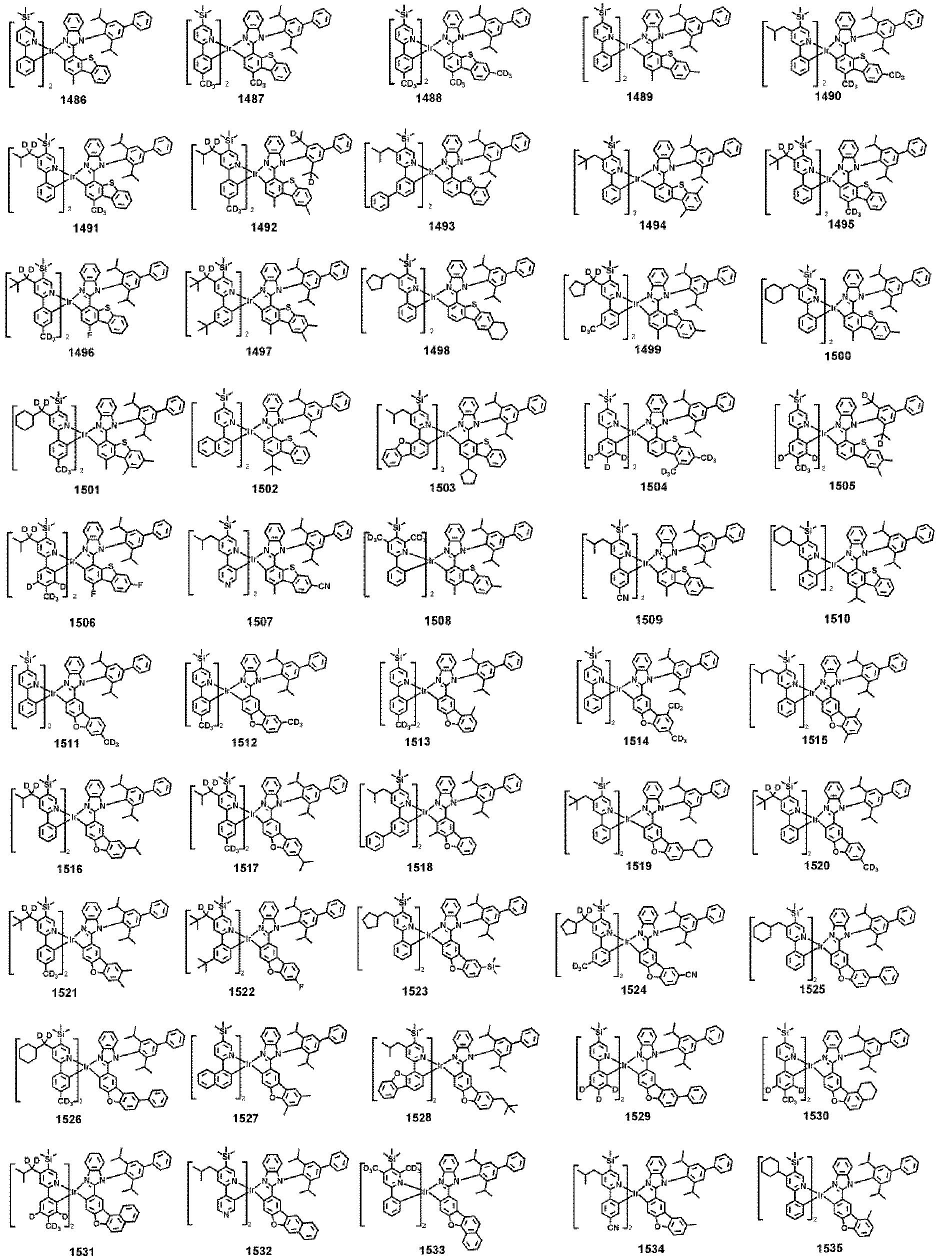

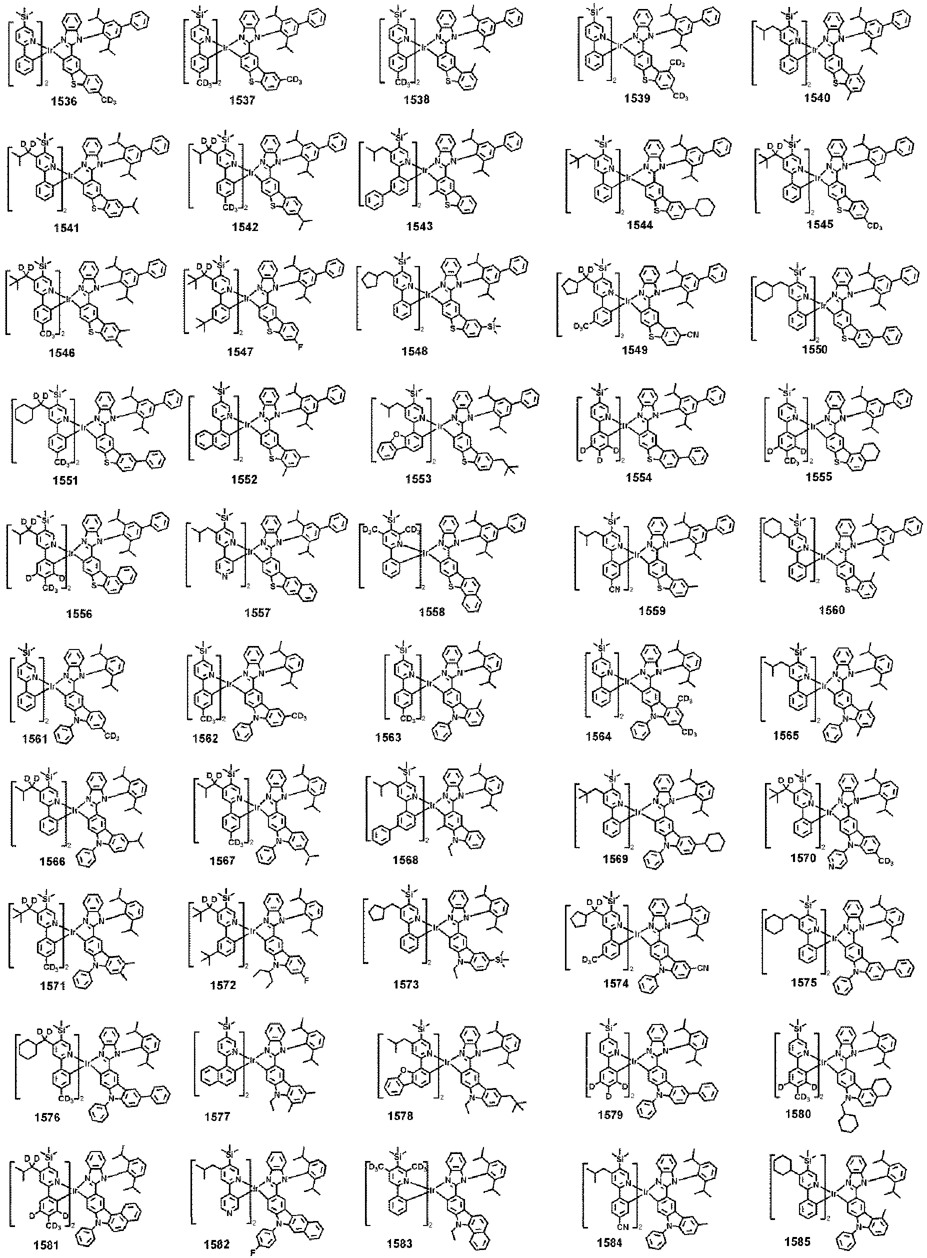

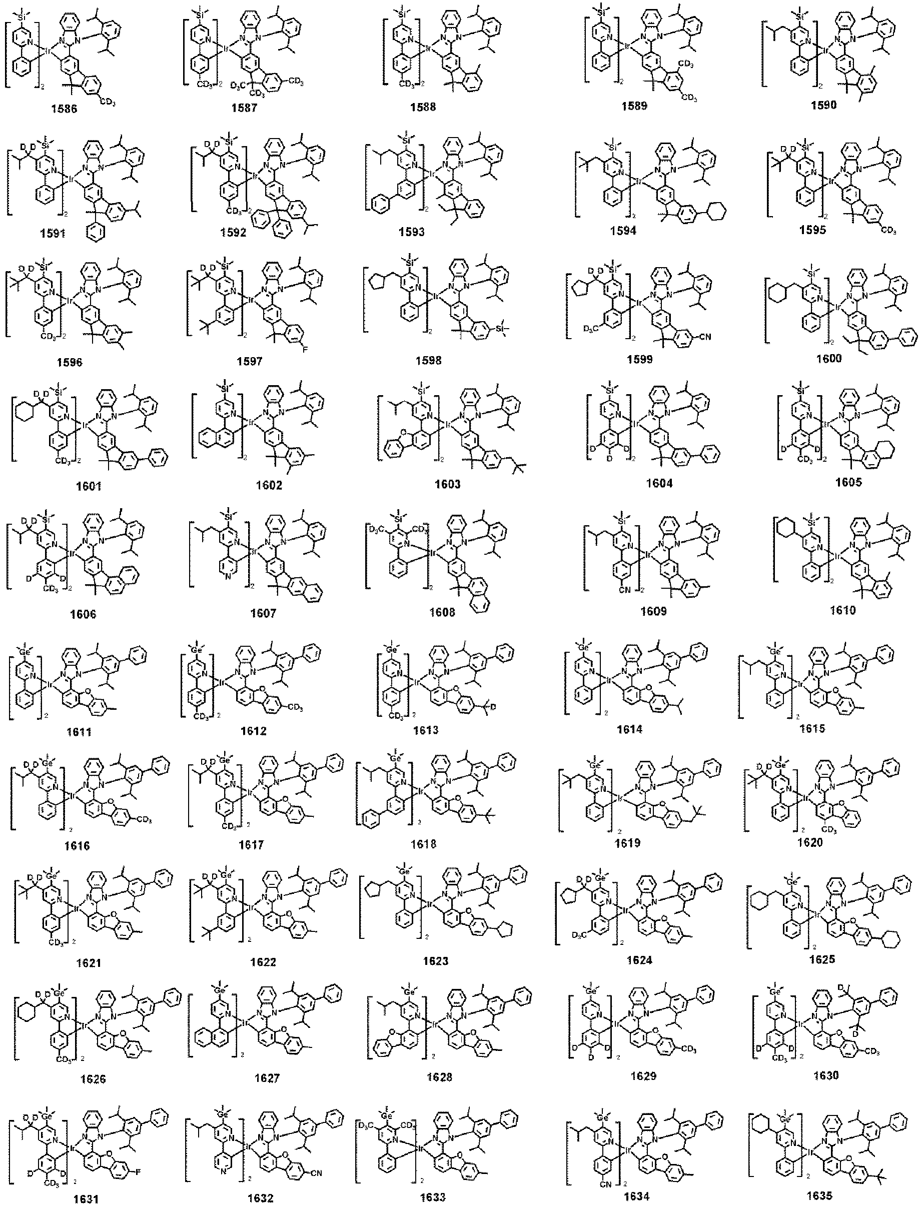

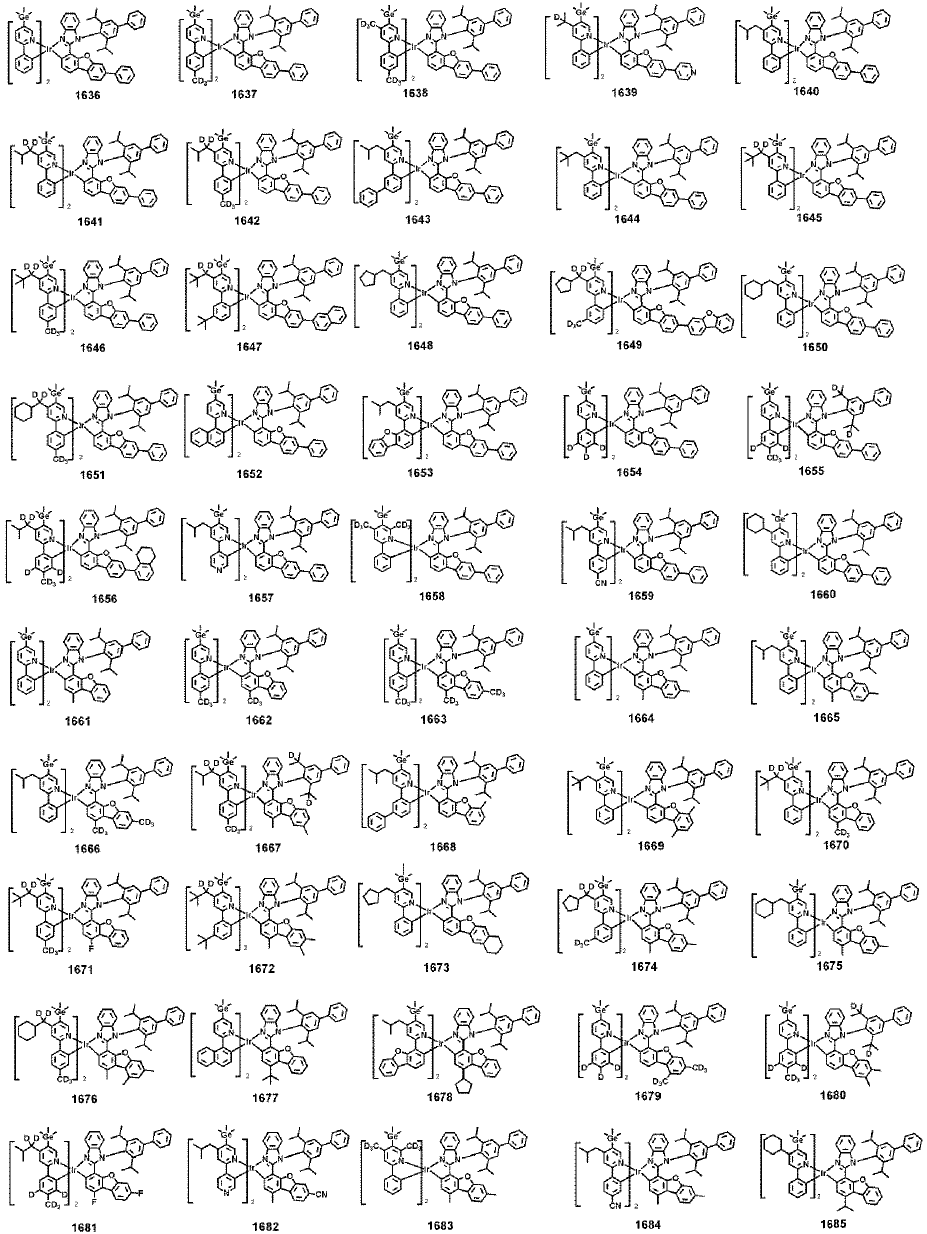

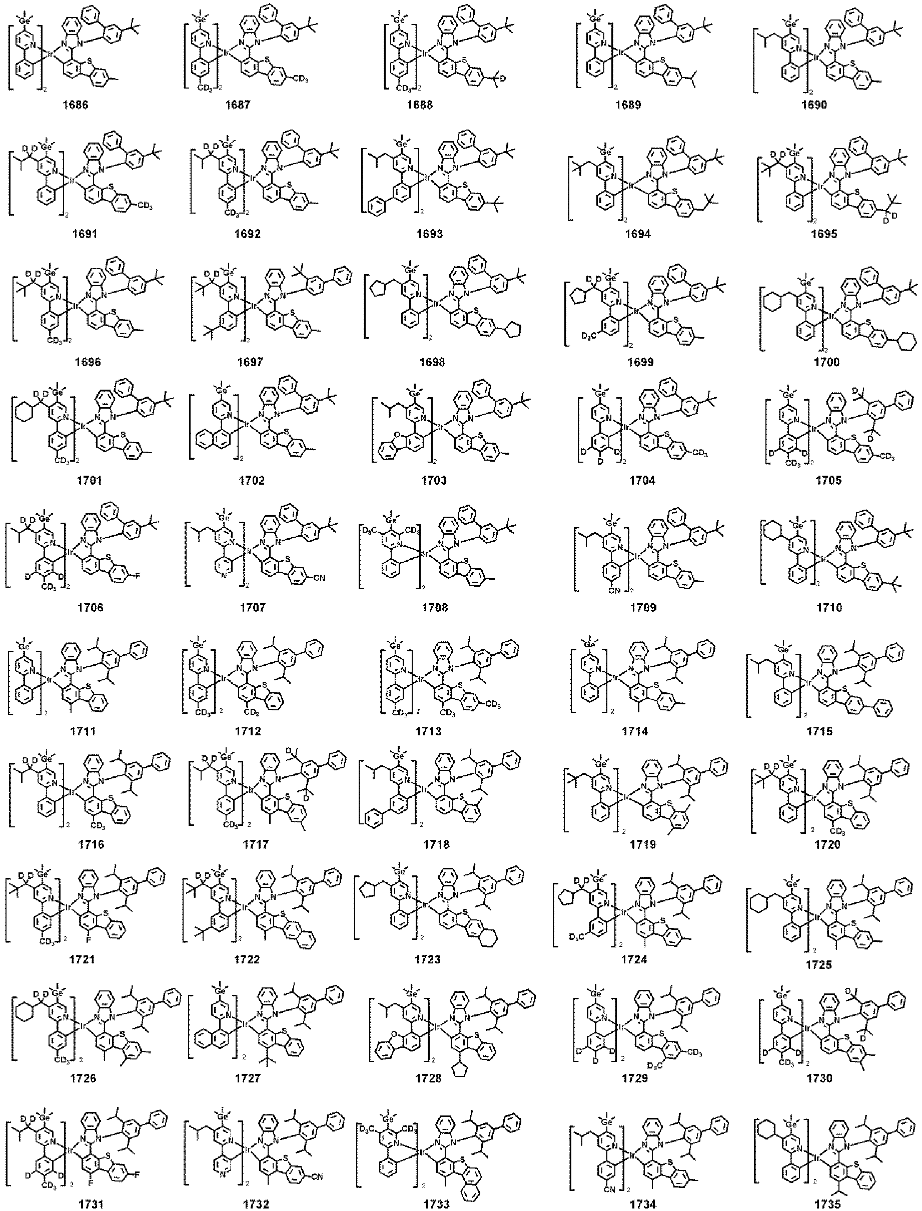

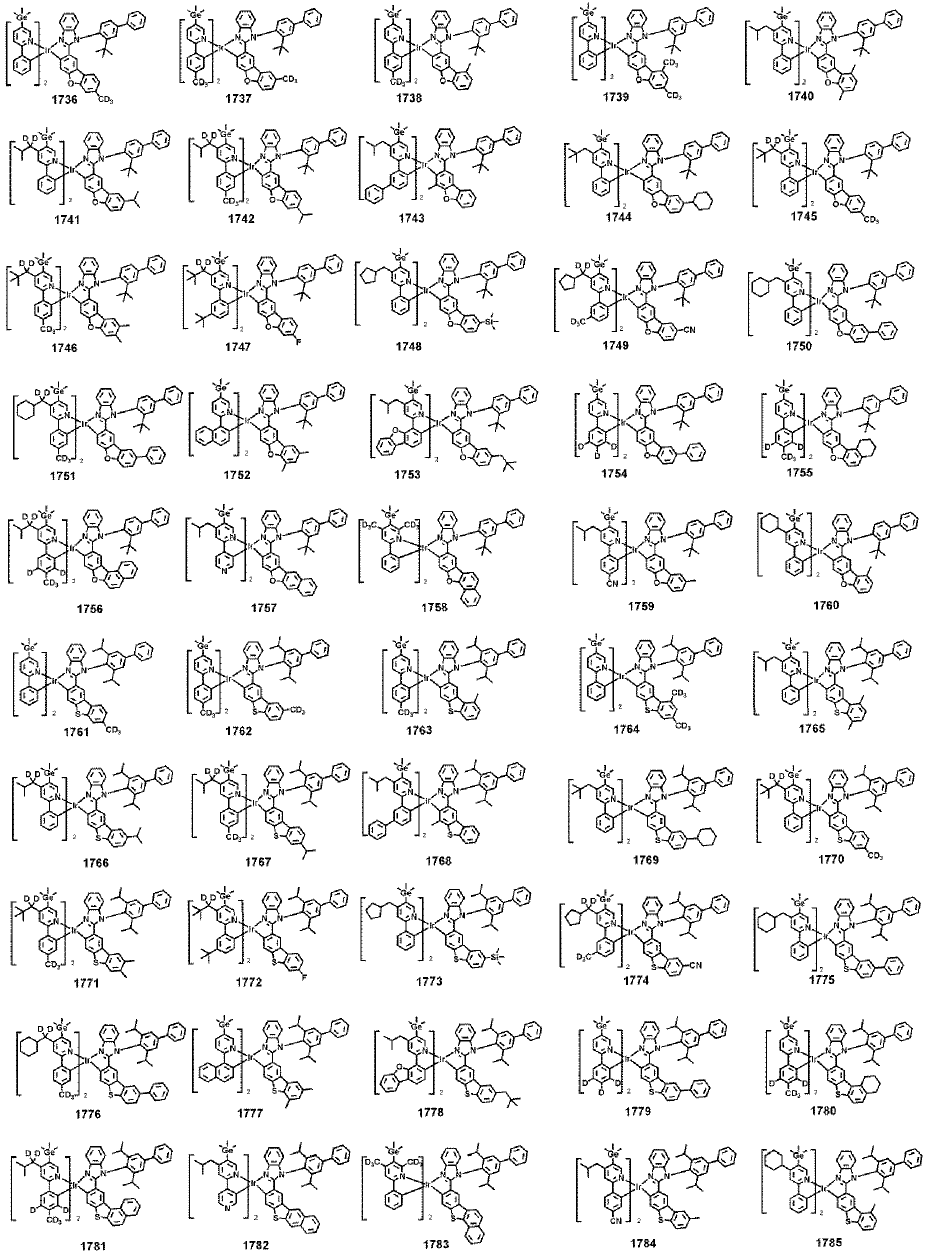

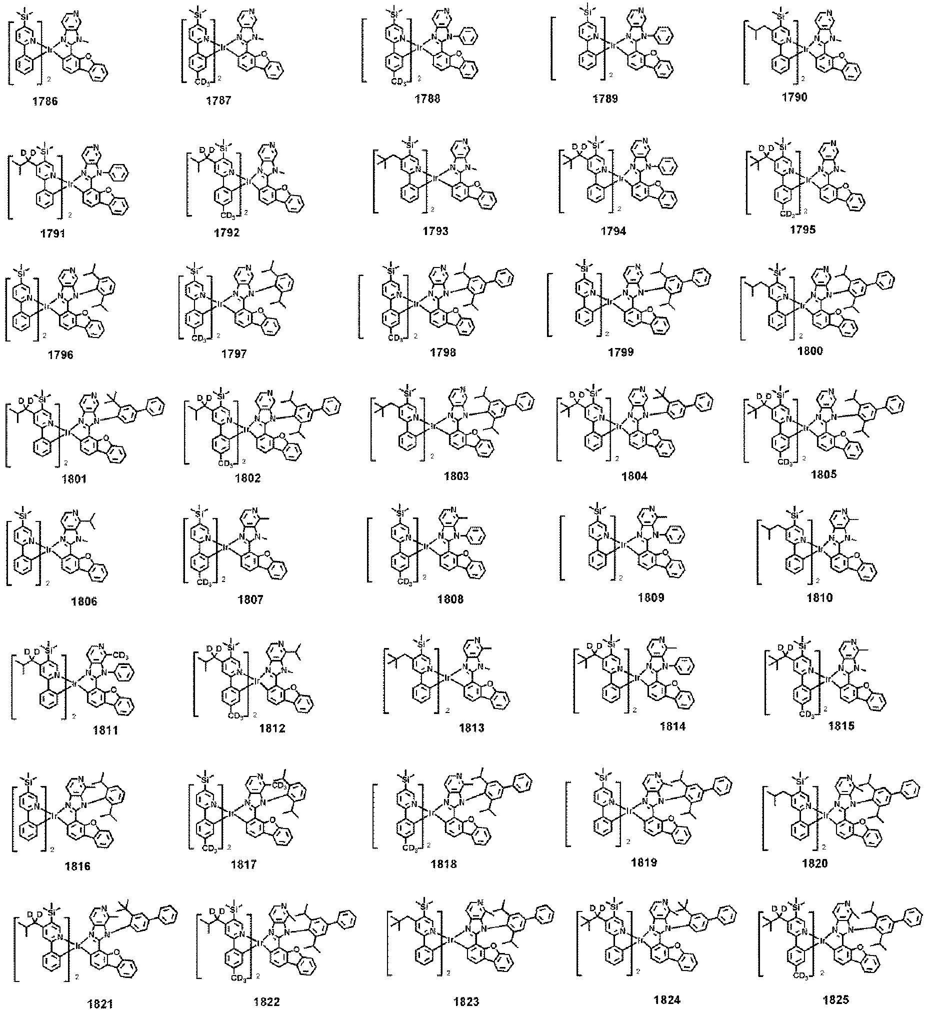

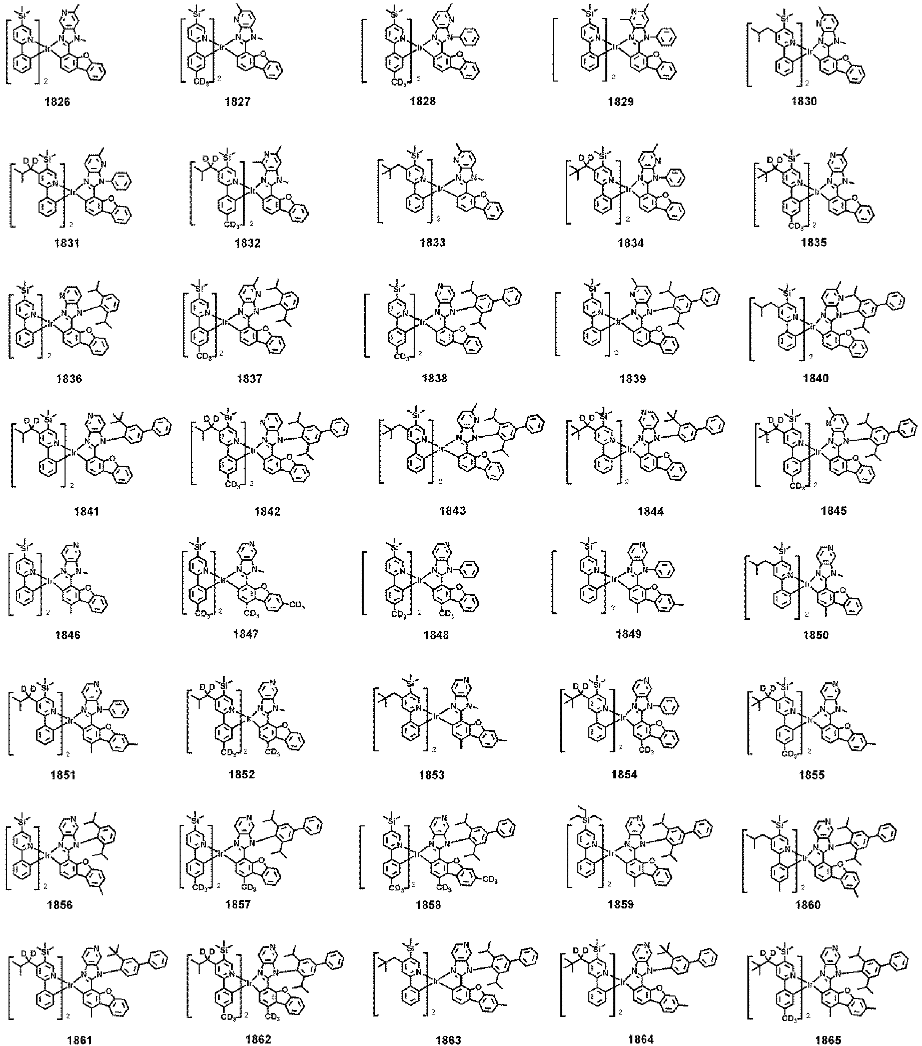

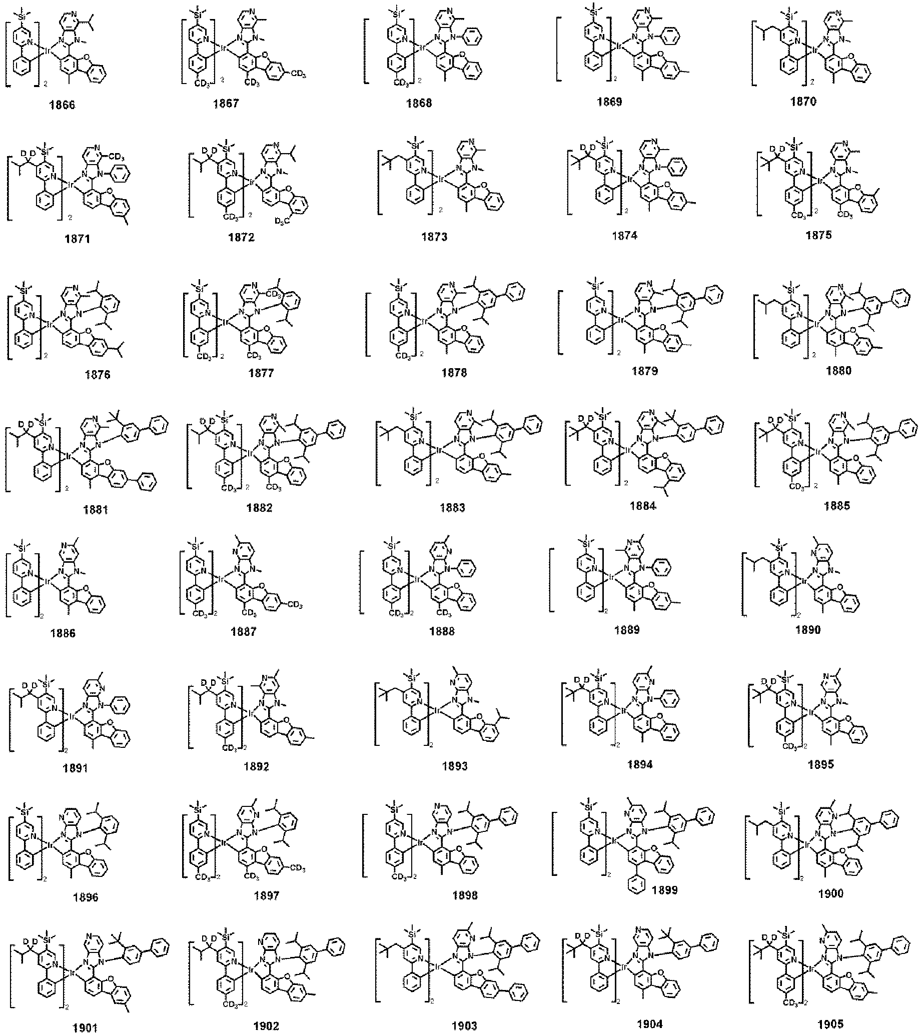

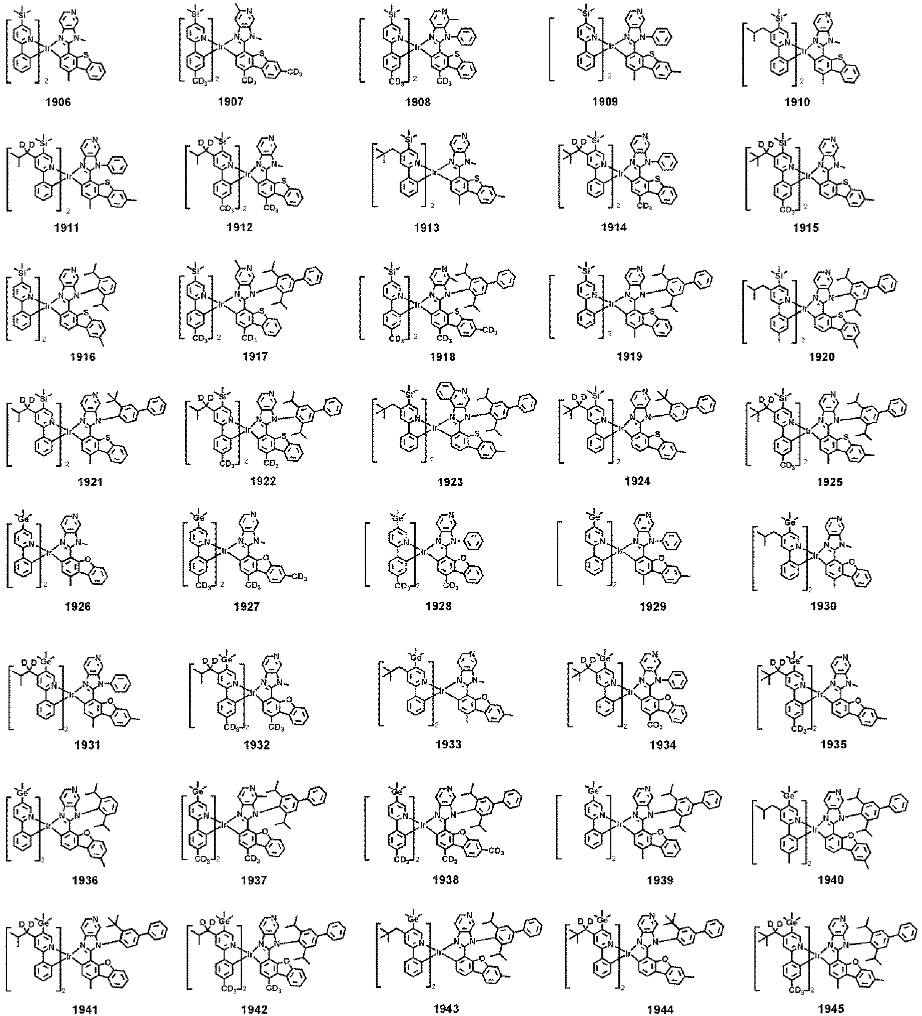

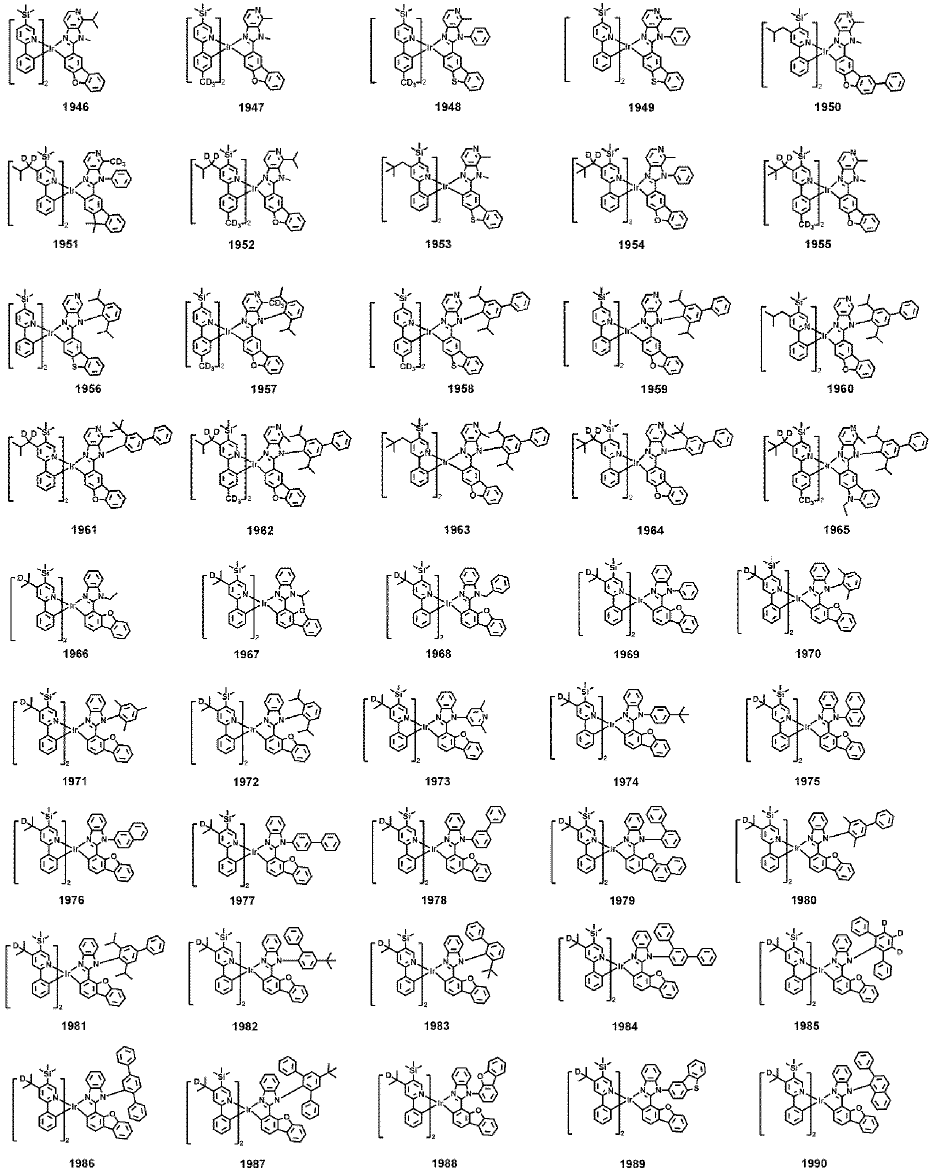

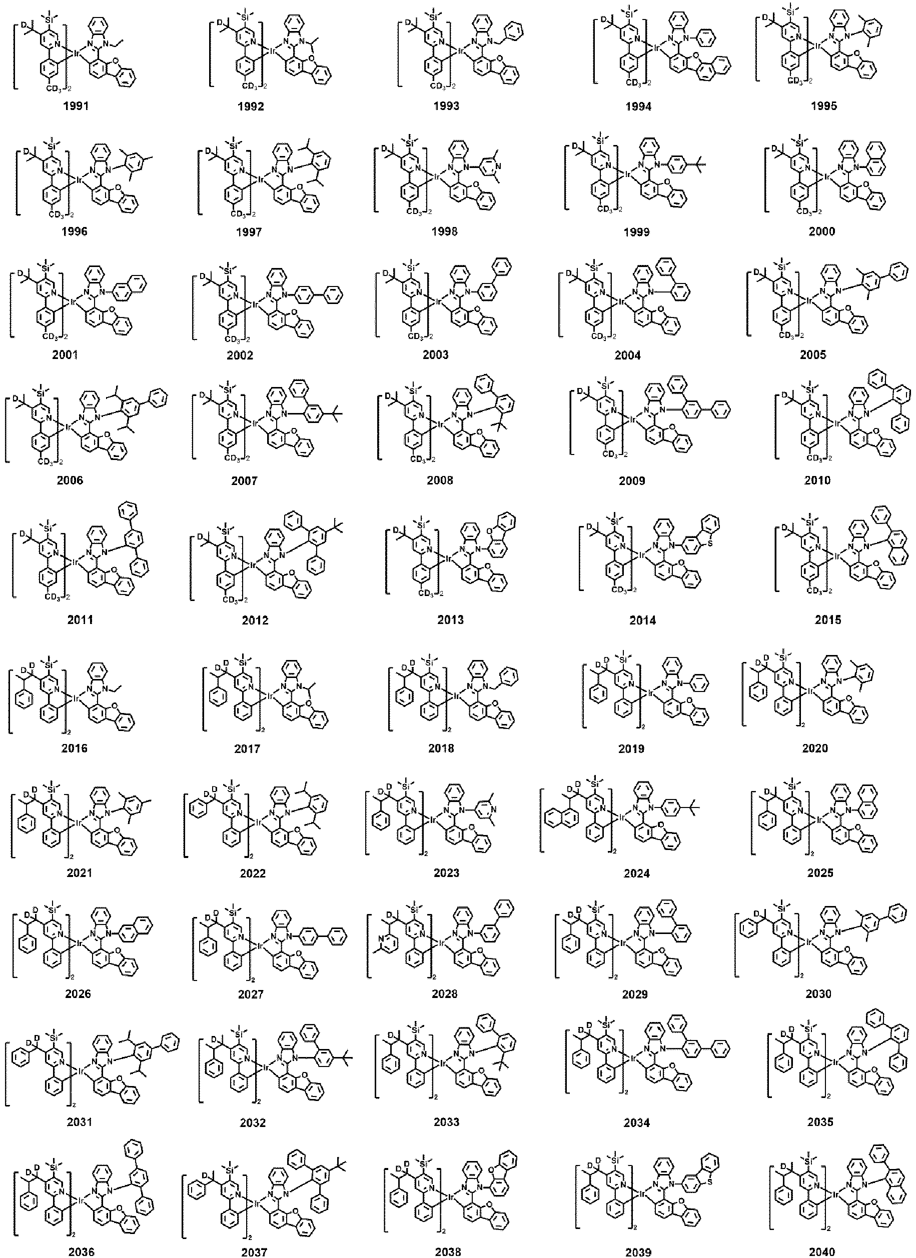

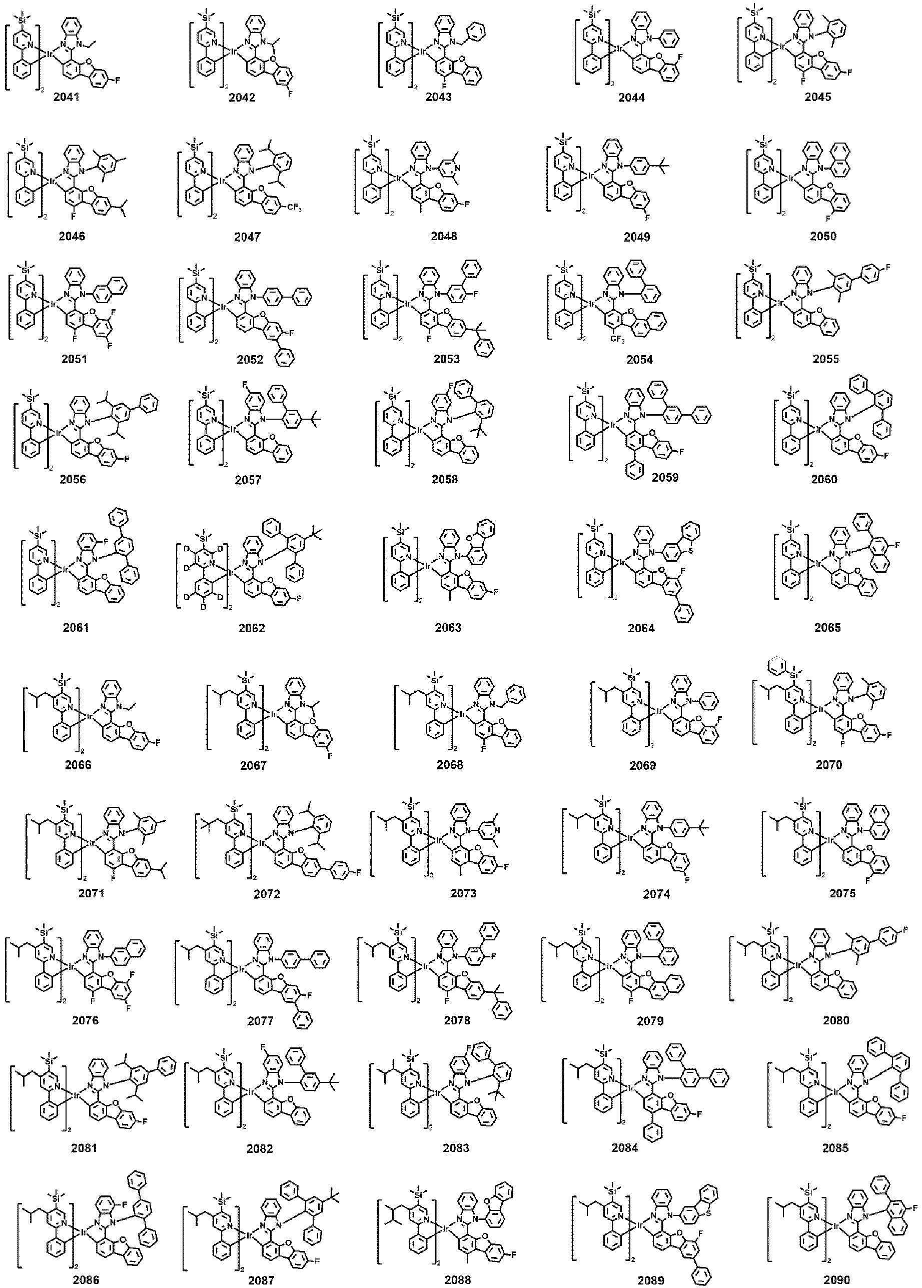

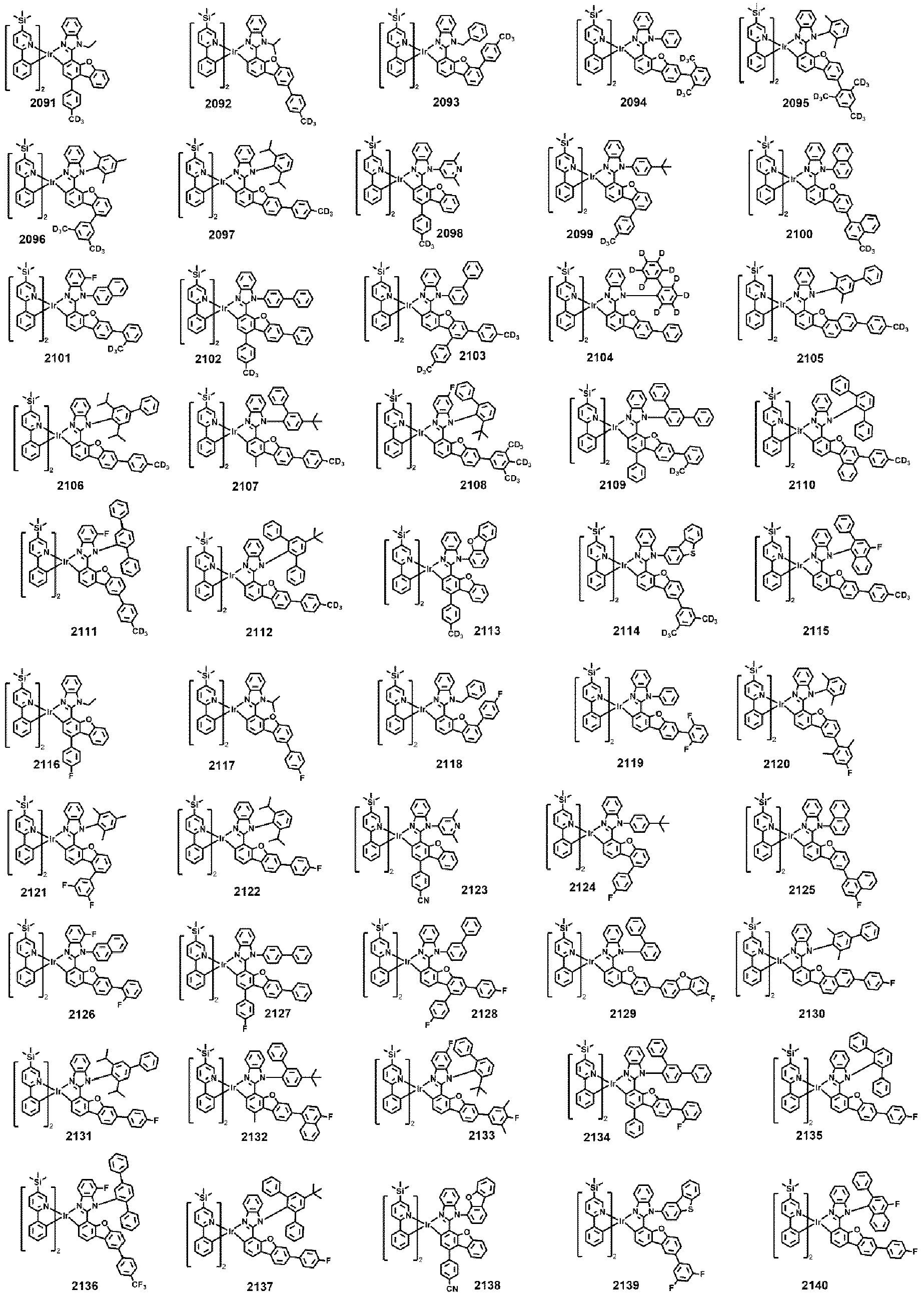

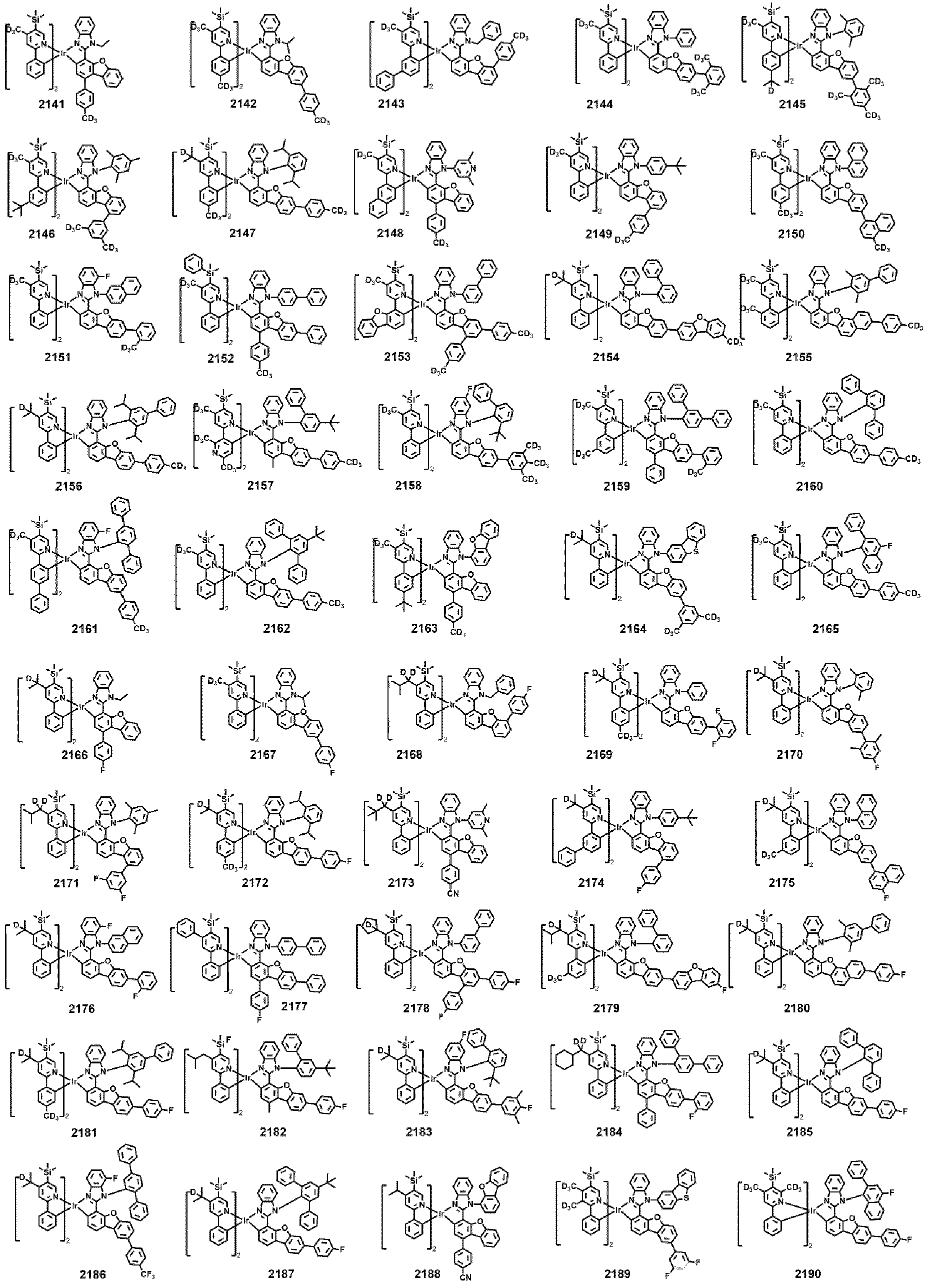

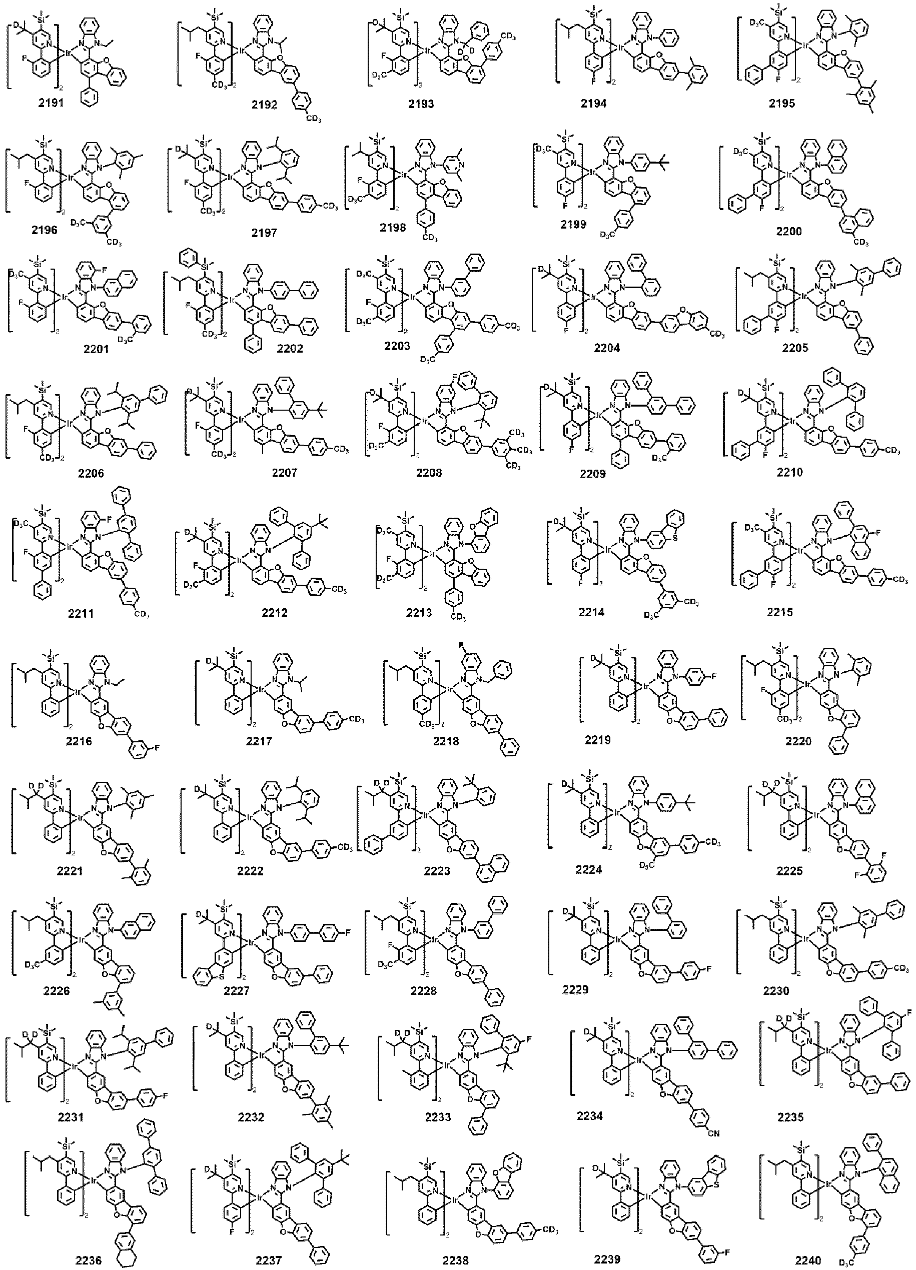

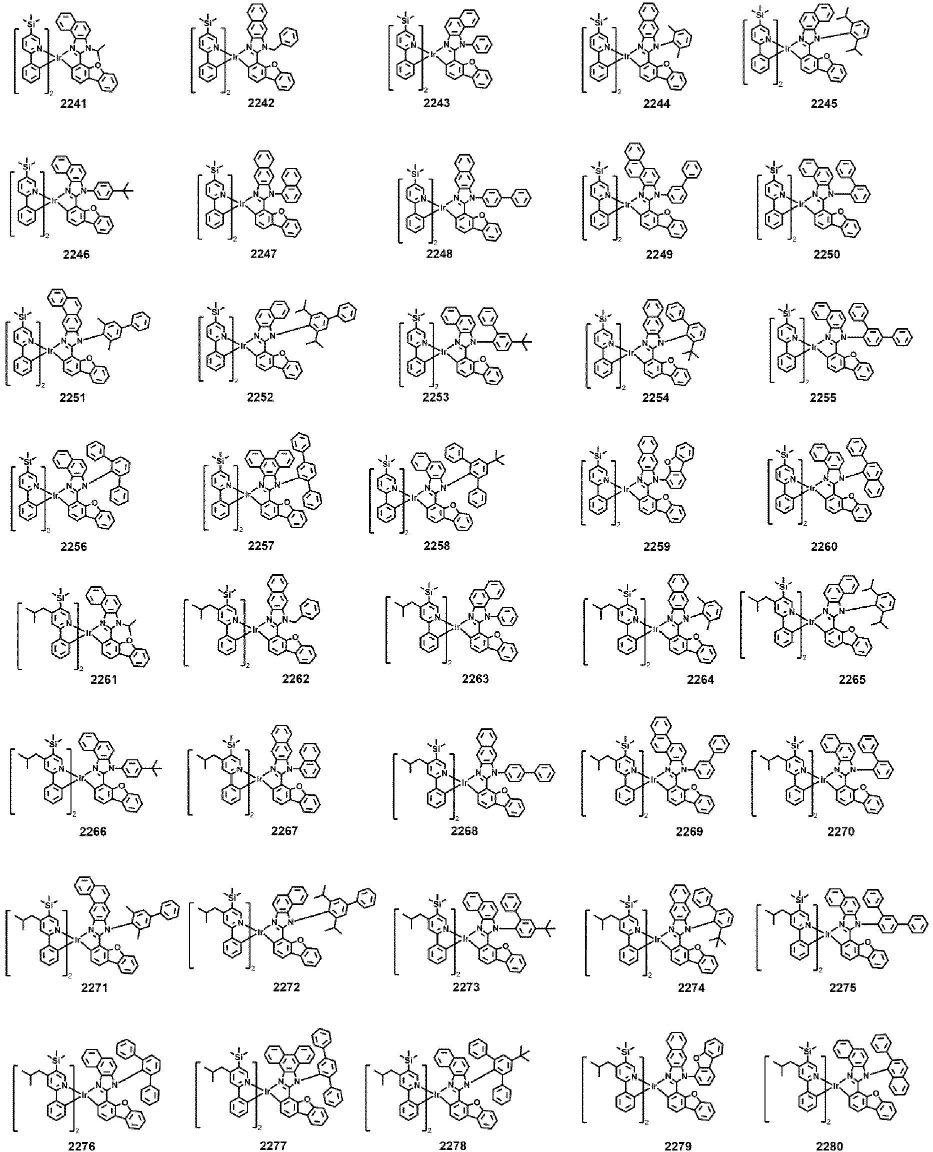

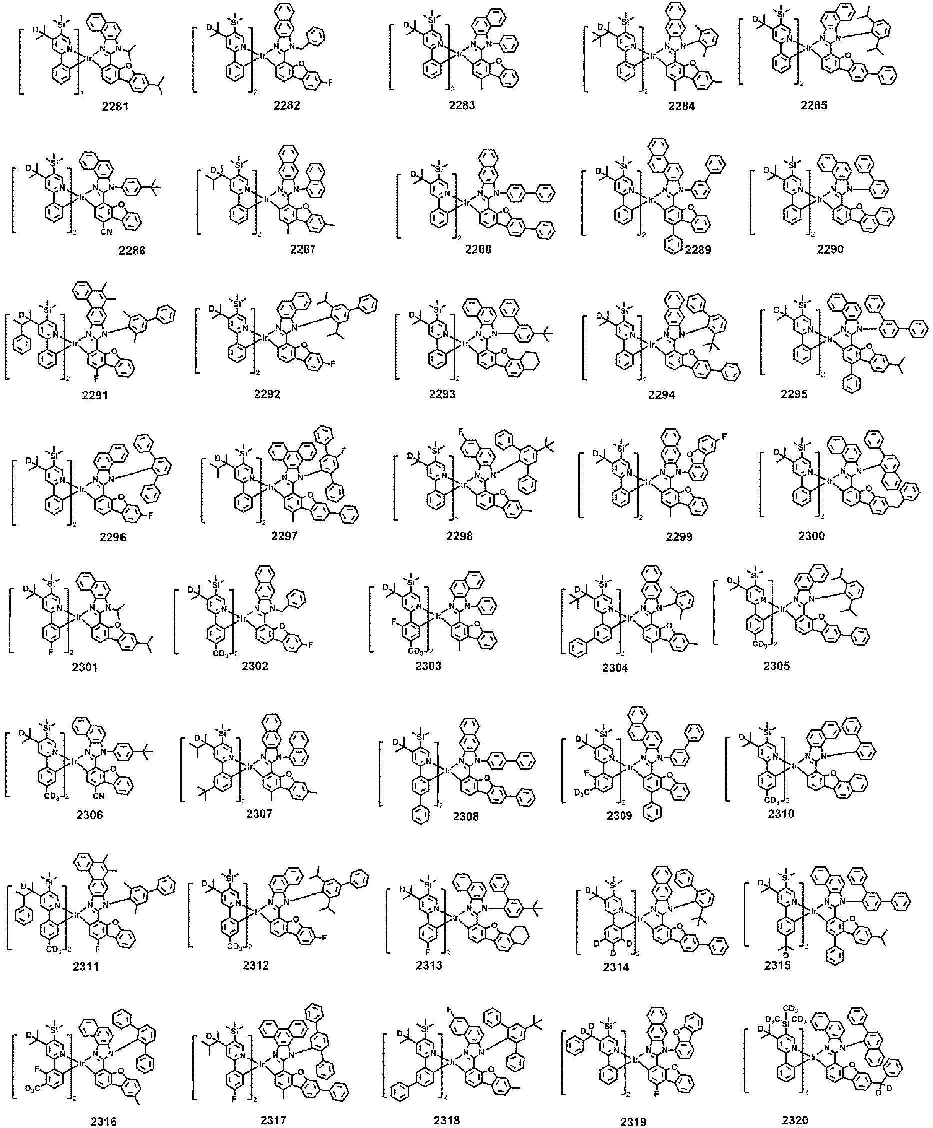

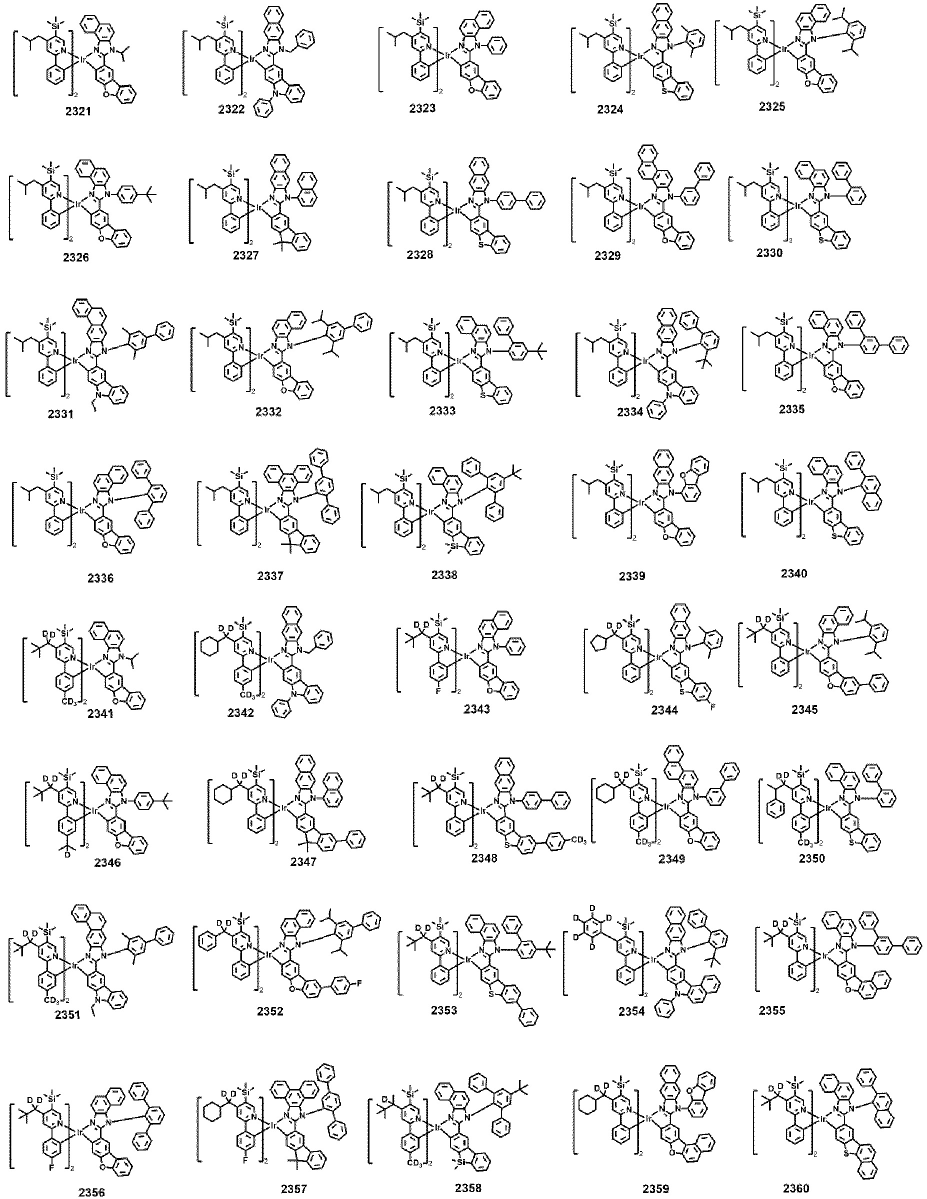

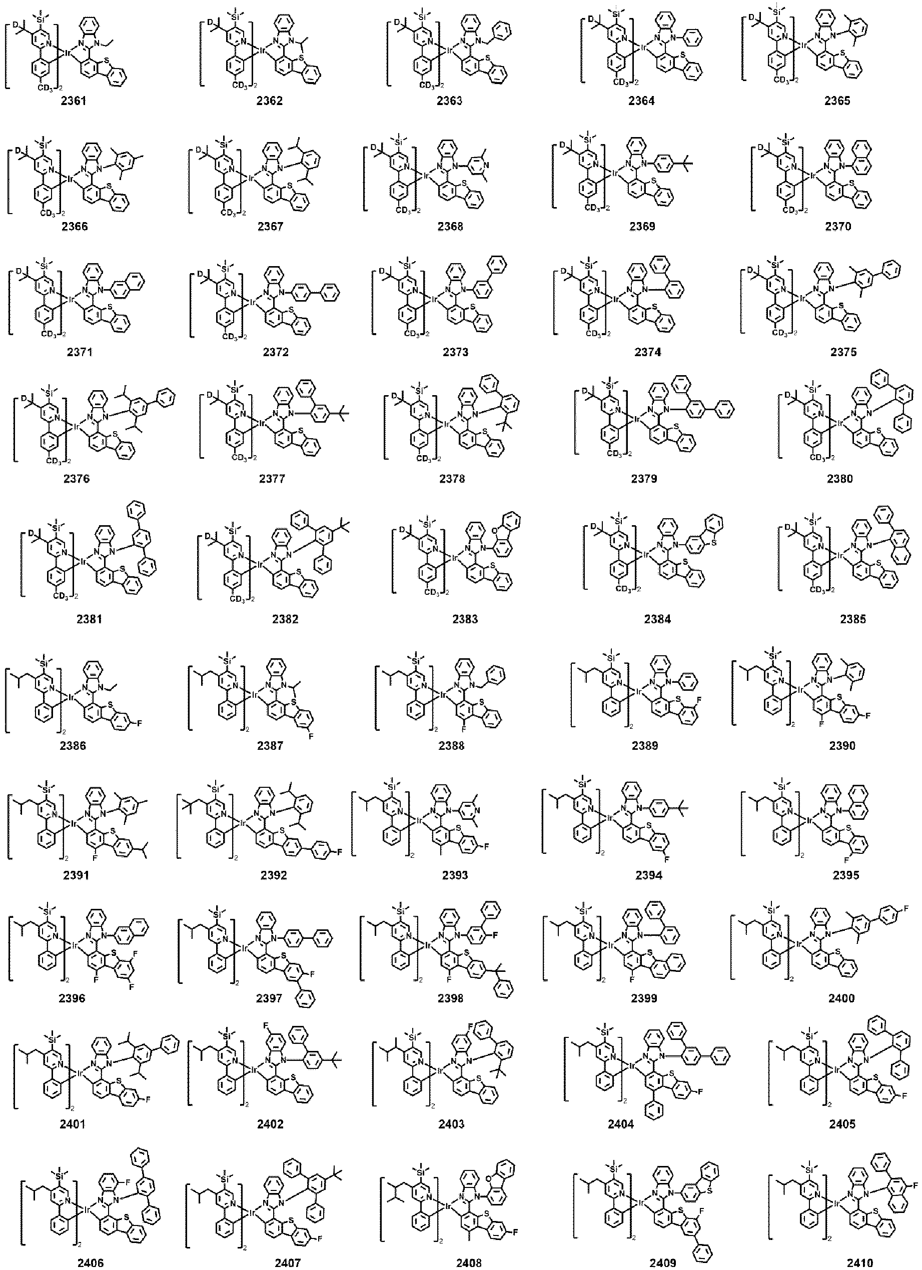

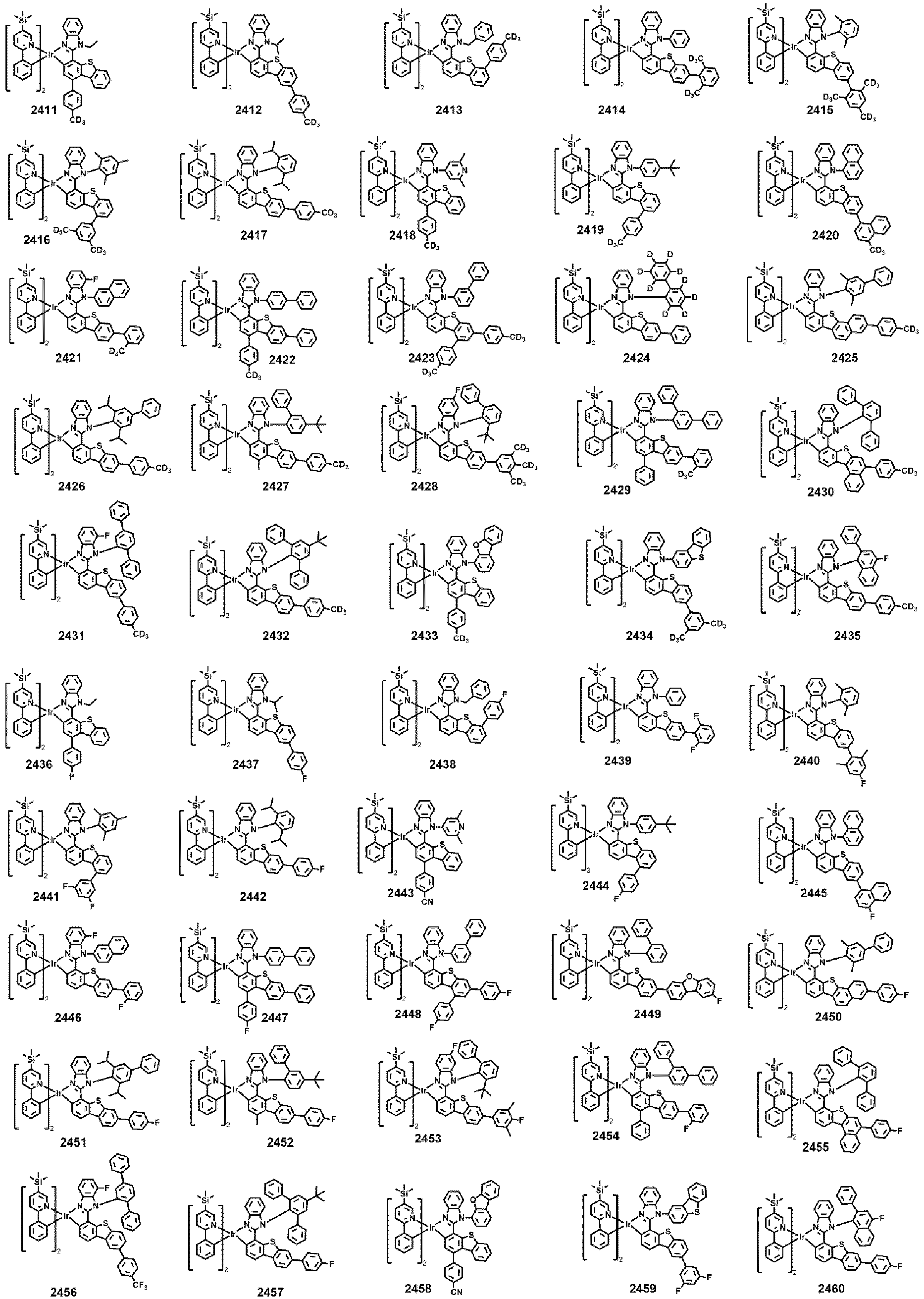

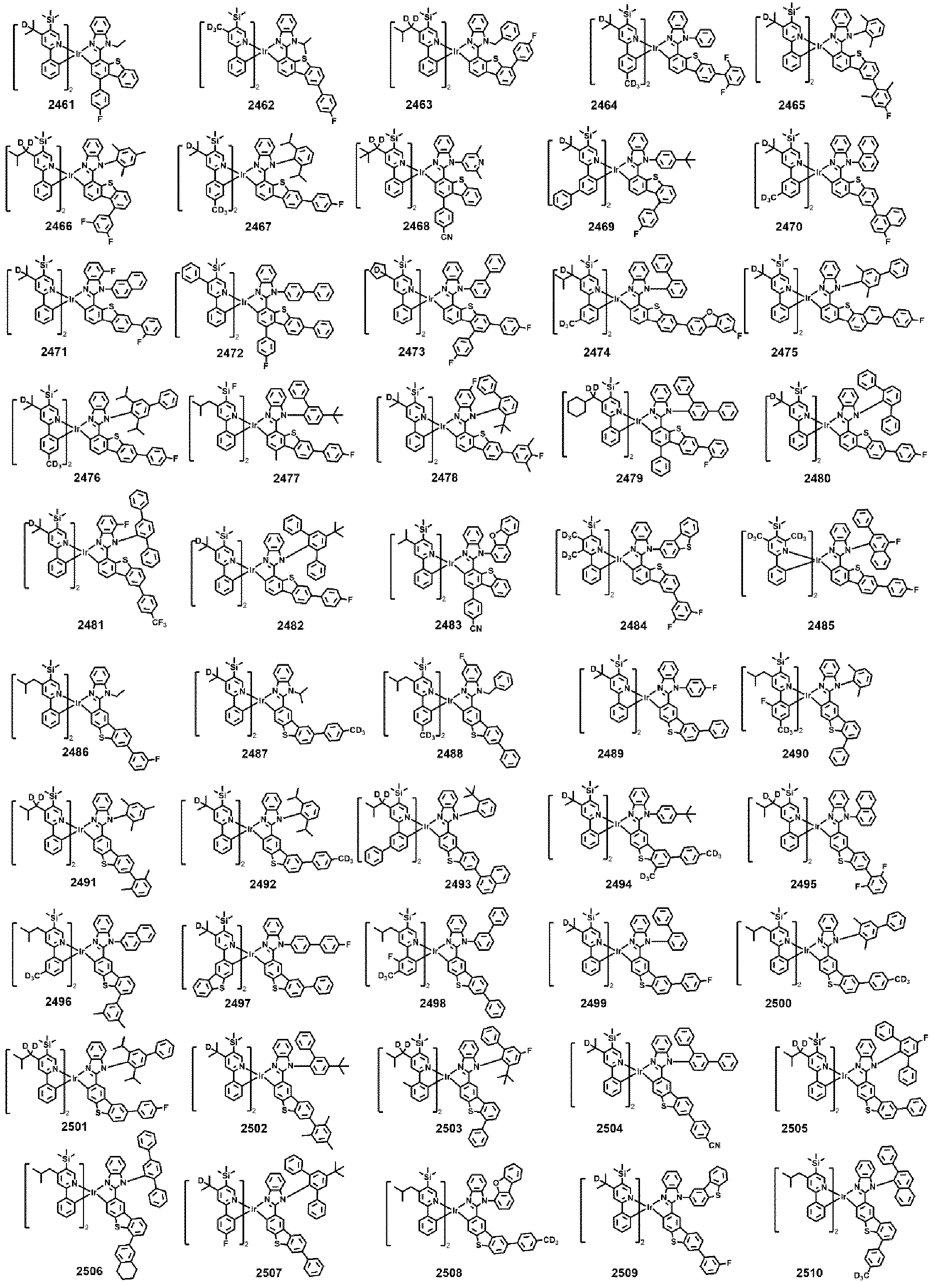

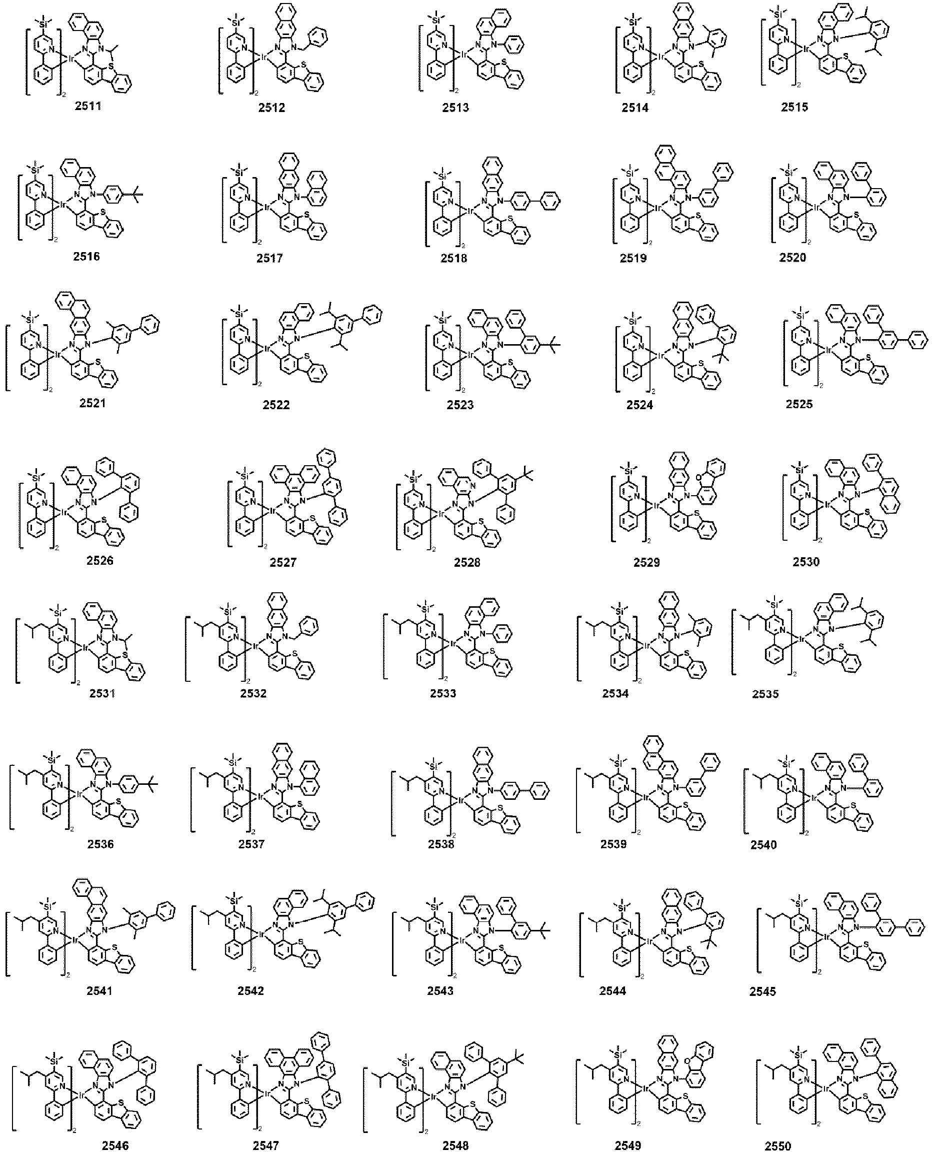

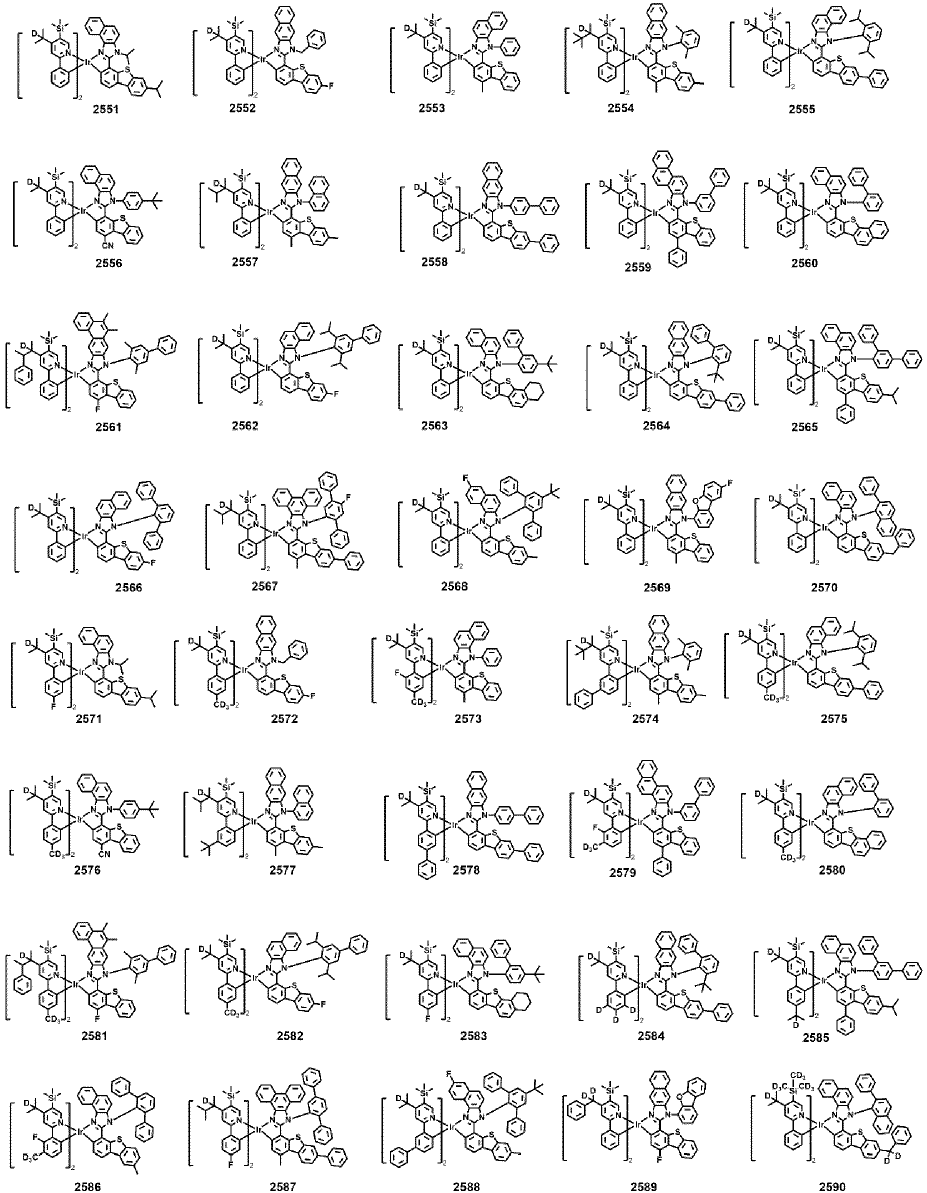

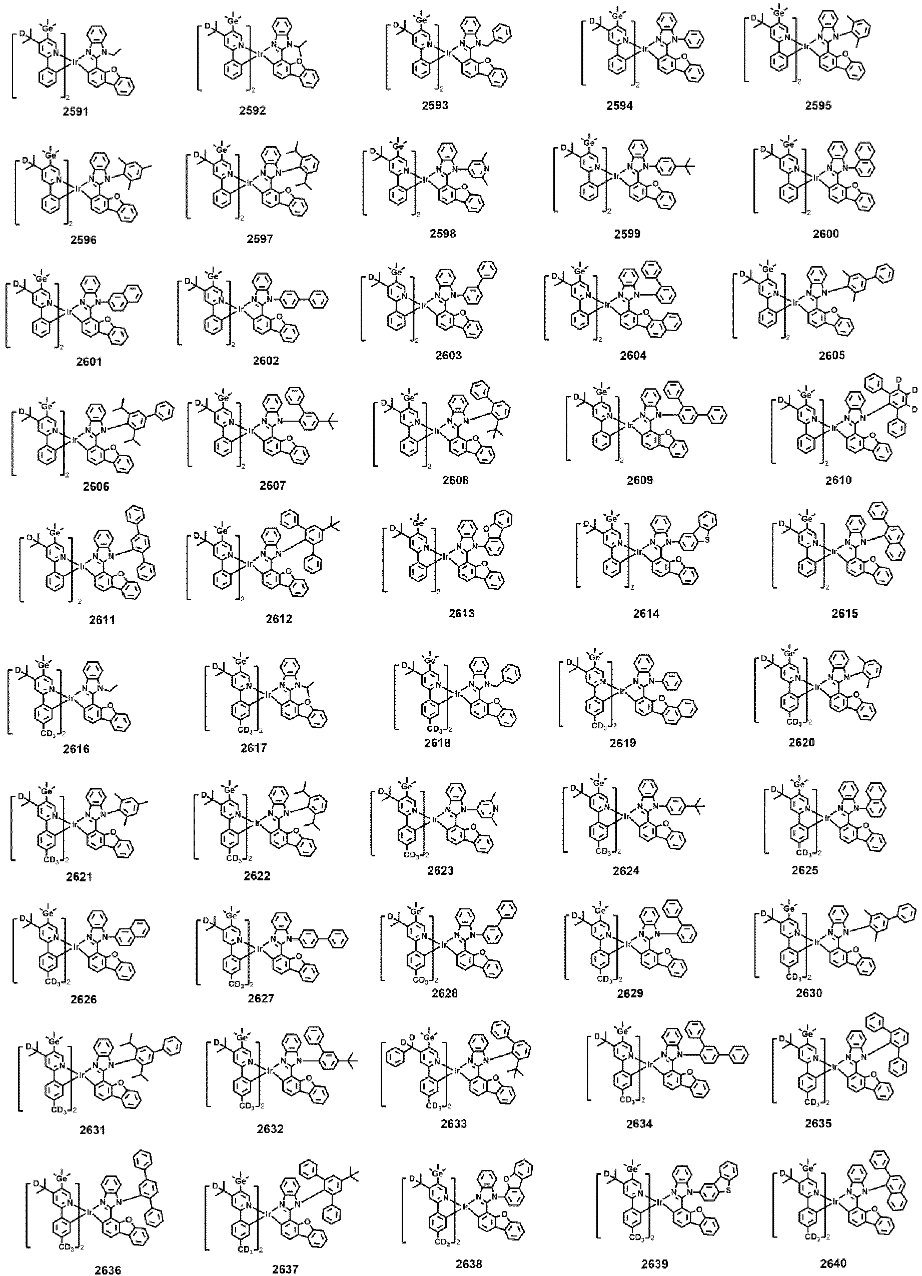

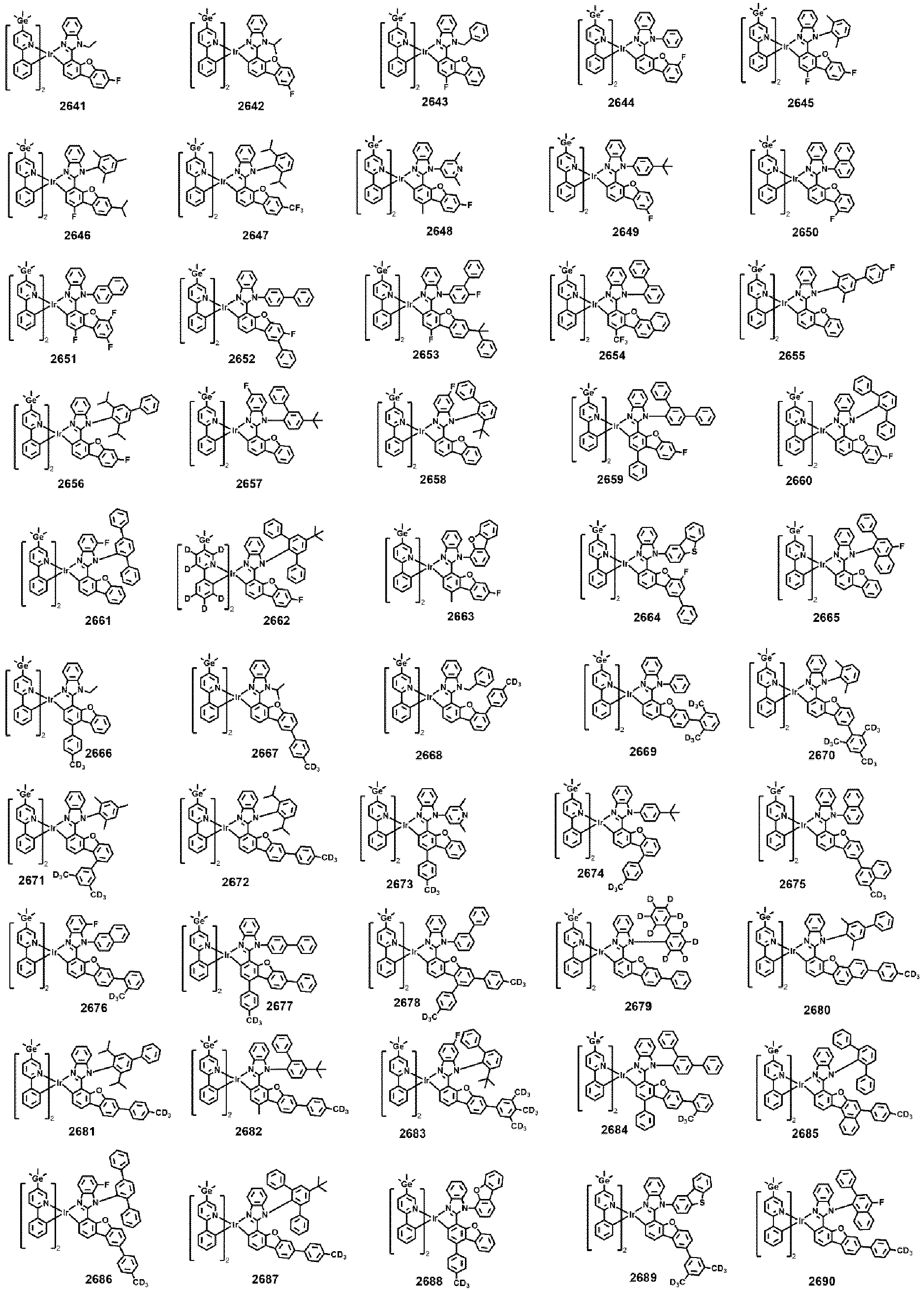

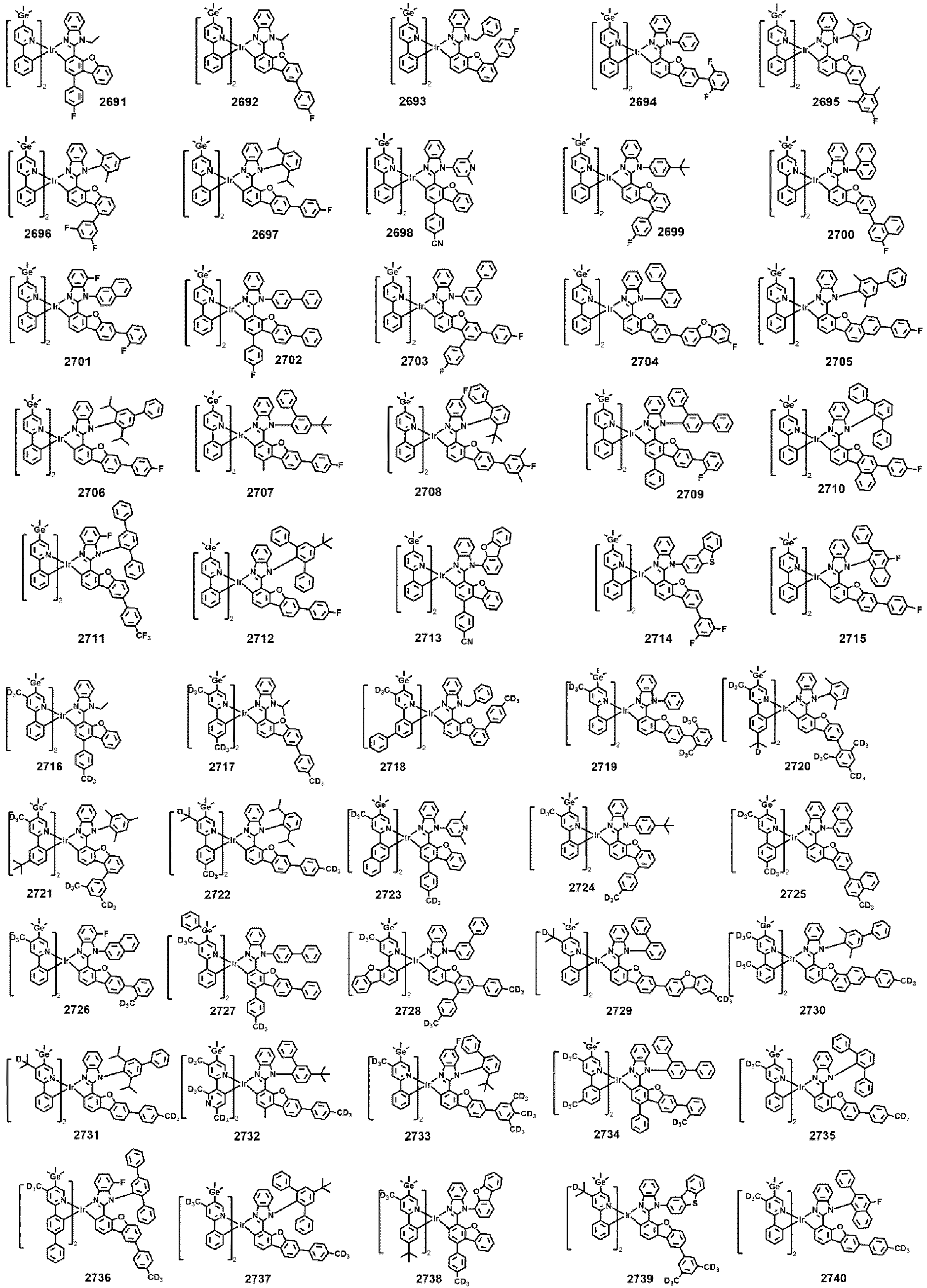

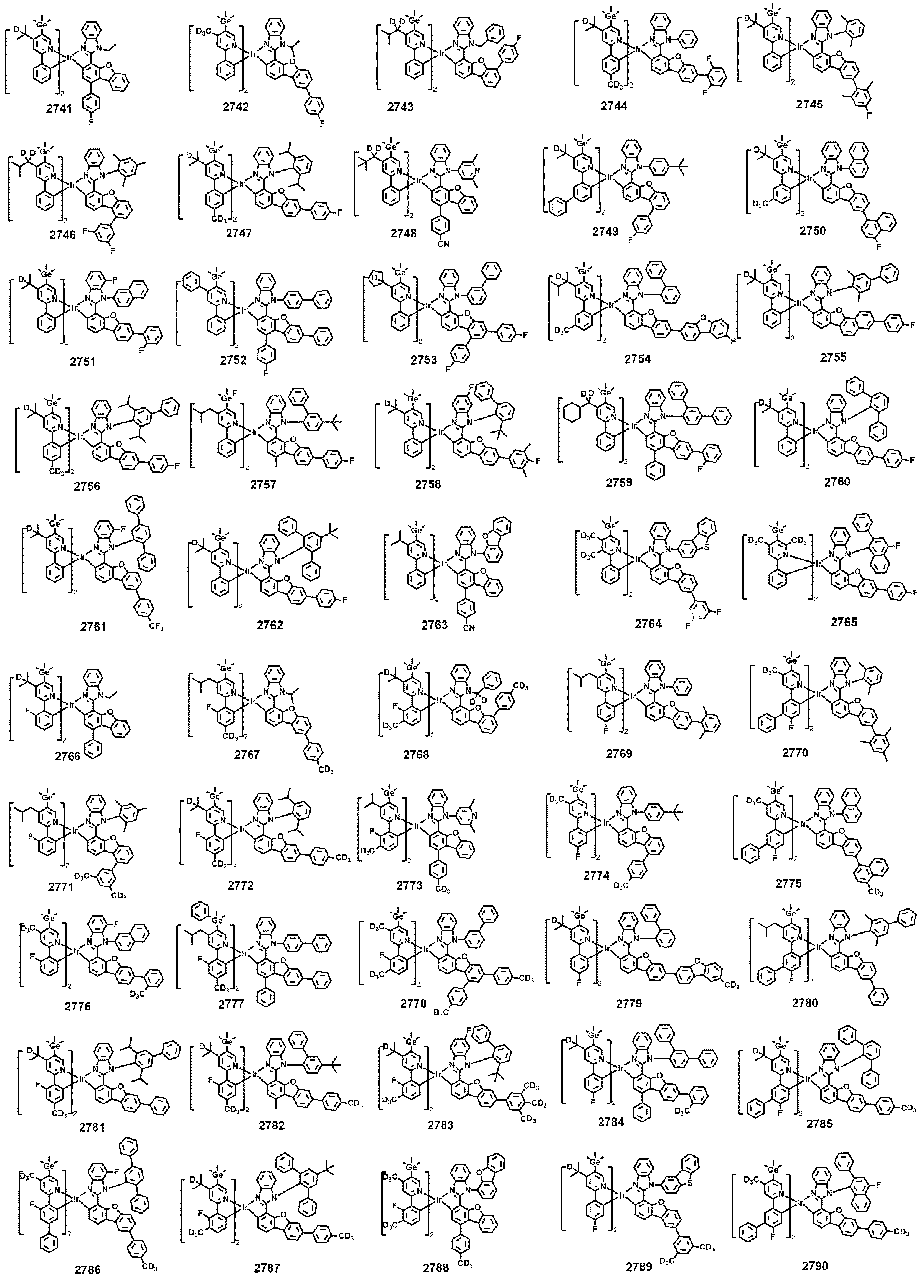

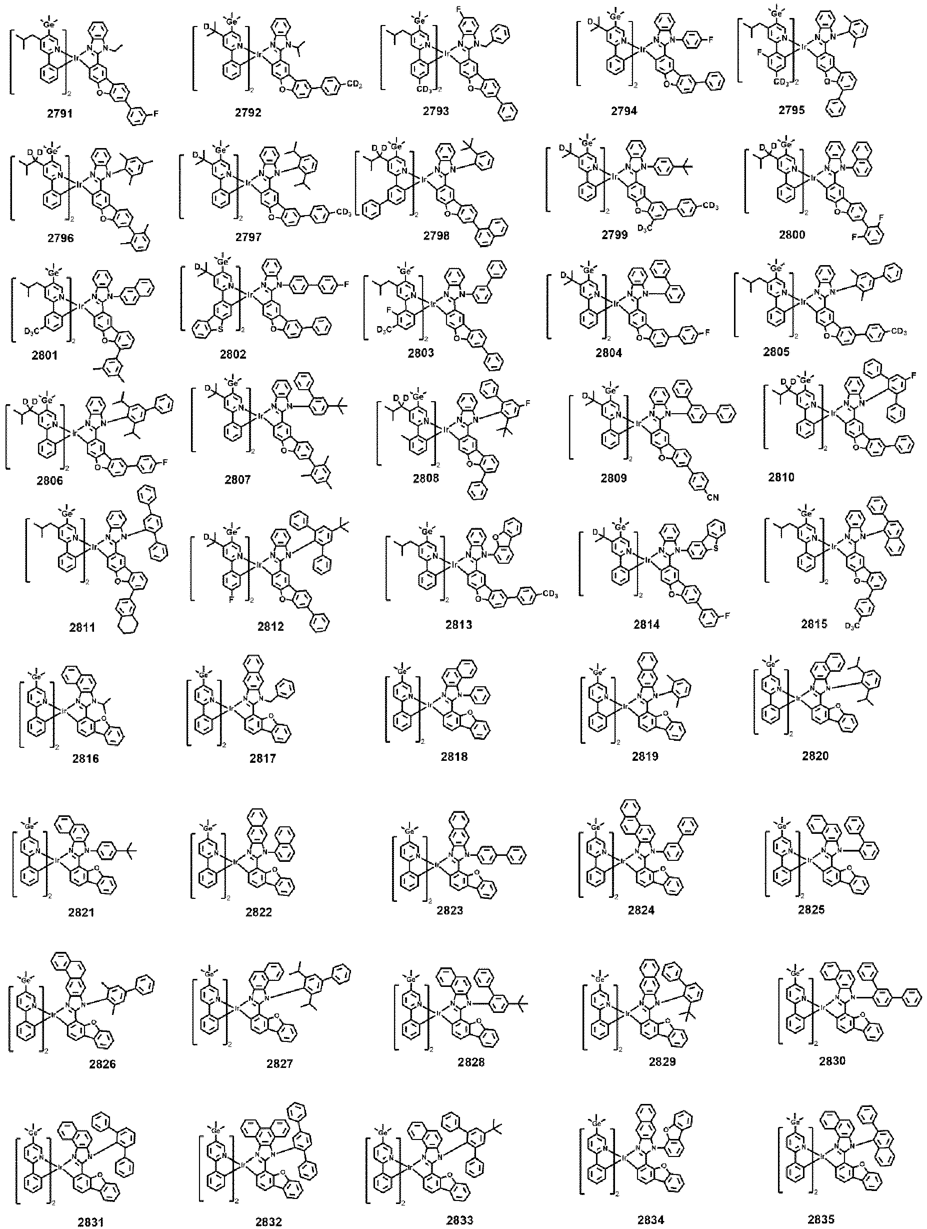

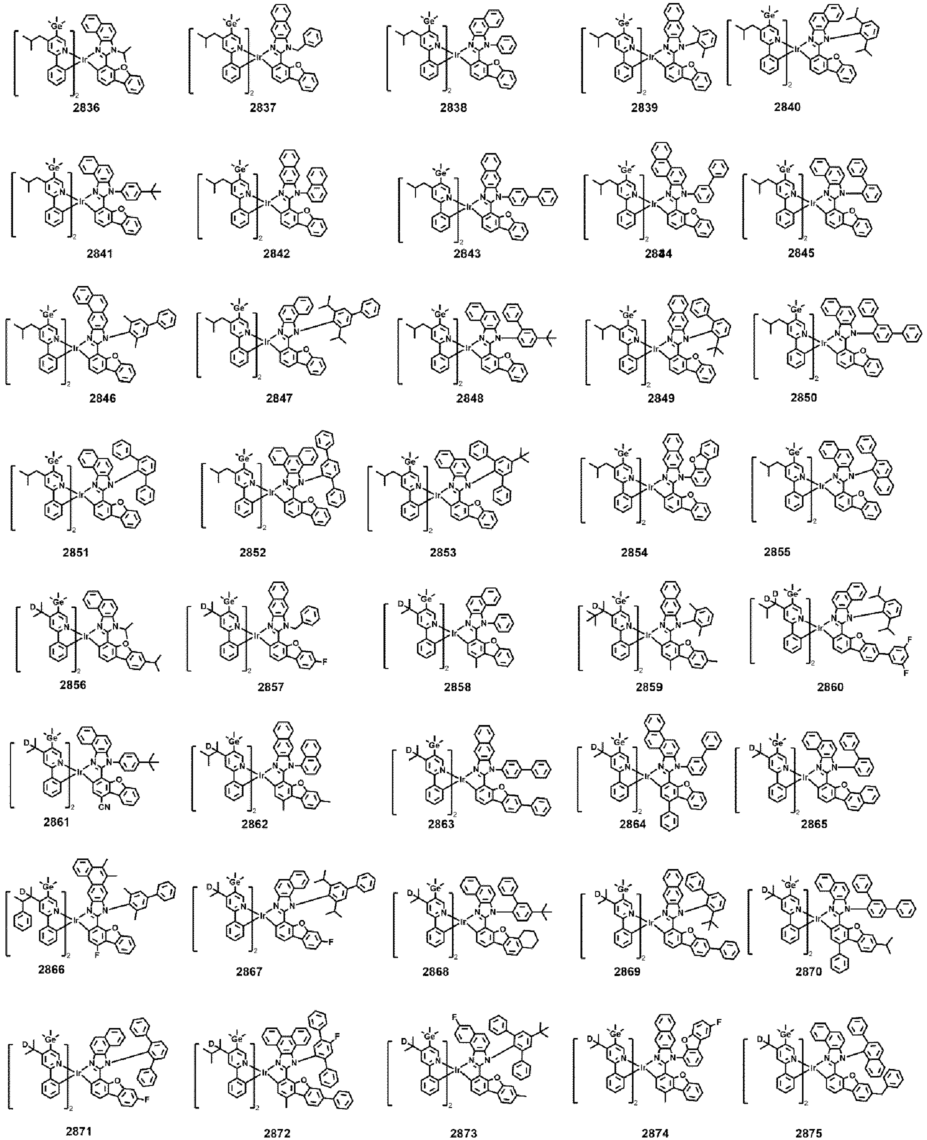

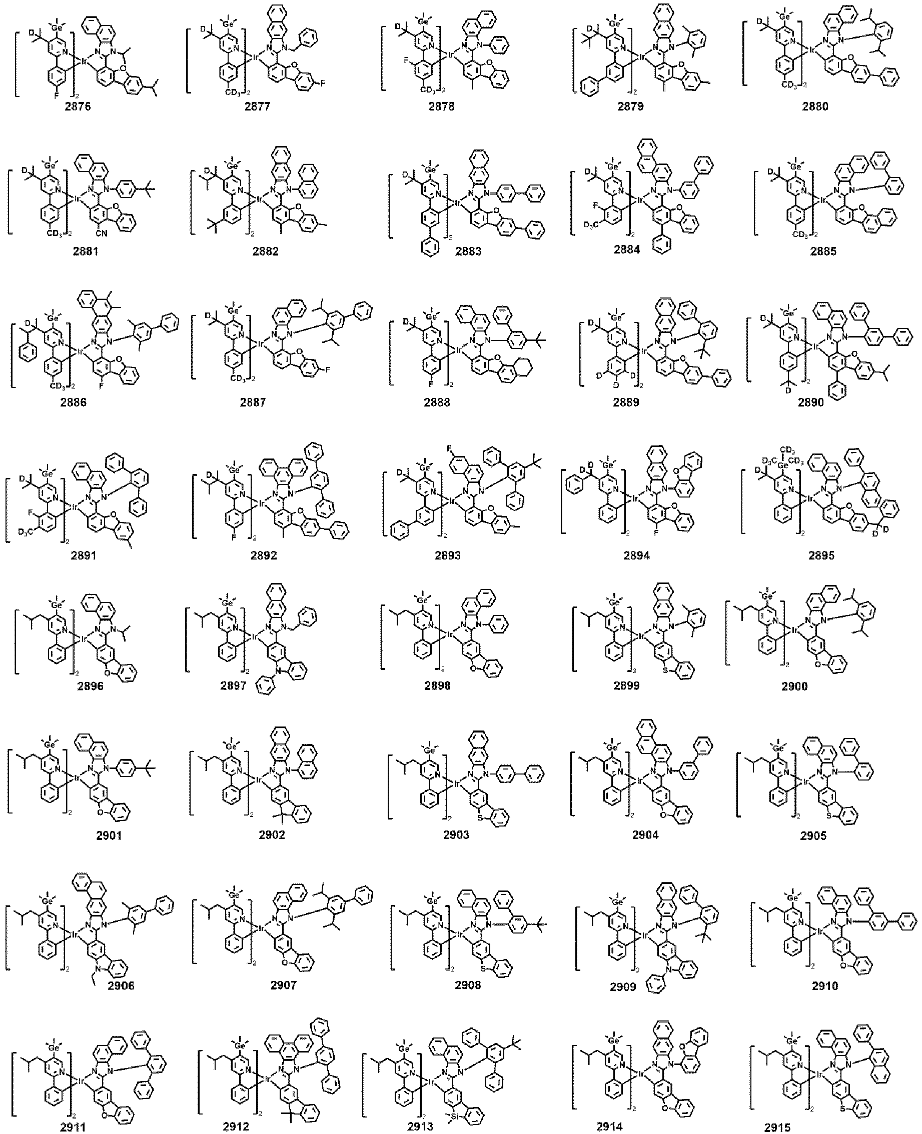

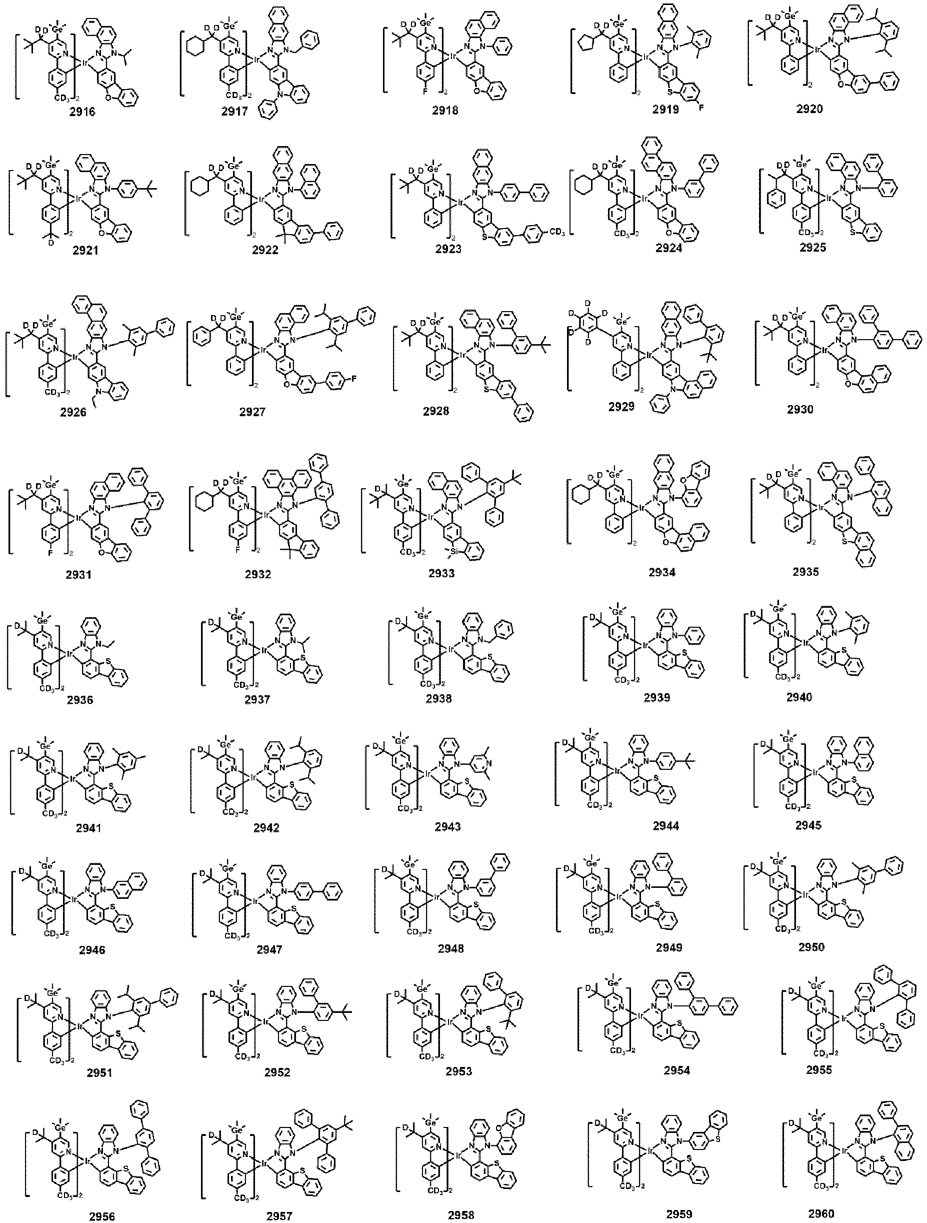

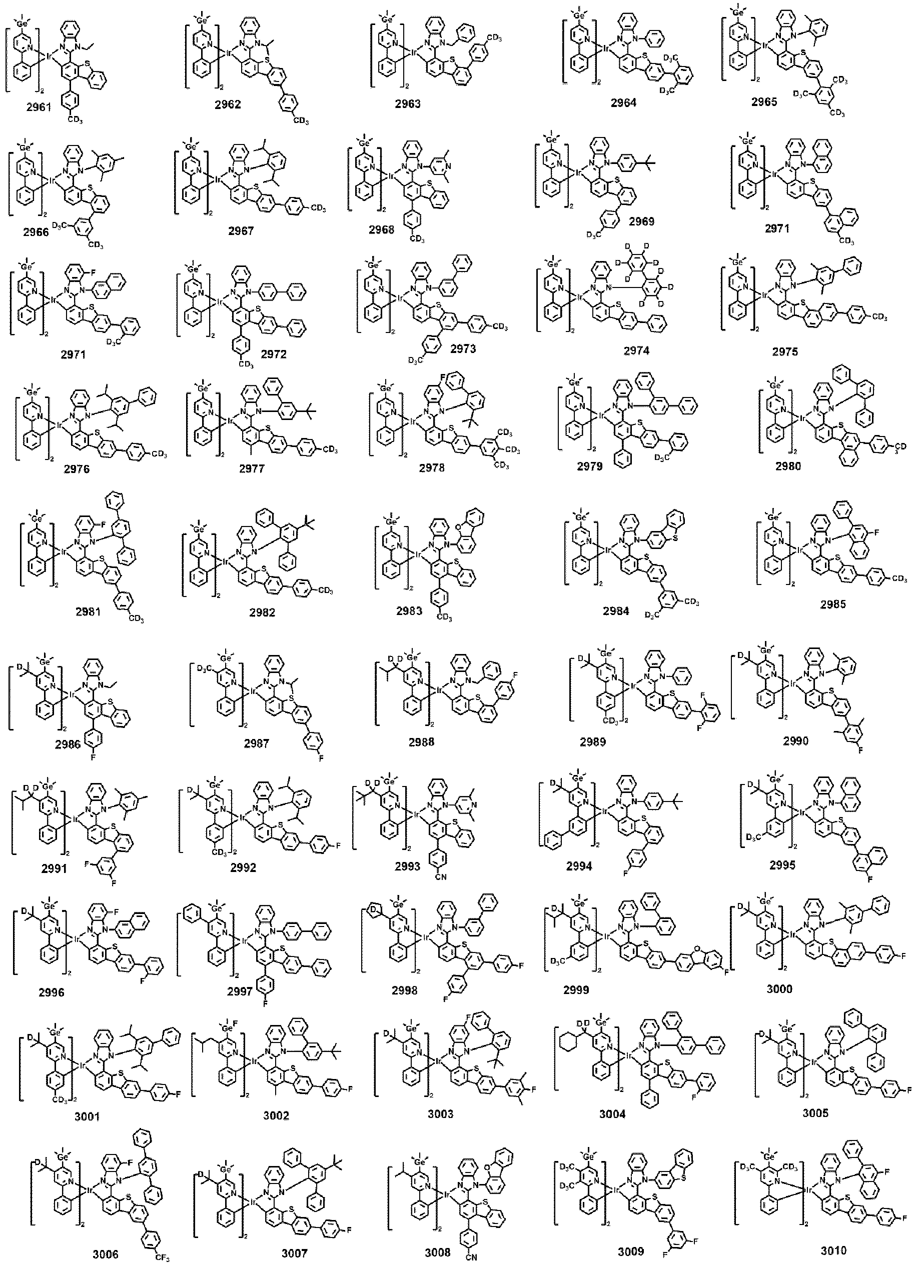

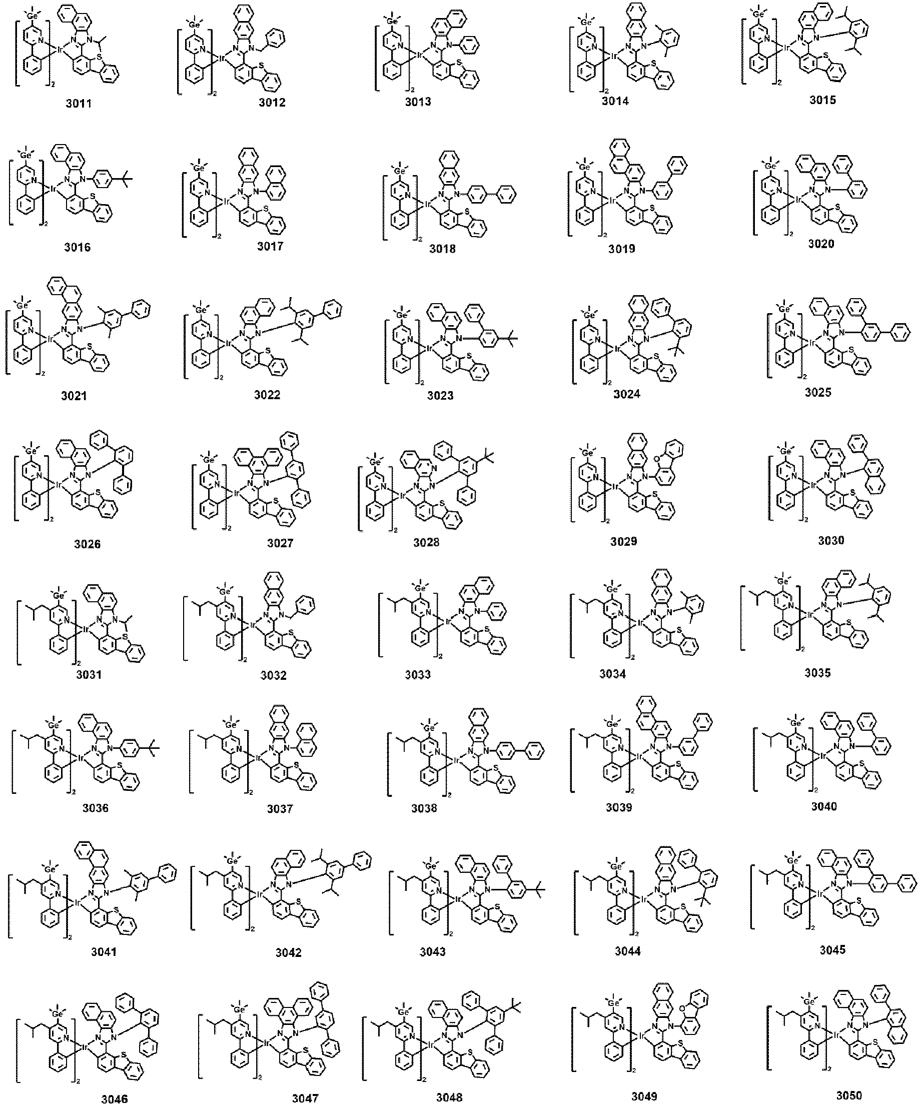

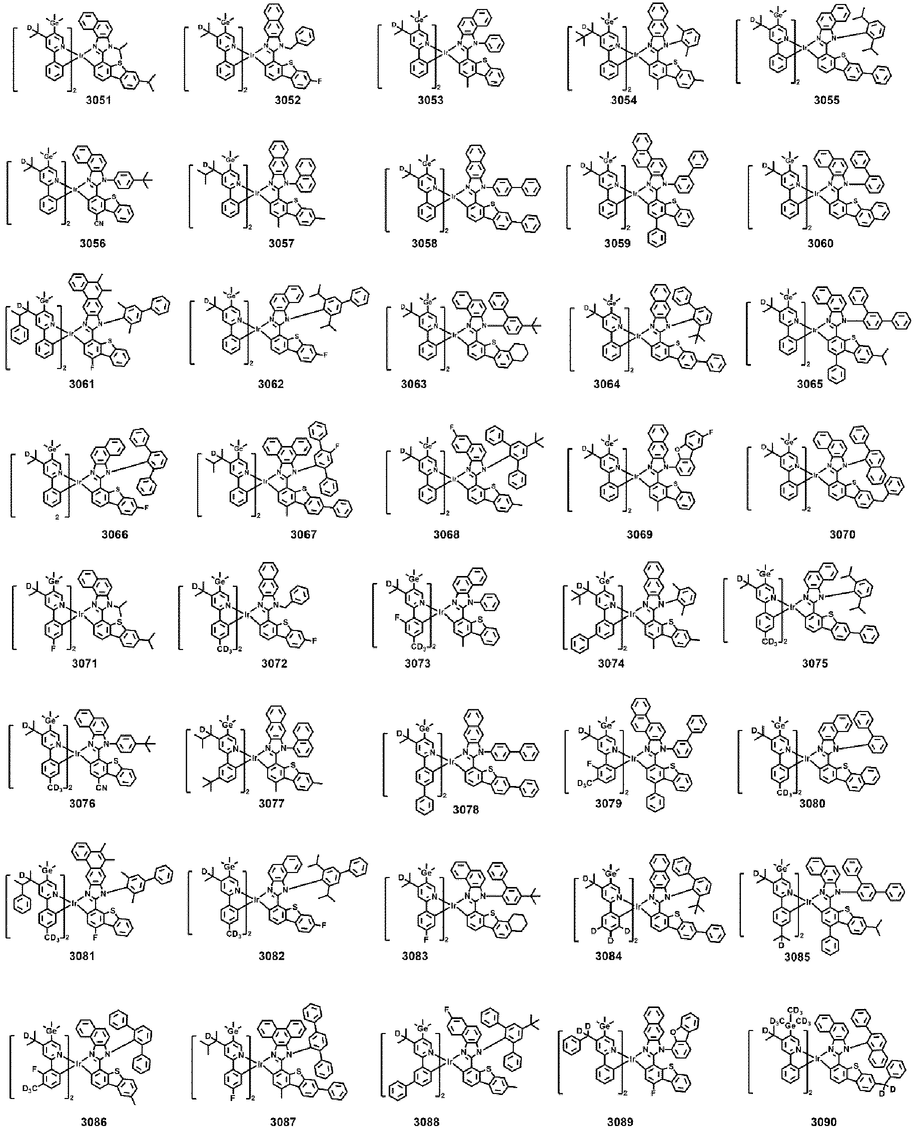

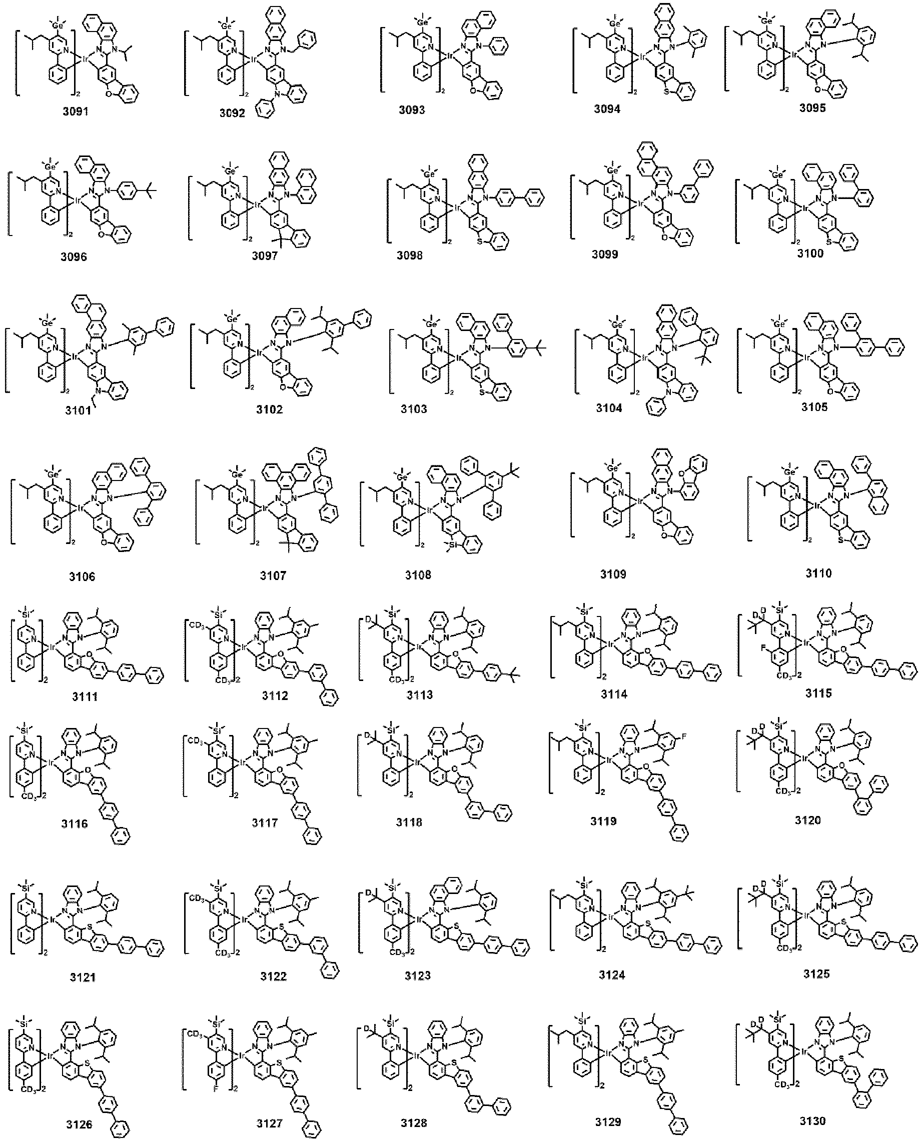

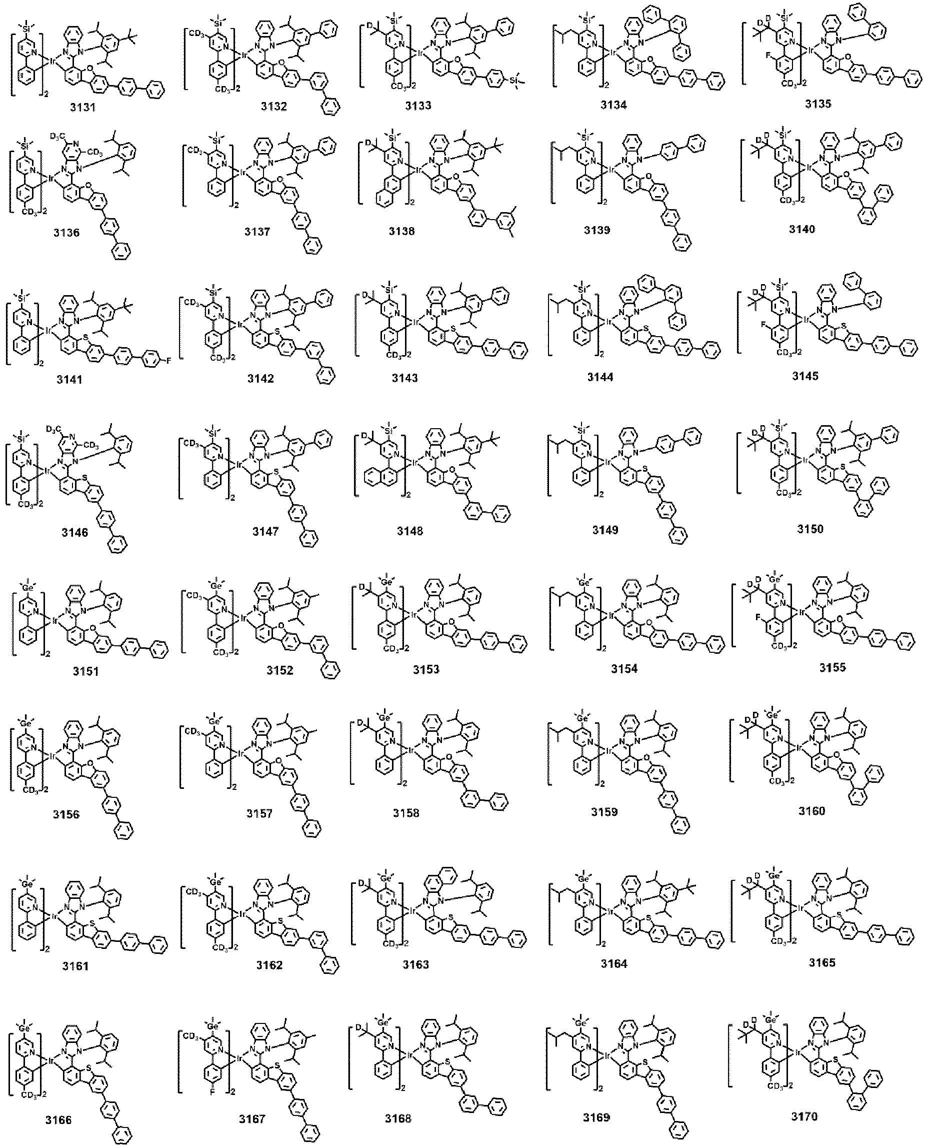

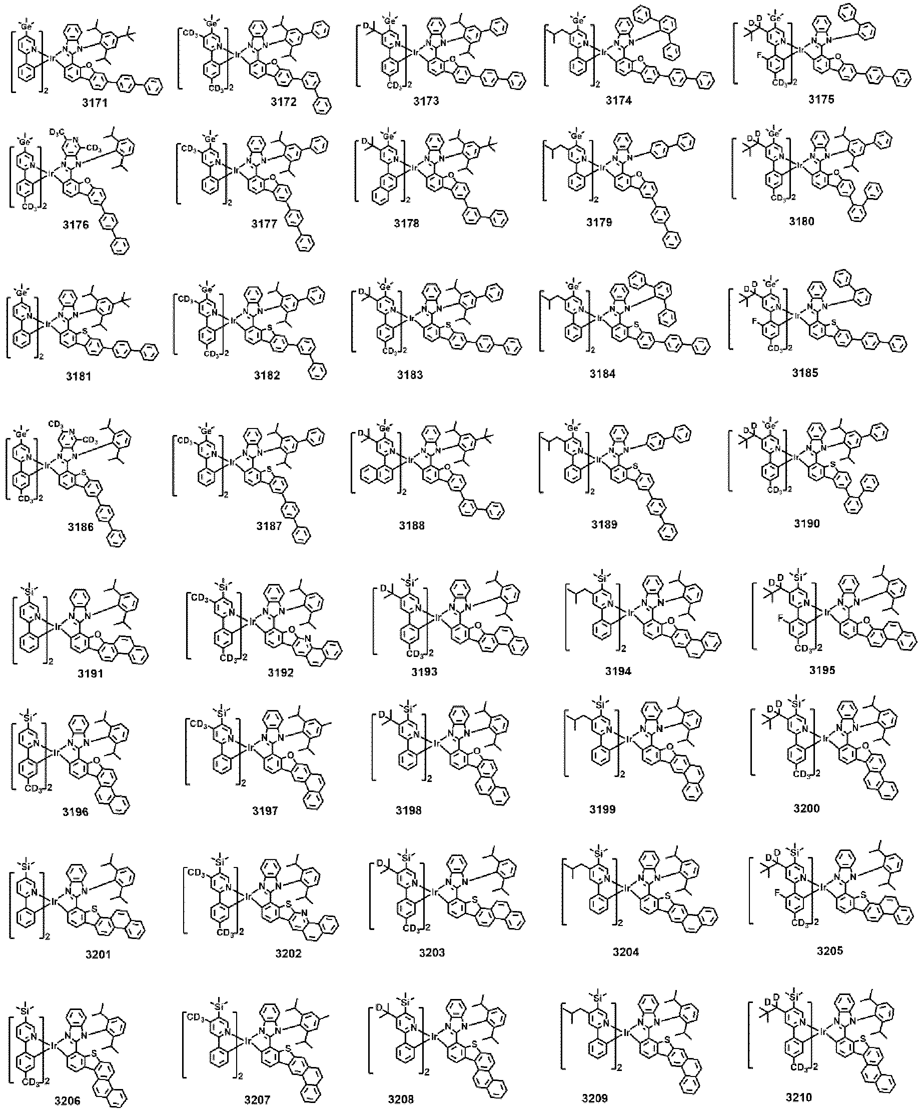

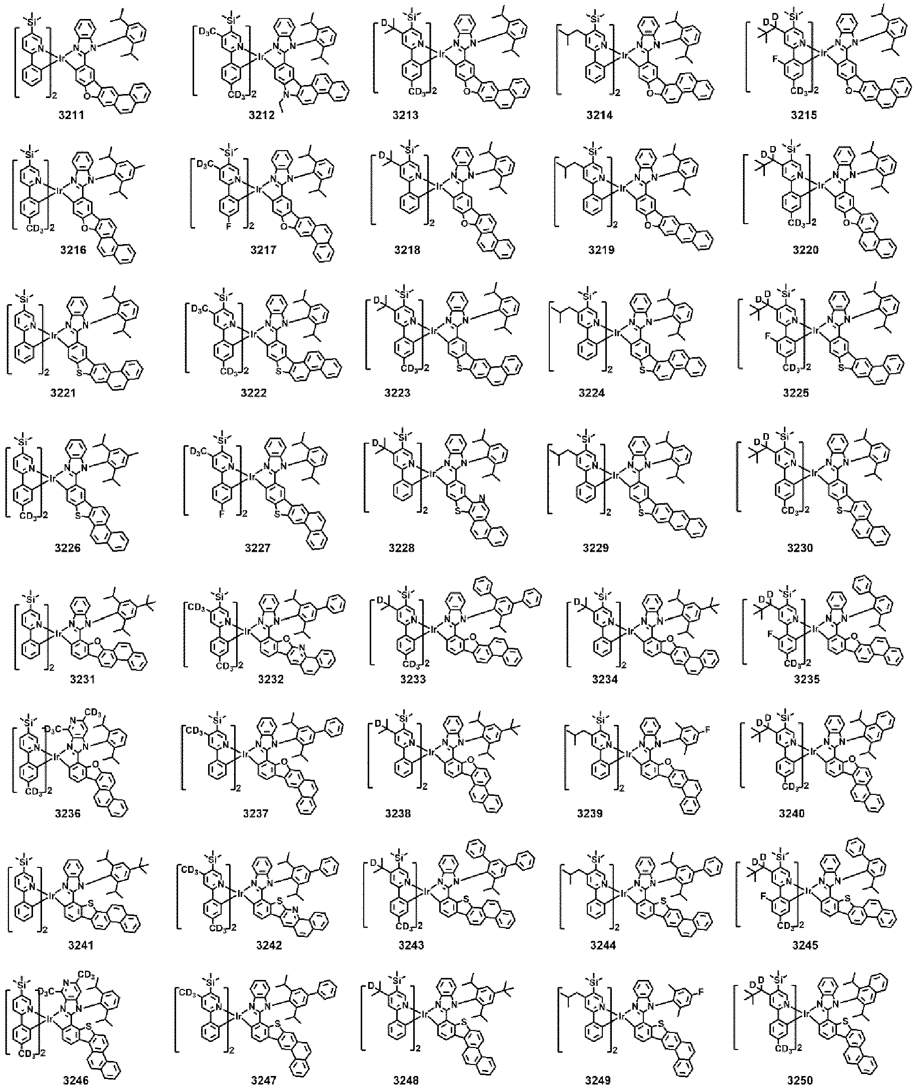

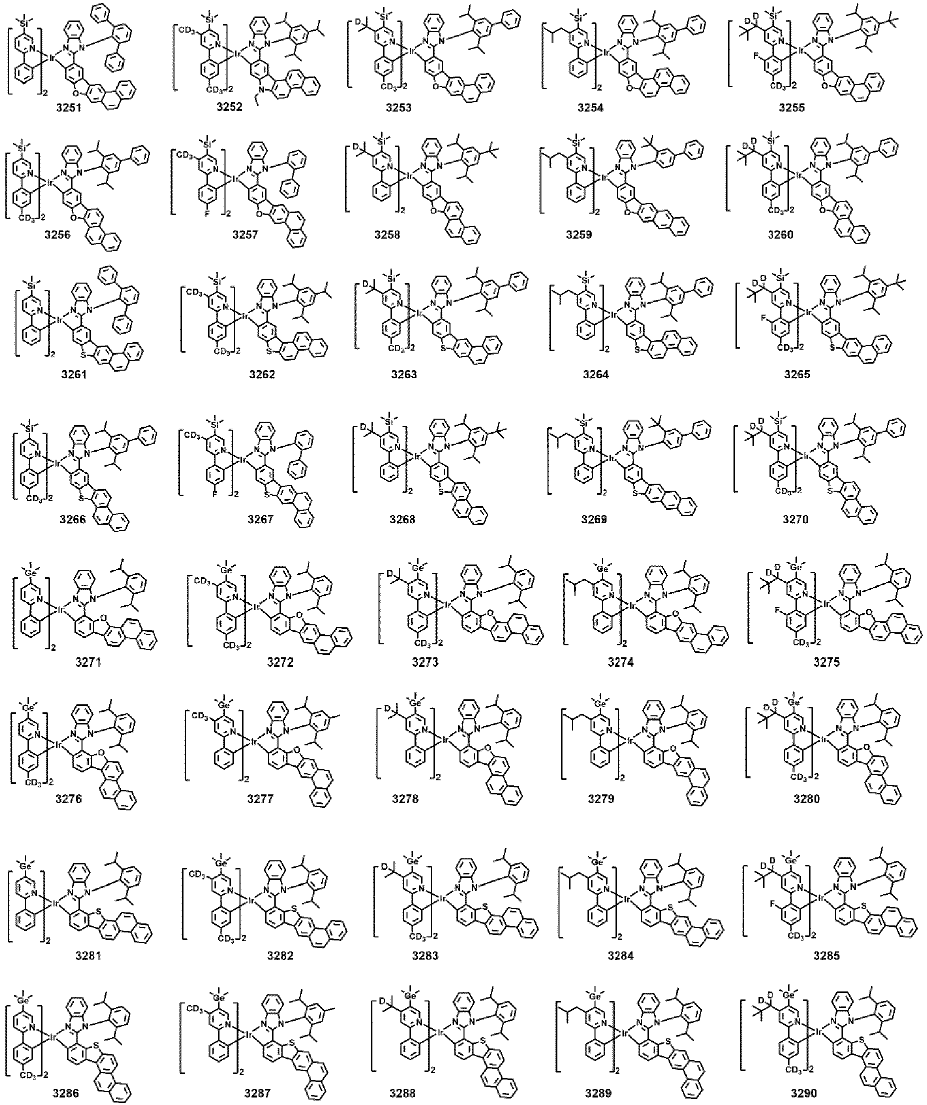

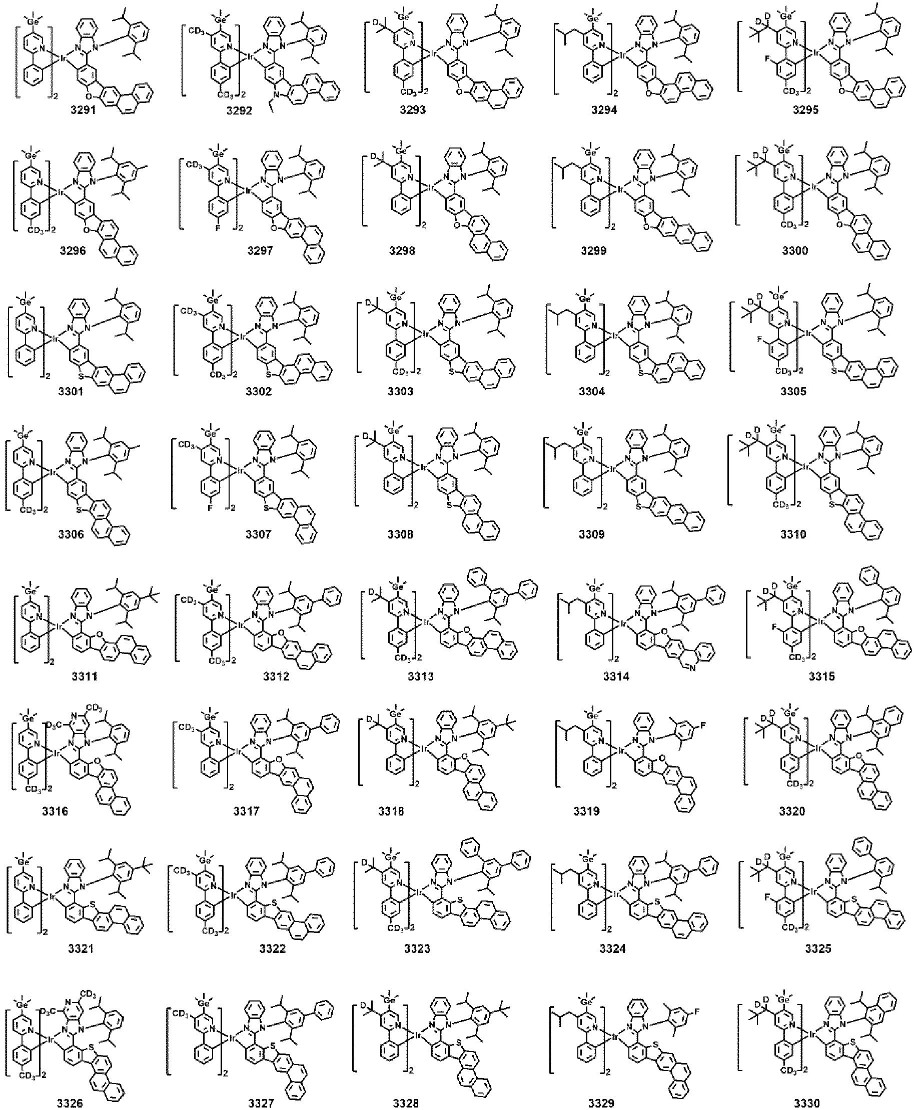

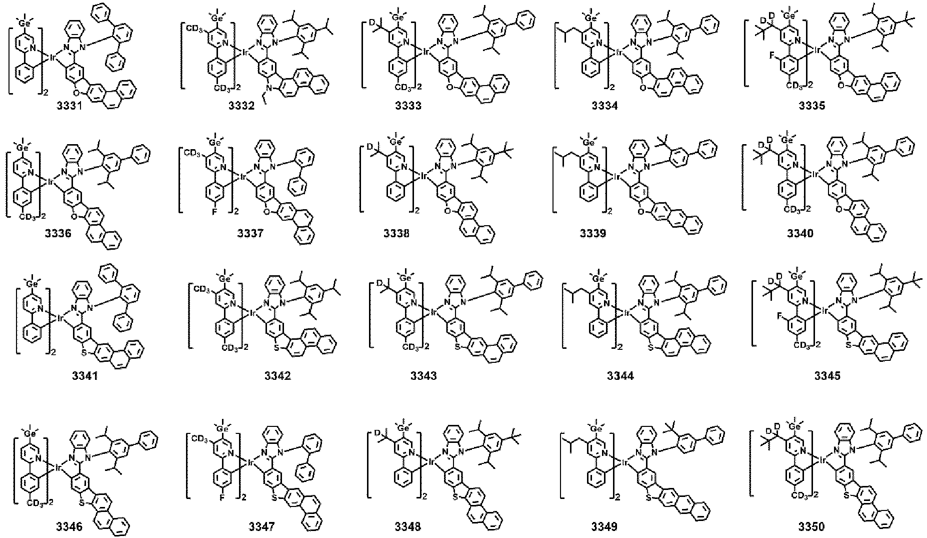

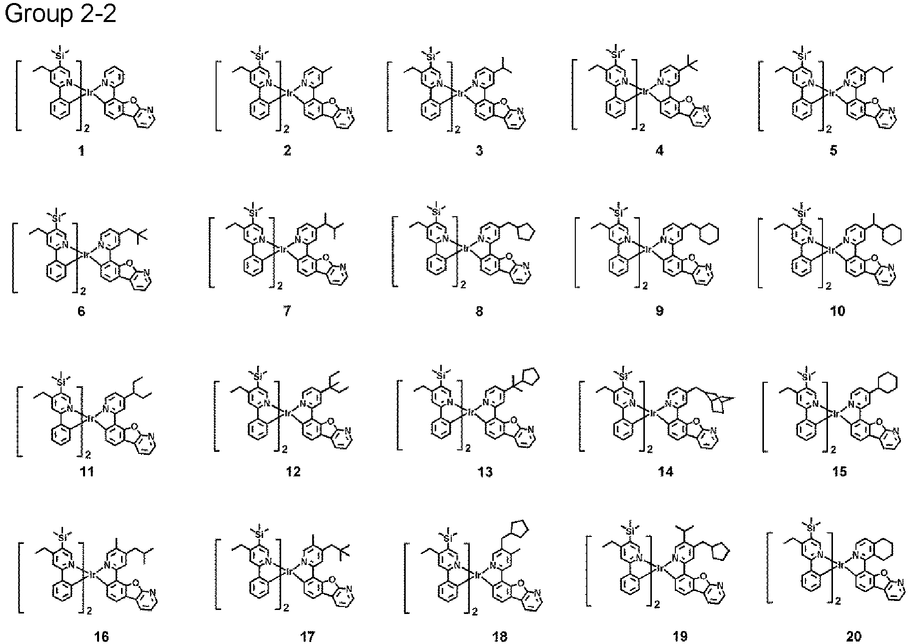

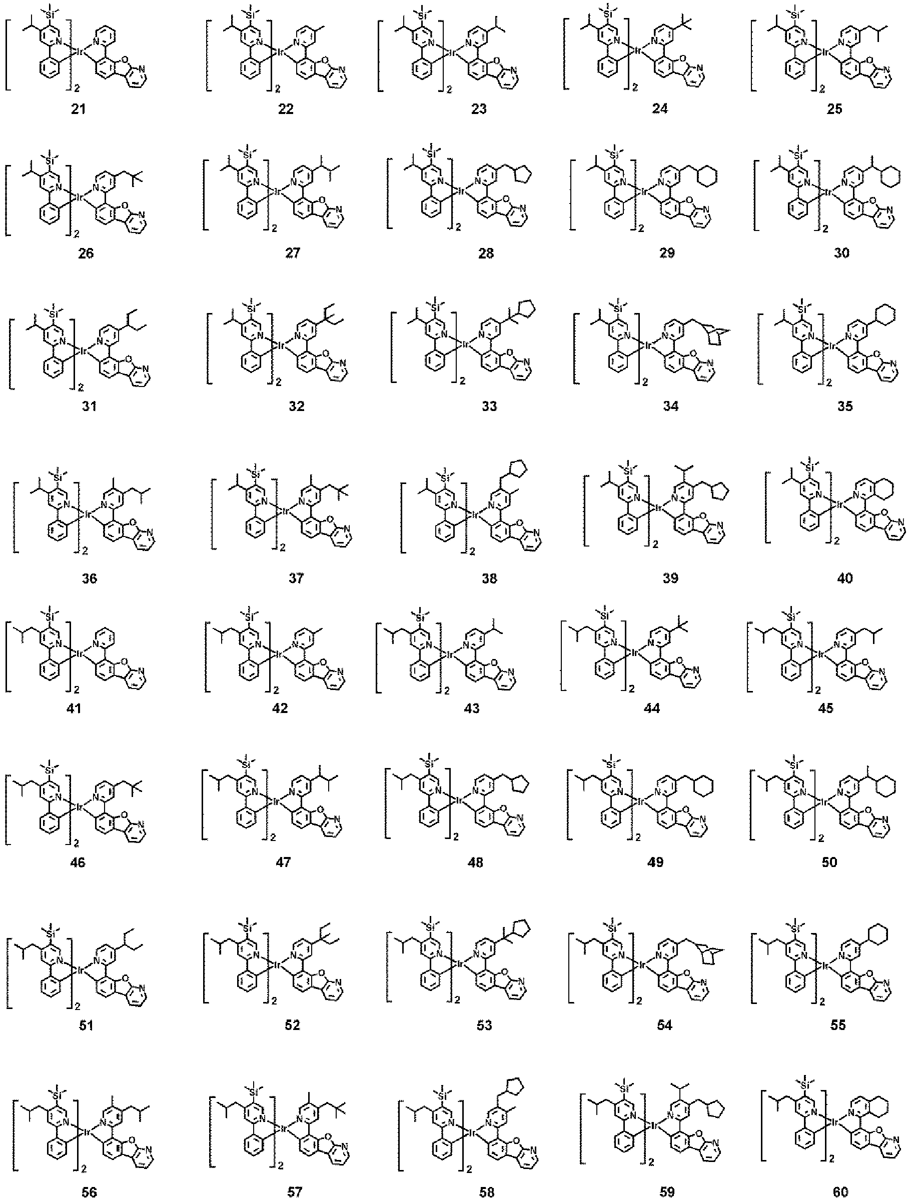

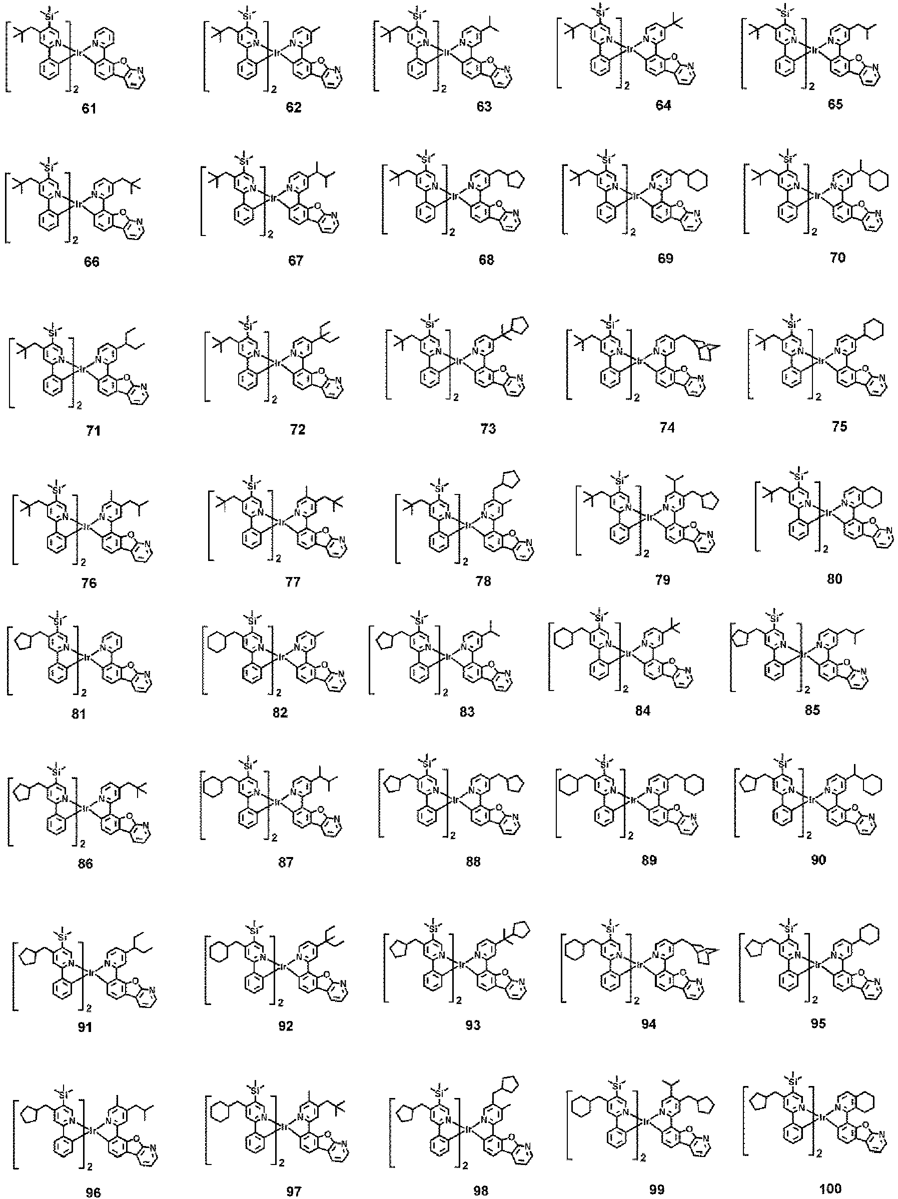

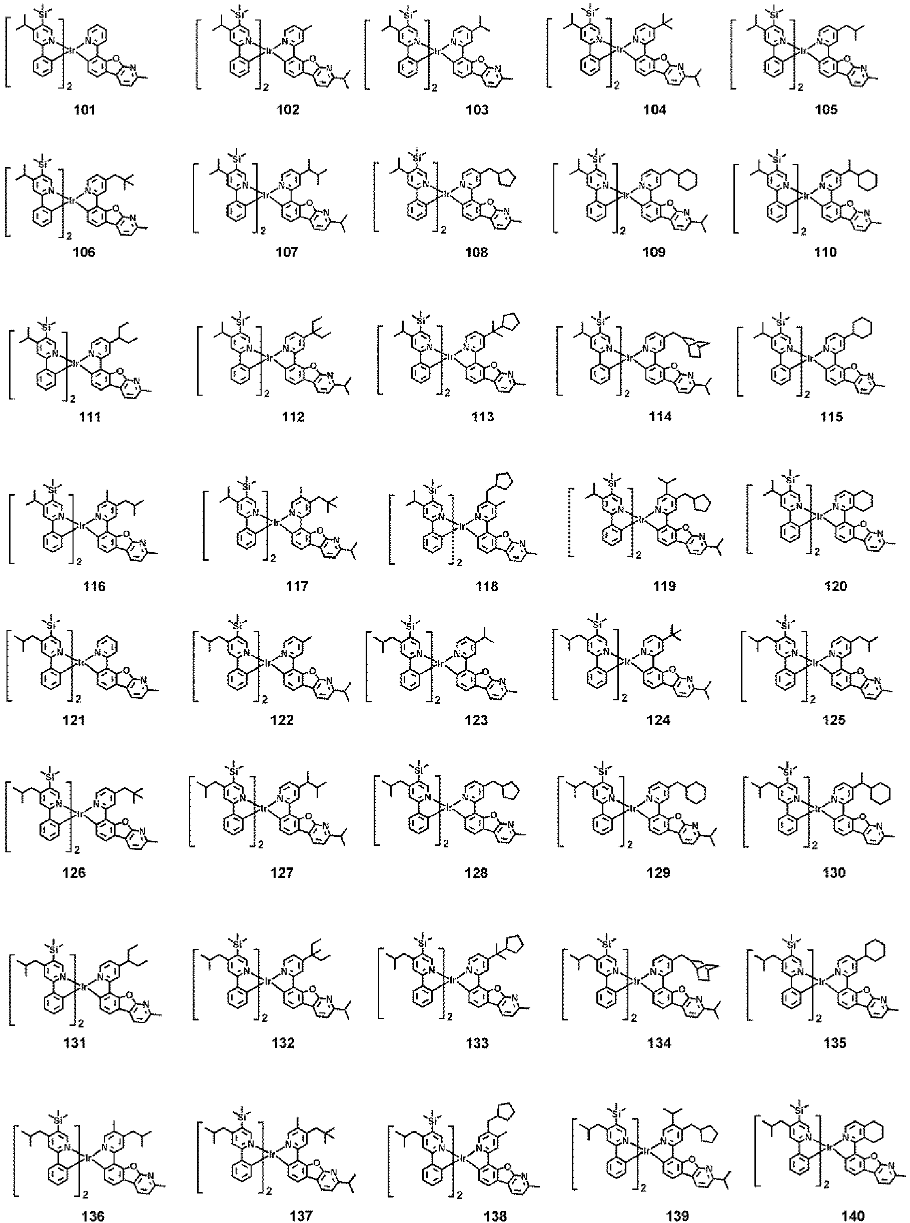

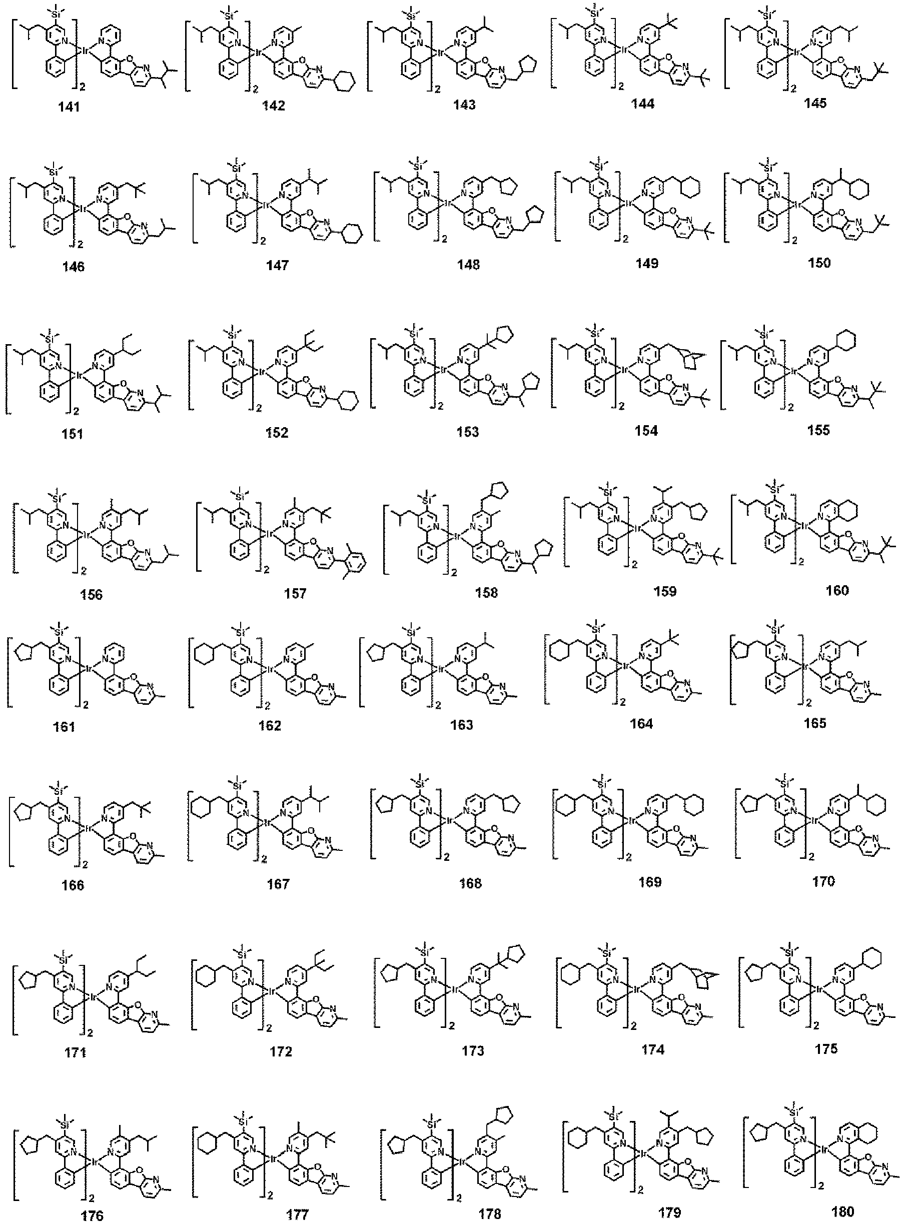

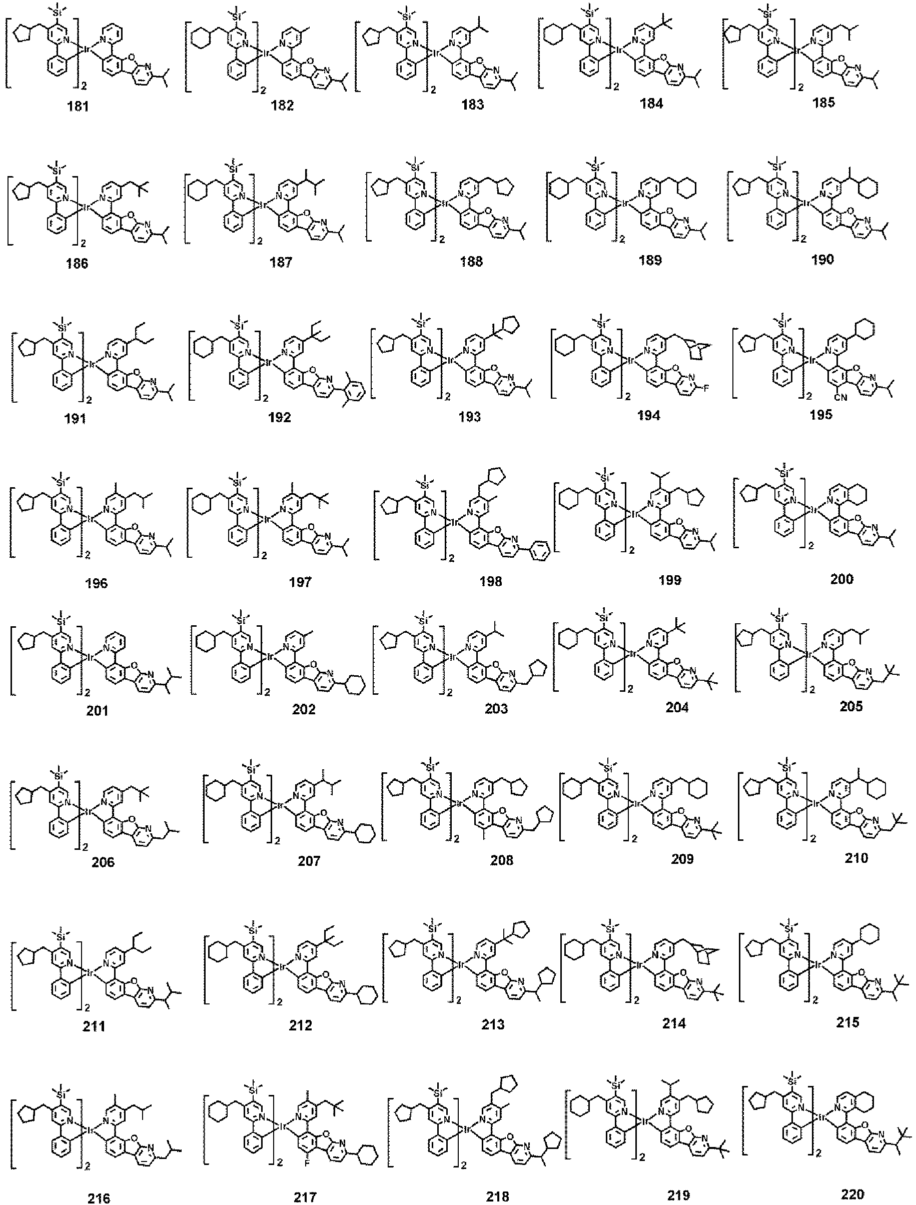

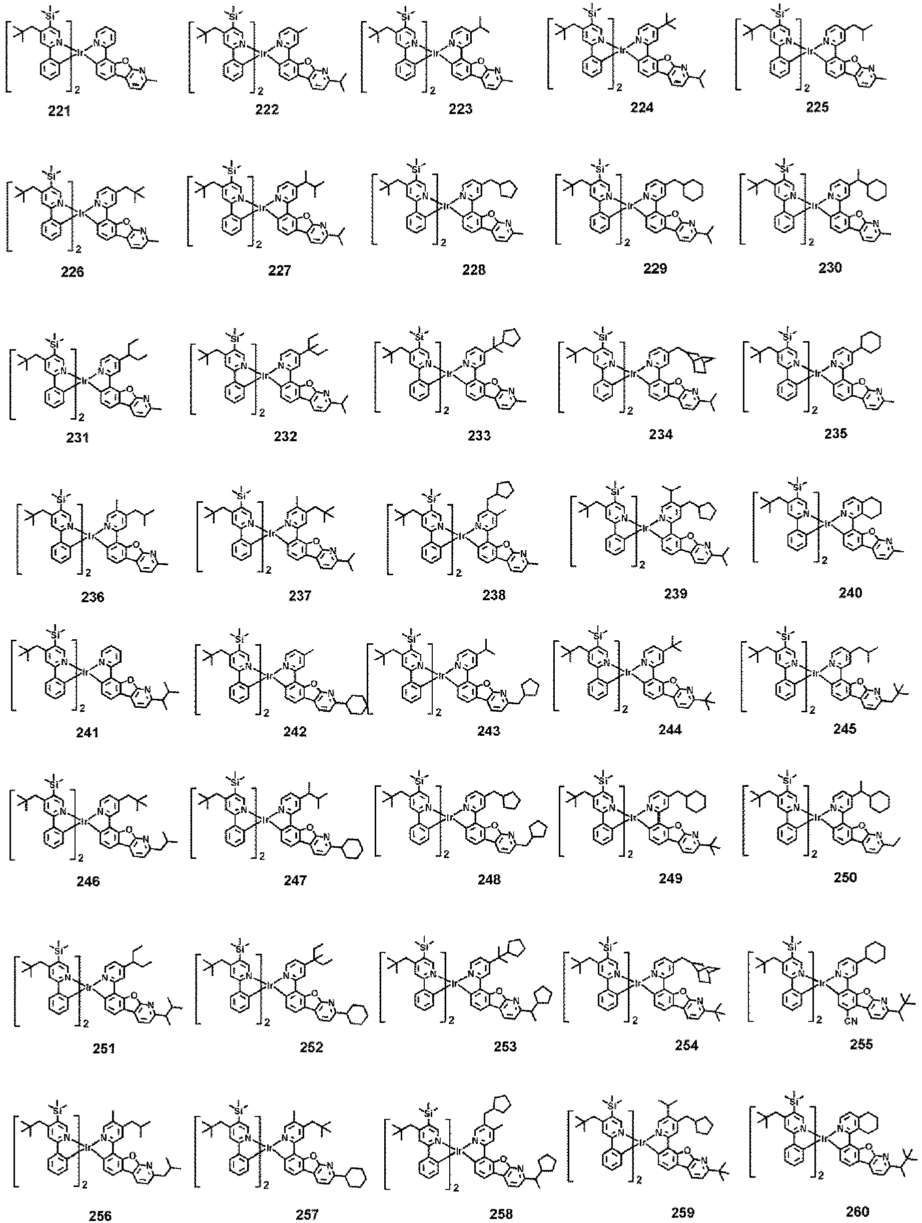

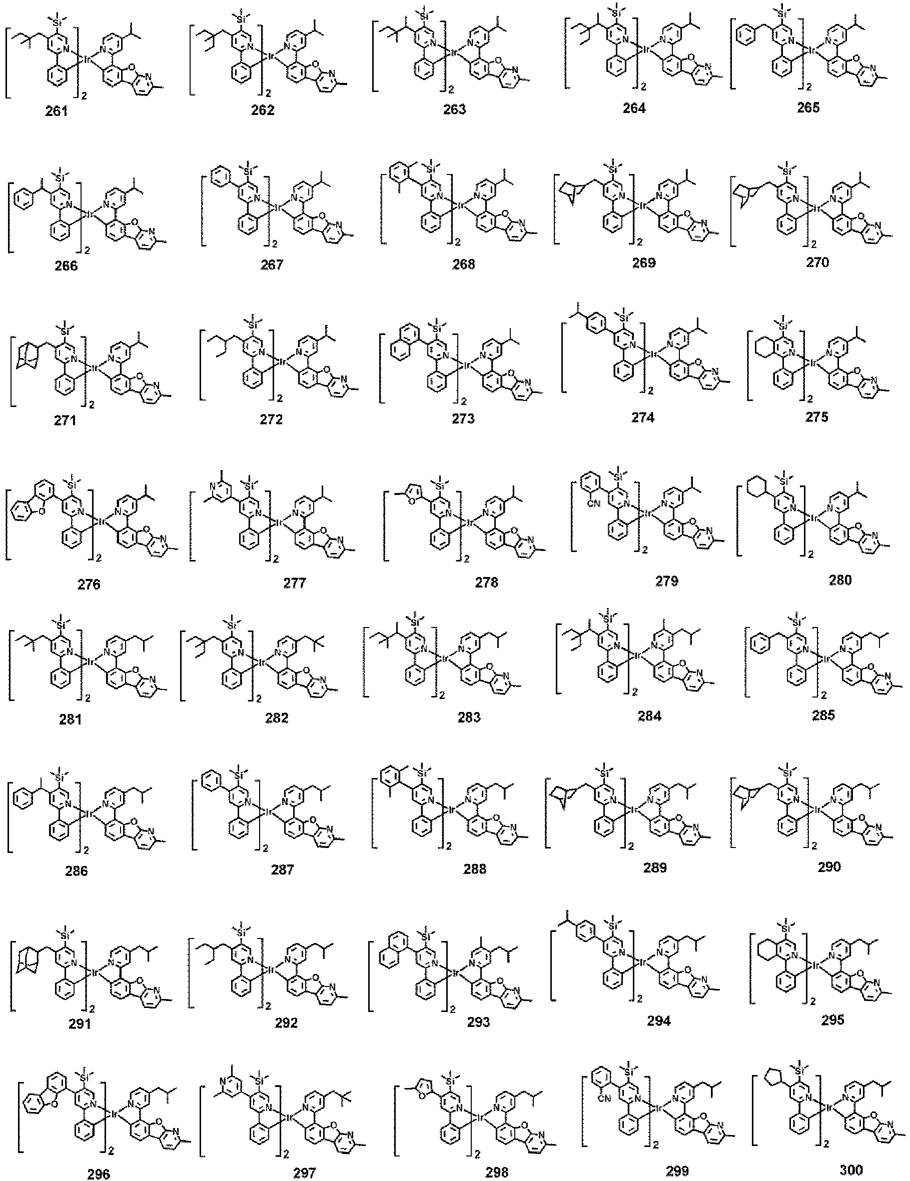

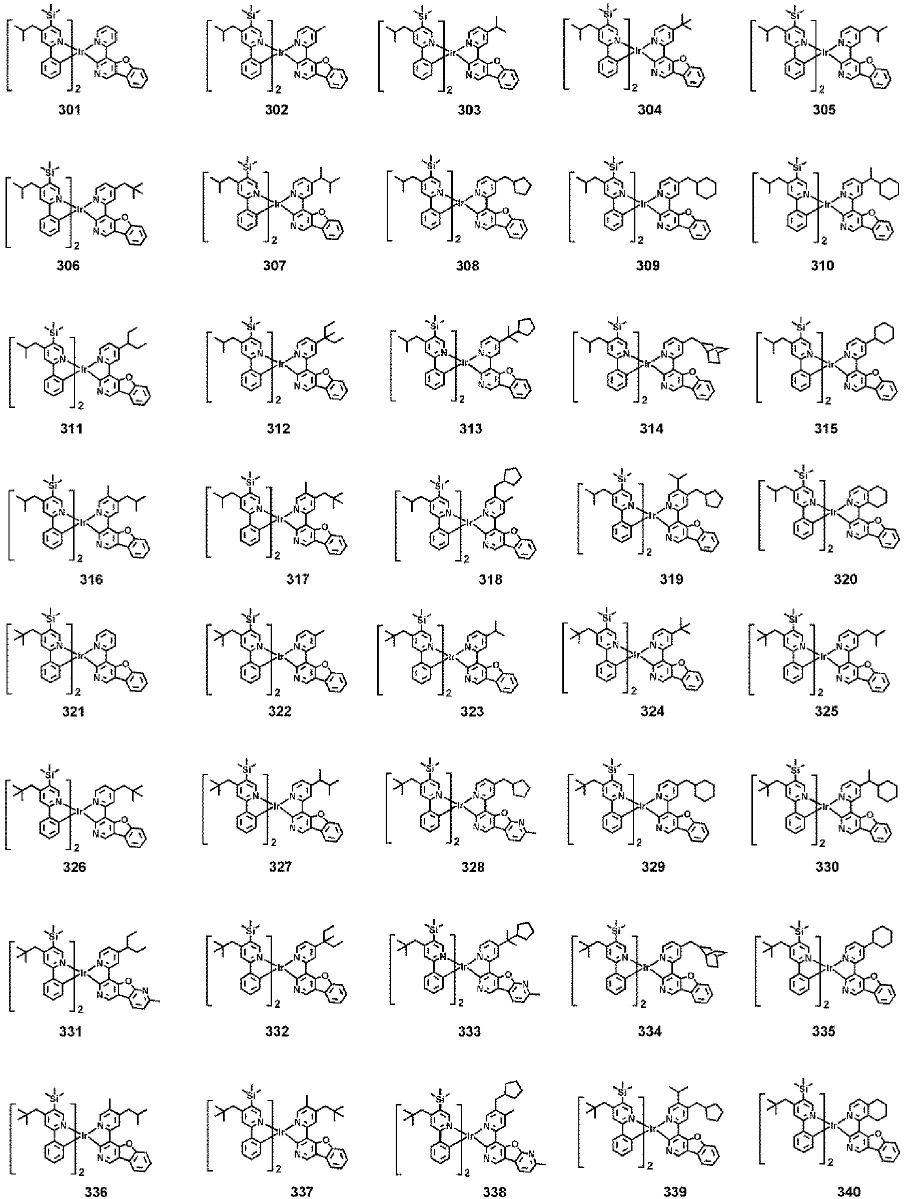

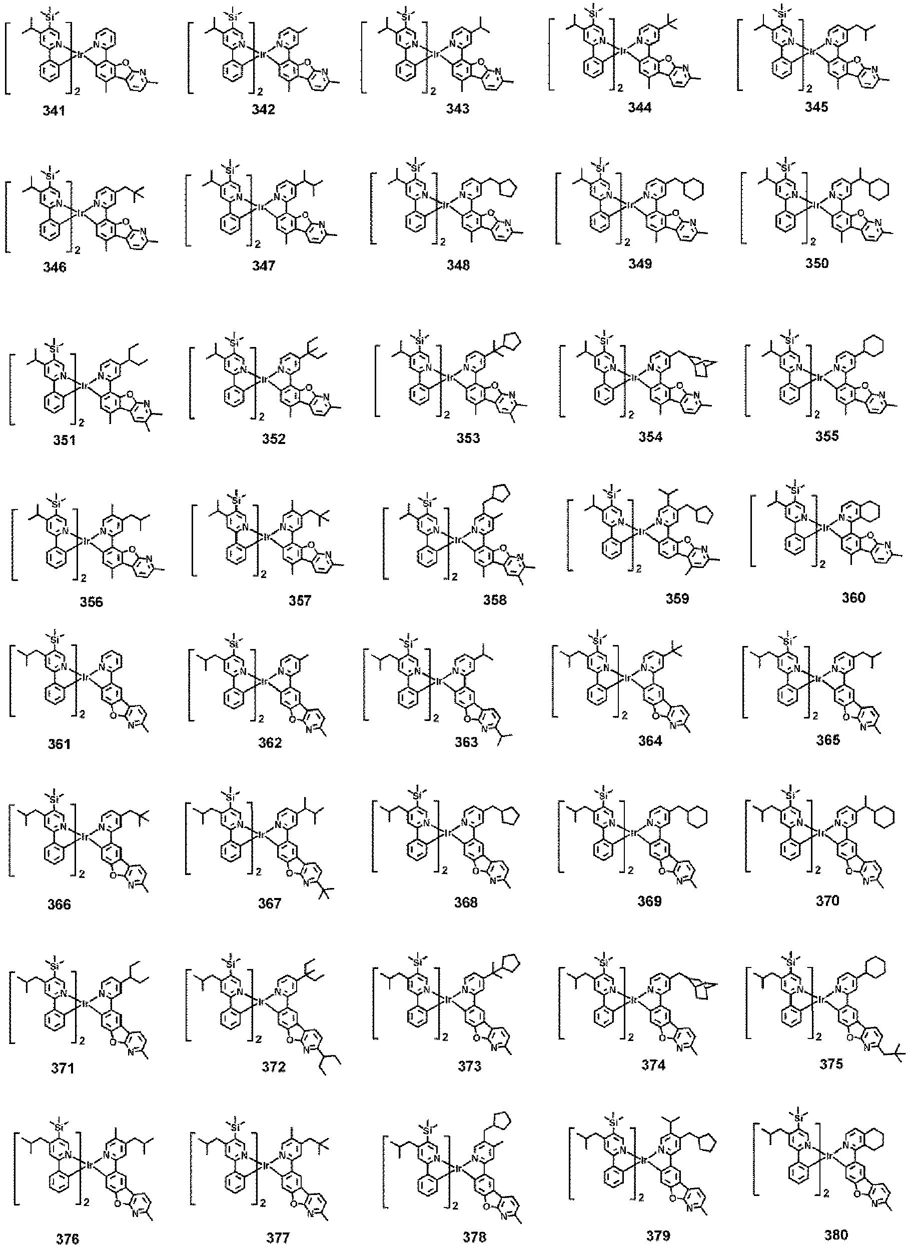

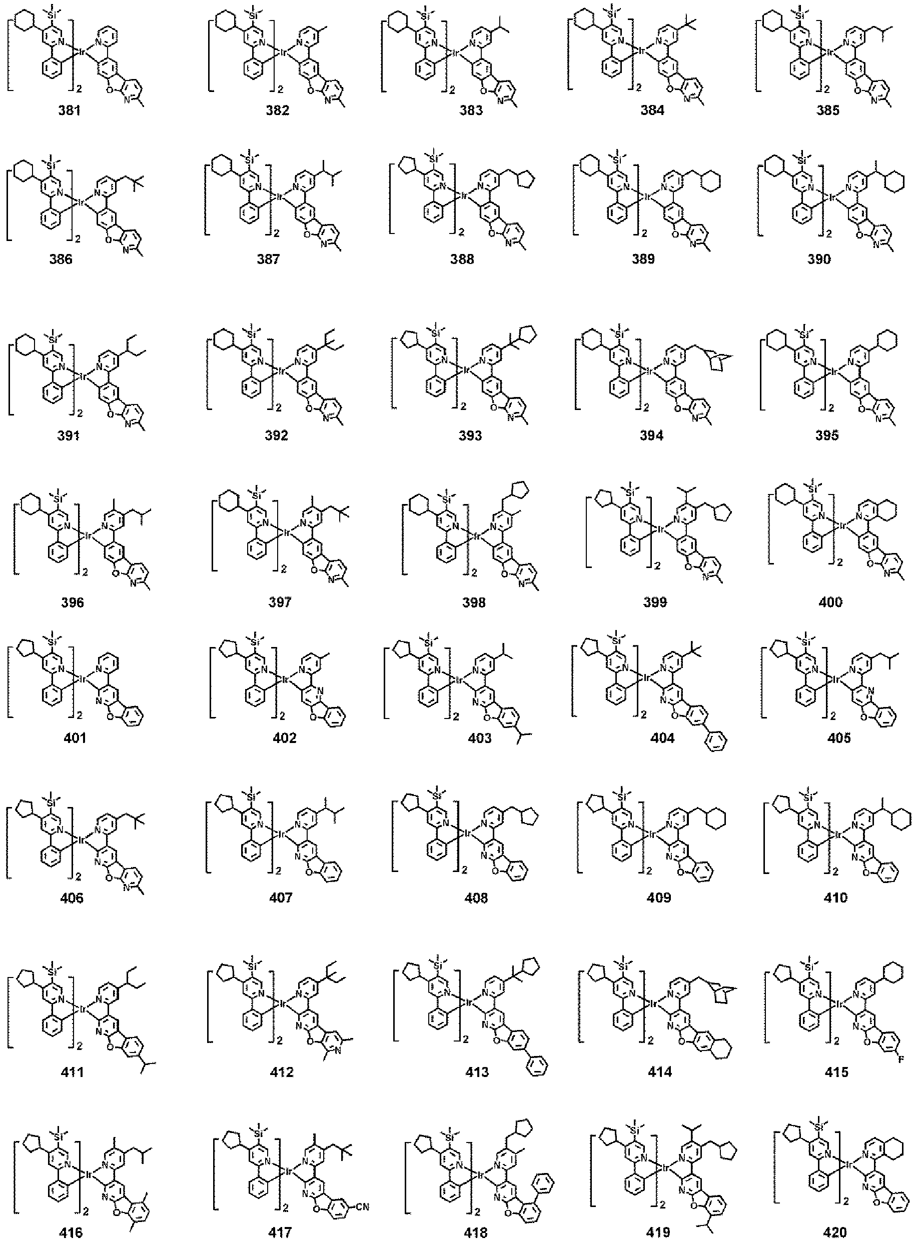

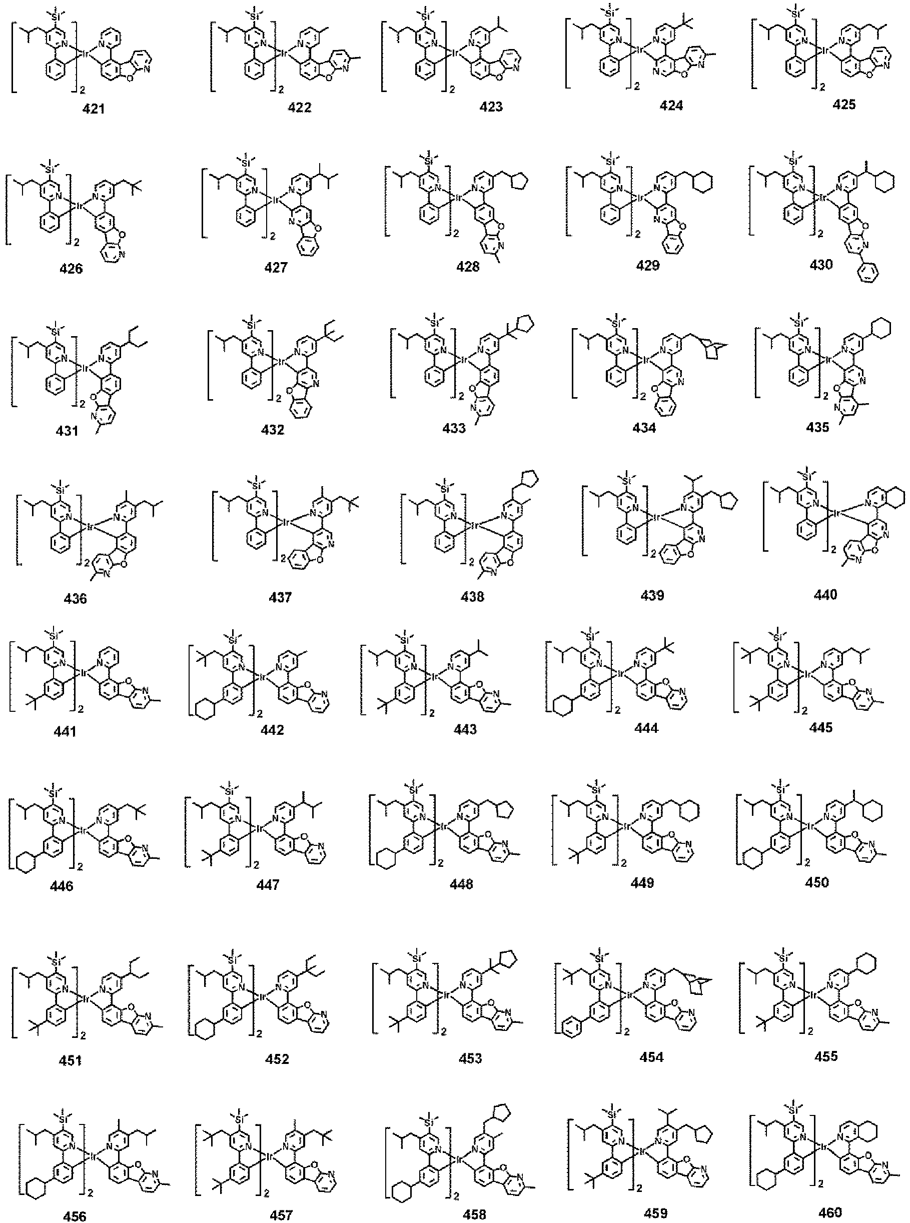

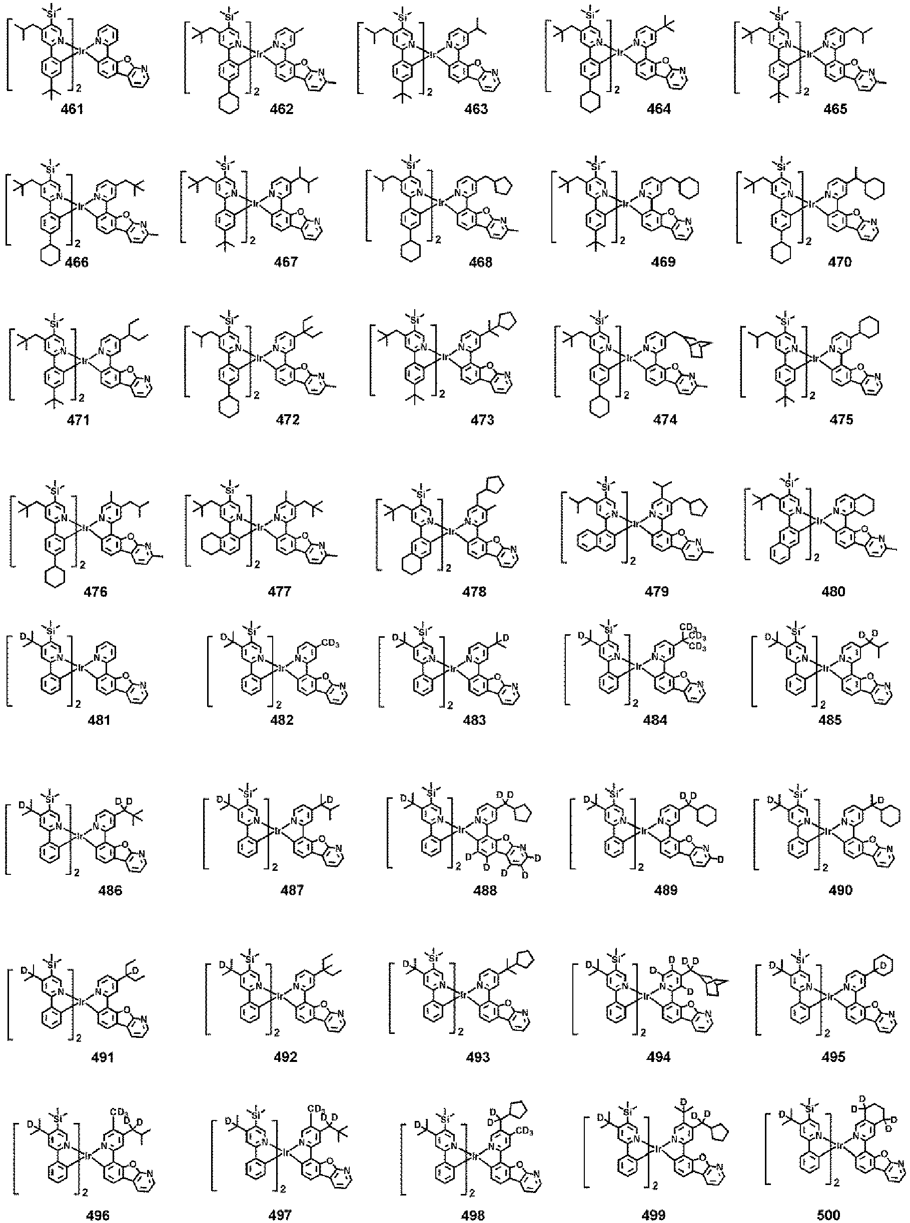

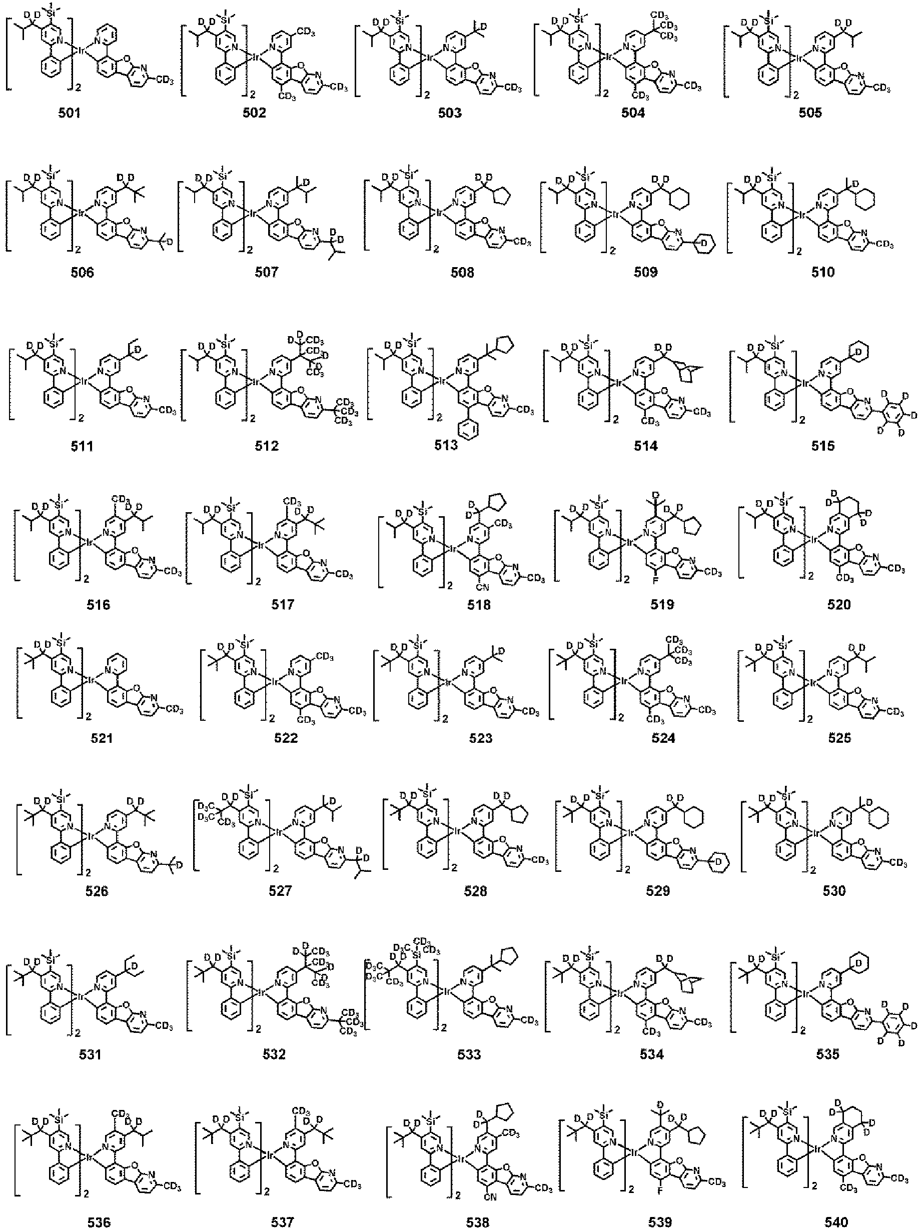

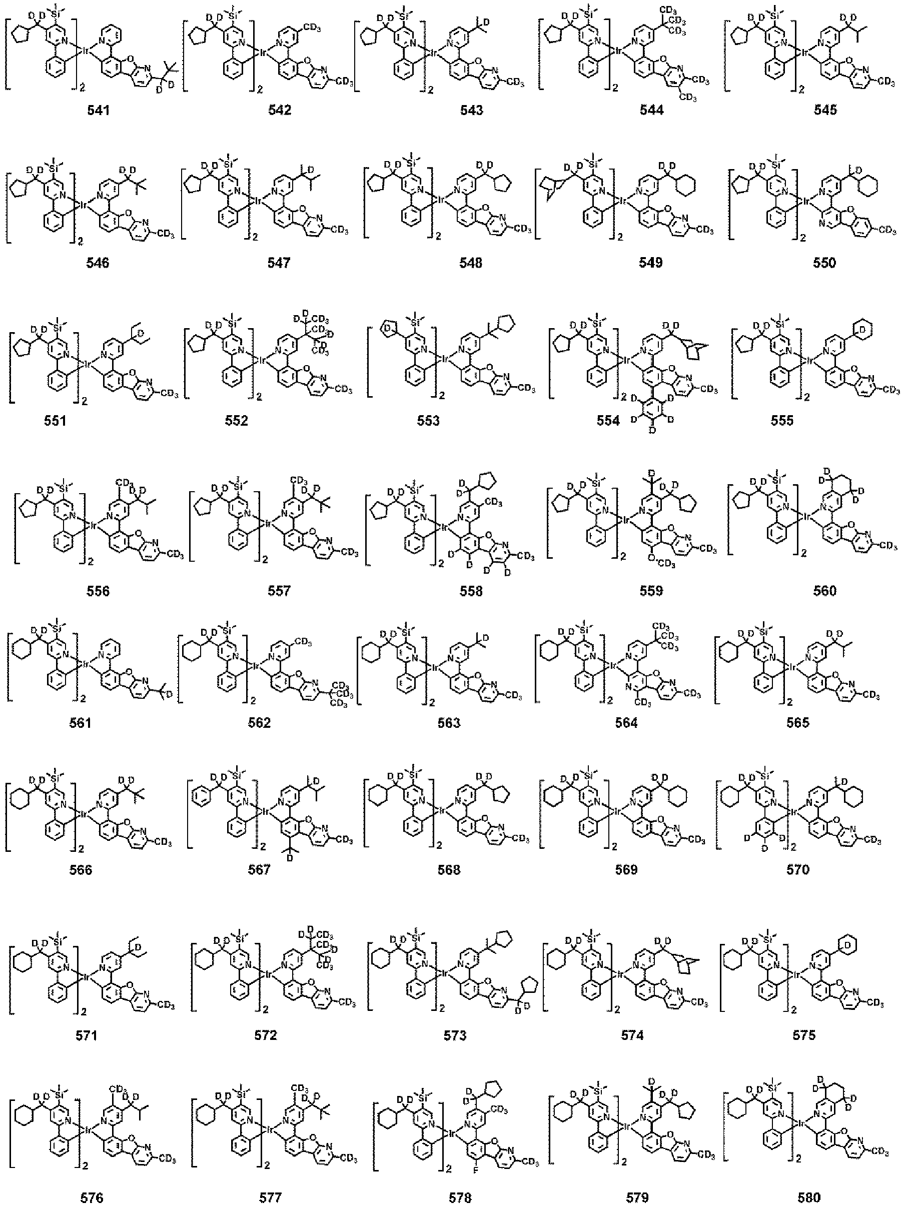

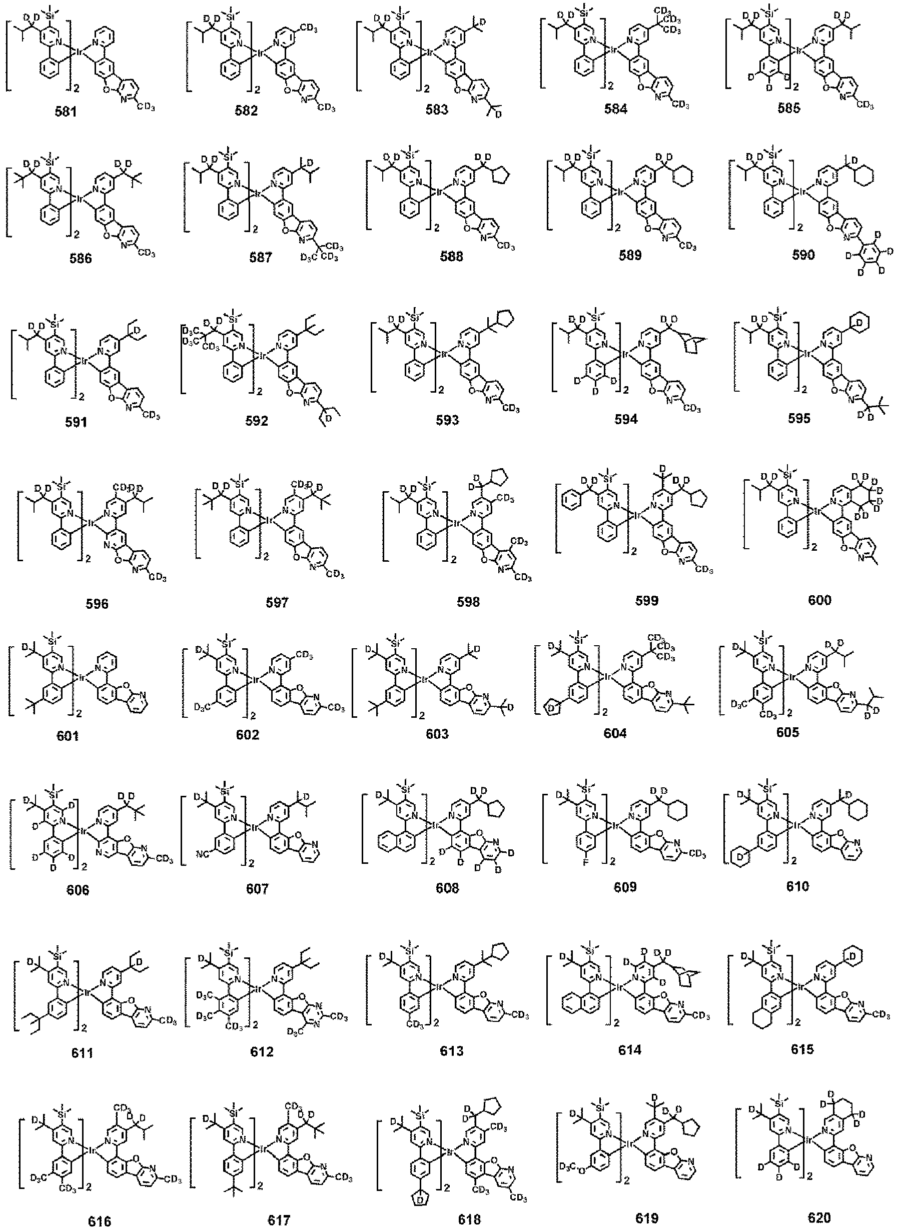

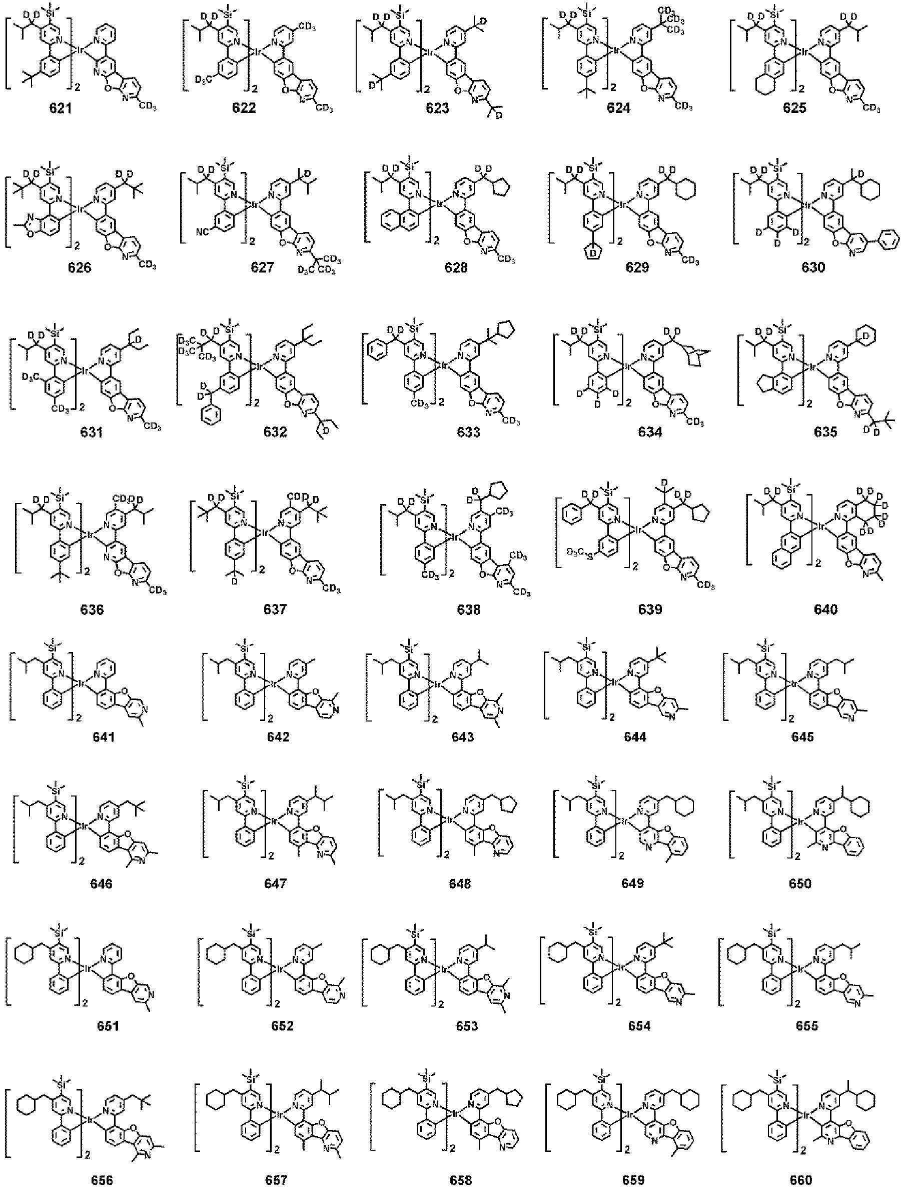

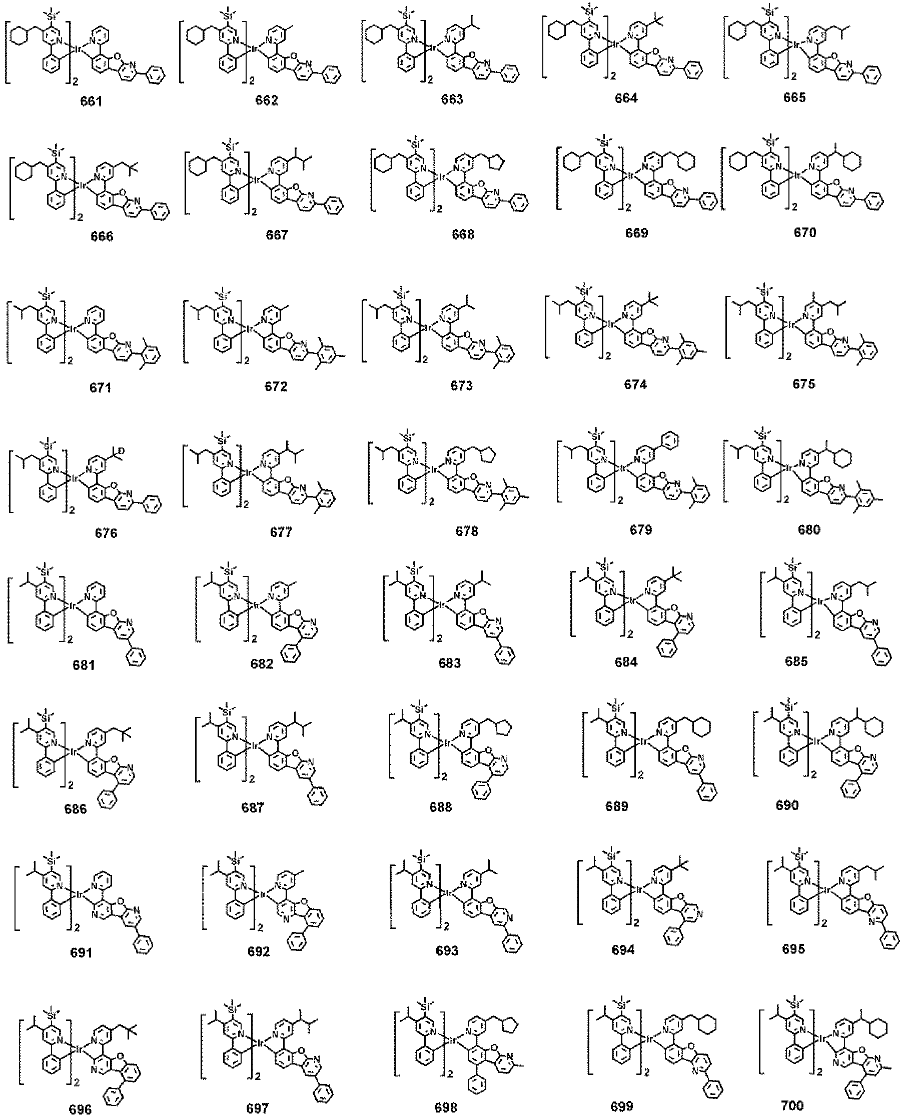

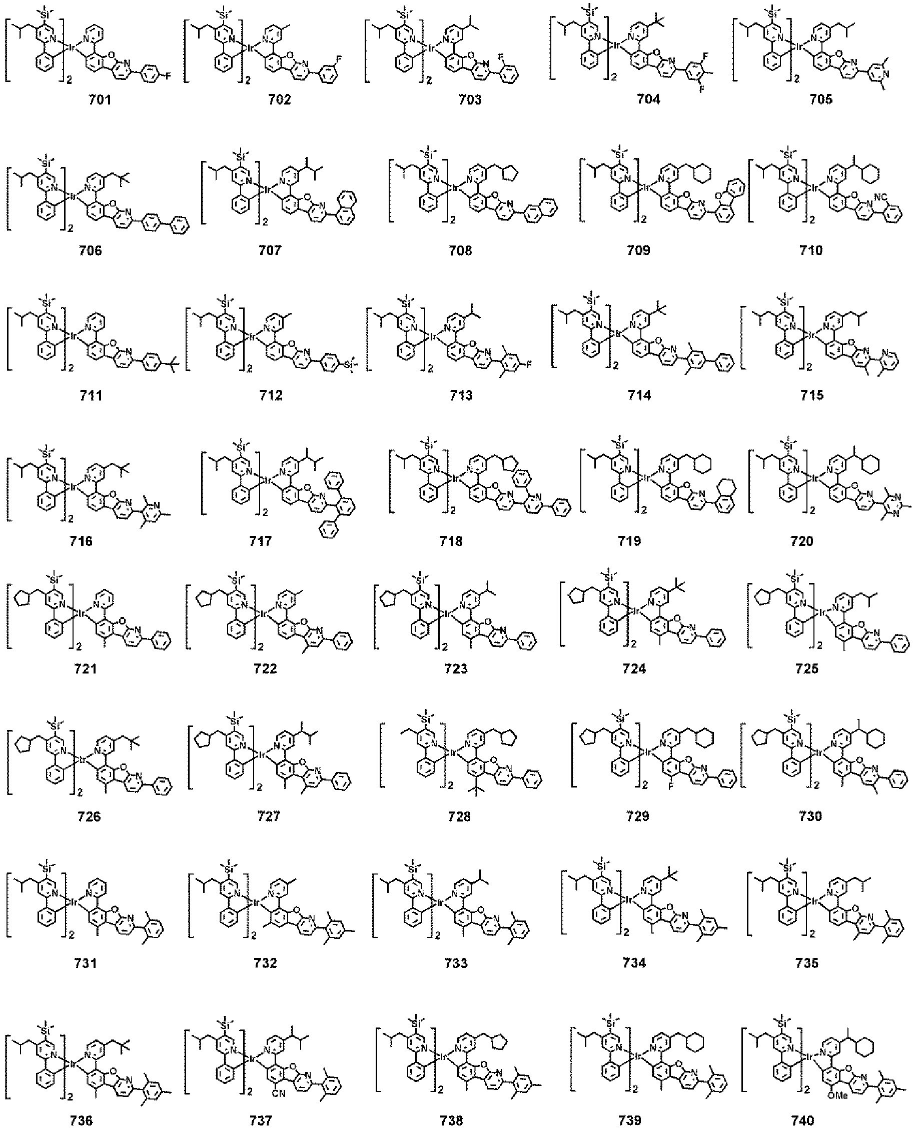

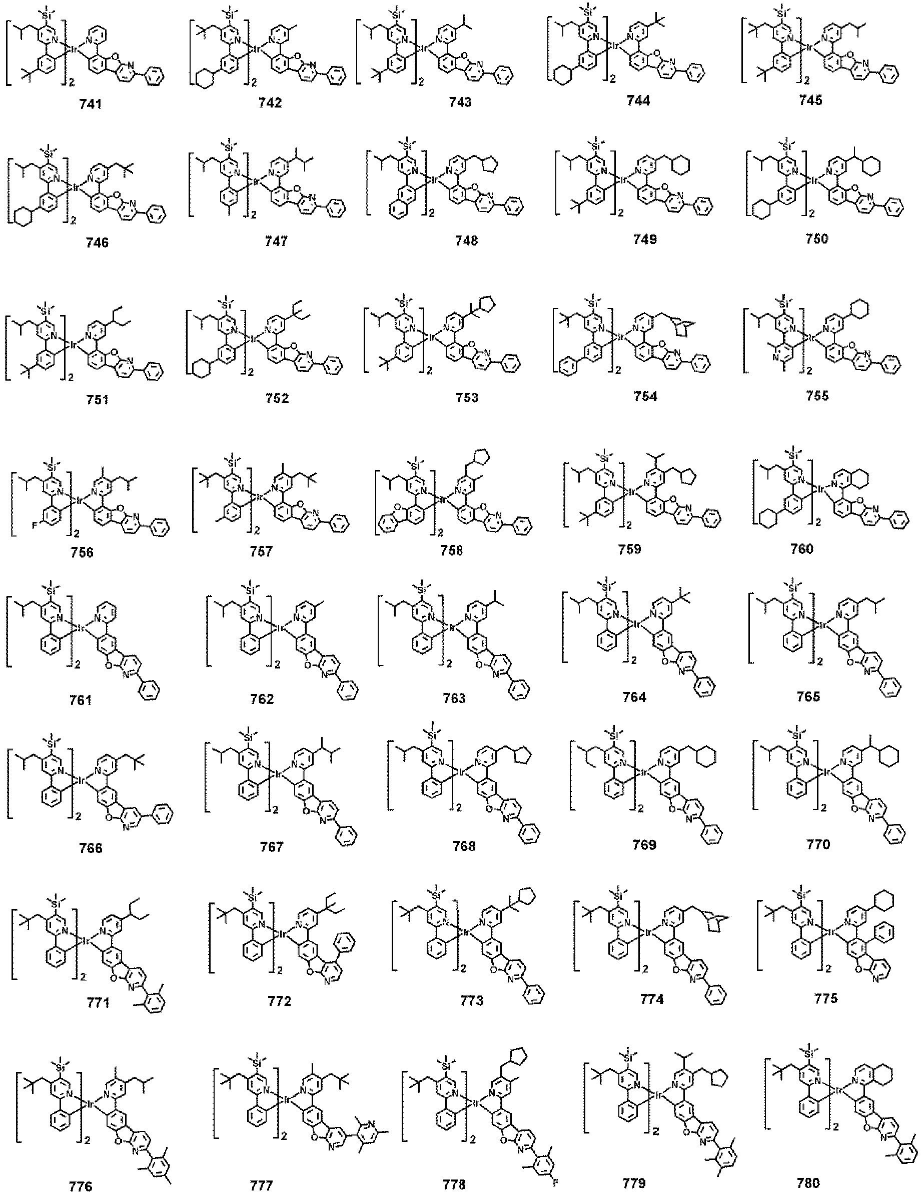

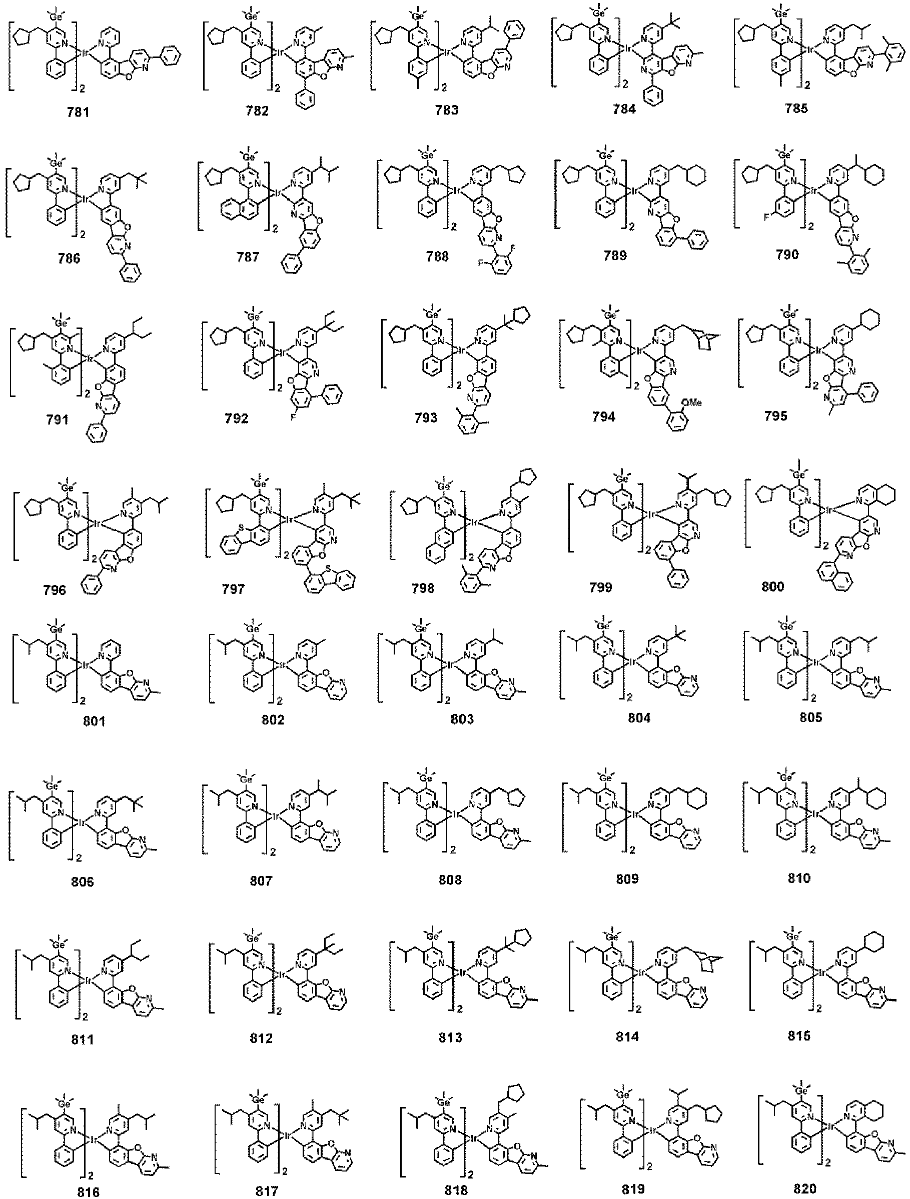

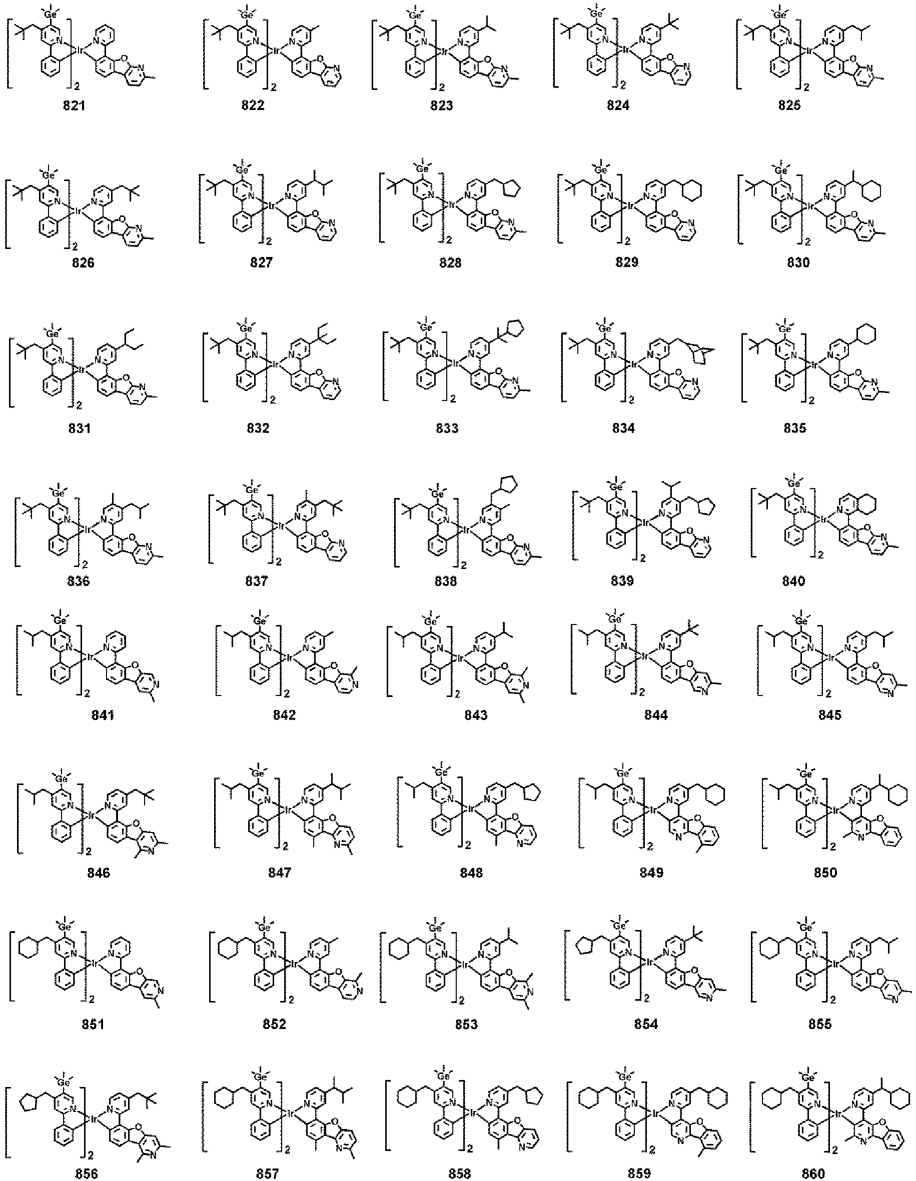

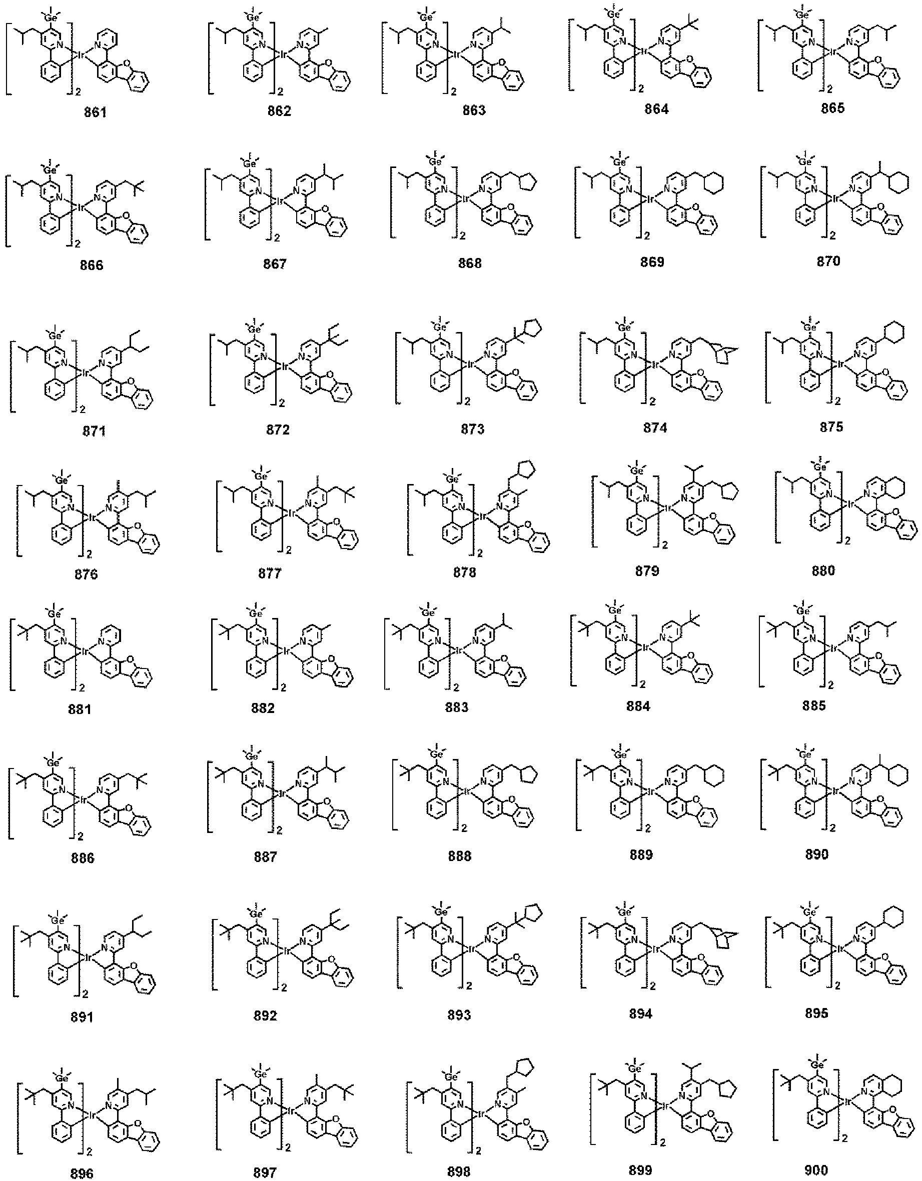

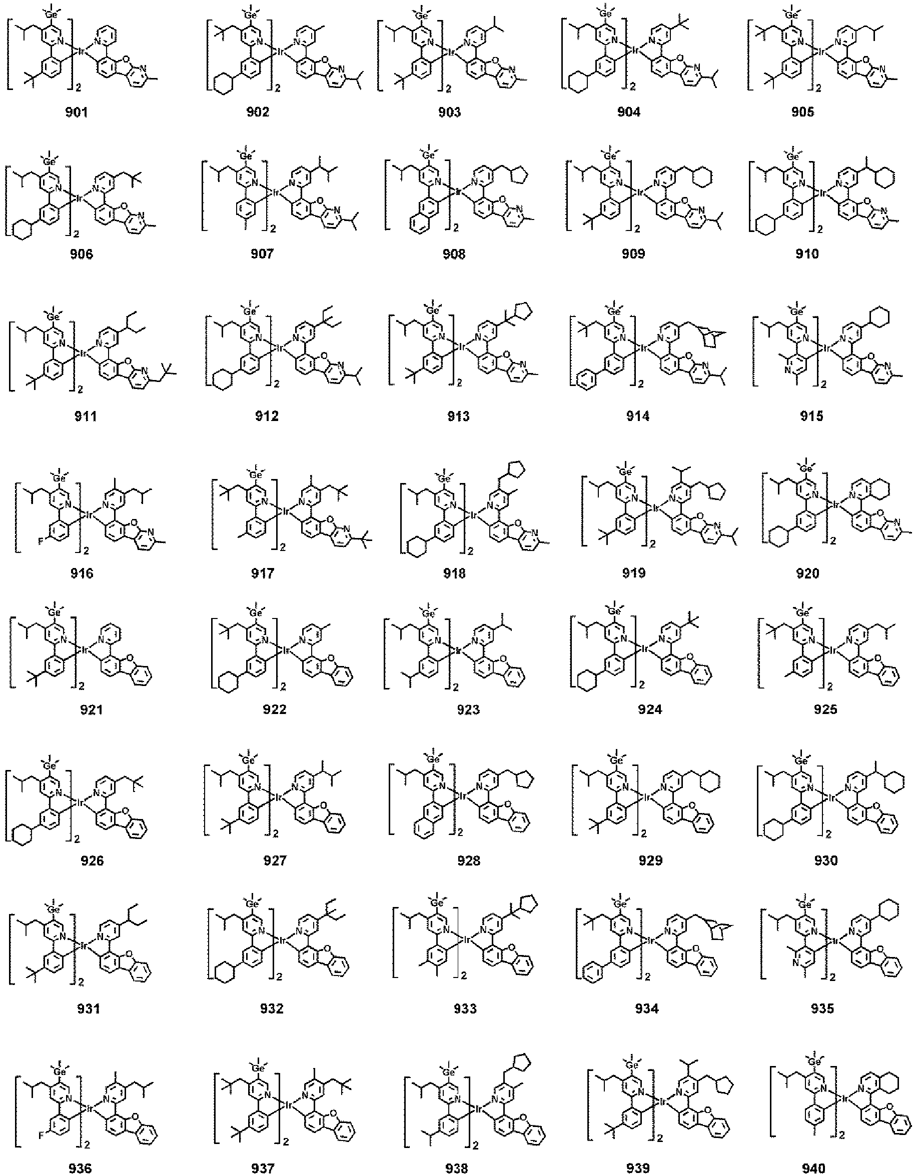

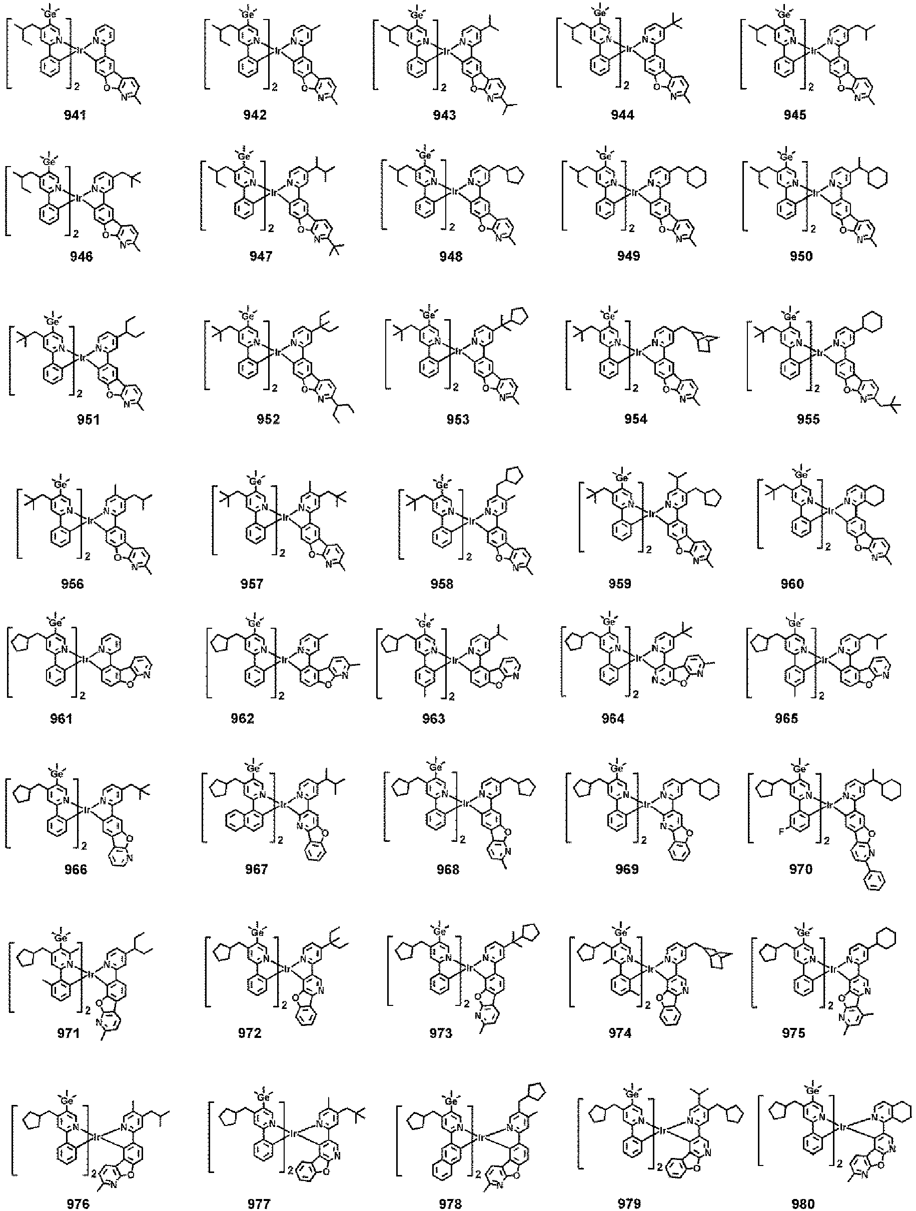

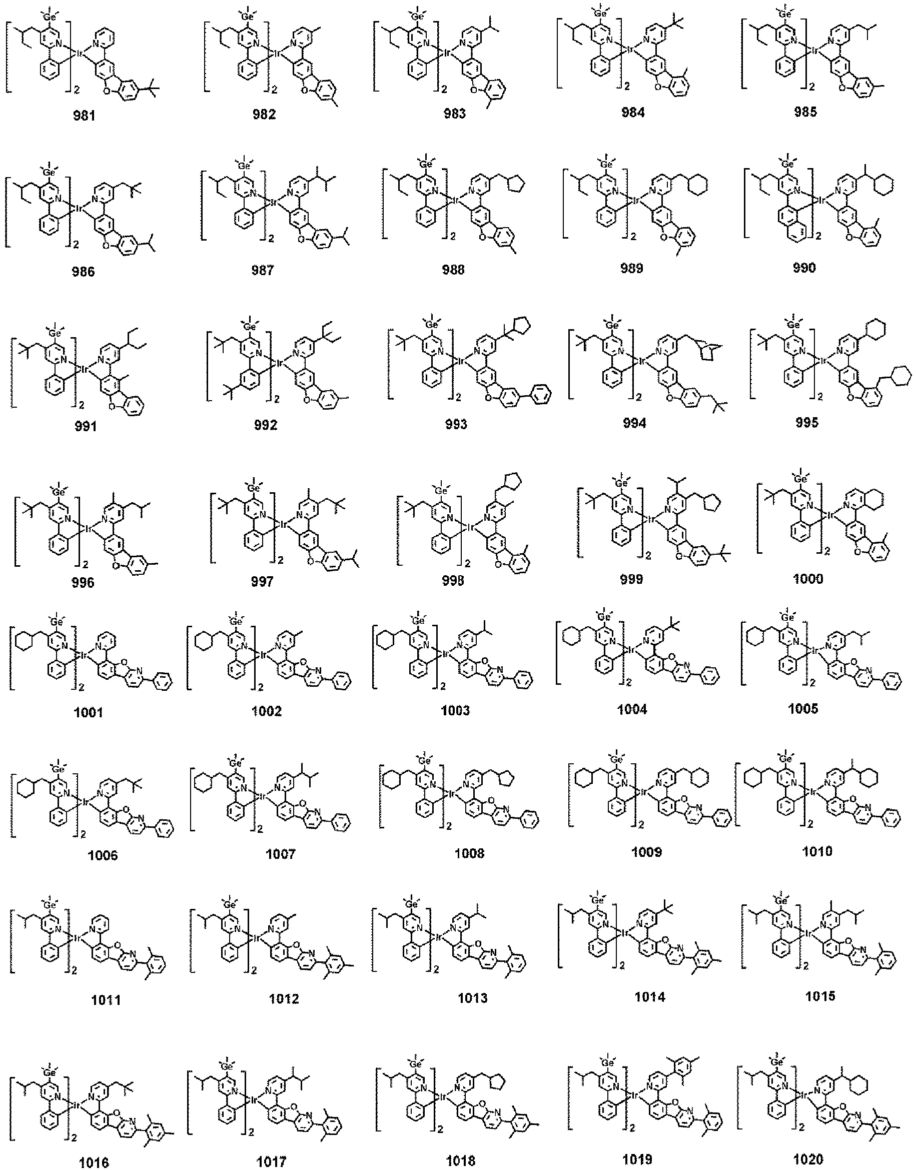

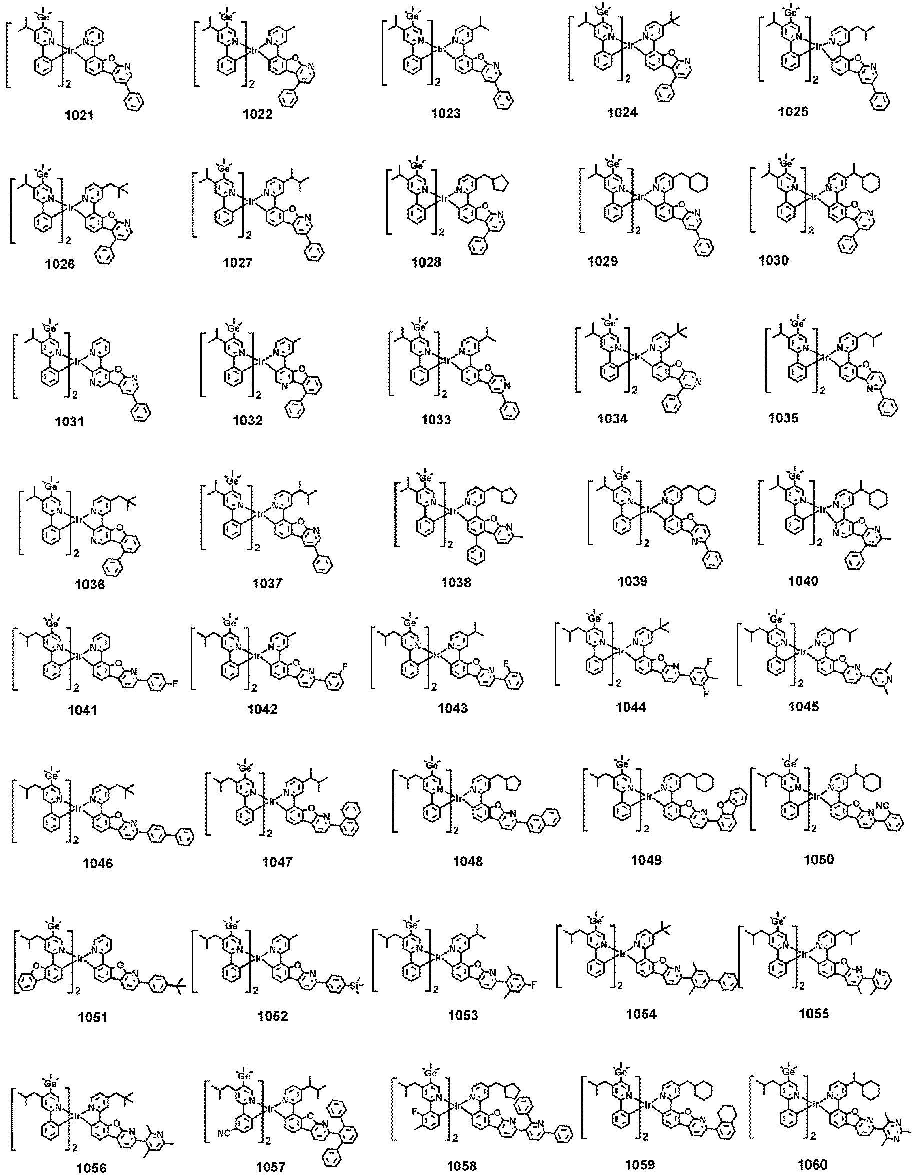

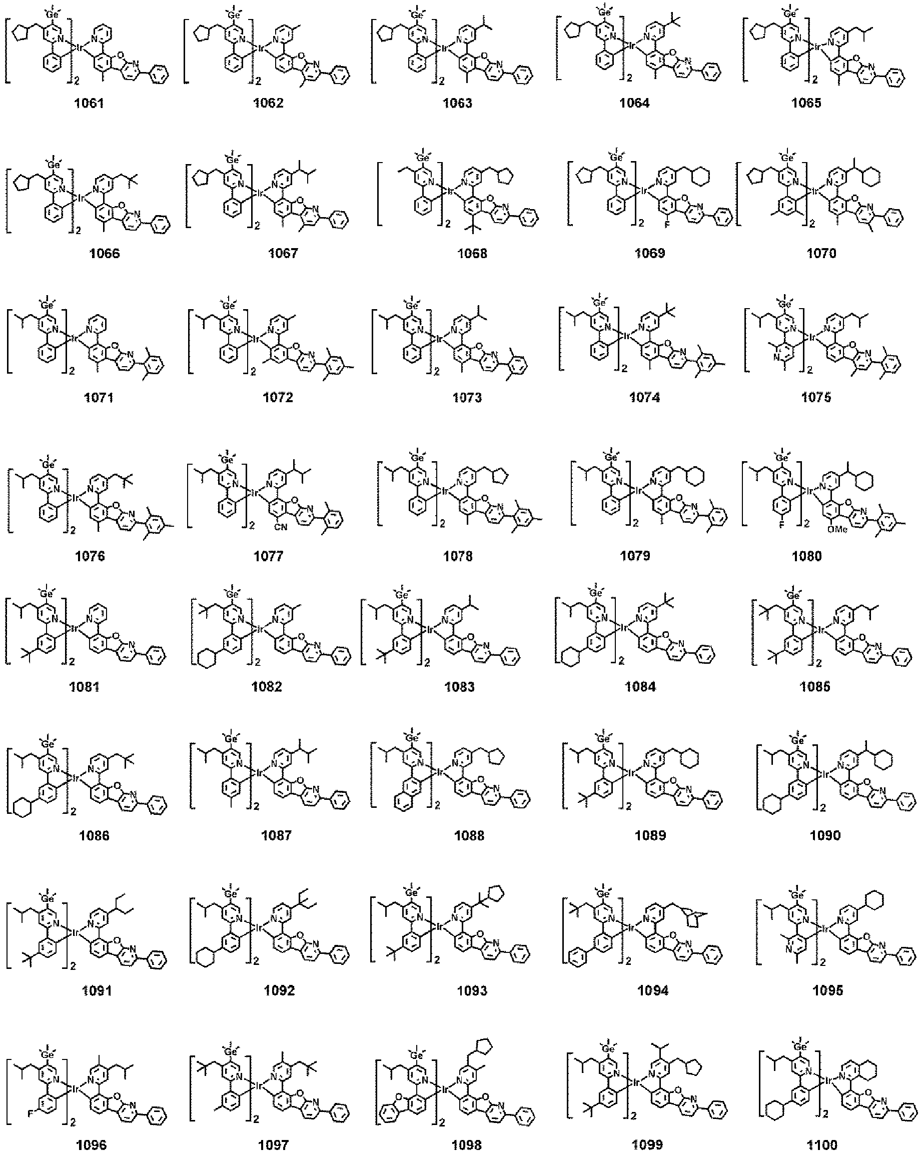

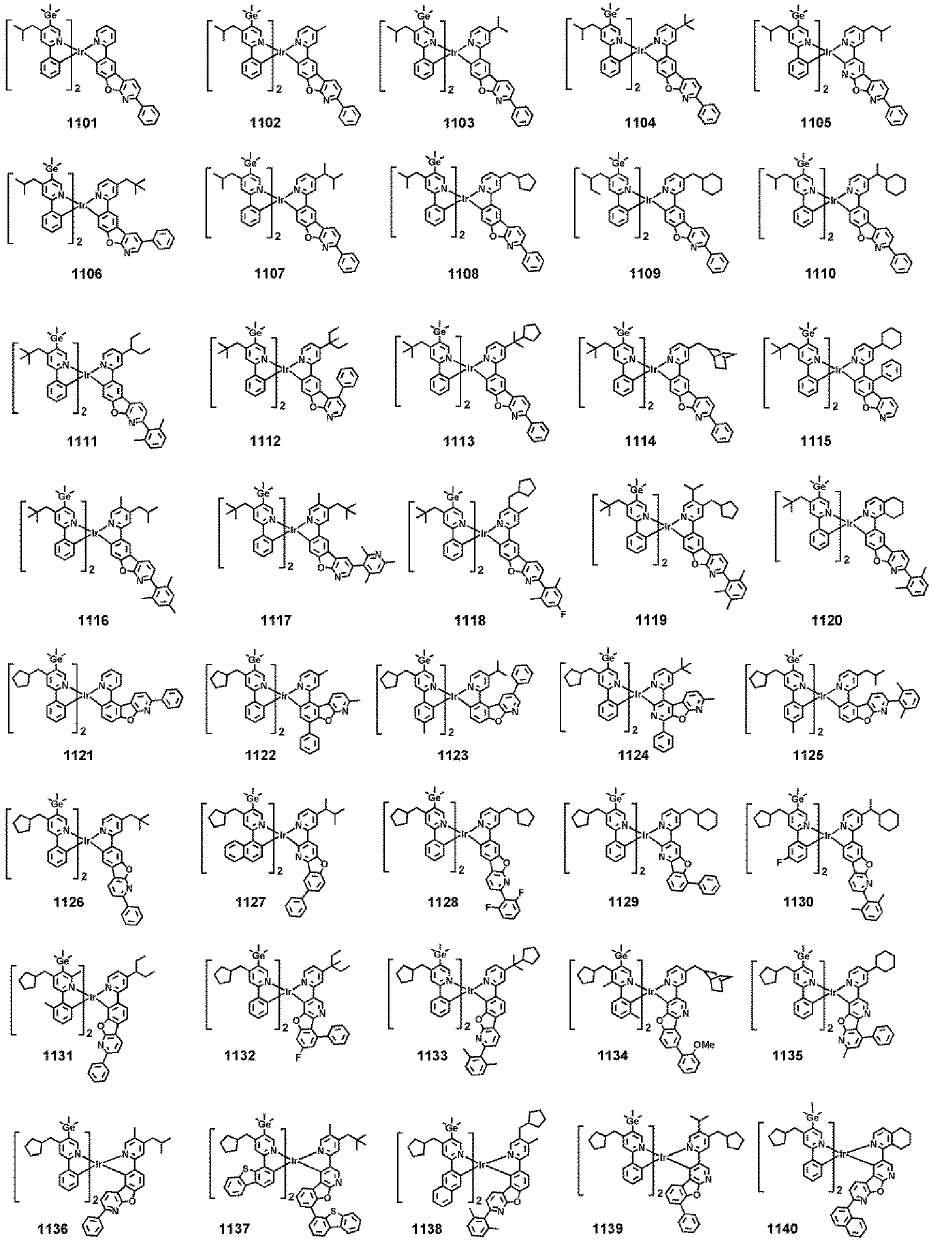

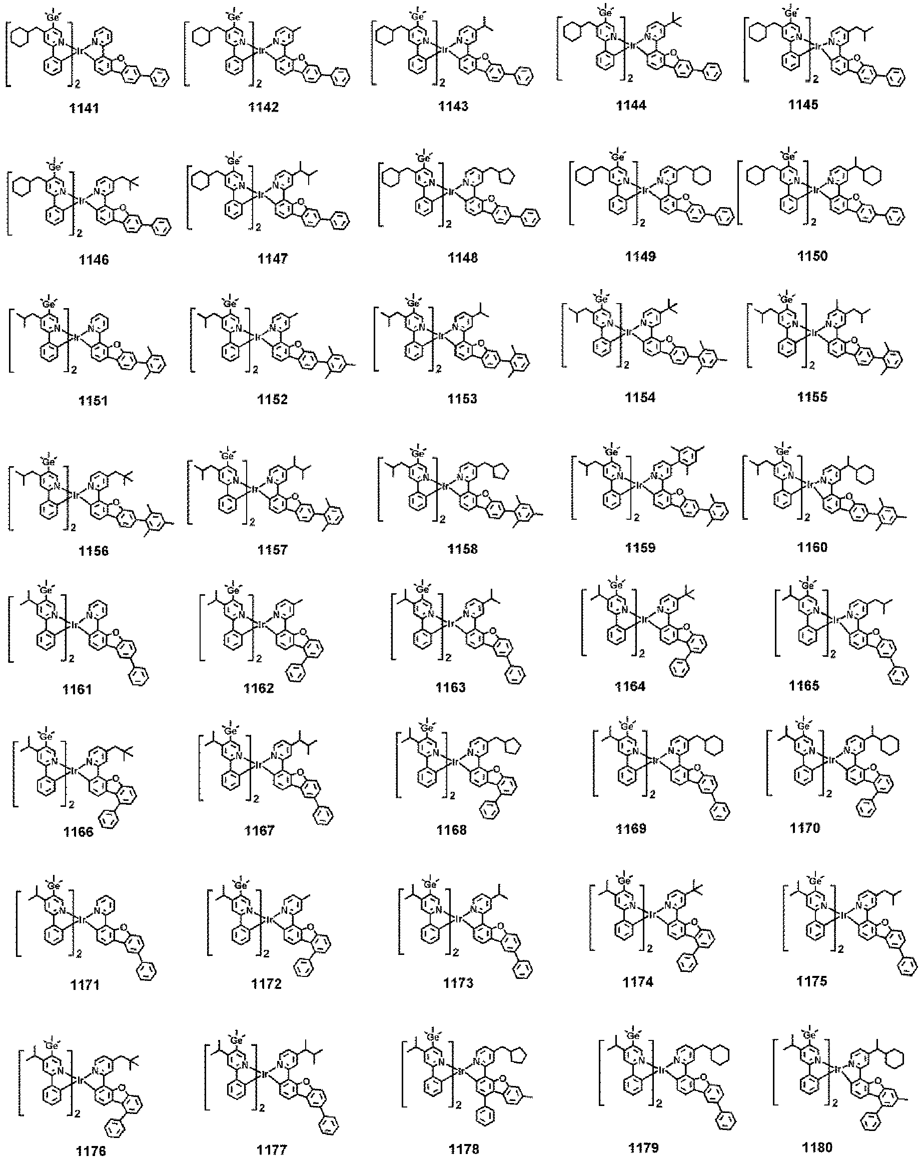

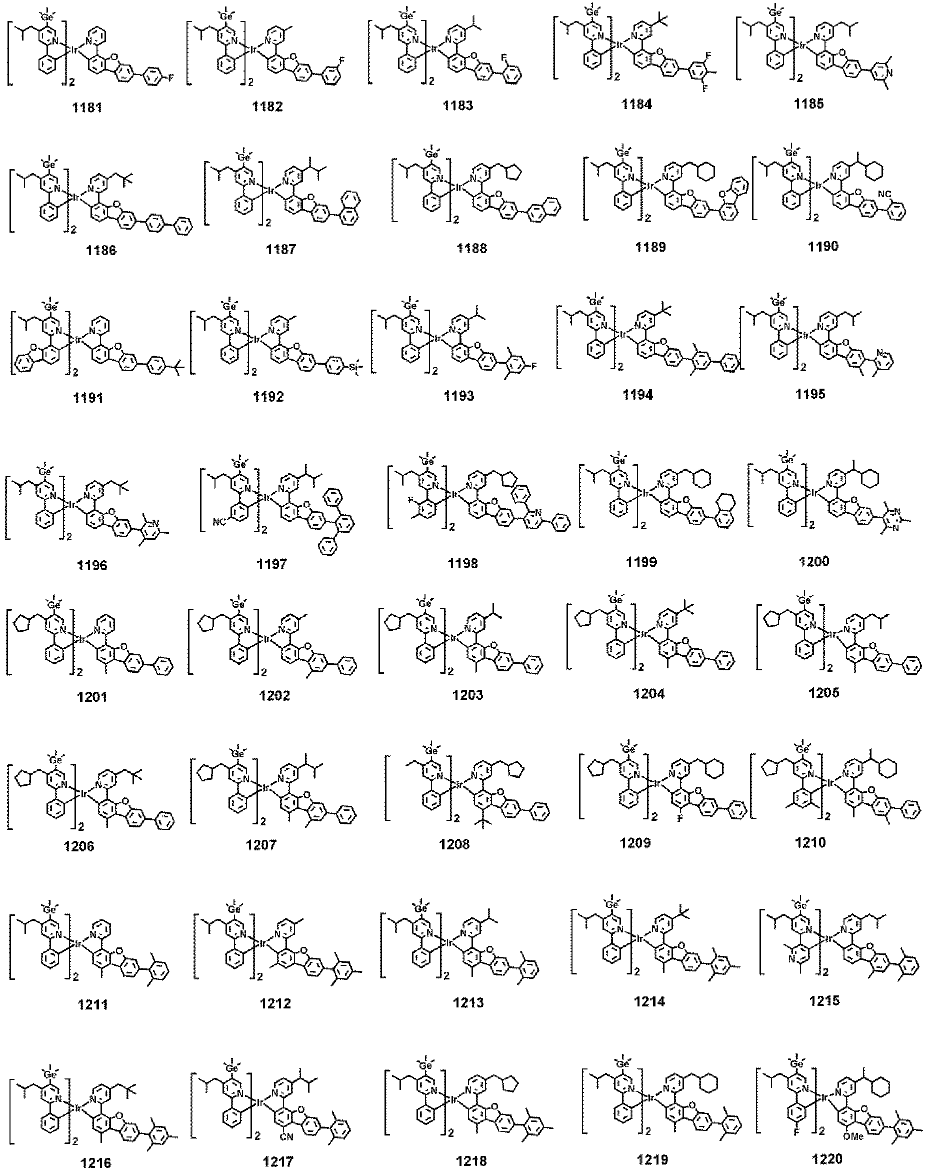

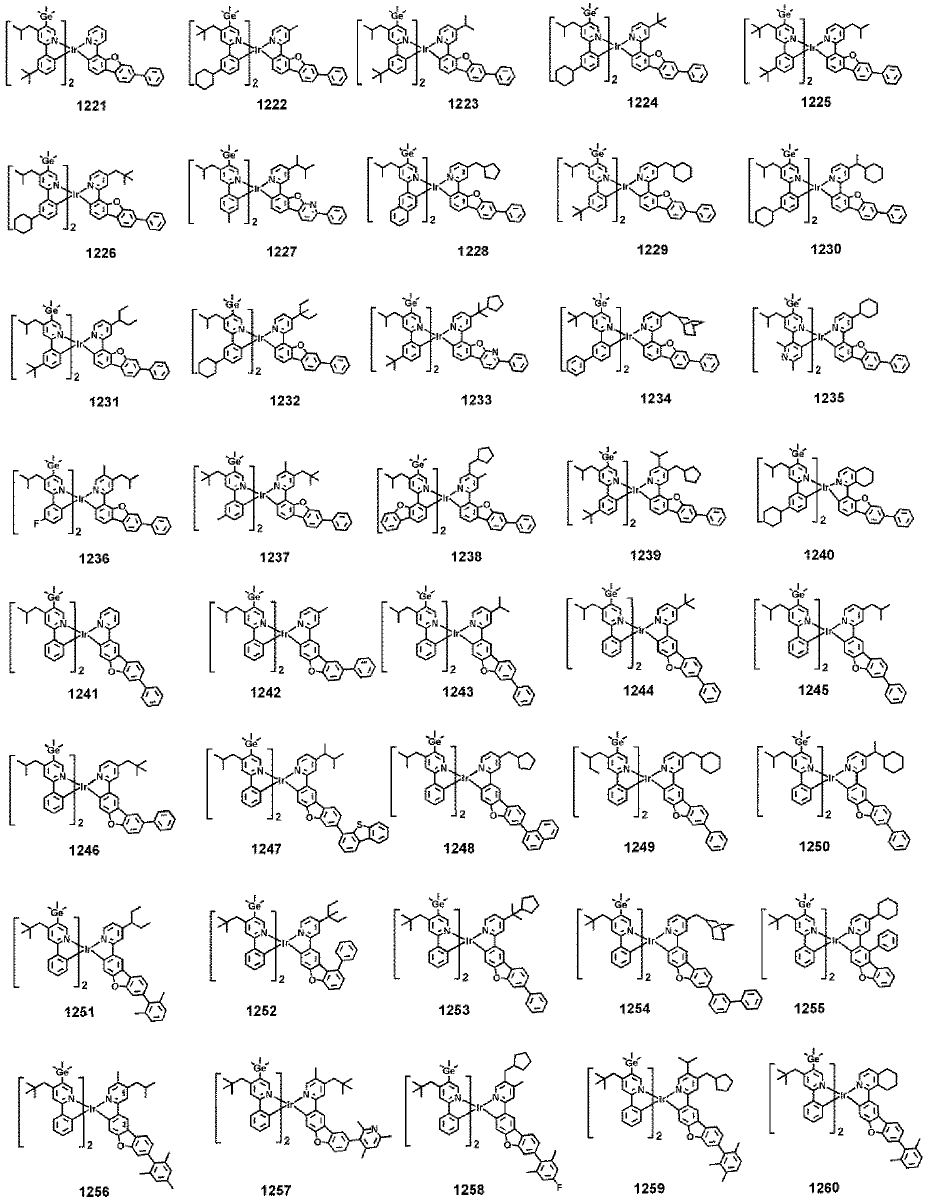

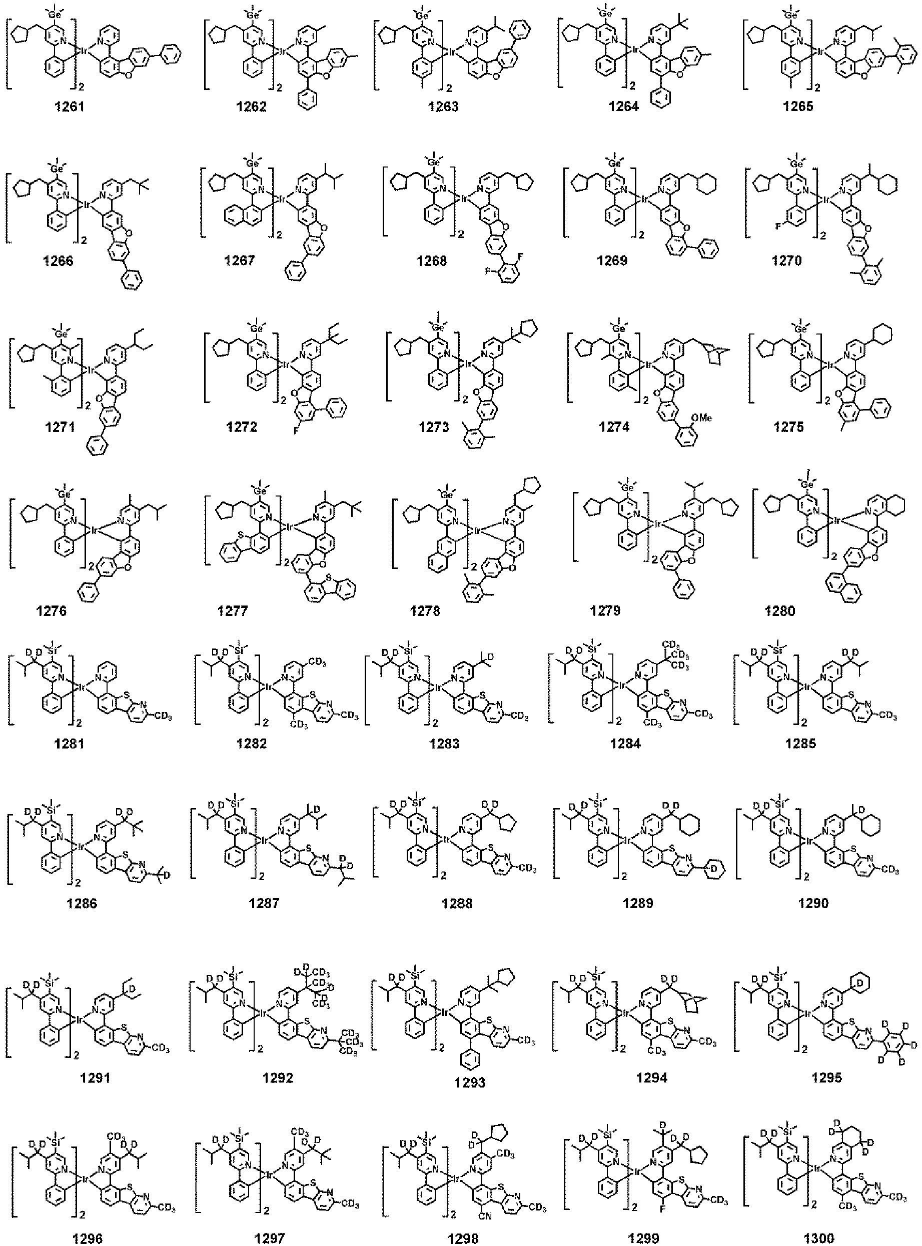

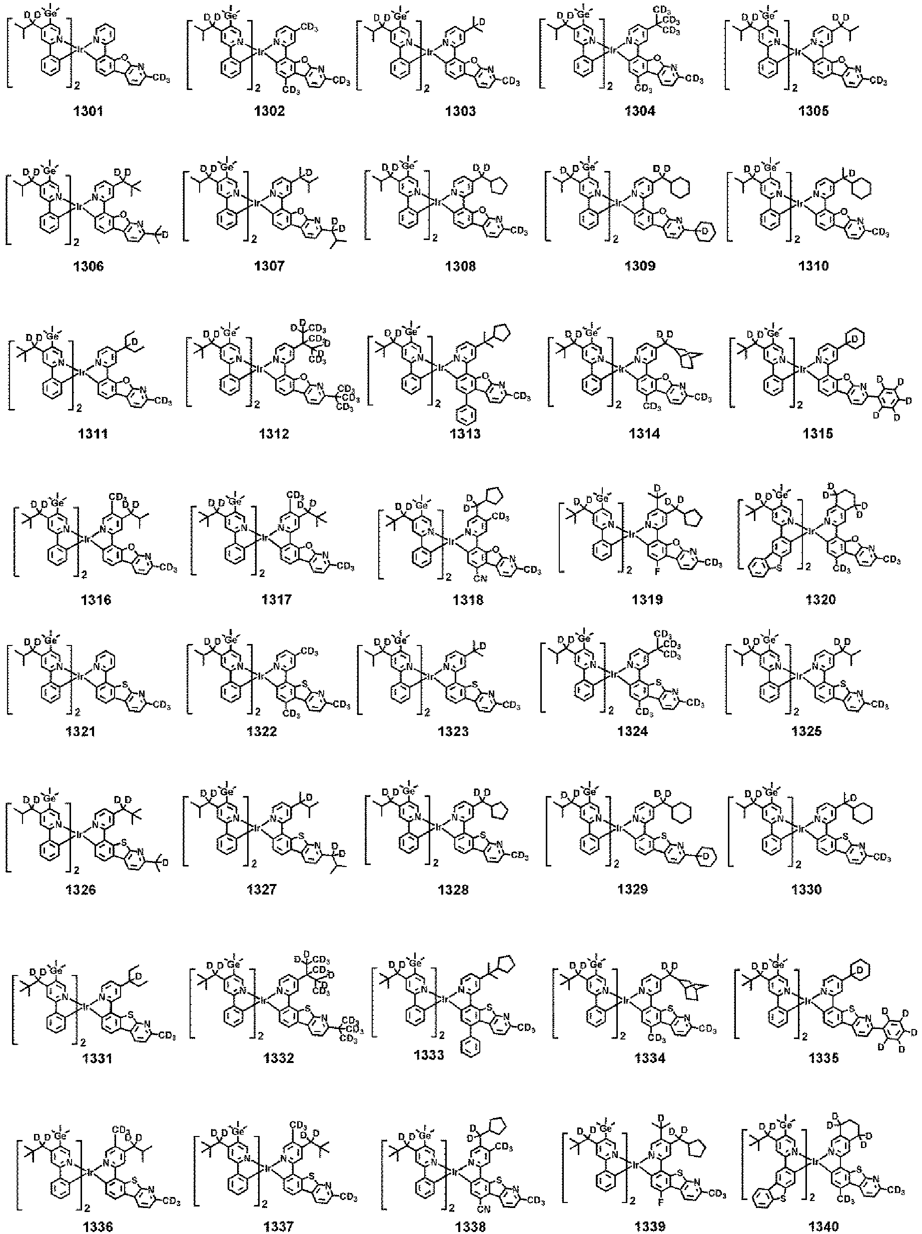

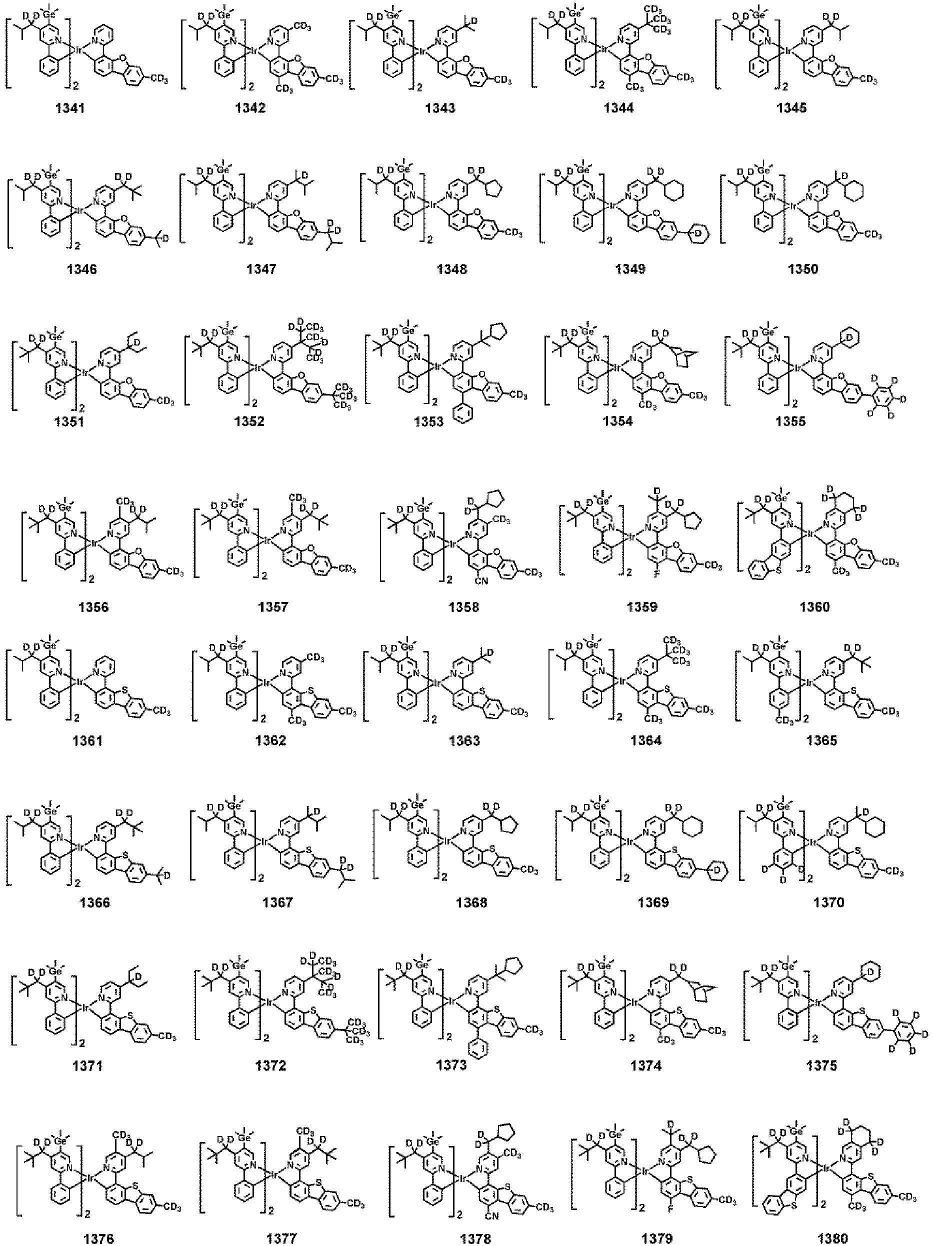

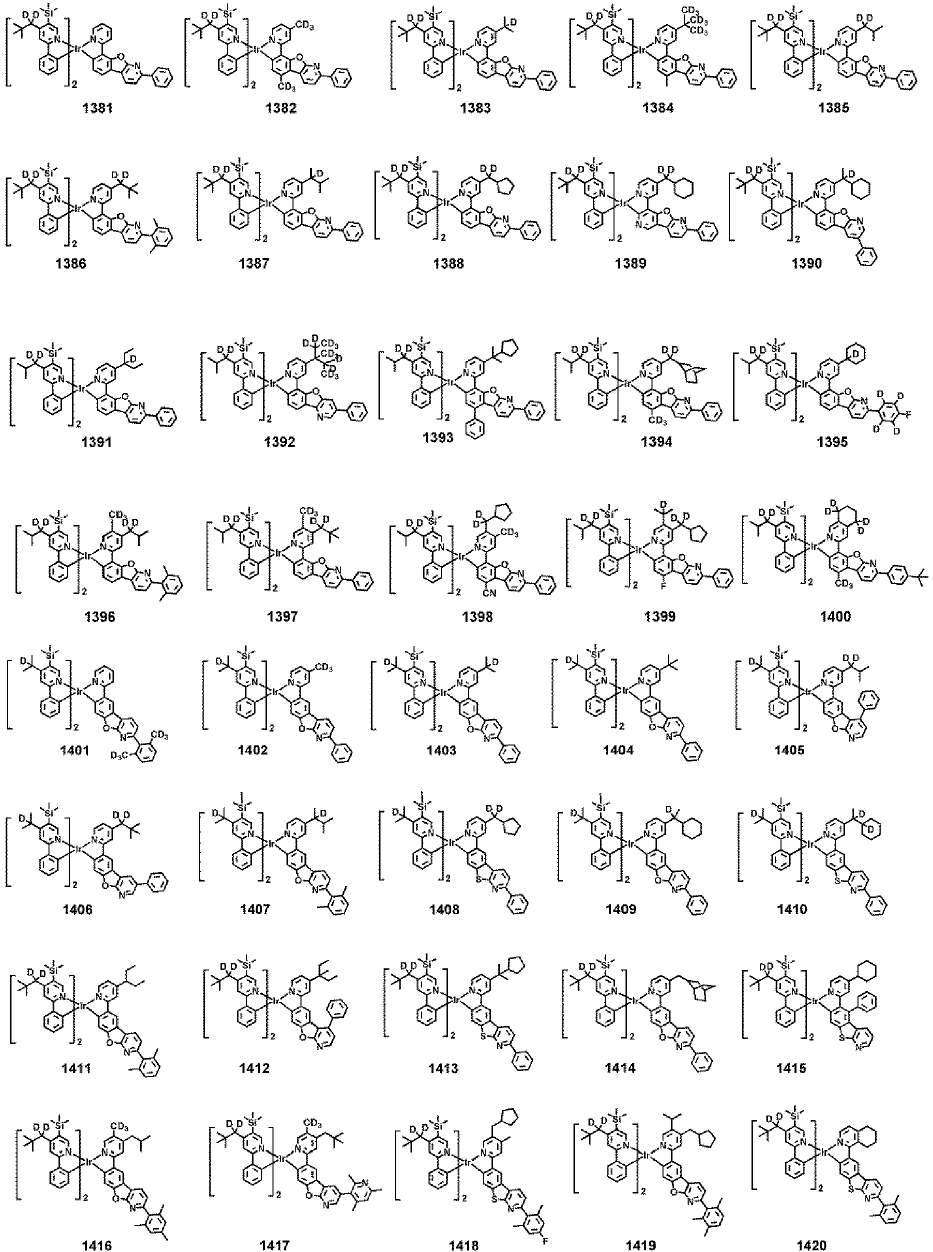

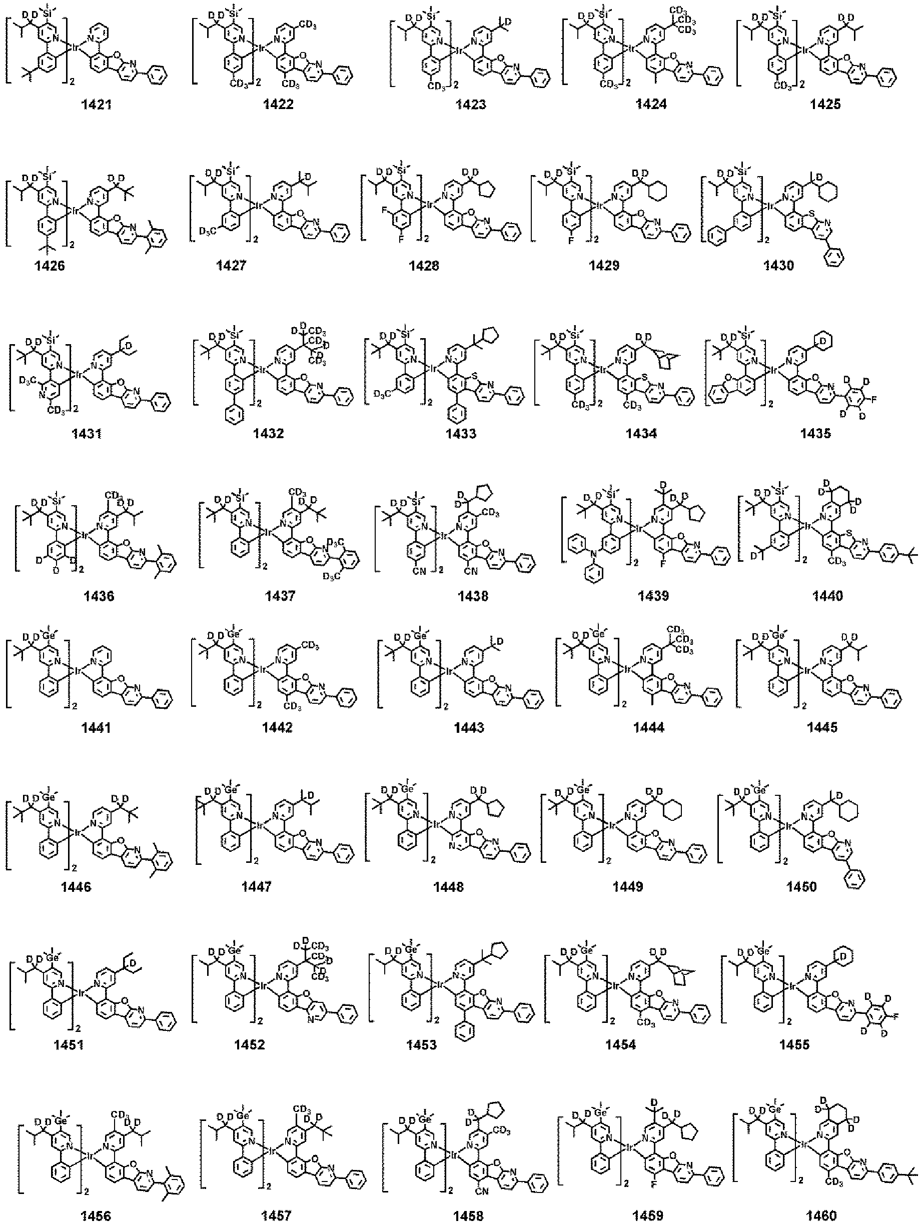

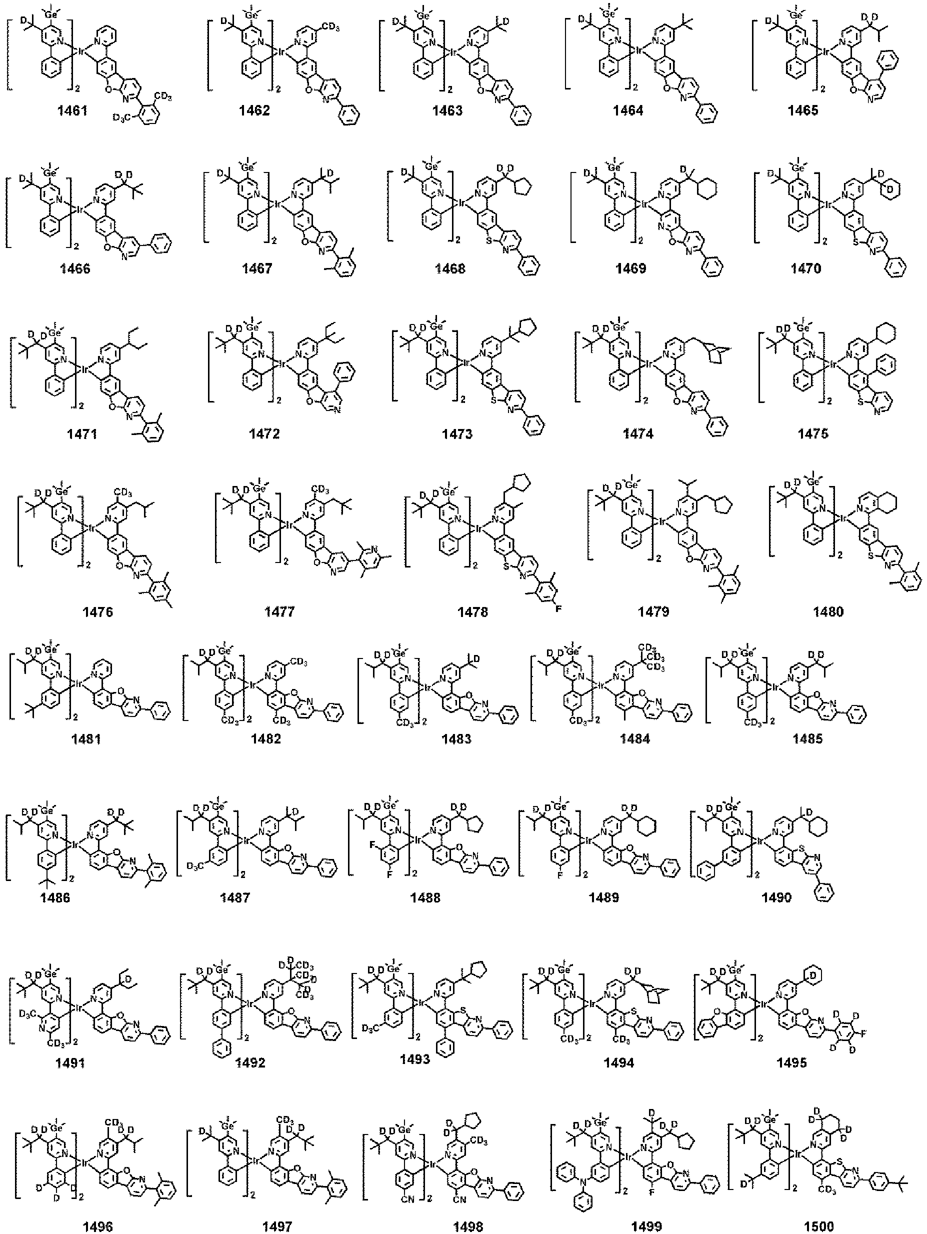

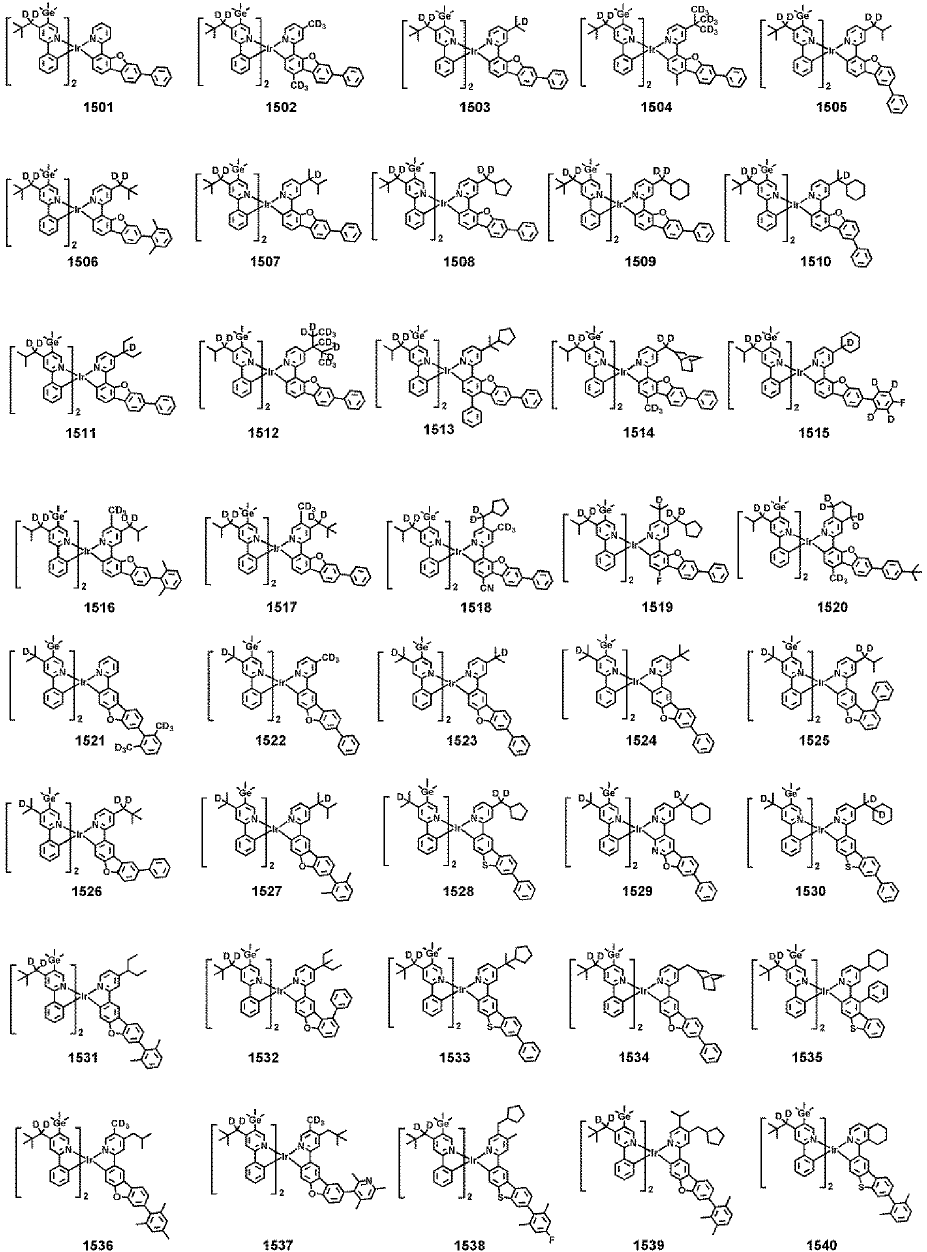

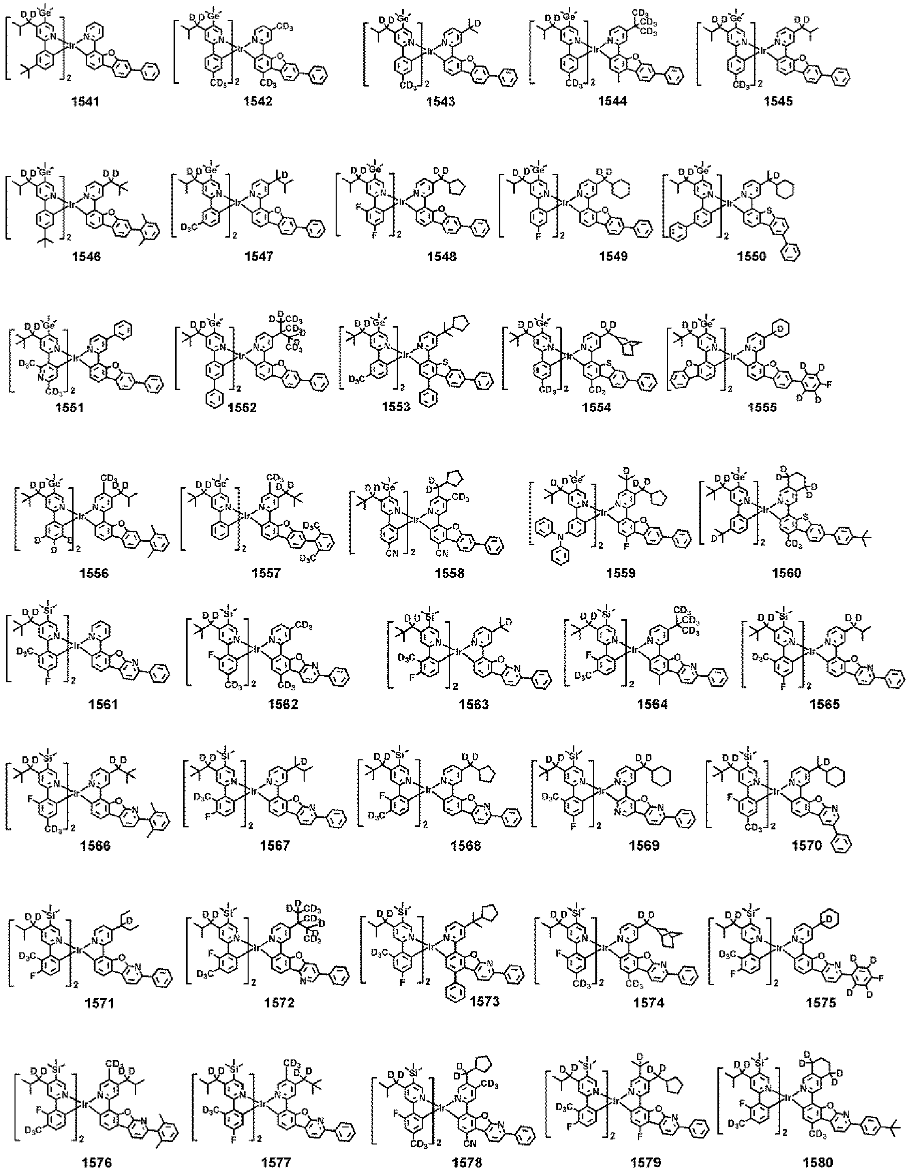

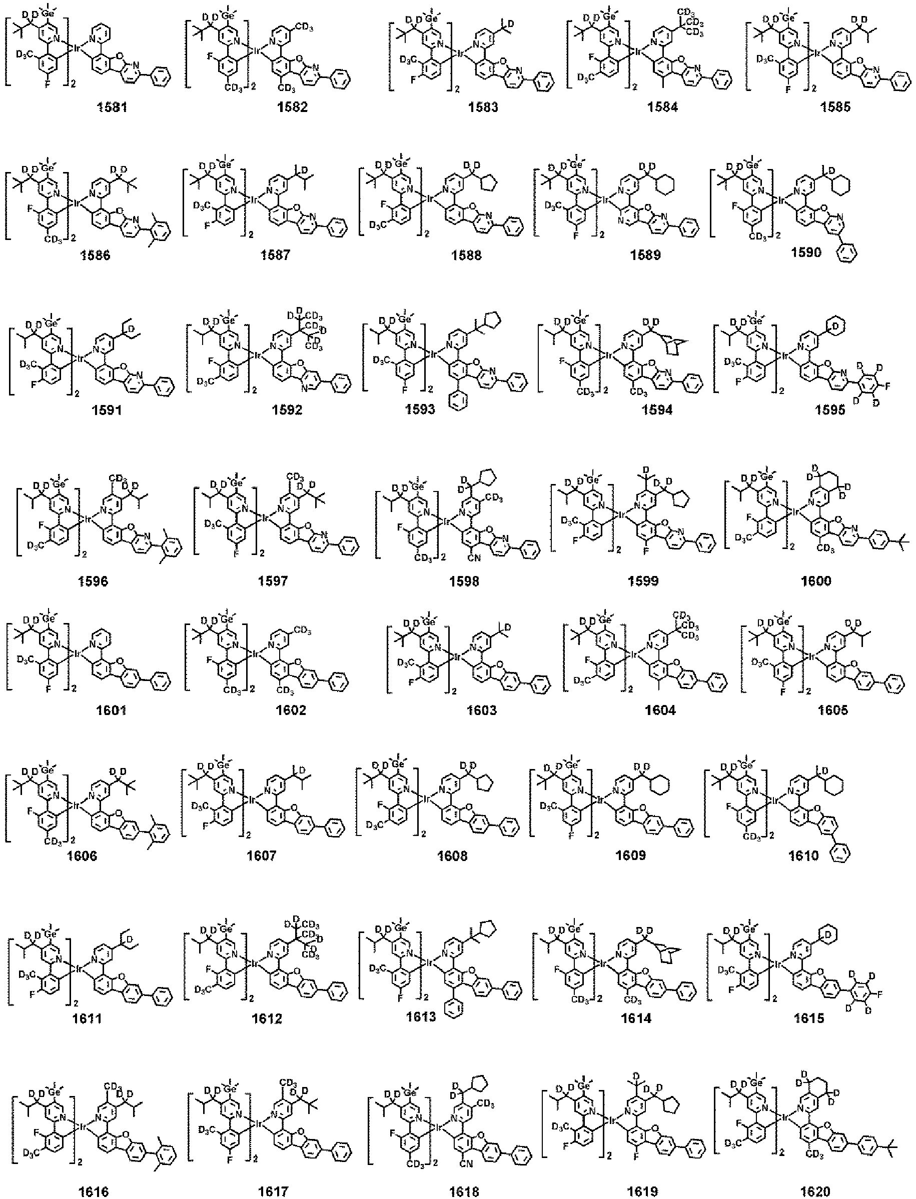

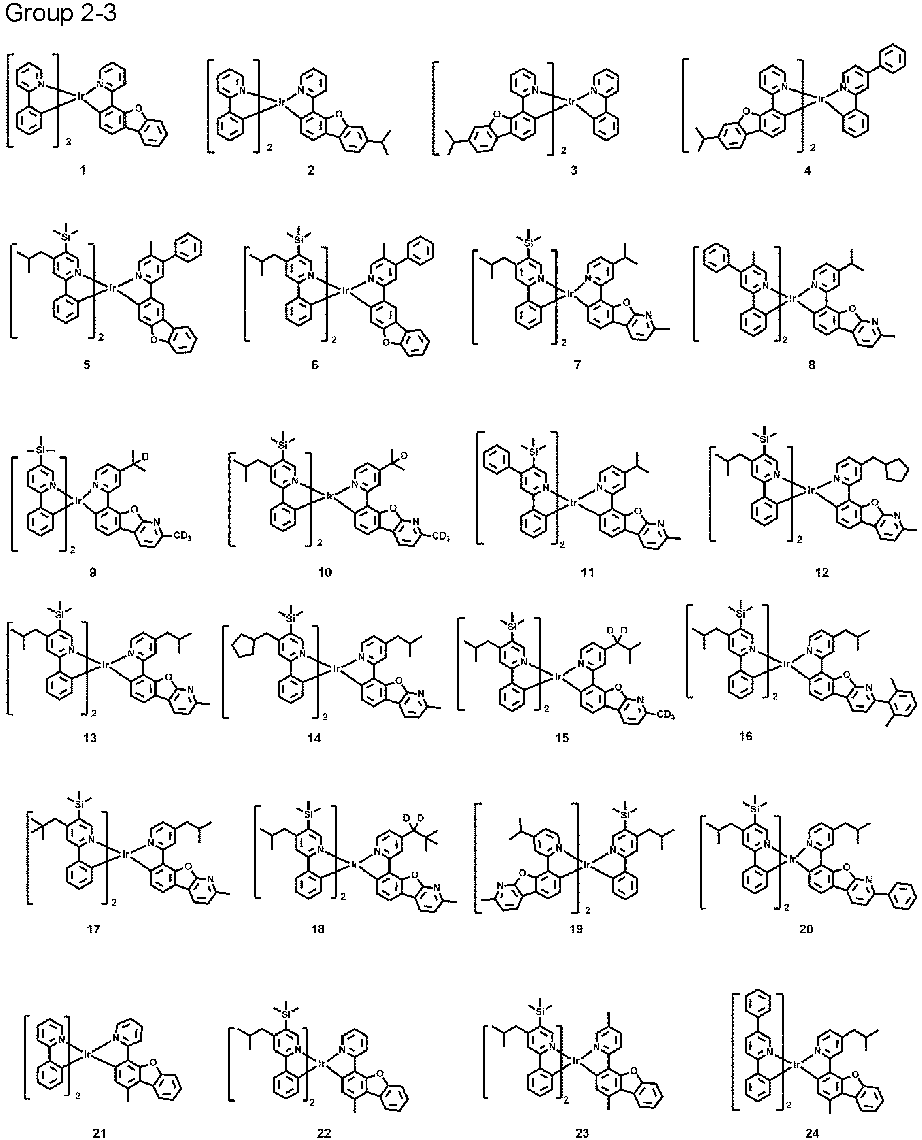

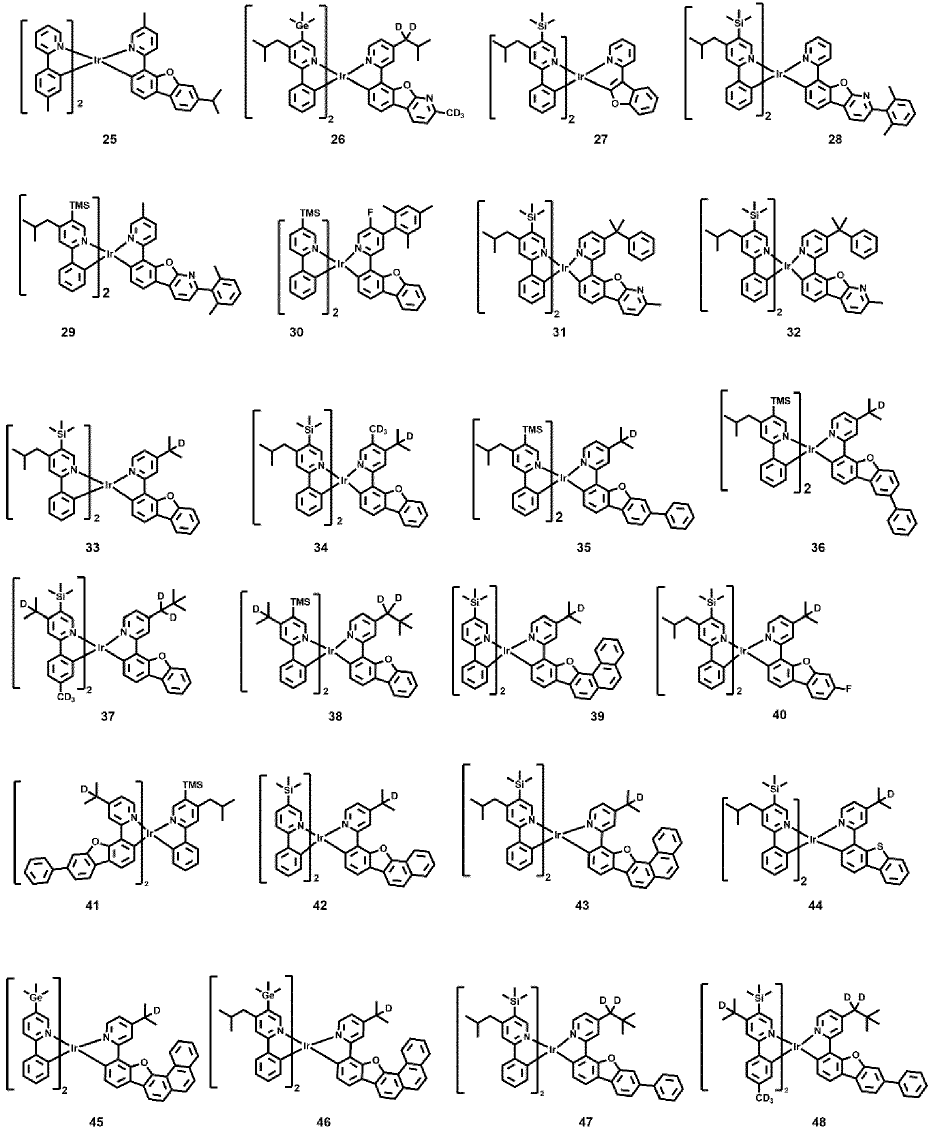

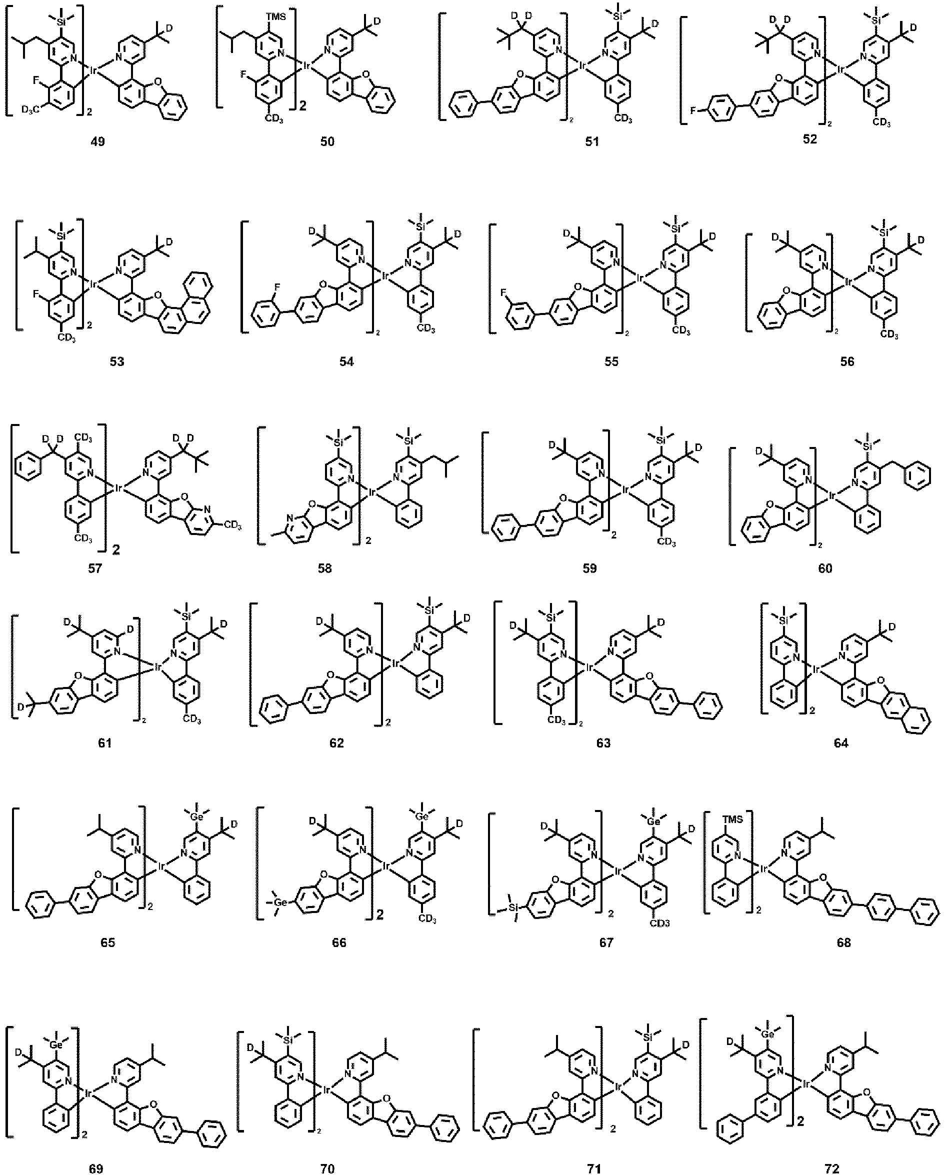

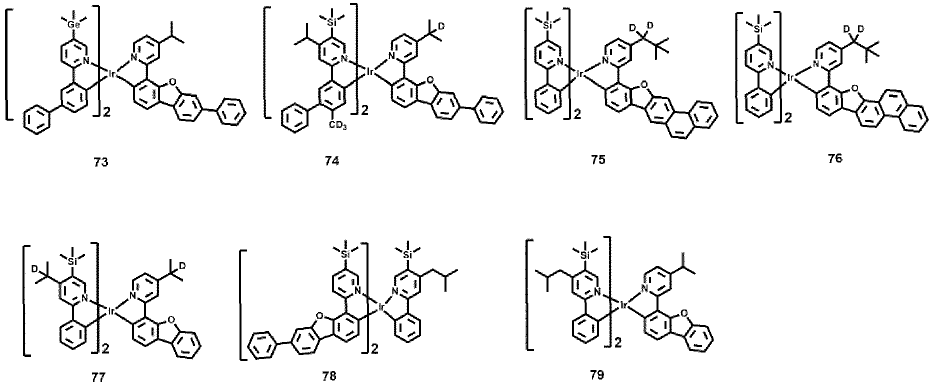

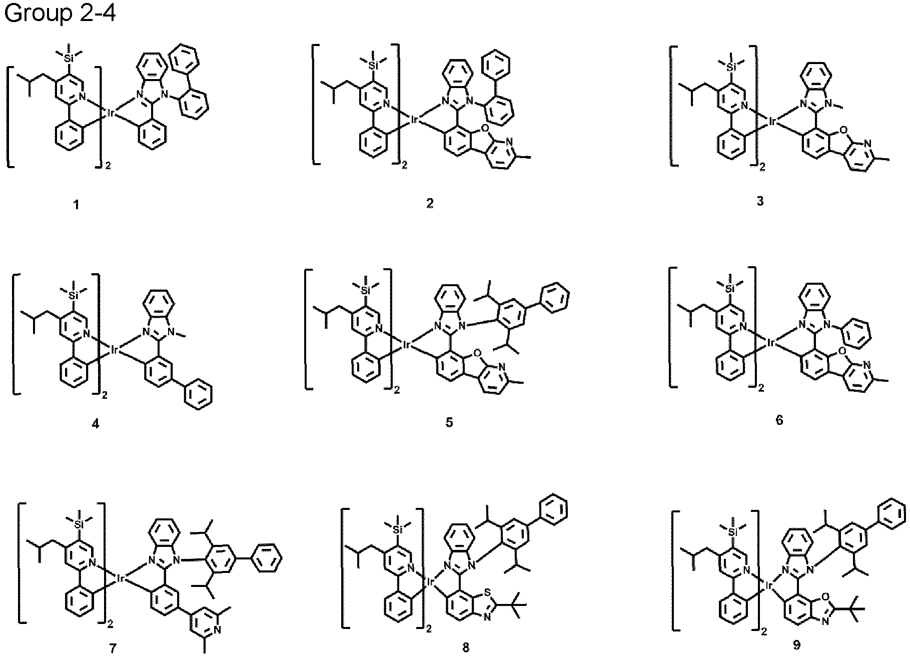

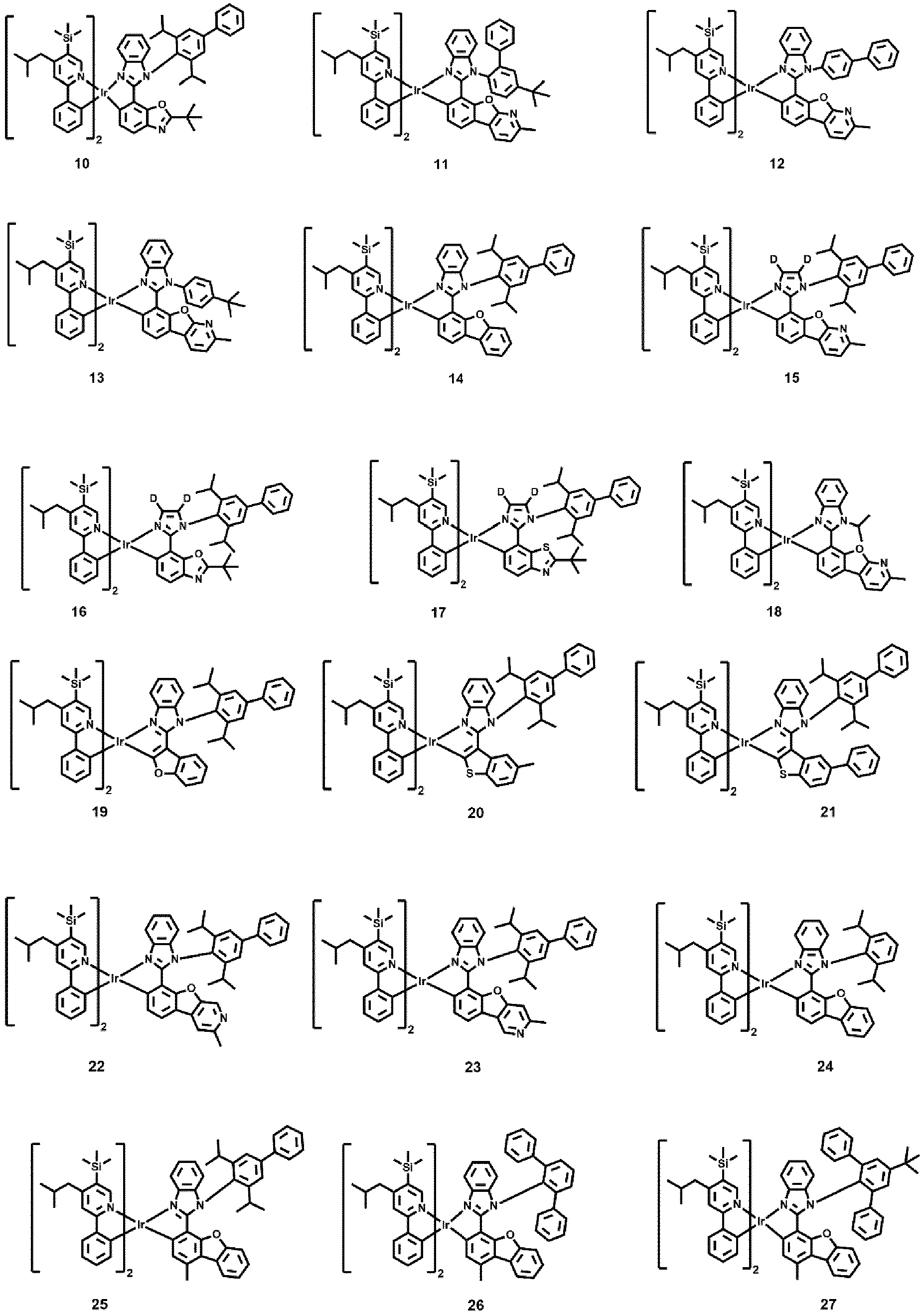

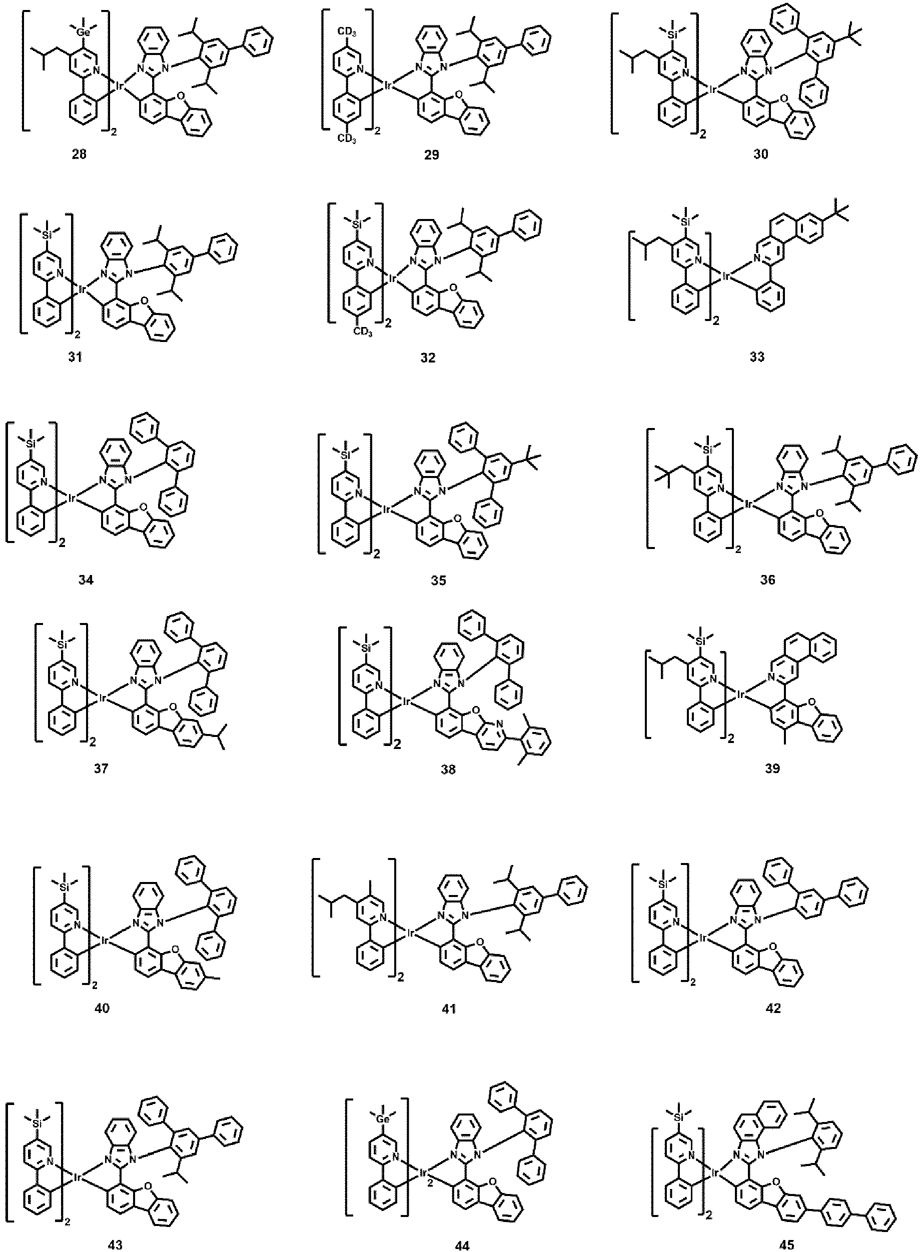

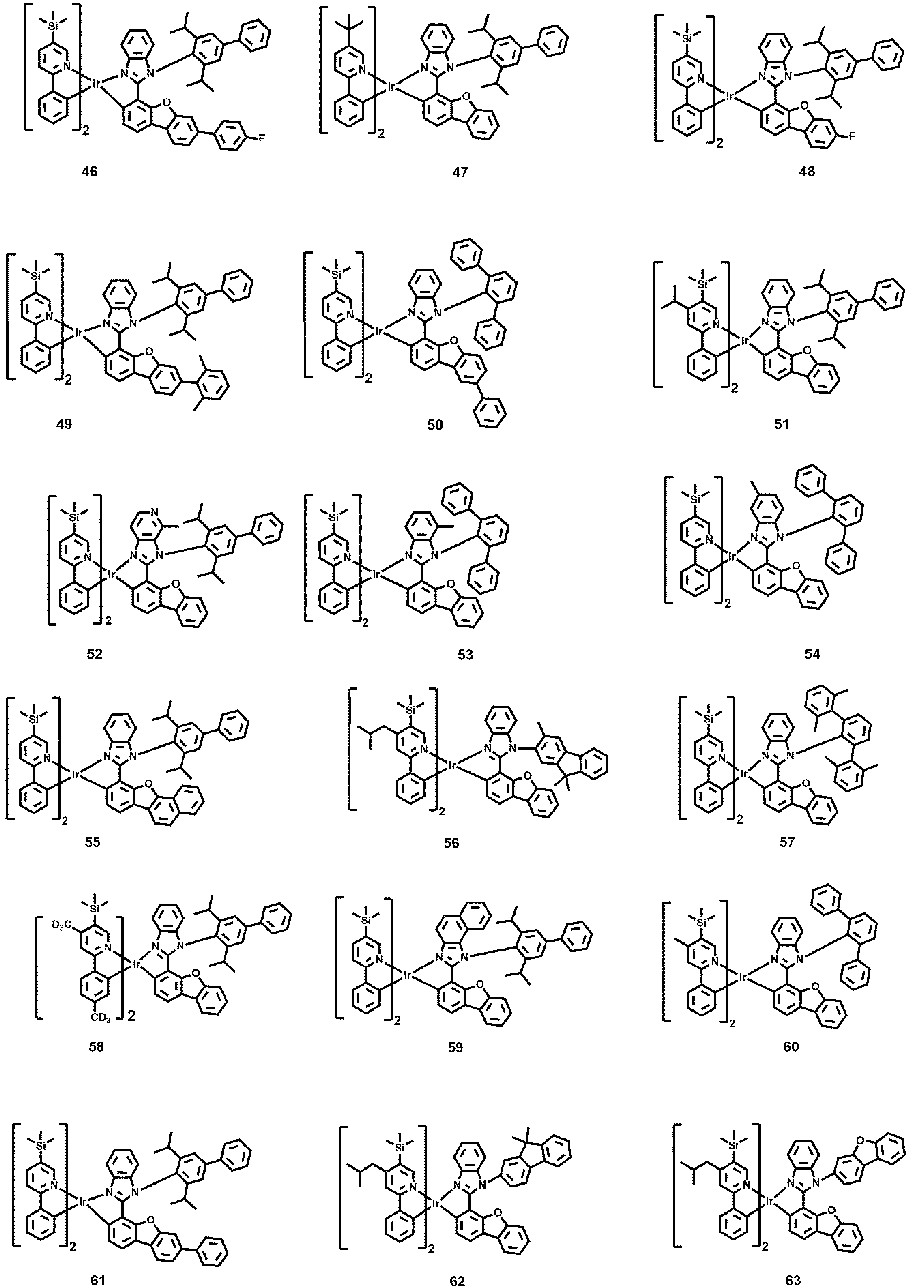

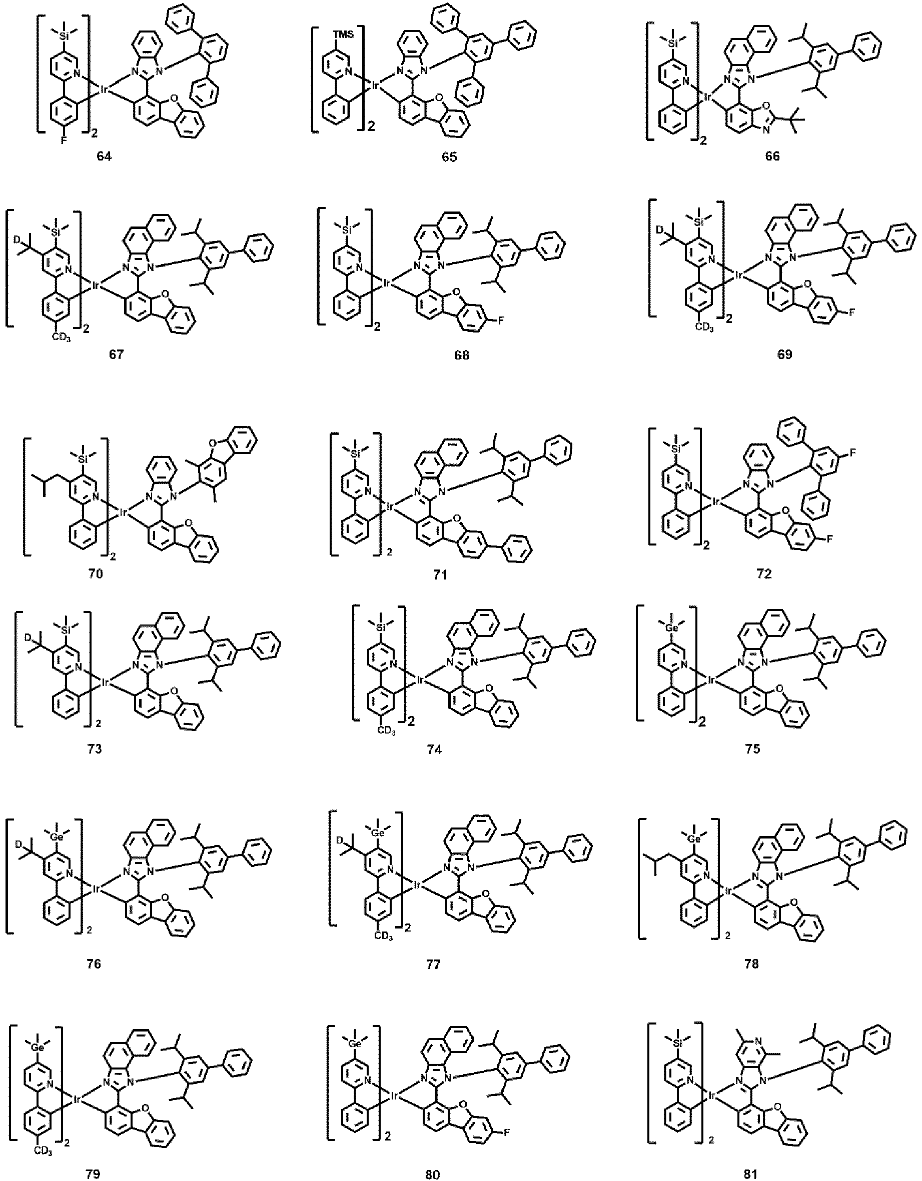

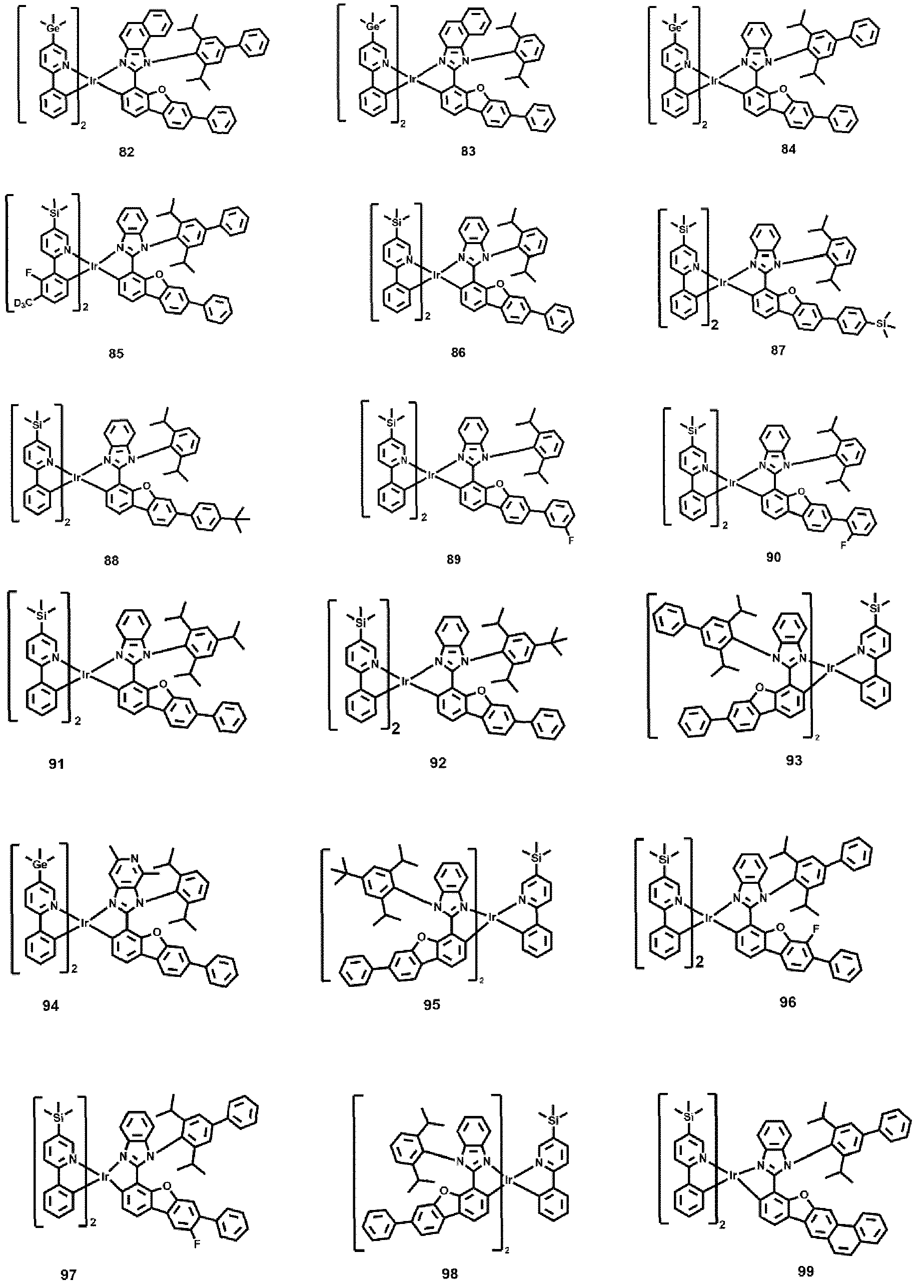

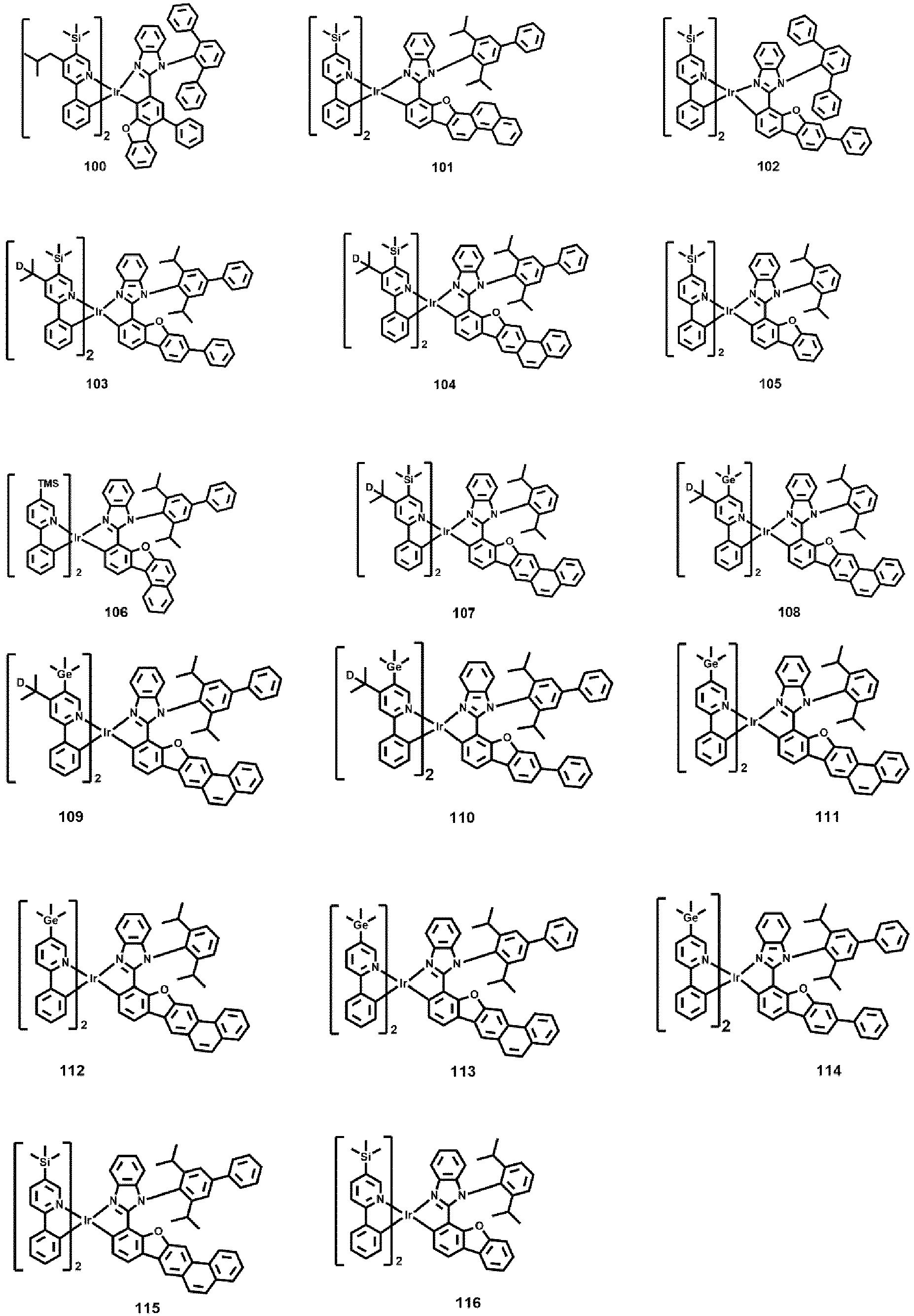

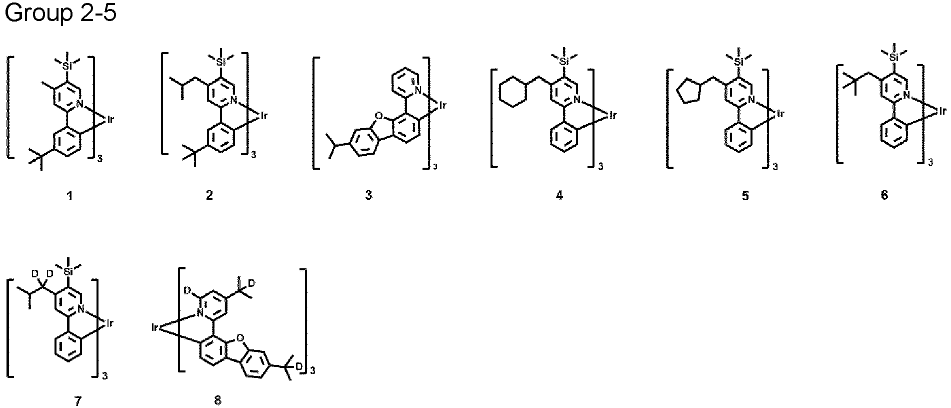

As used herein, and unless otherwise specified, "OMe" is a methoxy group, "TMS" is a trimethylsilyl group, and "TMG" is a trimethylgermyl group.

In one or more embodiments, the first emission layer may include a first dopant and a first host, the second emission layer may include a second dopant and a second host, the first dopant may include the first compound, and the second dopant may include the second compound.

For example, the first host and the second host may be identical to each other.

In one or more embodiments, the first host and the second host may be different from each other.

The first host and the second host may each include a hole transport compound, an electron transport compound, a bipolar compound, or a combination thereof.

For example, the first host and the second host may each include a hole transport compound and an electron transport compound, and the hole transport compound and the electron transport compound may be different from each other.

In one or more embodiments, the hole transport compound may include at least one π electron-rich C₃-C₆₀ cyclic group (for example, a carbazole group, an indolocarbazole group, a benzene group, or the like), and may not include an electron transport group. Examples of the electron transport group may include a cyano group, a fluoro group, a π electron-deficient nitrogen-containing C₁-C₆₀ cyclic group, a phosphine oxide group, and a sulfoxide group.

In one or more embodiments, the electron transport compound may be a compound including at least one electron transport group. The electron transport group may be a cyano group, a fluoro group, a π electron-deficient nitrogen-containing C₁-C₆₀ cyclic group, a phosphine oxide group, a sulfoxide group, or a combination thereof.

In one or more embodiments, the hole transport compound may be at least one of Compounds H1-1 to H1-72 of Group 5-1 or Compounds H1-1 to H1-20 of Group 5-2:

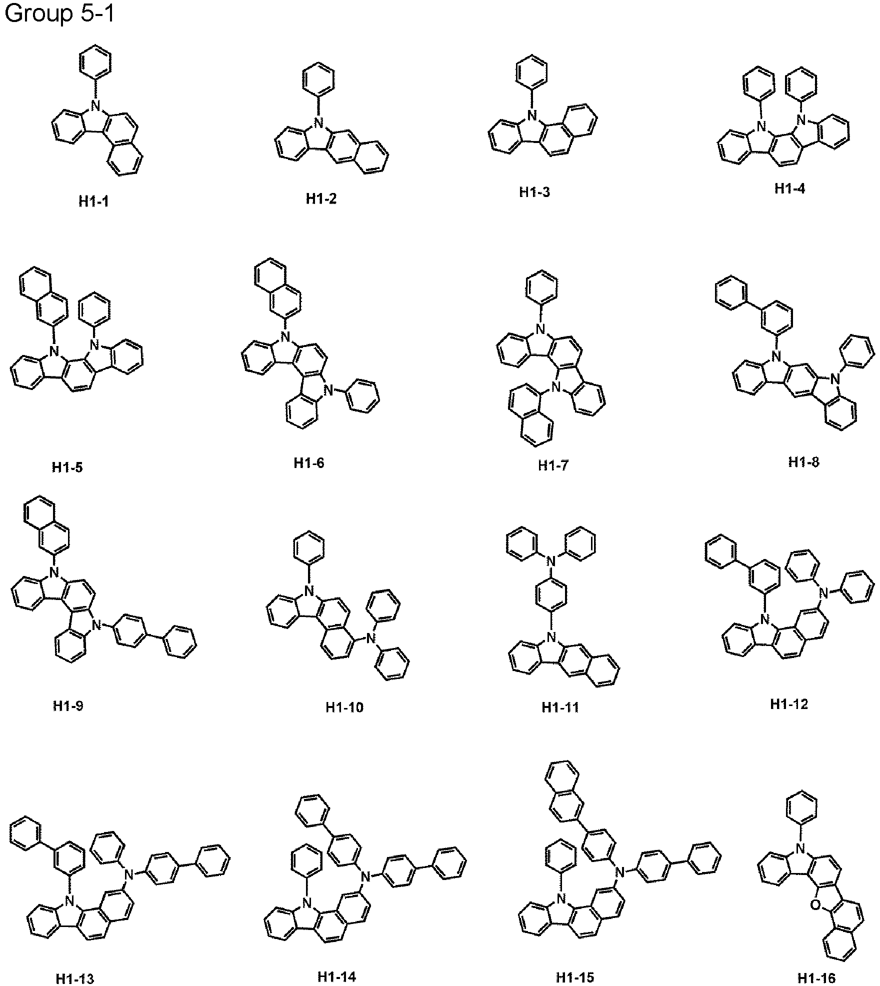

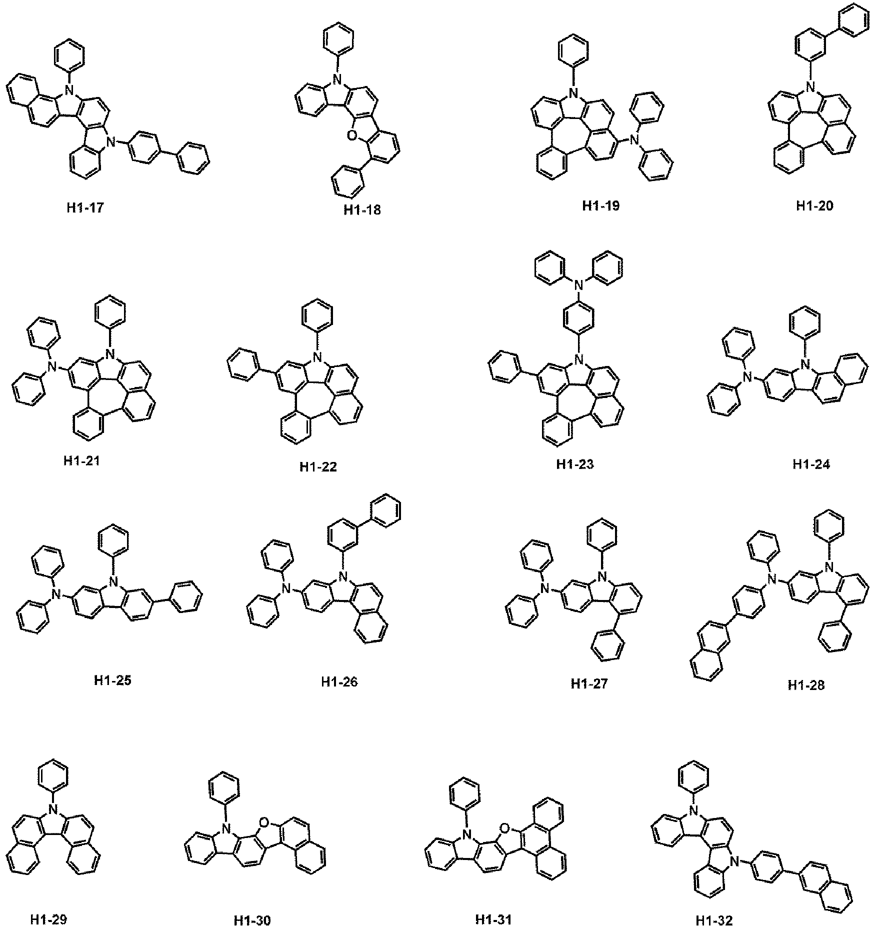

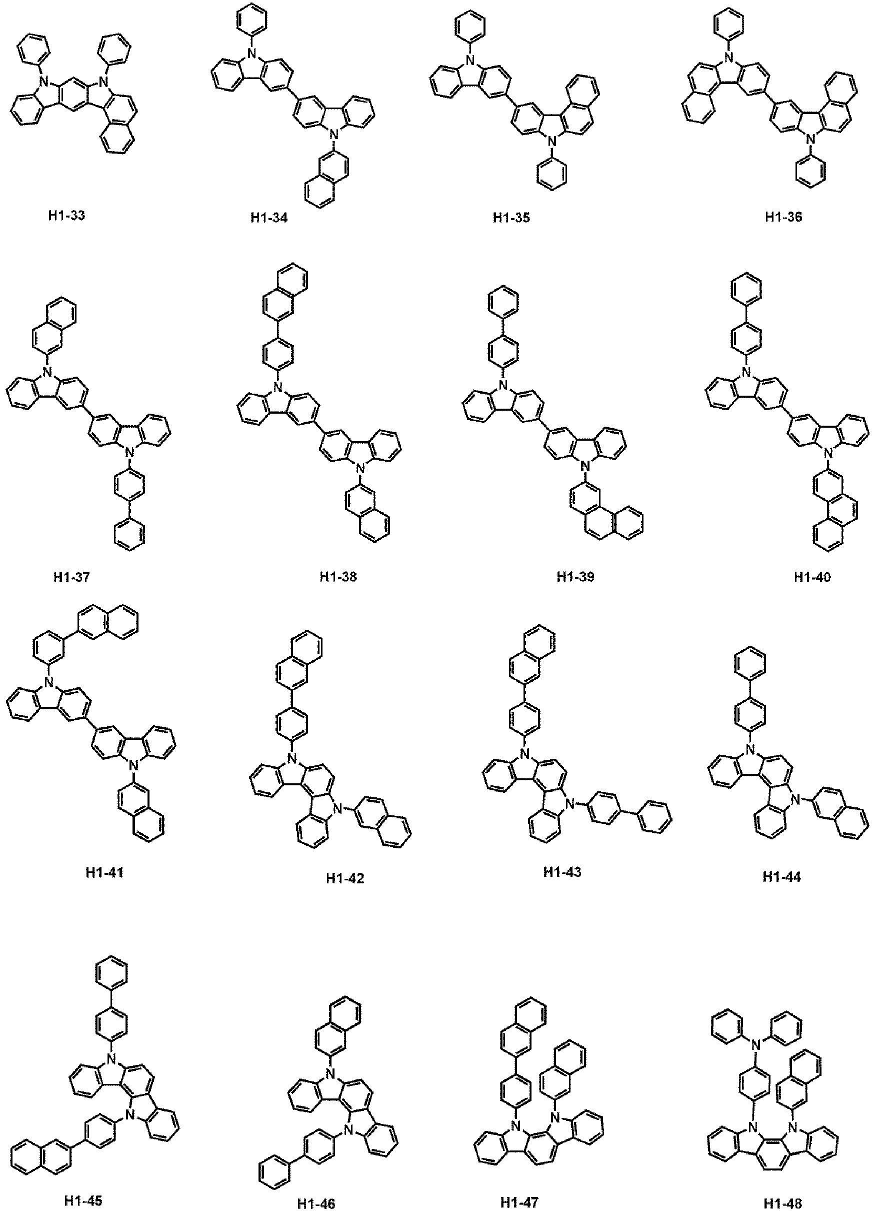

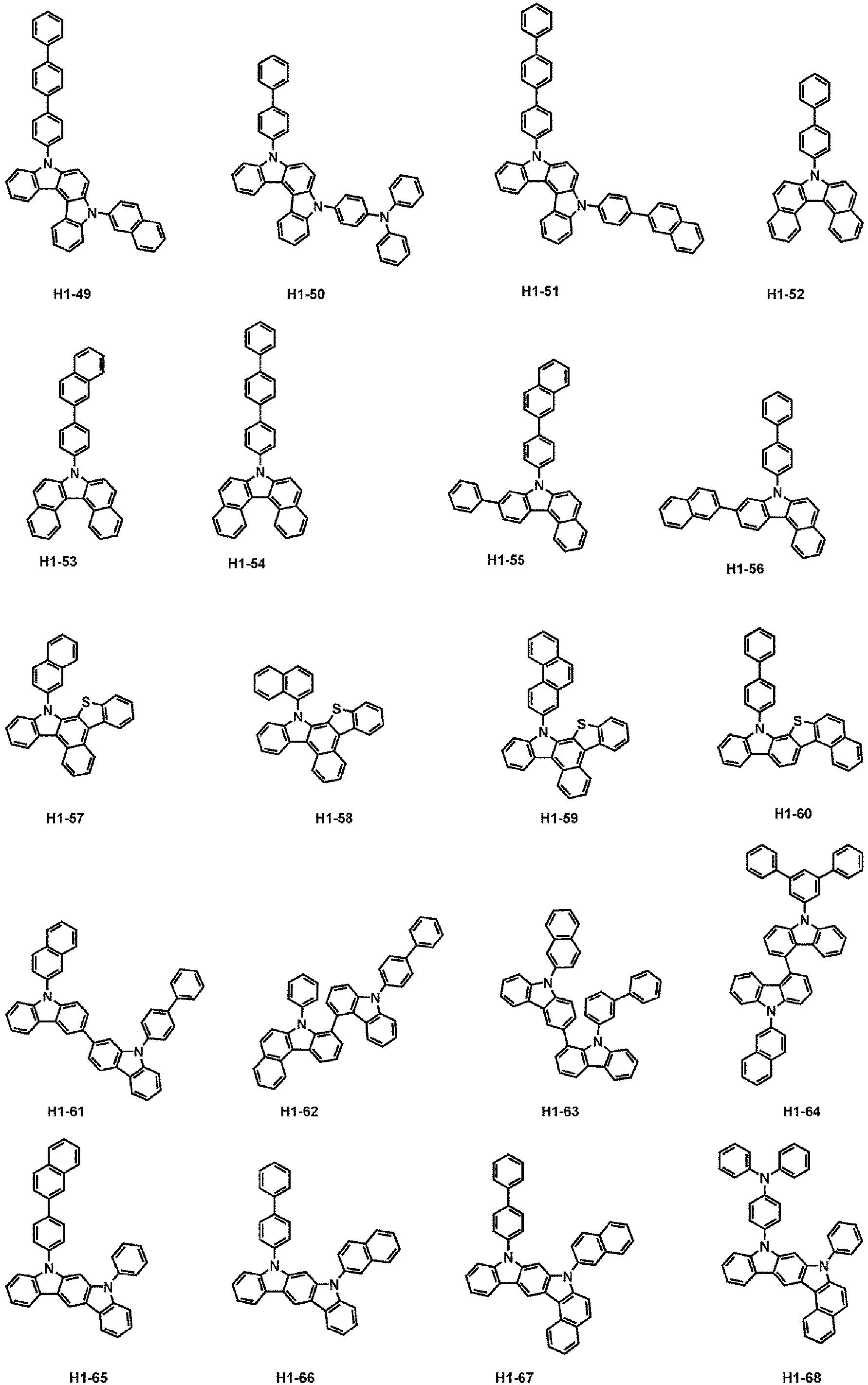

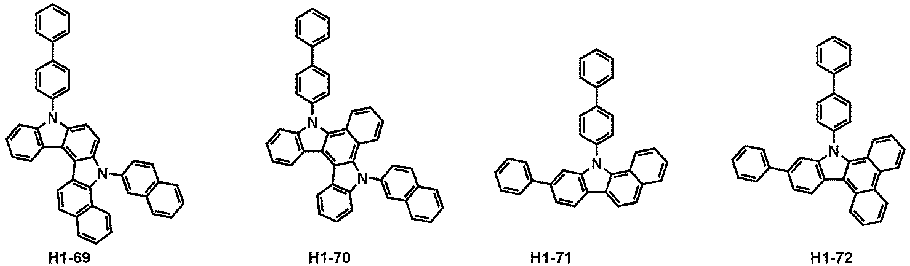

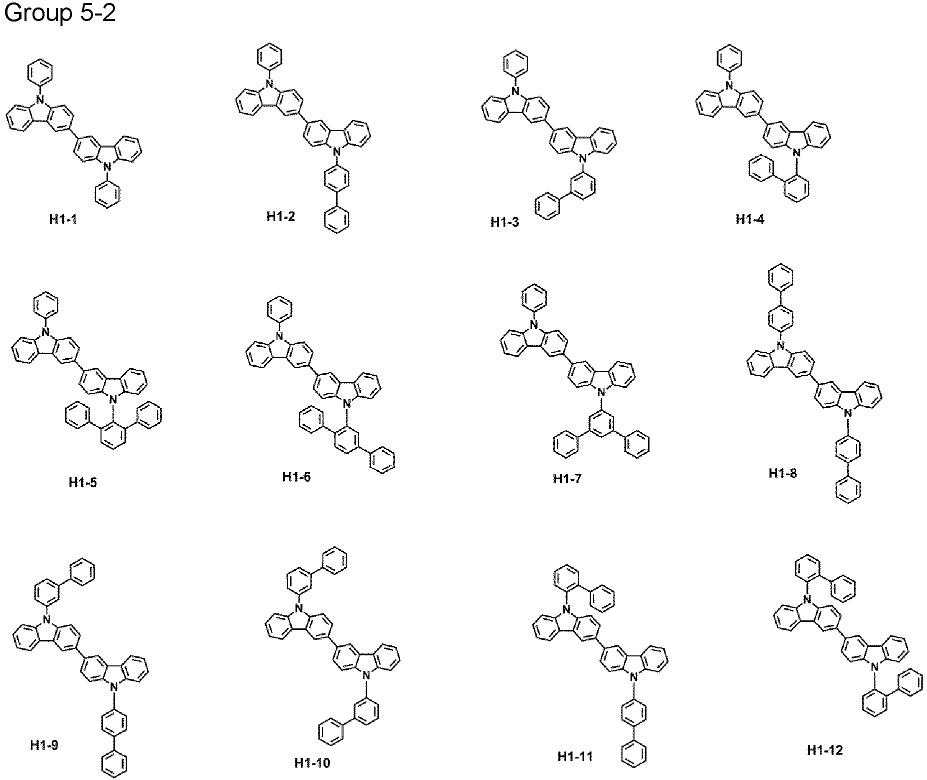

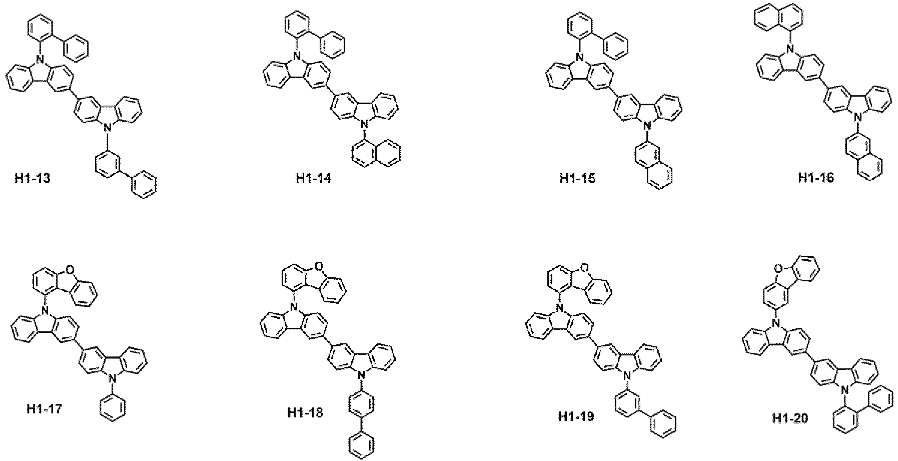

In one or more embodiments, the electron transport compound may be at least one of Compounds E1-1 to E1-62:

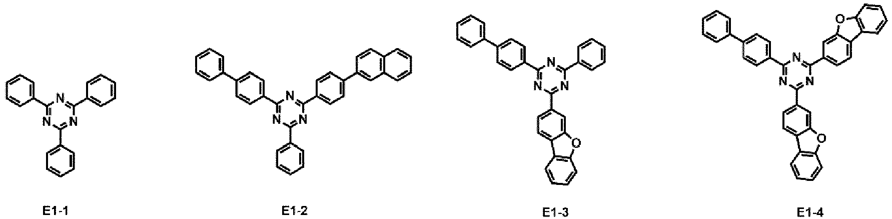

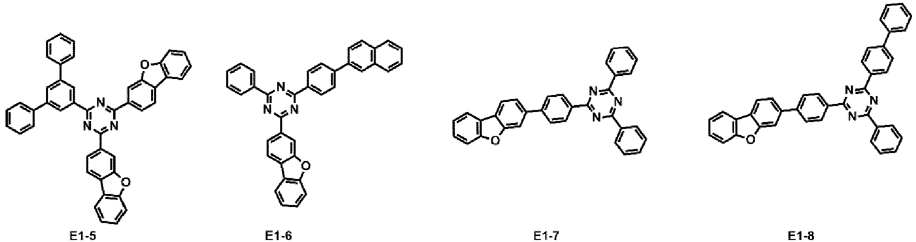

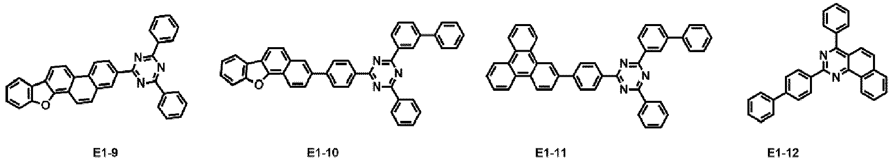

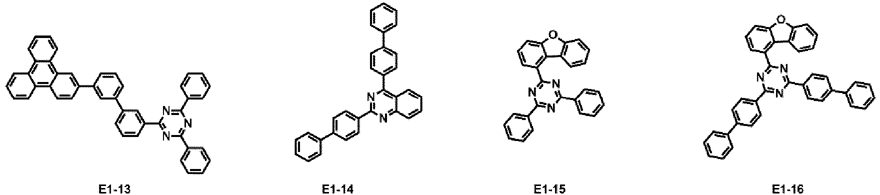

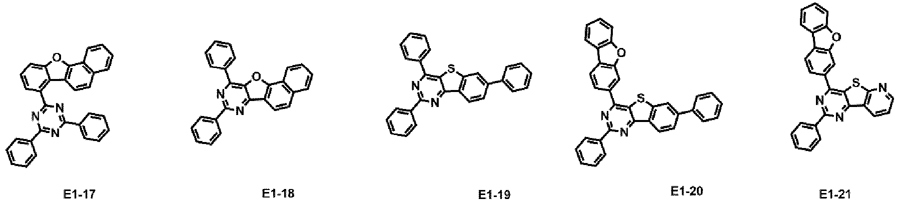

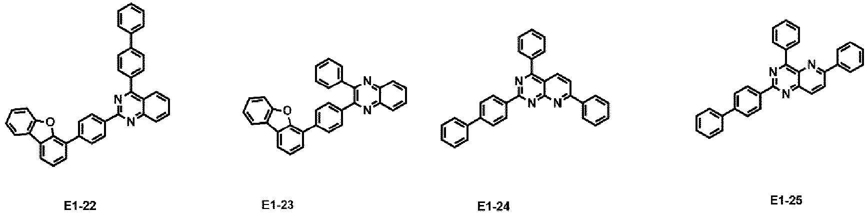

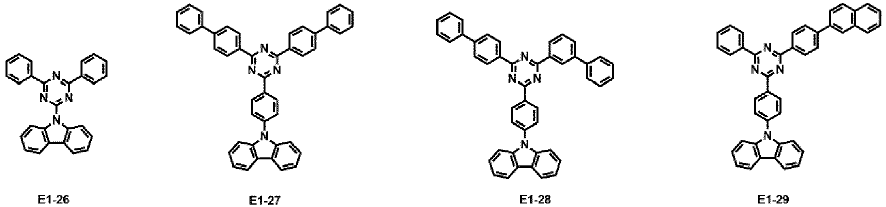

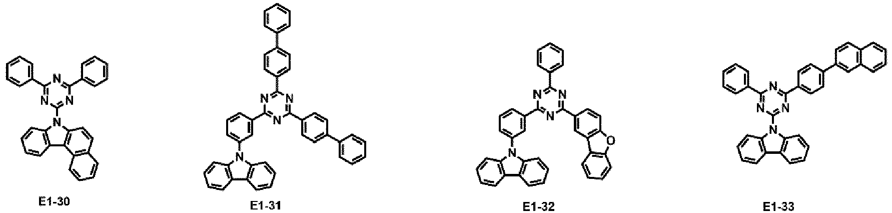

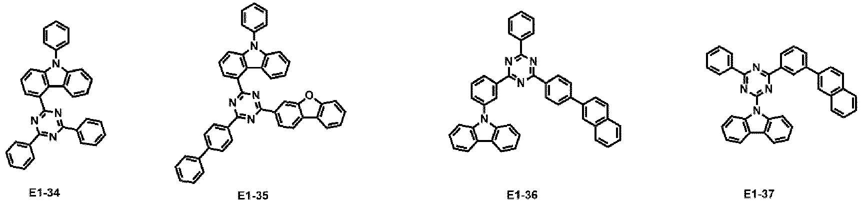

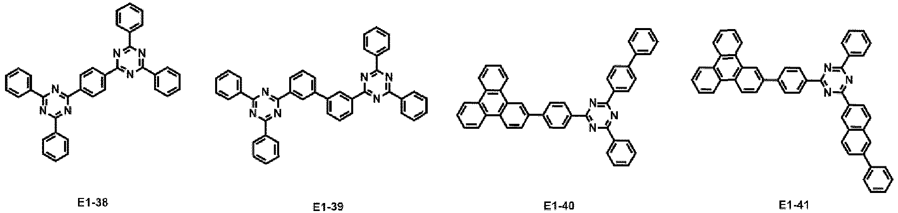

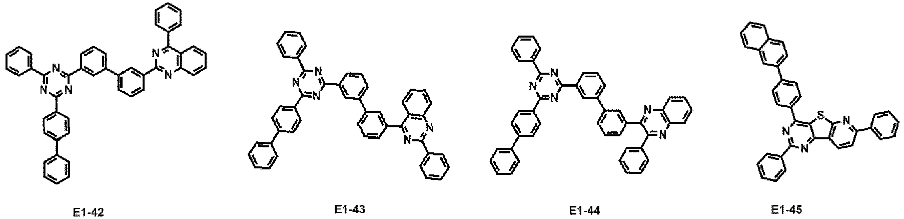

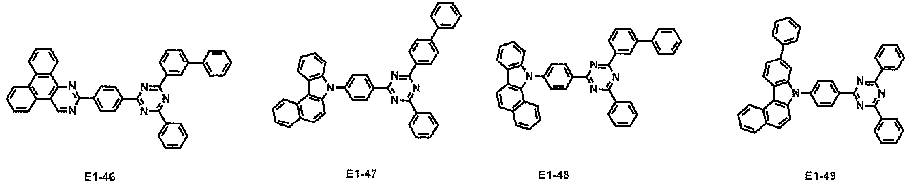

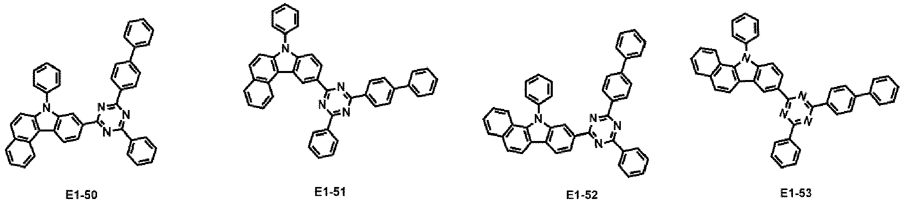

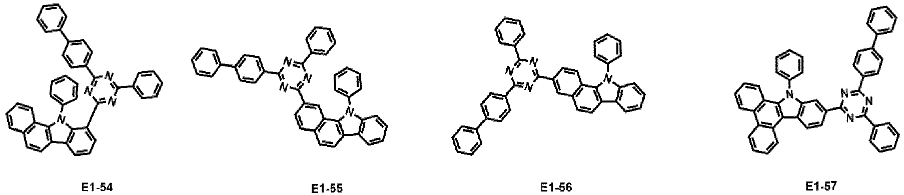

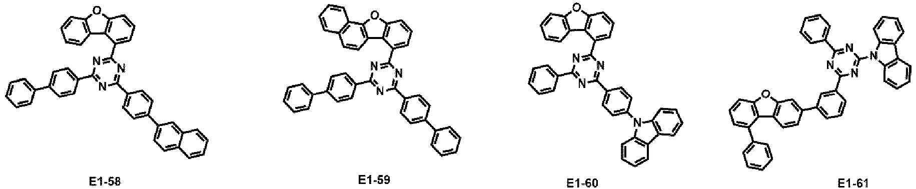

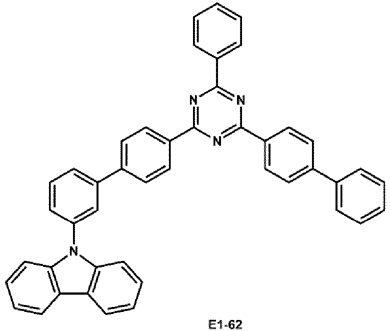

In one or more embodiments, the bipolar compound may be at least one of Compounds BP1-1 to BP1-17:

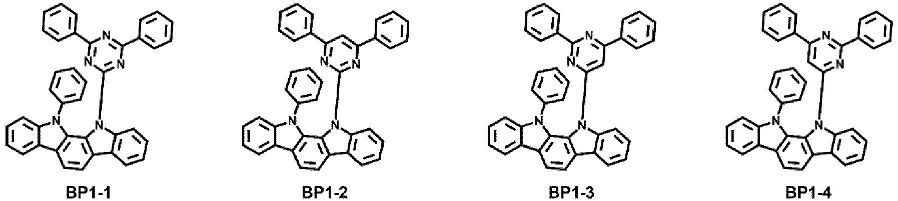

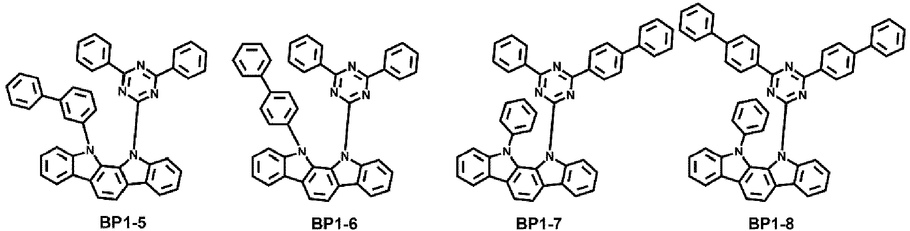

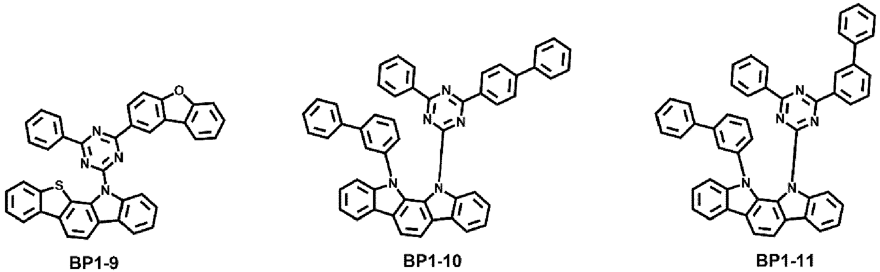

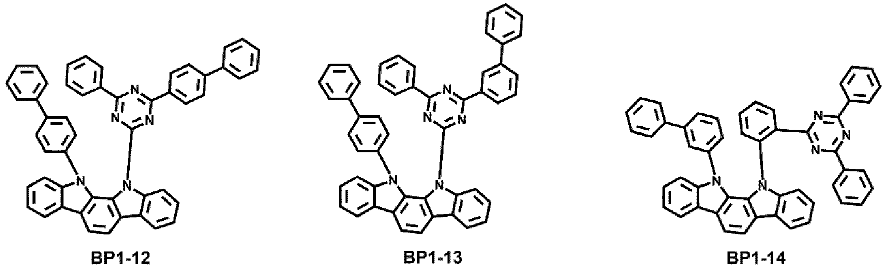

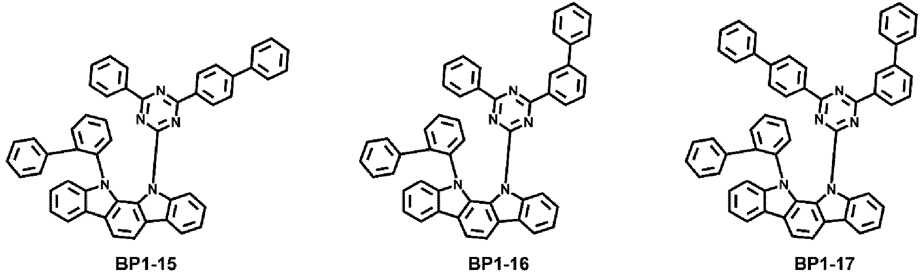

In one or more embodiments, each of the first emission layer and the second emission layer may not include compounds of Group A:

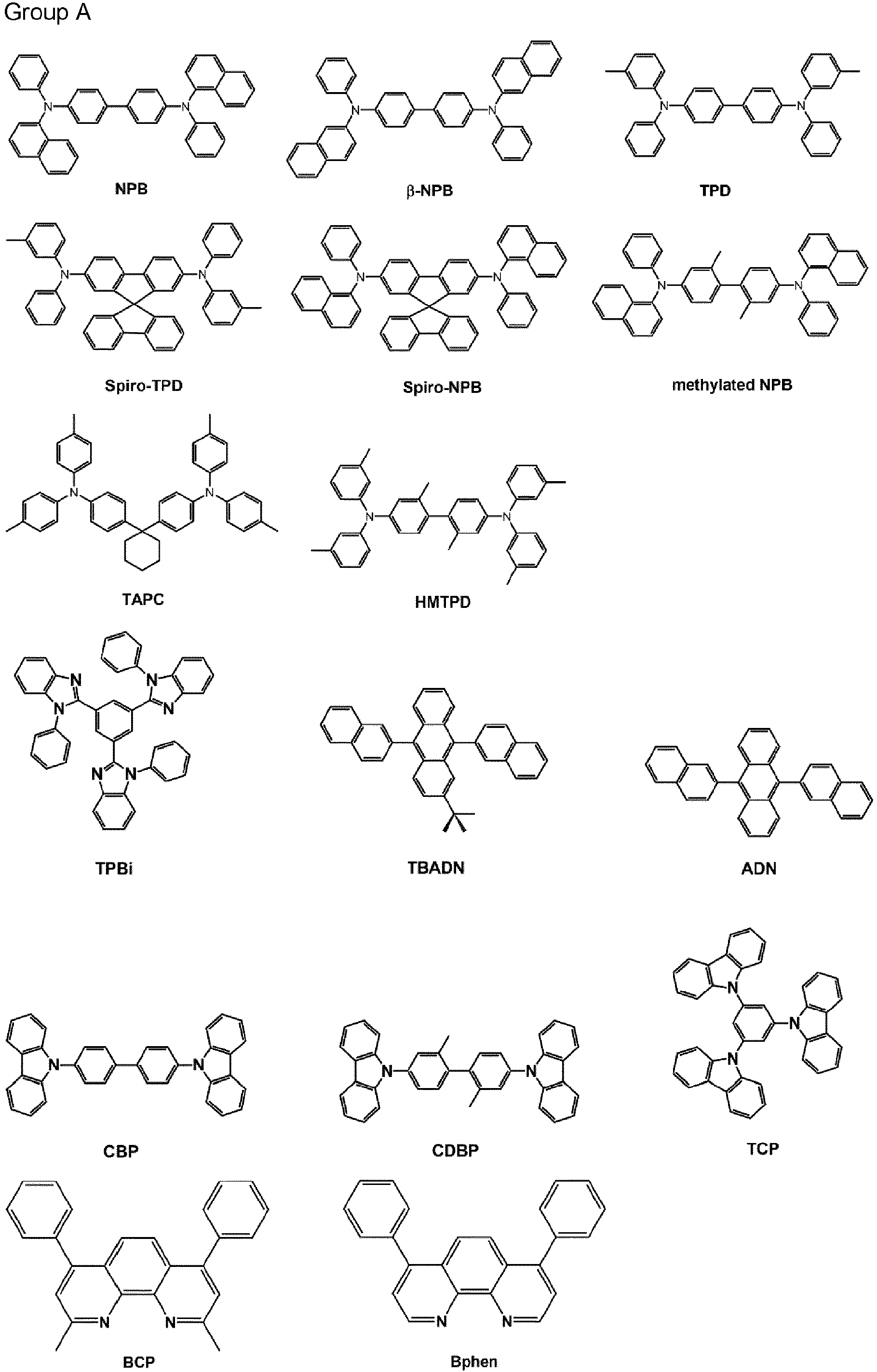

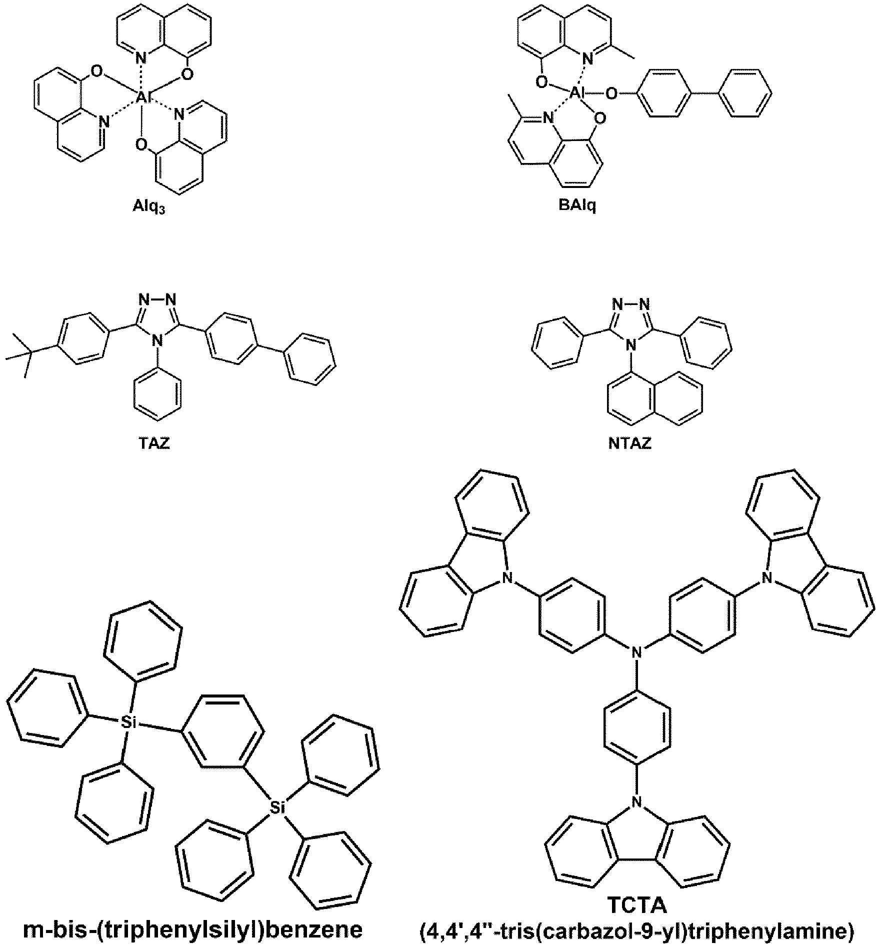

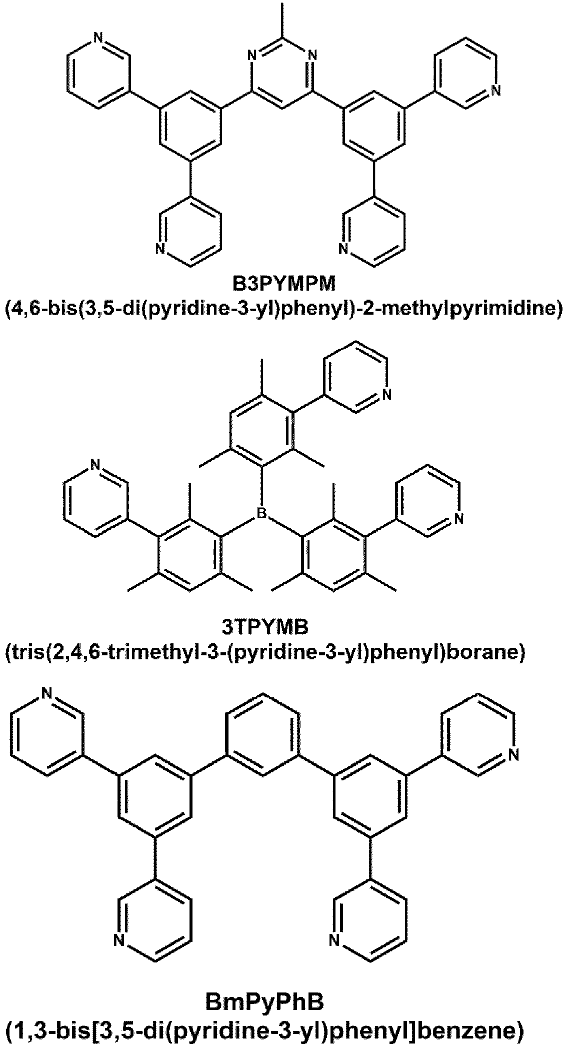

In one or more embodiments, the interlayer of the light-emitting device may further include a hole transport region arranged between the first electrode and the emission layer and an electron transport region arranged between the emission layer and the second electrode.

The hole transport region may include a hole injection layer, a hole transport layer, an electron blocking layer, a buffer layer, or a combination thereof, and the electron transport region may include a hole blocking layer, an electron transport layer, an electron injection layer, or a combination thereof.

The term "organic layer" as used herein refers to a single layer and/or a plurality of layers arranged between the first electrode and the second electrode of the light-emitting device. The "organic layer" may include, in addition to an organic compound, an organometallic complex including metal.

In one or more embodiments, the interlayer of the light-emitting device may include:
m light-emitting units including at least one emission layer; and
m-1 charge generation layers arranged between two neighboring light-emitting units of the m light-emitting units,
wherein m may be an integer of 2 or greater.

That is, the light-emitting device may be a tandem light-emitting device.

For example, m may be 2, 3, 4, 5, 6, 7, 8, 9, or 10. In one or more embodiments, m may be 2, 3, 4, 5, or 6.

In one or more embodiments, i) a first light-emitting unit of the m light-emitting units may include the first emission layer, and a second light-emitting unit of the m light-emitting units may include the second emission layer, or ii) one light-emitting unit of the m light-emitting units may include the first emission layer and the second emission layer, or a first light-emitting unit of the m light-emitting units may include the first emission layer and the second emission layer. The first emission layer and the second emission layer are each as described herein.

In one or more embodiments, a first light-emitting unit of the m light-emitting units may include the first emission layer, a second light-emitting unit of the m light-emitting units may include the second emission layer, and each of the first light-emitting unit including the first emission layer and the second light-emitting unit including the second emission layer may emit a green light.

In one or more embodiments, a first light-emitting unit of the m light-emitting units may include the first emission layer, a second light-emitting unit of the m light-emitting units may include the second emission layer, and the first light-emitting unit including the first emission layer may be arranged between the second light-emitting unit including the second emission layer and the second electrode.

In one or more embodiments, a first light-emitting unit of the m light-emitting units may include the fist emission layer, a second light-emitting unit of the m light-emitting units may include the second emission layer, and the second light-emitting unit including the second emission layer may be arranged between the first light-emitting unit including the first emission layer and the second electrode.

In one or more embodiments, one light-emitting unit of the m light-emitting units may include the one emission layer and the second emission layer, and the first light-emitting unit including the first emission layer and the second emission layer may emit a green light.

In one or more embodiments, at least one light-emitting unit of the m light-emitting units may emit a blue light.

According to another aspect, the light-emitting device may be included in an electronic apparatus. Thus, an electronic apparatus including the light-emitting device is also provided. The electronic apparatus may include, for example, a display, an illumination, a sensor, or the like.

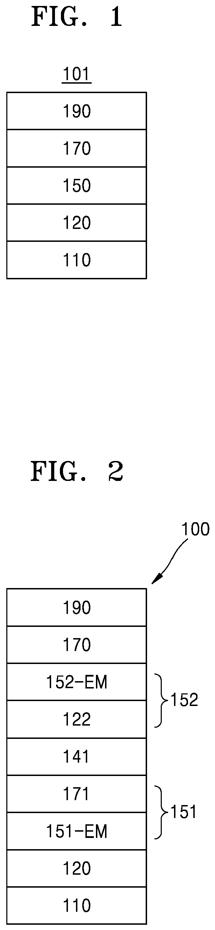

### Description of FIG. 1

FIG. 1 schematically illustrates a cross-sectional view of an organic light-emitting device 101, which is a light-emitting device according to one or more embodiments. Hereinafter, the structure and manufacturing method of the organic light-emitting device 101 according to one or more embodiments will be described in connection with FIG. 1.

The organic light-emitting device 101 of FIG. 1 includes a first electrode 110, a second electrode 190, and an interlayer (not shown) arranged between the first electrode 110 and the second electrode 190, wherein the interlayer includes a hole transport region 120, an emission layer 150, and an electron transport region 170.

A substrate may be additionally arranged under the first electrode 110 or above the second electrode 190. For use as the substrate, any substrate that is used in organic light-emitting devices available in the art may be used, and the substrate may be a glass substrate or a transparent plastic substrate, each having excellent mechanical strength, thermal stability, transparency, surface smoothness, ease of handling, and/or water resistance.

The first electrode 110 may be formed by, for example, depositing or sputtering a material for forming the first electrode 110 on the substrate. The first electrode 110 may be an anode. The material for forming the first electrode 110 may include materials with a high work function to facilitate hole injection. The first electrode 110 may be a reflective electrode. The material for forming the first electrode 110 may be indium tin oxide (ITO), indium zinc oxide (IZO), tin oxide (SnO₂), or zinc oxide (ZnO). In one or more embodiments, the material for forming the first electrode 110 may be metal, such as magnesium (Mg), aluminum (Al), silver (Ag), aluminum-lithium (Al-Li), calcium (Ca), magnesium-indium (Mg-In), or magnesium-silver (Mg-Ag).

The first electrode 110 may have a single-layered structure or a multi-layered structure including two or more layers. For example, the first electrode 110 may have a three-layered structure of ITO/Ag/ITO.

The hole transport region 120 may be arranged between the first electrode 110 and the emission layer 150.

The hole transport region 120 may include a hole injection layer, a hole transport layer, an electron blocking layer, a buffer layer, or a combination thereof.

The hole transport region 120 may include only a hole injection layer or only a hole transport layer. In one or more embodiments, the hole transport region 120 may have a hole injection layer/hole transport layer structure or a hole injection layer/hole transport layer/electron blocking layer structure, which are sequentially stacked in this stated order from the first electrode 110.

When the hole transport region 120 includes a hole injection layer, the hole injection layer may be formed on the first electrode 110 by using one or more suitable methods, for example, vacuum deposition, spin coating, casting, Langmuir-Blodgett (LB) deposition, and/or ink-jet printing.

When the hole injection layer is formed by vacuum deposition, the deposition conditions may vary depending on a material that is used to form the hole injection layer, and the structure and thermal characteristics of the hole injection layer. For example, the deposition conditions may include a deposition temperature of about 100 °C to about 500°C, a vacuum pressure of about 10⁻⁸ torr to about 10⁻³ torr, and a deposition rate of about 0.01 angstroms per second (Å/sec) to about 100 Å/sec.

When the hole injection layer is formed by spin coating, the coating conditions may vary depending on a material that is used to form the hole injection layer, and the structure and thermal characteristics of the hole injection layer. For example, the coating conditions may include a coating speed of about 2,000 revolutions per minute (rpm) to about 5,000 rpm and a heat treatment temperature of about 80°C to about 200°C for removing a solvent after coating.

The conditions for forming the hole transport layer and the electron blocking layer may be as the conditions for forming the hole injection layer.

The hole transport region 120 may include 4,4',4"-tris(3-methylphenylphenylamino)triphenylamine (m-MTDATA), 4,4',4"-tris(N,N-diphenylamino)triphenylamine (TDATA), 4,4',4"-tris{N-(2-naphthyl)-N-phenylamino}-triphenylamine (2-TNATA), N,N'-di(1-naphthyl)-N,N'-diphenylbenzidine (NPB), β-NPB, N,N'-bis(3-methylphenyl)-N,N'-diphenyl-[1,1-biphenyl]-4,4'-diamine (TPD), spiro-TPD, spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, a compound represented by Formula 202, or a combination thereof:

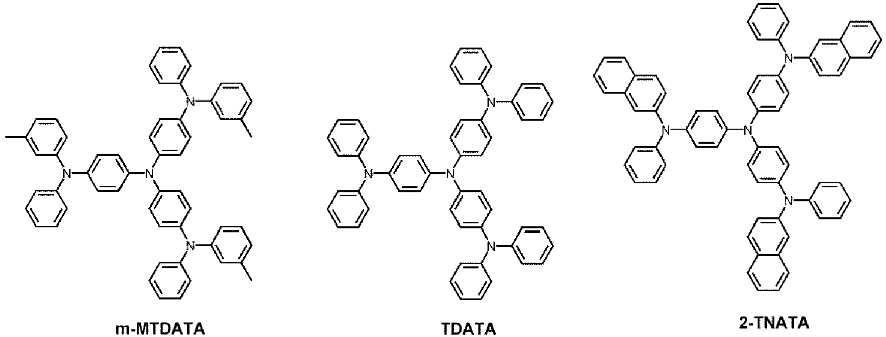

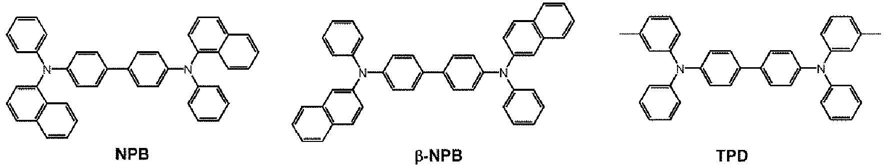

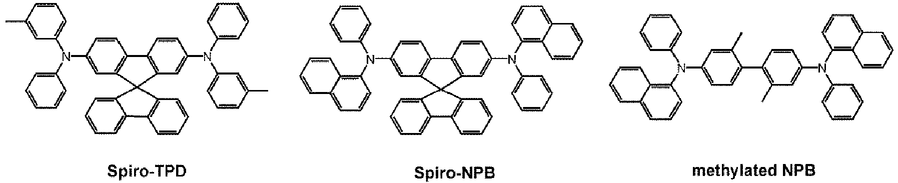

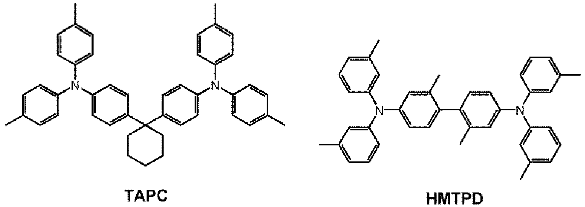

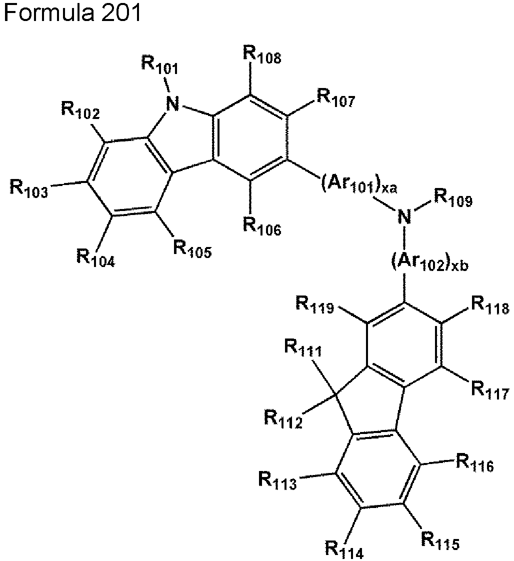

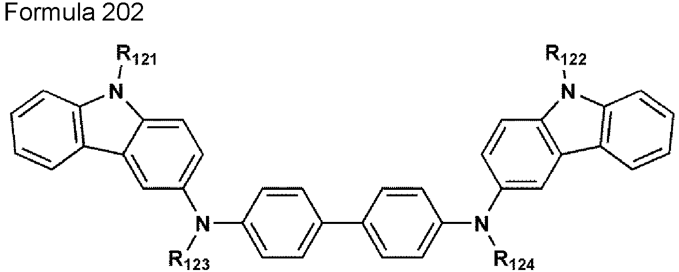

Ar₁₀₁ and Ar₁₀₂ in Formula 201 may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with at least one of deuterium, -F, -Cl, -Br, -I, - SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, or a combination thereof.

xa and xb in Formula 201 may each independently be an integer from 0 to 5, or may each independently be 0, 1, or 2. For example, xa may be 1 and xb may be 0.

R₁₀₁ to R₁₀₈, R₁₁₁ to R₁₁₉, and R₁₂₁ to R₁₂₄ in Formulae 201 and 202 may each independently be:
hydrogen, deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, a pentyl group, a hexyl group, etc.), a C₁-C₁₀ alkoxy group (for example, a methoxy group, an ethoxy group, a propoxy group, a butoxy group, a pentoxy group, etc.), or a C₁-C₁₀ alkylthio group;
a C₁-C₁₀ alkyl group, a C₁-C₁₀ alkoxy group, or a C₁-C₁₀ alkylthio group, each unsubstituted or substituted with at least one of deuterium, -F, -Cl, -Br, -I, - SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or
a phenyl group, a naphthyl group, an anthracenyl group, a fluorenyl group, or a pyrenyl group, each unsubstituted or substituted with at least one of deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, a C₁-C₁₀ alkylthio group, or a combination thereof.

R₁₀₉ in Formula 201 may be a phenyl group, a naphthyl group, an anthracenyl group, or a pyridinyl group, each unsubstituted or substituted with at least one of deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a naphthyl group, an anthracenyl group, a pyridinyl group, or a combination thereof.

In one or more embodiments, the compound represented by Formula 201 may be represented by Formula 201A: 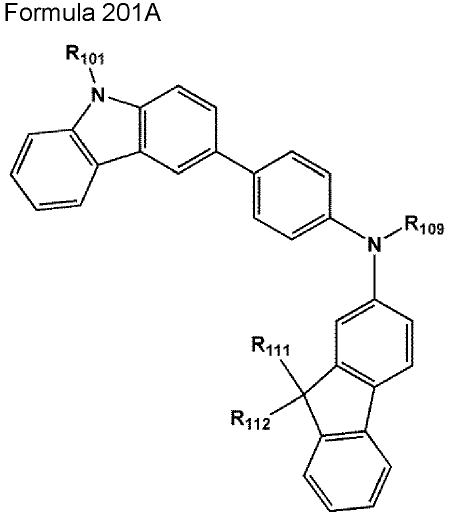 wherein, in Formula 201A, R₁₀₁, R₁₁₁, R₁₁₂, and R₁₀₉ are each as described herein.

For example, the hole transport region 120 may include at least one of Compounds HT1 to HT20, or a combination thereof:

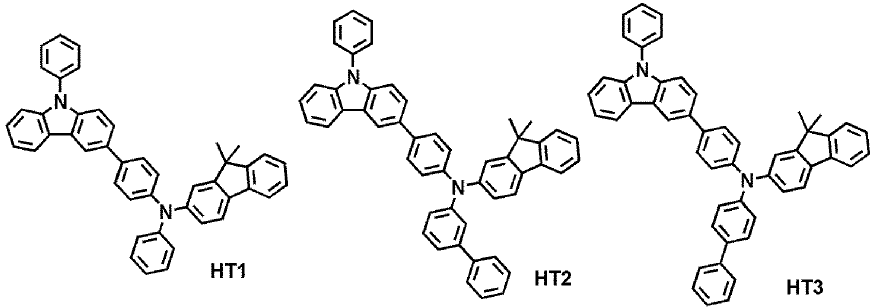

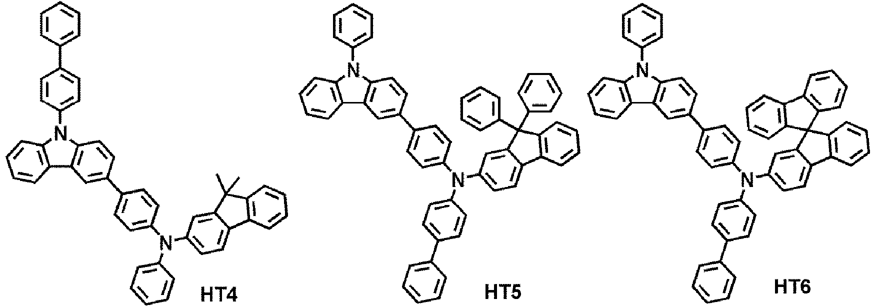

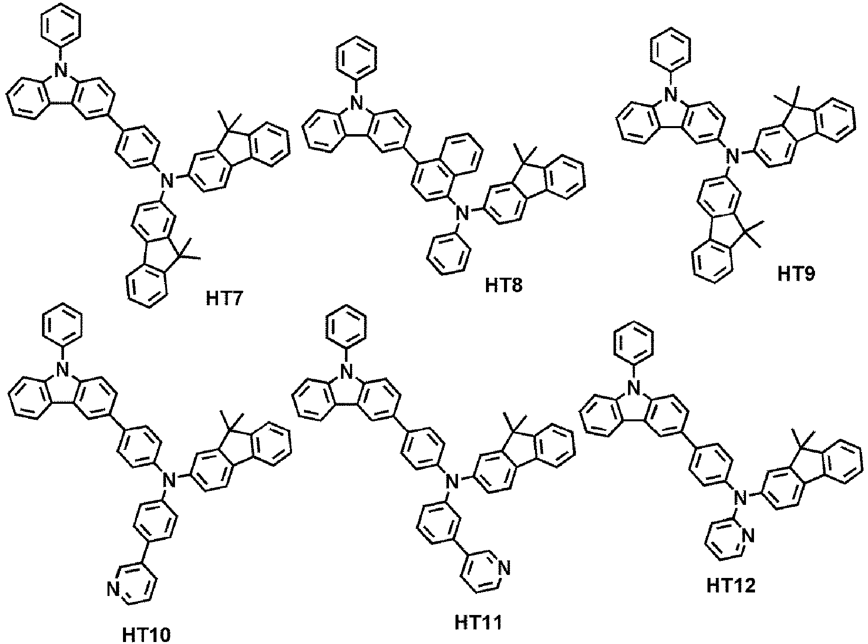

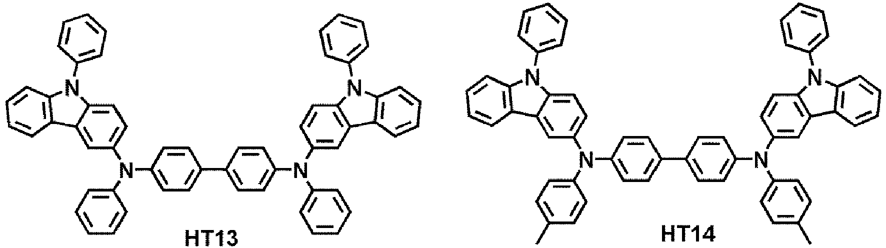

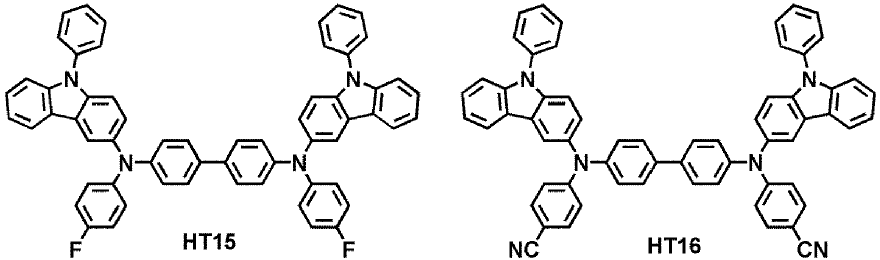

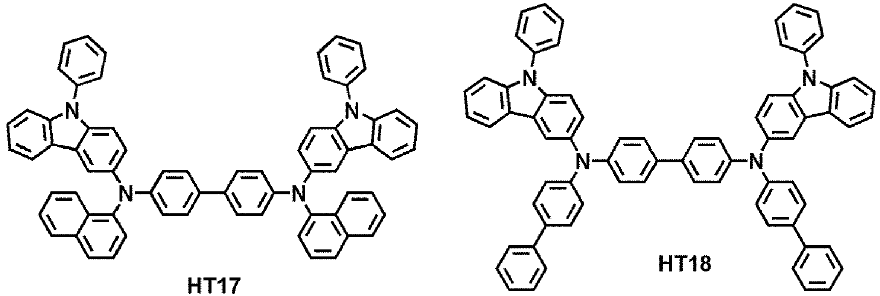

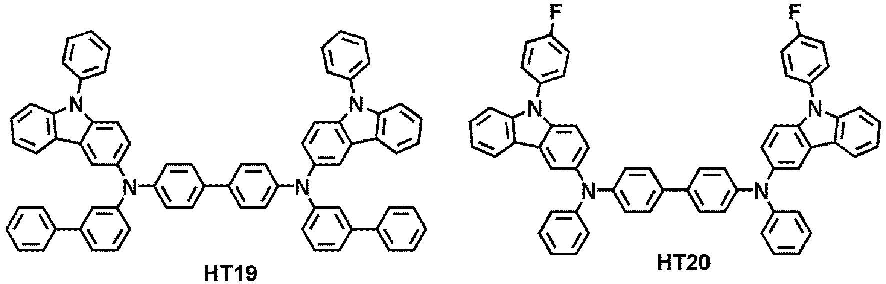

A thickness of the hole transport region 120 may be about 100 angstroms (Å) to about 10,000 Å, for example, about 100 Å to about 1,000 Å. When the hole transport region 120 includes a hole injection layer, a hole transport layer, an electron blocking layer, or a combination thereof, a thickness of the hole injection layer may be about 100 Å to about 10,000 Å, for example, about 100 Å to about 1,000 Å, and a thickness of the hole transport layer may be about 50 Å to about 2,000 Å, for example, about 100 Å to about 1,500 Å. When the thicknesses of the hole transport region 120, the hole injection layer, and the hole transport layer are within these ranges, satisfactory hole transporting characteristics may be obtained without a substantial increase in driving voltage.

The hole transport region 120 may further include, in addition to the materials as described above, a charge-generation material for the improvement of conductive characteristics. The charge-generation material may be homogeneously or non-homogeneously dispersed in the hole transport region 120.

The charge-generation material may be, for example, a p-dopant. The p-dopant may be a quinone derivative, a metal oxide, a cyano group-containing compound, or a combination thereof. For example, the p-dopant may be a quinone derivative such as tetracyanoquinodimethane (TCNQ), 2,3,5,6-tetrafluoro-tetracyano-1,4-benzoquinonedimethane (F4-TCNQ), or F6-TCNNQ; metal oxide, such as tungsten oxide and molybdenum oxide; a cyano group-containing compound, such as Compound HT-D1; or a combination thereof:

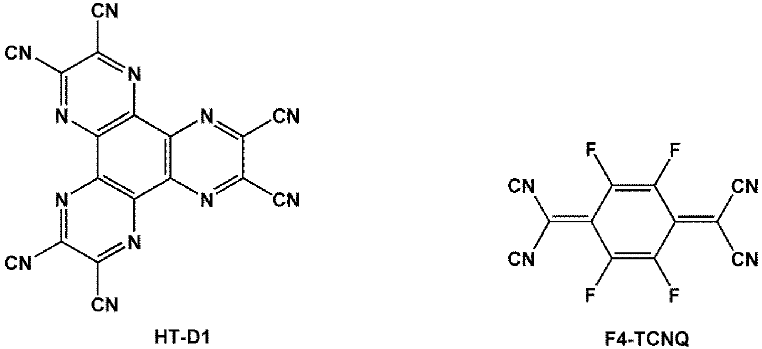

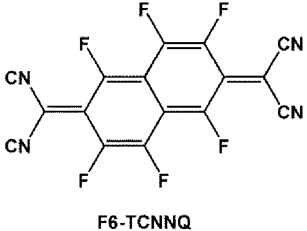

The hole transport region 120 may further include a buffer layer.

The buffer layer may compensate for an optical resonance distance according to a wavelength of light emitted from the emission layer 150 to increase efficiency.

When the hole transport region 120 includes an electron blocking layer, a material for forming the electron blocking layer may include the material that can be used in the hole transport region 120 as described above, the host material as described above, or a combination thereof. For example, when the hole transport region 120 may include an electron blocking layer, mCP, Compound H1-8 of Group 5-2, or the like may be used as a material for forming the electron blocking layer.

The emission layer 150 may be formed on the hole transport region 120 by using one or more suitable methods such as vacuum deposition, spin coating, casting, LB deposition, and/or ink-jet printing. When the emission layer 150 is formed by vacuum deposition or spin coating, the deposition or coating conditions may be similar to those applied in forming the hole injection layer although the deposition or coating conditions may vary depending on a material that is used to form the emission layer.

The emission layer 150 may include a first emission layer and a second emission layer as described herein.

In one or more embodiments, the first emission layer may include a first dopant and a first host, the first dopant may include the first compound, and an amount (weight) of the first dopant may be about 0.01 part by weight to about 20 parts by weight based on 100 parts by weight of the total weight of the first host.

In one or more embodiments, the second emission layer may include a second dopant and a second host, the second dopant may include the second compound, and an amount (weight) of the second dopant may be about 0.01 part by weight to about 20 parts by weight based on 100 parts by weight of the total weight of the second host.

A thickness of the emission layer 150 may be about 100 Å to about 1,000 Å, for example, about 200 Å to about 600 Å. When the thickness of the emission layer 150 is within this range, excellent light-emission characteristics may be obtained without a substantial increase in driving voltage.

A thickness ratio of the first emission layer to the second emission layer may be about 8:2 to about 2:8, about 7:3 to about 3:7, or about 6:4 to about 4:6.

When the organic light-emitting device 101 is a full-color light-emitting device, the emission layer 150 may be patterned into a red emission layer, a green emission layer, and/or a blue emission layer.

Next, the electron transport region 170 may be arranged on the emission layer 150.

The electron transport region 170 may include a hole blocking layer, an electron transport layer, an electron injection layer, or a combination thereof.

For example, the electron transport region 170 may have a hole blocking layer/electron transport layer/electron injection layer structure, a hole blocking layer/electron transport layer, or an electron transport layer/electron injection layer structure. The electron transport layer may have a single-layered structure or a multi-layered structure including two or more different materials.

The conditions for the formation of the hole blocking layer, the electron transport layer, and the electron injection layer in the electron transport region 170 are as the conditions for the formation of the hole injection layer.

When the electron transport region 170 includes a hole blocking layer, the hole blocking layer may include, for example, 2,9-dimethyl-4,7-diphenyl-1,10-phenanthroline (BCP), 4,7-diphenyl-1,10-phenanthroline (Bphen), bis(2-methyl-8-quinolinolato-N1,O8)-(1,1'-biphenyl-4-olato)aluminum (BAlq), or a combination thereof:

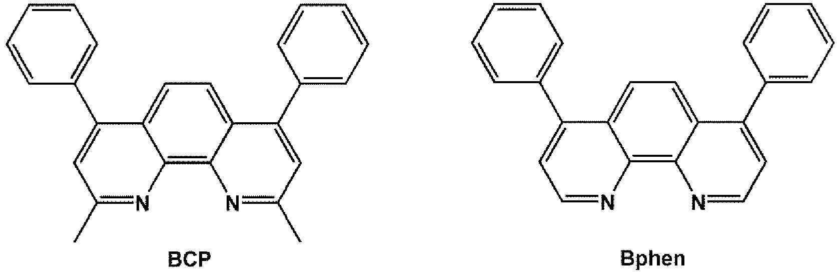

In one or more embodiments, the hole blocking layer may include any host material, and a material for an electron transport layer, a material for an electron injection layer, or a combination thereof, which will be described later.

A thickness of the hole blocking layer may be about 20 Å to about 1,000 Å, for example, about 30 Å to about 600 Å. When the thickness of the hole blocking layer is within this range, excellent hole blocking characteristics may be obtained without a substantial increase in driving voltage.

The electron transport layer may include BCP, Bphen, 1,3,5-tri(1-phenyl-1H-benzo[d]imidazol-2-yl)benzene (TPBi), tris(8-hydroxy-quinolinato)aluminum (Alq₃), BAlq, 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), or a combination thereof:

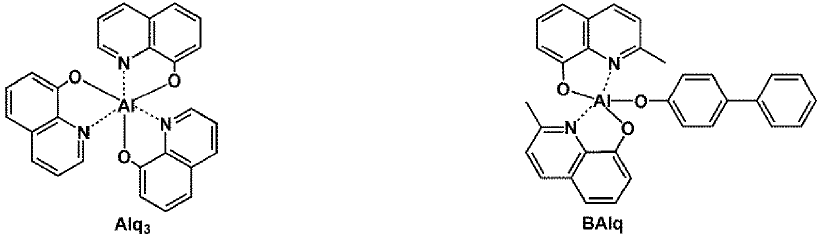

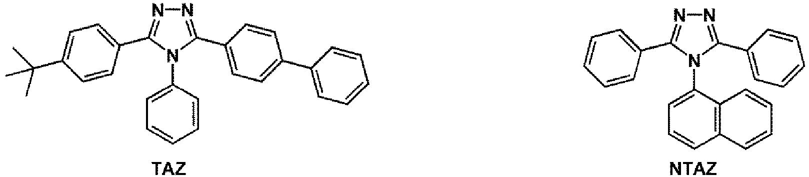

In one or more embodiments, the electron transport layer may include one of Compounds ET1 to ET25 or a combination thereof:

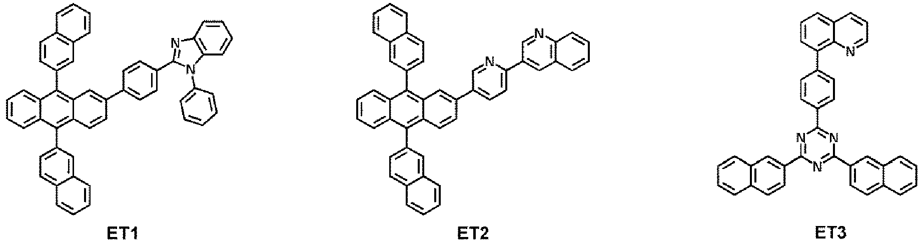

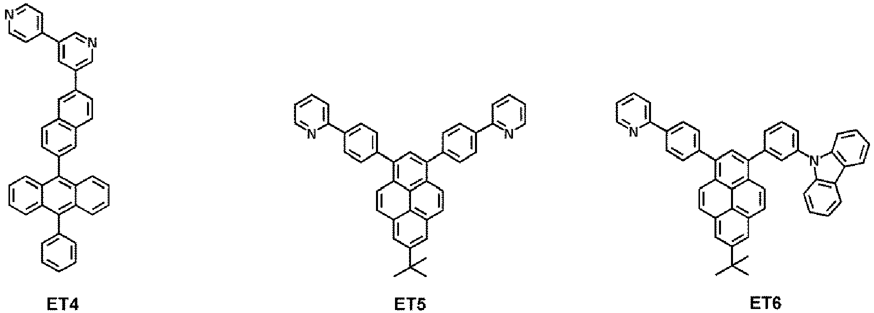

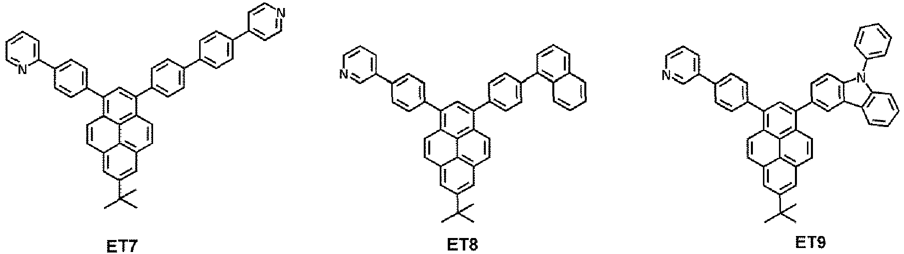

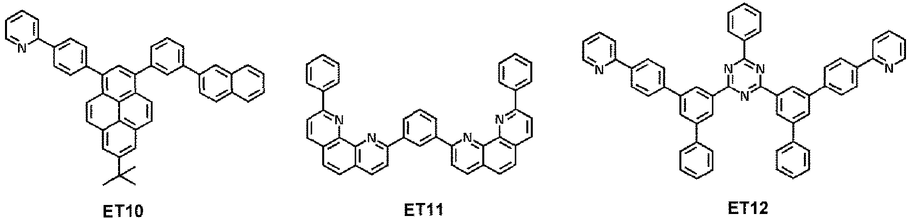

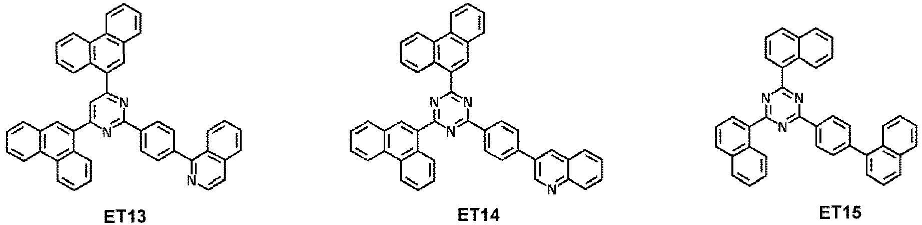

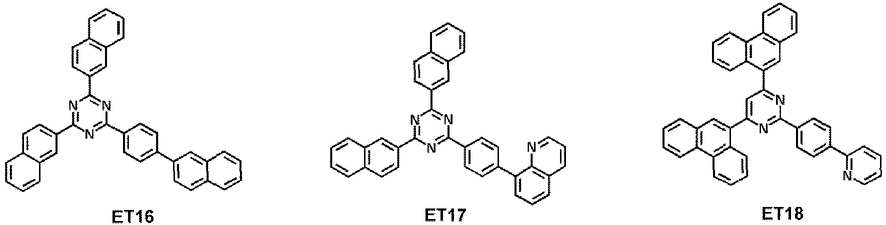

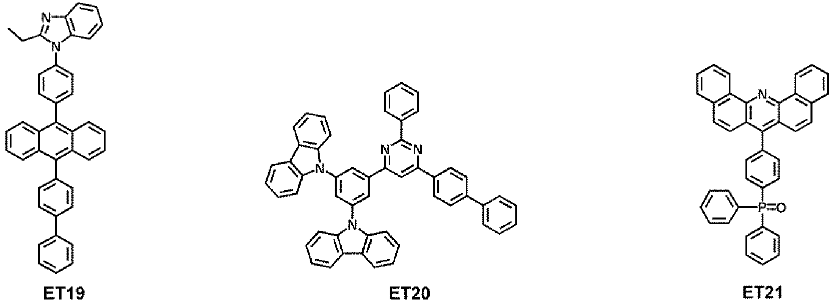

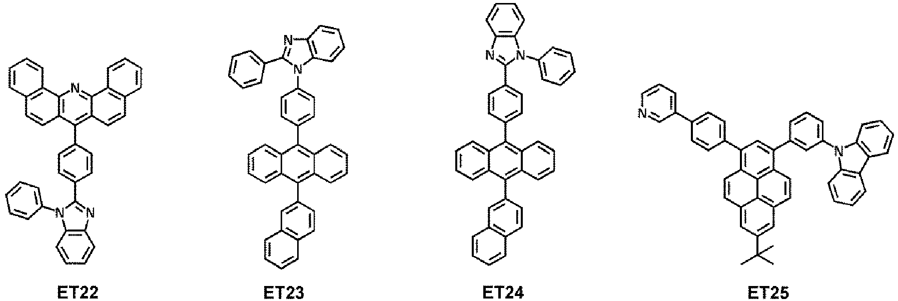

A thickness of the electron transport layer may be about 100 Å to about 1,000 Å, for example, about 150 Å to about 500 Å. When the thickness of the electron transport layer is within this range, satisfactory electron transporting characteristics may be obtained without a substantial increase in driving voltage.

The electron transport layer may include, in addition to the materials described above, a metal-containing material.

The metal-containing material may include a Li complex. The Li complex may include, for example, at least one of Compounds ET-D1 or ET-D2:

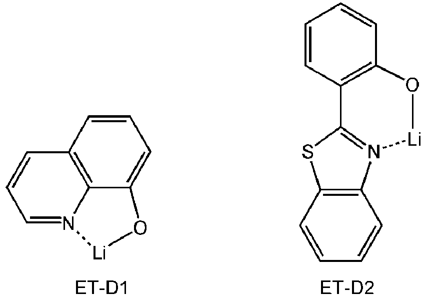

In one or more embodiments, the electron transport region 170 may include an electron injection layer that facilitates injection of electrons from the second electrode 190.

The electron injection layer may include at least one of LiF, NaCl, CsF, Li₂O, BaO, Yb, Compound ET-D1, Compound ET-D2, or a combination thereof.

A thickness of the electron injection layer may be about 1 Å to about 100 Å, for example, about 3 Å to about 90 Å. When the thickness of the electron injection layer is within this range, satisfactory electron injection characteristics may be obtained without a substantial increase in driving voltage.

The second electrode 190 may be arranged on the electron transport region 170. The second electrode 190 may be a cathode. A material for forming the second electrode 190 may be a metal, an alloy, an electrically conductive compound, or a combination thereof, which have a relatively low work function. For example, lithium (Li), magnesium (Mg), aluminum (Al), silver (Ag), aluminum-lithium (Al-Li), calcium (Ca), magnesium-indium (Mg-In), magnesium-silver (Mg-Ag), or the like may be used as the material for forming the second electrode 190. In one or more embodiments, to manufacture a top-emission type light-emitting device, a transparent or semi-transparent electrode formed using ITO or IZO may be used as the second electrode 190.

### Description of FIG. 2

FIG. 2 is a schematic view of an organic light-emitting device 100 according to one or more embodiments.

The organic light-emitting device 100 of FIG. 2 may include a first electrode 110, a second electrode 190 facing the first electrode 110, and a first light-emitting unit 151 and a second light-emitting unit 152 which are stacked between the first electrode 110 and the second electrode 190. A charge generation layer 141 may be arranged between the first light-emitting unit 151 and the second light-emitting unit 152. The charge generation layer 141 may include an n-type charge generation layer, a p-type charge generation layer, or a combination thereof. The charge generation layer 141 is a layer that generates charges and supplies the charges to neighboring light-emitting units, and any known charge generation material may be used therefor.

The first light-emitting unit 151 may include an emission layer 1 151-EM, and the second light-emitting unit 152 may include an emission layer 2 152-EM.

For example, the emission layer 1 151-EM may be the first emission layer as described herein, and the emission layer 2 152-EM may be the second emission layer as described herein.

In one or more embodiments, the emission layer 1 151-EM may be the second emission layer as described herein, and the emission layer 2 152-EM may be the first emission layer as described herein.

The hole transport region 120 may be arranged between the first light-emitting unit 151 and the first electrode 110, and the second light-emitting unit 152 may include a second hole transport region 122 arranged on the side of the first electrode 110.

An electron transport region 170 may be arranged between the second light-emitting unit 152 and the second electrode 190, and the first light-emitting unit 151 may include a first electron transport region 171 arranged between the charge generation layer 141 and the emission layer 1 151-EM.

The first electrode 110 and the second electrode 190 illustrated in FIG. 2 are as described in connection with the first electrode 110 and the second electrode 190 illustrated in FIG. 1, respectively.

The hole transport region 120 and the second hole transport region 122 illustrated in FIG. 2 are each as described in connection with the hole transport region 120 illustrated in FIG. 1.

The electron transport region 170 and the first electron transport region 171 illustrated in FIG. 2 are each as described in connection with the electron transport region 170 illustrated in FIG. 1.

Hereinbefore, one or more examples of a tandem light-emitting device has been described with reference to FIG. 2. However, the tandem light-emitting device may have various other forms. For example, the tandem light-emitting device may include three or more light-emitting units.

### Explanation of terms

The term "C₁-C₆₀ alkyl group" as used herein refers to a linear or branched saturated aliphatic hydrocarbons monovalent group having 1 to 60 carbon atoms, and the term "C₁-C₆₀ alkylene group_{"} as used herein refers to a divalent group having the same structure as the C₁-C₆₀ alkyl group.

Non-limiting examples of the C₁-C₆₀ alkyl group, the C₁-C₂₀ alkyl group, and/or the C₁-C₁₀ alkyl group may include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof. For example, Formula 9-33 is a branched C₆ alkyl group, for example, a tert-butyl group that is substituted with two methyl groups.

The term "C₁-C₆₀ alkoxy group" as used herein refers to a monovalent group represented by -OA₁₀₁ (wherein A₁₀₁ is the C₁-C₆₀ alkyl group), and non-limiting examples thereof may include a methoxy group, an ethoxy group, a propoxy group, a butoxy group, and a pentoxy group.

The term "C₁-C₆₀ alkylthio group" as used herein refers to a monovalent group represented by -SA₁₀₁ (wherein A₁₀₁ is the C₁-C₆₀ alkyl group).

The term "C₂-C₆₀ alkenyl group" as used herein refers to a hydrocarbon group formed by substituting at least one carbon-carbon double bond in the middle or at the terminus of the C₂-C₆₀ alkyl group, and non-limiting examples thereof include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by substituting at least one carbon-carbon triple bond in the middle or at the terminus of the C₂-C₆₀ alkyl group, and non-limiting examples thereof include an ethynyl group and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms, and the term "C₃-C₁₀ cycloalkylene group" as used herein refers to a divalent group having the same structure as the C₃-C₁₀ cycloalkyl group. Non-limiting examples of the C₃-C₁₀ cycloalkyl group may include a cyclopropyl group, a cyclobutyl group, a cyclopentyl, cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, and a bicyclo[2.2.2]octyl group.

The term "C₁-C₁₀ heterocycloalkyl group" as used herein refers to a monovalent saturated cyclic group that includes at least one heteroatom selected from N, O, P, Si, S, Se, Ge, and B as a ring-forming atom and 1 to 10 carbon atoms, and the term "C₁-C₁₀ heterocycloalkylene group" as used herein refers to a divalent group having the same structure as the C₁-C₁₀ heterocycloalkyl group. Non-limiting examples of the C₁-C₁₀ heterocycloalkyl group may include a silolanyl group, a silinanyl group, tetrahydrofuranyl group, a tetrahydro-2H-pyranyl group, and a tetrahydrothiophenyl group.

The term "C₃-C₁₀ cycloalkenyl group" as used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one heteroatom selected from N, O, P, Si, S, Se, Ge, and B as a ring-forming atom, 1 to 10 carbon atoms, and at least one double bond in its ring. Non-limiting examples of the C₁-C₁₀ heterocycloalkenyl group include a 2,3-dihydrofuranyl group and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Non-limiting examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the rings may be fused to each other.

The term "C₇-C₆₀ alkyl aryl group" used herein refers to a C₆-C₆₀ aryl group substituted with at least one C₁-C₆₀ alkyl group.

The term "C₇-C₆₀ aryl alkyl group" used herein refers to a C₁-C₆₀ alkyl group substituted with at least one C₆-C₆₀ aryl group.

The term "C₁-C₆₀ heteroaryl group" as used herein refers to a monovalent group that includes a cyclic aromatic system having at least one heteroatom selected from N, O, P, Si, S, Se, Ge, and B as a ring-forming atom and 1 to 60 carbon atoms, and the term "C₁-C₆₀ heteroarylene group" as used herein refers to a divalent group that includes a cyclic aromatic system having at least one heteroatom selected from N, O, P, Si, S, Se, Ge, and B as a ring-forming atom and 1 to 60 carbon atoms. Non-limiting examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₆-C₆₀ heteroaryl group and the C₆-C₆₀ heteroarylene group each include two or more rings, the rings may be fused to each other.

The term "C₂-C₆₀ alkyl heteroaryl group" as used herein refers to a C₁-C₆₀ heteroaryl group substituted with at least one C₁-C₆₀ alkyl group. The term "C₂-C₆₀ heteroaryl alkyl group" as used herein refers to a C₁-C₆₀ alkyl group substituted with at least one C₁-C₆₀ heteroaryl group.

The term "C₆-C₆₀ aryloxy group" as used herein indicates -OA₁₀₂ (wherein A₁₀₂ is the C₆-C₆₀ aryl group), and the term "C₆-C₆₀ arylthio group" as used herein indicates - SA₁₀₃ (wherein A₁₀₃ is the C₆-C₆₀ aryl group).

The term "C₁-C₆₀ heteroaryloxy group" as used herein indicates -OA_{102'} (wherein A_{102'} is the C₁-C₆₀ heteroaryl group), and the term "C₁-C₆₀ heteroarylthio group" as used herein indicates -SA_{103'} (wherein A_{103'} is the C₁-C₆₀ heteroaryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Non-limiting examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 1 to 60 carbon atoms) having two or more rings condensed to each other, at least one heteroatom selected from N, O, P, Si, S, Se, Ge, and B, other than carbon atoms, as a ring-forming atom, and no aromaticity in its entire molecular structure. Non-limiting examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "C₅-C₃₀ carbocyclic group" as used herein refers to a saturated or unsaturated cyclic group including 5 to 30 carbon atoms only as ring-forming atoms. The C₅-C₃₀ carbocyclic group may be a monocyclic group or a polycyclic group. Non-limiting examples of the "C₅-C₃₀ carbocyclic group (unsubstituted or substituted with at least one R₁₀ₐ)" used herein include an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, and a fluorene group (each unsubstituted or substituted with at least one R₁₀ₐ).

The term "C₁-C₃₀ heterocyclic group" as used herein refers to a saturated or unsaturated cyclic group having, as a ring-forming atom, at least one heteroatom selected from N, O, P, Si, S, Se, Ge, and B other than 1 to 30 carbon atoms as ring forming atoms. The C₁-C₃₀ heterocyclic group may be a monocyclic group or a polycyclic group. The "C₁-C₃₀ heterocyclic group (unsubstituted or substituted with at least one R₁₀ₐ)" may be, for example, a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group (each unsubstituted or substituted with at least one R₁₀ₐ).

In one or more embodiments, examples of the "C₅-C₃₀ carbocyclic group" and "C₁-C₃₀ heterocyclic group" as used herein include i) a first ring, ii) a second ring, iii) a condensed ring in which two or more first rings are condensed with each other, iv) a condensed ring in which two or more second rings are condensed with each other, or v) a condensed ring in which at least one first ring and at least one second ring are condensed with each other,
the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

The terms "fluorinated C₁-C₆₀ alkyl group (or, a fluorinated C₁-C₂₀ alkyl group or the like)", "fluorinated C₃-C₁₀ cycloalkyl group", "fluorinated C₁-C₁₀ heterocycloalkyl group," and "fluorinated phenyl group" as used herein respectively refer to a C₁-C₆₀ alkyl group (or, a C₁-C₂₀ alkyl group, or the like), a C₃-C₁₀ cycloalkyl group, a C₁-C₁₀ heterocycloalkyl group, and a phenyl group, each substituted with at least one fluoro group (-F). For example, the term "fluorinated C₁ alkyl group (that is, a fluorinated methyl group)" includes -CF₃, -CF₂H, and -CFH₂. The "fluorinated C₁-C₆₀ alkyl group (or, a fluorinated C₁-C₂₀ alkyl group, or the like)", "the fluorinated C₃-C₁₀ cycloalkyl group", "the fluorinated C₁-C₁₀ heterocycloalkyl group", or "the fluorinated a phenyl group" may be i) a fully fluorinated C₁-C₆₀ alkyl group (or, a fully fluorinated C₁-C₂₀ alkyl group, or the like), a fully fluorinated C₃-C₁₀ cycloalkyl group, a fully fluorinated C₁-C₁₀ heterocycloalkyl group, or a fully fluorinated phenyl group, wherein, in each group, all hydrogen included therein is substituted with a fluoro group, or ii) a partially fluorinated C₁-C₆₀ alkyl group (or, a partially fluorinated C₁-C₂₀ alkyl group, or the like), a partially fluorinated C₃-C₁₀ cycloalkyl group, a partially fluorinated C₁-C₁₀ heterocycloalkyl group, or a partially fluorinated phenyl group, wherein, in each group, all hydrogen atoms included therein are not substituted with a fluoro group.

The terms "deuterated C₁-C₆₀ alkyl group (or, a deuterated C₁-C₂₀ alkyl group, or the like)", "deuterated C₃-C₁₀ cycloalkyl group", "deuterated C₁-C₁₀ heterocycloalkyl group," and "deuterated phenyl group" as used herein respectively refer to a C₁-C₆₀ alkyl group (or, a C₁-C₂₀ alkyl group, or the like), a C₃-C₁₀ cycloalkyl group, a C₁-C₁₀ heterocycloalkyl group, and a phenyl group, each substituted with at least one deuterium. For example, the "deuterated C₁ alkyl group (that is, a deuterated methyl group)" may include -CD₃, -CD₂H, and -CDH₂, and examples of the "deuterated C₃-C₁₀ cycloalkyl group" are, for example, Formula 10-501, or the like. The "deuterated C₁-C₆₀ alkyl group (or, the deuterated C₁-C₂₀ alkyl group, or the like)", "the deuterated C₃-C₁₀ cycloalkyl group", "the deuterated C₁-C₁₀ heterocycloalkyl group", or "the deuterated phenyl group" may be i) a fully deuterated C₁-C₆₀ alkyl group (or, a fully deuterated C₁-C₂₀ alkyl group, or the like), a fully deuterated C₃-C₁₀ cycloalkyl group, a fully deuterated C₁-C₁₀ heterocycloalkyl group, or a fully deuterated phenyl group, in which, in each group, all hydrogen included therein are substituted with deuterium, or ii) a partially deuterated C₁-C₆₀ alkyl group (or, a partially deuterated C₁-C₂₀ alkyl group, or the like), a partially deuterated C₃-C₁₀ cycloalkyl group, a partially deuterated C₁-C₁₀ heterocycloalkyl group, or a partially deuterated phenyl group, in which, in each group, all hydrogen included therein are not substituted with deuterium.

The term "(C₁-C₂₀ alkyl) 'X' group" as used herein refers to a 'X' group that is substituted with at least one C₁-C₂₀ alkyl group. For example, the term "(C₁-C₂₀ alkyl)C₃-C₁₀ cycloalkyl group" as used herein refers to a C₃-C₁₀ cycloalkyl group substituted with at least one C₁-C₂₀ alkyl group, and the term "(C₁-C₂₀ alkyl)phenyl group" as used herein refers to a phenyl group substituted with at least one C₁-C₂₀ alkyl group. An example of a (C₁ alkyl)phenyl group is a toluyl group.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" respectively refer to heterocyclic groups having the same backbones as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, and a dibenzothiophene 5,5-dioxide group," in which, in each group, at least one carbon atom selected from ring-forming carbon atoms is substituted with a nitrogen atom.

At least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group may be:
deuterium, -F, -Cl, -Br, -I, -SFs, -CD₃, -CD₂H, -CDH₂, -CF₃, -CF₂H, -CFH₂, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SFs, -CD₃, -CD₂H, -CDH₂, -CF₃, -CF₂H, -CFH₂, a hydroxyl group, a cyano group, a nitro group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -Ge(Q₁₃)(Q₁₄)(Q₁₅), -B(Q₁₆)(Q₁₇), - P(=O)(Q₁₈)(Q₁₉), -P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, -F, -Cl, -Br, -I, -SF₅, - CD₃, -CD₂H, -CDH₂, -CF₃, -CF₂H, -CFH₂, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -Ge(Q₂₃)(Q₂₄)(Q₂₅), -B(Q₂₆)(Q₂₇), - P(=O)(Q₂₈)(Q₂₉), -P(Q₂₈)(Q₂₉), or a combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
a combination thereof.

Q₁ to Q₉, Q₁₁ to Q₁₉, Q₂₁ to Q₂₉, and Q₃₁ to Q₃₉ herein may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

For example, Q₁ to Q₉, Q₁₁ to Q₁₉, Q₂₁ to Q₂₉, and Q₃₁ to Q₃₉ herein may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or - CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, a C₁-C₁₀ alkyl group, a phenyl group, or a combination thereof.

Hereinafter, a light-emitting device according to one or more exemplary embodiments are described in further detail with reference to Examples. However, the embodiments are not limited to the following examples.

### EXAMPLES

### Evaluation Example 1

The HOMO energy levels of Ir-1 and Pt-1 were measured by using differential pulse voltammetry using ferrocene as a reference material, and the results are shown in Table 1. In detail, Bu₄NPF₆ at a concentration of 0.1 moles per liter (molar, M) was dissolved in dichloromethane, and was used as an electrolyte. The following measurement conditions were used: a pulse height of 50 millivolts (mV), a pulse width of 1 second, a step height of 10 mV, a step width of 2 seconds, and a scan rate of 5 millivolts per second (mV/sec). Ag/AgNO₃ was used as a reference electrode, thereby obtaining a potential(Volts, V)-current(milliamperes, mA) graph of each compound. Then, Eₚₑₐₖ(eV), which is an oxidation peak potential of the graph, was evaluated. Subsequently, Eₚₑₐₖ(eV) was substituted for Eₚₑₐₖ in Equation 1 to obtain the HOMO energy level (eV) of each compound : $HOMO \left(eV\right) = - 4.8 - \left({E}_{peak}-{E}_{peak}\left(Ferrocene\right)\right)$

**Table 1**

| Compound | HOMO energy level (eV) |
|---|---|
| Ir-1 | -5.155 |
| Pt-1 | -5.240 |

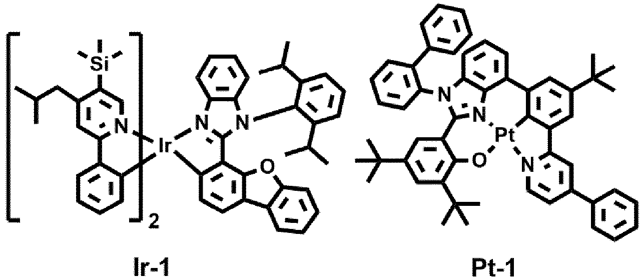

### Evaluation Example 2

Dipole moments of Ir-1 and Pt-1 were calculated by performing DFT calculations using the Gaussian 16 program, wherein the molecular structures of Ir-1 and Pt-1 were each optimized by using the B3LYP/LanL2DZ function for a metal included in each of Ir-1 and Pt-1 and using the B3LYP/6-31G(D,P) function for an organic ligand included in each of Ir-1 and Pt-1. The results are summarized in Table 2.

**Table 2**

| Compound | Dipole moment (debye) |
|---|---|
| Ir-1 | 5.52 |
| Pt-1 | 1.76 |

### Evaluation Example 3

On a quartz substrate, compounds shown in Table 3 were vacuum co-deposited at a vacuum pressure of 10⁻⁷ torr and at a weight ratio as shown in Table 3 to manufacture films A and B, with each having a thickness of 40 nm. Compound HT(1) is a compound which is identical to Compound H1-8 of Group 5-2.

Subsequently, an emission spectrum of each of the films A and B were measured using a QUANTAURUS-QY Absolute PL quantum yield spectrometer on which a xenon light source, a monochromator, a photonic multichannel analyzer, and an integrating sphere were mounted, and which included PLQY measurement software (Hamamatsu Photonics, Ltd., Shizuoka, Japan). During the measurements, an excitation wavelength was scanned from 320 nm to 380 nm at 10 nm intervals, and a spectrum measured at the excitation wavelength of 320 nm was taken. Emission peak wavelengths of Ir-1 and Pt-1 included in the films A and B were evaluated and the results are shown in Table 3.

**Table 3**

| Film no. | Film composition (weight ratio) | Emission peak wavelength (nm) |
|---|---|---|
| A | HT(1) : E1-62 : Ir-1 (63:27:10) | 529 |
| B | HT(1) : E1-62 : Pt-1 (66.5:28.5:5) | 526 |

### Manufacture of OLED 1 (Pt-Pt) (comparative example not according to the invention)

A glass substrate with ITO/Ag/ITO (as an anode) deposited thereon to a thickness of 70/1,000/70 Å was cut to a size of 50 millimeters (mm) x 50 mm x 0.5 mm, sonicated with isopropyl alcohol and deionized (DI) water for 5 minutes each, and then cleaned by irradiation of ultraviolet (UV) rays and exposure of ozone for 30 minutes. Then, the resultant glass substrate was loaded onto a vacuum deposition apparatus.

HT3 and F6-TCNNQ were co-deposited on the anode at a weight ratio of 98:2 to form a hole injection layer (HIL) having a thickness of 10 nm, HT3 was deposited on the hole injection layer to form a hole transport layer (HTL) having a thickness of 25 nm, and HT(1) was vacuum-deposited on the hole transport layer to form an electron blocking layer (EBL) having a thickness of 5 nm.

Subsequently, a dopant (Pt-1) and a host (HT(1) and E1-62) were co-deposited on the EBL to form an emission layer-1 (EML-1) having a thickness of 33 nm. The amount of the dopant in the EML-1 was 15 parts by weight based on 100 parts by weight of EML-1, and the weight ratio of HT(1) to E1-62 in the EML-1 was 7:3.

Thereafter, ET3 was vacuum-deposited on the EML-1 to form an electron transport layer-1 (ETL-1) having a thickness of 15 nm, and ET3 and ytterbium (Yb) were co-deposited on the ETL-1 at a weight ratio of 97:3 to form a charge generation layer having a thickness of 10 nm.

Subsequently, HT3 was vacuum-deposited on the charge generation layer to form a hole transport layer-2 (HTL-2) having a thickness of 25 nm, and then, HT(1) was vacuum-deposited on the HTL-2 to form an electron blocking layer-2 (EBL-2) having a thickness of 5 nm.

Subsequently, a dopant (Pt-1) and a host (HT(1) and E1-62) were co-deposited on the EBL-2 to form an emission layer-2 (EML-2) having a thickness of 33 nm. The amount of the dopant in the EML-2 was 15 parts by weight based on 100 parts by weight of EML-2, and the weight ratio of HT(1) to E1-62 in the EML-2 was 7:3.

Thereafter, ET3 was vacuum-deposited on the EML-2 to form a hole blocking layer (HBL) having a thickness of 5 nm, ET3 and ET-D1 were co-deposited on the HBL at a volume ratio of 50:50 to form an electron transport layer (ETL) having a thickness of 31 nm, and Mg and Ag were co-deposited on the ETL at a weight ratio of 90:10 to form a cathode having a thickness of 12 nm, thereby completing the manufacture of an organic light-emitting device.

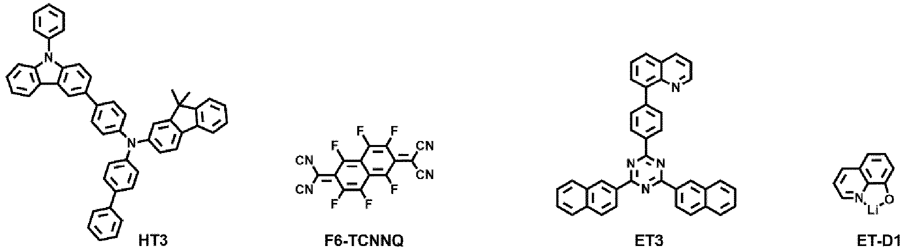

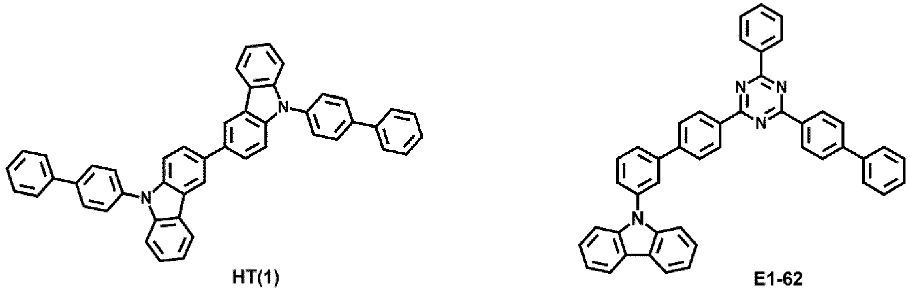

### Manufacture of OLED 2 (Ir-Pt) (example according to the invention)

OLED 2 (Ir-Pt) was manufactured in a similar manner as used to manufacture OLED 1 (Pt-Pt), except that Ir-1 was used instead of Pt-1 as a dopant in forming an EML-1, and the amount of the dopant in the EML-1 was changed to 7 parts by weight based on 100 parts by weight of the EML-1.

### Manufacture of OLED 3 (Pt-Ir) (example according to the invention)

OLED 3 (Pt-Ir) was manufactured in a similar manner as used to manufacture OLED 1 (Pt-Pt), except that Ir-1 was used instead of Pt-1 as a dopant in forming an EML-2, and the amount of the dopant in the EML-2 was changed to 7 parts by weight based on 100 parts by weight of the EML-2.

### Manufacture of OLED 4 (Ir-Ir) (comparative example not according to the invention)

OLED 4 (Ir-Ir) was manufactured in a similar manner as used to manufacture OLED 1 (Pt-Pt), except that Ir-1 was used instead of Pt-1 as a dopant in forming each of an EML-1 and an EML-2, and the amount of the dopant in each of the EML-1 and the EML-2 was changed to 7 parts by weight based on 100 parts by weight of each of the EML-1 and the EML-2.

The configurations of layers of each of OLED 1 (Pt-Pt), OLED 2 (Ir-Pt), OLED 3 (Pt-Ir) and OLED 4 (Ir-Ir) are summarized in Table 4:

**Table 4**

| | | OLED 1 (Pt-Pt) | OLED 2 (Ir-Pt) | OLED 3 (Pt-Ir) | OLED 4 (Ir-Ir) |
|---|---|---|---|---|---|
| Cathode (12 nm) | | Mg : Ag | Mg : Ag | Mg : Ag | Mg : Ag |
| ETL (31 nm) | | ET3 : ET-D1 | ET3 : ET-D1 | ET3 : ET-D1 | ET3 : ET-D1 |
| HBL (5 nm) | | ET3 | ET3 | ET3 | ET3 |
| EML-2 (33 nm) | Dopant | Pt-1 (15 wt%) | Pt-1 (15 wt%) | Ir-1 (7 wt%) | Ir-1 (7 wt%) |
| | Host | HT(1) : E1-62 | HT(1) : E1-62 | HT(1) : E1-62 | HT(1) : E1-62 |
| EBL-2 (5 nm) | | HT(1) | HT(1) | HT(1) | HT(1) |
| HTL-2 (25 nm) | | HT3 | HT3 | HT3 | HT3 |
| Charge generation layer (10 nm) | | ET3 : Yb | ET3 : Yb | ET3 : Yb | ET3 : Yb |
| ETL-1 (15 nm) | | ET3 | ET3 | ET3 | ET3 |
| EML-1 (33 nm) | Dopant | Pt-1 (15 wt%) | Ir-1 (7 wt%) | Pt-1 (15 wt%) | Ir-1 (7 wt%) |
| | Host | HT(1) : E1-62 | HT(1) : E1-62 | HT(1) : E1-62 | HT(1) : E1-62 |
| EBL (5 nm) | | HT(1) | HT(1) | HT(1) | HT(1) |
| HTL (25 nm) | | HT3 | HT3 | HT3 | HT3 |
| HIL (10 nm) | | HT3 : F6-TCNNQ | HT3 : F6-TCNNQ | HT3 : F6-TCNNQ | HT3 : F6-TCNNQ |
| Anode | | ITO/Ag/ITO | ITO/Ag/ITO | ITO/Ag/ITO | ITO/Ag/ITO |

### Evaluation Example 4

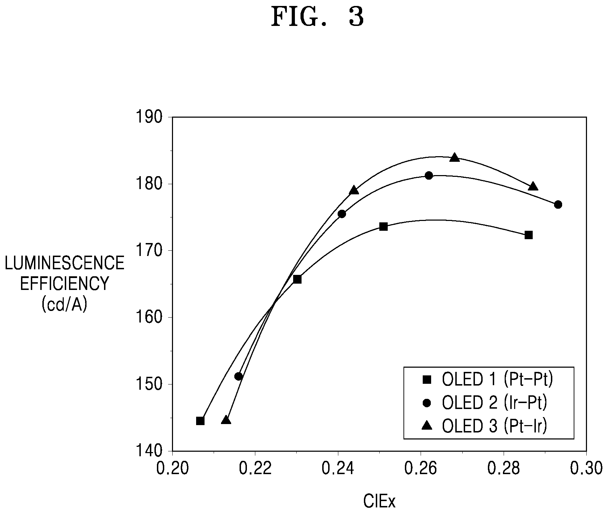

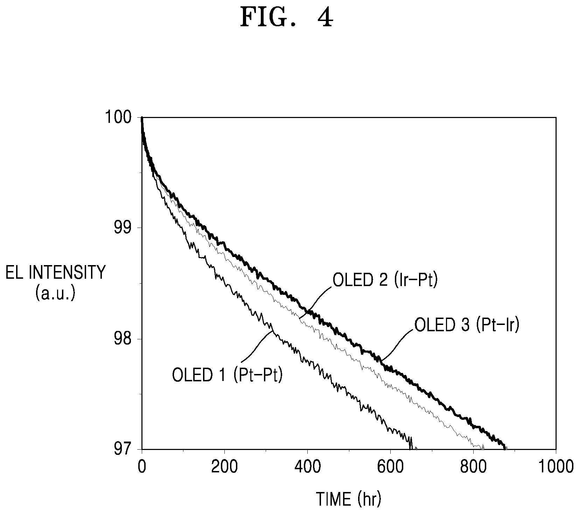

The luminescence efficiency (at CIEx = 0.26) (cd/A) and lifespan (T₉₇) (hr) of each of OLED 1 (Pt-Pt), OLED 2 (Ir-Pt), and OLED 3 (Pt-Ir) were evaluated, and the results are summarized in Table 5. As an evaluation device, a current-voltmeter (Keithley 2400) and a luminance meter (Minolta Cs-1000A) were used, and the lifespan (T₉₇) (at 15,000 candela per square meter (cd/m²) was evaluated as the time taken for luminance to reduce to 97% of 100% of the initial luminance. FIGS. 3 and 4 respectively show the x-color coordinate-luminescence efficiency graph and the time-emission intensity graph of each of OLED 1 (Pt-Pt), OLED 2 (Ir-Pt), and OLED 3 (Pt-Ir). The luminescence efficiency and the lifespan in Table 5 as well as the emission intensity in FIG. 4 are each expressed as a relative value (%).

**Table 5**

| | Luminescence efficiency (at CIEx = 0.26) (relative value, %) | Lifespan (T₉₇) (at 15,000 cd/m²) (relative value, %) |
|---|---|---|
| OLED 1 (Pt-Pt) | 100 | 100 |
| OLED 2 (Ir-Pt) | 104 | 122 |
| OLED 3 (Pt-Ir) | 105 | 129 |

From Table 5, it may be confirmed that OLED 2 (Ir-Pt) and OLED 3 (Pt-Ir) have superior luminescence efficiency and lifespan characteristics compared to OLED 1 (Pt-Pt). From FIG. 4, it may be confirmed that OLED 2 (Ir-Pt) and OLED 3 (Pt-Ir) have superior emission intensity according to time compared to OLED 1 (Pt-Pt).

### Evaluation Example 5

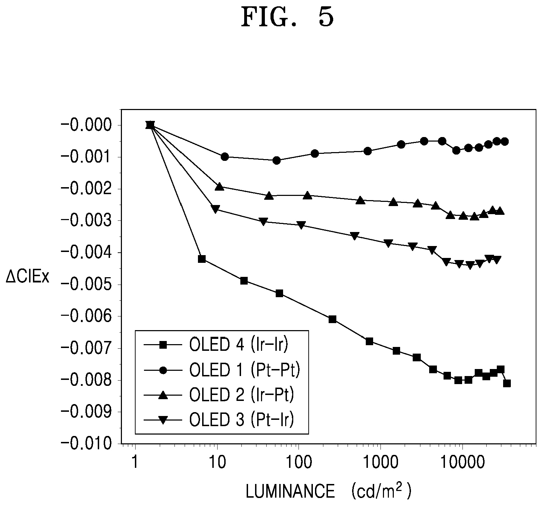

ΔCIEx according to luminance change in the range of 2 cd/m² to 15,000 cd/m² of each of OLED 4 (Ir-Ir), OLED 2 (Ir-Pt), OLED 3 (Pt-Ir), and OLED 1 (Pt-Pt) were evaluated, and the minimum values of ΔCIEx (that is, ΔCIEx having the maximum absolute value) of each device are summarized in Table 6. ΔCIEx was evaluated by calculating CIEx(1) - CIEx(2) at a corresponding luminance for each device, wherein CIEx(1) is a CIEx value of each device at the luminance of 2 cd/m², and CIEx(2) is a CIEx value of each device at the corresponding luminance. The evaluation was performed using a current-voltmeter (Keithley 2400) and a luminance meter (Minolta Cs-1000A). FIG. 5 shows the luminance (cd/m²)-ΔCIEx graph of each of OLED 4 (Ir-Ir), OLED 2 (Ir-Pt), OLED 3 (Pt-Ir), and OLED 1 (Pt-Pt) in the range of 2 cd/m² to 15,000 cd/m². For example, from FIG. 5, it is confirmed that "CIEx(1) - CIEx(2) at 15,000 cd/m² for OLED 4 (Ir-Ir)" is -0.008 (that is, a value of y-coordinate of the last point) and the minimum values of ΔCIEx in the range of 2 cd/m² to 15,000 cd/m² is -0.008.

**Table 6**

| | the minimum values of ΔCIEx in the range of 2 cd/m² to 15,000 cd/m² |
|---|---|
| OLED 4 (Ir-Ir) | -0.008 |
| OLED 2 (Ir-Pt) | -0.0027 |
| OLED 3 (Pt-Ir) | -0.004 |
| OLED 1 (Pt-Pt) | -0.001 |

From Table 6, it may be confirmed that OLED 2 (Ir-Pt) and OLED 3 (Pt-Ir) have a reduced amount of change in color purity as compared with OLED 4 (Ir-Ir), and thus may emit light having uniform color purity and accurate gradation in the entire range of low luminance and high luminance.

### Evaluation Example 6

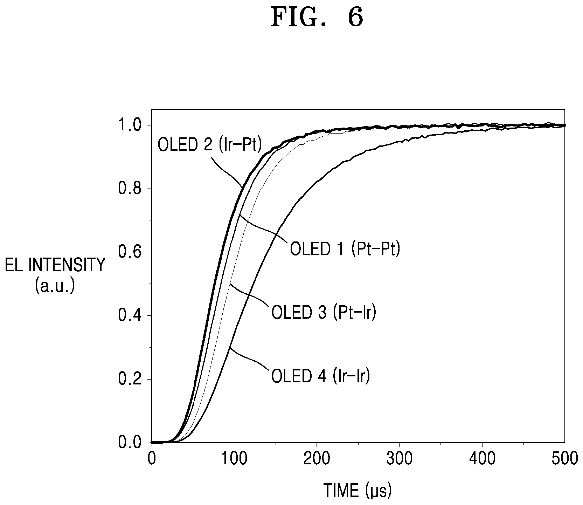

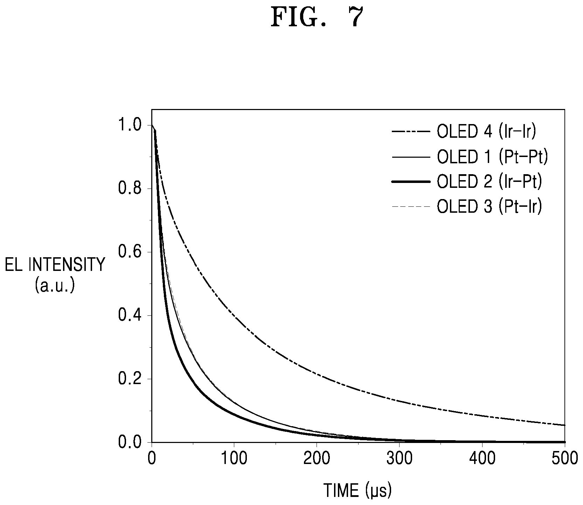

For each of OLED 4 (Ir-Ir), OLED 2 (Ir-Pt), OLED 3 (Pt-Ir), and OLED 1 (Pt-Pt), the transient electroluminescence (EL) intensity thereof was evaluated by using a Keysight DSO9104A oscilloscope while a voltage pulse was applied thereto (the width of the pulse was between 100 nanoseconds (ns) and 1 millisecond (ms)) by using a Keysight 81150A pulse function generator. Then, the turn-on time (µs), which was the time taken for luminance to increase from 10% to 90%, turn-on speed (relative value, %), turn-off time (µs), which was the time taken for luminance to decrease from 90% to 10%, and turn-off speed (relative value, %) of each device was evaluated, and the results thereof are summarized in Table 7. Turn-on speed and turn-off speed are defined by the changing speeds of the EL intensities according to time. FIGS. 6 and 7 show the evaluation results of the transient EL intensity (time-EL intensity graph) of each of OLED 4 (Ir-Ir), OLED 2 (Ir-Pt), OLED 3 (Pt-Ir), and OLED 1 (Pt-Pt).

**Table 7**

| | Turn-on time (µs) | Turn-on speed (relative value, %) | Turn-off time (µs) | Turn-off speed (relative value, %) |
|---|---|---|---|---|
| OLED 4 (Ir-Ir) | 180 | 100 | 352 | 100 |
| OLED 2 (Ir-Pt) | 88 | 205 | 84 | 419 |
| OLED 3 (Pt-Ir) | 104 | 173 | 112 | 314 |
| OLED 1 (Pt-Pt) | 96 | 188 | 112 | 314 |

According to Tables 5 to 7,
1) OLED 2 (Ir-Pt) had i) improved characteristics in terms of all of luminescence efficiency, lifespan, turn-on time, turn-on speed, turn-off time, and turn-off speed as compared with OLED 1 (Pt-Pt), while having good change in color purity, and ii) had improved characteristics in terms of all of amount of change in color purity, turn-on time, turn-on speed, turn-off time, and turn-off speed, as compared with OLED 4 (Ir-Ir), and
2) OLED 3 (Pt-Ir) had i) improved characteristics in terms of both luminescence efficiency and lifespan as compared with OLED 1 (Pt-Pt), while having good change in color purity, turn-on time, turn-on speed, turn-off time, and turn-off speed, and ii) had improved characteristics in terms of all of amount of change in color purity, turn-on time, turn-on speed, turn-off time, and turn-off speed as compared with OLED 4 (Ir-Ir).

Accordingly, it may be confirmed that OLED 2 (Ir-Pt) and OLED 3 (Pt-Ir) had, as compared with OLED 1 (Pt-Pt) and OLED 4 (Ir-Ir), high-quality luminescence characteristics with comprehensive improvement in amount of change in color purity, luminescence efficiency, lifespan, turn-on time, turn-on speed, turn-off time, and turn-off speed.

The light-emitting device according to the one or more embodiments described herein may simultaneously have improved characteristics in terms of luminescence efficiency, lifespan, rate of change in color purity according to change in luminance, turn-on time and turn-off time. Accordingly, a high-quality electronic apparatus may be manufactured by using the light-emitting device.

It should be understood that the exemplary embodiments described herein should be considered in a descriptive sense and not for purposes of limitation. Descriptions of features or aspects within each exemplary embodiment should typically be considered as available for other similar features or aspects in other exemplary embodiments. While one or more exemplary embodiments have been described with reference to the figures, it will be understood by those of ordinary skill in the art that various changes in form and details may be made therein without departing from the scope as defined by the following claims.

## Claims

1. A light-emitting device (101), comprising:
a first electrode (110);
a second electrode (190) facing the first electrode; and
an interlayer arranged between the first electrode and the second electrode,
wherein the interlayer comprises a first emission layer (151-EM) and a second emission layer (152-EM),
the first emission layer comprises a first compound that emits a first light having a first spectrum,
the second emission layer comprises a second compound that emits a second light having a second spectrum,
the first compound comprises a first transition metal,
the second compound comprises a second transition metal,
|HOMO(1) - HOMO(2)| is 0.05 electron Volts to 0.4 electron Volts,
|λmax(1) - λmax(2)| is 0 nanometers to 30 nanometers,
HOMO(1) is a highest occupied molecular orbital energy level of the first compound, expressed in electron Volts,
HOMO(2) is a highest occupied molecular orbital energy level of the second compound, expressed in electron Volts,
each of HOMO(1) and HOMO(2) is a negative value measured by differential pulse voltammetry using ferrocene as a reference material,
λmax(1) is an emission peak wavelength of the first compound in the first spectrum,
λmax(2) is an emission peak wavelength of the second compound in the second spectrum,
λmax(1) and λmax(2) are evaluated from photoluminescence spectra measured for a first film and a second film, respectively,
wherein the first film is a film comprising the first compound, and
wherein the second film is a film comprising the second compound, and **characterized in that** the first transition metal and the second transition metal are different from each other.

2. The light-emitting device of claim 1, wherein |HOMO(1) - HOMO(2)| is 0.05 electron Volts to 0.3 electron Volts; and/or
wherein HOMO(1) is -5.50 electron Volts to -5.10 electron Volts; and/or
wherein HOMO(2) is -5.30 electron Volts to -5.00 electron Volts.

3. The light-emitting device of claims 1 or 2, wherein
a dipole moment of the first compound is less than 3.0 debye, and
a dipole moment of the second compound is 3.0 debye or greater.

4. The light-emitting device of any of claims 1-3, wherein |λmax(1) - λmax(2)| is 0 nanometers to 10 nanometers.

5. The light-emitting device of any of claims 1-4, wherein each of λmax(1) and λmax(2) is 510 nanometers to 540 nanometers; or
wherein each of λmax(1) and λmax(2) is 540 nanometers to 570 nanometers.

6. The light-emitting device of any of claims 1-5, wherein
the first light is green light; and
the second light is green light.

7. The light-emitting device of any of claims 1-6, wherein
the first emission layer emits green light; and
the second emission layer emits green light.

8. The light-emitting device of any of claims 1-7, wherein the first emission layer is arranged between the second emission layer and the second electrode; and/or
wherein the second emission layer is arranged between the first emission layer and the second electrode.

9. The light-emitting device of any of claims 1-8, wherein
the first transition metal is platinum, and
the second transition metal is iridium.

10. The light-emitting device of any of claims 1-9, wherein the interlayer comprises:
m light-emitting units comprising at least one emission layer; and
m-1 charge generation layers (141) arranged between two neighboring light-emitting units of the m light-emitting units,
wherein m is an integer of 2 or greater, and
wherein:
a first light-emitting unit (151) of the m light-emitting units comprises the first emission layer, and a second light-emitting unit (152) of the m light-emitting units comprises the second emission layer, or
one light-emitting unit of the m light-emitting units comprises the first emission layer and the second emission layer.

11. The light-emitting device of claim 10,
wherein the first light-emitting unit of the m light-emitting units comprises the first emission layer, and the second light-emitting unit of the m light-emitting units comprises the second emission layer,
the first light-emitting unit comprising the first emission layer emits green light, and
the second light-emitting unit comprising the second emission layer emits green light.

12. The light-emitting device of claims 10 or 11, wherein the first light-emitting unit of the m light-emitting units comprises the first emission layer, and the second light-emitting unit of the m light-emitting units comprises the second emission layer, and
the first light-emitting unit comprising the first emission layer is arranged between the second light-emitting unit comprising the second emission layer and the second electrode.

13. The light-emitting device of any of claims 10-12, wherein the first light-emitting unit of the m light-emitting units comprises the first emission layer, and the second light-emitting unit of the m light-emitting units comprises the second emission layer, and
the second light-emitting unit comprising the second emission layer is arranged between the first light-emitting unit comprising the first emission layer and the second electrode.

14. The light-emitting device of any of claims 10-13, wherein the one light-emitting unit of the m light-emitting units comprises the first emission layer and the second emission layer, and the one light-emitting unit comprising the first emission layer and the second emission layer emits green light; and/or
wherein at least one light-emitting unit of the light-emitting units emits blue light.

15. An electronic apparatus, comprising the light-emitting device of any of claims 1-14.

## Patentansprüche

1. Licht emittierende Vorrichtung (101), umfassend:
eine erste Elektrode (110);
eine zweite Elektrode (190), die der ersten Elektrode zugewandt ist; und
eine zwischen der ersten Elektrode und der zweiten Elektrode angeordnete Zwischenschicht,
wobei die Zwischenschicht eine erste Emissionsschicht (151-EM) und eine zweite Emissionsschicht (152-EM) umfasst,
die erste Emissionsschicht eine erste Verbindung umfasst, die ein erstes Licht mit einem ersten Spektrum emittiert,
die zweite Emissionsschicht eine zweite Verbindung umfasst, die ein zweites Licht mit einem zweiten Spektrum emittiert,
die erste Verbindung ein erstes Übergangsmetall umfasst,
die zweite Verbindung ein zweites Übergangsmetall umfasst,
|HOMO(1) - HOMO(2)| 0,05 Elektronvolt bis 0,4 Elektronvolt ist,
|λmax(1) - λmax(2)| 0 Nanometer bis 30 Nanometer ist,
HOMO(1) ein höchstes besetztes molekulares Orbitalenergieniveau der ersten Verbindung ist, ausgedrückt in Elektronvolt,
HOMO(2) ein höchstes besetztes molekulares Orbitalenergieniveau der zweiten Verbindung ist, ausgedrückt in Elektronvolt,
HOMO(1) und HOMO(2) jeweils ein negativer Wert sind, gemessen durch Differenzial-Puls-Voltammetrie unter Verwendung von Ferrocen als Referenzmaterial,
λmax(1) eine Emissionsspitzen-Wellenlänge der ersten Verbindung im ersten Spektrum ist,
λmax(2) eine Emissionsspitzen-Wellenlänge der zweiten Verbindung im zweiten Spektrum ist,
λmax(1) und λmax(2) aus Photolumineszenzspektren ausgewertet werden, die für einen ersten Film bzw. einen zweiten Film gemessen wurden,
wobei der erste Film ein Film ist, der die erste Verbindung umfasst, und
wobei der zweite Film ein Film ist, der die zweite Verbindung umfasst, und **dadurch gekennzeichnet, dass** sich das erste Übergangsmetall und das zweite Übergangsmetall voneinander unterscheiden.

2. Licht emittierende Vorrichtung nach Anspruch 1, wobei |HOMO(1) - HOMO(2)| 0,05 Elektronvolt bis 0,3 Elektronvolt ist; und/oder
wobei HOMO(1) -5,50 Elektronvolt bis -5,10 Elektronvolt ist; und/oder
wobei HOMO(2) -5,30 Elektronvolt bis -5,00 Elektronvolt ist.

3. Licht emittierende Vorrichtung nach Anspruch 1 oder 2, wobei
ein Dipolmoment der ersten Verbindung weniger als 3,0 Debye ist, und
ein Dipolmoment der zweiten Verbindung 3,0 Debye oder größer ist.

4. Licht emittierende Vorrichtung nach einem der Ansprüche 1-3, wobei |λmax(1) - λmax(2)| 0 Nanometer bis 10 Nanometer ist.

5. Licht emittierende Vorrichtung nach einem der Ansprüche 1-4, wobei jedes von λmax(1) und λmax(2) 510 Nanometer bis 540 Nanometer ist; oder
wobei λmax(1) und λmax(2) jeweils 540 Nanometer bis 570 Nanometer sind.

6. Licht emittierende Vorrichtung nach einem der Ansprüche 1-5, wobei
das erste Licht grünes Licht ist; und
das zweite Licht grünes Licht ist.

7. Licht emittierende Vorrichtung nach einem der Ansprüche 1-6, wobei
die erste Emissionsschicht grünes Licht emittiert; und
die zweite Emissionsschicht grünes Licht emittiert.

8. Licht emittierende Vorrichtung nach einem der Ansprüche 1-7, wobei die erste Emissionsschicht zwischen der zweiten Emissionsschicht und der zweiten Elektrode angeordnet ist; und/oder
wobei die zweite Emissionsschicht zwischen der ersten Emissionsschicht und der zweiten Elektrode angeordnet ist.

9. Licht emittierende Vorrichtung nach einem der Ansprüche 1-8, wobei
das erste Übergangsmetall Platin ist und
das zweite Übergangsmetall Iridium ist.

10. Licht emittierende Vorrichtung nach einem der Ansprüche 1-9, wobei die Zwischenschicht Folgendes umfasst:
m Licht emittierende Einheiten, die mindestens eine Emissionsschicht umfassen; und
m-1 Ladungserzeugungsschichten (141), die zwischen zwei benachbarten Licht emittierenden Einheiten der m Licht emittierenden Einheiten angeordnet sind,
wobei m für eine ganze Zahl von 2 oder mehr steht, und
wobei:
eine erste Licht emittierende Einheit (151) der m Licht emittierenden Einheiten die erste Emissionsschicht umfasst und eine zweite Licht emittierende Einheit (152) der m Licht emittierenden Einheiten die zweite Emissionsschicht umfasst, oder
eine Licht emittierende Einheit der m Licht emittierenden Einheiten die erste Emissionsschicht und die zweite Emissionsschicht umfasst.

11. Licht emittierende Vorrichtung nach Anspruch 10,
wobei die erste Licht emittierende Einheit der m Licht emittierenden Einheiten die erste Emissionsschicht umfasst und die zweite Licht emittierende Einheit der m Licht emittierenden Einheiten die zweite Emissionsschicht umfasst,
die erste Licht emittierende Einheit, die die erste Emissionsschicht umfasst, grünes Licht emittiert, und
die zweite Licht emittierende Einheit, die die zweite Emissionsschicht umfasst, grünes Licht emittiert.

12. Licht emittierende Vorrichtung nach Anspruch 10 oder 11, wobei die erste Licht emittierende Einheit der m Licht emittierenden Einheiten die erste Emissionsschicht umfasst und die zweite Licht emittierende Einheit der m Licht emittierenden Einheiten die zweite Emissionsschicht umfasst, und
die erste Licht emittierende Einheit, die die erste Emissionsschicht umfasst, zwischen der zweiten Licht emittierenden Einheit, die die zweite Emissionsschicht umfasst, und der zweiten Elektrode angeordnet ist.

13. Licht emittierende Vorrichtung nach einem der Ansprüche 10-12, wobei die erste Licht emittierende Einheit der m Licht emittierenden Einheiten die erste Emissionsschicht umfasst und die zweite Licht emittierende Einheit der m Licht emittierenden Einheiten die zweite Emissionsschicht umfasst, und
die zweite Licht emittierende Einheit, die die zweite Emissionsschicht umfasst, zwischen der ersten Licht emittierenden Einheit, die die erste Emissionsschicht umfasst, und der zweiten Elektrode angeordnet ist.

14. Licht emittierende Vorrichtung nach einem der Ansprüche 10-13, wobei die eine Licht emittierende Einheit von diesen Licht emittierenden Einheiten die erste Emissionsschicht und die zweite Emissionsschicht umfasst und die eine Licht emittierende Einheit, die die erste Emissionsschicht und die zweite Emissionsschicht umfasst, grünes Licht emittiert; und/oder
wobei mindestens eine Licht emittierende Einheit der Licht emittierenden Einheiten blaues Licht emittiert.

15. Elektronische Vorrichtung, umfassend die Licht emittierende Vorrichtung nach einem der Ansprüche 1-14.

## Revendications

1. Dispositif électroluminescent (101), comprenant :
une première électrode (110) ;
une seconde électrode (190) faisant face à la première électrode ; et
une couche intermédiaire agencée entre la première électrode et la seconde électrode,
dans lequel la couche intermédiaire comprend une première couche d'émission (151-EM) et une seconde couche d'émission (152-EM),
la première couche d'émission comprend un premier composé qui émet une première lumière présentant un premier spectre,
la seconde couche d'émission comprend un second composé qui émet une seconde lumière présentant un second spectre,
le premier composé comprend un premier métal de transition,
le second composé comprend un second métal de transition,
|HOMO(1) - HOMO(2)| est de 0,05 électronvolt à 0,4 électronvolt,
|λmax(1) - λmax(2)| est de 0 nanomètre à 30 nanomètres,
HOMO(1) est un niveau d'énergie d'orbitale moléculaire occupée la plus élevée du premier composé, exprimé en électronvolts,
HOMO(2) est un niveau d'énergie d'orbitale moléculaire occupée la plus élevée du second composé, exprimé en électronvolts,
chacun de HOMO(1) et HOMO(2) est une valeur négative mesurée par voltamétrie impulsionnelle différentielle en utilisant du ferrocène comme matériau de référence,
λmax(1) est une longueur d'onde de pic d'émission du premier composé dans le premier spectre,
λmax(2) est une longueur d'onde de pic d'émission du second composé dans le second spectre,
λmax(1) et λmax(2) sont évalués à partir de spectres de photoluminescence mesurés pour un premier film et un second film, respectivement,
dans lequel le premier film est un film comprenant le premier composé, et
dans lequel le second film est un film comprenant le second composé, et
**caractérisé en ce que** le premier métal de transition et le second métal de transition sont différents l'un de l'autre.

2. Dispositif électroluminescent de la revendication 1, dans lequel |HOMO(1) - HOMO(2)| est de 0,05 électronvolt à 0,3 électronvolt ; et/ou
dans lequel HOMO(1) est de -5,50 électronvolts à -5,10 électronvolts ; et/ou
dans lequel HOMO(2) est de -5,30 électronvolts à -5,00 électronvolts.

3. Dispositif électroluminescent de l'une des revendications 1 ou 2, dans lequel
un moment de dipôle du premier composé est inférieur à 3,0 debye, et
un moment de dipôle du second composé est de 3,0 debye ou plus.

4. Dispositif électroluminescent de l'une quelconque des revendications 1 à 3, dans lequel |λmax(1) - λmax(2)| est de 0 nanomètre à 10 nanomètres.

5. Dispositif électroluminescent de l'une quelconque des revendications 1 à 4, dans lequel chacune de λmax(1) et λmax(2) est de 510 nanomètres à 540 nanomètres ; ou
dans lequel chacune de λmax(1) et λmax(2) est de 540 nanomètres à 570 nanomètres.

6. Dispositif électroluminescent de l'une quelconque des revendications 1 à 5, dans lequel
la première lumière est une lumière verte ; et
la seconde lumière est une lumière verte.

7. Dispositif électroluminescent de l'une quelconque des revendications 1 à 6, dans lequel
la première couche d'émission émet une lumière verte ; et
la seconde couche d'émission émet une lumière verte.

8. Dispositif électroluminescent de l'une quelconque des revendications 1 à 7, dans lequel la première couche d'émission est agencée entre la seconde couche d'émission et la seconde électrode ; et/ou
dans lequel la seconde couche d'émission est agencée entre la première couche d'émission et la seconde électrode.

9. Dispositif électroluminescent de l'une quelconque des revendications 1 à 8, dans lequel
le premier métal de transition est le platine, et
le second métal de transition est l'iridium.

10. Dispositif électroluminescent de l'une quelconque des revendications 1 à 9, dans lequel la couche intermédiaire comprend :
m unités électroluminescentes comprenant au moins une couche d'émission ; et
m-1 couches de génération de charge (141) agencées entre deux unités électroluminescentes voisines des m unités électroluminescentes,
dans lequel m est un nombre entier de 2 ou plus, et
dans lequel :
une première unité électroluminescente (151) des m unités électroluminescentes comprend la première couche d'émission, et une seconde unité électroluminescente (152) des m unités électroluminescentes comprend la seconde couche d'émission, ou
une unité électroluminescente des m unités électroluminescentes comprend la première couche d'émission et la seconde couche d'émission.

11. Dispositif électroluminescent de la revendication 10,
dans lequel la première unité électroluminescente des m unités électroluminescentes comprend la première couche d'émission, et la seconde unité électroluminescente des m unités électroluminescentes comprend la seconde couche d'émission,
la première unité électroluminescente comprenant la première couche d'émission émet une lumière verte, et
la seconde unité électroluminescente comprenant la seconde couche d'émission émet une lumière verte.

12. Dispositif électroluminescent de l'une des revendications 10 ou 11, dans lequel la première unité électroluminescente des m unités électroluminescentes comprend la première couche d'émission, et la seconde unité électroluminescente des m unités électroluminescentes comprend la seconde couche d'émission, et
la première unité électroluminescente comprenant la première couche d'émission est agencée entre la seconde unité électroluminescente comprenant la seconde couche d'émission et la seconde électrode.

13. Dispositif électroluminescent de l'une quelconque des revendications 10 à 12, dans lequel la première unité électroluminescente des m unités électroluminescentes comprend la première couche d'émission, et la seconde unité électroluminescente des m unités électroluminescentes comprend la seconde couche d'émission, et
la seconde unité électroluminescente comprenant la seconde couche d'émission est agencée entre la première unité électroluminescente comprenant la première couche d'émission et la seconde électrode.

14. Dispositif électroluminescent de l'une quelconque des revendications 10 à 13, dans lequel l'unité électroluminescente des m unités électroluminescentes comprend la première couche d'émission et la seconde couche d'émission, et l'unité électroluminescente comprenant la première couche d'émission et la seconde couche d'émission émet une lumière verte ; et/ou
dans lequel au moins une unité électroluminescente des unités électroluminescentes émet une lumière bleue.

15. Appareil électronique, comprenant le dispositif électroluminescent de l'une quelconque des revendications 1 à 14.
